(19) Europäisches Patentamt
European Patent Office
Office européen des brevets

(11) EP 3 266 790 B1

(12) **EUROPEAN PATENT SPECIFICATION**

(45) Date of publication and mention of the grant of the patent:
**06.11.2019 Bulletin 2019/45**

(51) Int Cl.:
*C07F 1/00* (2006.01) *C07F 15/00* (2006.01)
*C07F 9/66* (2006.01) *C09K 11/06* (2006.01)

(21) Application number: **17179351.6**

(22) Date of filing: **03.07.2017**

(54) **ORGANOMETALLIC COMPOUND, ORGANIC LIGHT-EMITTING DEVICE INCLUDING THE SAME, AND DIAGNOSTIC COMPOSITION INCLUDING THE ORGANOMETALLIC COMPOUND**

ORGANOMETALLISCHE VERBINDUNG, ORGANISCHE LICHTEMITTIERENDE VORRICHTUNG DAMIT UND DIAGNOSEZUSAMMENSETZUNG MIT DER ORGANOMETALLISCHEN VERBINDUNG

COMPOSÉ ORGANOMÉTALLIQUE, DISPOSITIF ÉLECTROLUMINESCENT ORGANIQUE LE COMPRENANT ET COMPOSITION DE DIAGNOSTIC COMPRENANT LE COMPOSÉ ORGANOMÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.07.2016 KR 20160085069**

(43) Date of publication of application:
**10.01.2018 Bulletin 2018/02**

(60) Divisional application:
**19199124.9**

(73) Proprietor: **Samsung Electronics Co., Ltd.**
**Gyeonggi-do 16677 (KR)**

(72) Inventors:
- **LEE, Jungin**
  **16678 Gyeonggi-do (KR)**
- **HWANG, Kyuyoung**
  **16678 Gyeonggi-do (KR)**
- **KIM, Soyeon**
  **16678 Gyeonggi-do (KR)**
- **JEON, Aram**
  **16678 Gyeonggi-do (KR)**
- **CHOI, Hyeonho**
  **16678 Gyeonggi-do (KR)**
- **KOO, Hyun**
  **16678 Gyeonggi-do (KR)**
- **KIM, Sangdong**
  **16678 Gyeonggi-do (KR)**
- **KWAK, Yoonhyun**
  **16678 Gyeonggi-do (KR)**
- **KWON, Ohyun**
  **16678 Gyeonggi-do (KR)**
- **CHOI, Byoungki**
  **16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**US-A1- 2016 240 800**

- **BIN WANG ET AL: "Strongly phosphorescent platinum(II) complexes supported by tetradentate benzazole-containing ligands", JOURNAL OF MATERIALS CHEMISTRY C: MATERIALS FOR OPTICAL AND ELECTRONIC DEVICES, vol. 3, no. 31, 17 July 2015 (2015-07-17), pages 8212-8218, XP055418878, UK ISSN: 2050-7526, DOI: 10.1039/C5TC01449B**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 266 790 B1

## Description

FIELD OF THE INVENTION

One or more embodiments relate to an organometallic compound, an organic light-emitting device including the organometallic compound, and a diagnostic composition including the organometallic compound.

BACKGROUND OF THE INVENTION

Organic light-emitting devices (OLEDs) are self-emission devices, which have better characteristics including wide viewing angles, high contrast ratios, short response times, and excellent brightness, driving voltage, and response speed, and produce full-color images.

In an example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Meanwhile, luminescent compounds may be used to monitor, sense, or detect a variety of biological materials including cells and proteins. An example of the luminescent compounds includes a phosphorescent luminescent compound.

Various types of organic light emitting devices are known. However, there still remains a need in OLEDs having low driving voltage, high efficiency, high brightness, and long lifespan.

In B. Wang et al., "Strongly phosphorescent platinum(II) complexes supported by tetradentate benzazole-containing ligands", Journal of Materials Chemistry C, Issue 31, 2015, pp. 8212-8218, a series of phosphorescent Pt(II) complexes supported by rigid benzazole-containing tetradentate ligands were designed and synthesized.

SUMMARY OF THE INVENTION

One or more embodiments include a novel organometallic compound, an organic light-emitting device including the organometallic compound, and a diagnostic composition including the organometallic compound.

Additional aspects will be set forth in part in the description which follows and, in part, will be apparent from the description, or may be learned by practice of the presented embodiments.

According to one or more embodiments, an organometallic compound is provided in accordance with claim 1.

According to one or more embodiments, an organic light-emitting device is provided in accordance with claim 6.

BRIEF DESCRIPTION OF THE DRAWING

These and/or other aspects will become apparent and more readily appreciated from the following description of the embodiments, taken in conjunction with Figure 1 which is a schematic view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figure, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer,

or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figure are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

In an embodiment, an organometallic compound is provided.

An organometallic compound according to an embodiment is represented by Formula 1-1:

Formula 1-1

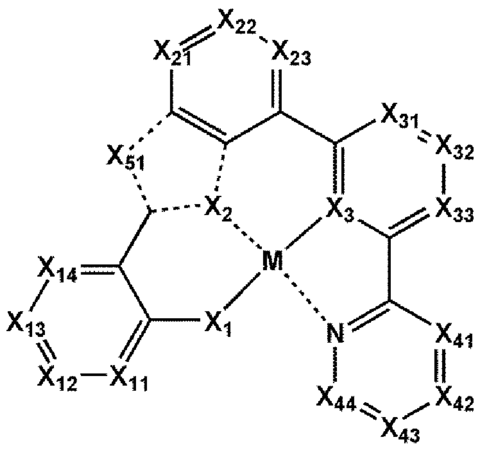

**Formula 1-1**

.

In Formula 1-1, M may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

For example, M in Formula 1-1 may be platinum (Pt), but embodiments of the present disclosure are not limited thereto.

The organometallic compound represented by Formula 1-1 may be a neutral compound which does not consist of an ion pair of an anion and a cation.

In Formula 1-1, $X_1$ is O or S, and a bond between $X_1$ and M is a covalent bond.

For example, in Formula 1-1, $X_1$ may be O, but embodiments of the present disclosure are not limited thereto.

In Formula 1-1,

i) $X_2$ is N, $X_3$ is C, a bond between $X_2$ and M is a coordinate bond, and a bond between $X_3$ and M is a covalent bond; or
ii) $X_3$ is N, $X_2$ is C, a bond between $X_3$ and M is a coordinate bond, and a bond between $X_2$ and M is a covalent bond.

In Formula 1-1, $X_{51}$ is selected from O, S, N-[$(L_7)_{b7}$-$(R_7)_{c7}$], C($R_7$)($R_8$), Si($R_7$)($R_8$), and C(=O), $R_7$ and $R_8$ are optionally linked via a first linking group to form a substituted or unsubstituted $C_5$-$C_{30}$ carbocyclic group or a substituted or unsubstituted $C_1$-$C_{30}$ heterocyclic group (for example, a $C_5$-$C_6$ 5-membered to 7-membered cyclic group; or a $C_5$-$C_6$ 5-membered to 7-membered cyclic group substituted with at least one of deuterium, a cyano group, -F, a $C_1$-$C_{10}$ alkyl group, and a $C_6$-$C_{14}$ aryl group). Here, $L_7$, b7, $R_7$, c7, and $R_8$ are each independently the same as described below.

The first linking group may be selected from a single bond, *-O-*'' *-S-*', *-C($R_5$)($R_6$)-*', *-C($R_5$)=*', *=C($R_6$)-*', *-C($R_5$)=C($R_6$)-*', *-C(=O)-*', *-C(=S)-*', *-C≡C-*', *-N($R_5$)-*' and *-Si($R_5$)($R_6$)-*', $R_5$ and $R_6$ are each independently the same as described in connection with $R_7$ below, and * and *' each indicate a binding site to a neighboring atom.

In Formula 1-1, $L_7$ is selected from a substituted or unsubstituted $C_5$-$C_{30}$ carbocyclic group and a substituted or unsubstituted $C_1$-$C_{30}$ heterocyclic group.

For example, in Formula 1-1, $L_7$ may be selected from:

a benzene group, a naphthalene group, an anthracene group, a phenanthrene group, a triphenylene group, a pyrene group, a chrysene group, a cyclopentadiene group, a furan group, a thiophene group, silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, azadibenzosilole group, a pyridine group, a pyrimidine group, a pyrazine group, a pyridazine group, a triazine group, a quinoline group, an isoquinoline group, a quinoxaline group, a quinazoline group, phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzooxadiazole group, and a benzothiadiazole group; and
a benzene group, a naphthalene group, an anthracene group, a phenanthrene group, a triphenylene group, a pyrene group, a chrysene group, a cyclopentadiene group, a furan group, a thiophene group, silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, azadibenzosilole group, a pyridine group, a pyrimidine group, a pyrazine group, a pyridazine group, a triazine group, a quinoline group, an isoquinoline group, a quinoxaline group, a quinazoline group, phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzooxadiazole group, and a benzothiadiazole group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -N($Q_{31}$)($Q_{32}$), -Si($Q_{33}$)($Q_{34}$)($Q_{35}$), -B($Q_{36}$)($Q_{37}$), and -P(=O)($Q_{38}$)($Q_{39}$),
$Q_{31}$ to $Q_{39}$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, and - $CD_2CDH_2$;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group, but embodiments of the present disclosure are not limited thereto.

In an embodiment, in Formula 1-1, $L_7$ may be selected from:

a benzene group, a pyridine group, and a pyrimidine group; and

a benzene group, a pyridine group, and a pyrimidine group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a pyridinyl group, and a pyrimidinyl group, -N($Q_{31}$)($Q_{32}$), -Si($Q_{33}$)($Q_{34}$)($Q_{35}$), -B($Q_{36}$)($Q_{37}$), and-P(=O)($Q_{38}$)($Q_{39}$) (wherein $Q_{31}$ to $Q_{39}$ are each independently the same as described herein),

but embodiments of the present disclosure are not limited thereto.

In Formula 1-1, b7 indicates the number of $L_7$, and is an integer from 0 to 5. When b7 is 0, *-$(L_7)_{b7}$-*' is a single bond. When b7 is two or more, two or more groups $L_7$ may be identical to or different from each other.

In an embodiment, in Formula 1-1, b7 is 0 or 1, but embodiments of the present disclosure are not limited thereto.

In Formula 1-1, $R_7$ and $R_8$ are each independently selected from hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_2$-$C_{60}$ heteroaryloxy group, a substituted or unsubstituted $C_2$-$C_{60}$ heteroarylthio group, a substituted or unsubstituted $C_3$-$C_{60}$ heteroarylalkyl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -B($Q_6$)($Q_7$), and -P(=O)($Q_8$)($Q_9$).

For example, $R_7$ and $R_8$ may each independently be selected from:

hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, -$SF_5$, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl (adamantyl) group, a norbornanyl (norbornyl) group, a norbornenyl group, a cyclopentenyl group, a cyclohexenyl group, a cycloheptenyl group, a phenyl group, a naphthyl group, a pyridinyl group, and a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a

quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group and $-Si(Q_{33})(Q_{34})(Q_{35})$; and

$-N(Q_1)(Q_2)$, $-Si(Q_3)(Q_4)(Q_5)$, $-B(Q_6)(Q_7)$, and $-P(=O)(Q_8)(Q_9)$, and

$Q_1$ to $Q_9$ and $Q_{33}$ to $Q_{35}$ are each independently the same as described in connection with $Q_{31}$.

In an embodiment, $R_7$ and $R_8$ may each independently be selected from:

hydrogen, deuterium, -F, a cyano group, a nitro group, $-SF_5$, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group;

a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group, each substituted with at least one selected from deuterium, -F, $-CD_3$, $-CD_2H$, $-CDH_2$, $-CF_3$, $-CF_2H$, $-CFH_2$, a cyano group, a nitro group, a $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, a dibenzosilolyl group and - $Si(Q_{33})(Q_{34})(Q_{35})$; and

$-N(Q_1)(Q_2)$, $-Si(Q_3)(Q_4)(Q_5)$, $-B(Q_6)(Q_7)$, and $-P(=O)(Q_8)(Q_9)$, and

$Q_1$ to $Q_9$ and $Q_{33}$ to $Q_{35}$ are each independently the same as described herein, but embodiments of the present disclosure are not limited thereto.

In one or more embodiments, $R_7$ and $R_8$ may each independently be selected from hydrogen, deuterium, -F, a cyano group, a nitro group, $-SF_5$, $-CH_3$, $-CD_3$, $-CD_2H$, $-CDH_2$,$-CF_3$, $-CF_2H$, $-CFH_2$, $-C_2F_5$, $-C_2F_4H$, $-C_2F_3H_2$, $-C_2F_2H_3$,

$-C_2FH_4$, groups represented by Formulae 9-1 to 9-19, groups represented by Formulae 10-1 to 10-167, $-N(Q_1)(Q_2)$,$-Si(Q_3)(Q_4)(Q_5)$, $-B(Q_6)(Q_7)$, and $-P(=O)(Q_8)(Q_9)$ (wherein $Q_1$ to $Q_9$ are each independently the same as described herein), but embodiments of the present disclosure are not limited thereto:

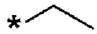
Formula 9-1
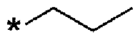
Formula 9-2
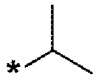
Formula 9-3
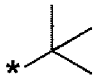
Formula 9-4
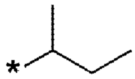
Formula 9-5
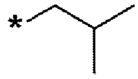
Formula 9-6
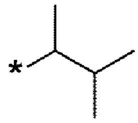
Formula 9-7
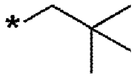
Formula 9-8
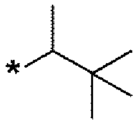
Formula 9-9
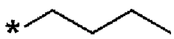
Formula 9-10
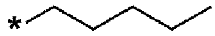
Formula 9-11
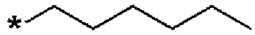
Formula 9-12
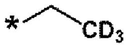
Formula 9-13
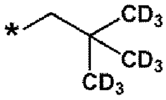
Formula 9-14
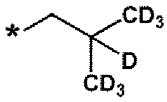
Formula 9-15
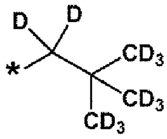
Formula 9-16
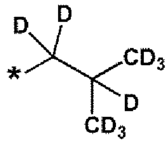
Formula 9-17
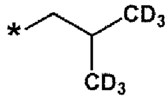
Formula 9-18
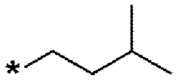
Formula 9-19
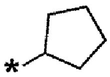
Formula 10-1
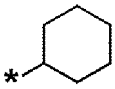
Formula 10-2
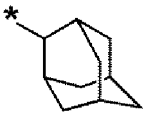
Formula 10-3
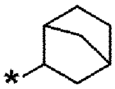
Formula 10-4
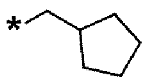
Formula 10-5
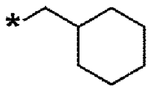
Formula 10-6
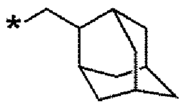
Formula 10-7
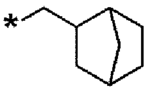
Formula 10-8
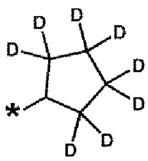
Formula 10-9
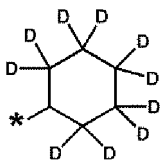
Formula 10-10
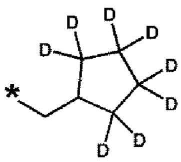
Formula 10-11
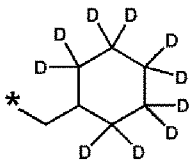
Formula 10-12
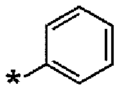
Formula 10-13
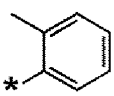
Formula 10-14
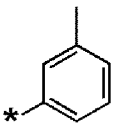
Formula 10-15
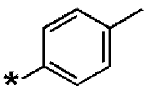
Formula 10-16
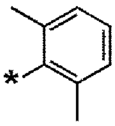
Formula 10-17
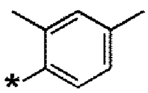
Formula 10-18
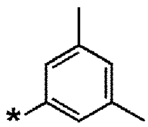
Formula 10-19
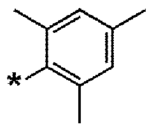
Formula 10-20
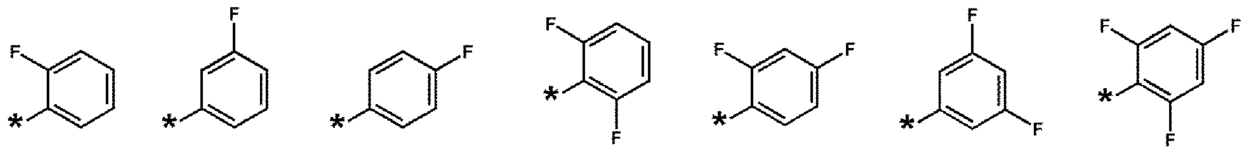
Formula 10-21 Formula 10-22 Formula 10-23 Formula 10-24 Formula 10-25 Formula 10-26 Formula 10-27

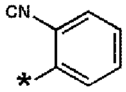
Formula 10-28
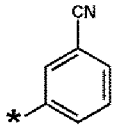
Formula 10-29
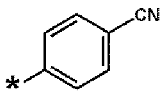
Formula 10-30
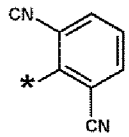
Formula 10-31
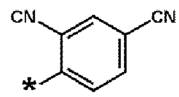
Formula 10-32
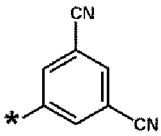
Formula 10-33
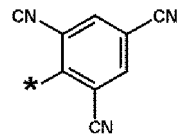
Formula 10-34

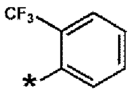
Formula 10-35
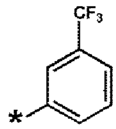
Formula 10-36
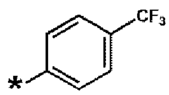
Formula 10-37
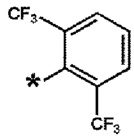
Formula 10-38
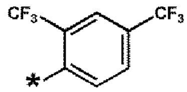
Formula 10-39
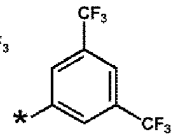
Formula 10-40
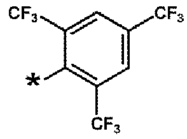
Formula 10-41

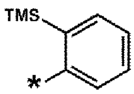
Formula 10-42
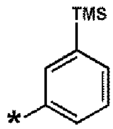
Formula 10-43
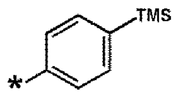
Formula 10-44
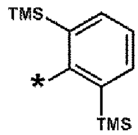
Formula 10-45
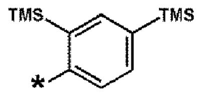
Formula 10-46
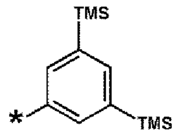
Formula 10-47
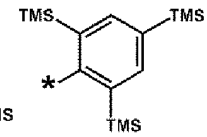
Formula 10-48

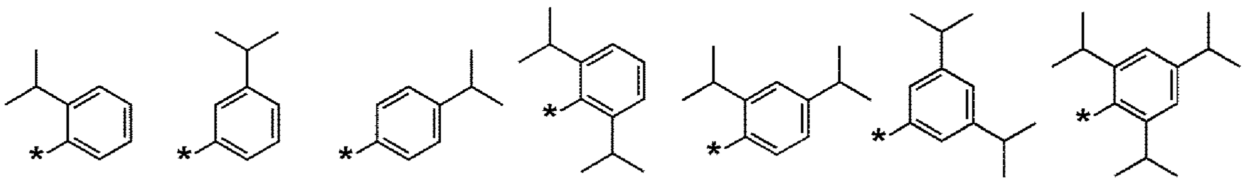
Formula 10-49 Formula 10-50 Formula 10-51 Formula 10-52 Formula 10-53 Formula 10-54 Formula 10-55

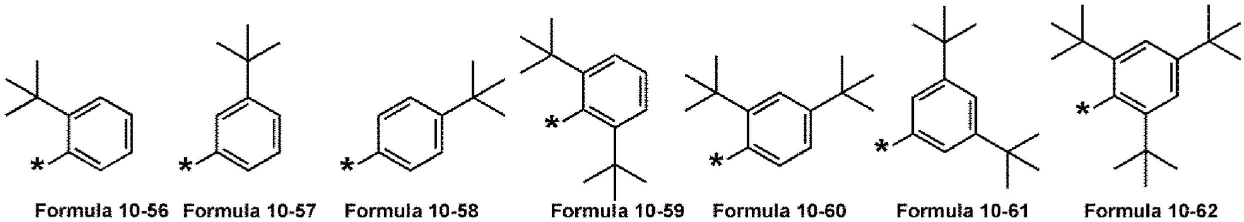
Formula 10-56 Formula 10-57 Formula 10-58 Formula 10-59 Formula 10-60 Formula 10-61 Formula 10-62

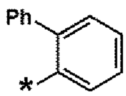
Formula 10-63
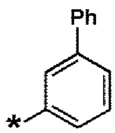
Formula 10-64
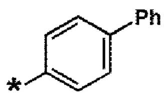
Formula 10-65
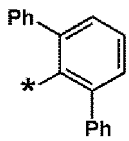
Formula 10-66
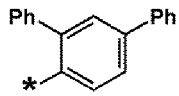
Formula 10-67
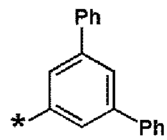
Formula 10-68
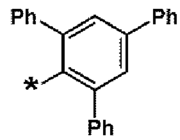
Formula 10-69

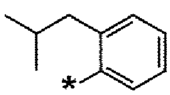
Formula 10-70
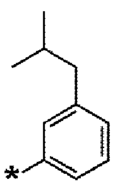
Formula 10-71
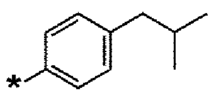
Formula 10-72
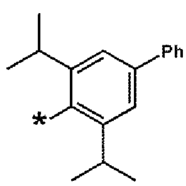
Formula 10-73
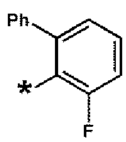
Formula 10-74
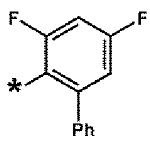
Formula 10-75

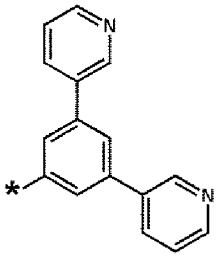
Formula 10-76

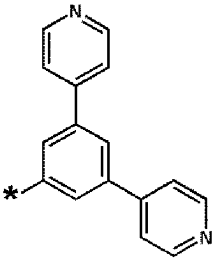
Formula 10-77

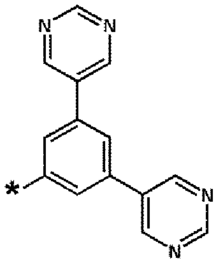
Formula 10-78

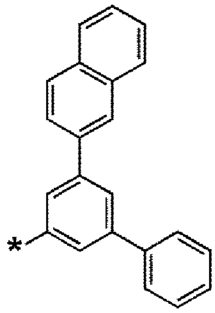
Formula 10-79

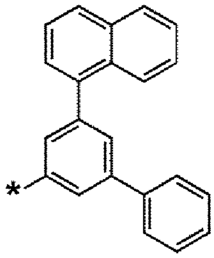
Formula 10-80

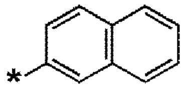
Formula 10-81

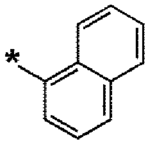
Formula 10-82

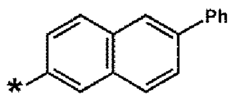
Formula 10-83

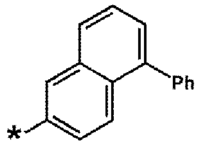
Formula 10-84

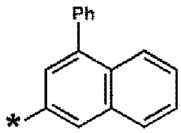
Formula 10-85

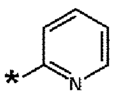
Formula 10-86

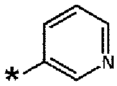
Formula 10-87

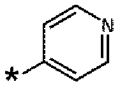
Formula 10-88

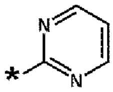
Formula 10-89

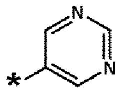
Formula 10-90

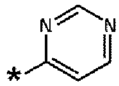
Formula 10-91

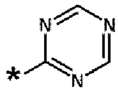
Formula 10-92

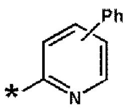
Formula 10-93

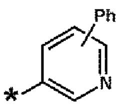
Formula 10-94

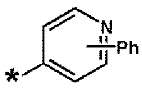
Formula 10-95

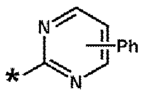
Formula 10-96

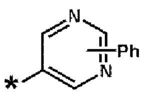
Formula 10-97

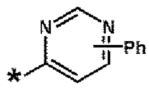
Formula 10-98

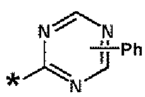
Formula 10-99

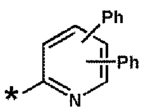
Formula 10-100

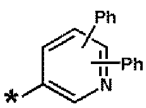
Formula 10-101

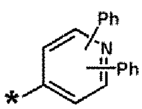
Formula 10-102

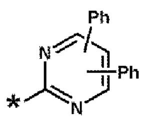
Formula 10-103

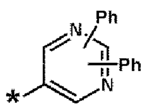
Formula 10-104

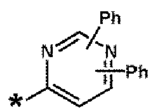
Formula 10-105

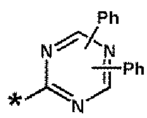
Formula 10-106

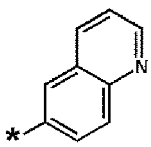
Formula 10-107

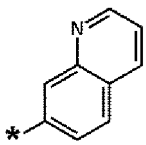
Formula 10-108

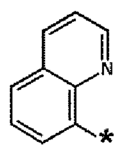
Formula 10-109

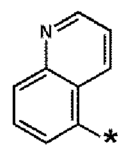
Formula 10-110

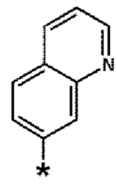
Formula 10-111

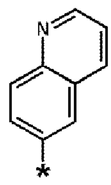
Formula 10-112

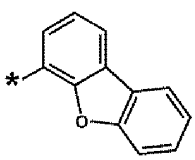
Formula 10-113

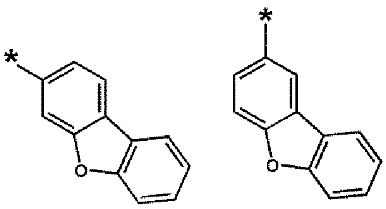
Formula 10-114 Formula 10-115

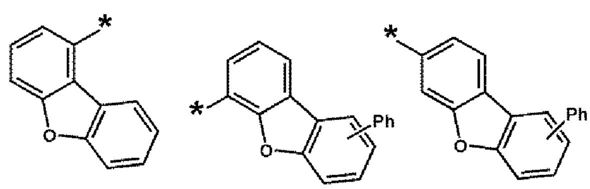
Formula 10-116 Formula 10-117 Formula 10-118

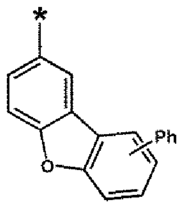
Formula 10-119

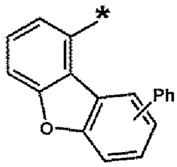
Formula 10-120

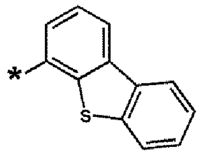
Formula 10-121

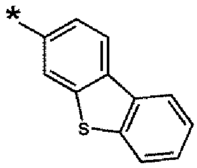
Formula 10-122

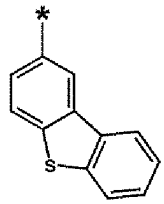
Formula 10-123

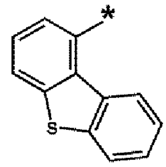
Formula 10-124

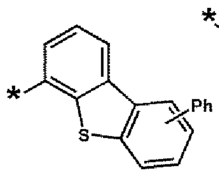
Formula 10-125

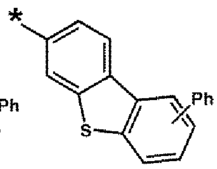
Formula 10-126

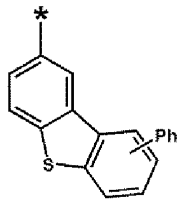
Formula 10-127

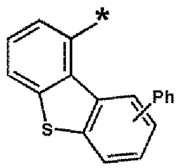
Formula 10-128

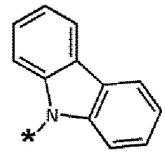
Formula 10-129

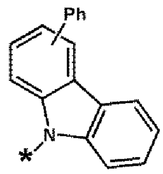
Formula 10-130

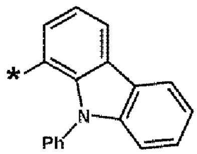
Formula 10-131

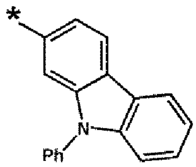
Formula 10-132

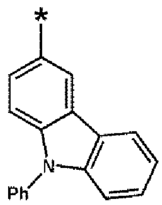
Formula 10-133

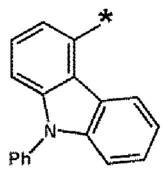
Formula 10-134

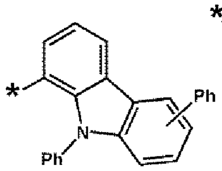
Formula 10-135

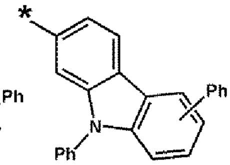
Formula 10-136

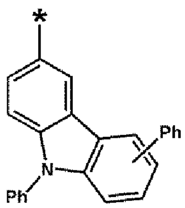
Formula 10-137

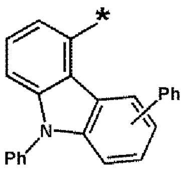
Formula 10-138

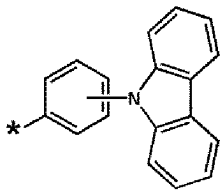
Formula 10-139

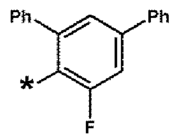
Formula 10-140

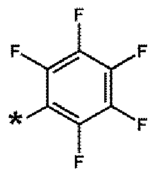
Formula 10-141

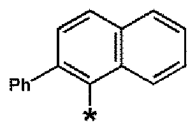
Formula 10-142

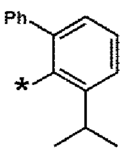
Formula 10-143

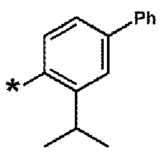
Formula 10-144

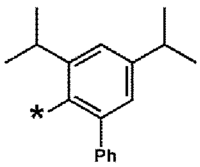
Formula 10-145

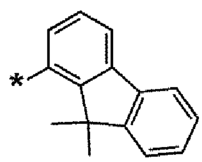
Formula 10-146

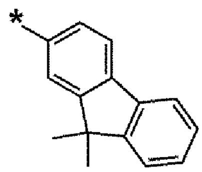
Formula 10-147

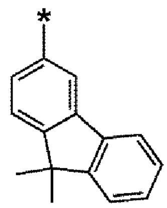
Formula 10-148

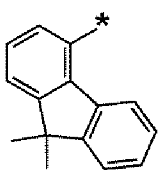
Formula 10-149

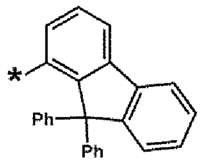
Formula 10-150

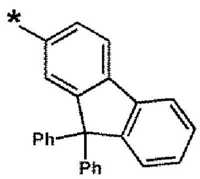
Formula 10-151

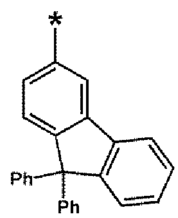
Formula 10-152

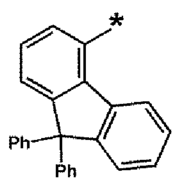
Formula 10-153

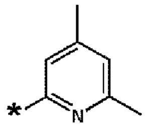
Formula 10-154

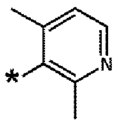
Formula 10-155

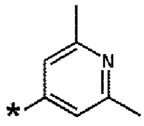
Formula 10-156

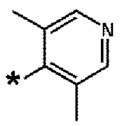
Formula 10-157

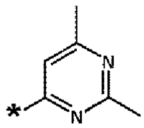
Formula 10-158

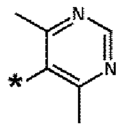
Formula 10-159

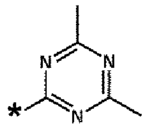
Formula 10-160

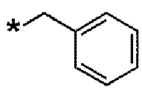
Formula 10-161

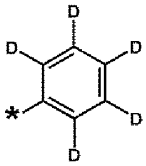
Formula 10-162

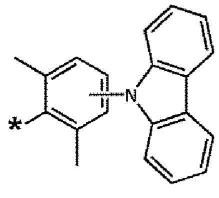
Formula 10-163

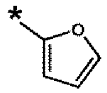
Formula 10-164

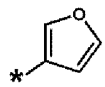
Formula 10-165

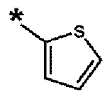
Formula 10-166

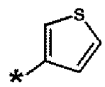
Formula 10-167 .

In groups represented by Formulae 9-1 to 9-19 and Formulae 10-1 to 10-167, * indicate a binding site to a neighboring group, Ph indicates a phenyl group, and TMS indicates a trimethylsilyl group.

In Formula 1-1, c7 indicates the number of $R_7$, is an integer from 1 to 5. When c7 is two or more, two or more groups $R_7$ may be identical to or different from each other.

In an embodiment, in Formula 1-1, c7 is 1 or 2, but embodiments of the present disclosure are not limited thereto.

$X_{11}$ is N or C-$[(L_{11})_{b11}$-$(R_{11})_{c11}]$, $X_{12}$ is N or C-$[(L_{12})_{b12}$-$(R_{12})_{c12}]$, $X_{13}$ is N or C-$[(L_{13})_{b13}$-$(R_{13})_{c13}]$, $X_{14}$ is N or C-$[(L_{14})_{b14}$-$(R_{14})_{c14}]$,

$L_{11}$ to $L_{14}$, b11 to b14, $R_{11}$ to $R_{14}$ and c11 to c14 are each independently the same as described in connection with $L_7$, b7, $R_7$, and c7 above, respectively,

$X_{21}$ is N or C-$[(L_{21})_{b21}$-$(R_{21})_{c21}]$, $X_{22}$ is N or C-$[(L_{22})_{b22}$-$(R_{22})_{c22}]$, $X_{23}$ is N or C-$[(L_{23})_{b23}$-$(R_{23})_{c23}]$,

$L_{21}$ to $L_{23}$, b21 to b23, $R_{21}$ to $R_{23}$ and c21 to c23 are each independently the same as described in connection with $L_7$, b7, $R_7$, and c7 above, respectively,

$X_{31}$ is N or C-$[(L_{31})_{b31}$-$(R_{31})_{c31}]$, $X_{32}$ is N or C-$[(L_{32})_{b32}$-$(R_{32})_{c32}]$, $X_{33}$ is N or C-$[(L_{33})_{b33}$-$(R_{33})_{c33}]$,

$L_{31}$ to $L_{33}$, b31 to b33, $R_{31}$ to $R_{33}$ and c31 to c33 are each independently the same as described in connection with $L_7$, b7, $R_7$, and c7 above,

$X_{41}$ is N or C-$[(L_{41})_{b41}$-$(R_{41})_{c41}]$, $X_{42}$ is N or C-$[(L_{42})_{b42}$-$(R_{42})_{c42}]$, $X_{43}$ is N or C-$[(L_{43})_{b43}$-$(R_{43})_{c43}]$, $X_{44}$ is N or C-$[(L_{44})_{b44}$-$(R_{44})_{c44}]$,

$L_{41}$ to $L_{44}$, b41 to b44, $R_{41}$ to $R_{44}$ and c41 to c44 are each independently the same as described in connection with $L_7$, b7, $R_7$, and c7 above,

two selected from $R_{11}$ to $R_{14}$ are optionally linked to form a substituted or unsubstituted $C_5$-$C_{30}$ carbocyclic group or a substituted or unsubstituted $C_1$-$C_{30}$ heterocyclic group,

two selected from $R_{21}$ to $R_{23}$ are optionally linked to form a substituted or unsubstituted $C_5$-$C_{30}$ carbocyclic group or a substituted or unsubstituted $C_1$-$C_{30}$ heterocyclic group,

two selected from $R_{31}$ to $R_{33}$ are optionally linked to form a substituted or unsubstituted $C_5$-$C_{30}$ carbocyclic group or a substituted or unsubstituted $C_1$-$C_{30}$ heterocyclic group, and

two selected from $R_{41}$ to $R_{44}$ are optionally linked to form a substituted or unsubstituted $C_5$-$C_{30}$ carbocyclic group or a substituted or unsubstituted $C_1$-$C_{30}$ heterocyclic group,

In an embodiment, in Formula 1-1,

i) the two bonds from $X_{51}$ indicated by a dotted line are each a single bond, and $X_{51}$ is $C(R_7)(R_8)$, $Si(R_7)(R_8)$, or C(=O),

ii) the two bonds from $X_{51}$ indicated by a dotted line are each a single bond, $X_{51}$ is N-$[(L_7)_{b7}$-$(R_7)_{c7}]$, and $R_7$ is selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_2$-$C_{60}$ heteroaryloxy group, a substituted or unsubstituted $C_2$-$C_{60}$ heteroarylthio group, a substituted or unsubstituted $C_3$-$C_{60}$ heteroarylalkyl group, a substituted or unsubstituted monovalent non-aromatic condensed polycyclic group, and a substituted or unsubstituted monovalent non-aromatic condensed heteropolycyclic group, or

iii) of the two bonds from $X_{51}$ indicated by a dotted line, one is a single bond, while the other bond thereof is a double bond, and $X_{51}$ is N, $C(R_7)$, or $Si(R_7)$.

In one or more embodiments, in Formula 1-1, $X_{51}$ may be N-$[(L_7)_{b7}$-$(R_7)_{c7}]$, and $R_7$ may be selected from:

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group; and

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzosilolyl group, a dibenzocarbazolyl group, an imidazopyridinyl group, an imidazopyrimidinyl group, and -Si$(Q_{33})(Q_{34})(Q_{35})$, and

$Q_{33}$ to $Q_{35}$ are each independently the same as described herein.

In one or more embodiments, in Formula 1-1, $X_{51}$ may be N-$[(L_7)_{b7}$-$(R_7)_{c7}]$, and $R_7$ may be selected from groups represented by Formulae 10-1 to 10-128 and groups represented by Formulae 10-131 to 10-167, but embodiments of the present disclosure are not limited thereto.

In Formula 1-1,

in cases where i) M is Pt, ii) $X_1$ is O, iii) $X_2$ is N, $X_3$ is C, a bond between $X_2$ and M is a coordinate bond, and a bond between $X_3$ and M is a covalent bond, iv) the two bonds from $X_{51}$ indicated by a dotted line are each a single bond, v) $X_{11}$, $X_{12}$, $X_{13}$, $X_{14}$, $X_{21}$, $X_{22}$ $X_{23}$, $X_{31}$, $X_{32}$, $X_{33}$, $X_{41}$, $X_{42}$, $X_{43}$ and $X_{44}$ are C-$[(L_{11})_{b11}$-$(R_{11})_{c11}]$, C-$[(L_{12})_{b12}$-$(R_{12})_{c12}]$, C-$[(L_{13})_{b13}$-$(R_{13})_{c13}]$, C-$[(L_{14})_{b14}$-$(R_{14})_{c14}]$, C-$[(L_{21})_{b21}$-$(R_{21})_{c21}]$, C-$[(L_{22})_{b22}$-$(R_{22})_{c22}]$, C-$[(L_{23})_{b23}$-$(R_{23})_{23}]$, C-$[(L_{31})_{b31}$-$(R_{31})_{c31}]$, C-$[(L_{32})_{b32}$-$(R_{32})_{c32}]$, C-$[(L_{33})_{b33}$-$(R_{33})_{33}]$, C-$[(L_{41})_{b41}$-$(R_{41})_{c41}]$, C-$[(L_{42})_{b42}$-$(R_{42})_{c42}]$, C-$[(L_{43})_{b43}$-$(R_{43})_{c43}]$ and C-$[(L_{44})b_{44}$-$(R_{44})c_{44}]$, respectively, vi) $X_{51}$ is O, S, or N-$[(L_7)_{b7}$-$(R_7)_{c7}]$, and vii) b7 is 0, c7 is 1, and $R_7$ is a substituted or unsubstituted $C_1$-$C_{60}$ alkyl group,

at least one selected from $R_{11}$ to $R_{14}$, $R_{21}$ to $R_{23}$, $R_{31}$ to $R_{33}$ and $R_{41}$ to $R_{44}$ is selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a sub-

stituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group.

In one or more embodiments, in Formula 1-1,

$X_{51}$ may be O, S, or N-[$(L_7)_{b7}$-$(R_7)_{c7}$], b7 may be 0, c7 may be 1,
$R_7$ may be selected from:

a $C_1$-$C_{30}$ alkyl group; and
a $C_1$-$C_{30}$ alkyl group substituted with at least one selected from deuterium,-F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group.

For example, in Formula 1-1, i) a substituted or unsubstituted $C_5$-$C_{30}$ carbocyclic group or a substituted or unsubstituted $C_1$-$C_{30}$ heterocyclic group, formed by linking two of $R_{11}$ to $R_{14}$, ii) a substituted or unsubstituted $C_5$-$C_{30}$ carbocyclic group or a substituted or unsubstituted $C_1$-$C_{30}$ heterocyclic group, formed by linking two of $R_{21}$ to $R_{23}$, iii) a substituted or unsubstituted $C_5$-$C_{30}$ carbocyclic group or a substituted or unsubstituted $C_1$-$C_{30}$ heterocyclic group, formed by linking two of $R_{31}$ to $R_{32}$, iv) a substituted or unsubstituted $C_5$-$C_{30}$ carbocyclic group or a substituted or unsubstituted $C_1$-$C_{30}$ heterocyclic group, formed by linking two of $R_{41}$ to $R_{44}$, and v) a substituted or unsubstituted $C_5$-$C_{30}$ carbocyclic group or a substituted or unsubstituted $C_1$-$C_{30}$ heterocyclic group, formed by linking two or more neighboring groups selected from $R_{11}$ to $R_{14}$, $R_{21}$ to $R_{23}$, $R_{31}$ to $R_{33}$, and $R_{41}$ to $R_{44}$ may each independently be selected from:

a cyclopentadiene group, a cyclohexane group, a cycloheptane group, an adamantane group, a norbornane group, a norbornene group, a bicycle-heptane group, a bicyclo-octane group, a benzene group, a pyridine group, a pyrimidine group, a pyrazine group, a pyridazine group, a triazine group, a naphthalene group, an anthracene group, a tetracene group, a phenanthrene group, a dihydronaphthalene group, a phenalene group, a benzothiophene group, a benzofuran group, an indene group, an indole group, a benzosilole group, an azabenzothiophene group, an azabenzofuran group, an azaindene group, an azaindole group, and an azabenzosilole group; and
a cyclopentadiene group, a cyclohexane group, a cycloheptane group, an adamantane group, a norbornane group, a norbornene group, a bicycle-heptane group, a bicyclo-octane group, a benzene group, a pyridine group, a pyrimidine group, a pyrazine group, a pyridazine group, a triazine group, a naphthalene group, an anthracene group, a tetracene group, a phenanthrene group, a dihydronaphthalene group, a phenalene group, a benzothiophene group, a benzofuran group, an indene group, an indole group, a benzosilole group, an azabenzothiophene group, an azabenzofuran group, an azaindene group, an azaindole group, and an azabenzosilole group, each substituted with at least one $R_{1a}$, but embodiments of the present disclosure are not limited thereto.

For example, the organometallic compound may be represented by Formula 1-1, and in Formula 1-1,

$X_{11}$ may be C-[$(L_{11})_{b11}$-$(R_{11})_{c11}$], $X_{12}$ may be C-[$(L_{12})_{b12}$-$(R_{12})_{c12}$], $X_{13}$ may be C-[$(L_{13})_{b13}$-$(R_{13})_{c13}$], $X_{14}$ may be C-[$(L_{14})_{b14}$-$(R_{14})_{c14}$], $X_{21}$ may be C-[$(L_{21})_{b21}$-$(R_{21})_{c21}$], $X_{22}$ may be C-[$(L_{22})_{b22}$-$(R_{22})_{c22}$], $X_{23}$ may be C-[$(L_{23})_{b23}$-$(R_{23})_{c23}$], $X_{31}$ may be C-[$(L_{31})_{b31}$-$(R_{31})_{c31}$], $X_{32}$ may be C-[$(L_{32})_{b32}$-$(R_{32})_{c32}$], $X_{33}$ may be C-[$(L_{33})_{b33}$-$(R_{33})_{c33}$], $X_{41}$ may be C-[$(L_{41})_{b41}$-$(R_{41})_{c41}$], $X_{42}$ may be C-[$(L_{42})_{b42}$-$(R_{42})_{c42}$], $X_{43}$ may be C-[$(L_{43})_{b43}$-$(R_{43})_{c43}$], $X_{44}$ may be C-[$(L_{44})_{b44}$-$(R_{44})_{c44}$],
$X_{51}$ may be O, S, or N-[$(L_7)_{b7}$-$(R_7)_{c7}$],
b7 may be 0, c7 may be 1,
$R_7$ may be selected from:

a $C_1$-$C_{30}$ alkyl group; and
a $C_1$-$C_{30}$ alkyl group substituted with at least one selected from deuterium,-F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a

cyclopentenyl group, a cyclohexenyl group, a cycloheptenyl group, a phenyl group, a naphthyl group, a pyridinyl group, and a pyrimidinyl group, and

at least one selected from $R_{11}$ to $R_{14}$, $R_{21}$ to $R_{23}$, $R_{31}$ to $R_{33}$, and $R_{41}$ to $R_{44}$ may be selected from:

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group; and a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and $-Si(Q_{33})(Q_{34})(Q_{35})$ (wherein $Q_{33}$ to $Q_{35}$ are each independently the same as described herein),

but embodiments of the present disclosure are not limited thereto.

In one or more embodiments in Formula 1-1,

$X_{11}$ may be $C-[(L_{11})_{b11}-(R_{11})_{c11}]$, $X_{12}$ may be $C-[(L_{12})_{b12}-(R_{12})_{c12}]$, $X_{13}$ may be $C-[(L_{13})_{b13}-(R_{13})_{c13}]$, $X_{14}$ may be $C-[(L_{14})_{b14}-(R_{14})_{c14}]$, $X_{21}$ may be $C-[(L_{21})_{b21}-(R_{21})_{c21}]$, $X_{22}$ may be $C-[(L_{22})_{b22}-(R_{22})_{c22}]$, $X_{23}$ may be $C-[(L_{23})_{b23}-(R_{23})_{c23}]$, $X_{31}$ may be $C-[(L_{31})_{b31}-(R_{31})_{c31}]$, $X_{32}$ may be $C-[(L_{32})_{b32}-(R_{32})_{c32}]$, $X_{33}$ may be $C-[(L_{33})_{b33}-(R_{33})_{c33}]$, $X_{41}$ may be $C-[(L_{41})_{b41}-(R_{41})_{c41}]$, $X_{42}$ may be $C-[(L_{42})_{b42}-(R_{42})_{c42}]$, $X_{43}$ may be $C-[(L_{43})_{b43}-(R_{43})_{c43}]$, $X_{44}$ may be $C-[(L_{44})_{b44}-(R_{44})_{c44}]$,
$X_{51}$ may be O, S, or $N-[(L_7)_{b7}-(R_7)_{c7}]$,
b7 may be 0, c7 may be 1,

$R_7$ may be selected from:

a $C_1$-$C_{30}$ alkyl group; and

a $C_1$-$C_{30}$ alkyl group substituted with at least one selected from deuterium,-F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group,

$R_{11}$ to $R_{14}$, $R_{21}$ to $R_{23}$, $R_{31}$ to $R_{33}$, and $R_{41}$ to $R_{44}$ may each independently be selected from hydrogen, deuterium, -F, a cyano group, a nitro group, $-SF_5$, $-CH_3$,$-CD_3$, $-CD_2H$, $-CDH_2$, $-CF_3$, $-CF_2H$, $-CFH_2$, groups represented by Formulae 9-1 to 9-19, groups represented by Formulae 10-1 to 10-167, $-N(Q_1)(Q_2)$, $-Si(Q_3)(Q_4)(Q_5)$, $-B(Q_6)(Q_7)$, and $-P(=O)(Q_8)(Q_9)$ (wherein $Q_1$ to $Q_9$ are each independently the same as described herein), and in Formula 1-1, at least one selected from $R_{11}$ to $R_{14}$, $R_{21}$ to $R_{23}$, $R_{31}$ to $R_{33}$, and $R_{41}$ to $R_{44}$ may each independently be selected from groups represented by Formulae 10-1 to 10-167, but embodiments of the present disclosure are not limited thereto.

For example, the organometallic compound may be one selected from Compounds 1-1 to 1-88, Compounds 2-1 to 2-47, and Compounds 3-1 to 3-582, but embodiments of the present disclosure are not limited thereto:

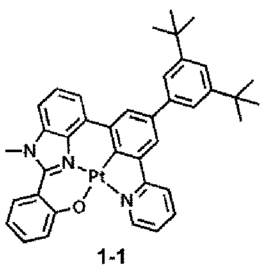
1-1

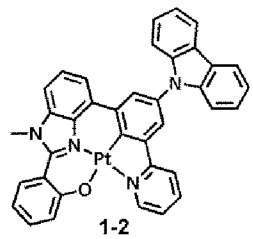
1-2

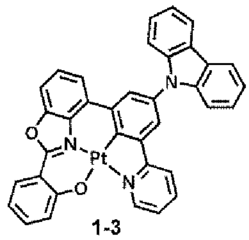
1-3

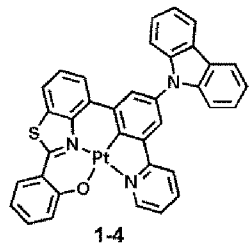
1-4

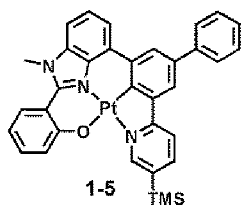
1-5

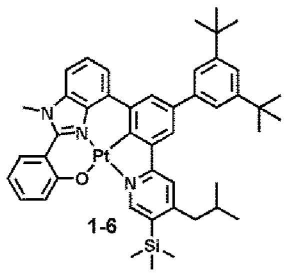
1-6

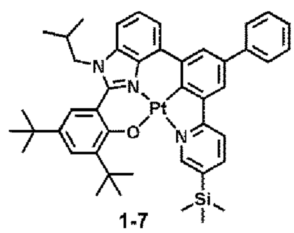
1-7

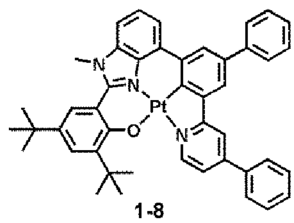
1-8

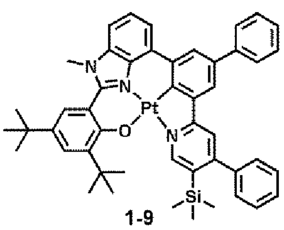
1-9

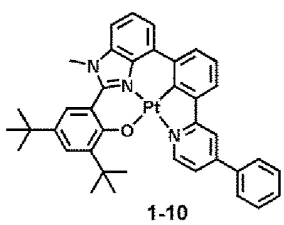
1-10

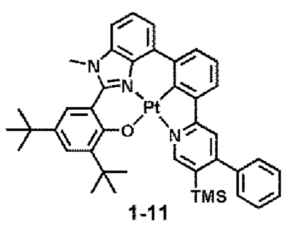
1-11

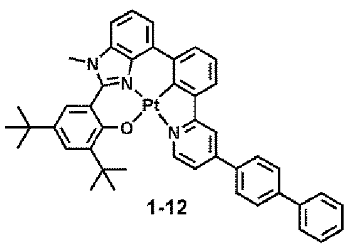
1-12

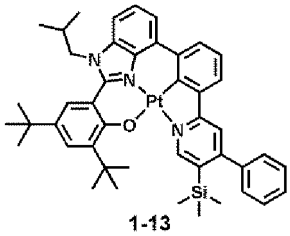
1-13

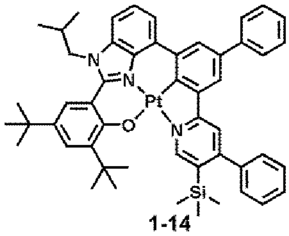
1-14

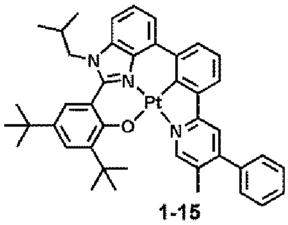
1-15

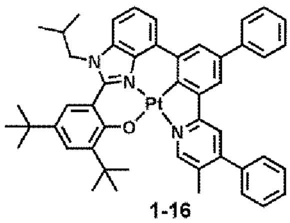
1-16

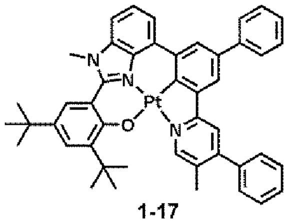
1-17

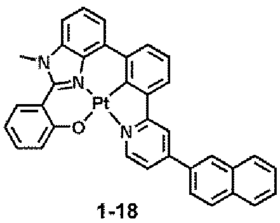
1-18

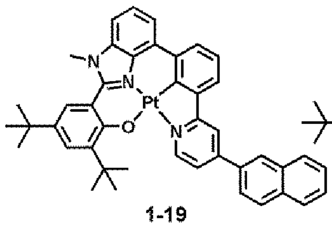
1-19

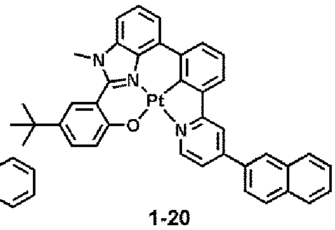
1-20

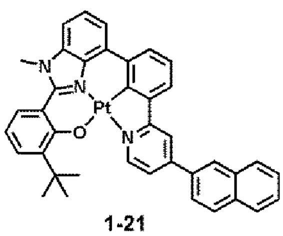
1-21

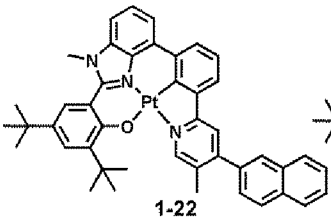
1-22

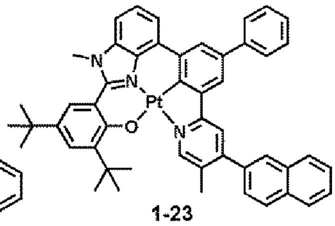
1-23

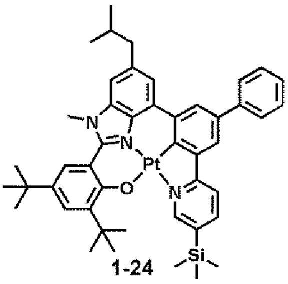
1-24

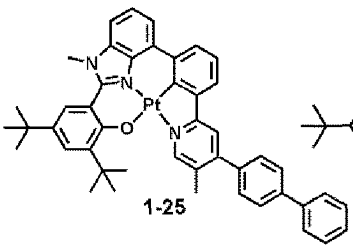
1-25

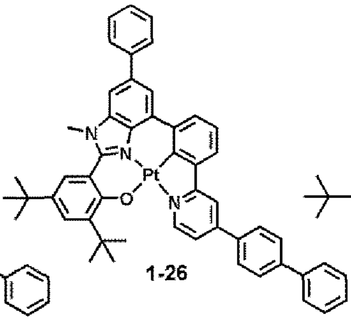
1-26

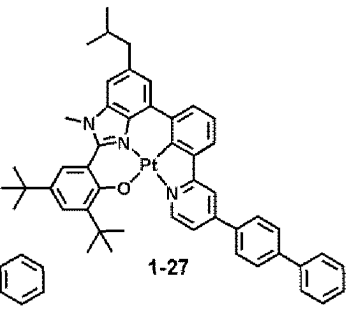
1-27

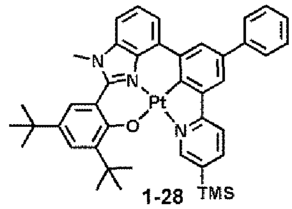
1-28

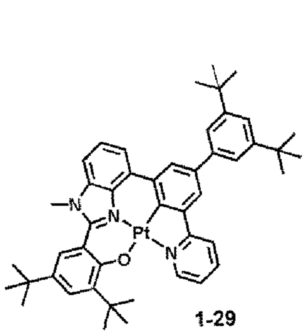
1-29

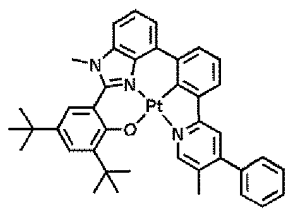
1-30

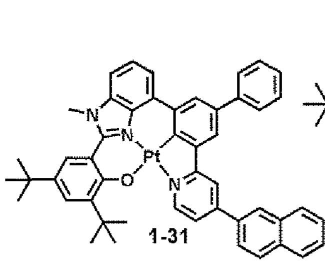
1-31

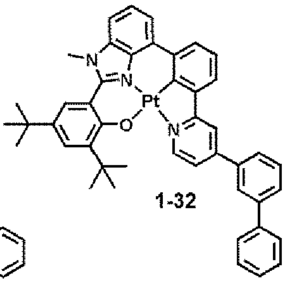
1-32

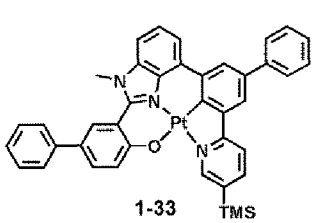
1-33

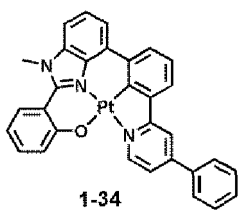
1-34

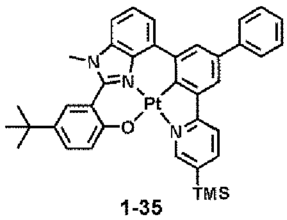
1-35

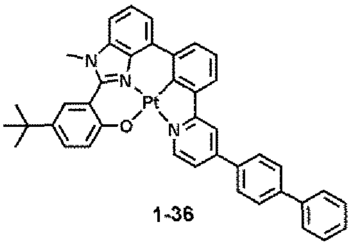
1-36

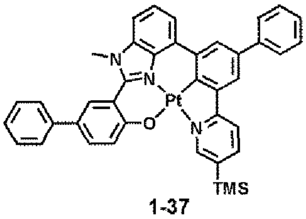
1-37

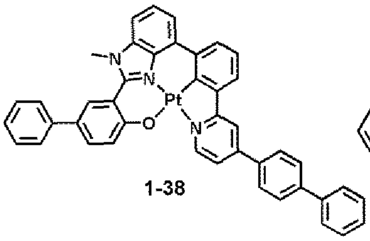
1-38

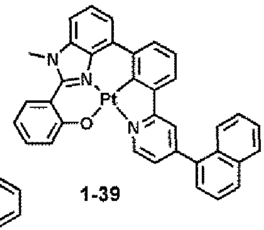
1-39

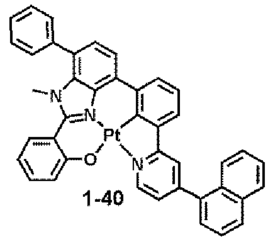
1-40

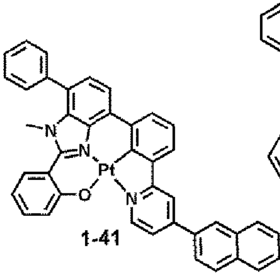
1-41

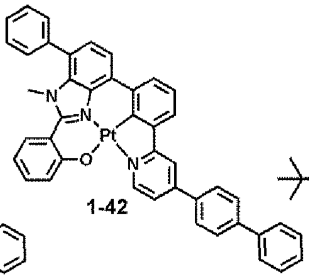
1-42

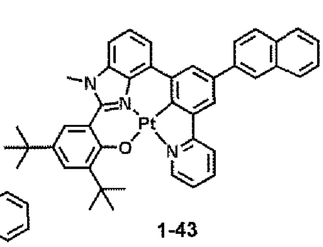
1-43

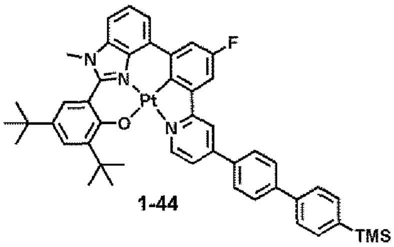
1-44

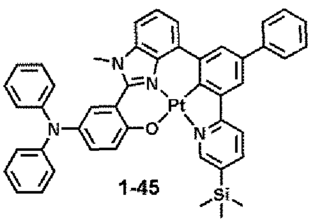
1-45

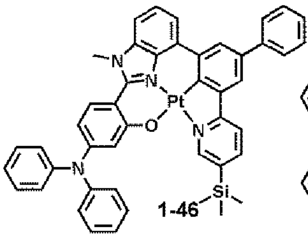
1-46

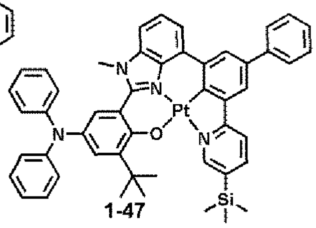
1-47

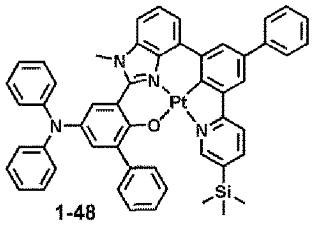
1-48

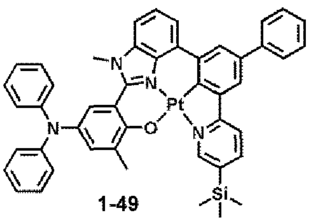
1-49

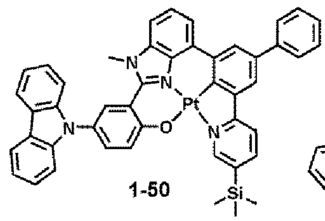
1-50

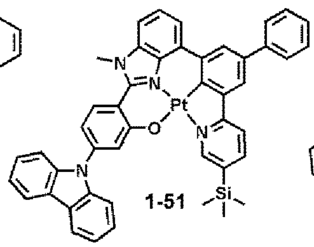
1-51

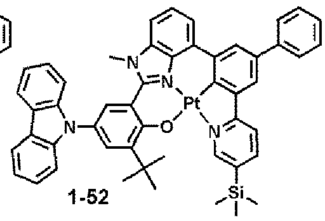
1-52

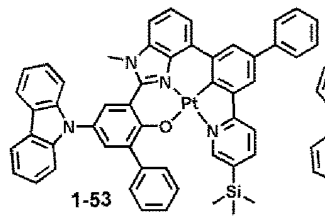
1-53

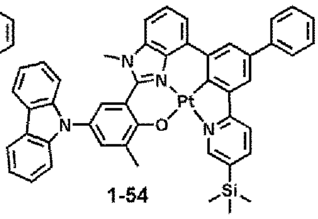
1-54

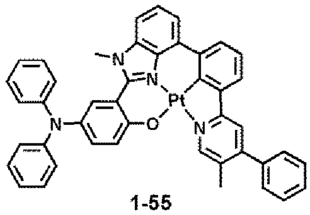
1-55

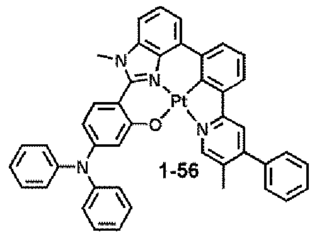
1-56

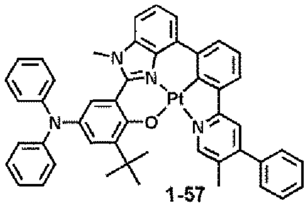
1-57

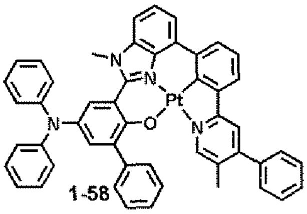
1-58

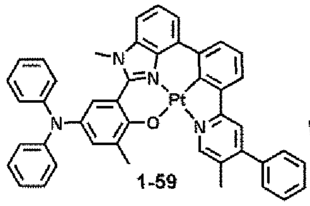
1-59

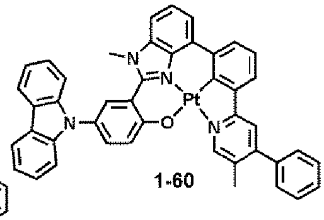
1-60

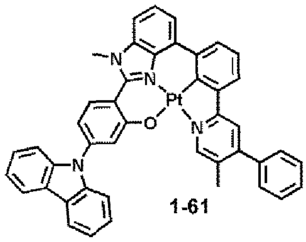
1-61

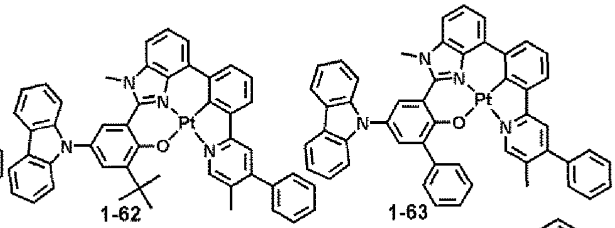
1-62

1-63

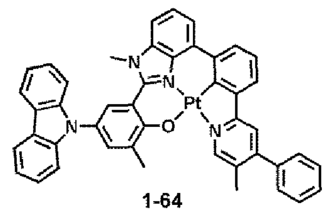
1-64

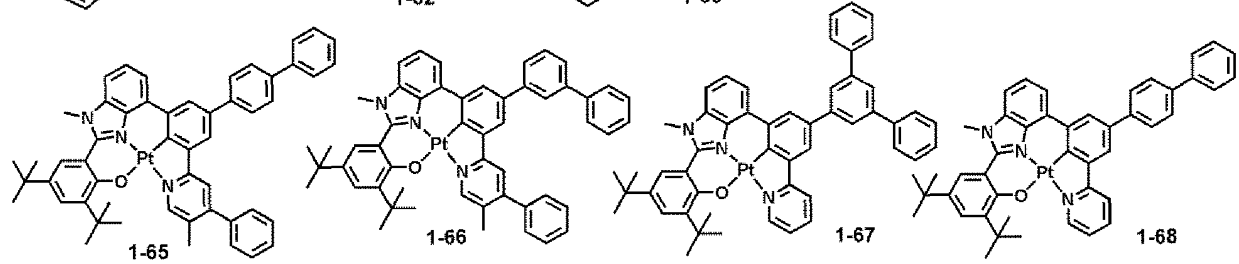
1-65

1-66

1-67

1-68

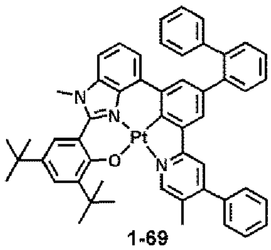
1-69

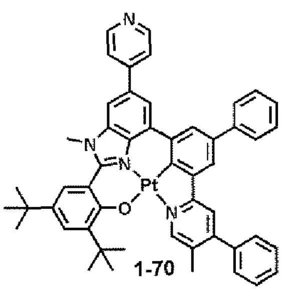
1-70

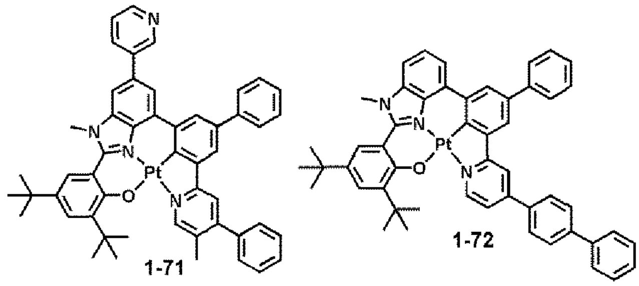
1-71

1-72

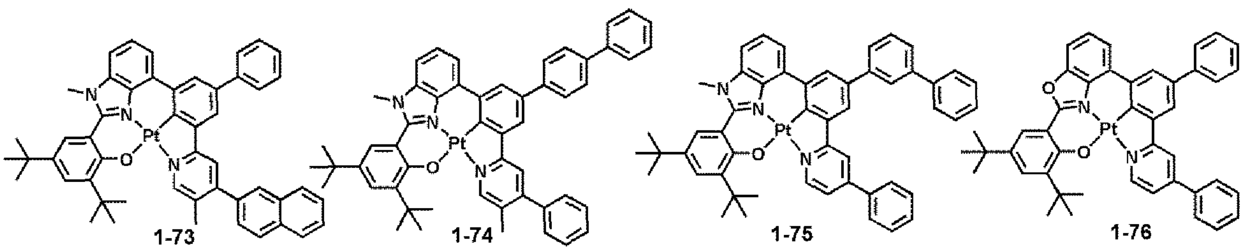
1-73

1-74

1-75

1-76

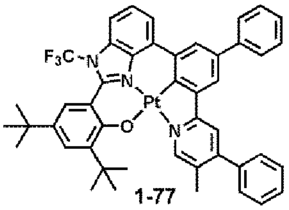
1-77

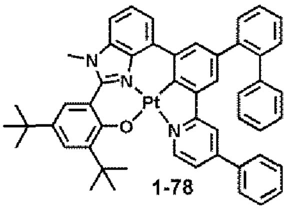
1-78

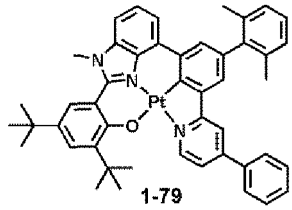
1-79

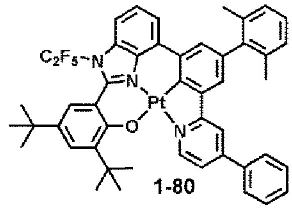
1-80

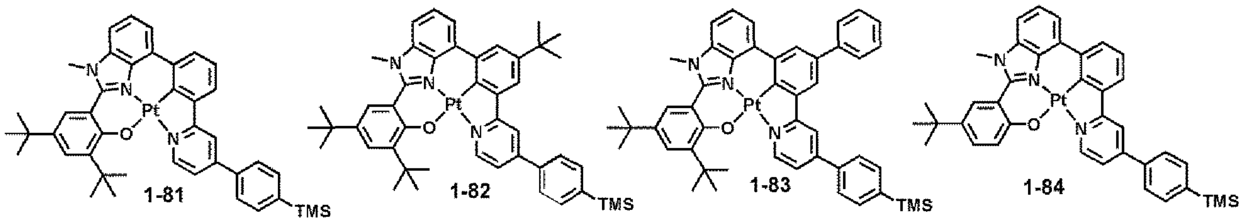

1-81 1-82 1-83 1-84

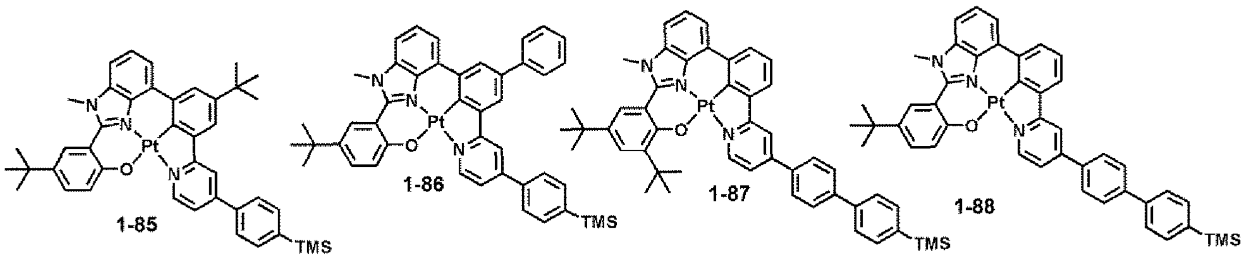

1-85 1-86 1-87 1-88

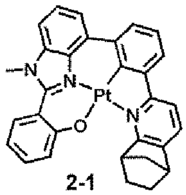

2-1

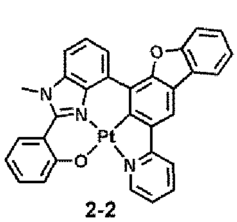

2-2

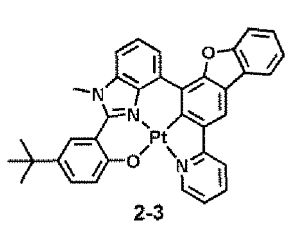

2-3

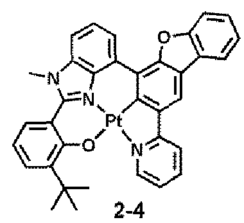

2-4

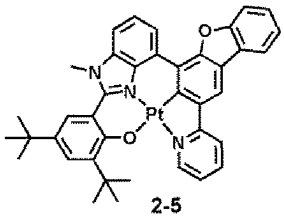

2-5

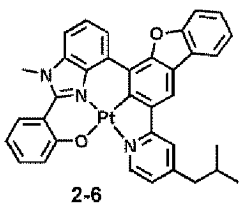

2-6

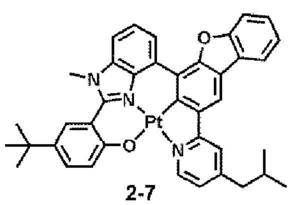

2-7

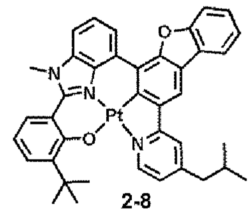

2-8

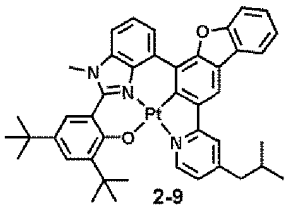

2-9

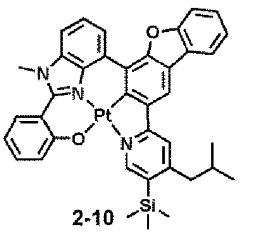

2-10

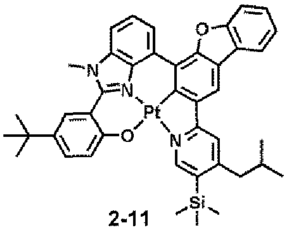

2-11

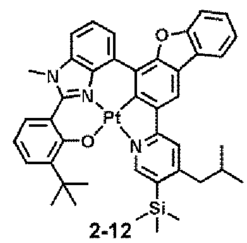

2-12

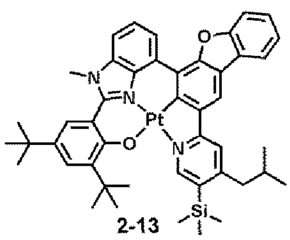

2-13

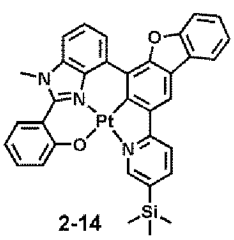

2-14

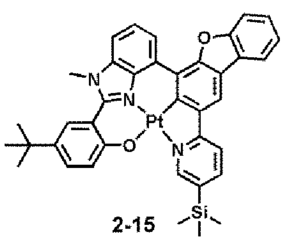

2-15

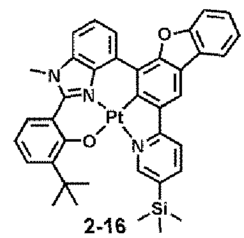

2-16

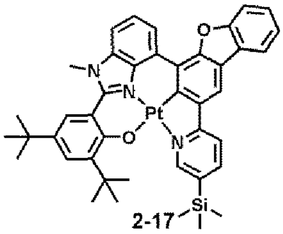
2-17

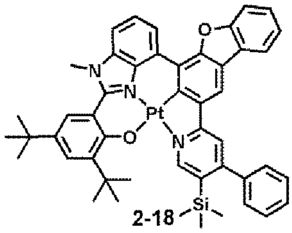
2-18

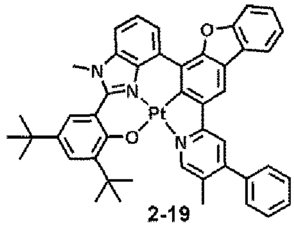
2-19

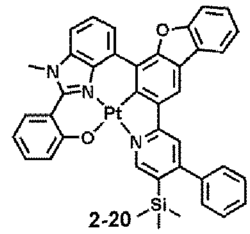
2-20

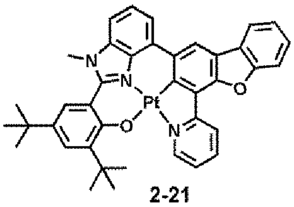
2-21

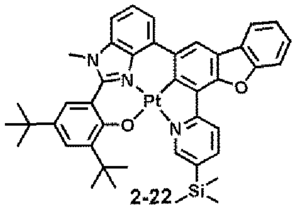
2-22

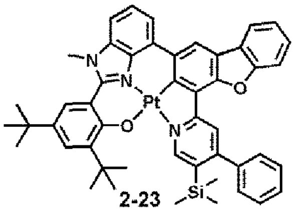
2-23

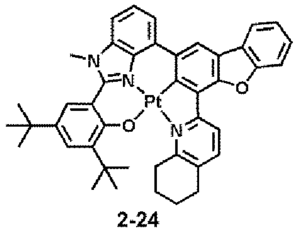
2-24

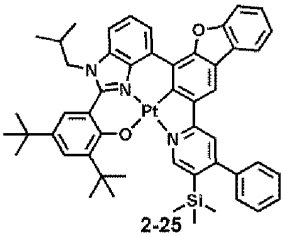
2-25

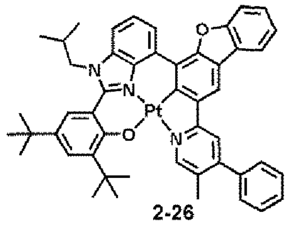
2-26

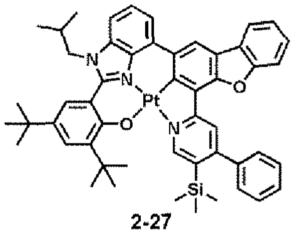
2-27

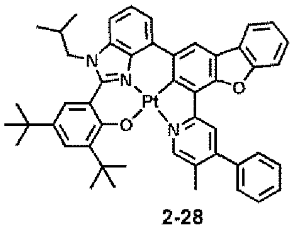
2-28

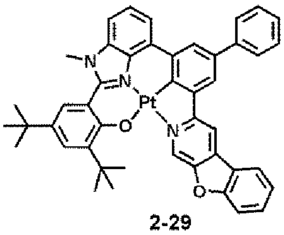
2-29

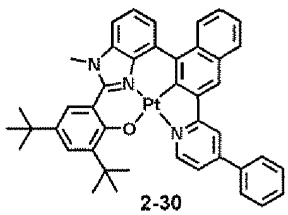
2-30

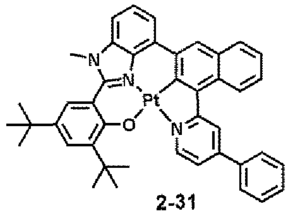
2-31

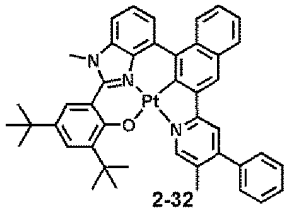
2-32

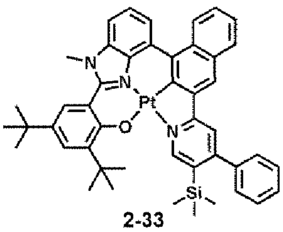
2-33

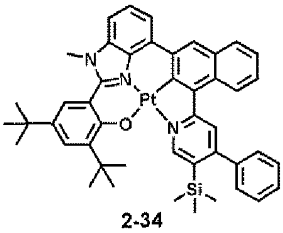
2-34

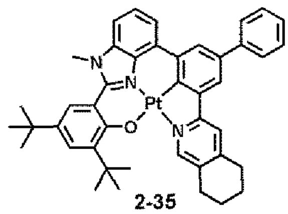
2-35

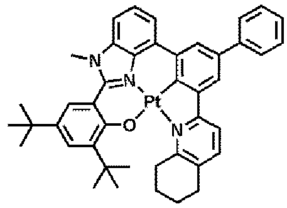
2-36

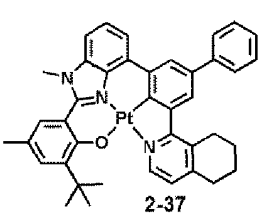
2-37

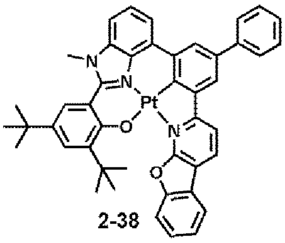
2-38

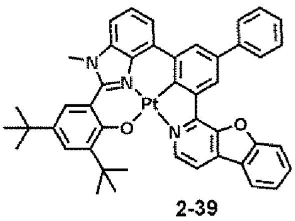
2-39

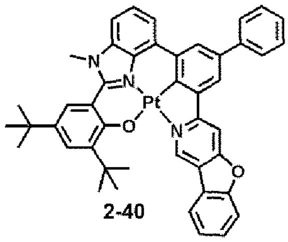
2-40

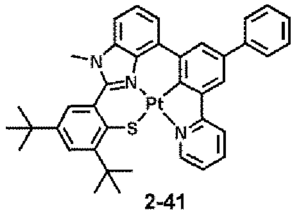
2-41
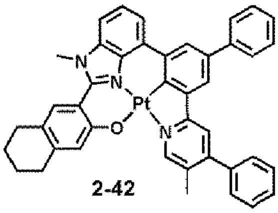
2-42
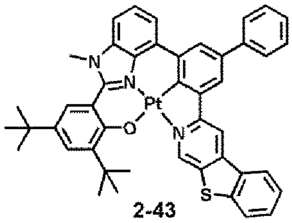
2-43
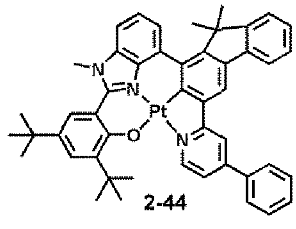
2-44

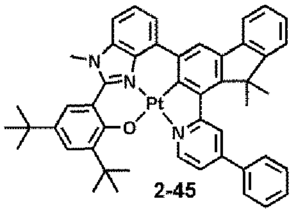
2-45
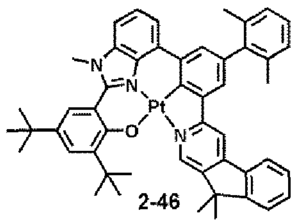
2-46
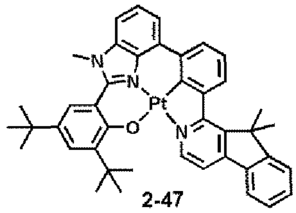
2-47

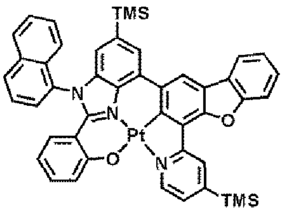
3-1
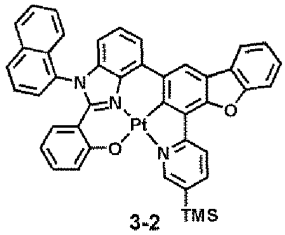
3-2
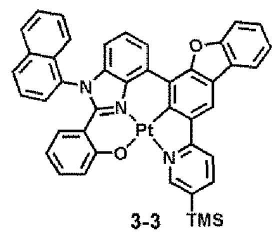
3-3
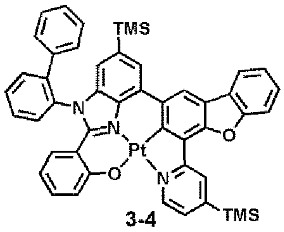
3-4

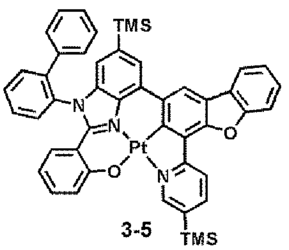
3-5
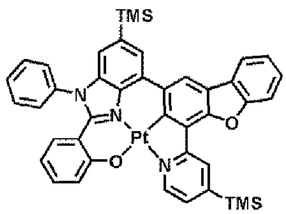
3-6
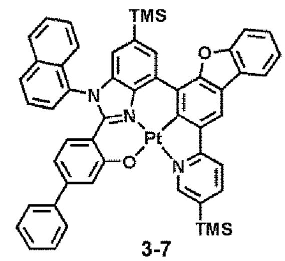
3-7
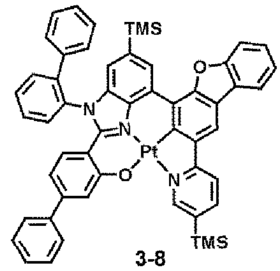
3-8

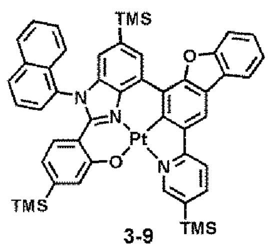
3-9
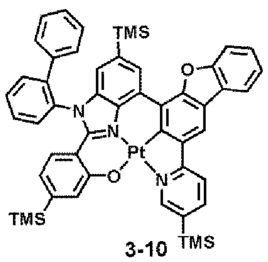
3-10
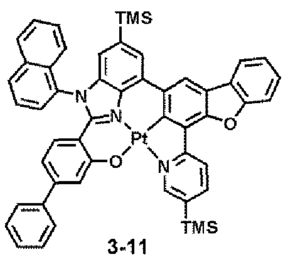
3-11
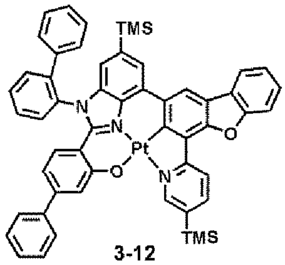
3-12

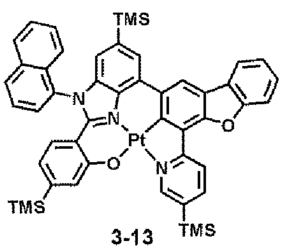
3-13
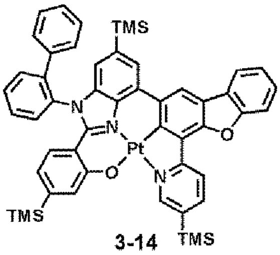
3-14
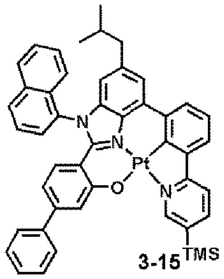
3-15
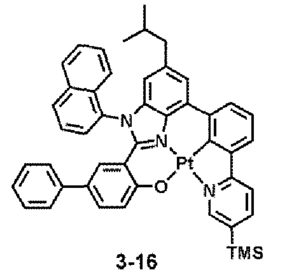
3-16

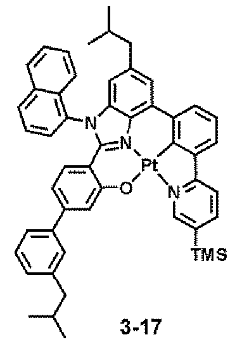
3-17

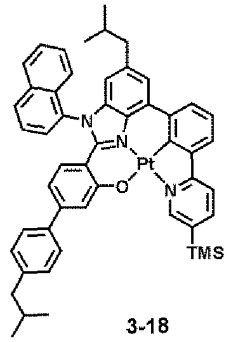
3-18

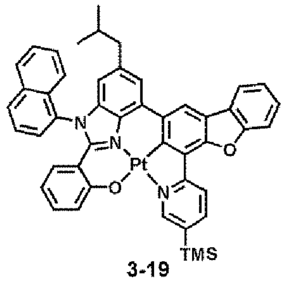
3-19

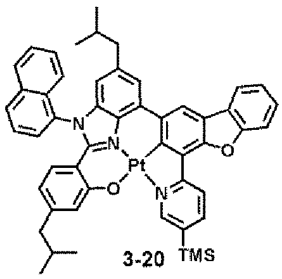
3-20

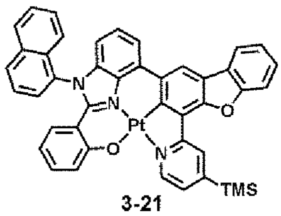
3-21

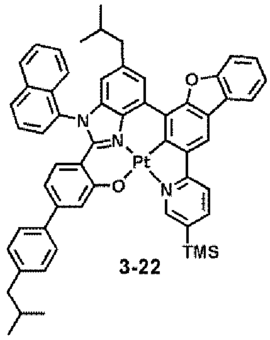
3-22

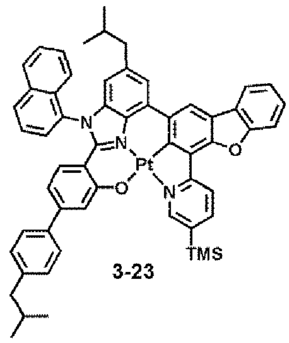
3-23

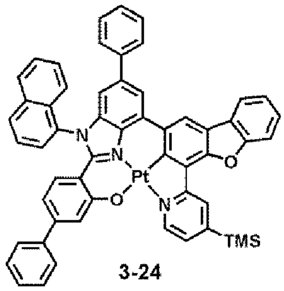
3-24

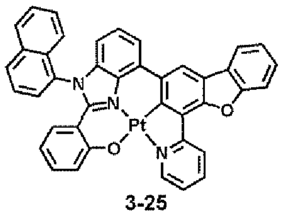
3-25

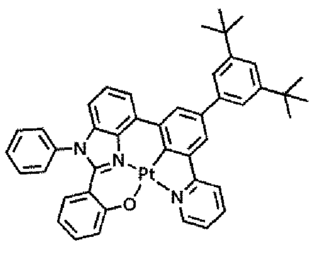
3-26

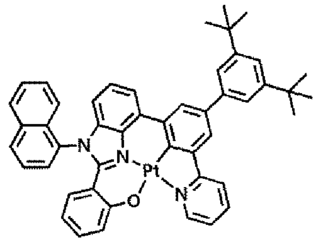
3-27

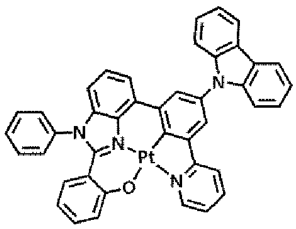
3-28

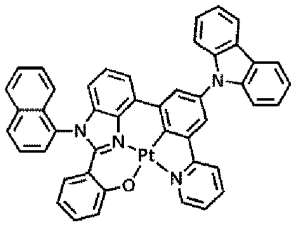
3-29

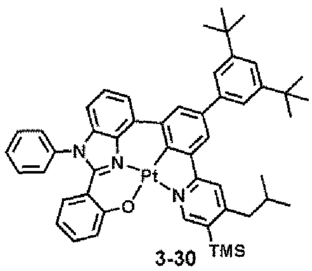
3-30

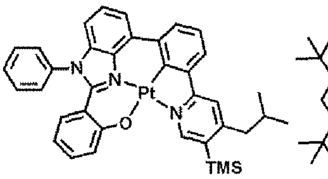
3-31

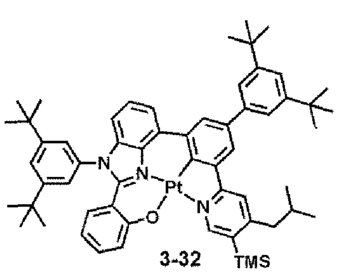
3-32

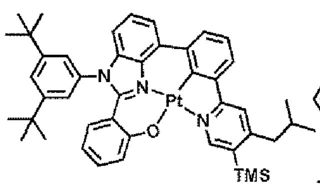
3-33

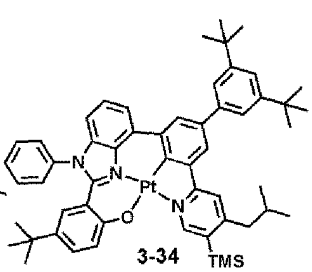
3-34

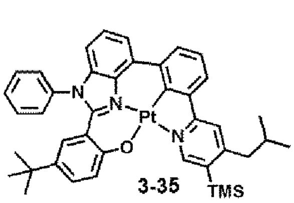
3-35

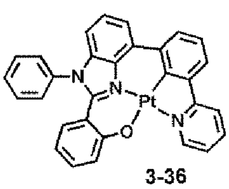
3-36

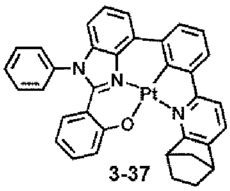
3-37

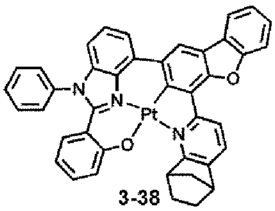
3-38

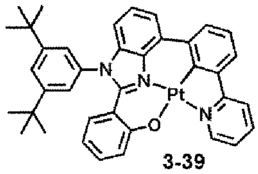
3-39

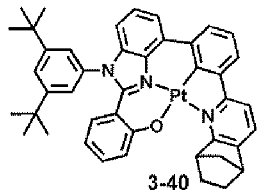
3-40

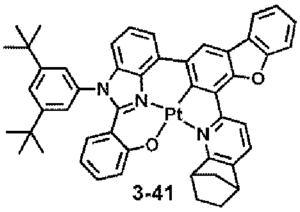
3-41

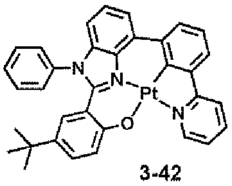
3-42

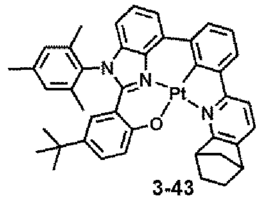
3-43

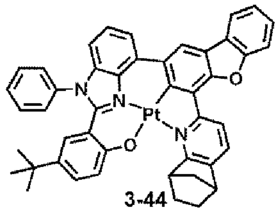
3-44

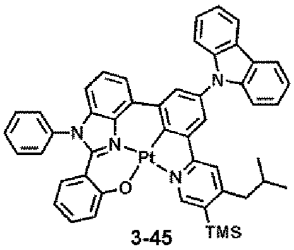
3-45

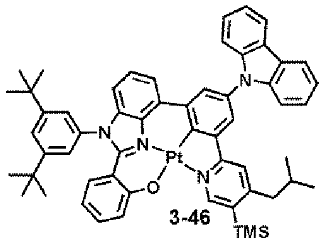
3-46

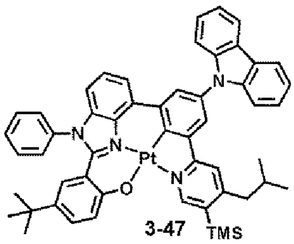
3-47

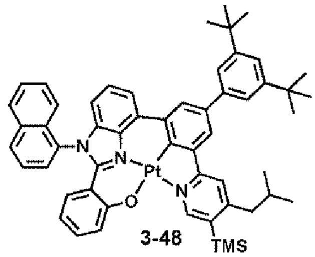
3-48

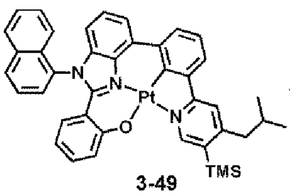
3-49

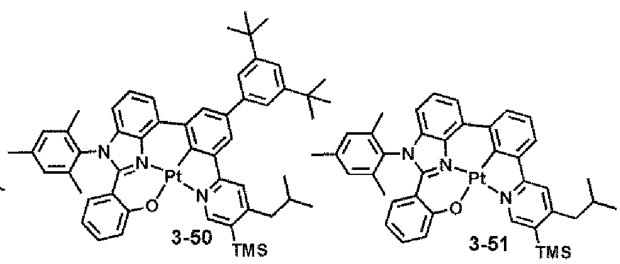
3-50

3-51

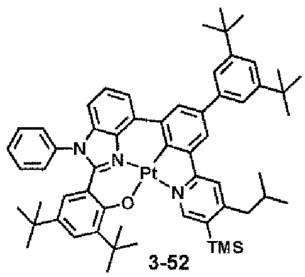
3-52

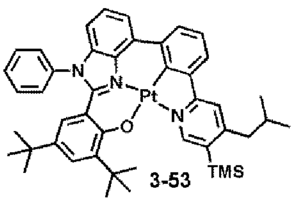
3-53

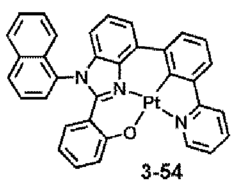
3-54

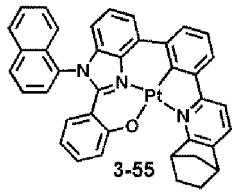
3-55

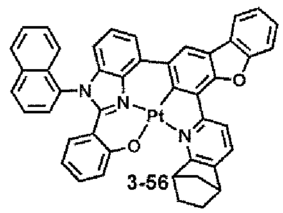
3-56

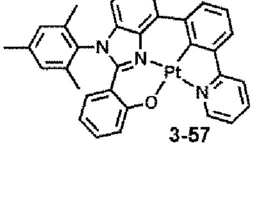
3-57

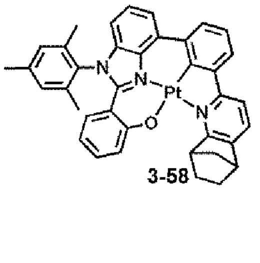
3-58

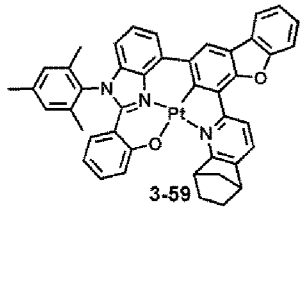
3-59

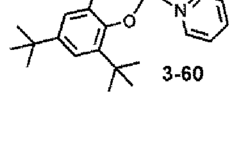
3-60

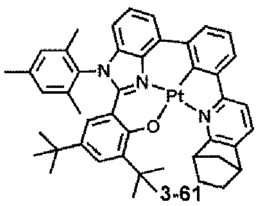
3-61

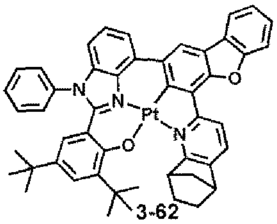
3-62

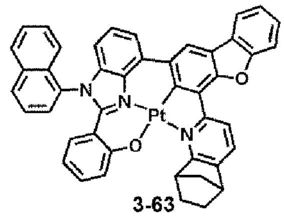
3-63

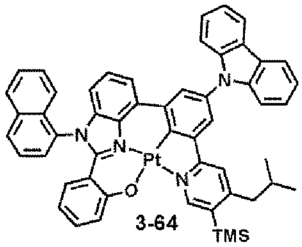
3-64

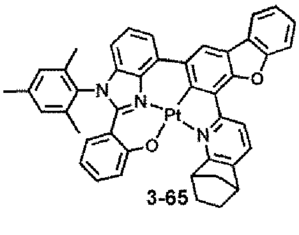
3-65

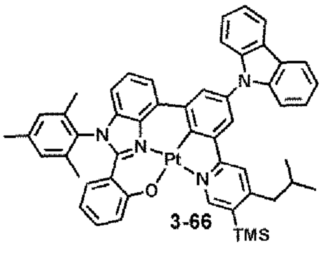
3-66

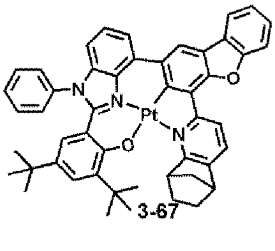
3-67

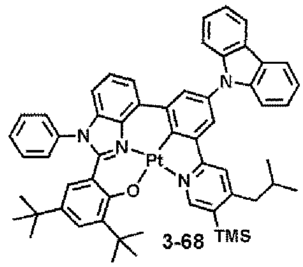
3-68

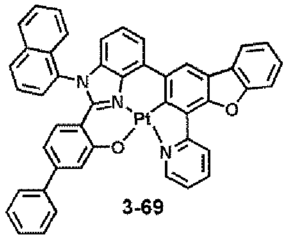
3-69

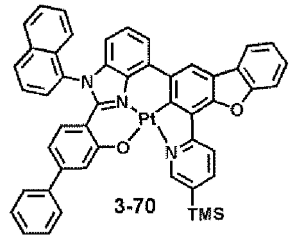
3-70

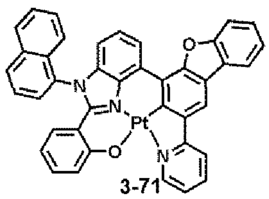
3-71

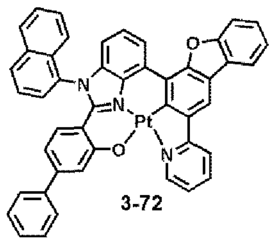
3-72

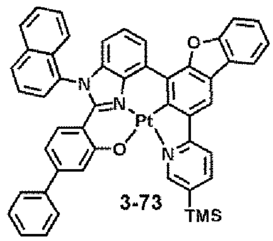
3-73

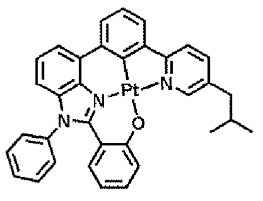
3-74

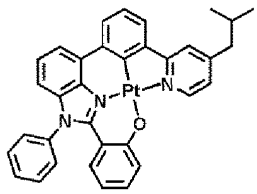
3-75

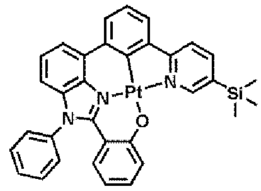
3-76

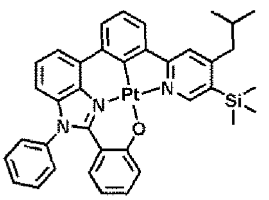
3-77

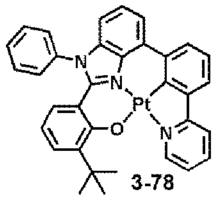
3-78

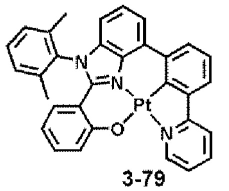
3-79

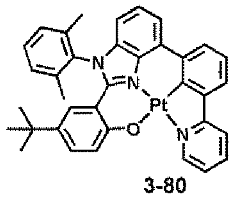
3-80

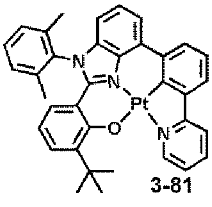
3-81

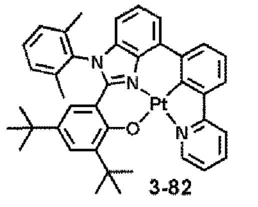
3-82

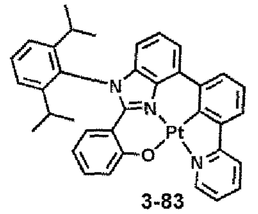
3-83

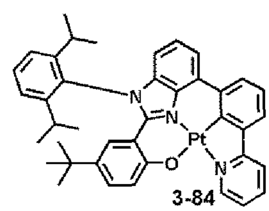
3-84

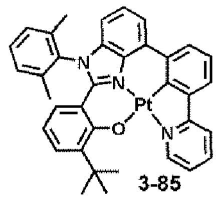
3-85

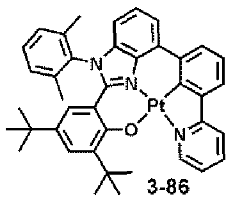
3-86

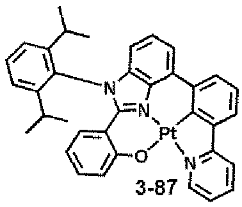
3-87

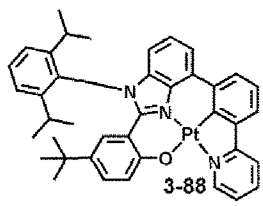
3-88

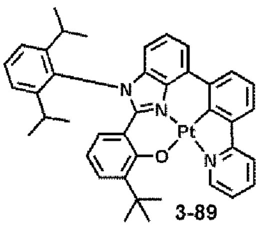
3-89

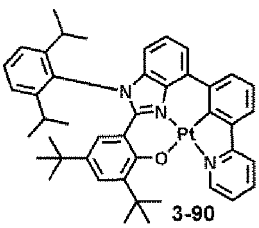
3-90

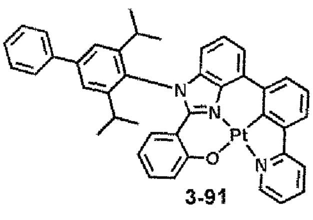
3-91

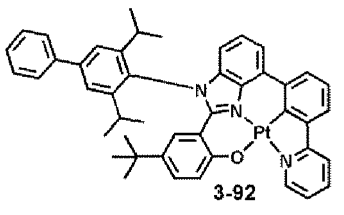
3-92

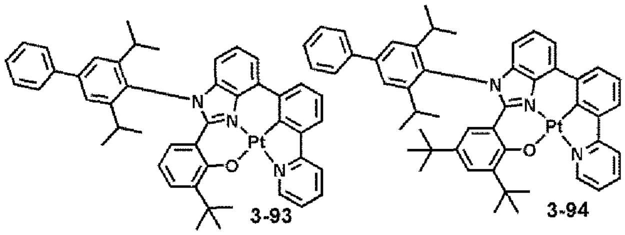
3-93

3-94

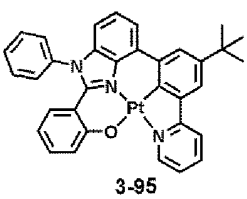
3-95

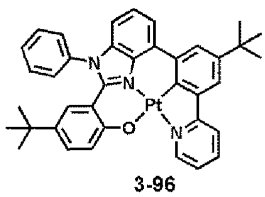
3-96

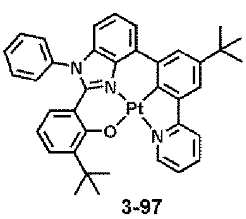
3-97

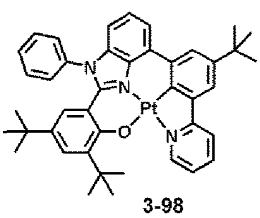
3-98

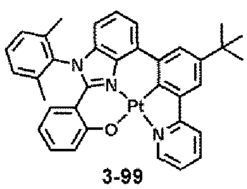
3-99

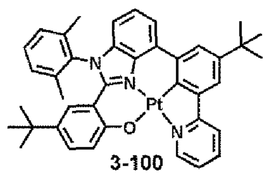
3-100

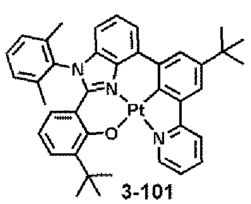
3-101

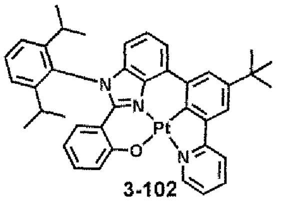
3-102

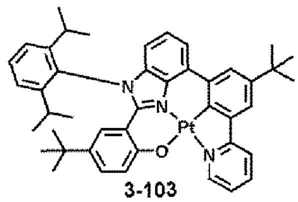
3-103

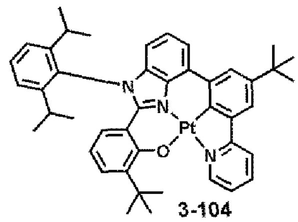
3-104

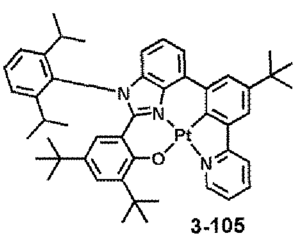
3-105

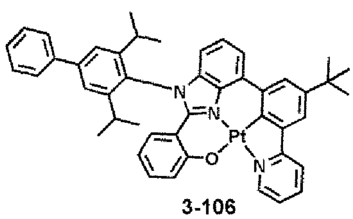
3-106

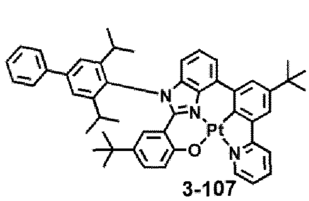
3-107

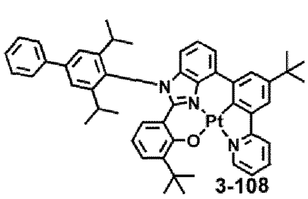
3-108

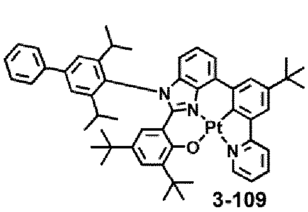
3-109

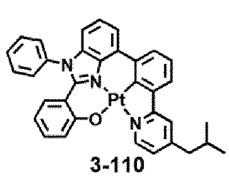
3-110

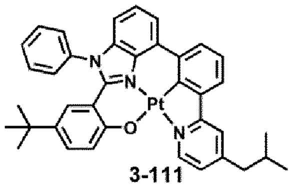
3-111

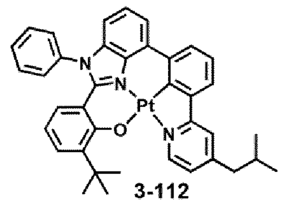
3-112

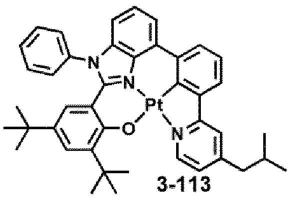
3-113

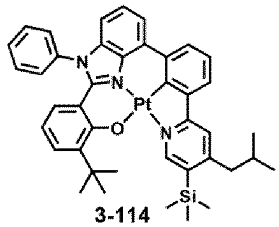
3-114

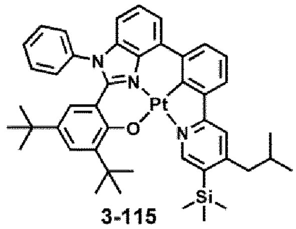
3-115

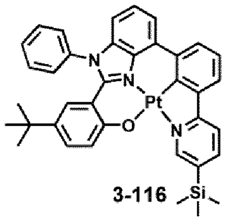
3-116

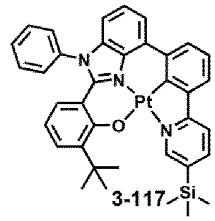
3-117

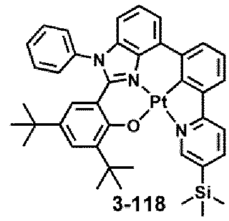
3-118

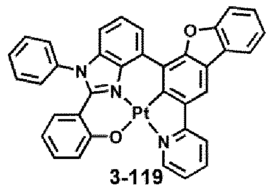
3-119

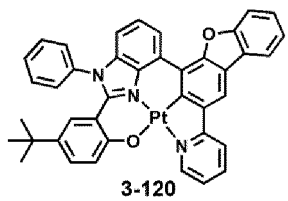
3-120

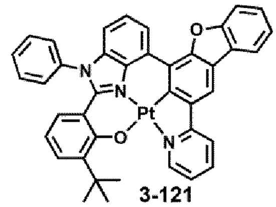
3-121

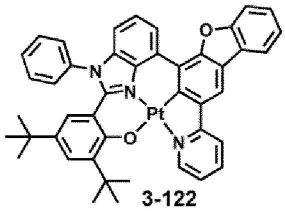
3-122

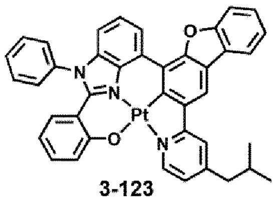
3-123

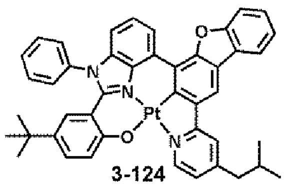
3-124

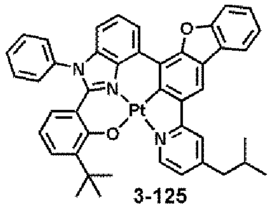
3-125

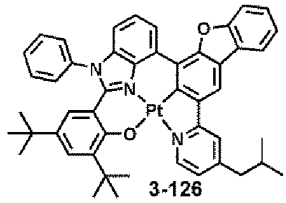
3-126

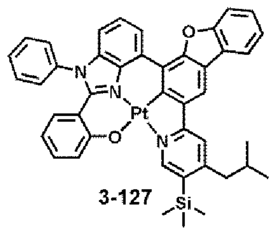
3-127

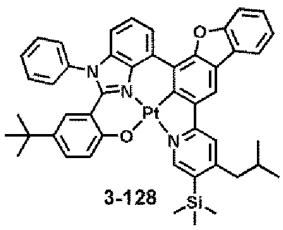
3-128

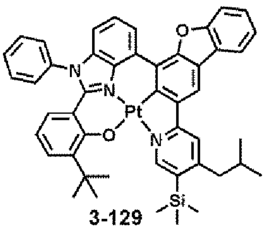
3-129

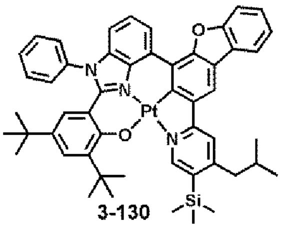
3-130

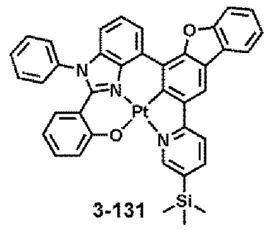
3-131

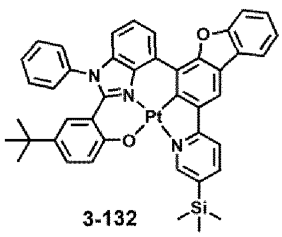
3-132

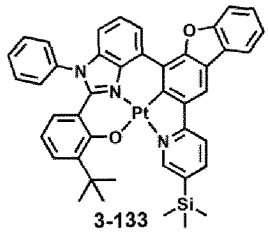
3-133

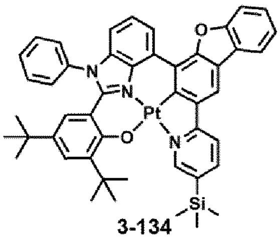
3-134

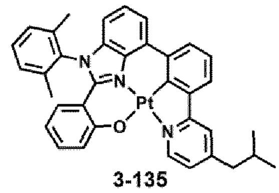
3-135

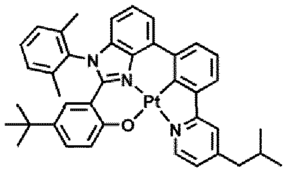
3-136

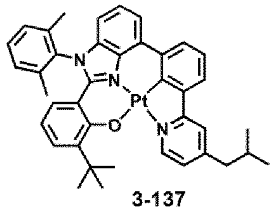
3-137

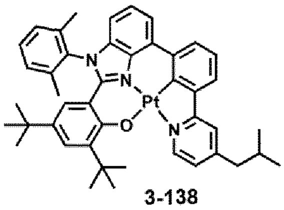
3-138

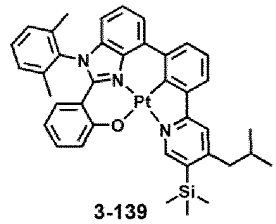
3-139

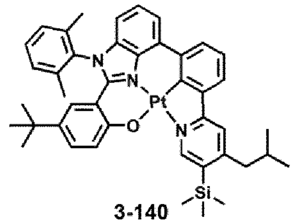
3-140

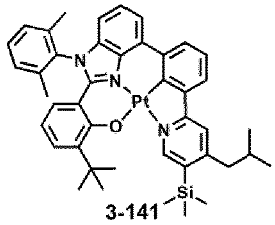
3-141

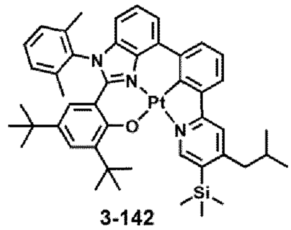
3-142

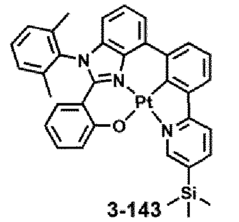
3-143

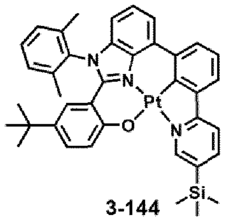
3-144

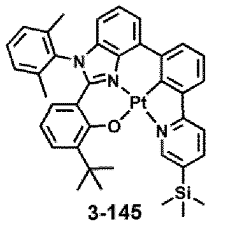
3-145

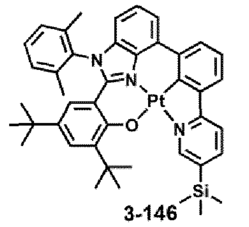
3-146

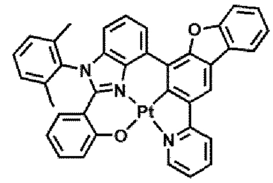
3-147

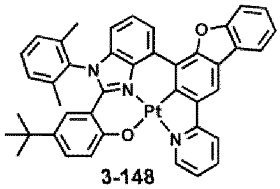
3-148

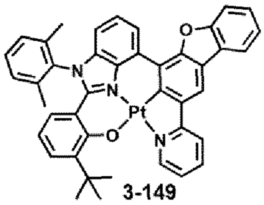
3-149

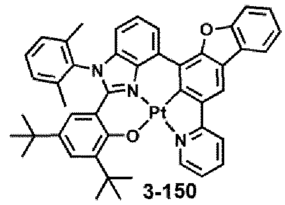
3-150

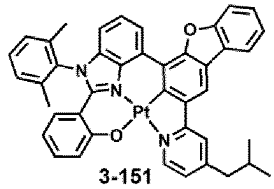
3-151

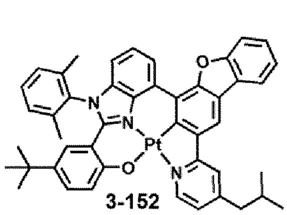
3-152

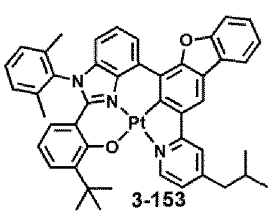
3-153

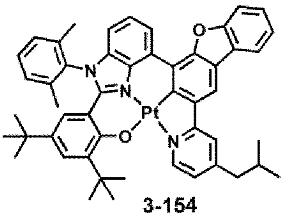
3-154

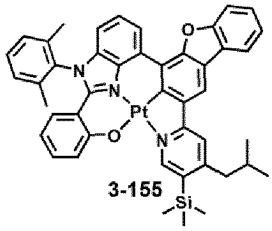
3-155

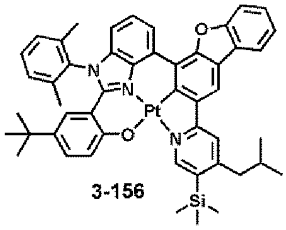
3-156

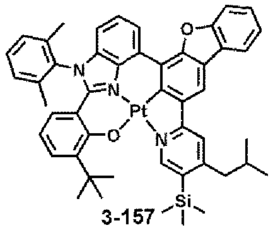
3-157

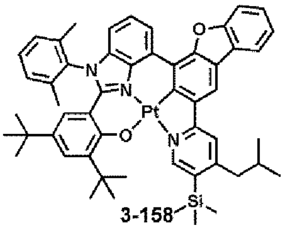
3-158

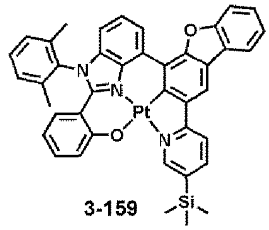
3-159

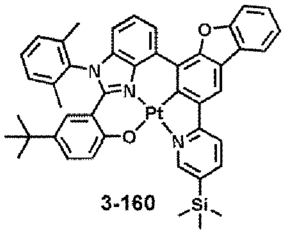
3-160

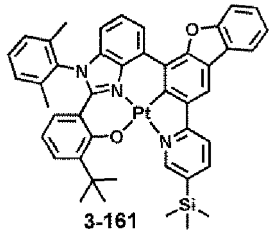
3-161

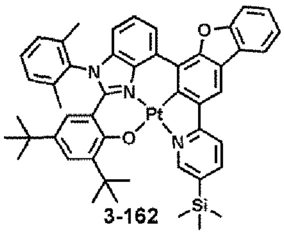
3-162

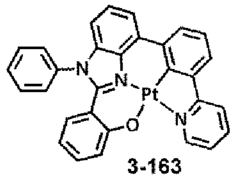
3-163

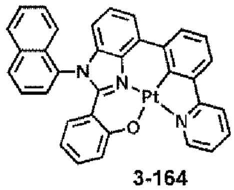
3-164

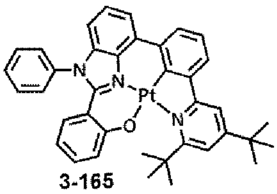
3-165

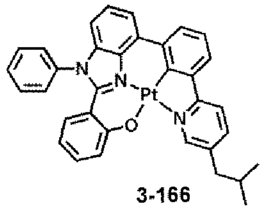
3-166

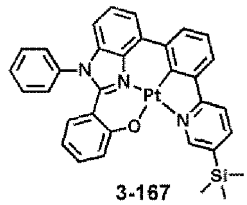
3-167

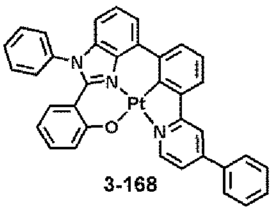
3-168

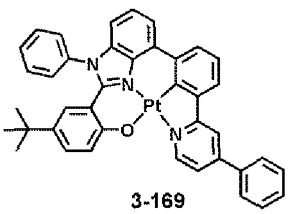
3-169

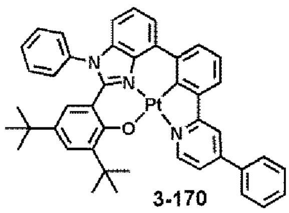
3-170

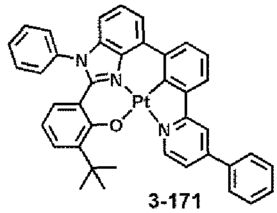
3-171

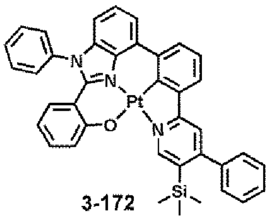
3-172

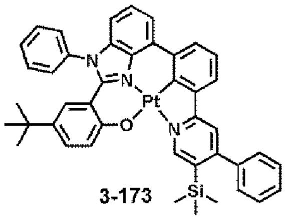
3-173

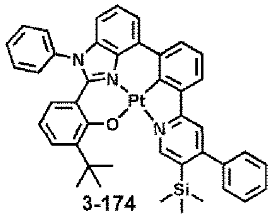
3-174

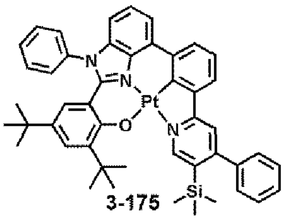
3-175

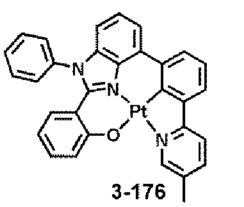
3-176

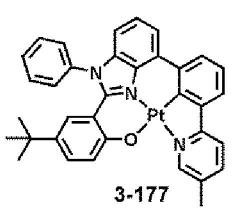
3-177

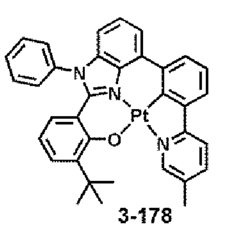
3-178

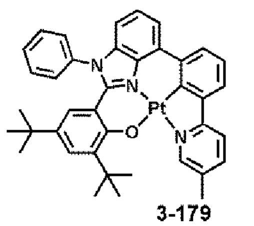
3-179

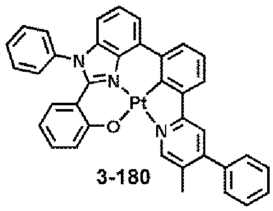
3-180

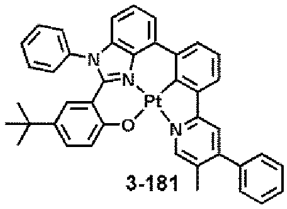
3-181

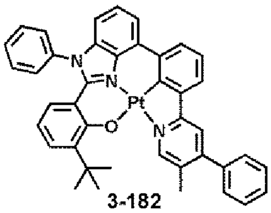
3-182

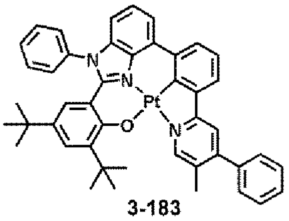
3-183

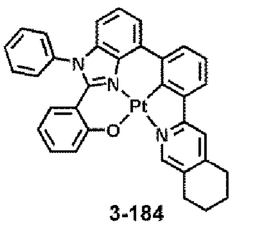
3-184

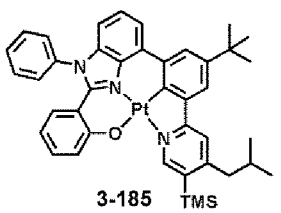
3-185

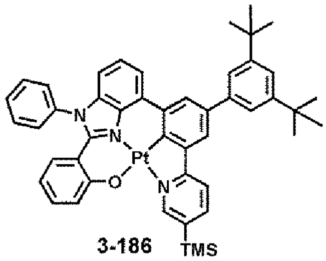
3-186

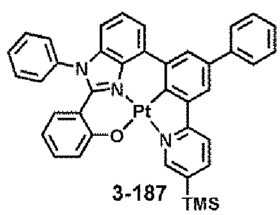
3-187

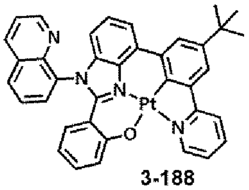
3-188

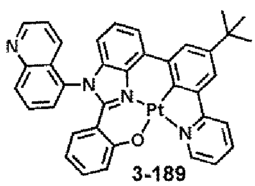
3-189

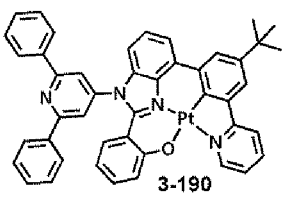
3-190

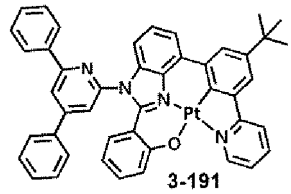
3-191

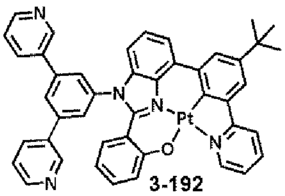
3-192

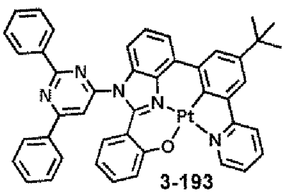
3-193

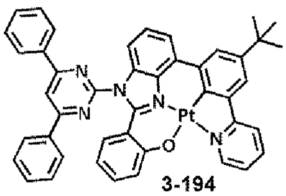
3-194

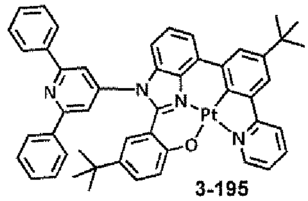
3-195

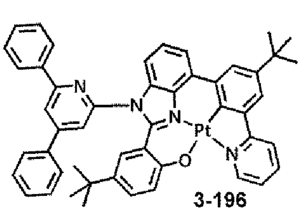
3-196

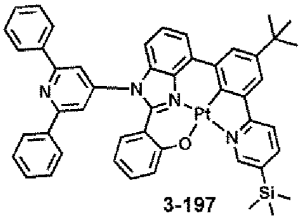
3-197

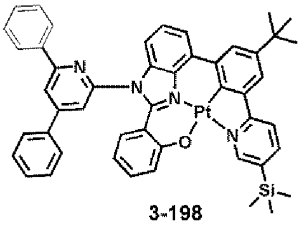
3-198

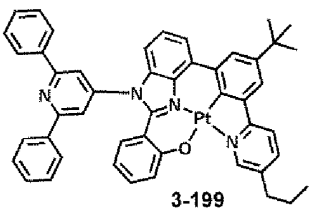
3-199

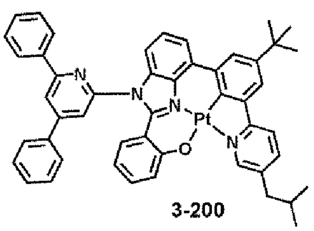
3-200

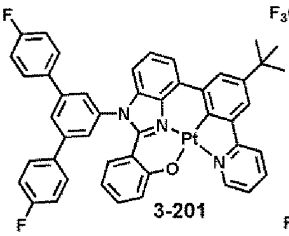
3-201

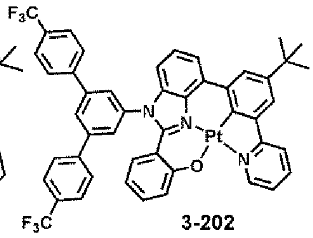
3-202

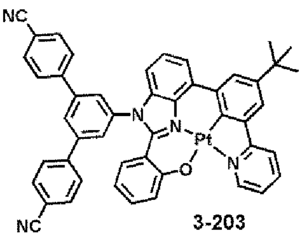
3-203

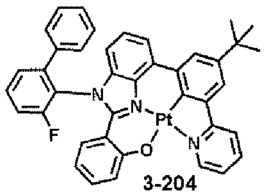
3-204

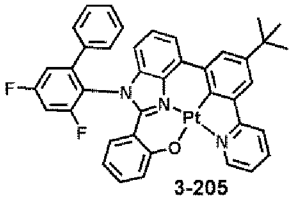
3-205

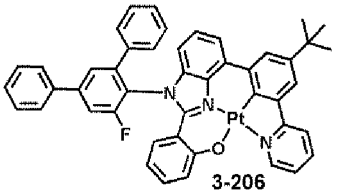
3-206

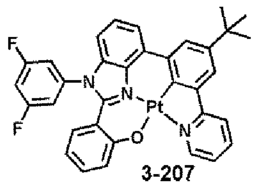
3-207

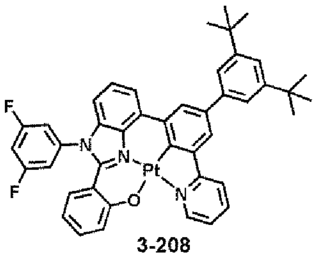
3-208

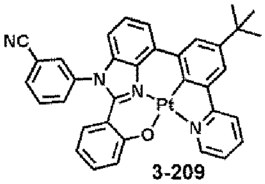
3-209

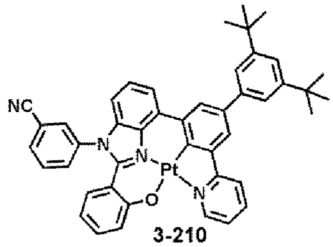
3-210

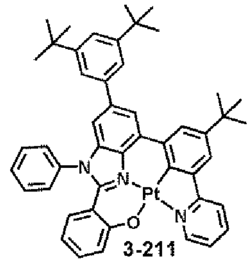
3-211

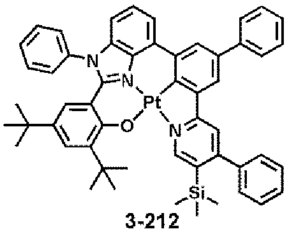
3-212

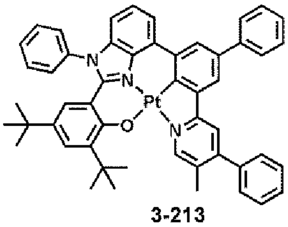
3-213

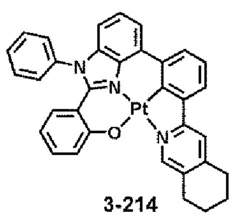
3-214

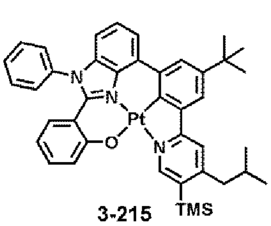
3-215

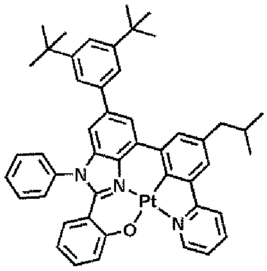
3-216

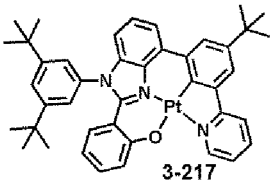
3-217

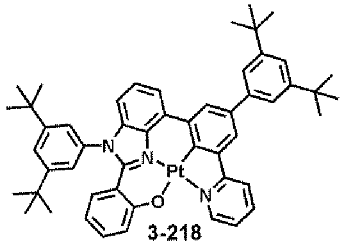
3-218

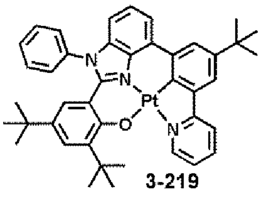
3-219

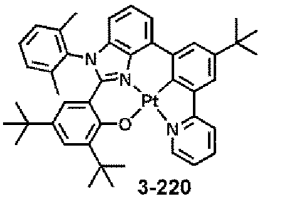
3-220

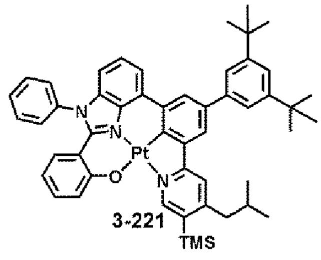
3-221

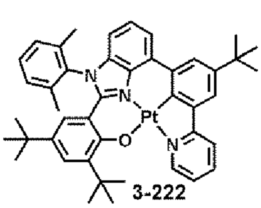
3-222

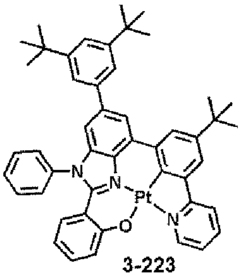
3-223

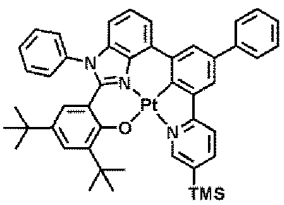
3-224

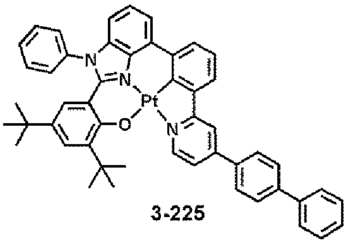
3-225

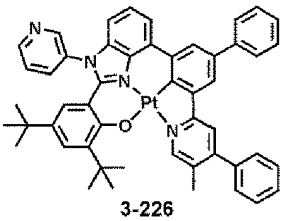
3-226

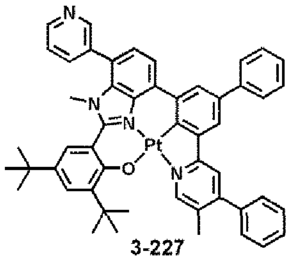
3-227

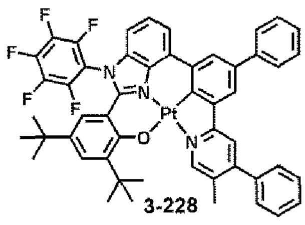
3-228

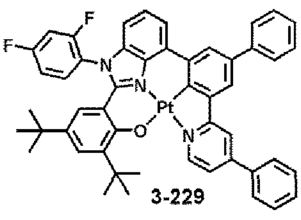
3-229

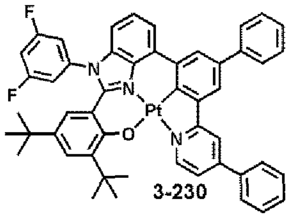
3-230

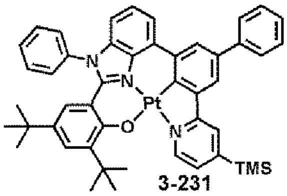
3-231

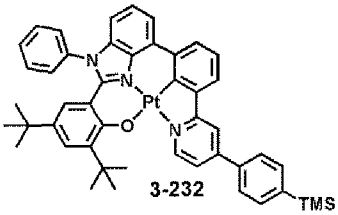
3-232

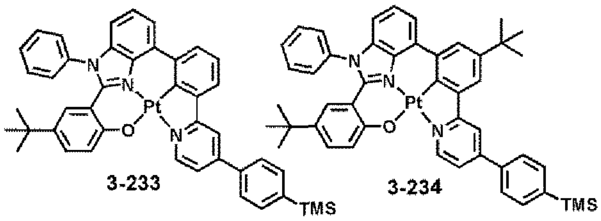
3-233

3-234

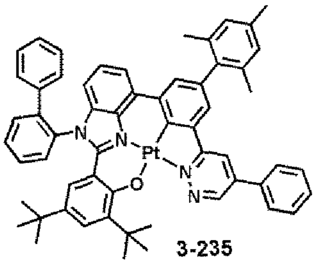
3-235

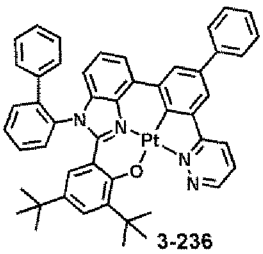
3-236

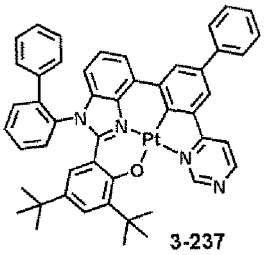
3-237

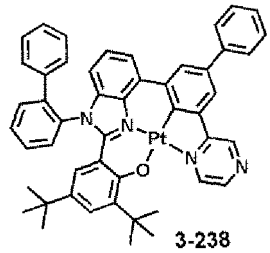
3-238

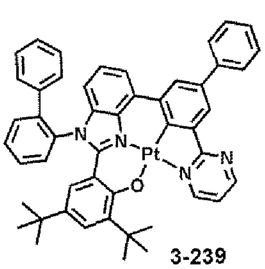
3-239

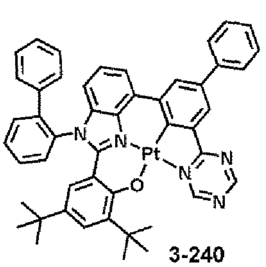
3-240

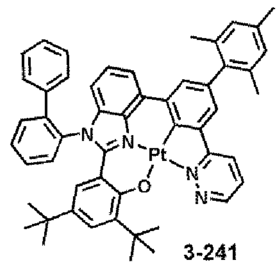
3-241

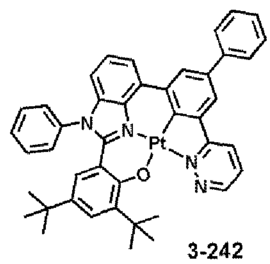
3-242

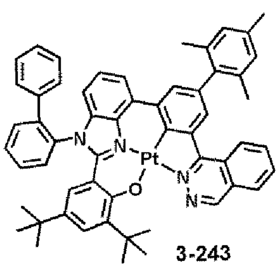
3-243

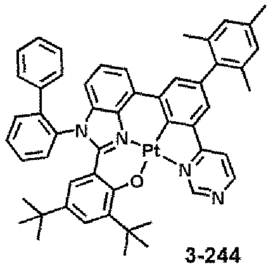
3-244

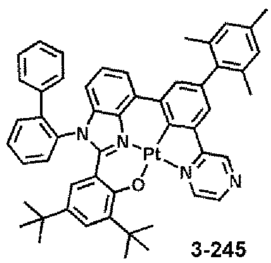
3-245

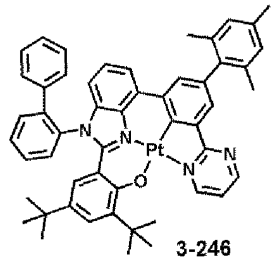
3-246

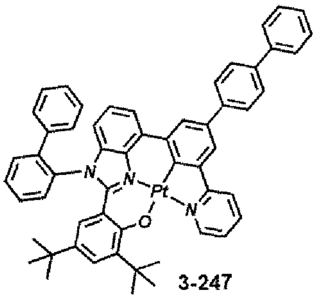
3-247

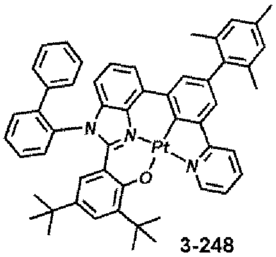
3-248

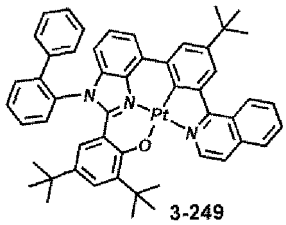
3-249

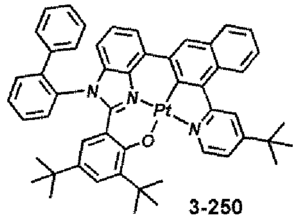
3-250

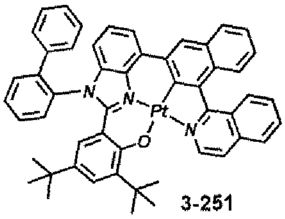
3-251

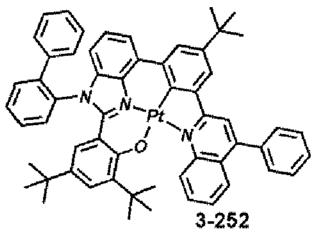
3-252

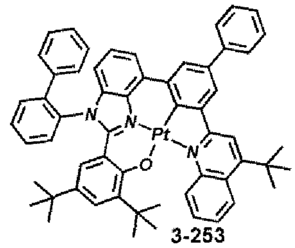
3-253

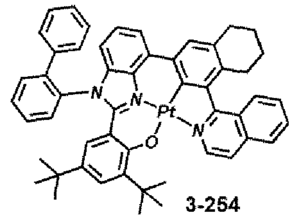
3-254

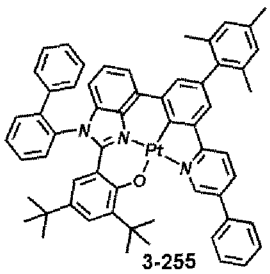
3-255

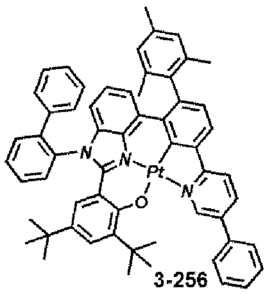
3-256

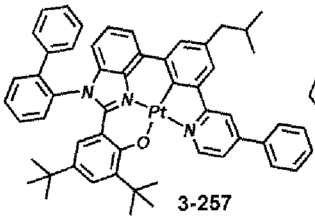
3-257

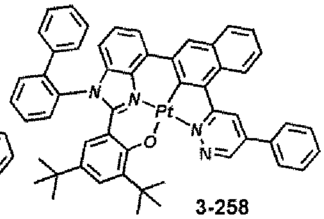
3-258

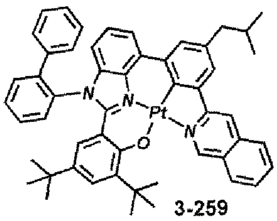
3-259

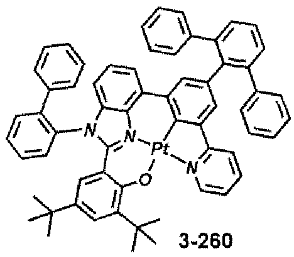
3-260

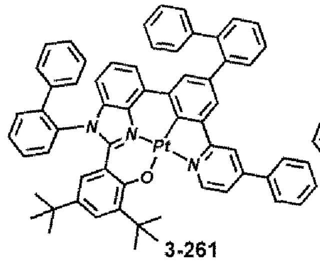
3-261

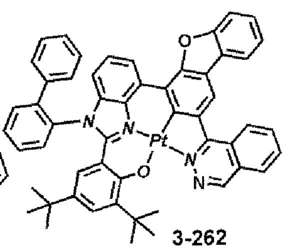
3-262

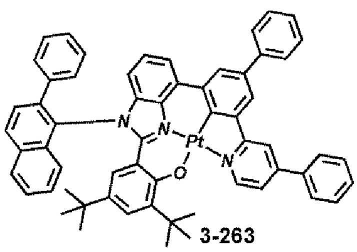
3-263

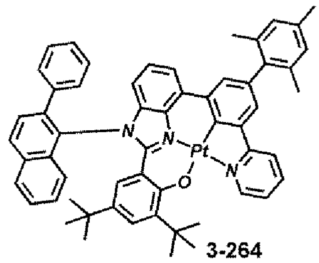
3-264

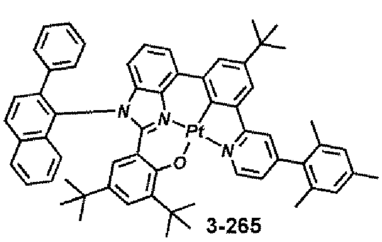
3-265

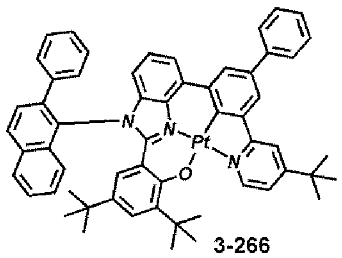
3-266

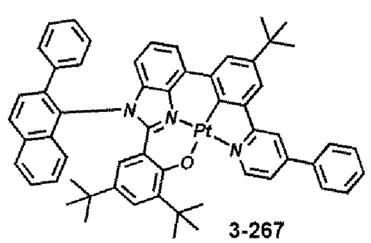
3-267

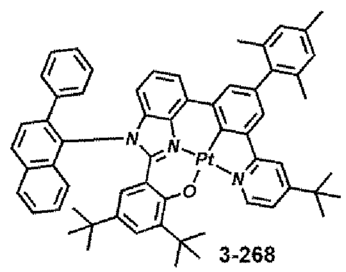
3-268

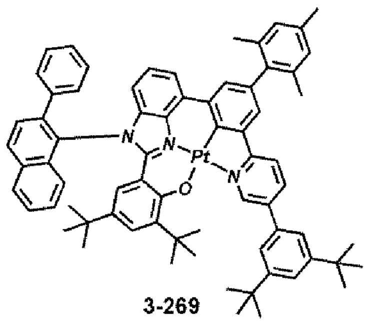
3-269

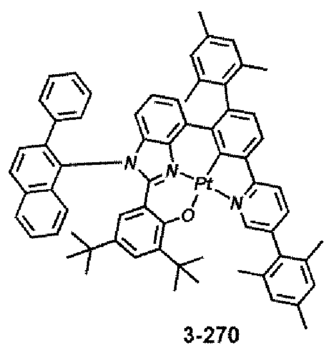
3-270

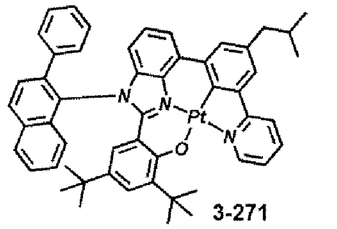
3-271

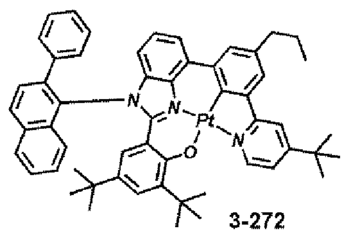
3-272

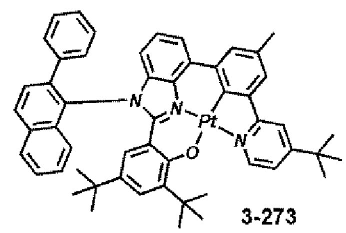
3-273

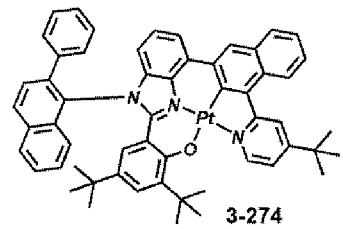
3-274

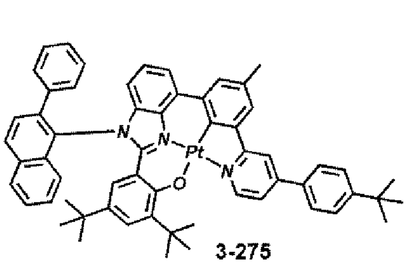
3-275

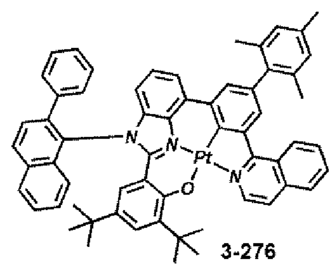
3-276

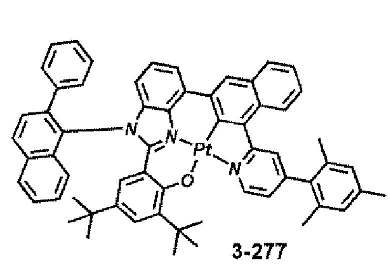
3-277

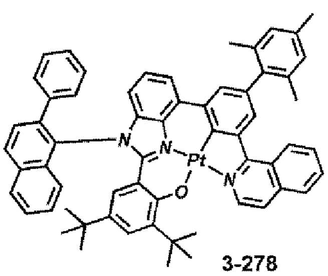
3-278

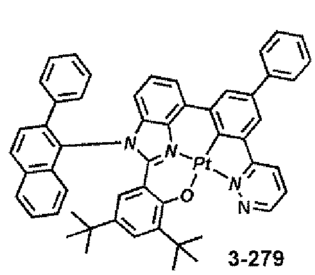
3-279

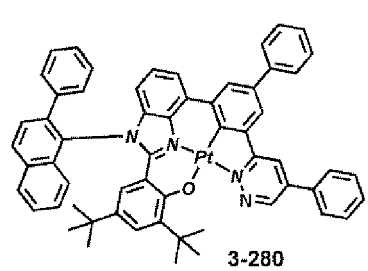
3-280

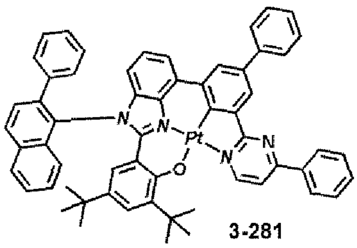
3-281

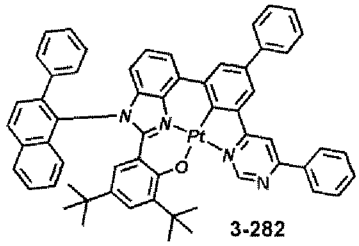
3-282

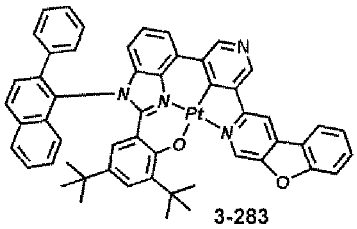
3-283

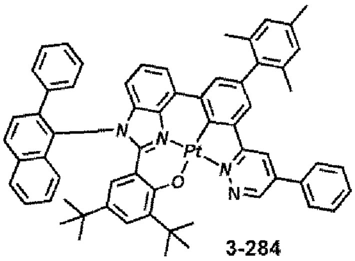
3-284

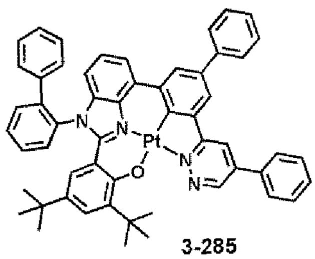
3-285

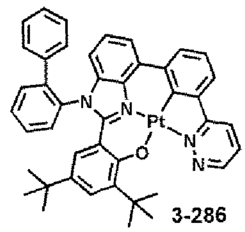
3-286

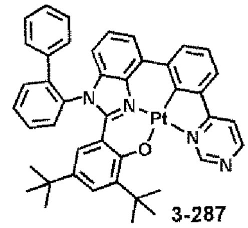
3-287

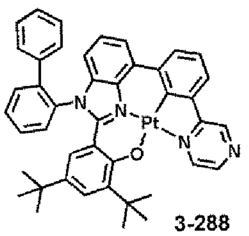
3-288

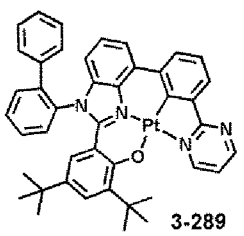
3-289

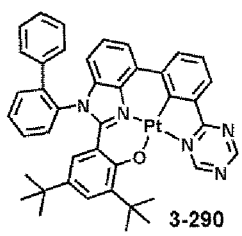
3-290

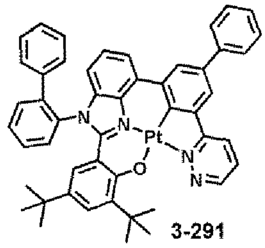
3-291

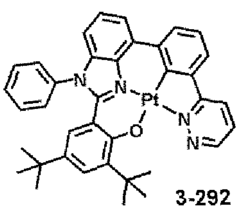
3-292

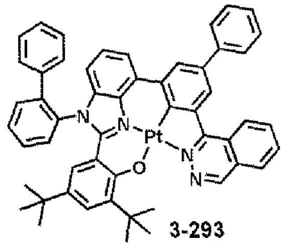
3-293

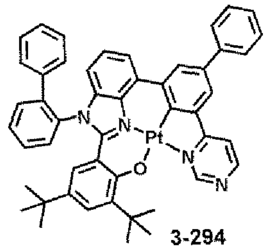
3-294

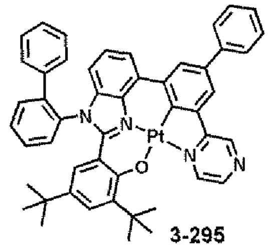
3-295

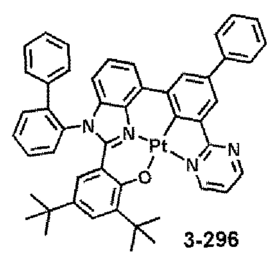
3-296

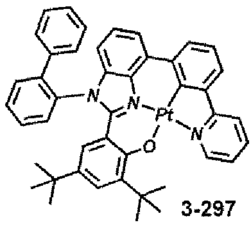
3-297

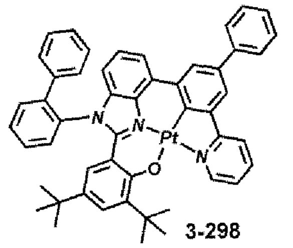
3-298

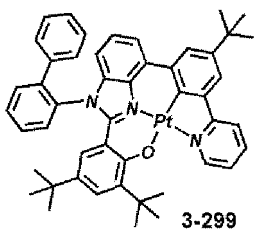
3-299

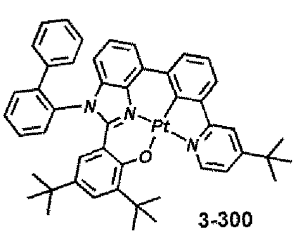
3-300

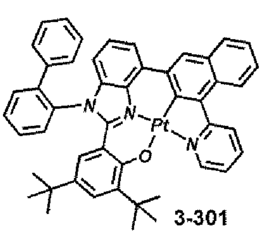
3-301

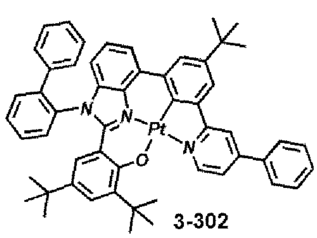
3-302

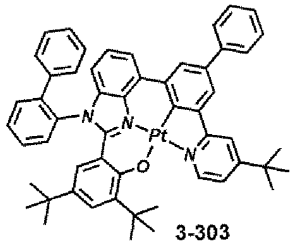
3-303

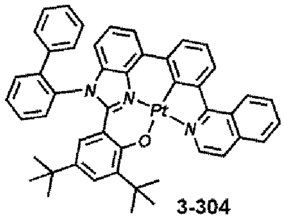
3-304

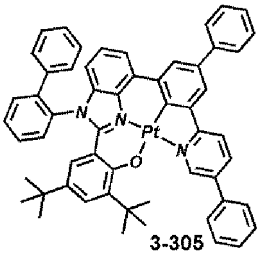
3-305

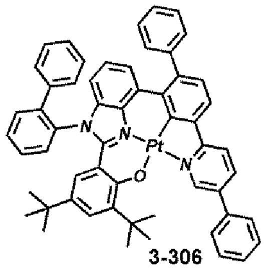
3-306

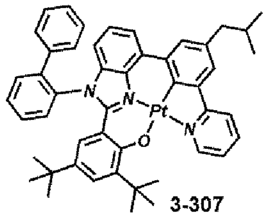
3-307

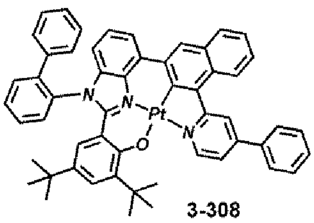
3-308

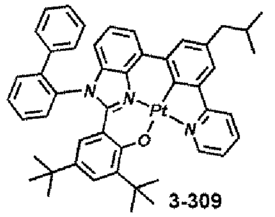
3-309

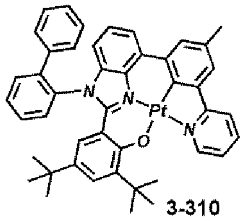
3-310

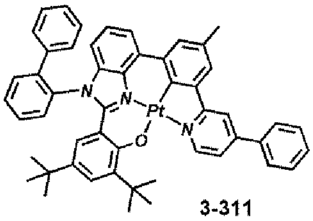
3-311

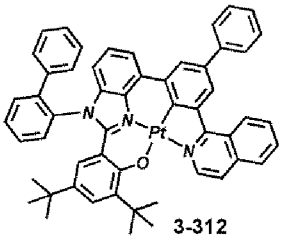
3-312

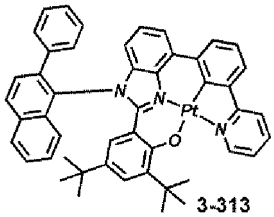
3-313

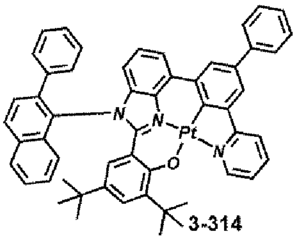
3-314

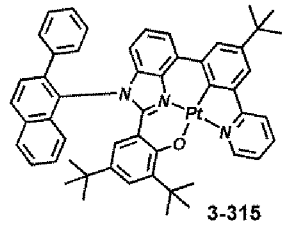
3-315

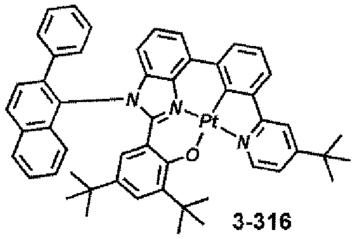
3-316

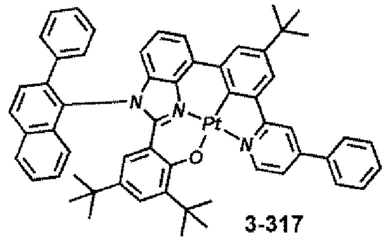
3-317

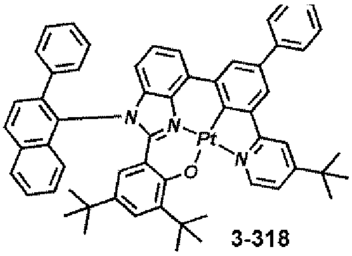
3-318

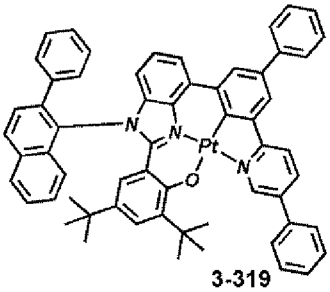
3-319

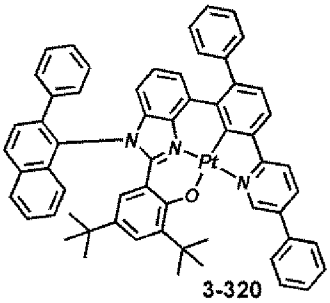
3-320

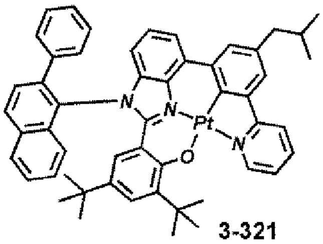
3-321

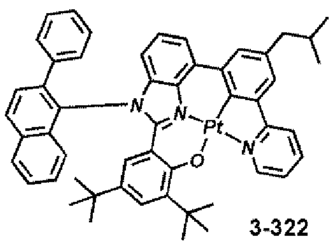
3-322

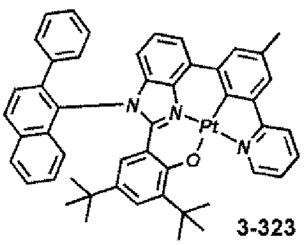
3-323

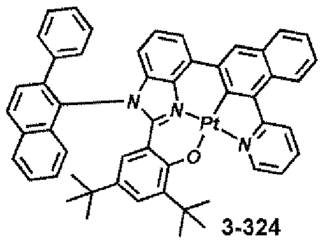
3-324

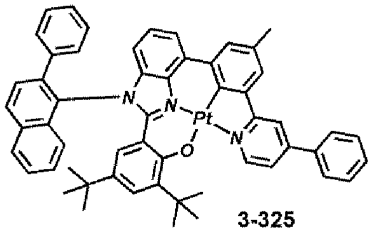
3-325

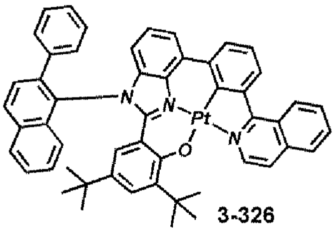
3-326

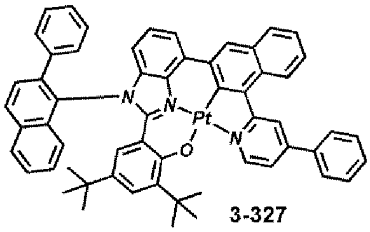
3-327

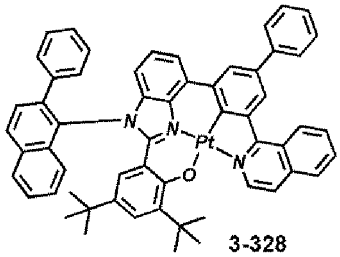
3-328

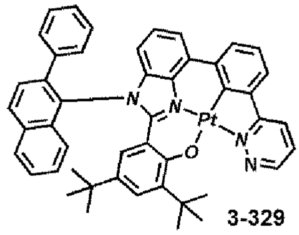
3-329

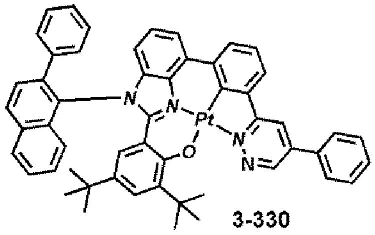
3-330

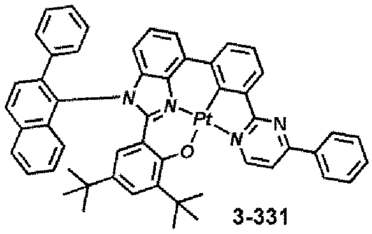
3-331

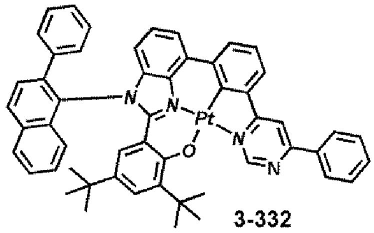
3-332

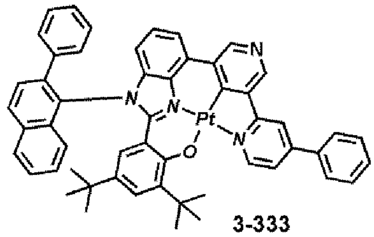
3-333

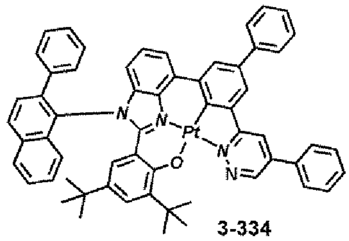
3-334

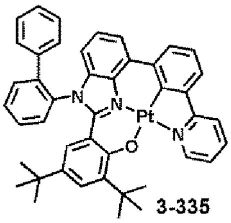
3-335

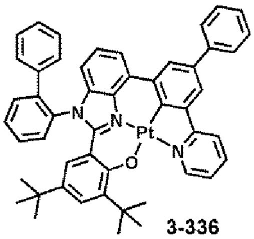
3-336

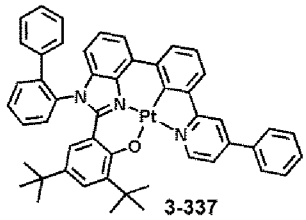
3-337

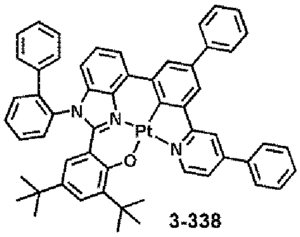
3-338

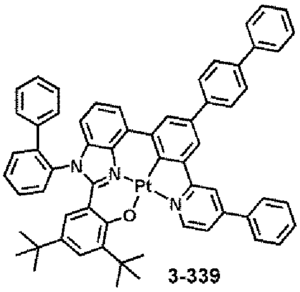
3-339

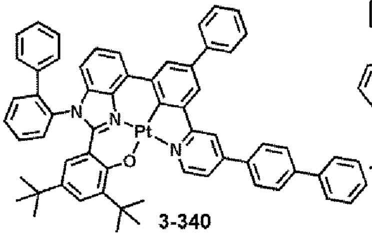
3-340

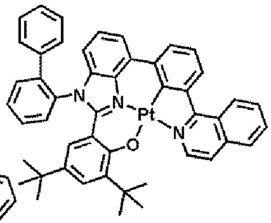
3-341

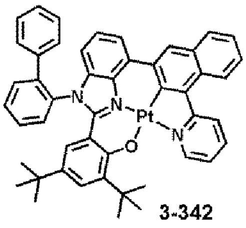
3-342

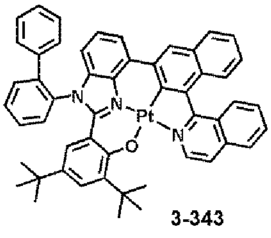
3-343

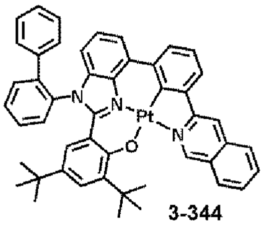
3-344

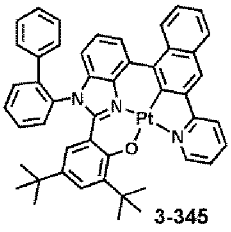
3-345

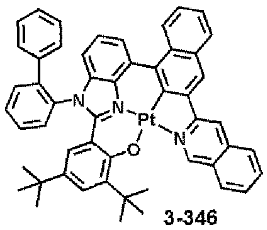
3-346

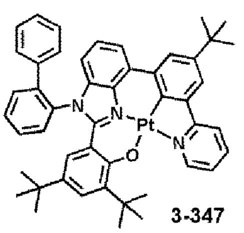
3-347

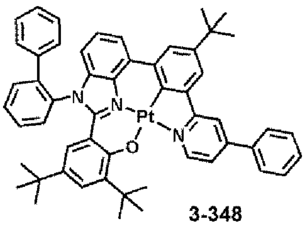
3-348

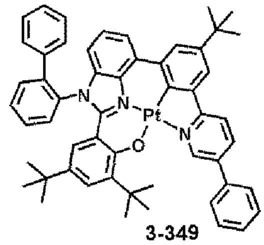
3-349

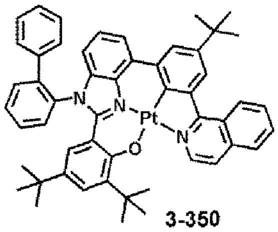
3-350

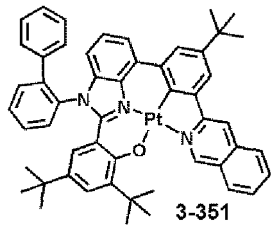
3-351

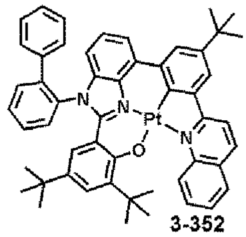
3-352

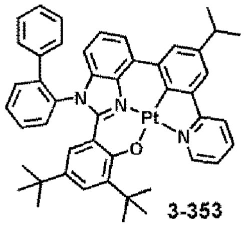
3-353

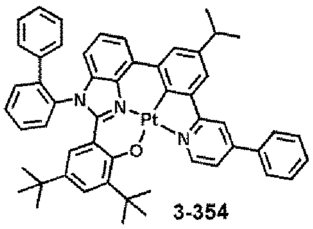
3-354

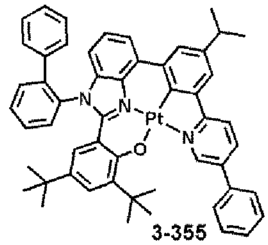
3-355

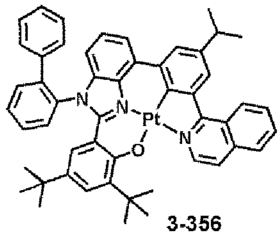
3-356

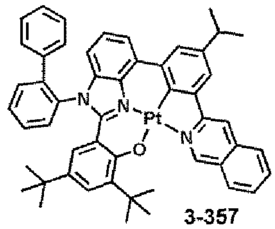
3-357

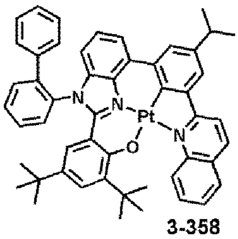
3-358

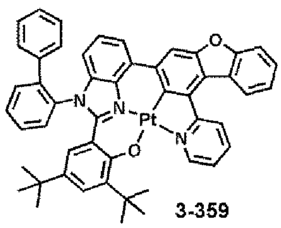
3-359

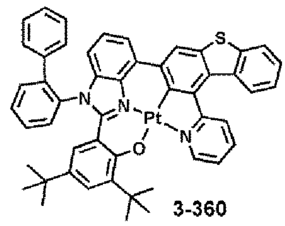
3-360

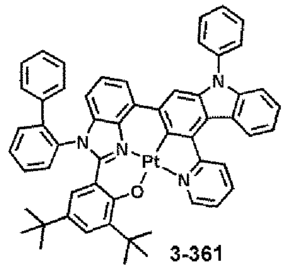
3-361

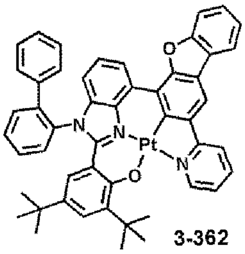
3-362

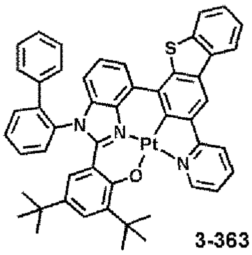
3-363

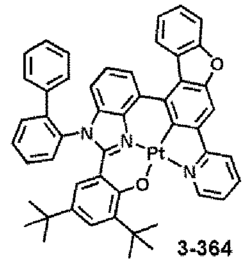
3-364

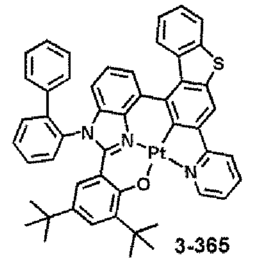
3-365

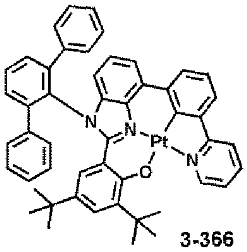
3-366

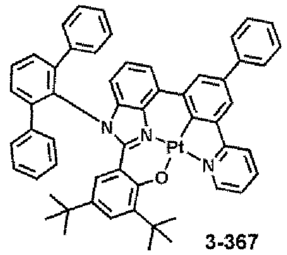
3-367

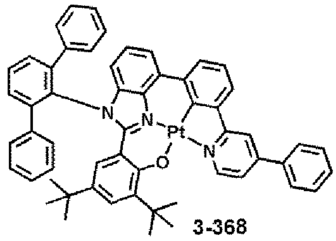
3-368

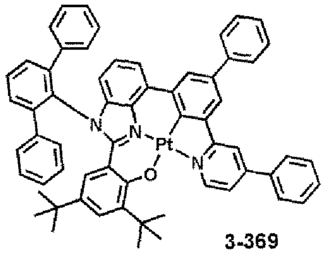
3-369

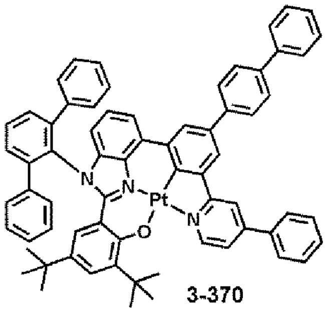

3-370

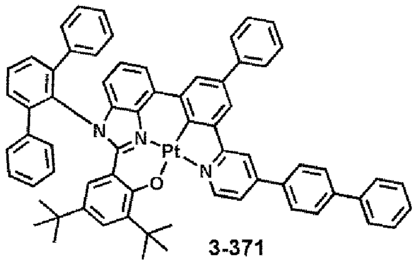

3-371

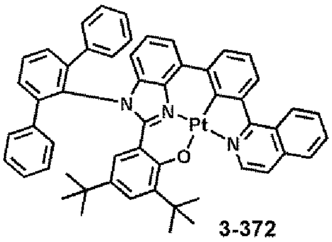

3-372

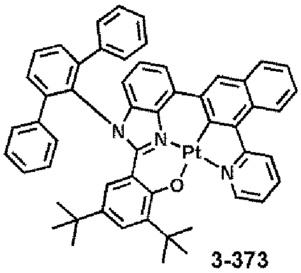

3-373

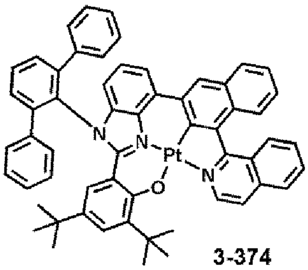

3-374

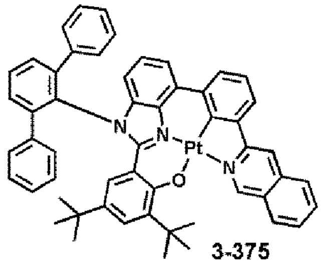

3-375

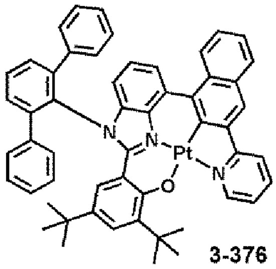

3-376

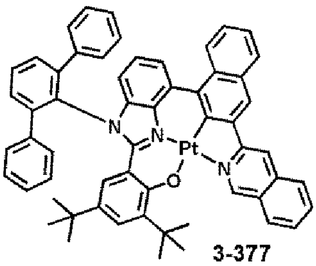

3-377

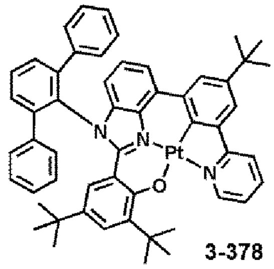

3-378

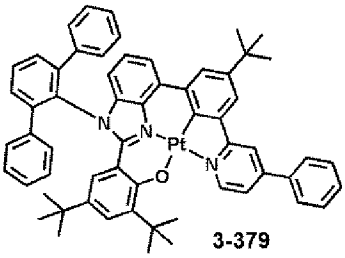

3-379

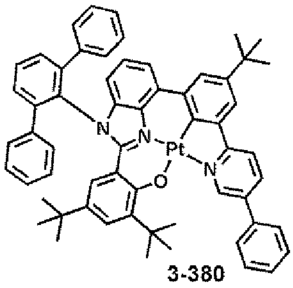

3-380

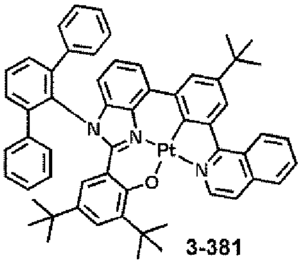

3-381

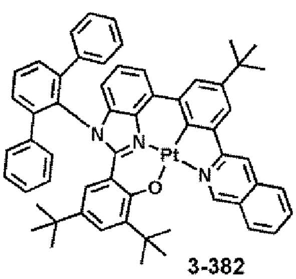

3-382

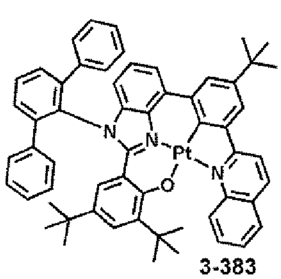

3-383

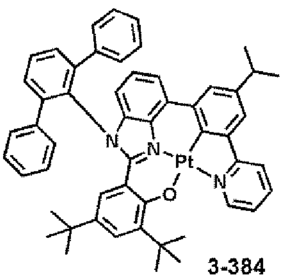

3-384

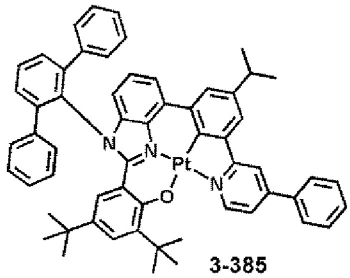
3-385

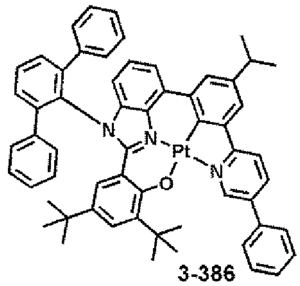
3-386

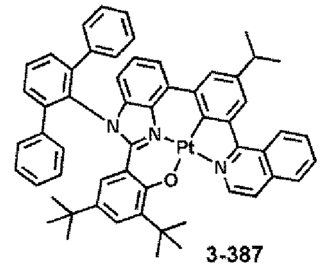
3-387

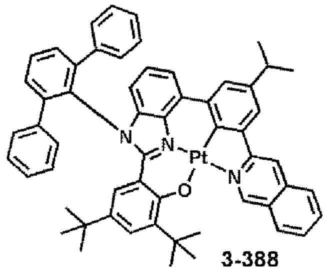
3-388

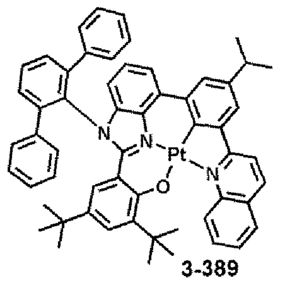
3-389

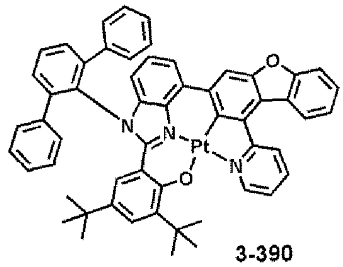
3-390

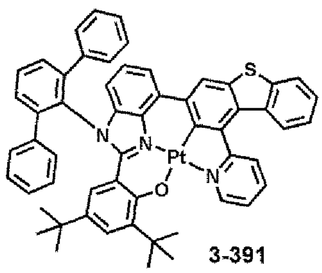
3-391

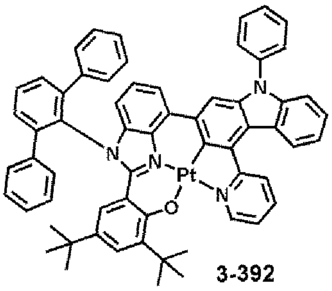
3-392

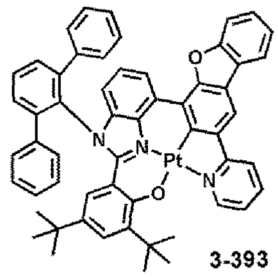
3-393

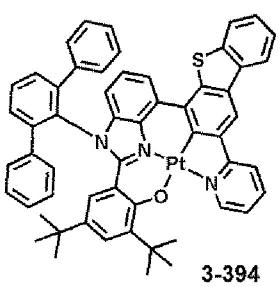
3-394

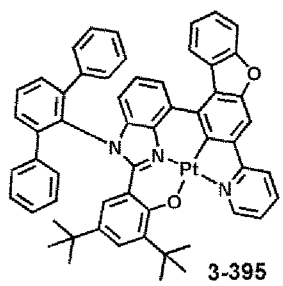
3-395

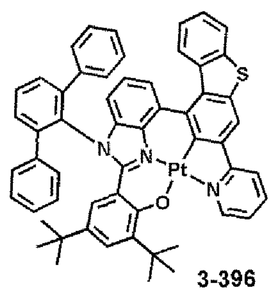
3-396

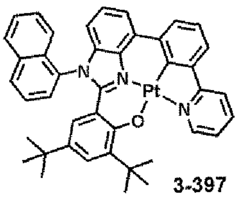
3-397

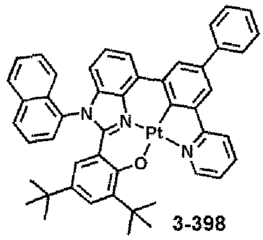
3-398

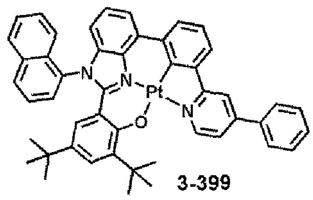
3-399

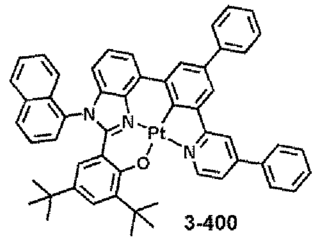
3-400

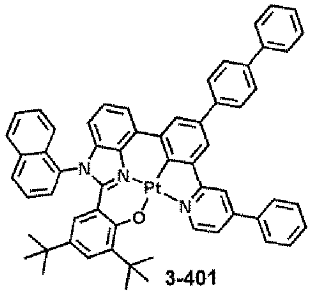
3-401

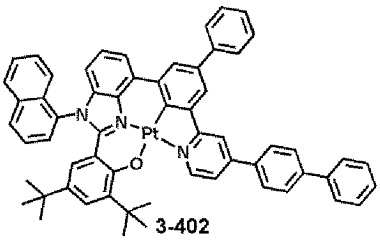
3-402

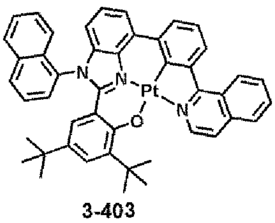
3-403

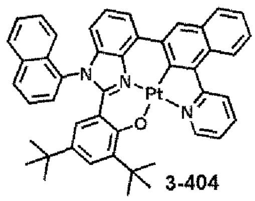
3-404

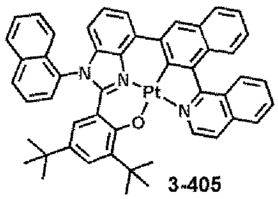
3-405

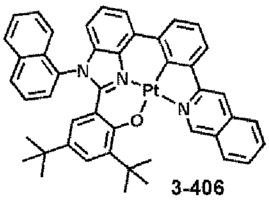
3-406

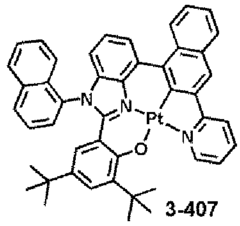
3-407

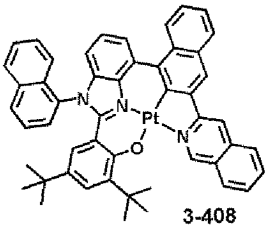
3-408

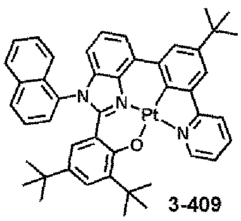
3-409

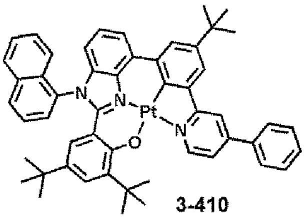
3-410

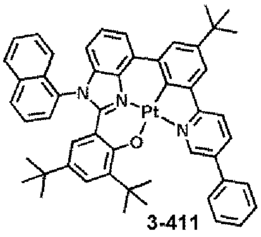
3-411

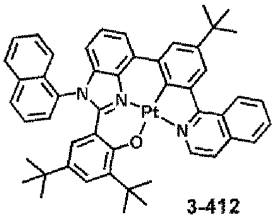
3-412

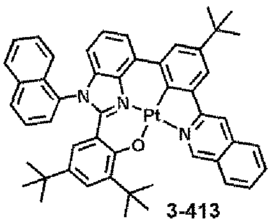
3-413

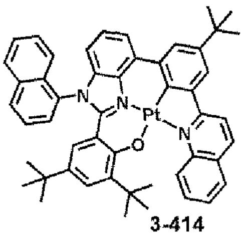
3-414

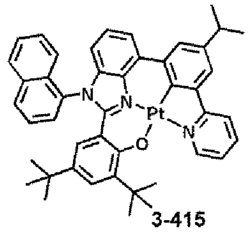
3-415

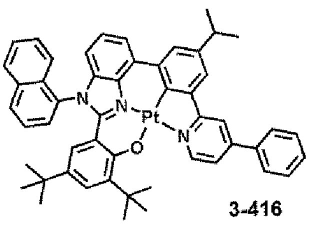
3-416

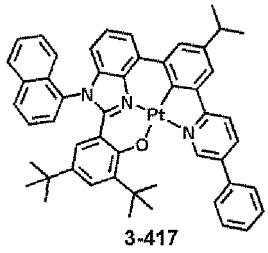
3-417

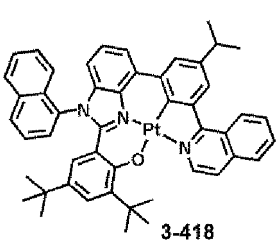
3-418

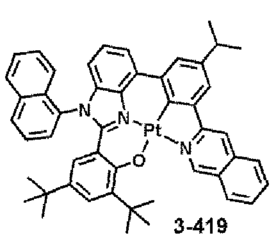
3-419

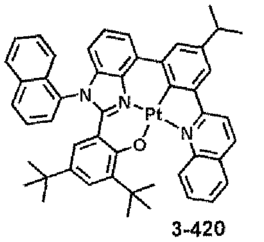
3-420

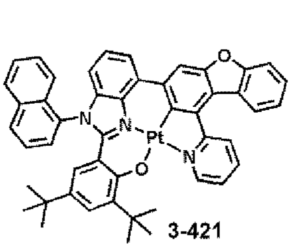
3-421

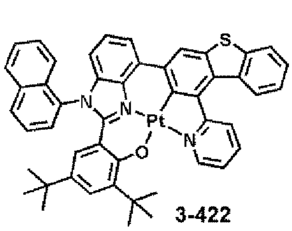
3-422

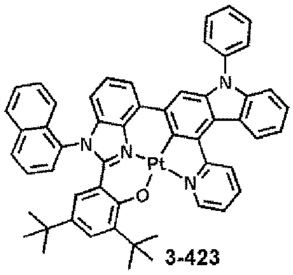
3-423

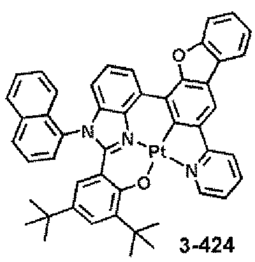
3-424

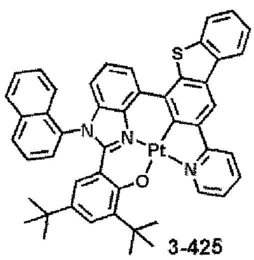
3-425

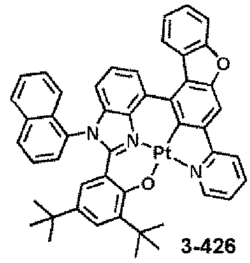
3-426

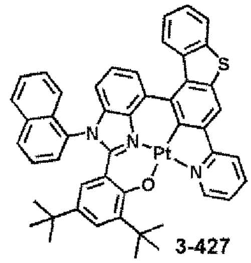
3-427

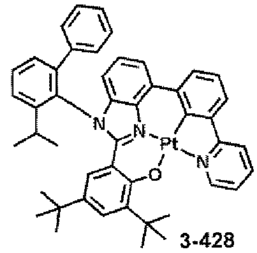
3-428

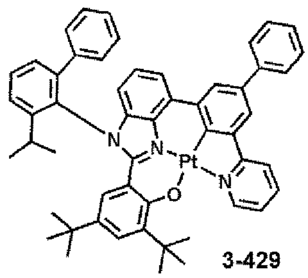
3-429

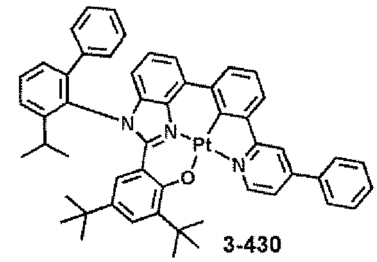
3-430

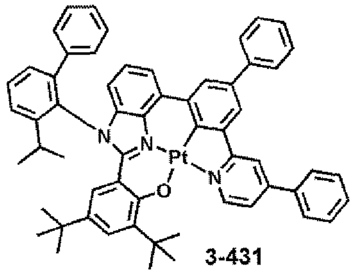
3-431

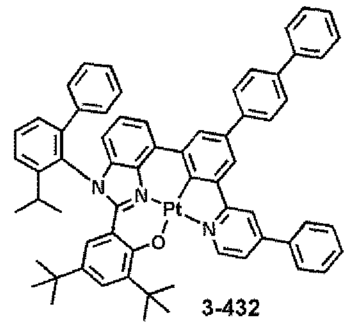
3-432

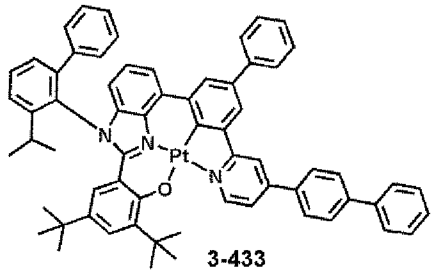
3-433

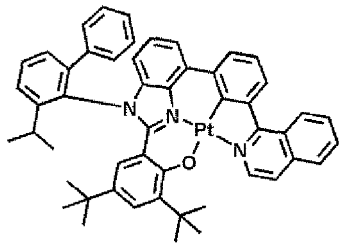
3-434

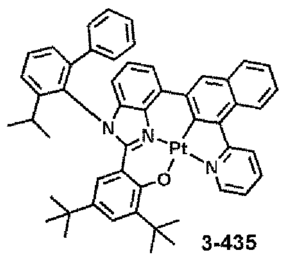
3-435

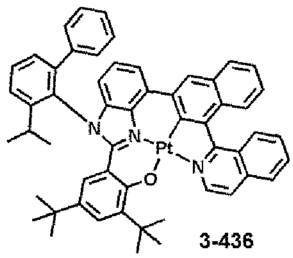
3-436

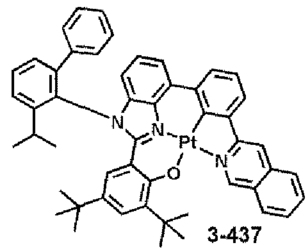
3-437

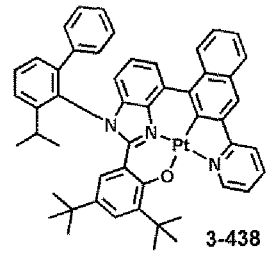
3-438

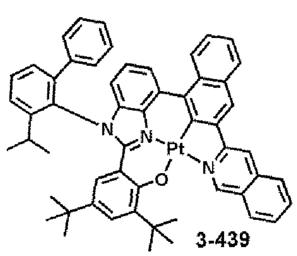
3-439

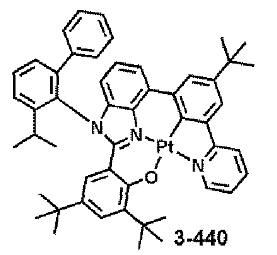
3-440

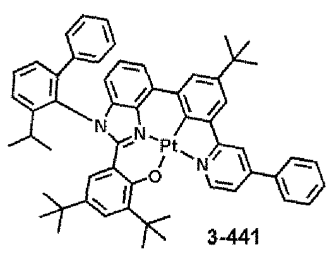
3-441

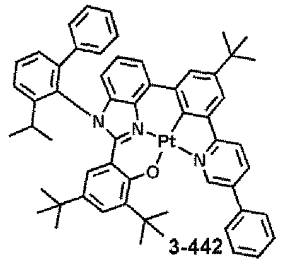
3-442

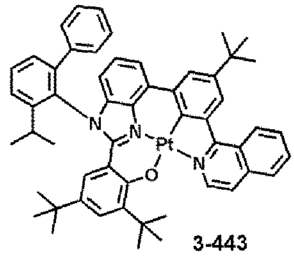
3-443

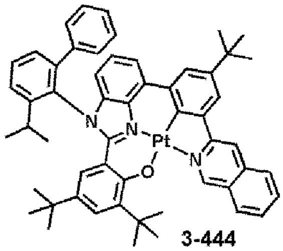
3-444

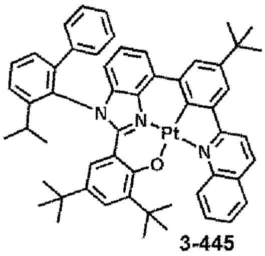
3-445

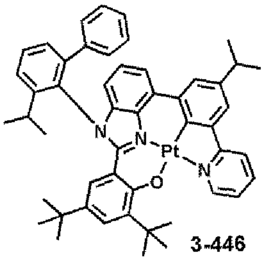
3-446

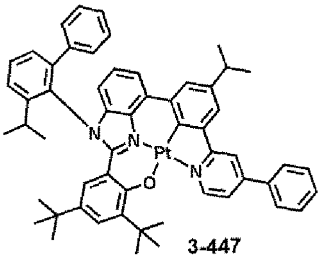
3-447

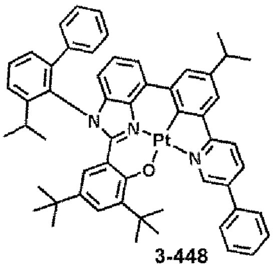
3-448

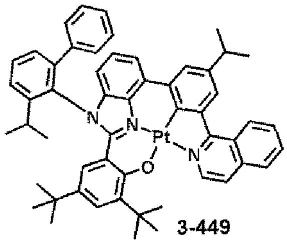
3-449

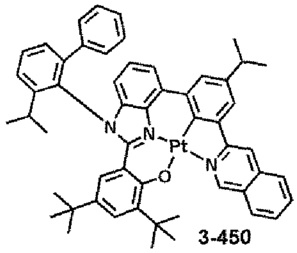
3-450

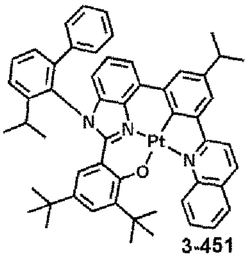
3-451

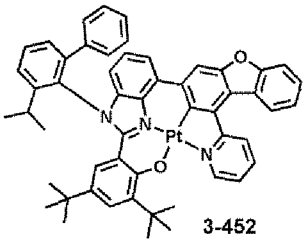
3-452

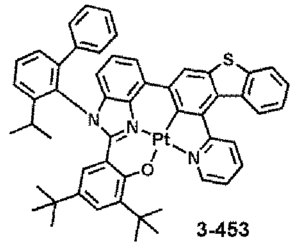
3-453

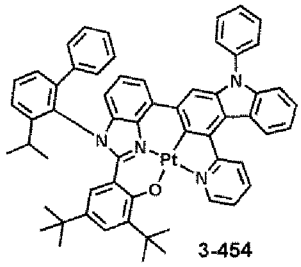
3-454

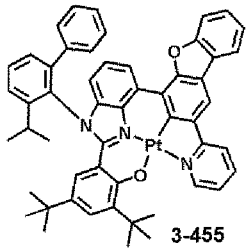
3-455

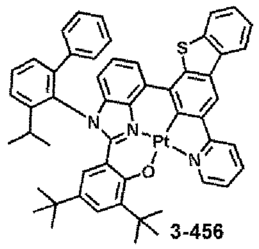
3-456

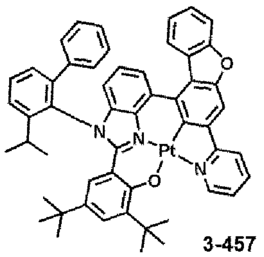
3-457

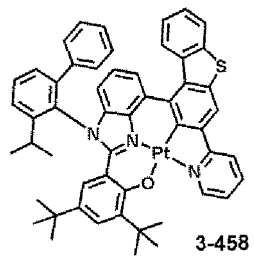
3-458

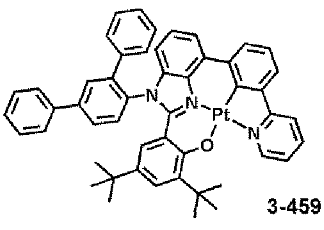
3-459

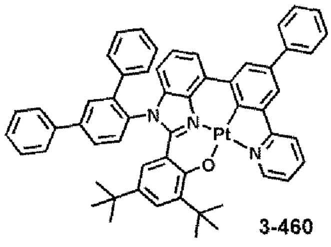
3-460

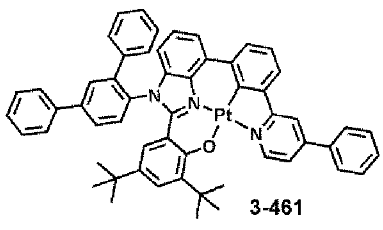
3-461

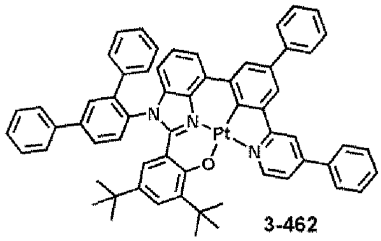
3-462

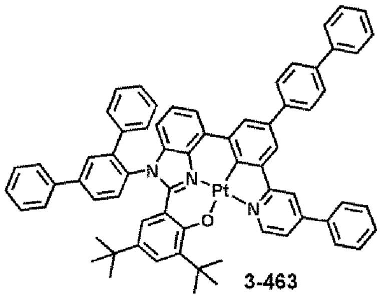
3-463

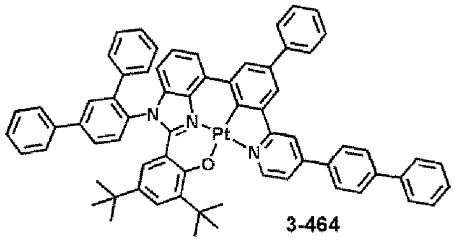
3-464

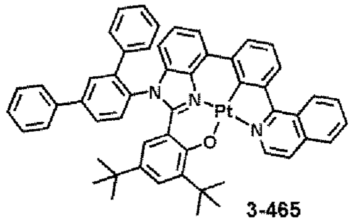
3-465

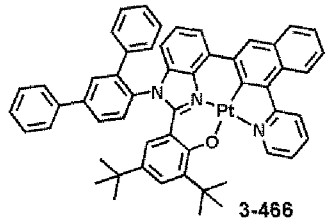
3-466

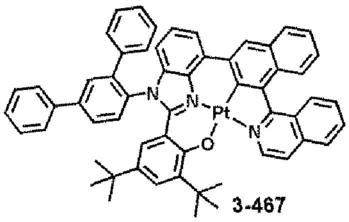
3-467

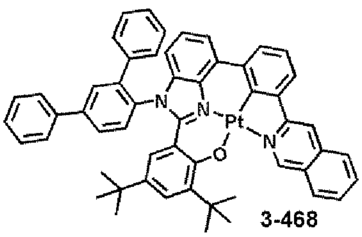
3-468

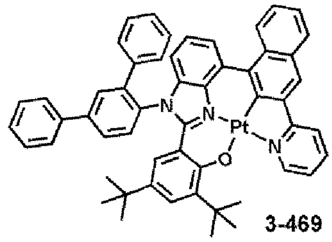
3-469

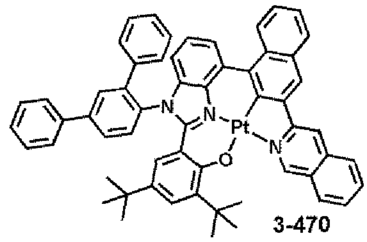
3-470

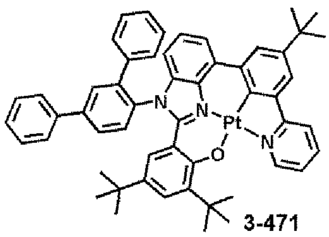
3-471

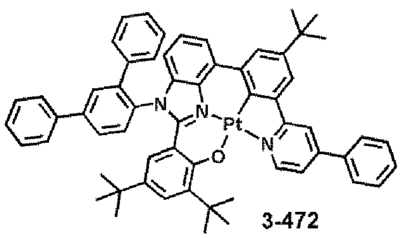
3-472

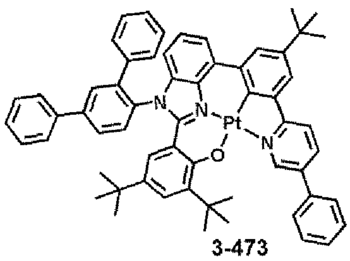
3-473

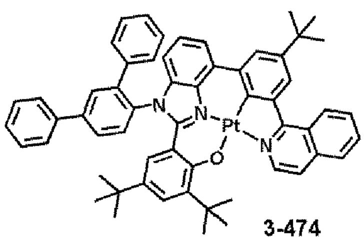
3-474

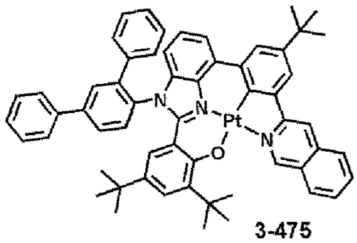
3-475

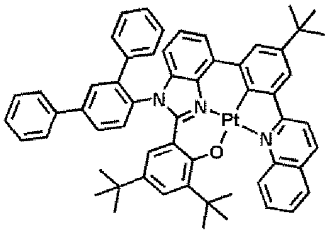
3-476

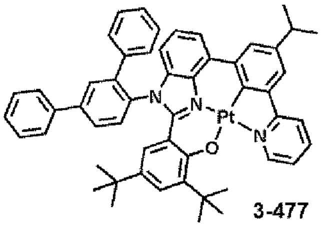
3-477

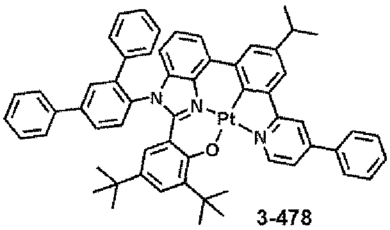
3-478

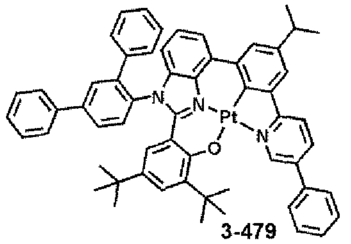
3-479

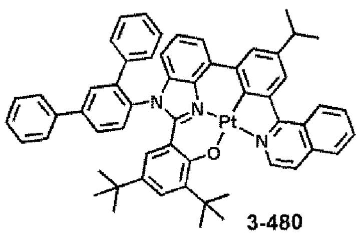
3-480

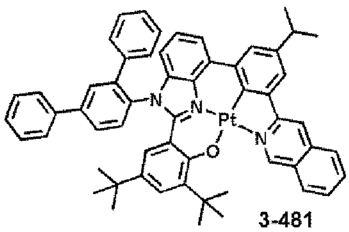
3-481

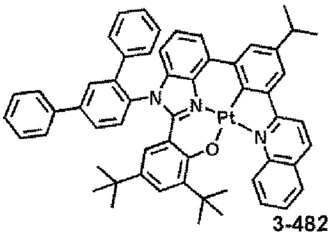
3-482

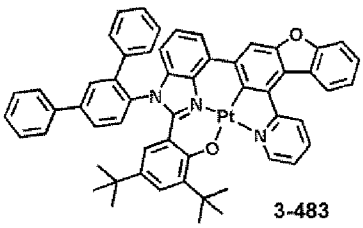
3-483

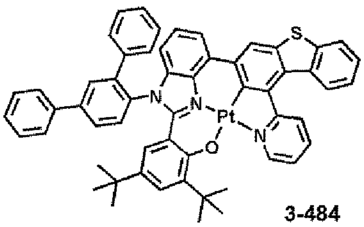
3-484

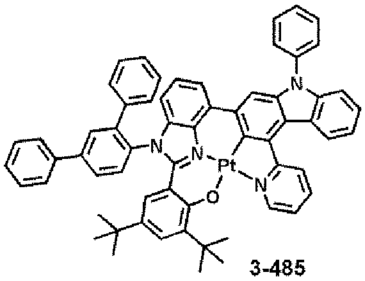
3-485

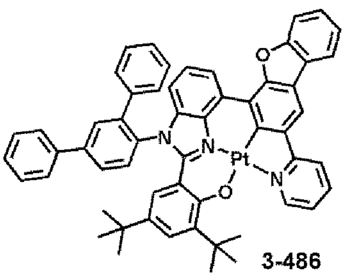
3-486

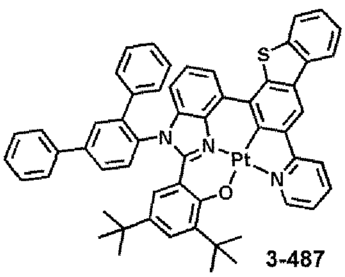
3-487

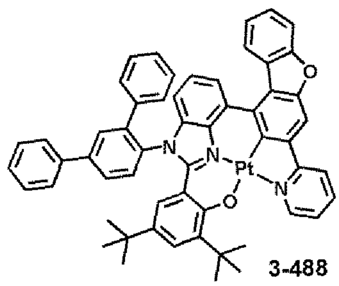
3-488

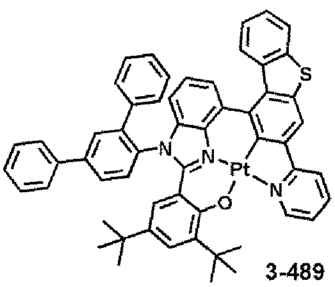
3-489

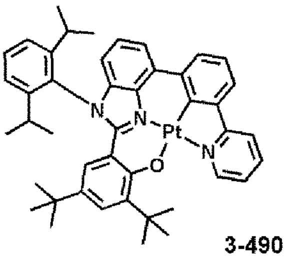
3-490

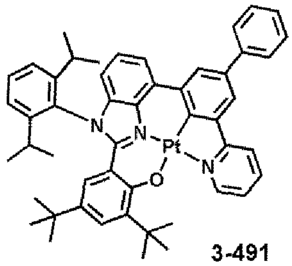
3-491

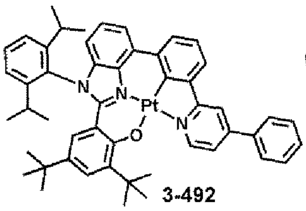
3-492

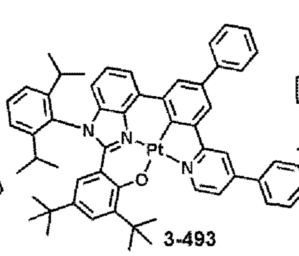
3-493

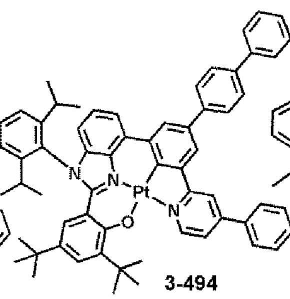
3-494

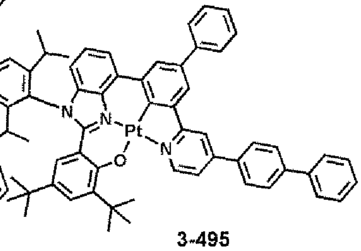
3-495

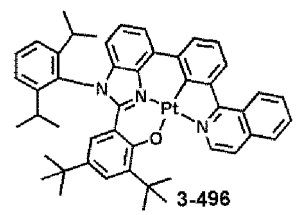
3-496

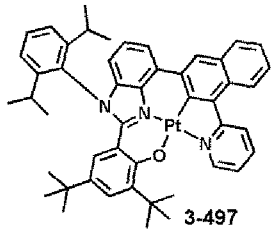
3-497

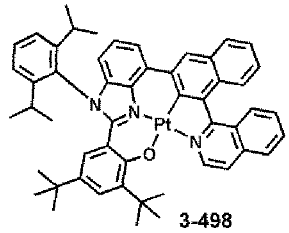
3-498

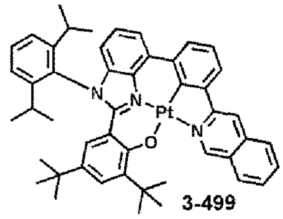
3-499

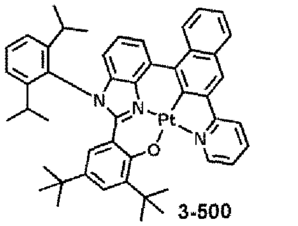
3-500

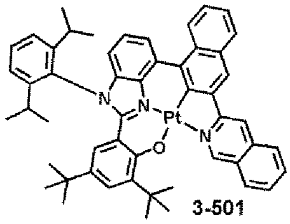
3-501

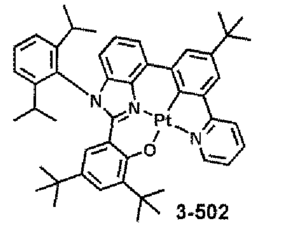
3-502

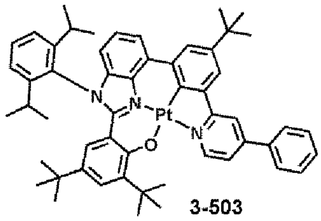
3-503

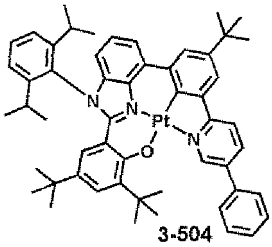
3-504

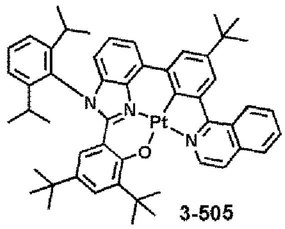
3-505

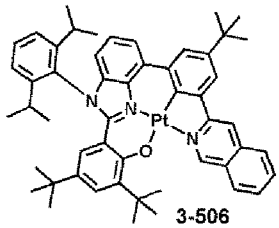
3-506

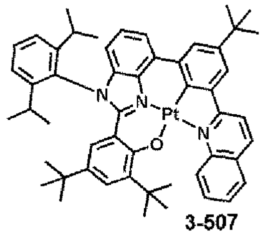
3-507

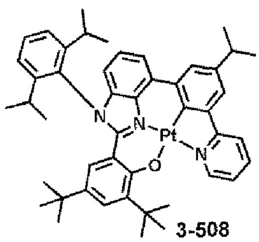
3-508

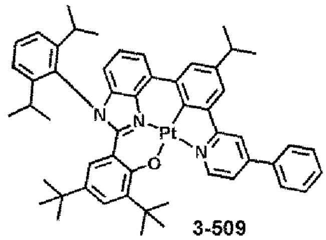
3-509

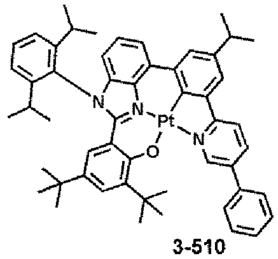
3-510

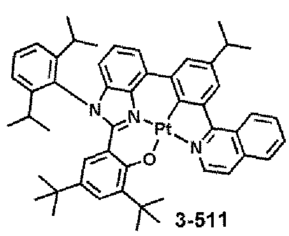
3-511

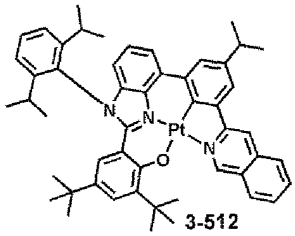
3-512

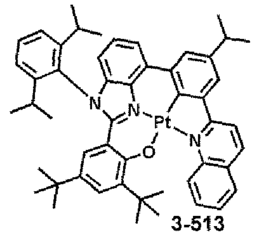
3-513

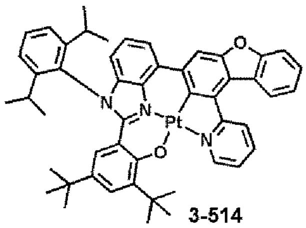
3-514

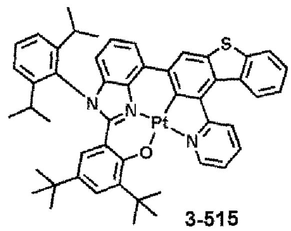
3-515

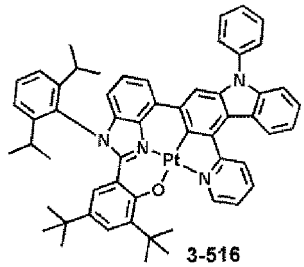
3-516

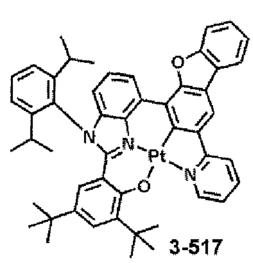
3-517

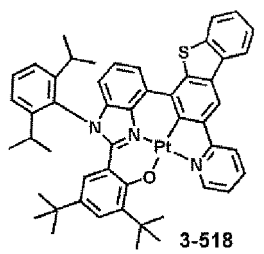
3-518

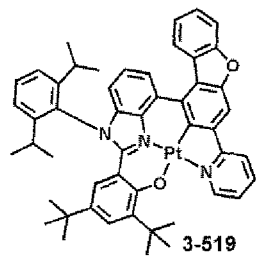
3-519

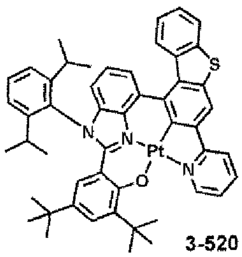
3-520

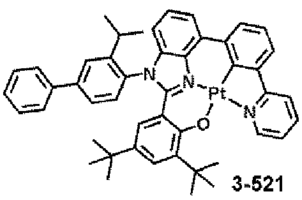
3-521

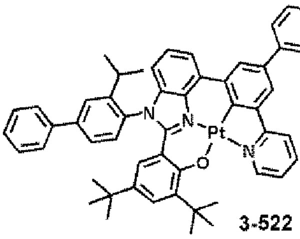
3-522

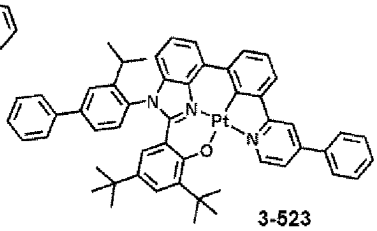
3-523

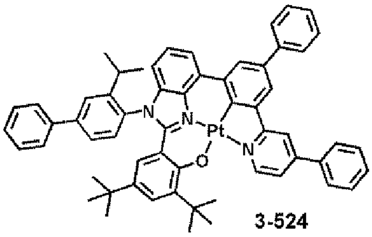
3-524

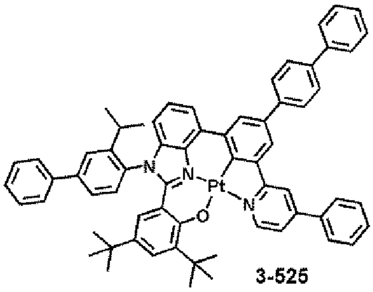
3-525

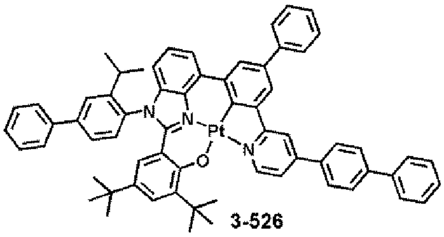
3-526

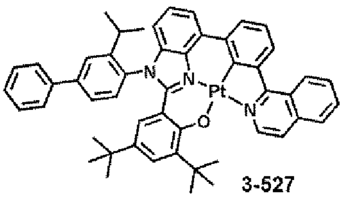
3-527

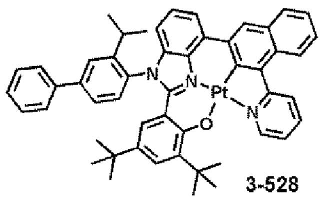
3-528

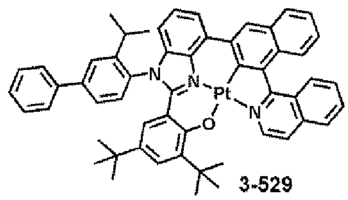
3-529

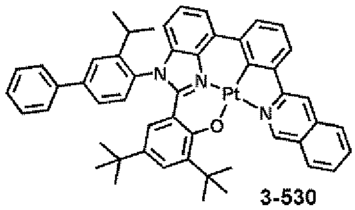
3-530

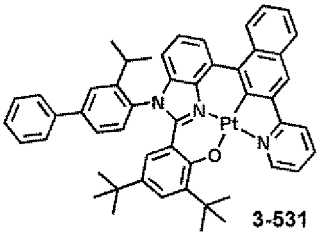
3-531

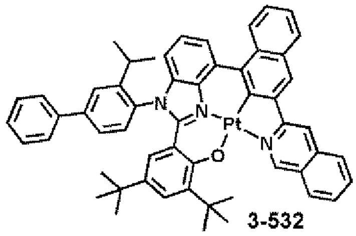
3-532

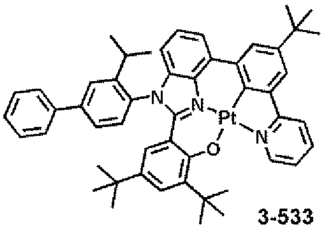
3-533

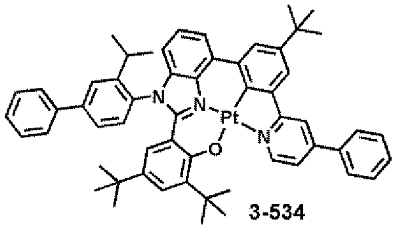
3-534

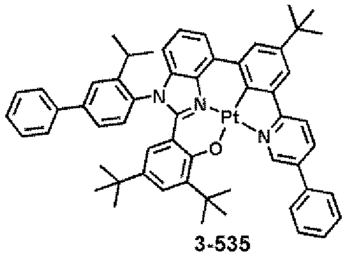
3-535

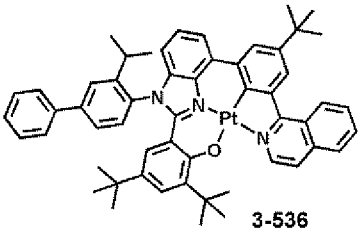
3-536

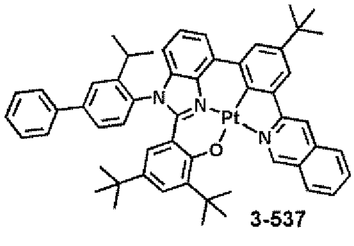
3-537

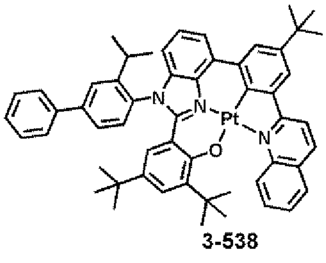
3-538

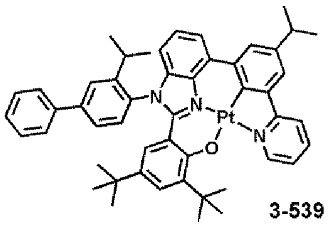
3-539

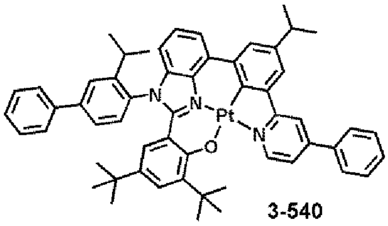
3-540

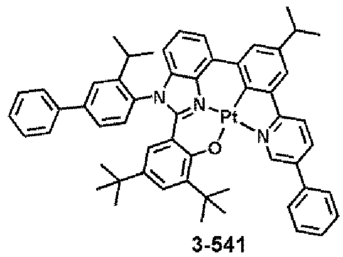
3-541

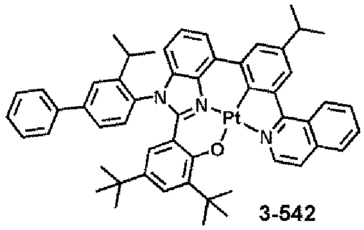
3-542

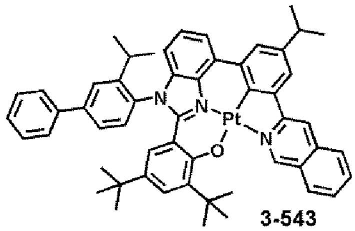
3-543

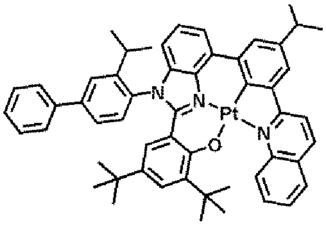
3-544

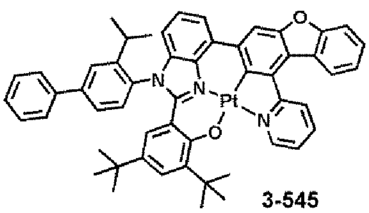
3-545

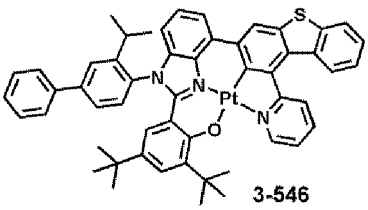
3-546

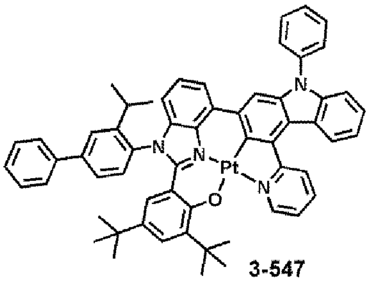
3-547

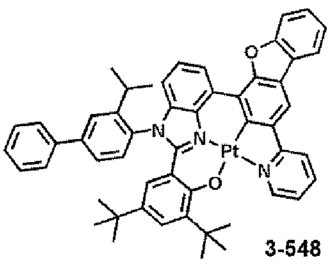
3-548

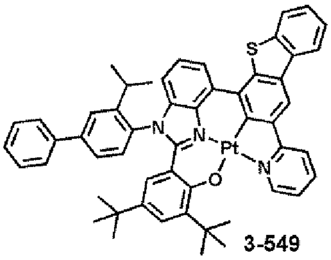
3-549

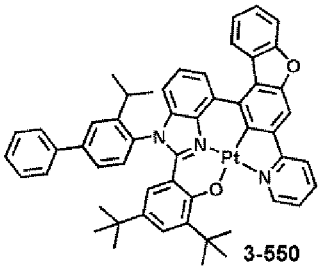
3-550

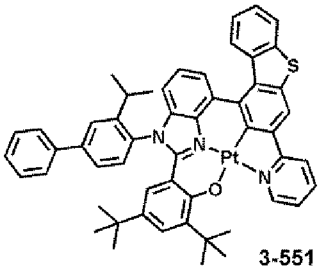
3-551

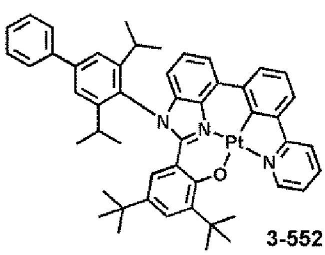
3-552

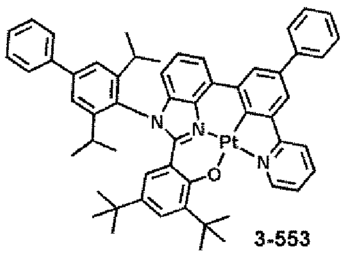
3-553

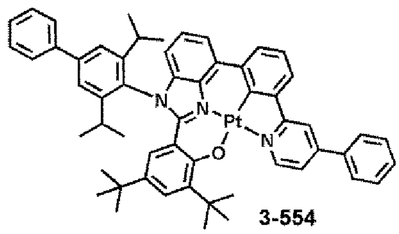
3-554

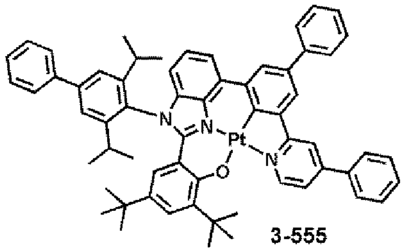
3-555

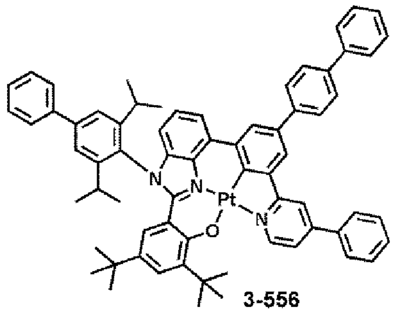
3-556

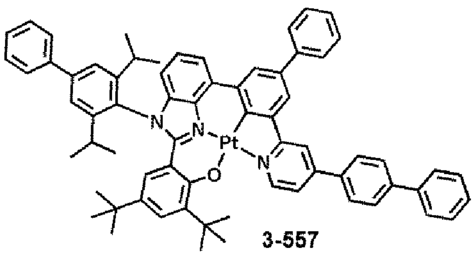
3-557

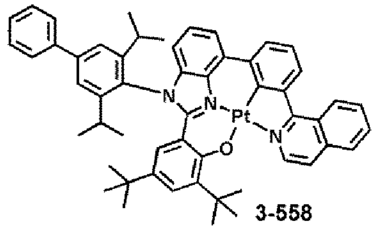
3-558

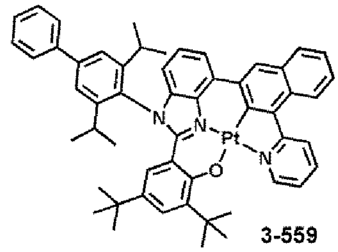
3-559

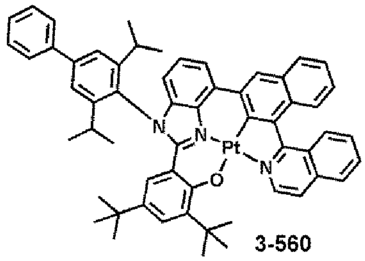
3-560

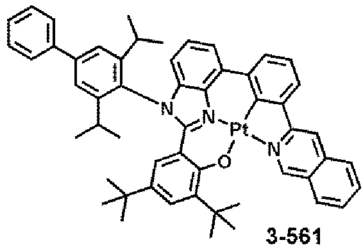
3-561

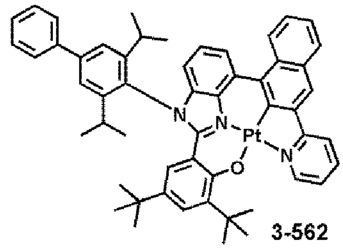
3-562

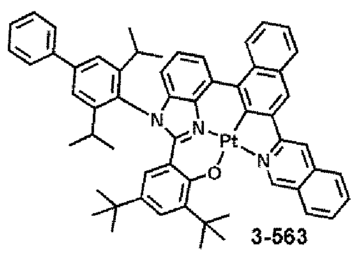
3-563

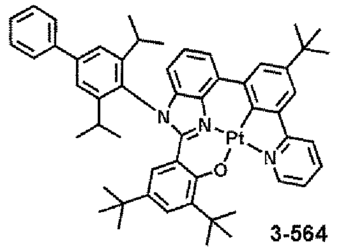
3-564

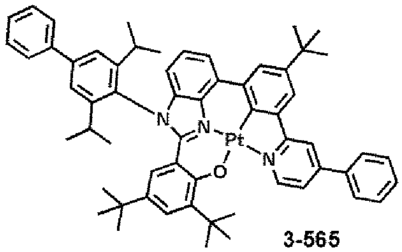
3-565

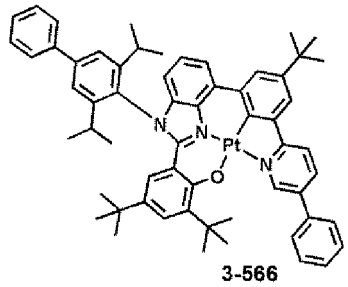
3-566

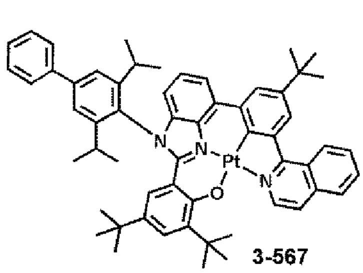
3-567

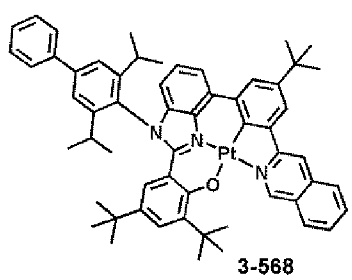
3-568

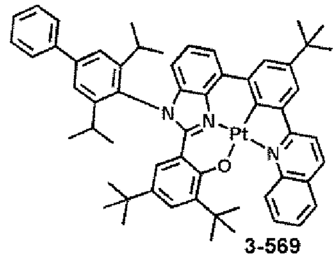
3-569

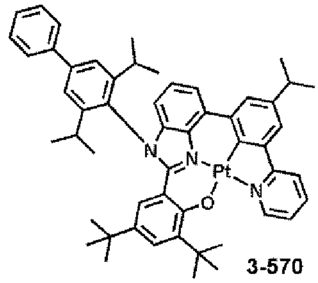
3-570

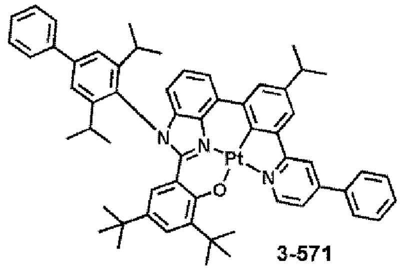
3-571

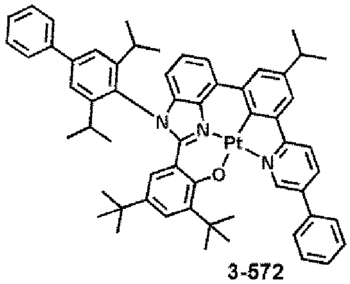
3-572

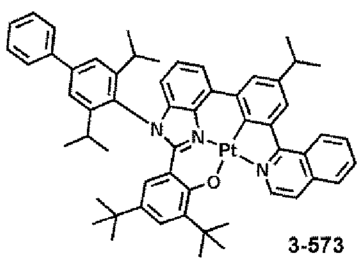
3-573

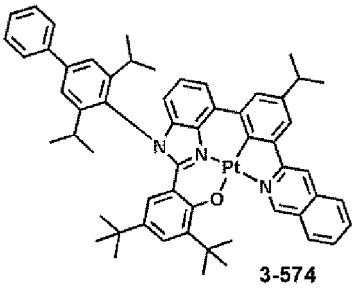
3-574

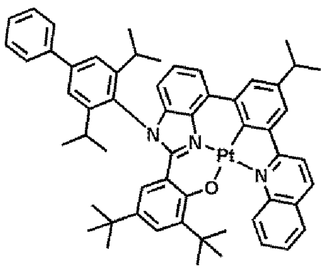
3-575

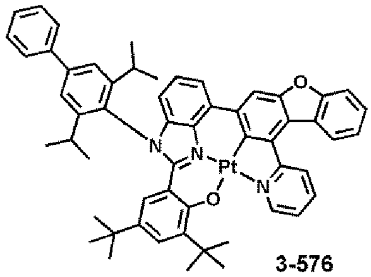
3-576

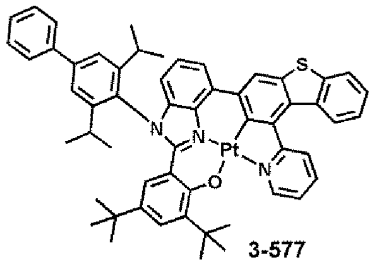
3-577

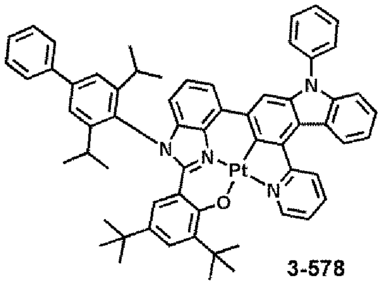
3-578

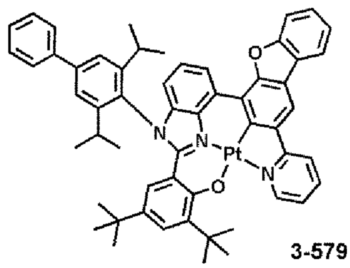
3-579

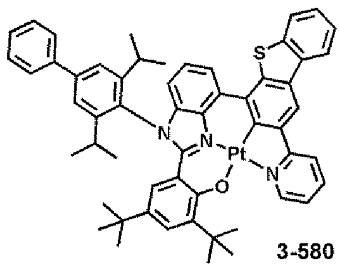
3-580

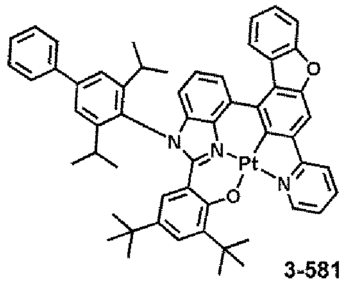
3-581

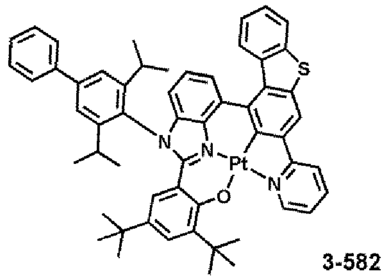
3-582

A stable bond angle may be formed between a tetradentate ligand and a metal in Formula 1-1, thereby improving a molecular stability of the organometallic compound represented by Formula 1-1.

The organometallic compound represented by Formula 1-1 may have improved molecular orientation, and in

this regard, an electronic device, for example, an organic light-emitting device, which includes the organometallic compound represented by Formula 1-1, may have improved efficiency and lifespan.

The organometallic compound represented by Formula 1-1 may emit a phosphorescent light emission having a high luminescent efficiency due to an intermolecular charge transfer mechanism.

For example, a highest occupied molecular orbital (HOMO) energy level, a lowest unoccupied molecular orbital (LUMO) energy level, a singlet ($S_1$) energy level, and a triplet ($T_1$) energy level of each of Compounds 1-28, 1-30, 1-17, 1-9, and 1-12 were evaluated by using a density functional theory (DFT) method of a Gaussian program (a structure was optimized at a B3LYP, 6-31 G(d,p) level). Evaluation results thereof are shown in Table 1.

Table 1

| Compound No. | HOMO (eV) | LUMO (eV) | $S_1$ energy level (eV) | $T_1$ energy level (eV) |
|---|---|---|---|---|
| 1-28 | -4.869 | -1.589 | 2.728 | 2.472 |
| 1-30 | -4.994 | -1.793 | 2.661 | 2.439 |
| 1-17 | -4.794 | -1.528 | 2.721 | 2.47 |
| 1-9 | -4.782 | -1.528 | 2.719 | 2.466 |
| 1-12 | -4.813 | -1.598 | 2.693 | 2.395 |

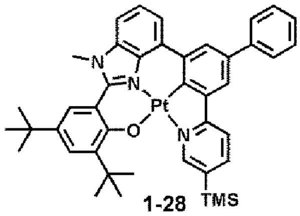
1-28

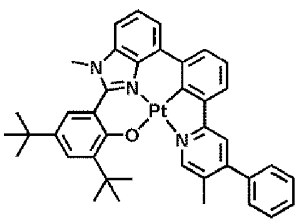
1-30

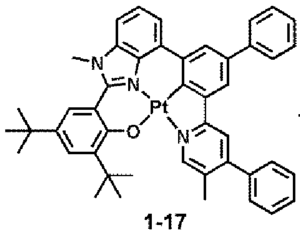
1-17

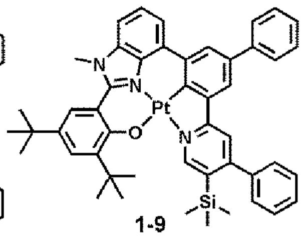
1-9

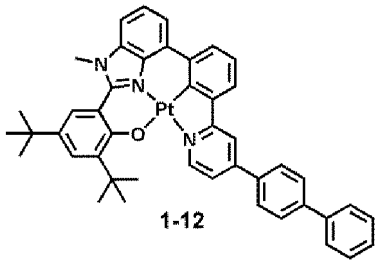
1-12

Referring to Table 1, it has been determined that the organometallic compound represented by Formula 1-1 has electrical characteristics suitable for use as a dopant of an electronic device, for example, an organic light-emitting device.

Synthesis methods of the organometallic compound represented by Formula 1-1 may be recognizable by one of ordinary skill in the art by referring to Synthesis Examples provided below.

The organometallic compound represented by Formula 1-1 is suitable for use in an organic layer of an organic light-emitting device, for example, for use as a dopant in an emission layer of the organic layer. Thus, another aspect of the present disclosure provides an organic light-emitting device that includes: a first electrode; a second electrode; and an organic layer that is disposed between the first electrode and the second electrode and includes an emission layer, wherein the organic layer includes at least one of the organometallic compound represented by Formula 1-1.

The organic light-emitting device may have, due to the inclusion of an organic layer including the organometallic compound represented by Formula 1-1, a low driving voltage, high efficiency, high power, high quantum efficiency, a long lifespan, a low roll-off ratio, and excellent color purity.

The organometallic compound represented by Formula 1-1 may be used between a pair of electrodes of an organic light-emitting device. For example, the organometallic compound represented by Formula 1-1 may be included in the emission layer. In this regard, the organometallic compound may act as a dopant, and the emission layer may further include a host (that is, an amount of the organometallic compound represented by Formula 1-1 is smaller than

an amount of the host).

The expression "(an organic layer) includes at least one of organometallic compounds" as used herein may include an embodiment in which "(an organic layer) includes identical organometallic compounds represented by Formula 1-1" and an embodiment in which "(an organic layer) includes two or more different organometallic compounds represented by Formula 1-1."

For example, the organic layer may include, as the organometallic compound, only Compound 1-1. In this regard, Compound 1-1 may be included in an emission layer of the organic light-emitting device. In one or more embodiments, the organic layer may include, as the organometallic compound, Compound 1-1 and Compound 1-2. In this regard, Compound 1-1 and Compound 1-2 may be included in an identical layer (for example, Compound 1-1 and Compound 1-2 all may be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, in the organic light-emitting device, the first electrode may be an anode, and the second electrode may be a cathode, and the organic layer may further include a hole transport region disposed between the first electrode and the emission layer and an electron transport region disposed between the emission layer and the second electrode, and the hole transport region may include a hole injection layer, a hole transport layer, an electron blocking layer, or any combination thereof, and the electron transport region may include a hole blocking layer, an electron transport layer, an electron injection layer, or any combination thereof.

The term "organic layer" as used herein refers to a single layer and/or a plurality of layers disposed between the first electrode and the second electrode of the organic light-emitting device. The "organic layer" may include, in addition to an organic compound, an organometallic complex including metal.

Figure 1 is a schematic view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100°C to about 500°C, a vacuum pressure of about $10^{-8}$ torr to about $10^{-3}$ torr, and a deposition rate of about 0.01 Angstroms per second (Å/sec) to about 100 Å/sec. However, the deposition conditions are not limited thereto.

When the hole injection layer is formed using spin coating, coating conditions may vary according to the material

used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below:

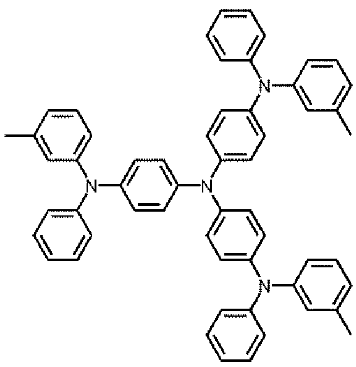

m-MTDATA

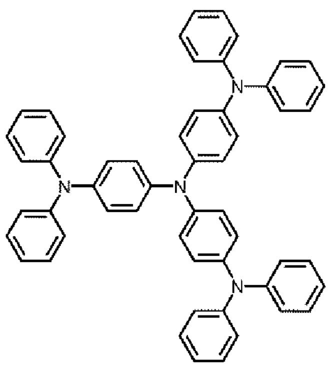

TDATA

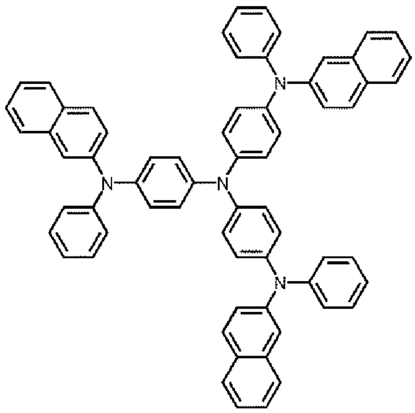

2-TNATA

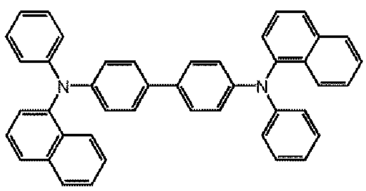

NPB

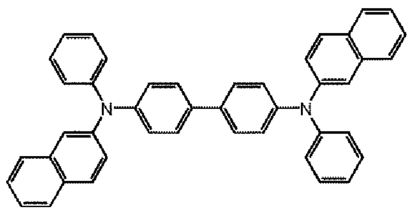

β-NPB

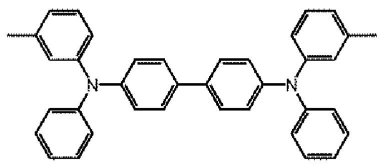

TPD

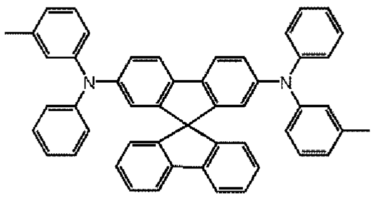

Spiro-TPD

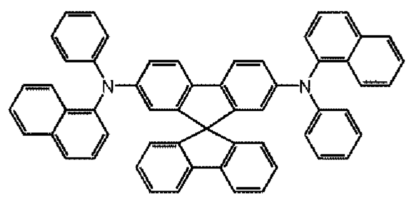

Spiro-NPB

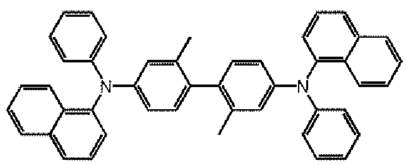

methylated NPB

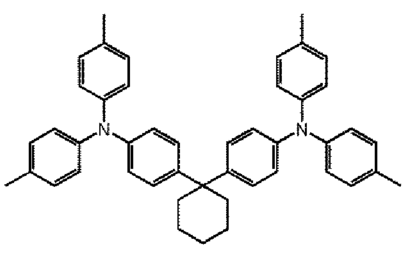

TAPC

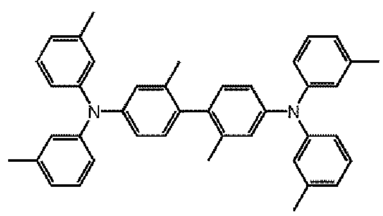

HMTPD

Formula 201

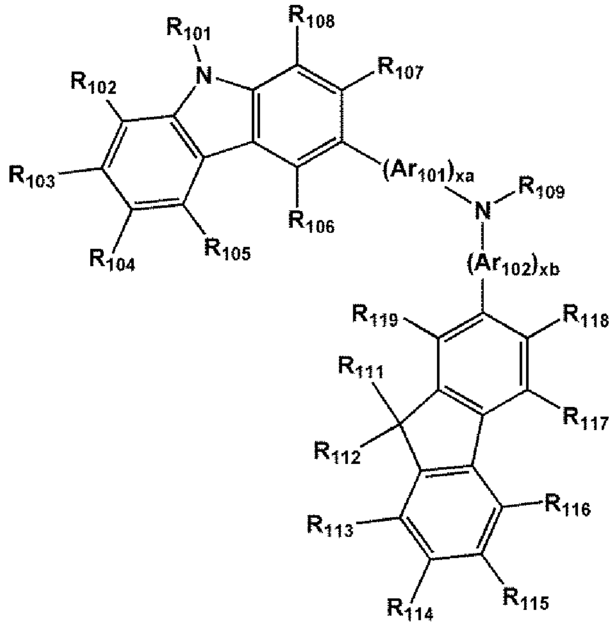

Formula 202

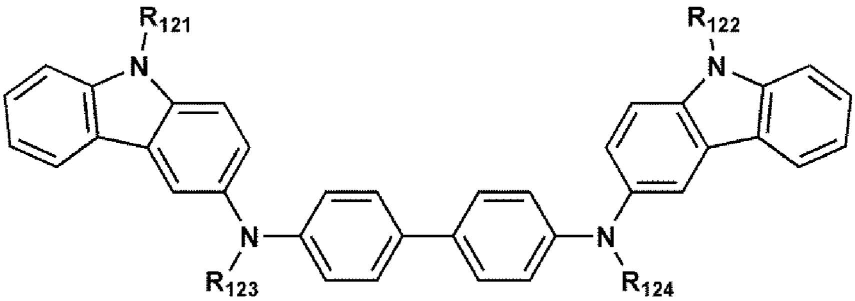

In Formula 201, $Ar_{101}$ and $Ar_{102}$ may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, - F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, and a monovalent non-aromatic condensed heteropolycyclic group.

In Formula 201, xa and xb may each independently be an integer from 0 to 5, or may each independently be 0, 1, or 2. For example, xa may be 1 and xb may be 0, but embodiments of the present disclosure are not limited thereto.

In Formulae 201 and 202, $R_{101}$ to $R_{108}$, $R_{111}$ to $R_{119}$, and $R_{121}$ to $R_{124}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, pentyl group, a hexyl group, and the like), and a $C_1$-$C_{10}$ alkoxy group (for example, a methoxy group, an ethoxy group, a propoxy group, a butoxy group, a pentoxy group, and the like);
a $C_1$-$C_{10}$ alkyl group and a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group;
but embodiments of the present disclosure are not limited thereto.

In Formula 201, $R_{109}$ may be selected from:

a phenyl group, a naphthyl group, an anthracenyl group, and a pyridinyl group; and
a phenyl group, a naphthyl group, an anthracenyl group, and a pyridinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

In an embodiment, the compound represented by Formula 201 may be represented by Formula 201A, but embodiments of the present disclosure are not limited thereto:

Formula 201A

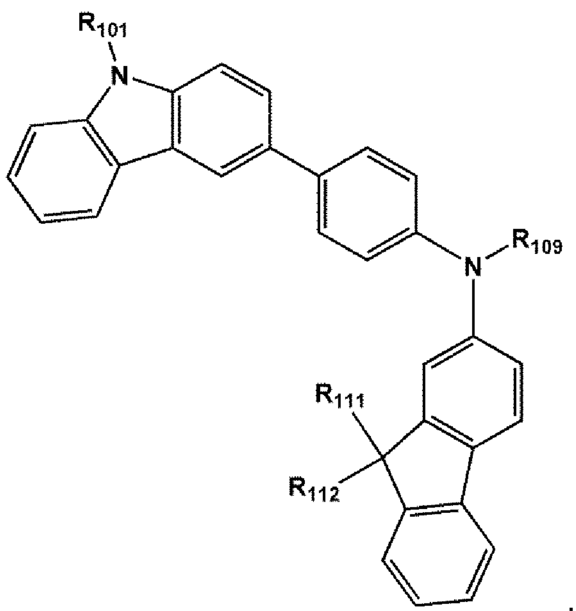

In Formula 201A, $R_{101}$, $R_{111}$, $R_{112}$, and $R_{109}$ may be understood by referring to the description provided herein.

For example, the compound represented by Formula 201, and the compound represented by Formula 202 may include Compounds HT1 to HT20 below, but embodiments of the present disclosure are not limited thereto:

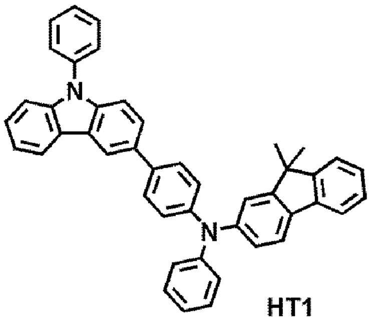

HT1

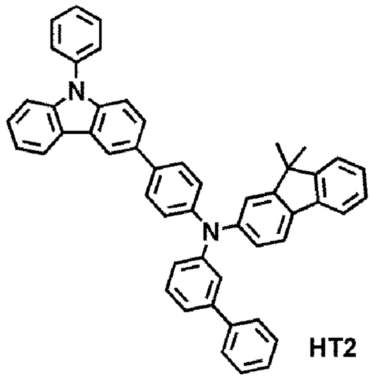

HT2

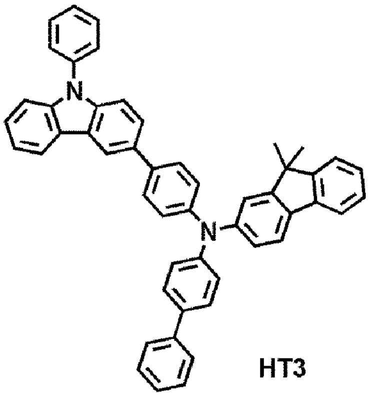

HT3

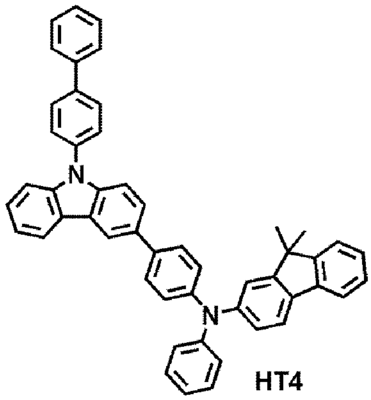

HT4

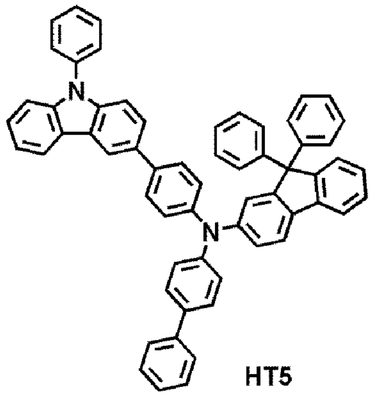

HT5

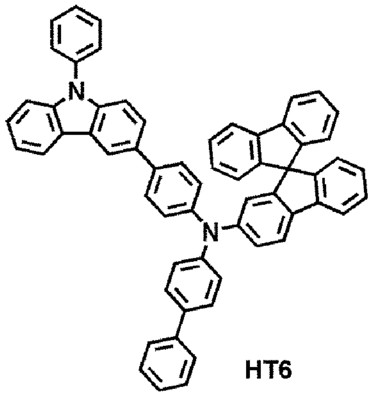

HT6

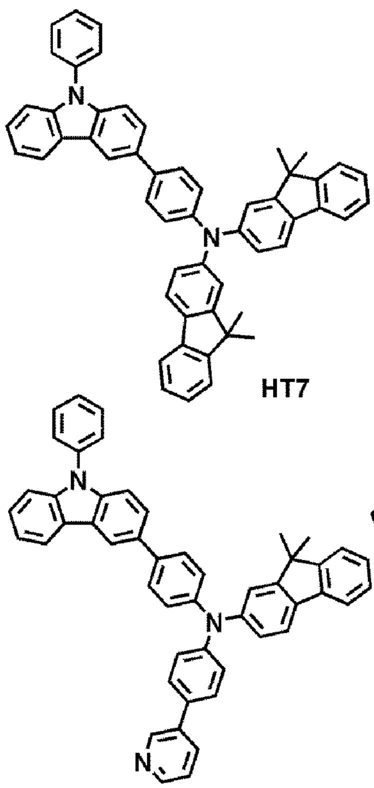

HT7

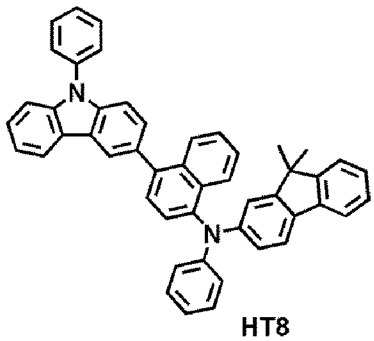

HT8

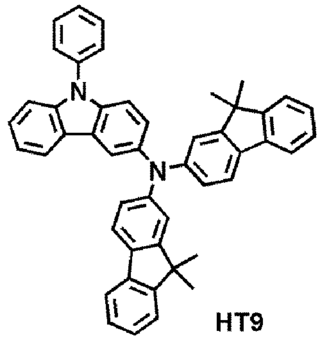

HT9

HT10

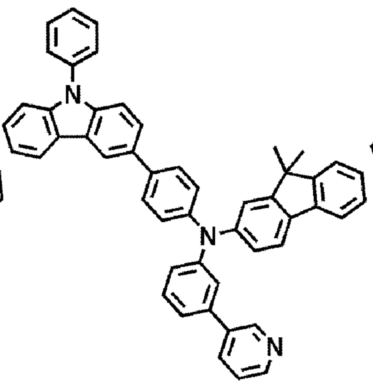

HT11

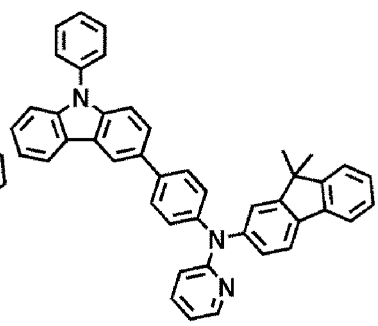

HT12

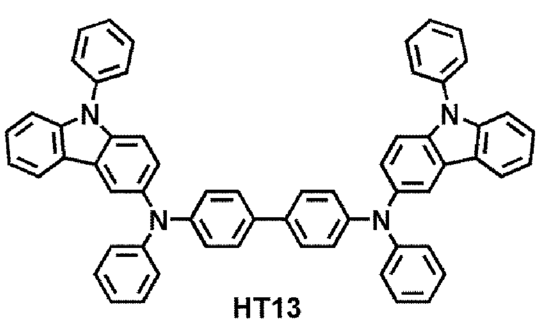

HT13

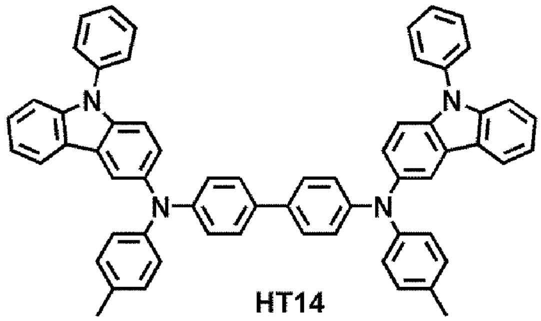

HT14

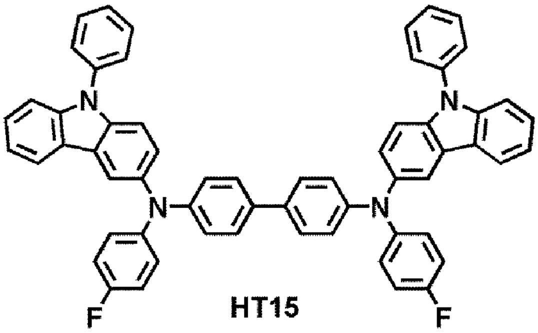

HT15

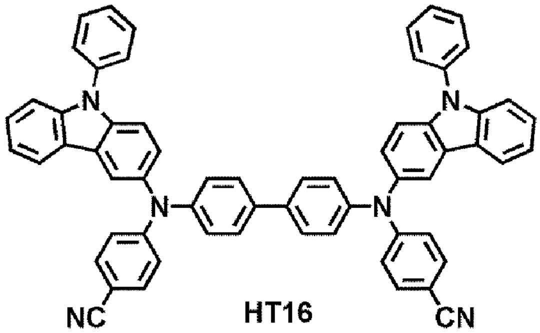

HT16

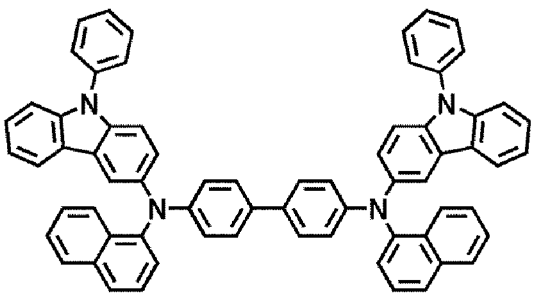

HT17

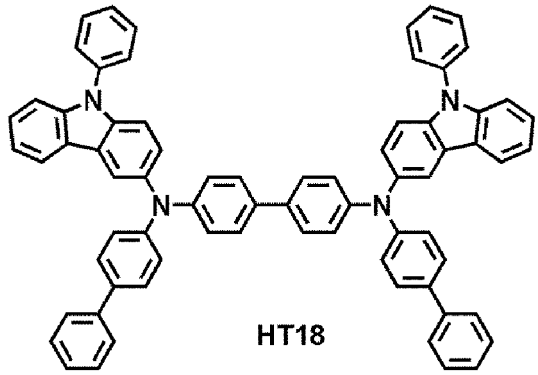

HT18

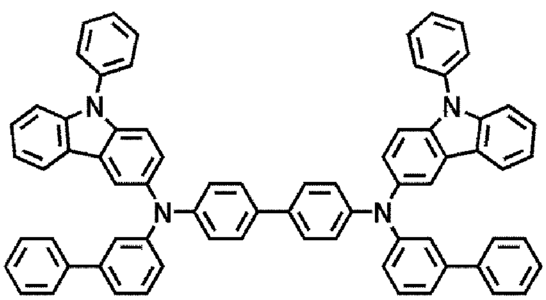

HT19

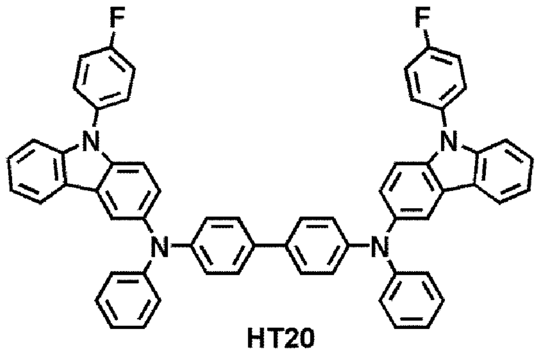

HT20

.

A thickness of the hole transport region may be in a range of about 100 Angstroms (Å) to about 10,000 Å, for example, about 100 Å to about 1,000 Å. When the hole transport region includes at least one of a hole injection layer and a hole transport layer, the thickness of the hole injection layer may be in a range of about 100 Å to about 10,000 Å, and for example, about 100 Å to about 1,000 Å, and the thickness of the hole transport layer may be in a range of about 50 Å to about 2,000 Å, and for example, about 100 Å to about 1,500 Å. While not wishing to be bound by theory, it is understood that when the thicknesses of the hole transport region, the hole injection layer, and the hole transport layer are within these ranges, satisfactory hole transporting characteristics may be obtained without a substantial increase in

driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 or Compound HT-D2 below, but embodiments of the present disclosure are not limited thereto:

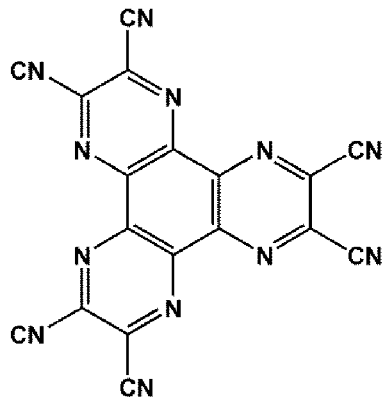

HT-D1

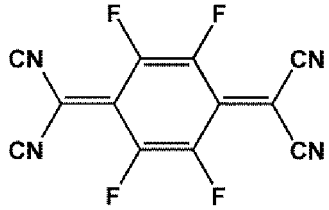

F4-TCNQ

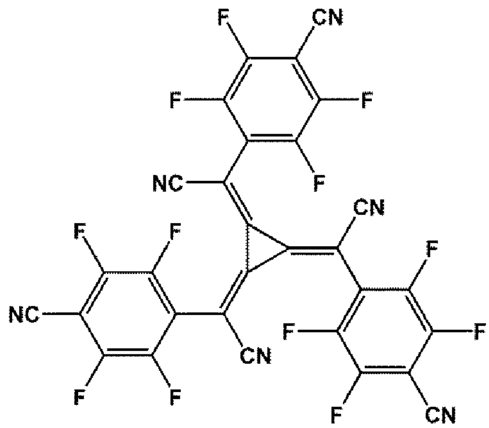

HT-D2

.

The hole transport region may include a buffer layer.

The buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1-1.

The host may include at least one selected from TPBi, TBADN, ADN (also referred to as "DNA"), CBP, CDBP,

TCP, mCP, Compound H50, and Compound H51:

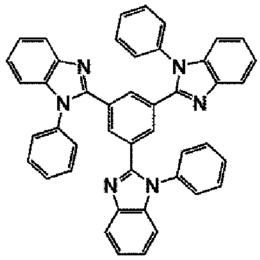

TPBi

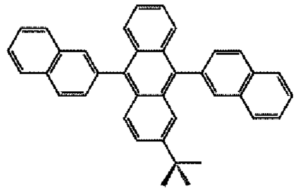

TBADN

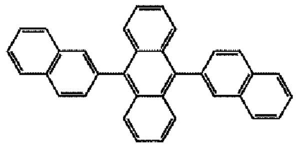

ADN

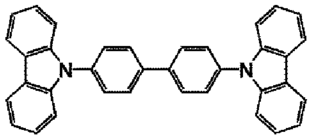

CBP

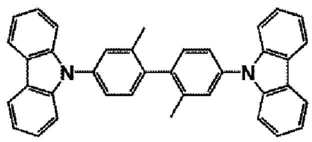

CDBP

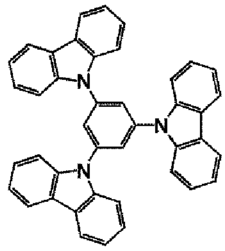

TCP

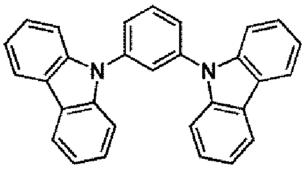

mCP

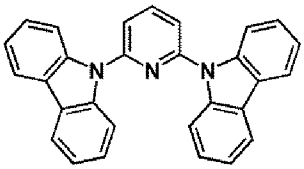

H50

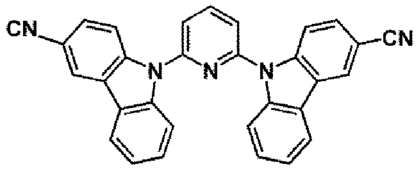

H51

.

In one or more embodiments, the host may further include a compound represented by Formula 301 below:

Formula 301

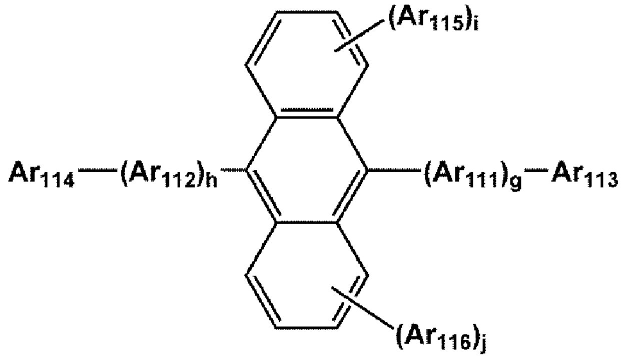

.

In Formula 301, $Ar_{111}$ and $Ar_{112}$ may each independently be selected from:

a phenylene group, a naphthylene group, a phenanthrenylene group, and a pyrenylene group; and

a phenylene group, a naphthylene group, a phenanthrenylene group, and a pyrenylene group, each substituted with at least one selected from a phenyl group, a naphthyl group, and an anthracenyl group.

In Formula 301, $Ar_{113}$ to $Ar_{116}$ may each independently be selected from:

a $C_1$-$C_{10}$ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

In Formula 301, g, h, i, and j may each independently be an integer from 0 to 4, for example, 0, 1, or 2.
In Formula 301, $Ar_{113}$ to $Ar_{116}$ may each independently be selected from:

a $C_1$-$C_{10}$ alkyl group substituted with at least one selected from a phenyl group, a naphthyl group, and an anthracenyl group;
a phenyl group, a naphthyl group, an anthracenyl group, a pyrenyl group, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a phenyl group, a naphthyl group, an anthracenyl group, a pyrenyl group, a phenanthrenyl group, and a fluorenyl group; and

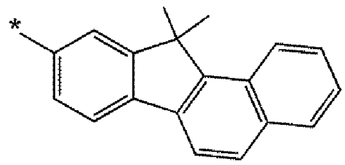,

but embodiments of the present disclosure are not limited thereto.

In one or more embodiments, the host may include a compound represented by Formula 302:

Formula 302

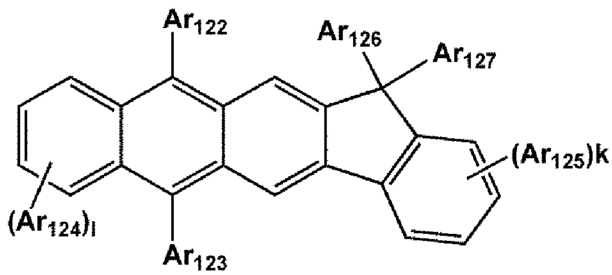.

In Formula 302, $Ar_{122}$ to $Ar_{125}$ are the same as described in detail in connection with $Ar_{113}$ in Formula 301.
In Formula 302, $Ar_{126}$ and $Ar_{127}$ may each independently be a $C_1$-$C_{10}$ alkyl group (for example, a methyl group, an ethyl group, or a propyl group).
In Formula 302, k and l may each independently be an integer from 0 to 4. For example, k and l may be 0, 1, or 2.
The compound represented by Formula 301 and the compound represented by Formula 302 may include Compounds H1 to H42 below, but embodiments of the present disclosure are not limited thereto.

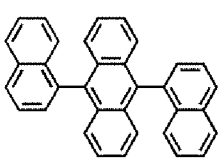
H1

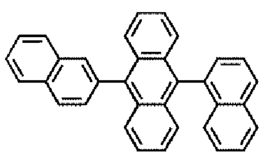
H2

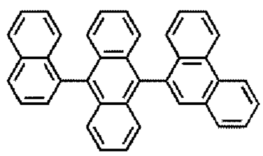
H3

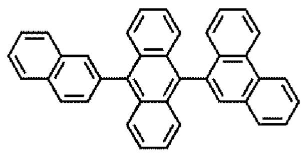
H4

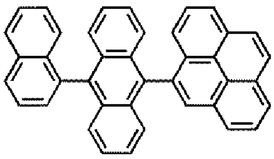
H5

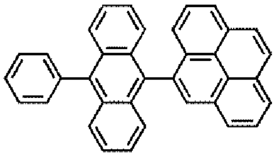
H6

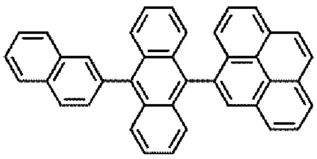
H7

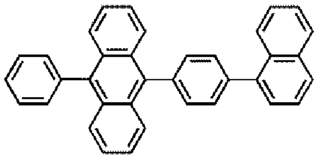
H8

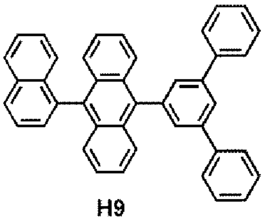
H9

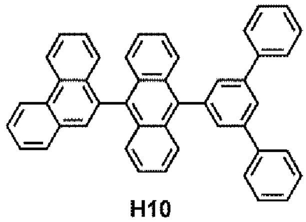
H10

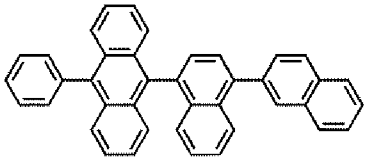
H11

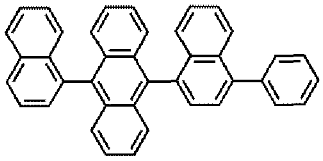
H12

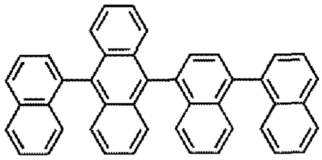
H13

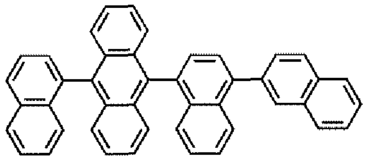
H14

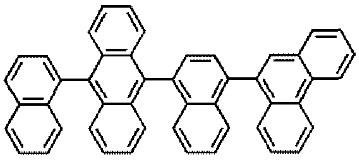
H15

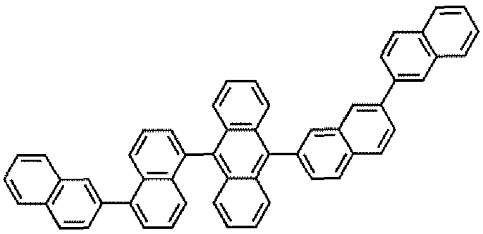
H16

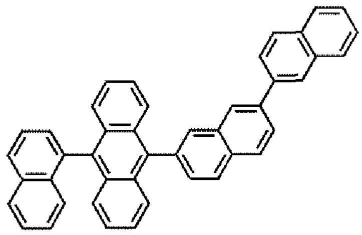
H17

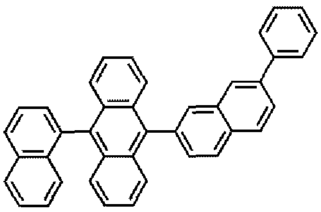
H18

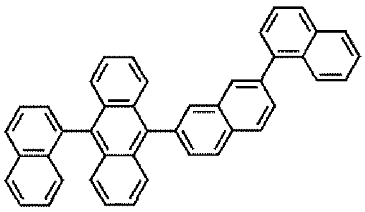
H19

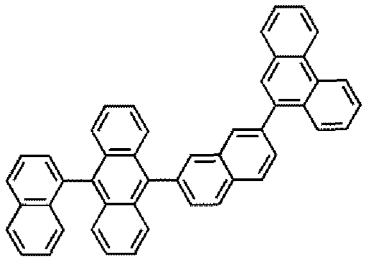
H20

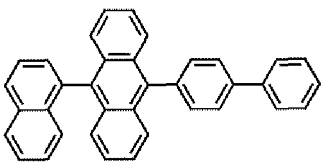
H21

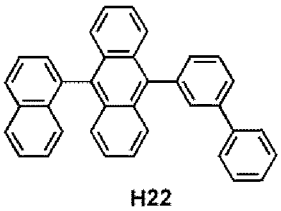
H22

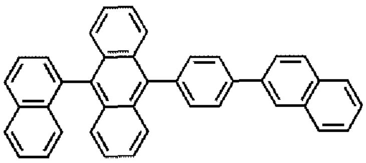
H23

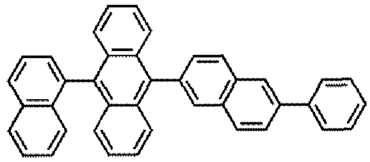
H24

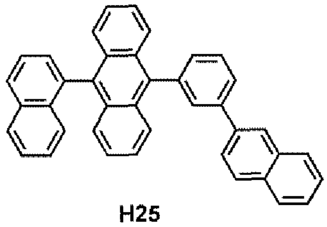
H25

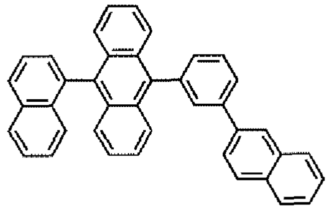
H26

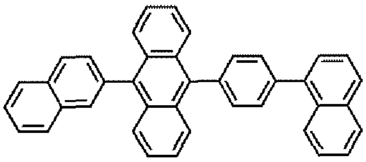
H27

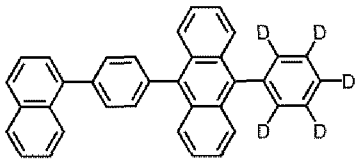
H28

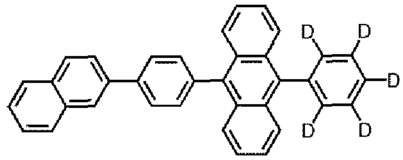
H29

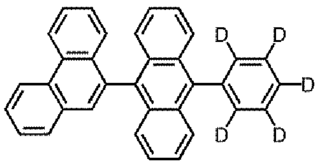
H30

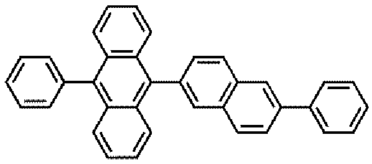
H31

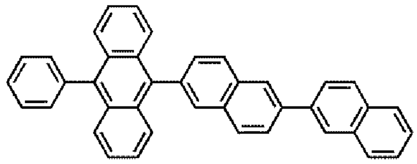
H32

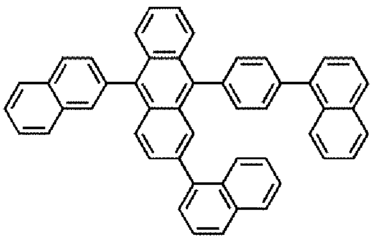
H33

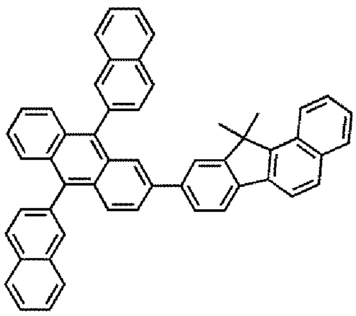
H34

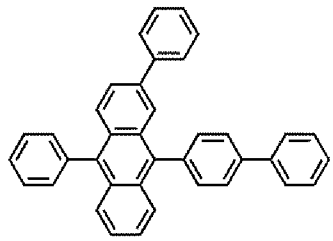
H35

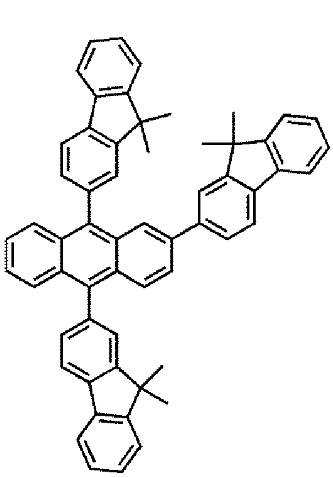
H36

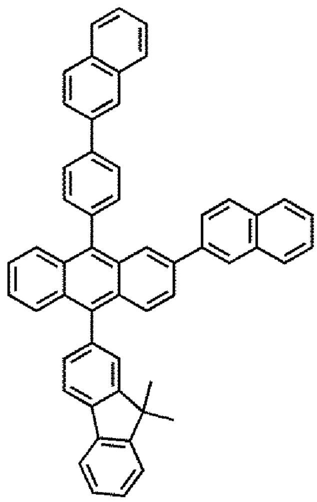
H37

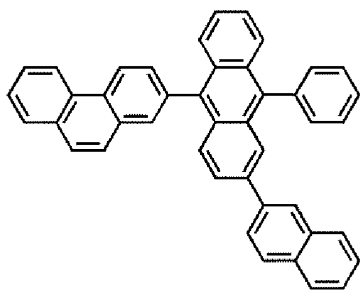
H38

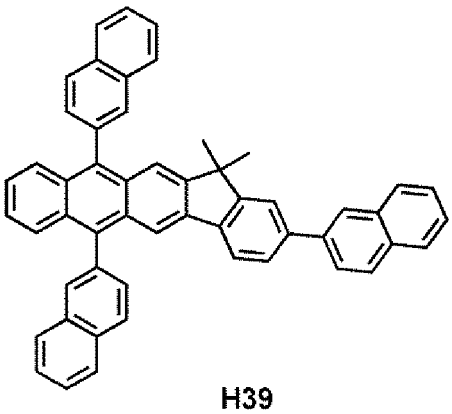

H39

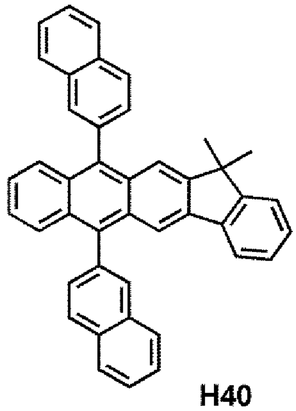

H40

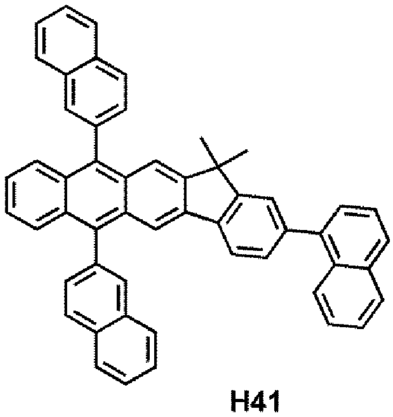

H41

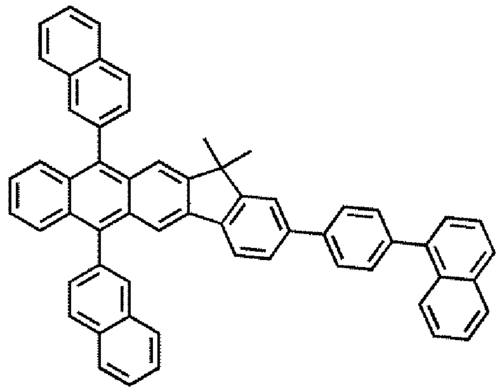

H42

.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto:

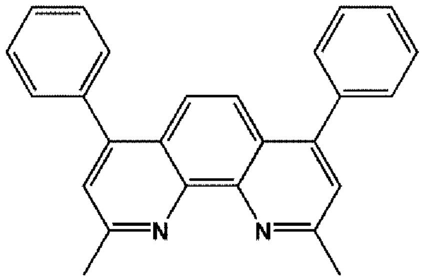

BCP

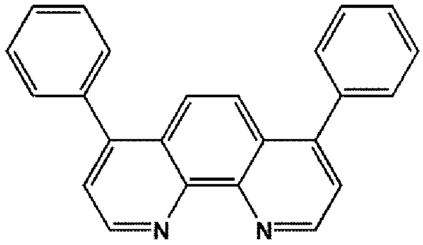

Bphen

.

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have improved hole blocking ability without a substantial increase in driving voltage.

The electron transport layer may further include at least one selected from BCP, Bphen, $Alq_3$, BAlq, TAZ, and NTAZ:

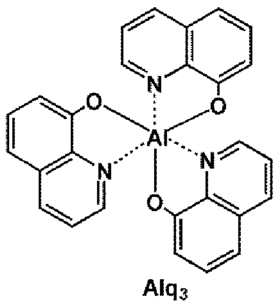

$Alq_3$

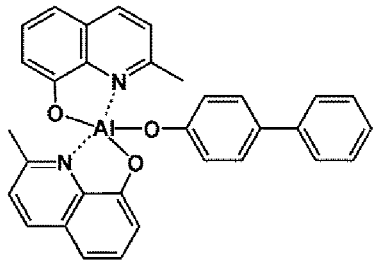

BAlq

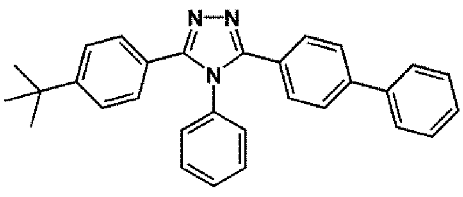

TAZ

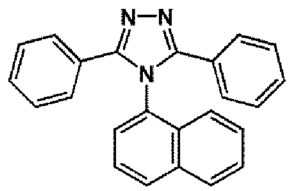

NTAZ

In one or more embodiments, the electron transport layer may include at least one of Compounds ET1 to ET25, but embodiments of the present disclosure are not limited thereto:

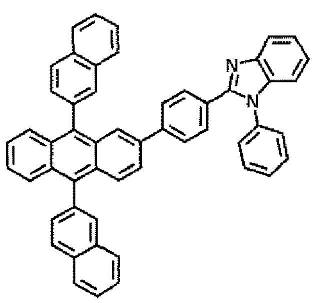

ET1

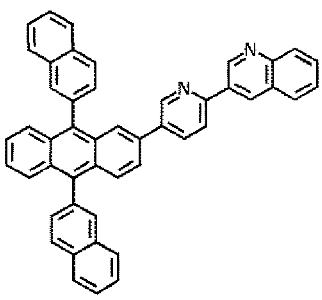

ET2

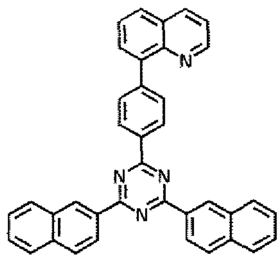

ET3

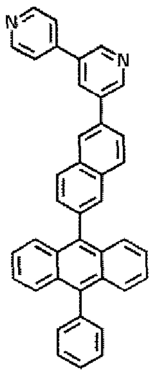

ET4

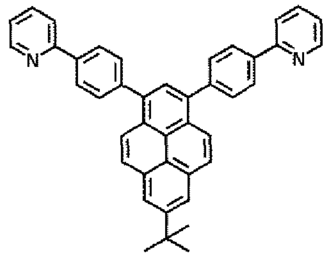

ET5

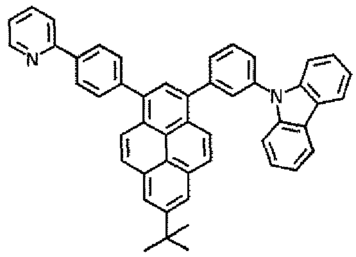

ET6

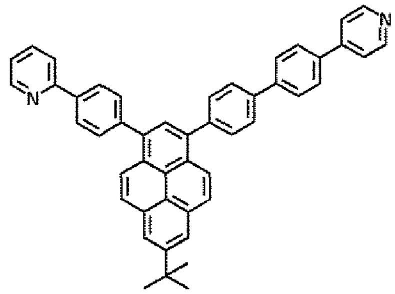

ET7

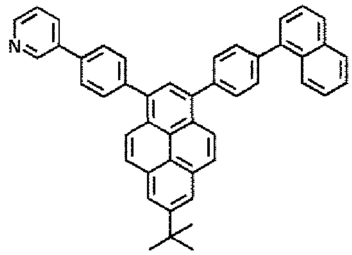

ET8

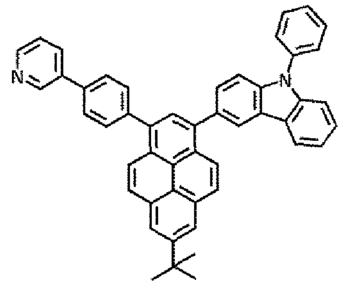

ET9

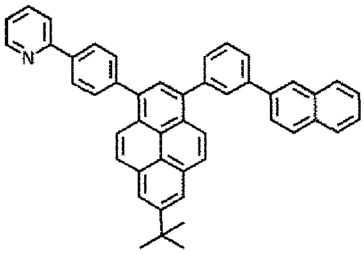

ET10

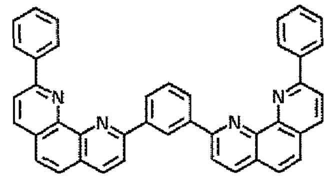

ET11

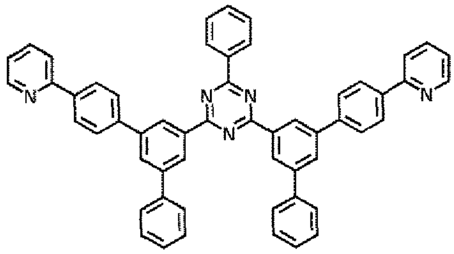

ET12

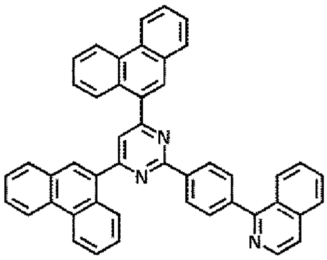

ET13

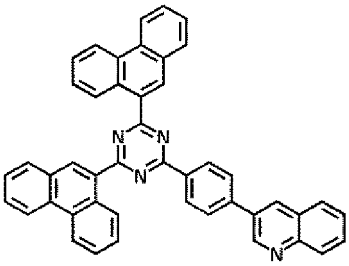

ET14

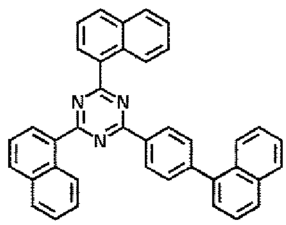

ET15

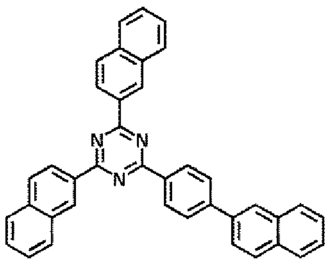

ET16

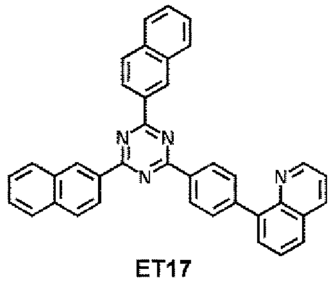

ET17

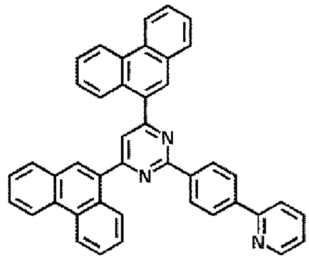

ET18

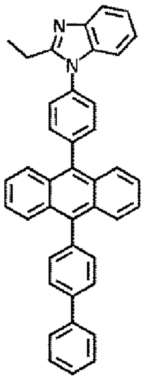

ET19

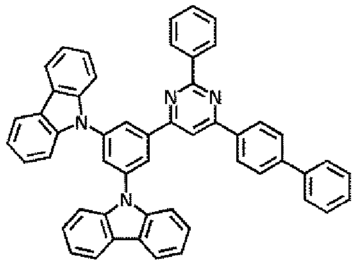

ET20

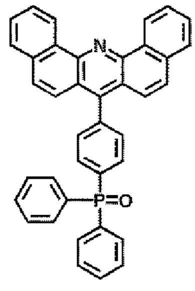

ET21

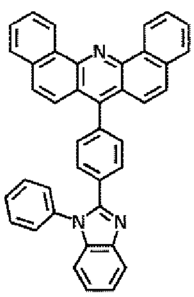

ET22

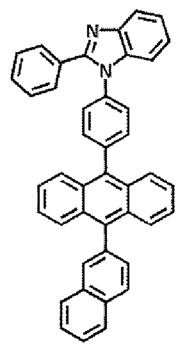

ET23

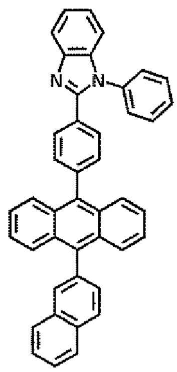

ET24

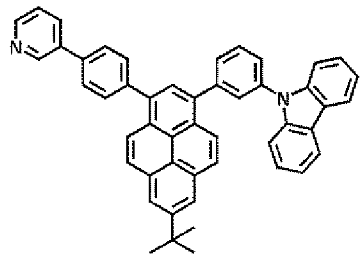

ET25

.

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or Compound ET-D2:

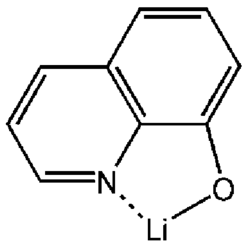

ET-D1

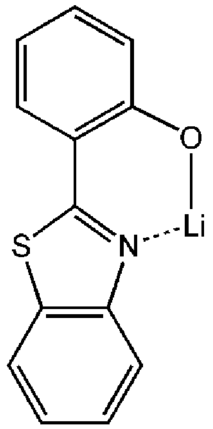

ET-D2 .

The electron transport region may include an electron injection layer that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, for example, about 3 Å to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to Figure 1, but embodiments of the present disclosure are not limited thereto.

The organometallic compound represented by Formula 1-1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and non-limiting examples thereof include a methoxy group, an ethoxy group, and an iso-propyloxy (iso-propoxy) group.

The term "$C_2$-$C_{60}$ alkenyl group" as used herein refers to a hydrocarbon group formed by including at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by including at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and

non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof, that is non-aromatic, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having an aromatic system that has at least one heteroatom selected from N, O, P, and S as a ring-forming atom, and 1 to 60 carbon atoms. The term "$C_1$-$C_{60}$ heteroarylene group" as used herein refers to a divalent group having an aromatic system that has at least one heteroatom selected from N, O, P, Si, and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" as used herein indicates $-OA_{102}$ (wherein $A_{102}$ is the $C_6$-$C_{60}$ aryl group), the term "$C_6$-$C_{60}$ arylthio group" as used herein indicates $-SA_{103}$ (wherein $A_{103}$ is the $C_6$-$C_{60}$ aryl group), and the term "$C_7$-$C_{60}$ arylalkyl group" as used herein indicates $-A_{104}A_{105}$ (wherein $A_{104}$ is the $C_6$-$C_{59}$ aryl group and $A_{105}$ is the $C_1$-$C_{53}$ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group," as used herein, refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The $C_1$-$C_{30}$ heterocyclic group may be a monocyclic group or a polycyclic group.

At least one substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_2$-$C_{60}$ heteroaryloxy group, the substituted $C_2$-$C_{60}$ heteroarylthio group, the substituted $C_3$-$C_{60}$ heteroarylalkyl group, the substituted monovalent non-aromatic condensed polycyclic group, and the substituted monovalent non-aromatic condensed heteropolycyclic group may be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group,

an amidino group, a hydrazine group, a hydrazone group, a carboxylic acid group or a salt thereof, a sulfonic acid group or a salt thereof, a phosphoric acid group or a salt thereof, $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, and a monovalent non-aromatic condensed heteropolycyclic group.

When a group containing a specified number of carbon atoms is substituted with any of the groups listed in the preceding paragraph, the number of carbon atoms in the resulting "substituted" group is defined as the sum of the carbon atoms contained in the original (unsubstituted) group and the carbon atoms (if any) contained in the substituent. For example, when the term "substituted $C_1$-$C_{30}$ alkyl" refers to a $C_1$-$C_{30}$ alkyl group substituted with $C_6$-$C_{30}$ aryl group, the total number of carbon atoms in the resulting aryl substituted alkyl group is $C_7$-$C_{60}$.

Hereinafter, a compound and an organic light-emitting device according to embodiments are described in detail with reference to Synthesis Examples and Examples. However, the organic light-emitting device is not limited thereto. The wording "B was used instead of A" used in describing Synthesis Examples means that the number of molar equivalents of A used was identical to the number of molar equivalents of B used.

EXAMPLES

Synthesis Example 1: Synthesis of Compound 1-1

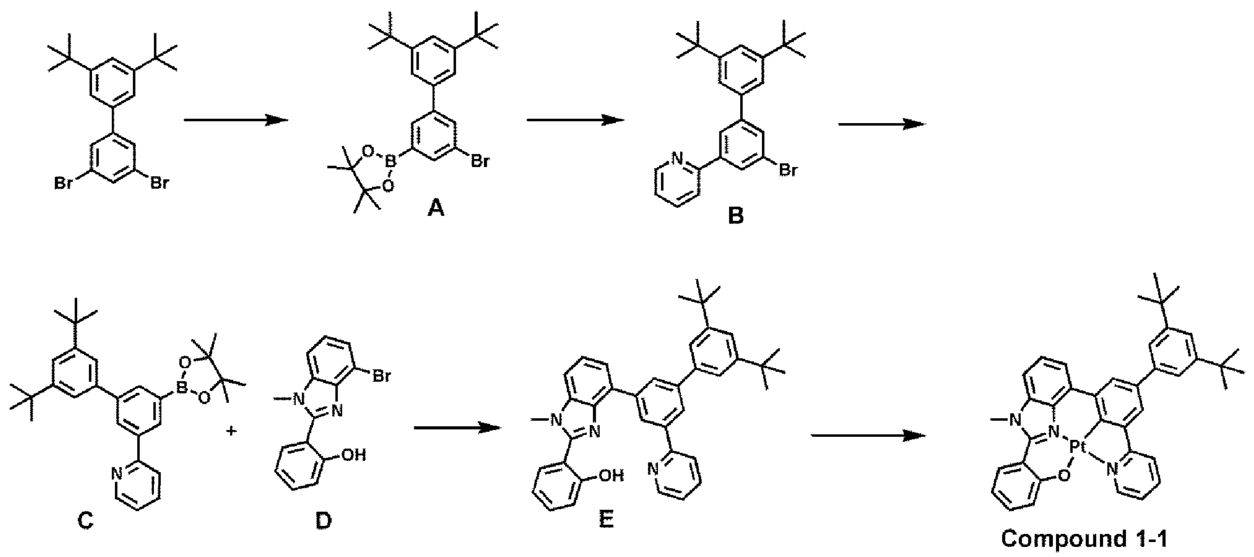

A B C D E Compound 1-1

Synthesis of Intermediate A (2-(5-bromo-3',5'-di-tert-butyl-[1,1'-biphenyl]-3-yl)-4,4,5,5-tetramethyl-1,3,2-dioxaborolane)

10 grams (g) (0.024 moles, mol) of 3,5-dibromo-3',5'-di-tert-butyl-1,1'-biphenyl and 9.0 g (0.036 mol, 1.5 equivalents, equiv.) of bispinacolato diboron were added to a flask, and 4.6 g (0.048 mol, 2 equiv.) of potassium acetate and 0.96 g (0.05 equiv.) of $PdCl_2$(dppf) were added to the flask. Then, 100 milliliters (ml) of toluene was added thereto, and the resultant mixture was refluxed overnight at a temperature of 100°C. The refluxed mixture thus obtained was cooled to room temperature, and the precipitate was filtered therefrom. The filtrate was washed by using ethyl acetate (EA)/$H_2O$, and purified by column chromatography to obtain 5.6 g (yield: 50%) of Intermediate A. The obtained product was confirmed by Mass Spectrometry and HPLC analysis.
HRMS (MALDI) calcd for $C_{26}H_{36}BBrO_2$: m/z 470.1992, found: 470.1994

Synthesis of Intermediate **B** (2-(5-bromo-3',5'-di-tert-butyl-[1,1'-biphenyl]-3-yl)pyridine)

5.6 g (0.014 mol, 1.2 equiv.) of Intermediate A, 1.9 g (0.012 mol, 1 equiv.) of 2-bromopyridine, 0.61 g (0.001 mol, 0.07 equiv.) of tetrakis(triphenylphosphine)palladium(0), and 3.1 g (0.036 mol, 3 equiv.) of potassium carbonate were dissolved in a solvent (25 mL, 0.8 molar, M) in which tetrahydrofuran (THF) and distilled water ($H_2O$) were mixed at a ratio of 3:1, and the mixed solution was refluxed for 12 hours. The refluxed mixture thus obtained was cooled to room temperature, and the precipitate was filtered therefrom. The filtrate was washed by using EA/$H_2O$, and purified by column chromatography (while increasing a volume rate of methylene chloride (MC)/hexane (Hex) to between 25% and 50%) to obtain 4 g (yield: 80%) of Intermediate B. The obtained product was confirmed by Mass Spectrometry and HPLC analysis.
HRMS (MALDI) calcd for $C_{25}H_{28}BrN$: m/z 421.1405, found: 421.1407

Synthesis of Intermediate **C** (2-(3',5'-di-tert-butyl-5-(4,4,5,5-tetramethyl-1,3,2-dioxaborolan-2-yl)-[1,1'-biphenyl]-3-yl)pyridine)

4 g (0.009 mol) of Intermediate **B** (2-(5-bromo-3',5'-di-tert-butyl-[1,1'-biphenyl]-3-yl)pyridine) and 3.6 g (0.014 mol, 1.5 equiv.) of bispinacolato diboron were added to a flask, and 1.9 g (0.019 mol, 2 equiv.) of potassium acetate and 0.39 g (0.05 equiv.) of $PdCl_2$(dppf) were added to the flask. Then, 32 mL of toluene was added thereto, and the resultant mixture was refluxed overnight at a temperature of 100°C. The refluxed mixture thus obtained was cooled to room temperature, and the precipitate was filtered therefrom. The filtrate was washed by using EA/$H_2O$, and purified by column chromatography to obtain 2.4 g (yield: 56%) of Intermediate C. The obtained product was confirmed by Mass Spectrometry and HPLC analysis.
HRMS (MALDI) calcd for $C_{31}H_{40}BNO_2$: m/z 469.3152, found: 469.3155

Synthesis of Intermediate **E** (2-(4-(3',5'-di-tert-butyl-5-(pyridin-2-yl)-[1,1'-biphenyl]-3-yl)-1-methyl-1H-benzo[d]imidazol-2-yl)phenol)

2.4 g (0.005 mol, 1.2 equiv.) of Intermediate C, 1.3 g (0.004 mol, 1 equiv.) of Intermediate D (2-(4-bromo-1-methyl-1H-benzo[d]imidazol-2-yl)phenol), 0.35 g (0.001 mol, 0.07 equiv.) of tetrakis(triphenylphosphine)palladium(0), and 1.8 g (0.013 mol, 3 equiv.) of potassium carbonate were dissolved in 20 mL of a solvent in which tetrahydrofuran (THF) and distilled water ($H_2O$) were mixed at a ratio of 3:1, and the mixed solution was refluxed for 12 hours. The refluxed mixture thus obtained was cooled to room temperature, and the precipitate was filtered therefrom. The filtrate was washed by using EA/$H_2O$, and purified by column chromatography (while increasing a volume rate of MC/Hex to between 25% and 50%) to obtain 1.7 g (yield: 73%) of Intermediate E. The obtained product was confirmed by Mass Spectrometry and HPLC analysis.
HRMS (MALDI) calcd for $C_{39}H_{39}N_3O$: m/z 565.3093, found: 565.3096

Synthesis of Compound 1-1

1.4 g (2.5 mmol) of Intermediate E and 1.23 g (3 mmol, 1.2 equiv.) of $K_2PtCl_4$ were dissolved in 25 mL of a solvent in which 20 mL of AcOH and 5 mL of $H_2O$ were mixed, and the mixed solution was refluxed for 16 hours. The refluxed mixture thus obtained was cooled to room temperature, and the precipitate was filtered therefrom. The precipitate was dissolved again in MC and washed by using $H_2O$. The organic layer was purified by column chromatography (MC 40%, EA 1%, Hex 59%) to obtain 0.7 g (purity: 99% or more) of Compound 1-1. The obtained product was confirmed by Mass Spectrometry and HPLC analysis.
HRMS (MALDI) calcd for $C_{39}H_{37}N_3OPt$: m/z 758.26, found:758.26

Synthesis Example 2: Synthesis of Compound 1-28

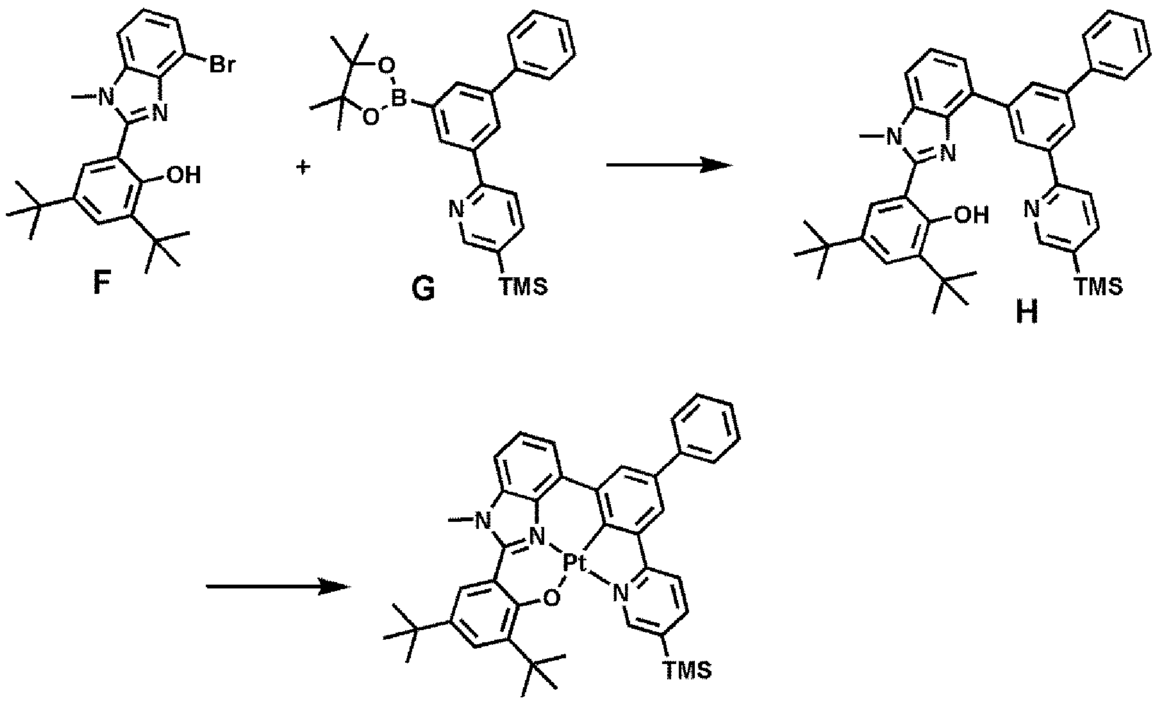

Compound 1-28

Synthesis of Intermediate H

Intermediate H was synthesized in the same manner as Intermediate E in Synthesis Example 1, except that Intermediate F and Intermediate G were used instead of Intermediate D and Intermediate C, respectively.
HRMS (MALDI) calcd for $C_{42}H_{47}N_3OSi$: m/z 637.3488, found: 637.3485

Synthesis of Compound 1-28

Compound 1-28 (1.5 g, yield: 52%) was synthesized in the same manner as Compound 1-1 in Synthesis

Example 1, except that Intermediate H was used instead of Intermediate E.
HRMS (MALDI) calcd for $C_{42}H_{45}N_3OPtSi$: m/z 830.2980, found: 830.2983

Synthesis Example 3: Synthesis of Compound 1-30

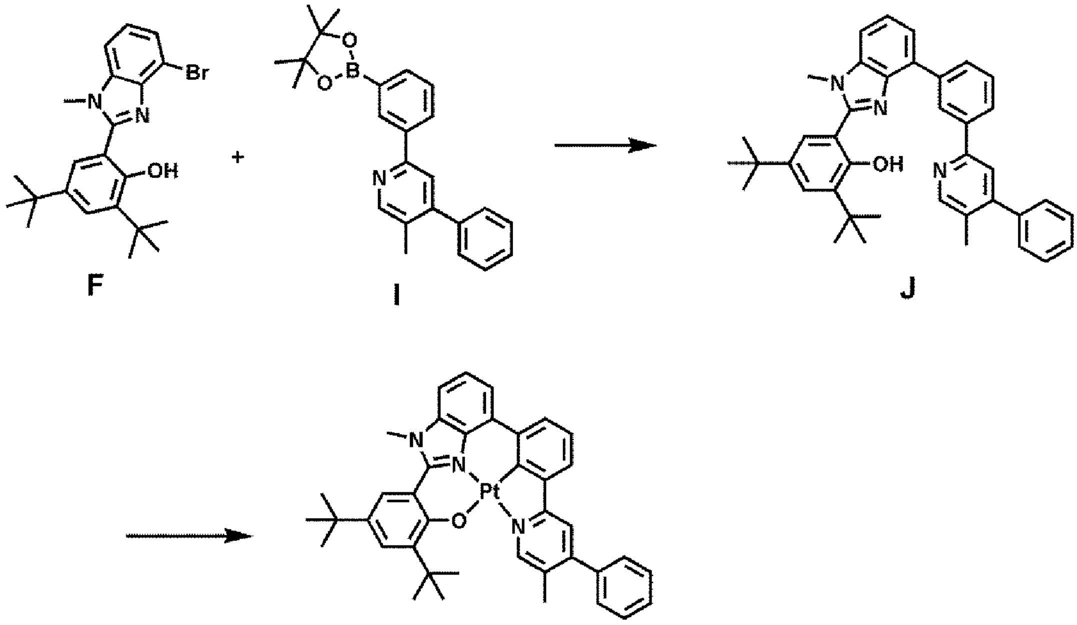

F I J

Compound 1-30

Synthesis of Intermediate J

Intermediate J was synthesized in the same manner as Intermediate E in Synthesis Example 1, except that Intermediate F and Intermediate I were used instead of Intermediate D and Intermediate C, respectively.
HRMS (MALDI) calcd for $C_{40}H_{41}N_3O$: m/z 579.3250, found: 579.3252

Synthesis of Compound 1-30

Compound 1-30 (1.2 g, yield: 56%) was synthesized in the same manner as Compound 1-1 in Synthesis Example 1, except that Intermediate J was used instead of Intermediate E.
HRMS (MALDI) calcd for $C_{40}H_{39}N_3OPt$: m/z 772.2741, found: 772.2745

Synthesis Example 4: Synthesis of Compound 1-17

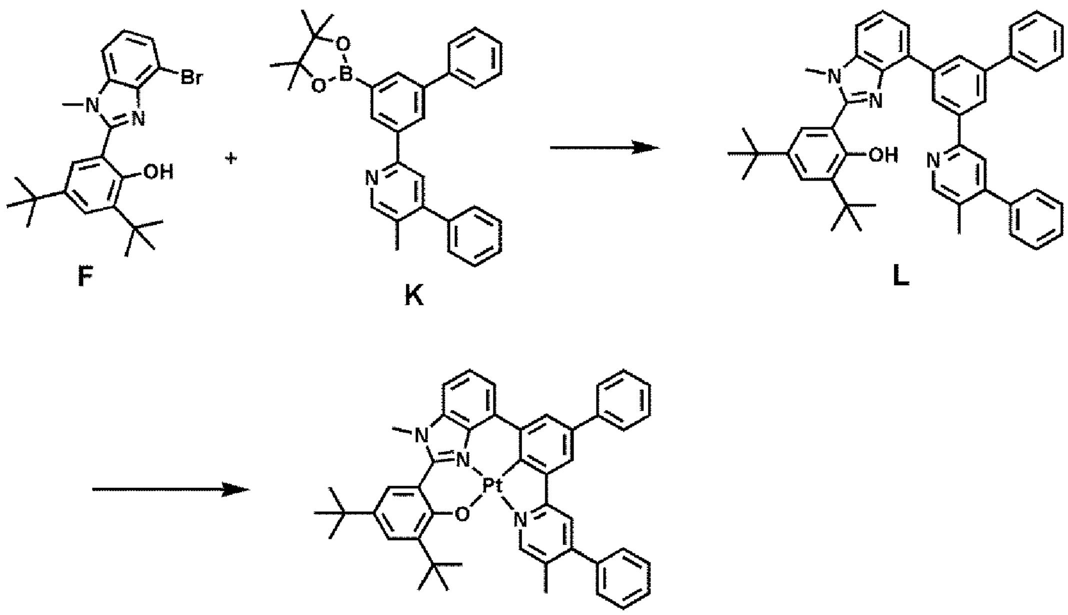

F K L

Compound 1-17

Synthesis of Intermediate L

Intermediate L was synthesized in the same manner as Intermediate E in Synthesis Example 1, except that Intermediate F and Intermediate K were used instead of Intermediate D and Intermediate C, respectively.
HRMS (MALDI) calcd for $C_{46}H_{45}N_3O$: m/z 655.3563, found: 655.3567

Synthesis of Compound 1-17

Compound 1-17 (1.7g, yield: 57%) was synthesized in the same manner as Compound 1-1 in Synthesis Example 1, except that Intermediate L was used instead of Intermediate E.
HRMS (MALDI) calcd for $C_{46}H_{43}N_3OPt$: m/z 848.3054, found: 848.3053

Synthesis Example 5: Synthesis of Compound 1-9

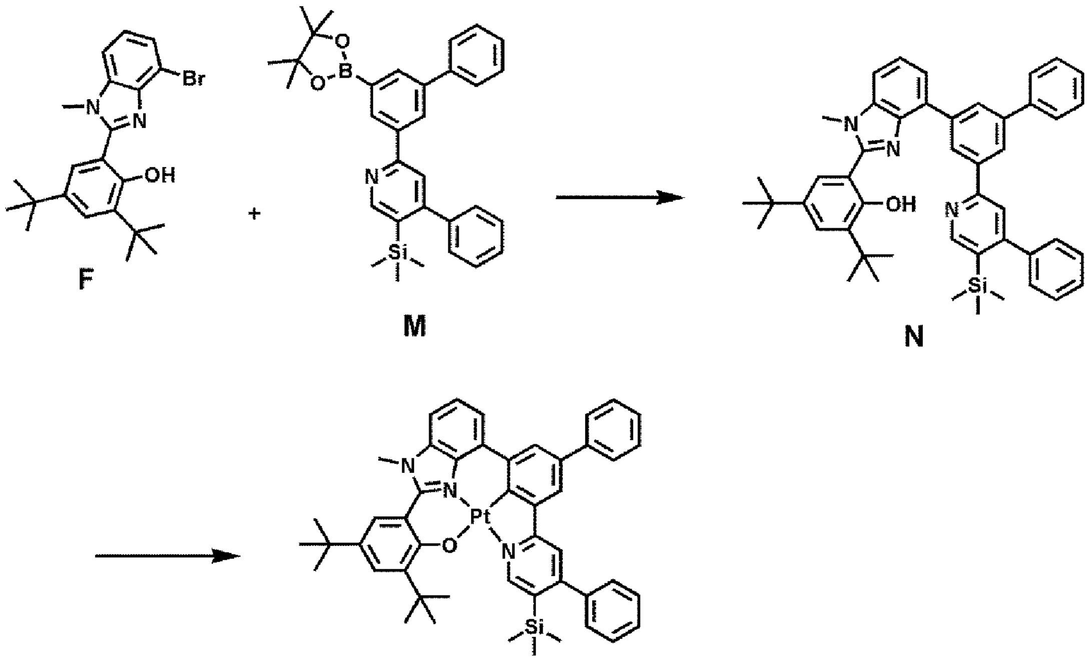

F

M

N

Compound 1-9

Synthesis of Intermediate N

Intermediate N was synthesized in the same manner as Intermediate E in Synthesis Example 1, except that Intermediate F and Intermediate M were used instead of Intermediate D and Intermediate C, respectively.
HRMS (MALDI) calcd $C_{48}H_{51}N_3OSi$: m/z 713.3801, found: 713.3804

Synthesis of Compound 1-9

Compound 1-9 (1.2 g, yield: 52%) was synthesized in the same manner as Compound 1-1 in Synthesis Example 1, except that Intermediate N was used instead of Intermediate E.
HRMS (MALDI) calcd for $C_{48}H_{49}N_3OPtSi$: m/z 906.3293, found: 906.3297

Synthesis Example 6: Synthesis of Compound 1-12

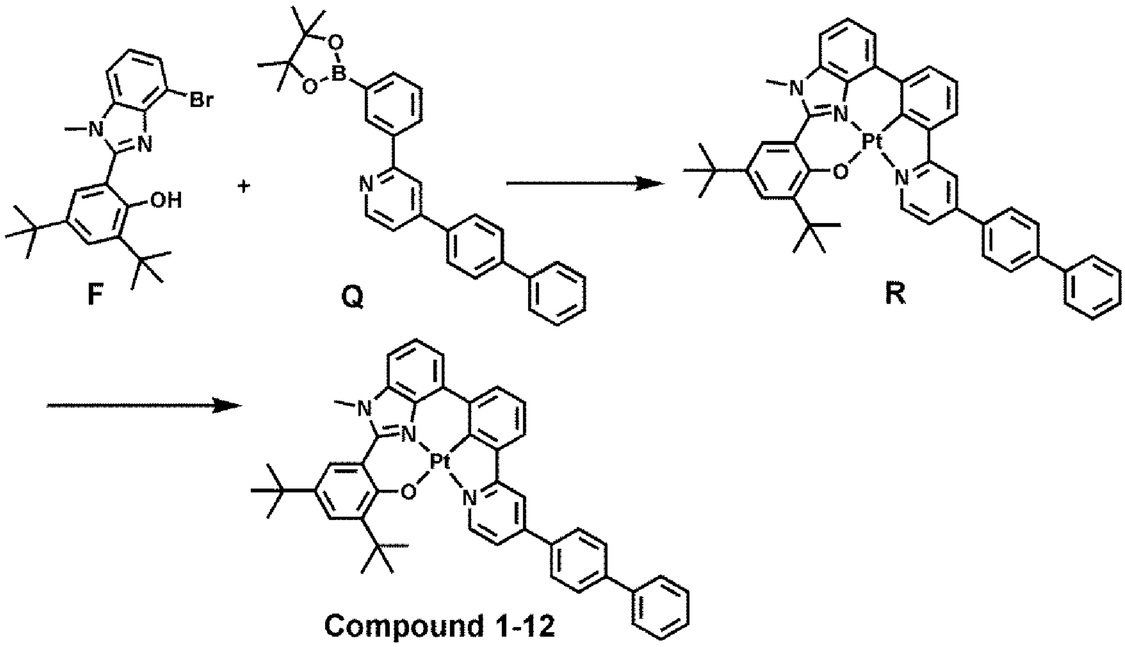

F Q R

Compound 1-12

Synthesis of Intermediate R

Intermediate R was synthesized in the same manner as Intermediate E in Synthesis Example 1, except that Intermediate F and Intermediate Q were used instead of Intermediate D and Intermediate C, respectively.
HRMS (MALDI) calcd for $C_{45}H_{43}N_3O$: m/z 641.3406, found: 641.3408

Synthesis of Compound 1-12

Compound 1-12 (1.0 g, yield: 45%) was synthesized in the same manner as Compound 1-1 in Synthesis Example 1, except that Intermediate R was used instead of Intermediate E.
HRMS (MALDI) calcd for $C_{45}H_{41}N_3OPt$ : m/z 834.2897, found: 834.2892

Synthesis Example 7: Synthesis of Compound 3-417

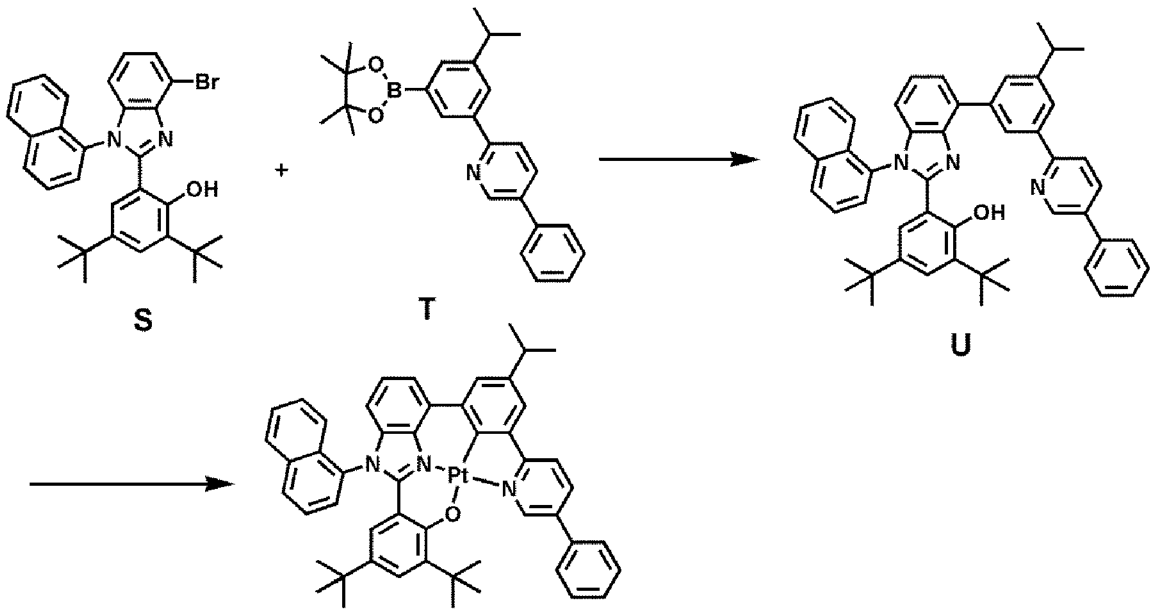

S T U

Compound 3-417

Synthesis of Intermediate U

Intermediate U was synthesized in the same manner as Intermediate E in Synthesis Example 1, except that Intermediate S and Intermediate T were used instead of Intermediate D and Intermediate C, respectively.
HRMS (MALDI) calcd for $C_{51}H_{49}N_3O$: m/z 719.3876, found: 719.3874

Synthesis of Compound 3-417

Compound 3-417 (1.2 g, yield: 55%) was synthesized in the same manner as Compound 1-1 in Synthesis Example 1, except that Intermediate U was used instead of Intermediate E.
HRMS (MALDI) calcd for $C_{45}H_{41}N_3OPt$ : m/z 912.3367, found: 912.3369

Example 1

An ITO glass substrate on which an ITO electrode (anode) is deposited was cut to a size of 50 mm x 50 mm x 0.5 mm (mm = millimeter), sonicated with acetone, iso-propyl alcohol, and pure water each for 15 minutes, and cleaned by exposure to ultraviolet (UV) rays and ozone for 30 minutes.

Then, m-MTDATA was deposited on an ITO electrode (anode) of the glass substrate at a deposition rate of 1 Angstroms per second (Å/sec) to form a hole injection layer having a thickness of 600 Angstroms (Å), and $\alpha$-NPD (also referred to as NPB) was deposited on the hole injection layer at a deposition rate of 1 Å/sec to form a hole transport layer having a thickness of 250 Å.

Compound 1-28 (dopant) and CBP (host) were co-deposited on the hole transport layer at a deposition rate of 0.1 Å/sec and 1 Å/sec, respectively, to form an emission layer having a thickness of 400 Å.

BAlq was deposited on the emission layer at a deposition rate of 1 Å/sec to form a hole blocking layer having a thickness of 50 Å, $Alq_3$ was deposited on the hole blocking layer to form an electron transport layer having a thickness of 300 Å, LiF was deposited on the electron transport layer to form an electron injection layer having a thickness of 10 Å, and Al was vacuum-deposited on the electron injection layer to form a second electrode (cathode) having a thickness of 1,200 Å, thereby completing the manufacture of an organic light-emitting device having a structure of ITO / m-MTDATA (600 Å) / $\alpha$-NPD (250 Å) / CBP + Compound 1-28 (10 wt%) (400 Å) / BAlq (50 Å) / $Alq_3$ (300 Å) / LiF (10 Å) / Al (1,200 Å).

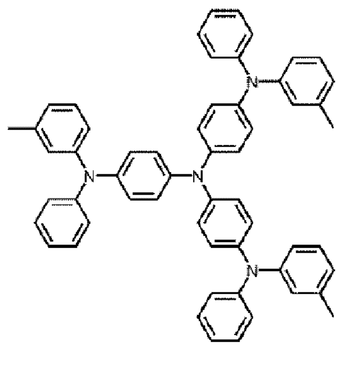

m-MTDATA

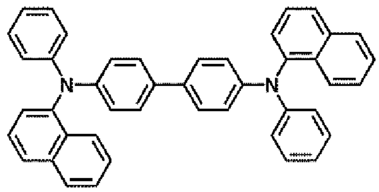

NPB

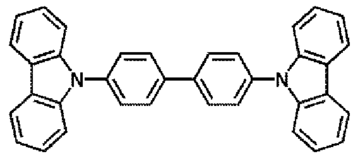

CBP

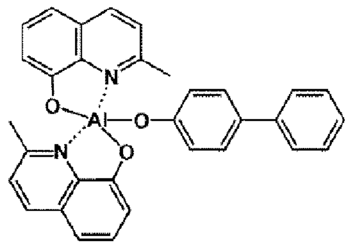

BAlq

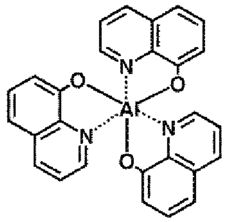

$Alq_3$

Examples 2 to 6 and Comparative Examples 1 to 4

Organic light-emitting devices were manufactured in the same manner as in Example 1, except that Compounds shown in Table 2 were each used instead of Compound 1-28 as a dopant in forming an emission layer.

Evaluation Example 1: Evaluation of characteristics of organic light-emitting devices

The driving voltage, luminescent efficiency, quantum emission efficiency, roll-off ratio, and lifespan ($T_{95}$) characteristics of the organic light-emitting device manufactured according to Examples 1 to 6 and Comparative Examples 1 to 4 were evaluated, and results thereof are shown in Table 2. Devices used for the evaluation were a current-voltage meter (Keithley 2400) and a luminance meter (Minolta Cs-1000A). The lifespan ($T_{95}$) (at 6,000 nit) indicates an amount of time that lapsed when luminance was 95% of initial luminance (100%) in a relative manner with respect to those of the organic light-emitting device of Example 6. The roll-off ratio was calculated according to Equation 20. The luminescence efficiency are also provided in a relative manner with respect to those of the organic light-emitting device of Example 5.

Equation 20

$$\text{Roll off} = \{1- (\text{efficiency at 9,000 nit / maximum light-emission efficiency})\} \times 100\%$$

Table 2

| | Dopant | Driving voltage (V) | Luminescent efficiency (%) (relative value) | Quantum emission efficiency (%) | Roll-off ratio (%) | Lifespan (%) ($T_{95}$) (relative value) |
|---|---|---|---|---|---|---|
| Example 1 | Compound 1-28 | 4.11 | 81% | 84% | 14% | 24% |

(continued)

| | Dopant | Driving voltage (V) | Luminescent efficiency (%) (relative value) | Quantum emission efficiency (%) | Roll-off ratio (%) | Lifespan (%) ($T_{95}$) (relative value) |
|---|---|---|---|---|---|---|
| Example 2 | Compound 1-30 | 4.14 | 80% | 89% | 15% | 11% |
| Example 3 | Compound 1-17 | 4.10 | 84% | 87% | 11% | 28% |
| Example 4 | Compound 1-9 | 3.90 | 91% | 91% | 9% | 15% |
| Example 5 | Compound 1-12 | 3.82 | 100% | 100% | 6% | 75% |
| Example 6 | Compound 3-417 | 3.94 | 92% | 94% | 10% | 100% |
| Comparative Example 1 | Compound A | 4.57 | 50% | 69% | 11% | 18% |
| Comparative Example 2 | Compound B | 4.00 | 61% | 56% | 9% | 0% |
| Comparative Example 3 | Compound C | 4.97 | 62% | 61% | 35% | 4% |
| Comparative Example 4 | Compound D | 4.78 | 57% | 60% | 19% | 0% |

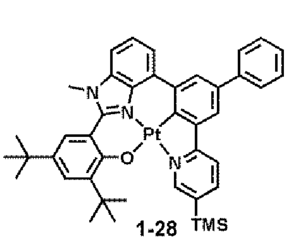
1-28

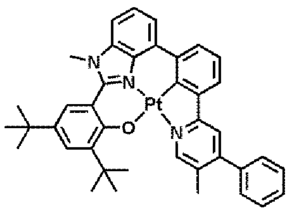
1-30

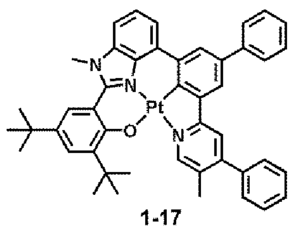
1-17

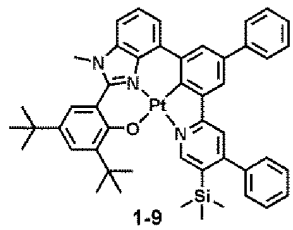
1-9

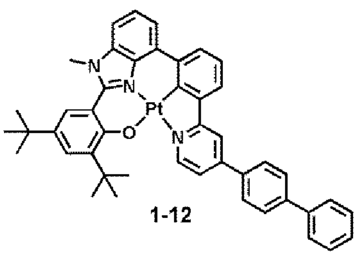
1-12

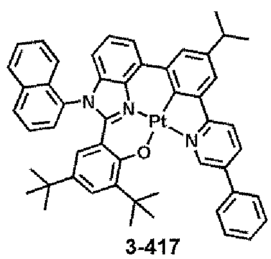
3-417

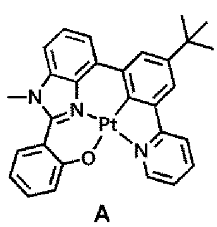
A

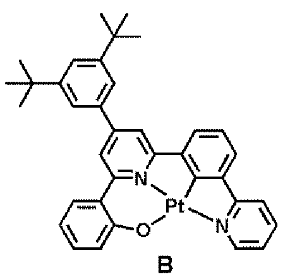
B

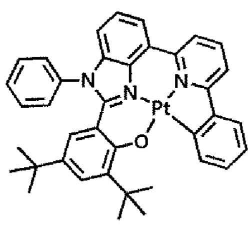
C

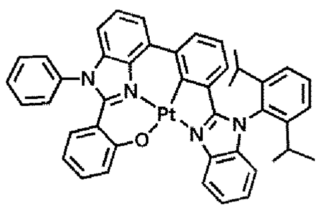
D

Referring to Table 2, it was confirmed that the organic light-emitting devices of Examples 1 to 6 have improved driving voltage, luminescent efficiency, quantum emission efficiency, roll-off ratio, and lifespan characteristics, as compared with those of the organic light-emitting devices of Comparative Examples 1 to 4.

As described above, an organometallic compound according to embodiments of the present disclosure has excellent electrical characteristics and thermal stability, and accordingly, an organic light-emitting device including the organometallic compound may have excellent driving voltage, light-emission efficiency, quantum emission efficiency, roll-off ratio, and lifespan characteristics. In addition, due to excellent phosphorescent luminescence characteristics of the organometallic compound, the organometallic compound may provide a diagnostic composition having high diagnostic efficiency.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figure, it will be understood by those of ordinary skill in the art that various changes in form and details may be made therein without departing from the scope of the present disclosure as defined by the following claims.

## Claims

1. An organometallic compound represented by Formula 1-1:

Formula 1-1

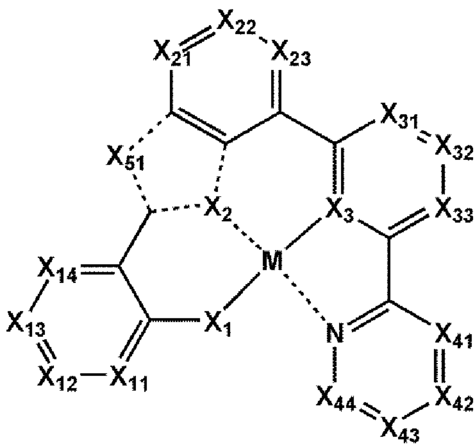

**Formula 1-1**

,

wherein, in Formula 1-1,

M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),
$X_1$ is O or S, and a bond between $X_1$ and M is a covalent bond,
i) $X_2$ is N, $X_3$ is C, a bond between $X_2$ and M is a coordinate bond, and a bond between $X_3$ and M is covalent bond; or ii) $X_3$ is N, $X_2$ is C, a bond between $X_3$ and M is a coordinate bond, and a bond between $X_2$ and M is a covalent bond,
$X_{51}$ is selected from O, S, N-[$(L_7)_{b7}$-$(R_7)_{c7}$], C($R_7$)($R_8$), Si($R_7$)($R_8$), and C(=O),
$R_7$ and $R_8$ are optionally linked via a first linking group to form a substituted or unsubstituted $C_5$-$C_{30}$ carbocyclic group or a substituted or unsubstituted $C_1$-$C_{30}$ heterocyclic group, and the first linking group may be selected from a single bond, *-O-*', *-S-*', *-C($R_5$)($P_6$)-*', *-C($R_5$)=*', *=C($R_6$)-*', *-C($R_5$)=C($R_6$)-*', *-C(=O)-*', *-C(=S)-*', *-C≡C-*', *-N($R_5$)-*' and *-Si($R_5$)($R_6$)-*', $R_5$ and $R_6$ are each independently the same as described in connection with $R_7$ described below, and * and *' each indicate a binding site to a neighboring atom,
$L_7$ is selected from a substituted or unsubstituted $C_5$-$C_{30}$ carbocyclic group and a substituted or unsubstituted $C_1$-$C_{30}$ heterocyclic group,
b7 is an integer from 0 to 5,

$R_7$, and $R_8$ are each independently selected from hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_2$-$C_{60}$ heteroaryloxy group, a substituted or unsubstituted $C_2$-$C_{60}$ heteroarylthio group, a substituted or unsubstituted $C_3$-$C_{60}$ heteroarylalkyl group, a substituted or unsubstituted monovalent non-aromatic condensed polycyclic group, a substituted or unsubstituted monovalent non-aromatic condensed heteropolycyclic group, - $N(Q_1)(Q_2)$, $-Si(Q_3)(Q_4)(Q_5)$, $-B(Q_6)(Q_7)$, and $-P(=O)(Q_8)(Q_9)$,

c7 is an integer from 1 to 5,

$X_{11}$ is N or $C-[(L_{11})_{b11}-(R_{11})_{c11}]$, $X_{12}$ is N or $C-[(L_{12})_{b12}-(R_{12})_{c12}]$, $X_{13}$ is N or $C-[(L_{13})_{b13}-(R_{13})_{c13}]$, $X_{14}$ is N or $C-[(L_{14})_{b14}-(R_{14})_{c14}]$,

$L_{11}$ to $L_{14}$, b11 to b14, $R_{11}$ to $R_{14}$ and c11 to c14 are each independently the same as described in connection with $L_7$, b7, $R_7$, and c7 above, respectively,

$X_{21}$ is N or $C-[(L_{21})_{b21}-(R_{21})_{c21}]$, $X_{22}$ is N or $C-[(L_{22})_{b22}-(R_{22})_{c22}]$, $X_{23}$ is N or $C-[(L_{23})_{b23}-(R_{23})_{c23}]$,

$L_{21}$ to $L_{23}$, b21 to b23, $R_{21}$ to $R_{23}$ and c21 to c23 are each independently the same as described in connection with $L_7$, b7, $R_7$, and c7 above, respectively,

$X_{31}$ is N or $C-[(L_{31})_{b31}-(R_{31})_{c31}]$, $X_{32}$ is N or $C-[(L_{32})_{b32}-(R_{32})_{c32}]$, $X_{33}$ is N or $C-[(L_{33})_{b33}-(R_{33})_{c33}]$,

$L_{31}$ to $L_{33}$, b31 to b33, $R_{31}$ to $R_{33}$ and c31 to c33 are each independently the same as described in connection with $L_7$, b7, $R_7$, and c7 above,

$X_{41}$ is N or $C-[(L_{41})_{b41}-(R_{41})_{c41}]$, $X_{42}$ is N or $C-[(L_{42})_{b42}-(R_{42})_{c42}]$, $X_{43}$ is N or $C-[(L_{43})_{b43}-(R_{43})_{c43}]$, $X_{44}$ is N or $C-[(L_{44})_{b44}-(R_{44})_{c44}]$,

$L_{41}$ to $L_{44}$, b41 to b44, $R_{41}$ to $R_{44}$ and c41 to c44 are each independently the same as described in connection with $L_7$, b7, $R_7$, and c7 above,

two selected from $R_{11}$ to $R_{14}$ are optionally linked to form a substituted or unsubstituted $C_5$-$C_{30}$ carbocyclic group or a substituted or unsubstituted $C_1$-$C_{30}$ heterocyclic group,

two selected from $R_{21}$ to $R_{23}$ are optionally linked to form a substituted or unsubstituted $C_5$-$C_{30}$ carbocyclic group or a substituted or unsubstituted $C_1$-$C_{30}$ heterocyclic group,

two selected from $R_{31}$ to $R_{33}$ are optionally linked to form a substituted or unsubstituted $C_5$-$C_{30}$ carbocyclic group or a substituted or unsubstituted $C_1$-$C_{30}$ heterocyclic group, and

two selected from $R_{41}$ to $R_{44}$ are optionally linked to form a substituted or unsubstituted $C_5$-$C_{30}$ carbocyclic group or a substituted or unsubstituted $C_1$-$C_{30}$ heterocyclic group,

in cases where i)-vii) below apply, at least one selected from $R_{11}$ to $R_{14}$, $R_{21}$ to $R_{23}$, $R_{31}$ to $R_{33}$ and $R_{41}$ to $R_{44}$ is selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group,

i) M is Pt, ii) $X_1$ is O, iii) $X_2$ is N, $X_3$ is C, a bond between $X_2$ and M is a coordinate bond, and a bond between $X_3$ and M is a covalent bond, iv) the two bonds from $X_{51}$ indicated by a dotted line are each a single bond, v) $X_{11}$, $X_{12}$, $X_{13}$, $X_{14}$, $X_{21}$, $X_{22}$ $X_{23}$, $X_{31}$, $X_{32}$, $X_{33}$, $X_{41}$, $X_{42}$, $X_{43}$ and $X_{44}$ are $C-[(L_{11})_{b11}-(R_{11})_{c11}]$, $C-[(L_{12})_{b12}-(R_{12})_{c12}]$, $C-[(L_{13})_{b13}-(R_{13})_{c13}]$, $C-[(L_{14})_{b14}-(R_{14})_{c14}]$, $C-[(L_{21})_{b21}-(R_{21})_{c21}]$, $C-[(L_{22})_{b22}-(R_{22})_{c22}]$, $C-[(L_{23})_{b23}-(R_{23})_{23}]$, $C-[(L_{31})_{b31}-(R_{31})_{c31}]$, $C-[(L_{32})_{b32}-(R_{32})_{c32}]$, $C-[(L_{33})_{b33}-(R_{33})_{33}]$, $C-[(L_{41})_{b41}-(R_{41})_{c41}]$, $C-[(L_{42})_{b42}-(R_{42})_{c42}]$, $C-[(L_{43})_{b43}-(R_{43})_{c43}]$ and $C-[(L_{44})_{b44}-(R_{44})_{c44}]$, respectively, vi) $X_{51}$ is O, S, or $N-[(L_7)_{b7}-(R_7)_{c7}]$, and vii) b7 is 0, c7 is 1, and $R_7$ is a substituted or unsubstituted $C_1$-$C_{60}$ alkyl group;

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_2$-$C_{60}$ heteroaryloxy group, the substituted $C_2$-$C_{60}$ heteroarylthio group, the substituted $C_3$-$C_{60}$ heteroarylalkyl group, the substituted monovalent non-aromatic condensed polycyclic group, and the substituted monovalent non-aromatic condensed

heteropolycyclic group is selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, - $CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, and a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, a monovalent non-aromatic condensed heteropolycyclic group, $-N(Q_{21})(Q_{22})$, - $Si(Q_{23})(Q_{24})(Q_{25})$, $-B(Q_{26})(Q_{27})$, and $-P(=O)(Q_{28})(Q_{29})$; and
$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_2$-$C_{60}$ heteroaryloxy group, a $C_2$-$C_{60}$ heteroarylthio group, a $C_3$-$C_{60}$ heteroarylalkyl group, a monovalent non-aromatic condensed polycyclic group, and a monovalent non-aromatic condensed heteropolycyclic group.

**2.** The organometallic compound of claim 1, wherein $R_7$ and $R_8$ are each independently selected from:

hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, - $SF_5$, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, $C_1$-$C_{10}$ alkyl group, a cyclopentyl group, a

cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and $-Si(Q_{33})(Q_{34})(Q_{35})$; and
$-N(Q_1)(Q_2)$, $-Si(Q_3)(Q_4)(Q_5)$, $-B(Q_6)(Q_7)$, and $-P(=O)(Q_8)(Q_9)$, and
$Q_1$ to $Q_9$ and $Q_{33}$ to $Q_{35}$ are each independently selected from:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, and $-CD_2CDH_2$;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group;

preferably wherein $R_7$ and $R_8$ are each independently selected from hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, $-C_2F_5$, $-C_2F_4H$, $-C_2F_3H_2$, $-C_2F_2H_3$, $-C_2FH_4$,

groups represented by Formulae 9-1 to 9-19, groups represented by Formulae 10-1 to 10-167, $-N(Q_1)(Q_2)$, $-Si(Q_3)(Q_4)(Q_5)$, $-B(Q_6)(Q_7)$, and $-P(=O)(Q_8)(Q_9)$:

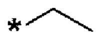
Formula 9-1
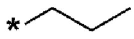
Formula 9-2
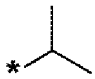
Formula 9-3
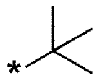
Formula 9-4
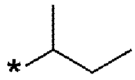
Formula 9-5
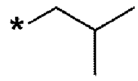
Formula 9-6
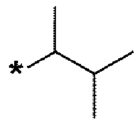
Formula 9-7

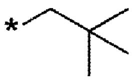
Formula 9-8
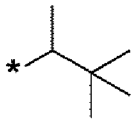
Formula 9-9
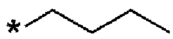
Formula 9-10
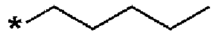
Formula 9-11
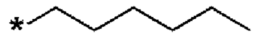
Formula 9-12

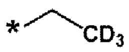
Formula 9-13
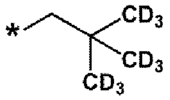
Formula 9-14
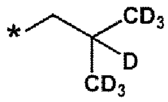
Formula 9-15
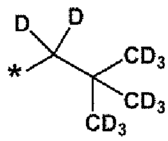
Formula 9-16
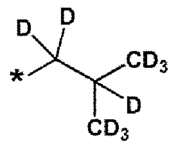
Formula 9-17
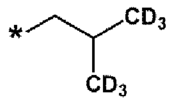
Formula 9-18

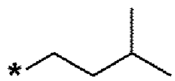
Formula 9-19

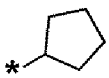
Formula 10-1
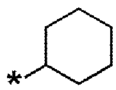
Formula 10-2
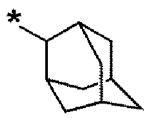
Formula 10-3
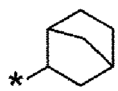
Formula 10-4
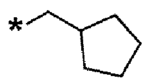
Formula 10-5
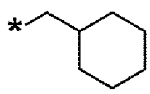
Formula 10-6
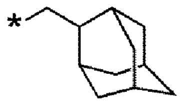
Formula 10-7

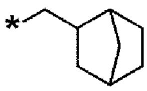
Formula 10-8
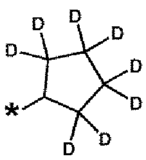
Formula 10-9
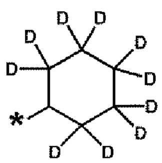
Formula 10-10
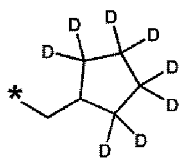
Formula 10-11
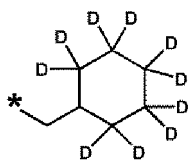
Formula 10-12
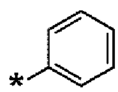
Formula 10-13

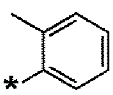
Formula 10-14
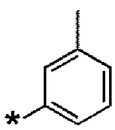
Formula 10-15
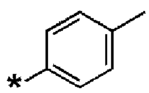
Formula 10-16
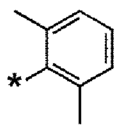
Formula 10-17
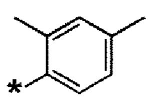
Formula 10-18
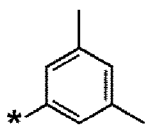
Formula 10-19
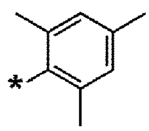
Formula 10-20

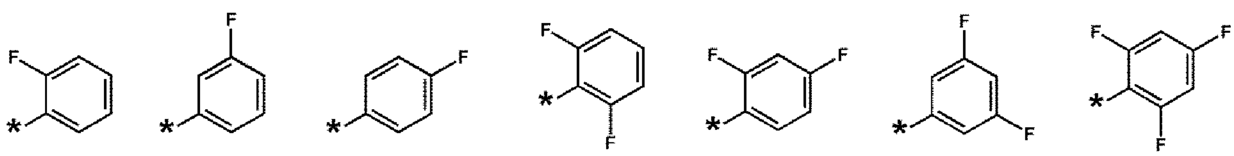
Formula 10-21
Formula 10-22
Formula 10-23
Formula 10-24
Formula 10-25
Formula 10-26
Formula 10-27

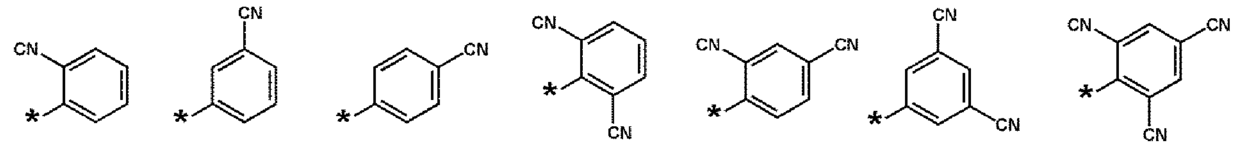

Formula 10-28 Formula 10-29 Formula 10-30 Formula 10-31 Formula 10-32 Formula 10-33 Formula 10-34

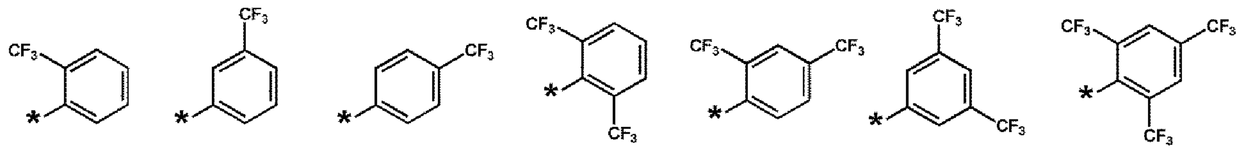

Formula 10-35 Formula 10-36 Formula 10-37 Formula 10-38 Formula 10-39 Formula 10-40 Formula 10-41

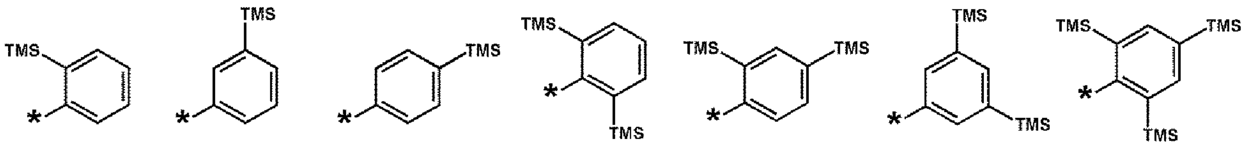

Formula 10-42 Formula 10-43 Formula 10-44 Formula 10-45 Formula 10-46 Formula 10-47 Formula 10-48

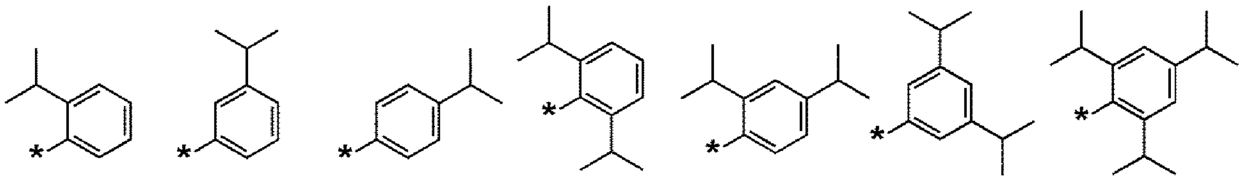

Formula 10-49 Formula 10-50 Formula 10-51 Formula 10-52 Formula 10-53 Formula 10-54 Formula 10-55

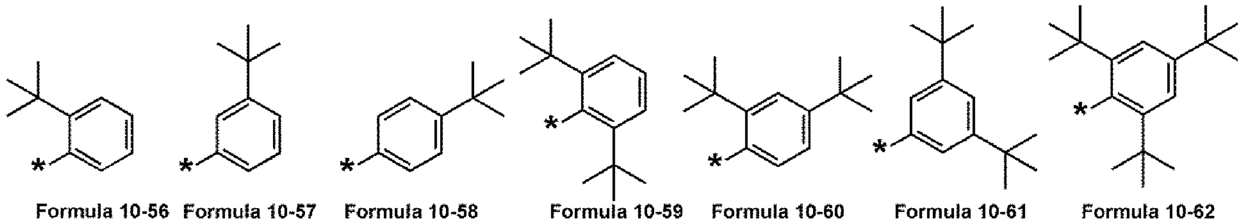

Formula 10-56 Formula 10-57 Formula 10-58 Formula 10-59 Formula 10-60 Formula 10-61 Formula 10-62

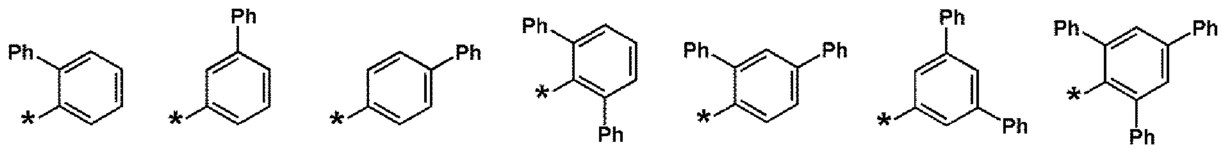

Formula 10-63 Formula 10-64 Formula 10-65 Formula 10-66 Formula 10-67 Formula 10-68 Formula 10-69

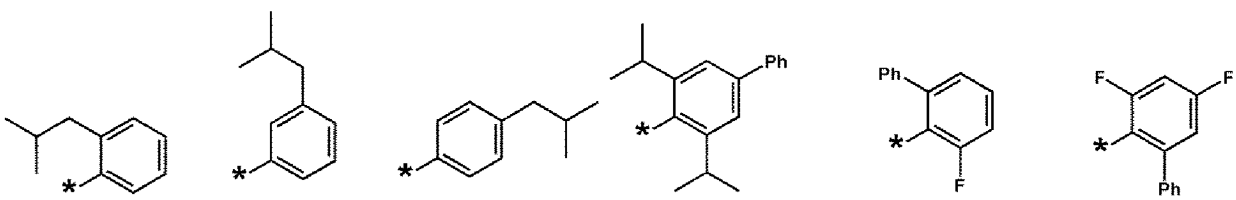

Formula 10-70 Formula 10-71 Formula 10-72 Formula 10-73 Formula 10-74 Formula 10-75

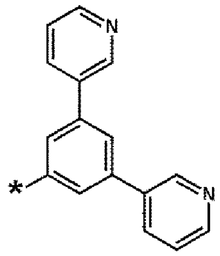
Formula 10-76

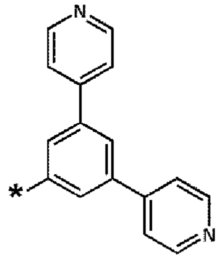
Formula 10-77

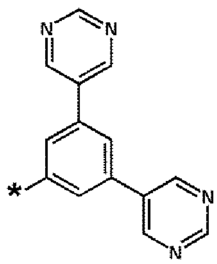
Formula 10-78

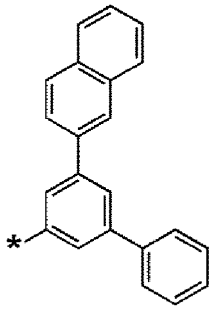
Formula 10-79

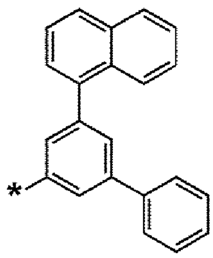
Formula 10-80

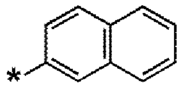
Formula 10-81

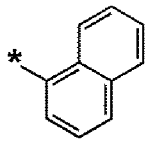
Formula 10-82

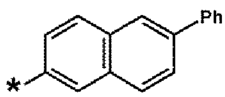
Formula 10-83

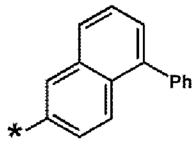
Formula 10-84

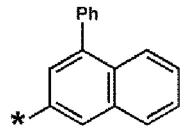
Formula 10-85

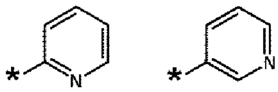
Formula 10-86

Formula 10-87

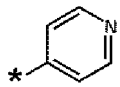
Formula 10-88

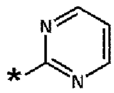
Formula 10-89

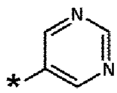
Formula 10-90

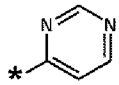
Formula 10-91

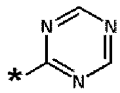
Formula 10-92

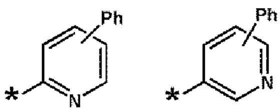
Formula 10-93

Formula 10-94

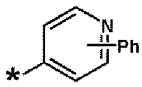
Formula 10-95

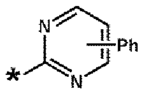
Formula 10-96

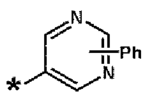
Formula 10-97

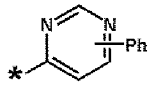
Formula 10-98

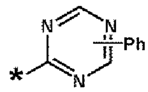
Formula 10-99

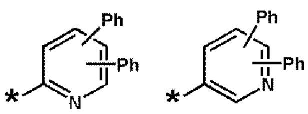
Formula 10-100

Formula 10-101

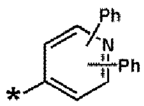
Formula 10-102

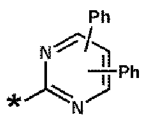
Formula 10-103

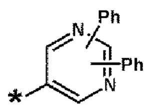
Formula 10-104

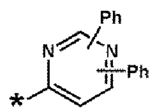
Formula 10-105

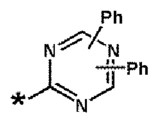
Formula 10-106

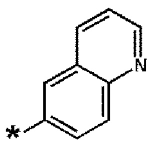
Formula 10-107

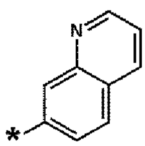
Formula 10-108

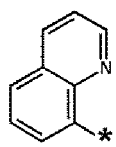
Formula 10-109

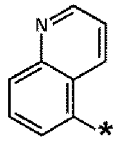
Formula 10-110

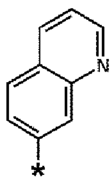
Formula 10-111

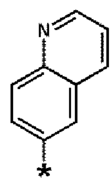
Formula 10-112

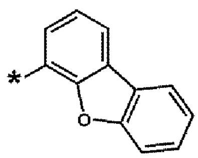
Formula 10-113

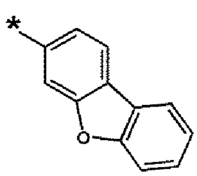
Formula 10-114

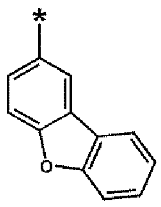
Formula 10-115

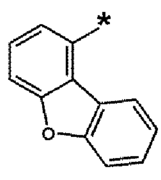
Formula 10-116

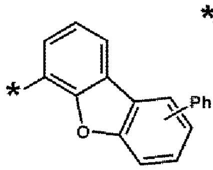
Formula 10-117

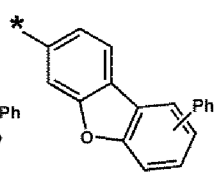
Formula 10-118

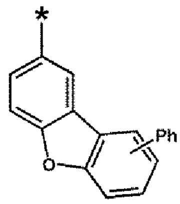
Formula 10-119
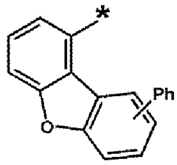
Formula 10-120
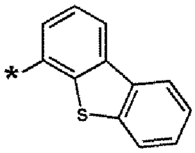
Formula 10-121
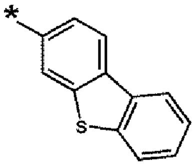
Formula 10-122
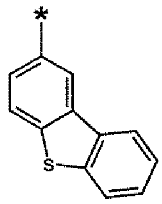
Formula 10-123
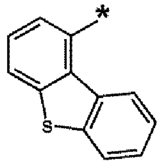
Formula 10-124

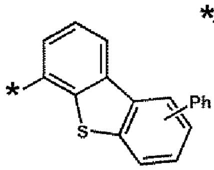
Formula 10-125
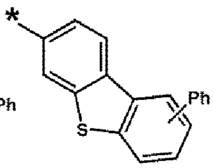
Formula 10-126
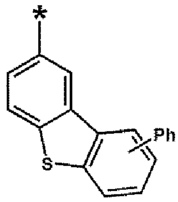
Formula 10-127
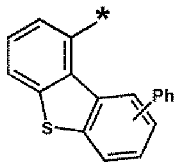
Formula 10-128
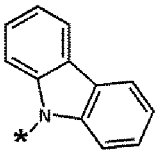
Formula 10-129
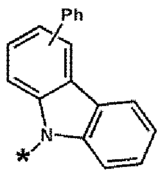
Formula 10-130

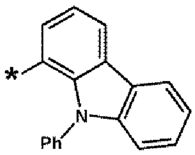
Formula 10-131
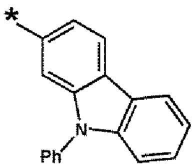
Formula 10-132
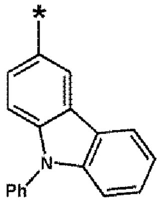
Formula 10-133
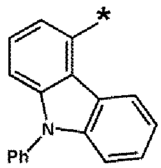
Formula 10-134
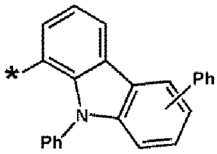
Formula 10-135
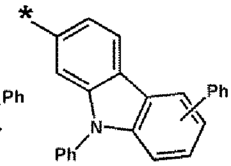
Formula 10-136

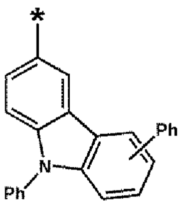
Formula 10-137
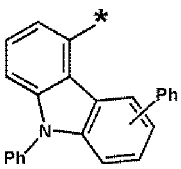
Formula 10-138
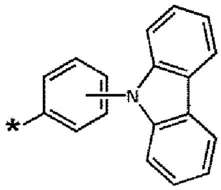
Formula 10-139
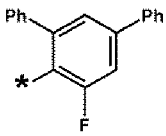
Formula 10-140
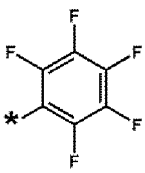
Formula 10-141
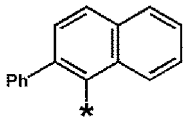
Formula 10-142

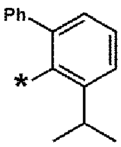
Formula 10-143
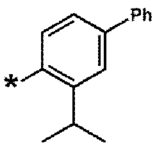
Formula 10-144
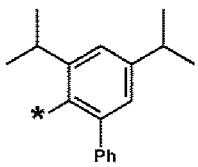
Formula 10-145
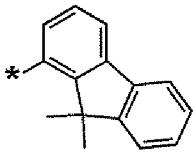
Formula 10-146
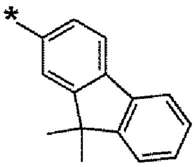
Formula 10-147
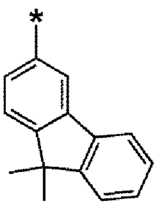
Formula 10-148

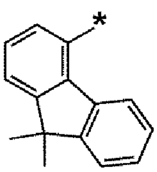
Formula 10-149
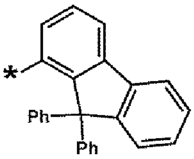
Formula 10-150
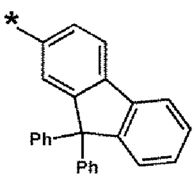
Formula 10-151
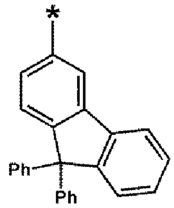
Formula 10-152
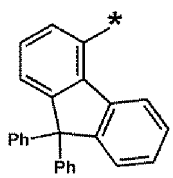
Formula 10-153

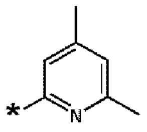
Formula 10-154
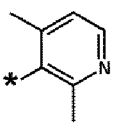
Formula 10-155
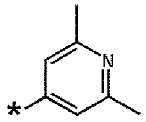
Formula 10-156
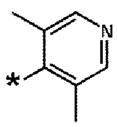
Formula 10-157
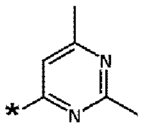
Formula 10-158
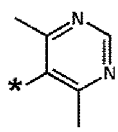
Formula 10-159
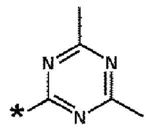
Formula 10-160

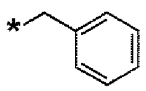
Formula 10-161
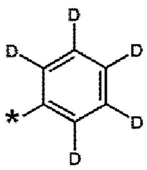
Formula 10-162
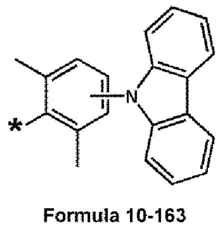
Formula 10-163
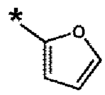
Formula 10-164
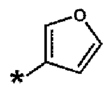
Formula 10-165
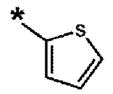
Formula 10-166
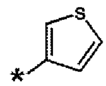
Formula 10-167,

$Q_1$ to $Q_9$ are each independently selected from:

-$CH_3$, -$CD_3$, -$CD_2H$, -$CDH_2$, -$CH_2CH_3$, -$CH_2CD_3$, -$CH_2CD_2H$, -$CH_2CDH_2$, -$CHDCH_3$, -$CHDCD_2H$, -$CHDCDH_2$, -$CHDCD_3$, -$CD_2CD_3$, -$CD_2CD_2H$, and -$CD_2CDH_2$;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group, and

in Formulae 9-1 to 9-19 and 10-1 to 10-167,
* indicates a binding site to a neighboring atom;
Ph indicates a phenyl group; and
TMS indicates a trimethylsilyl group.

**3.** The organometallic compound of claims 1 or 2, wherein

i) the two bonds from $X_{51}$ indicated by a dotted line are each a single bond, and $X_{51}$ is $C(R_7)(R_8)$, $Si(R_7)(R_8)$, or C(=O),
ii) the two bonds from $X_{51}$ indicated by a dotted line are each a single bond, $X_{51}$ is N-$[(L_7)_{b7}$-$(R_7)_{c7}]$, and $R_7$ is selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_2$-$C_{60}$ heteroaryloxy group, a substituted or unsubstituted $C_2$-$C_{60}$ heteroarylthio group, a substituted or unsubstituted $C_3$-$C_{60}$ heteroarylalkyl group, a substituted or unsubstituted monovalent non-aromatic condensed polycyclic group, and a substituted or unsubstituted monovalent non-aromatic condensed heteropolycyclic group, or
iii) of the two bonds from $X_{51}$ indicated by a dotted line, one is a single bond while the other bond thereof is a double bond, and $X_{51}$ is N, $C(R_7)$, or $Si(R_7)$.

**4.** The organometallic compound of any of claims 1-3, wherein $X_{51}$ is O, S, or N-$[(L_7)_{b7}$-$(R_7)_{c7}]$,
b7 is 0,
c7 is 1,
$R_7$ is selected from:

a $C_1$-$C_{30}$ alkyl group; and
a $C_1$-$C_{30}$ alkyl group substituted with at least one selected from deuterium, -F, -Cl, - Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a

hydrazone group, a carboxylic acid group or a salt thereof, a sulfonic acid group or a salt thereof, a phosphoric acid group or a salt thereof, $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group.

**5.** The organometallic compound of any of claims 1-4, wherein the organometallic compound is one selected from Compounds 1-1 to 1-88, Compounds 2-1 to 2-47, and Compounds 3-1 to 3-582:

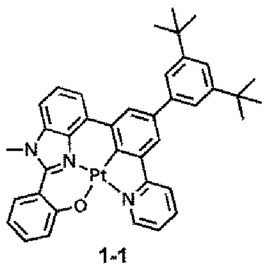
1-1

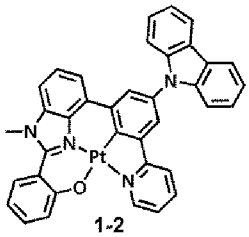
1-2

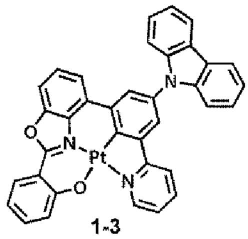
1-3

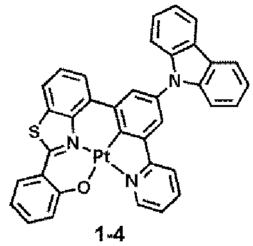
1-4

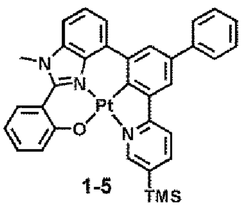
1-5

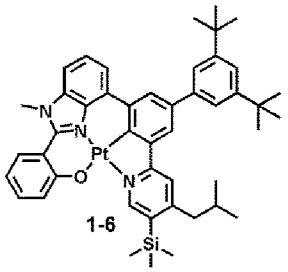
1-6

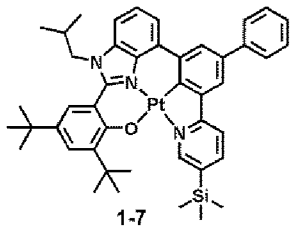
1-7

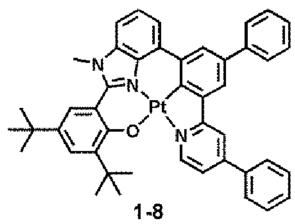
1-8

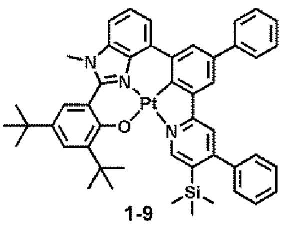
1-9

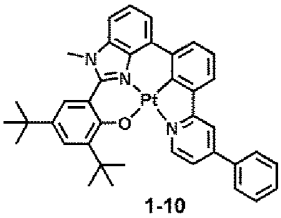
1-10

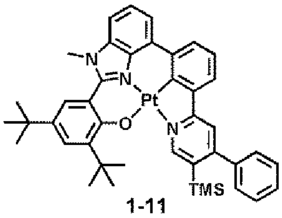
1-11

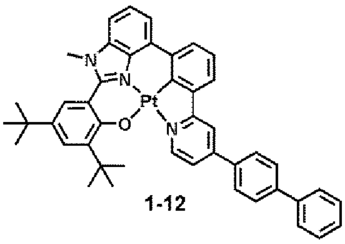
1-12

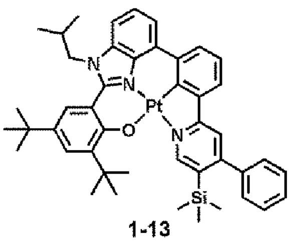
1-13

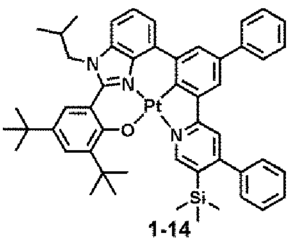
1-14

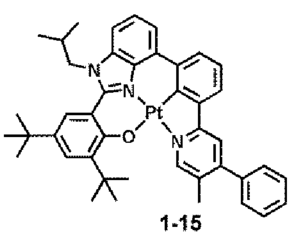
1-15

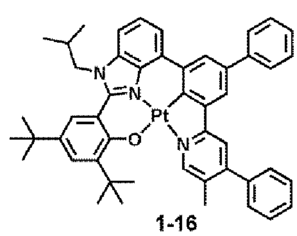
1-16

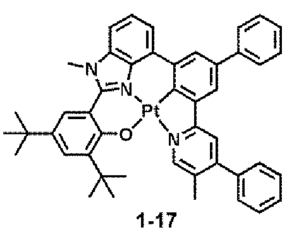
1-17

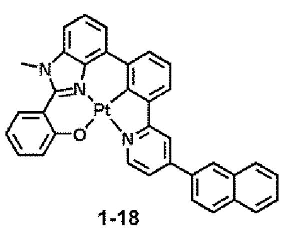
1-18

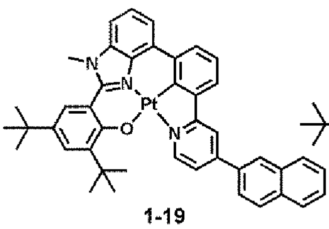
1-19

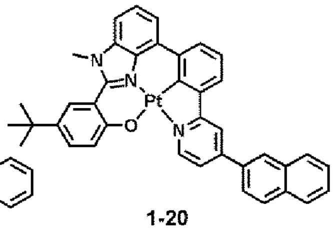
1-20

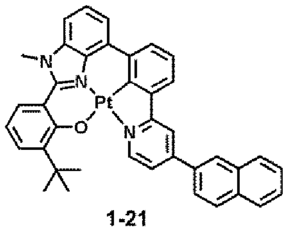

1-21

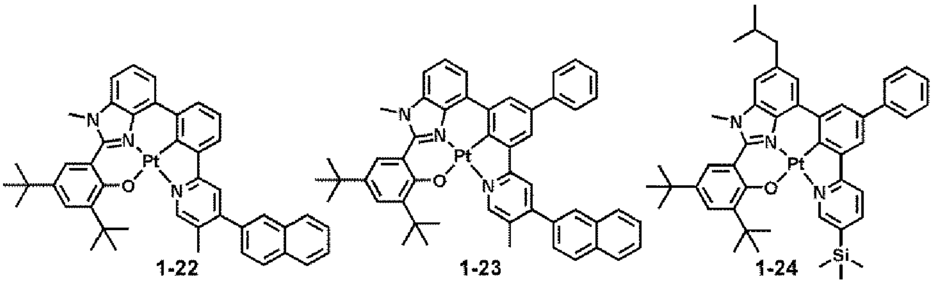

1-22 1-23 1-24

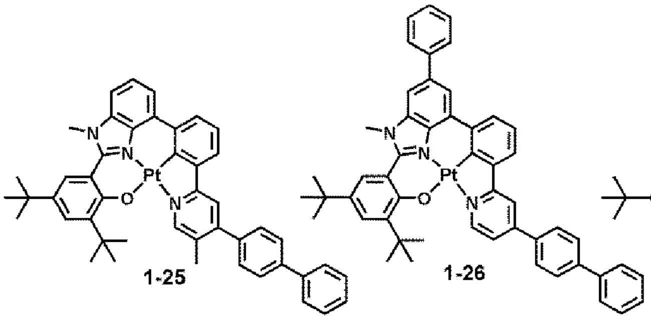

1-25 1-26 1-27

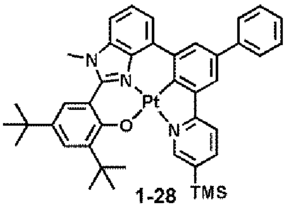

1-28

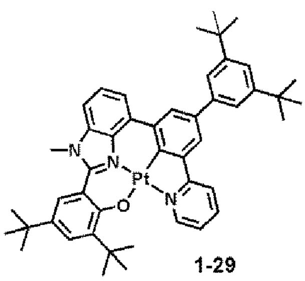

1-29

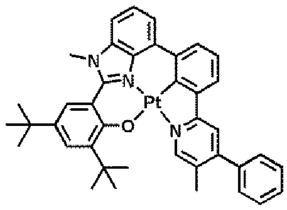

1-30

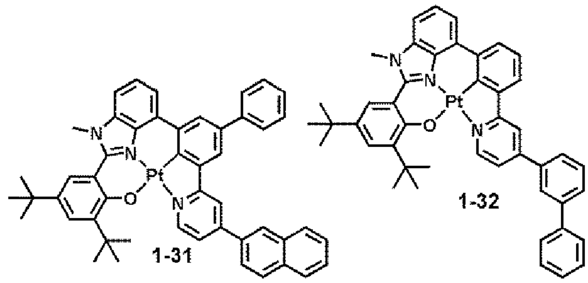

1-31 1-32

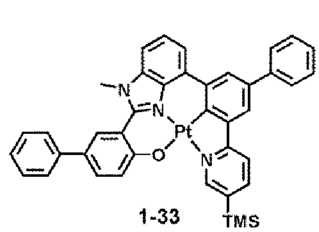

1-33

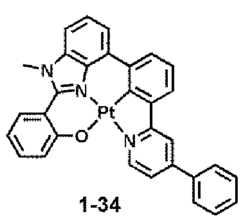

1-34

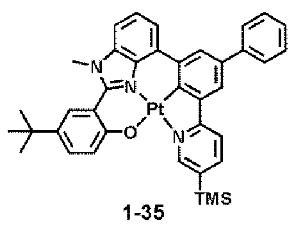

1-35

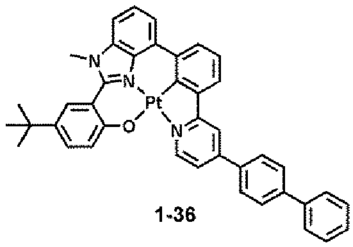

1-36

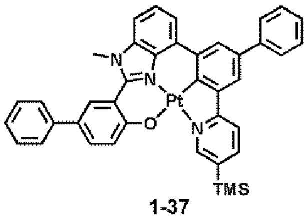

1-37

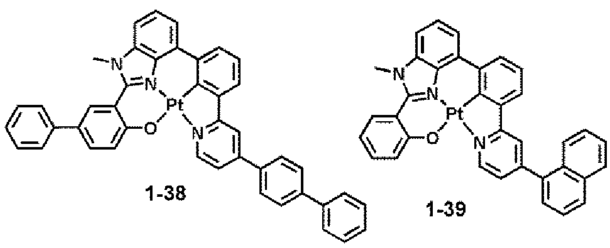

1-38 1-39

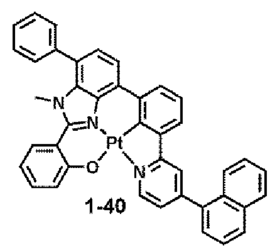

1-40

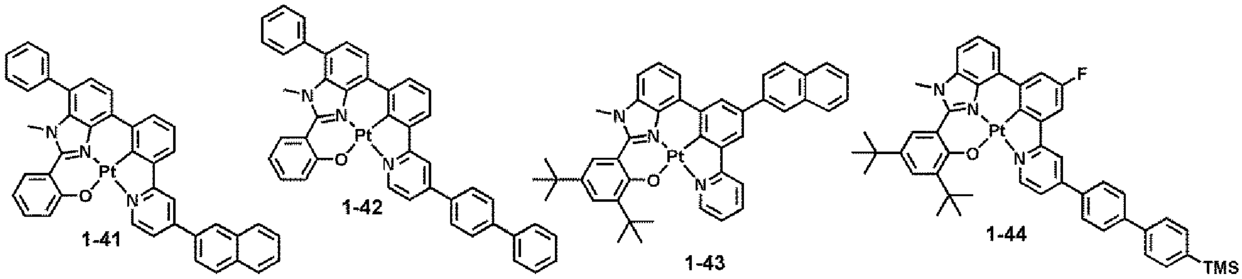

1-41 1-42 1-43 1-44

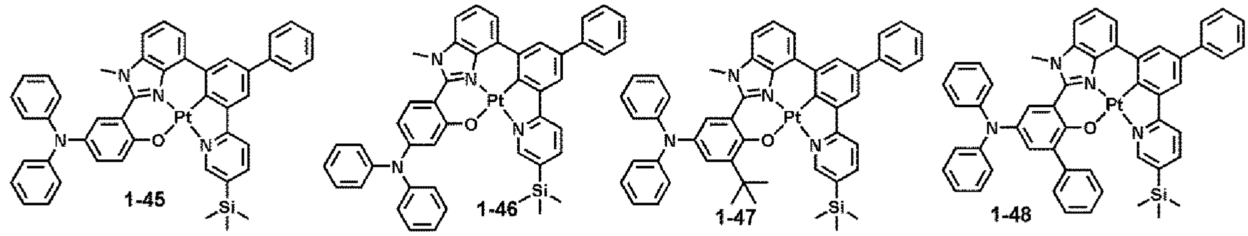

1-45 1-46 1-47 1-48

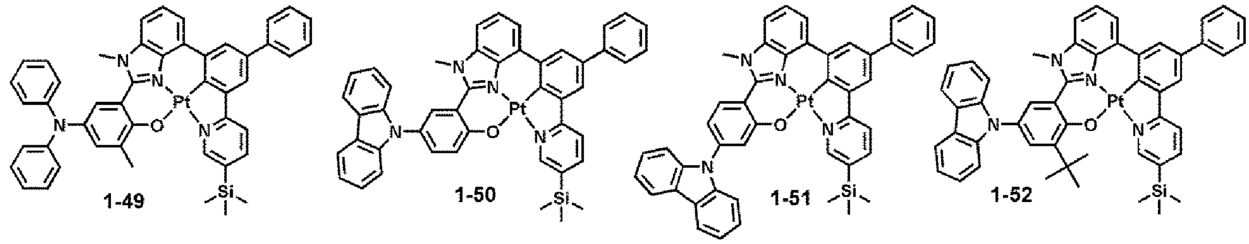

1-49 1-50 1-51 1-52

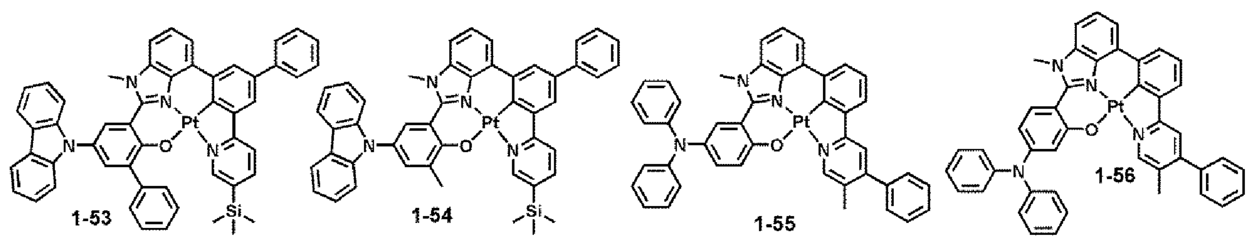

1-53 1-54 1-55 1-56

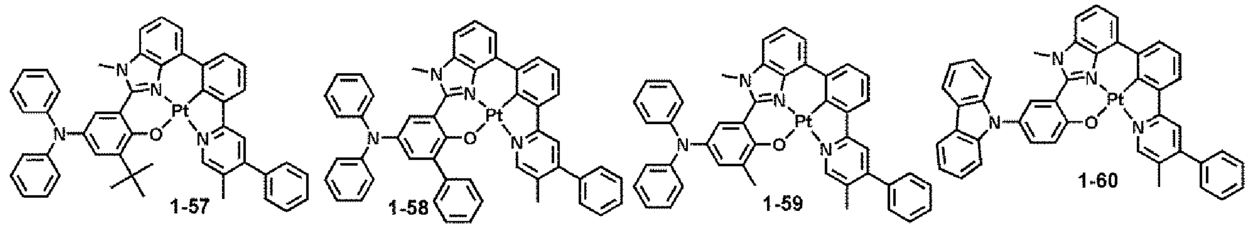

1-57 1-58 1-59 1-60

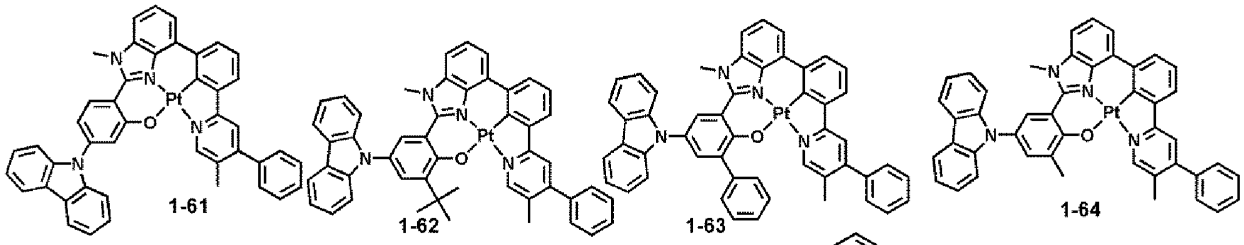

1-61 1-62 1-63 1-64

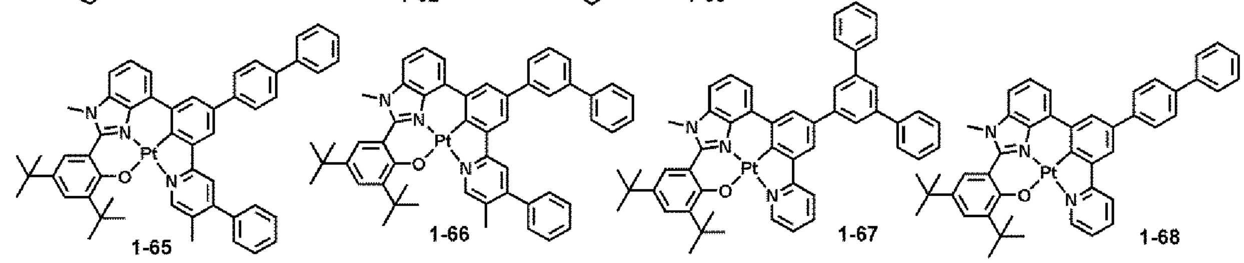

1-65 1-66 1-67 1-68

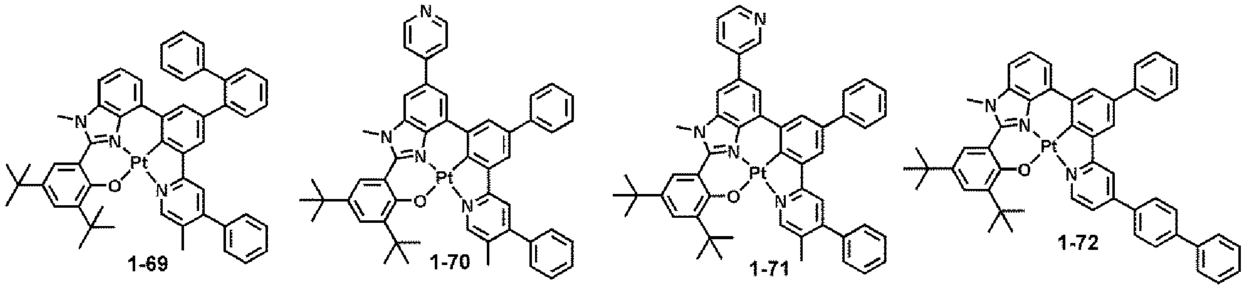

1-69 1-70 1-71 1-72

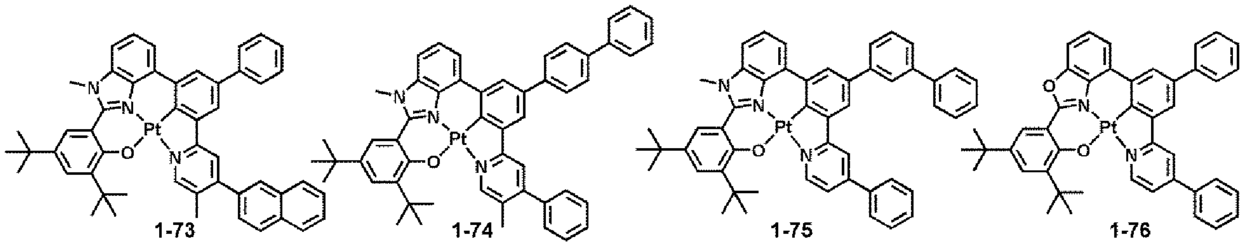

1-73 1-74 1-75 1-76

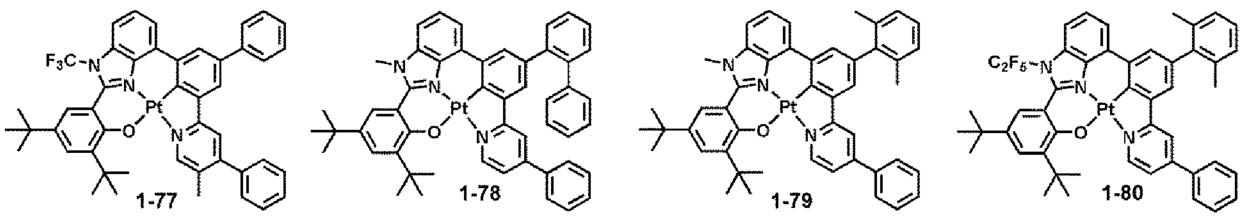

1-77 1-78 1-79 1-80

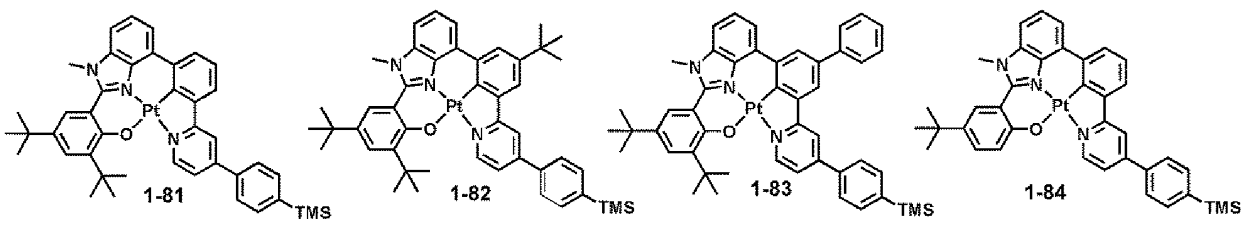

1-81 1-82 1-83 1-84

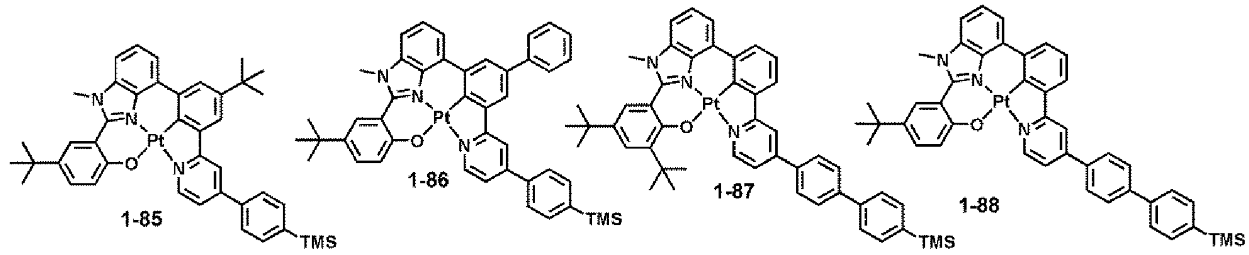

1-85 1-86 1-87 1-88

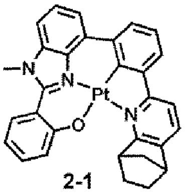

2-1

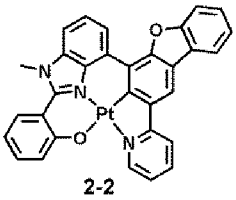

2-2

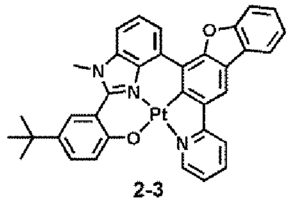

2-3

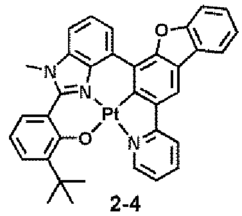

2-4

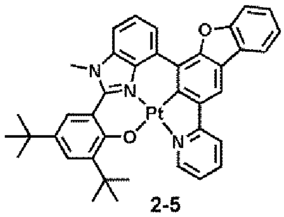

2-5

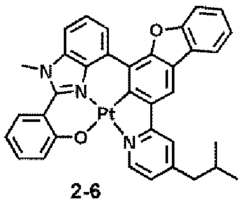

2-6

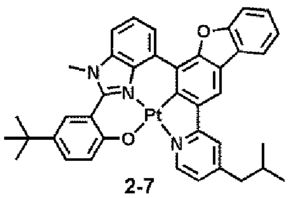

2-7

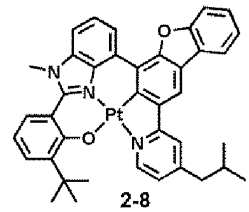

2-8

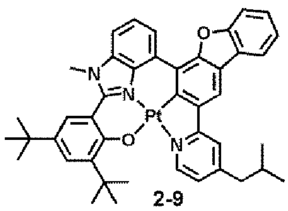

2-9

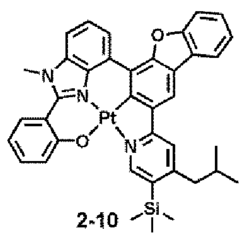

2-10

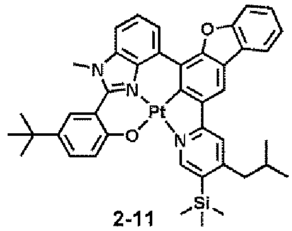

2-11

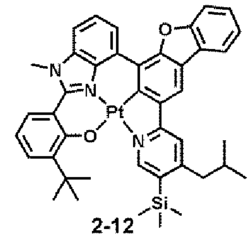

2-12

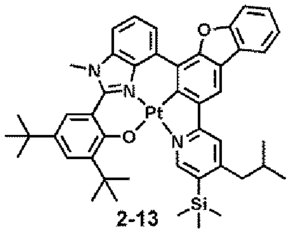

2-13

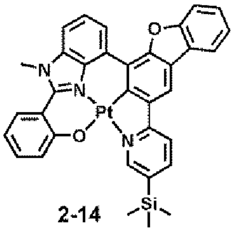

2-14

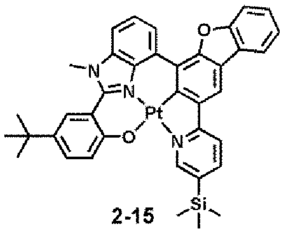

2-15

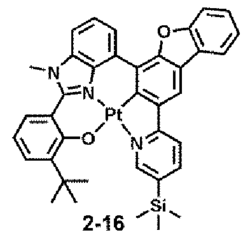

2-16

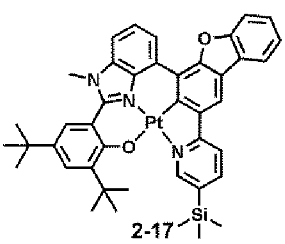

2-17

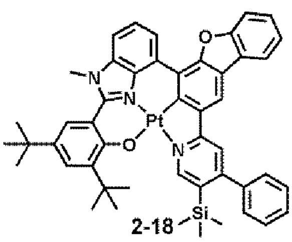

2-18

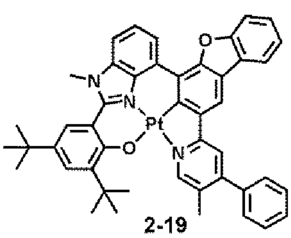

2-19

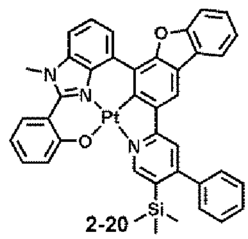

2-20

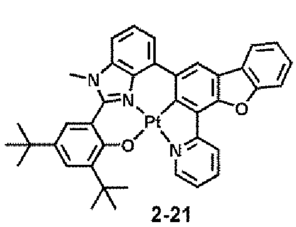
2-21

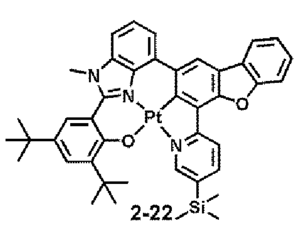
2-22

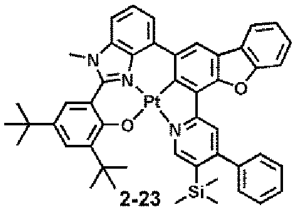
2-23

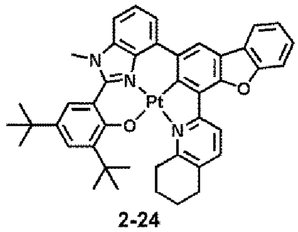
2-24

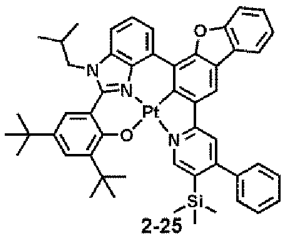
2-25

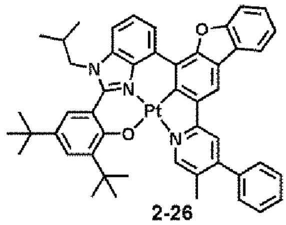
2-26

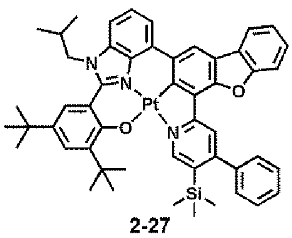
2-27

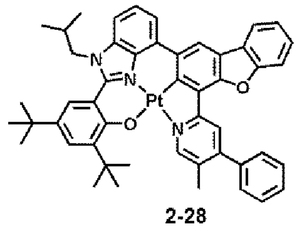
2-28

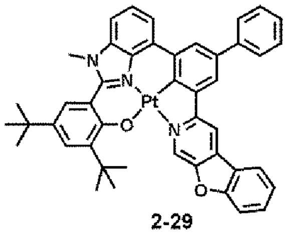
2-29

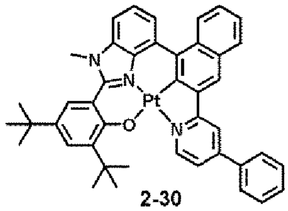
2-30

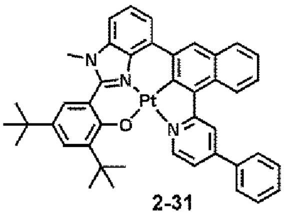
2-31

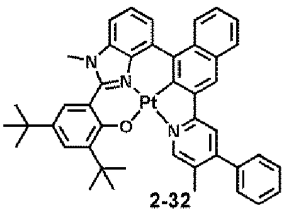
2-32

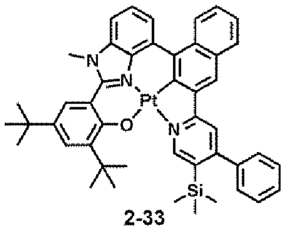
2-33

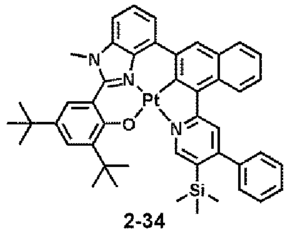
2-34

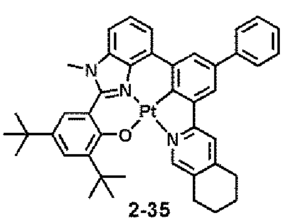
2-35

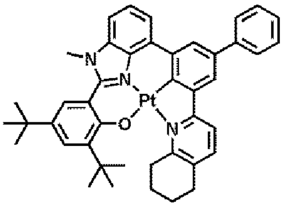
2-36

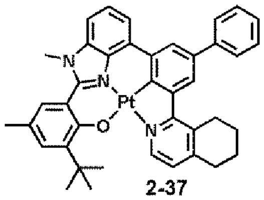
2-37

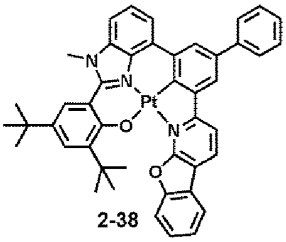
2-38

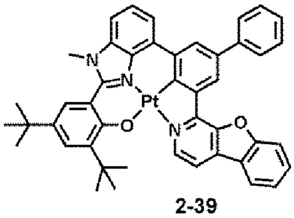
2-39

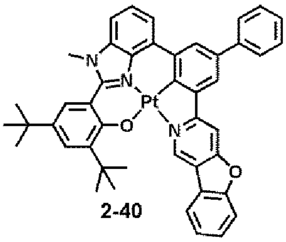
2-40

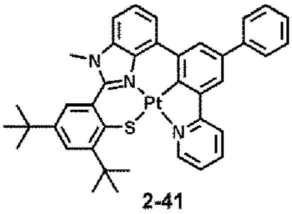
2-41

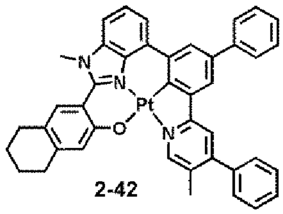
2-42

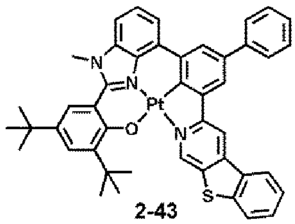
2-43

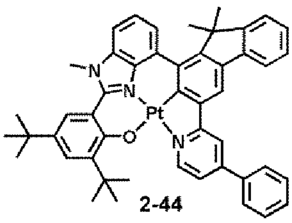
2-44

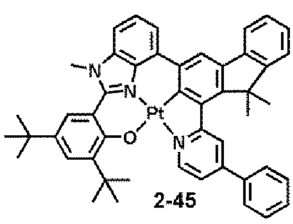
2-45

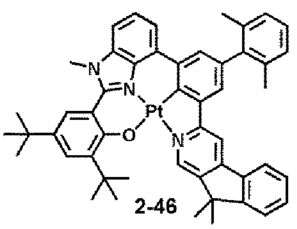
2-46

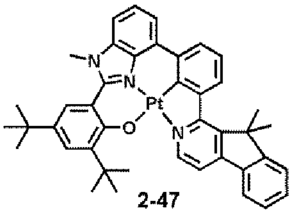
2-47

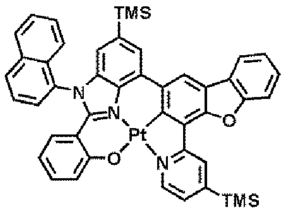
3-1

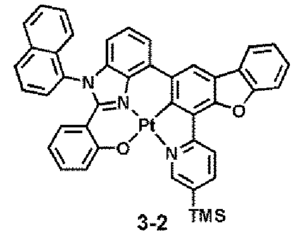
3-2

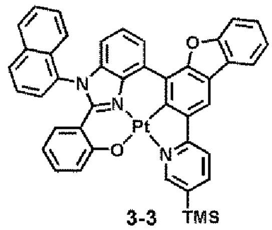
3-3

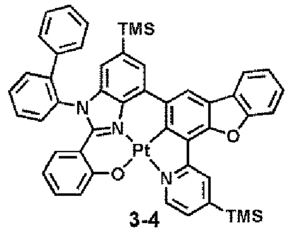
3-4

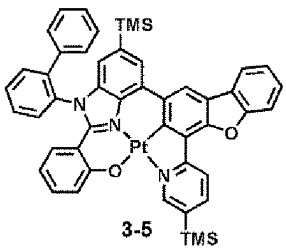
3-5

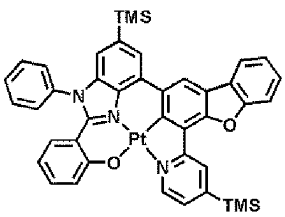
3-6

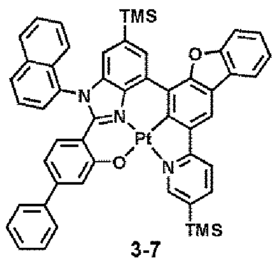
3-7

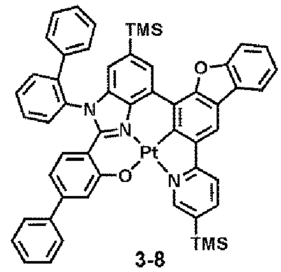
3-8

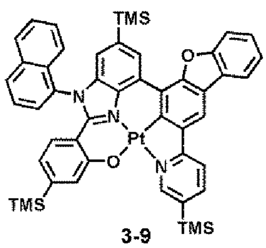
3-9

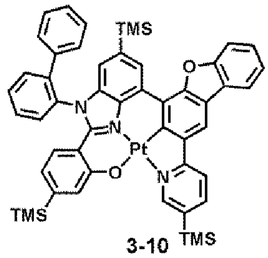
3-10

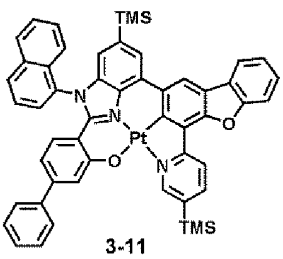
3-11

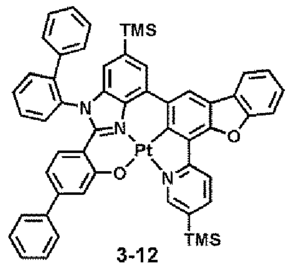
3-12

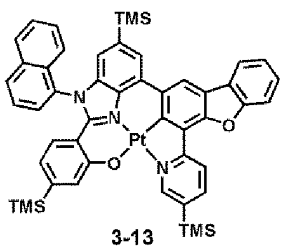
3-13

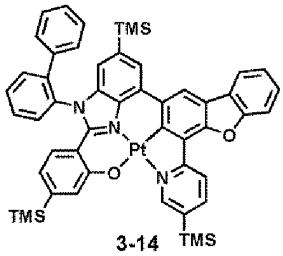
3-14

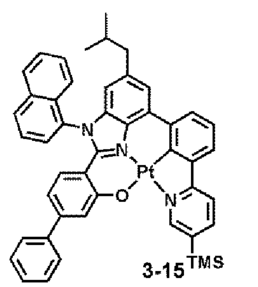
3-15

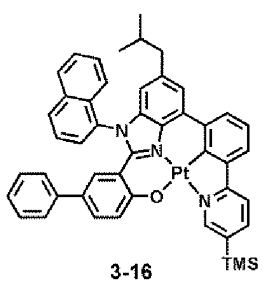
3-16

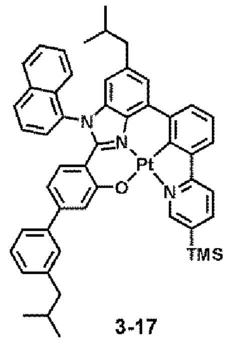
3-17

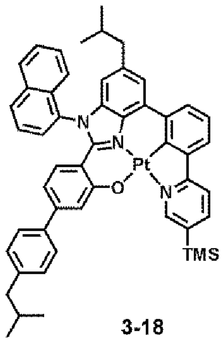
3-18

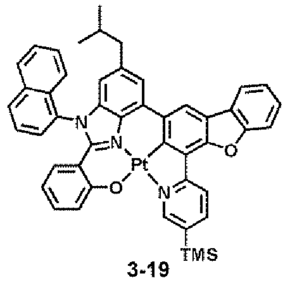
3-19

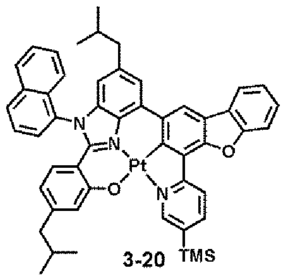
3-20

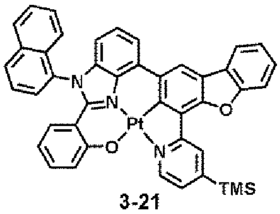
3-21

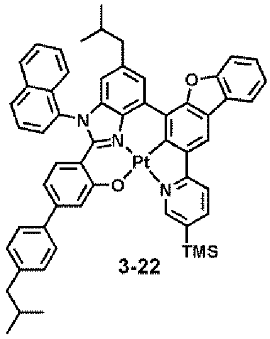
3-22

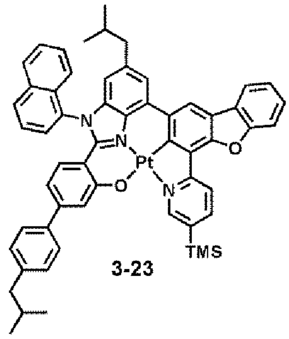
3-23

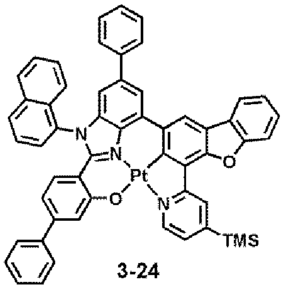
3-24

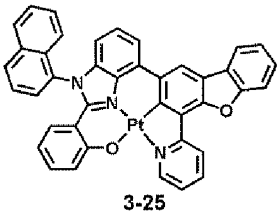
3-25

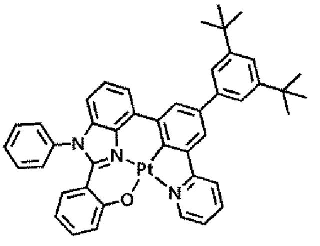
3-26

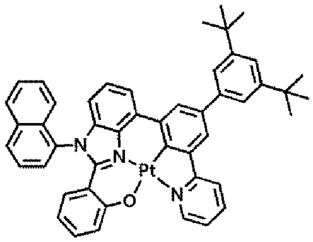
3-27

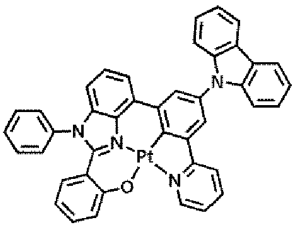
3-28

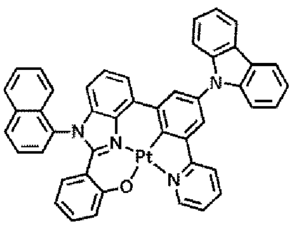
3-29

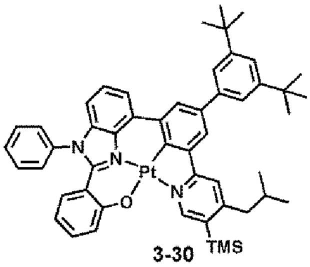
3-30

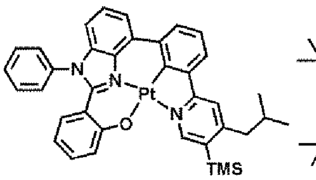
3-31

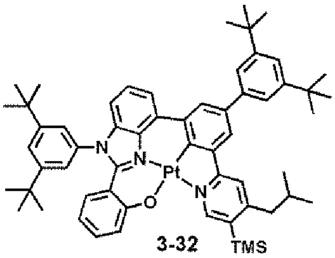
3-32

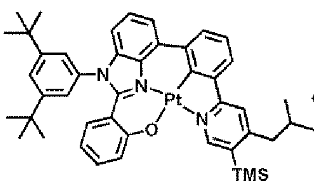
3-33

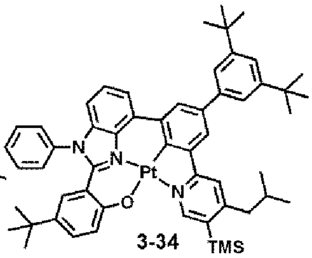
3-34

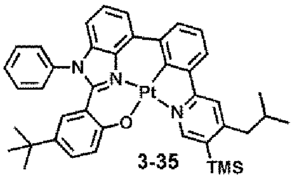
3-35

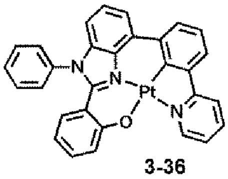
3-36

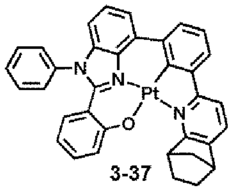
3-37

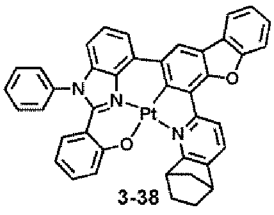
3-38

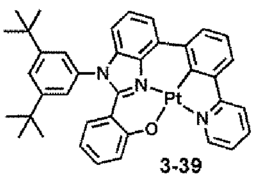
3-39

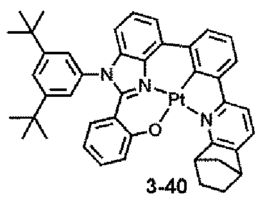
3-40

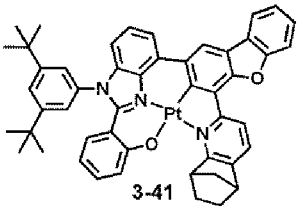
3-41

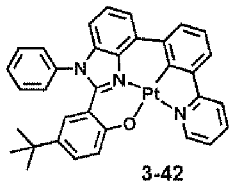
3-42

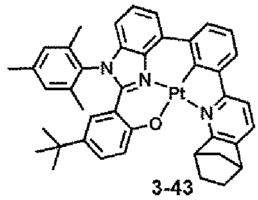
3-43

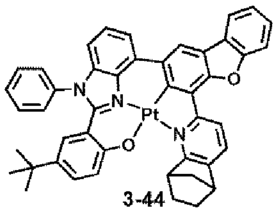
3-44

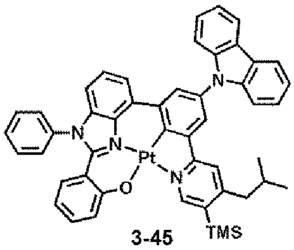
3-45

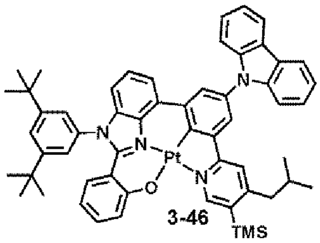
3-46

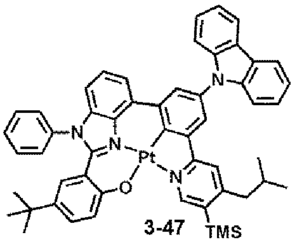
3-47

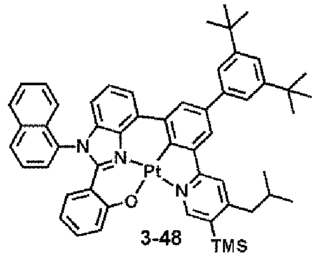
3-48

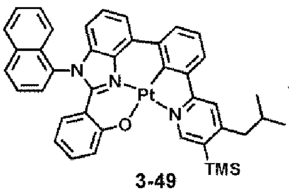
3-49

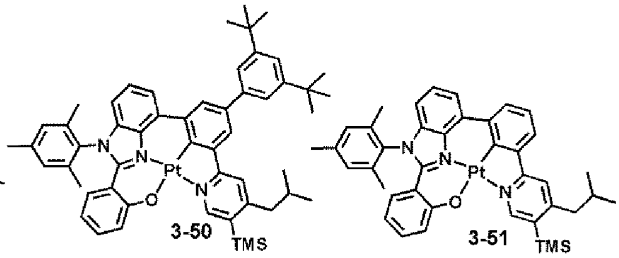
3-50

3-51

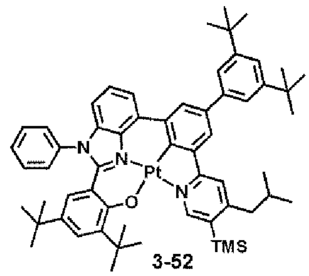
3-52

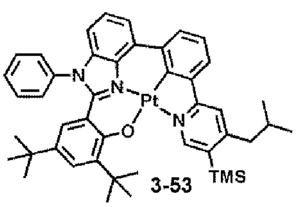
3-53

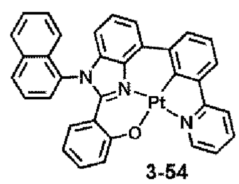
3-54

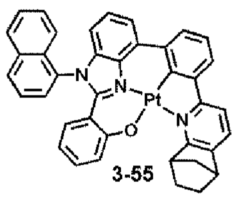
3-55

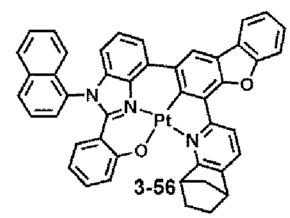
3-56

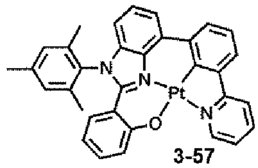
3-57

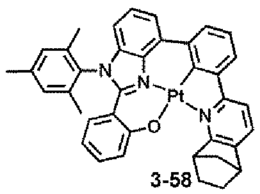
3-58

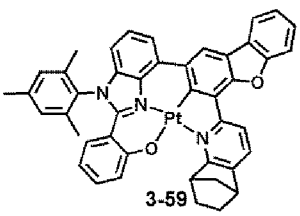
3-59

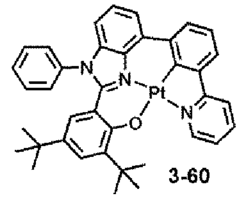
3-60

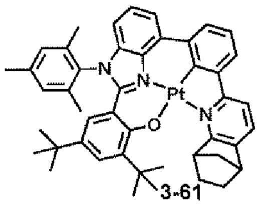
3-61
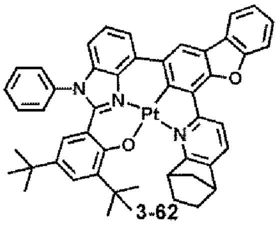
3-62
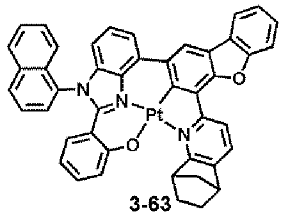
3-63
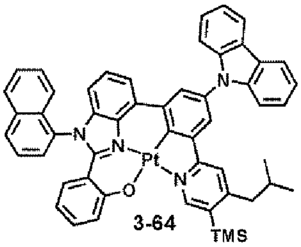
3-64
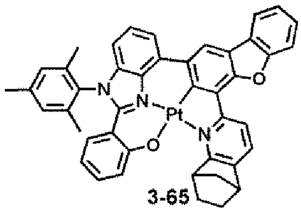
3-65
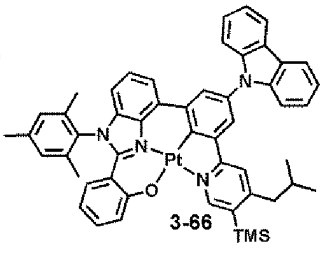
3-66
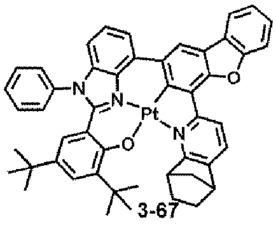
3-67
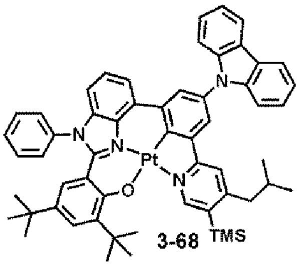
3-68
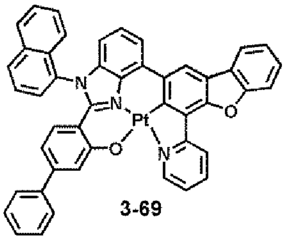
3-69
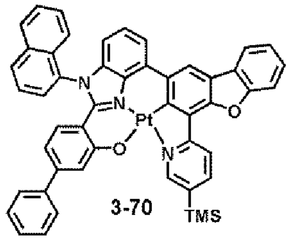
3-70
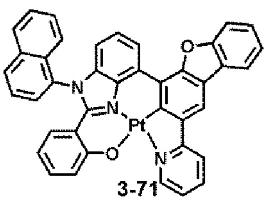
3-71
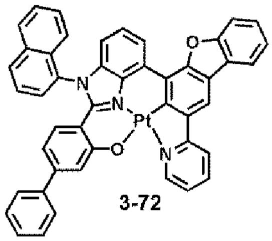
3-72
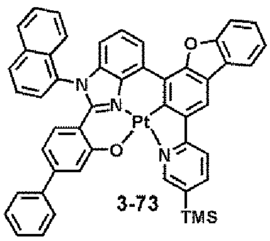
3-73
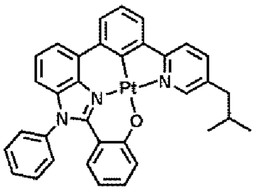
3-74
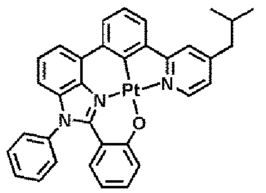
3-75
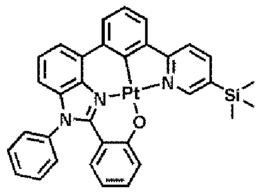
3-76
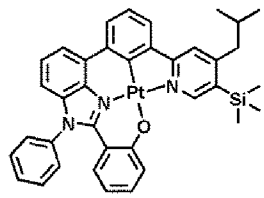
3-77
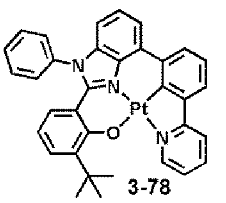
3-78
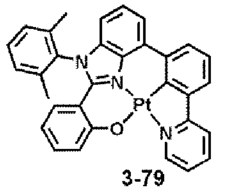
3-79
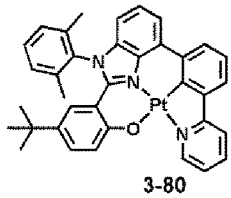
3-80
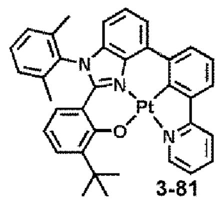
3-81
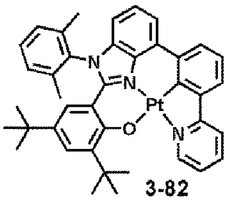
3-82
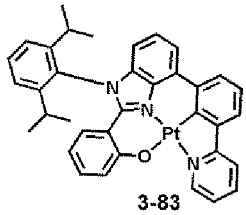
3-83
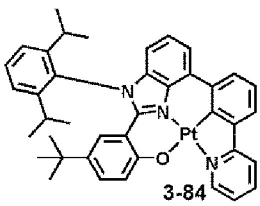
3-84

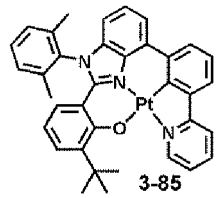
3-85
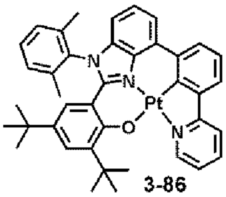
3-86
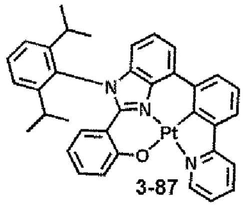
3-87
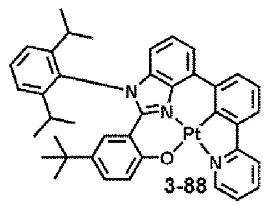
3-88
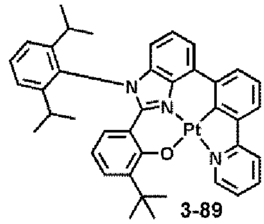
3-89
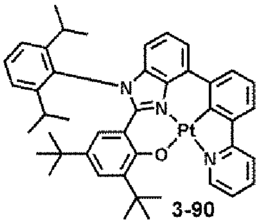
3-90
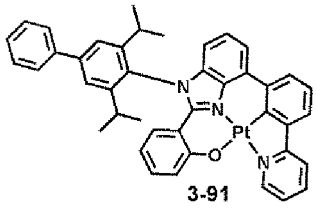
3-91
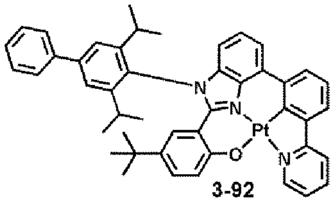
3-92
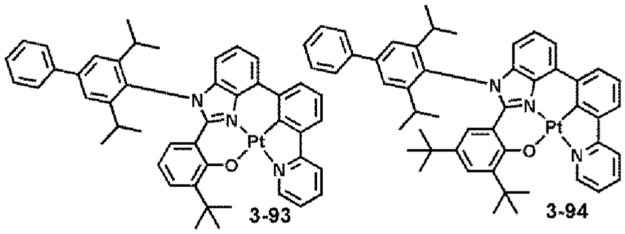
3-93
3-94
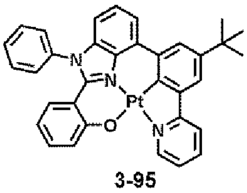
3-95
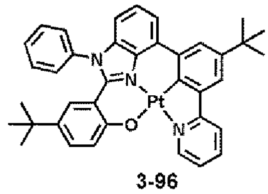
3-96
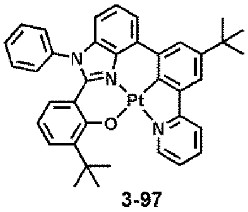
3-97
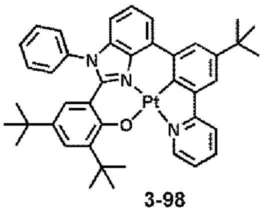
3-98
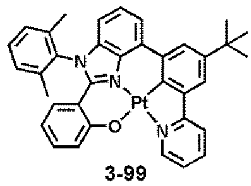
3-99
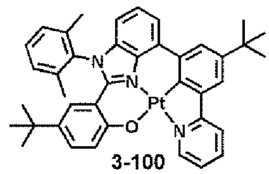
3-100
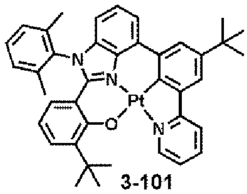
3-101
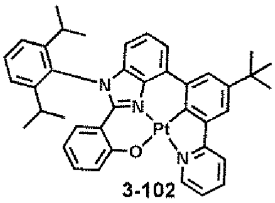
3-102
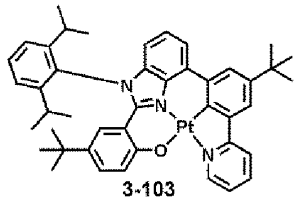
3-103
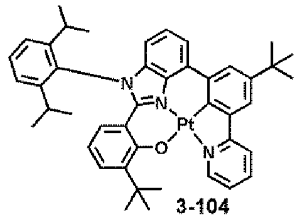
3-104
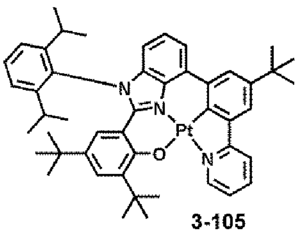
3-105
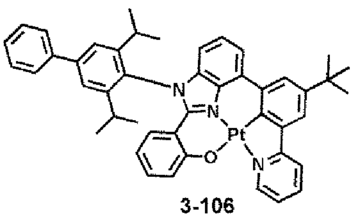
3-106

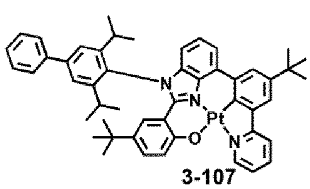
3-107

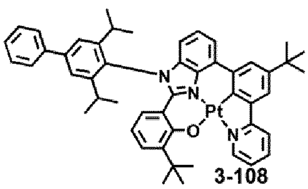
3-108

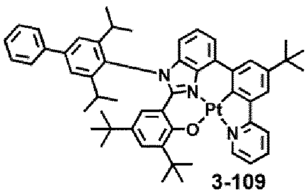
3-109

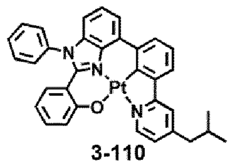
3-110

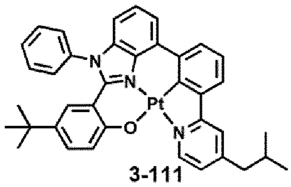
3-111

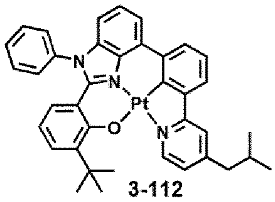
3-112

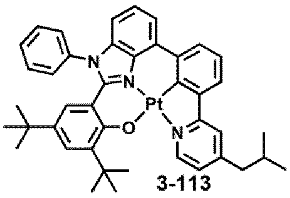
3-113

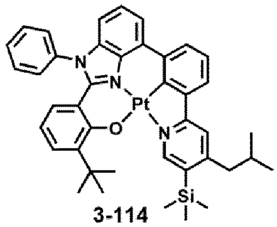
3-114

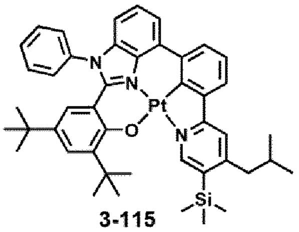
3-115

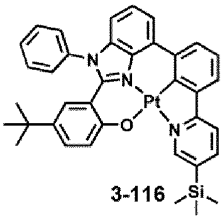
3-116

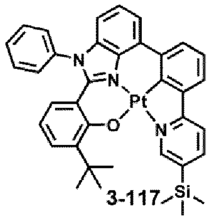
3-117

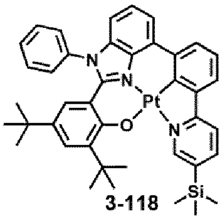
3-118

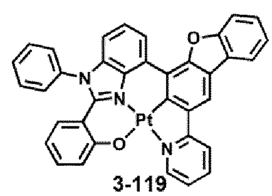
3-119

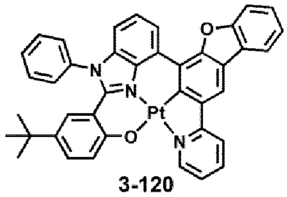
3-120

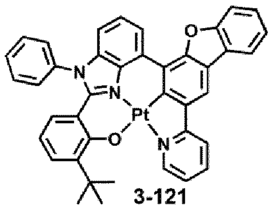
3-121

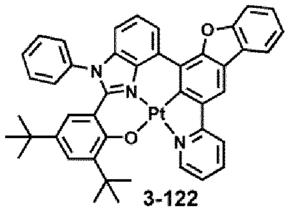
3-122

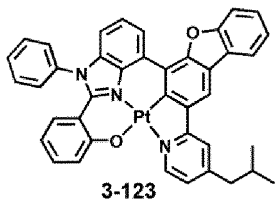
3-123

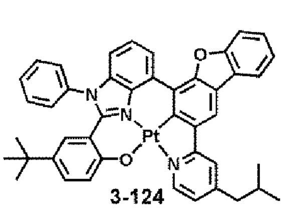
3-124

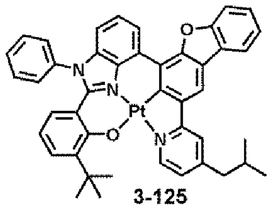
3-125

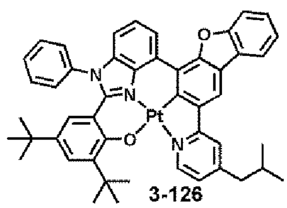
3-126

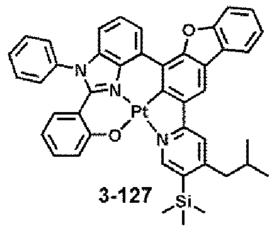
3-127

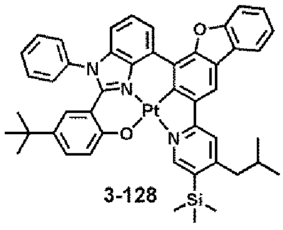
3-128

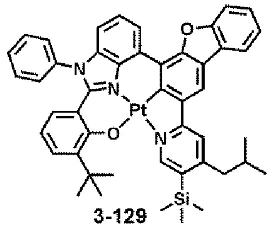
3-129

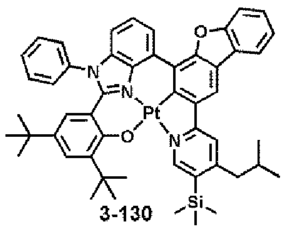
3-130

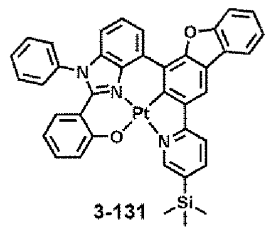
3-131

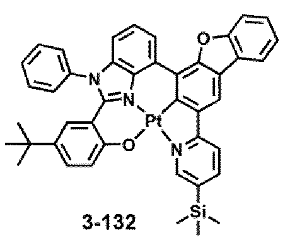
3-132

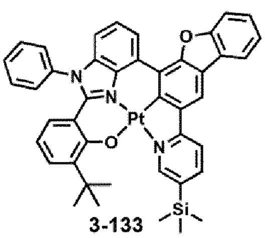
3-133

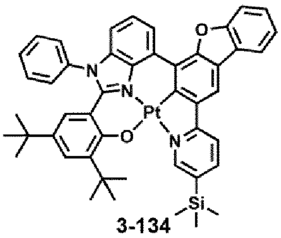
3-134

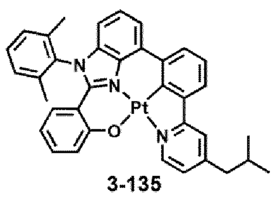
3-135

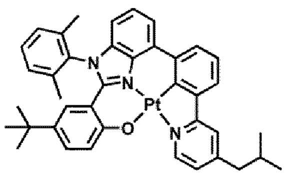
3-136

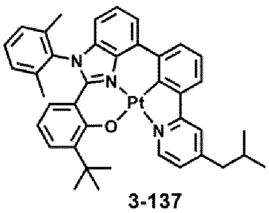
3-137

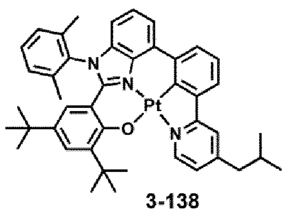
3-138

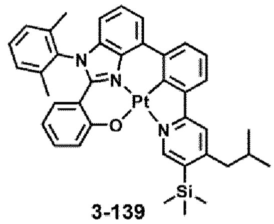
3-139

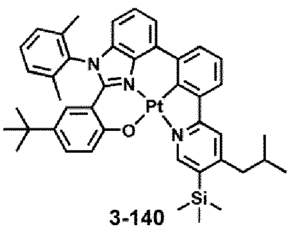
3-140

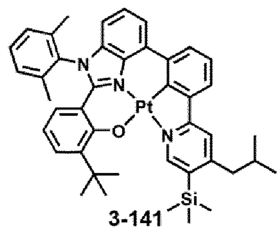
3-141

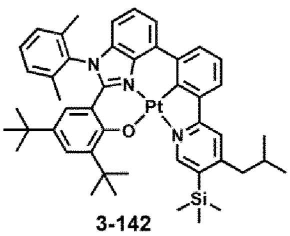
3-142

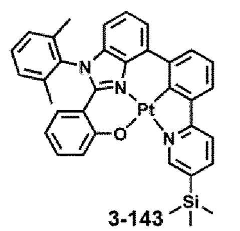
3-143

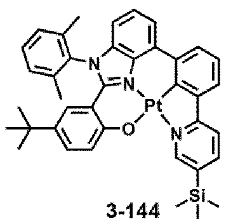
3-144

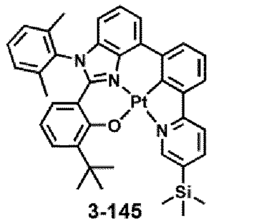
3-145

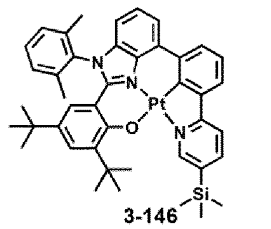
3-146

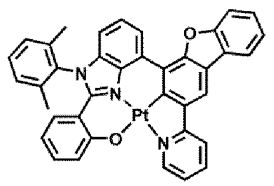
3-147

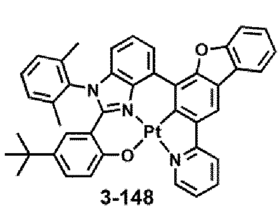
3-148

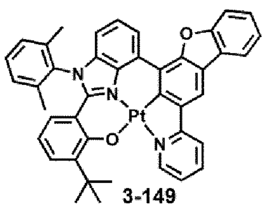
3-149

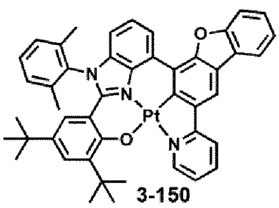
3-150

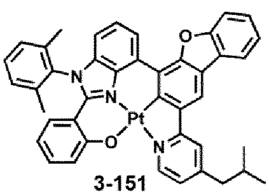
3-151

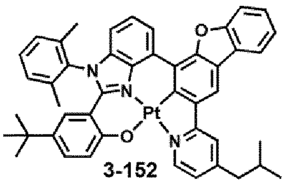
3-152

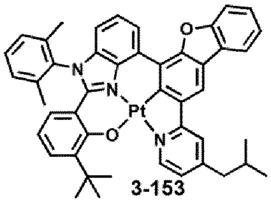
3-153

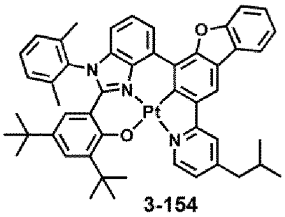
3-154

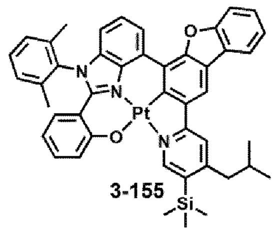
3-155

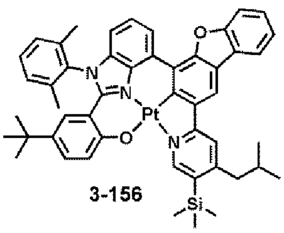
3-156

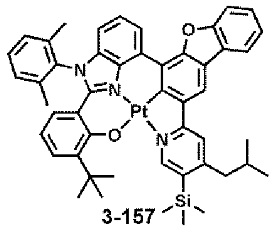
3-157

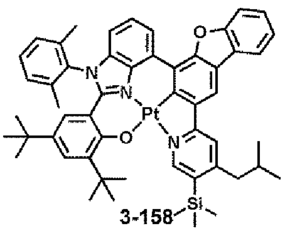
3-158

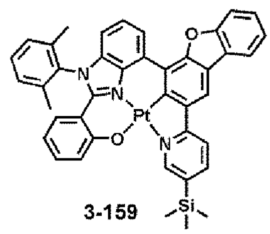
3-159

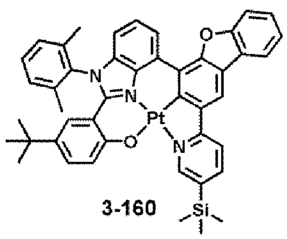
3-160

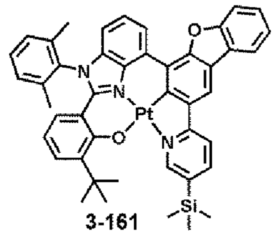
3-161

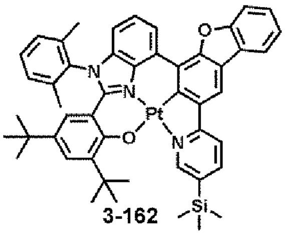
3-162

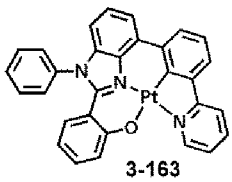
3-163

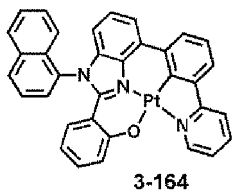
3-164

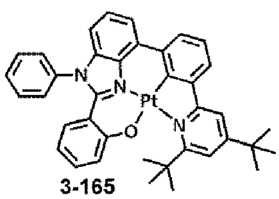
3-165

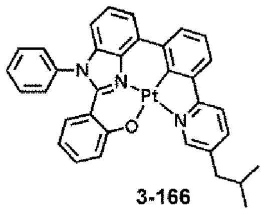
3-166

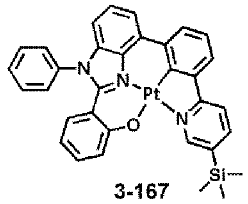
3-167

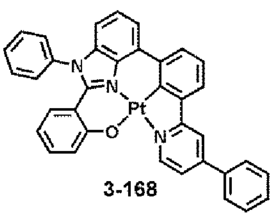
3-168

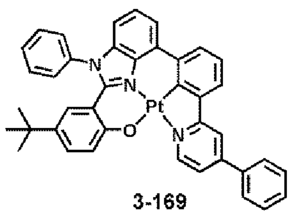
3-169

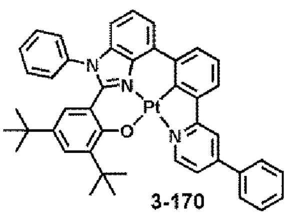
3-170

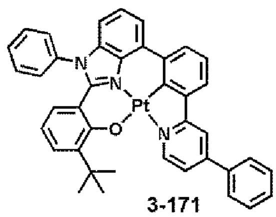
3-171

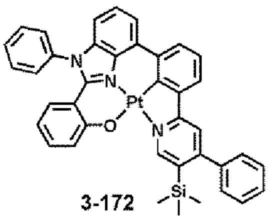
3-172

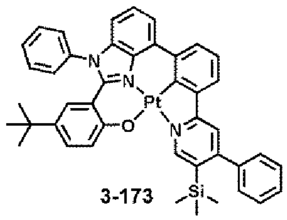
3-173

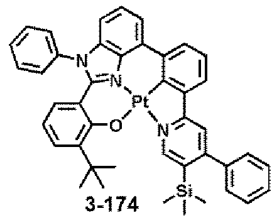
3-174

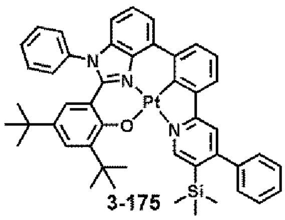
3-175

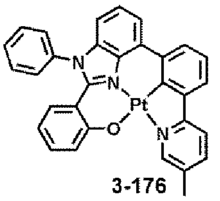
3-176

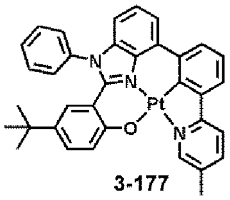
3-177

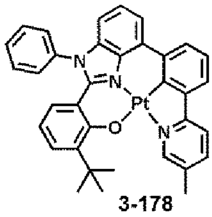
3-178

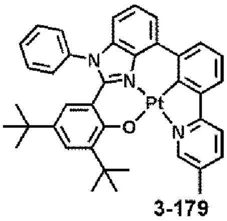
3-179

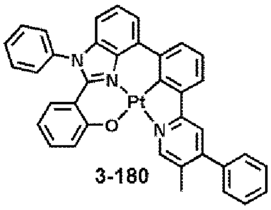
3-180

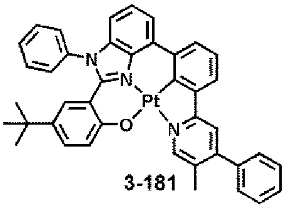
3-181

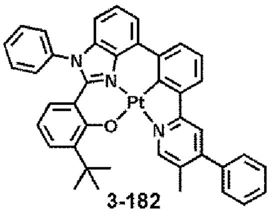
3-182

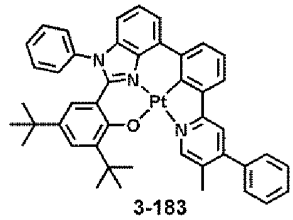
3-183

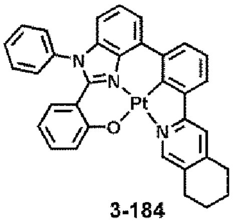
3-184

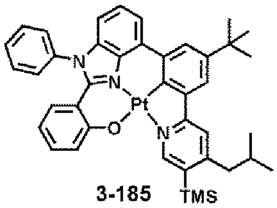
3-185

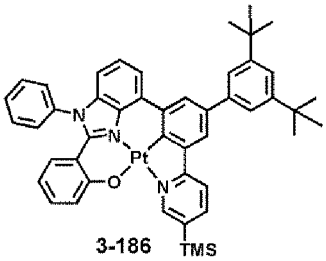
3-186

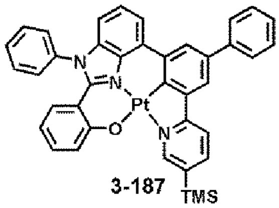
3-187

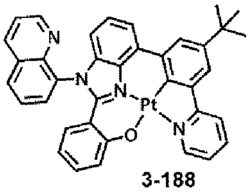
3-188

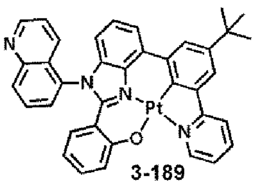
3-189

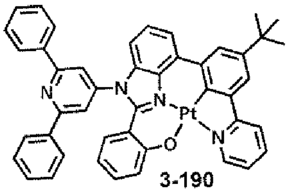
3-190

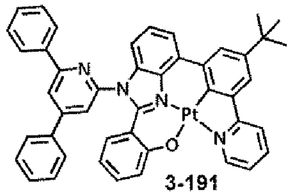
3-191

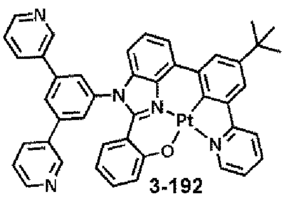
3-192

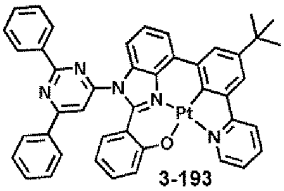
3-193

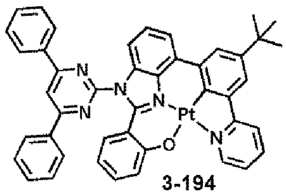
3-194

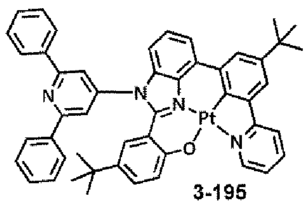
3-195

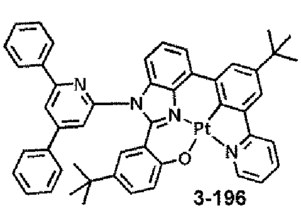
3-196

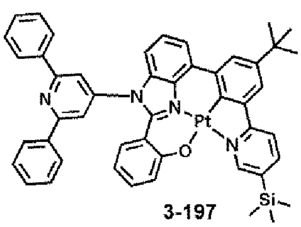
3-197

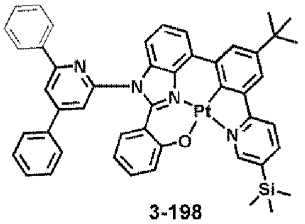
3-198

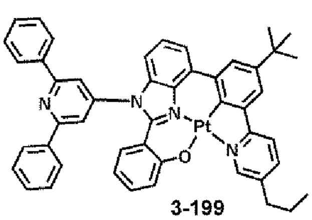
3-199

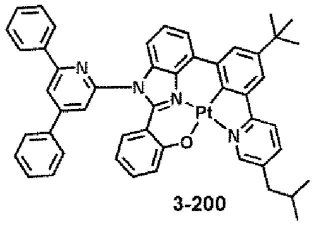
3-200

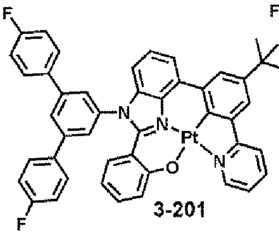
3-201

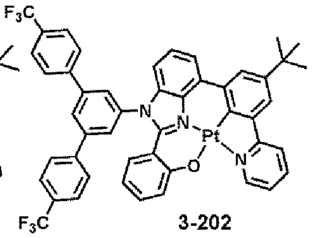
3-202

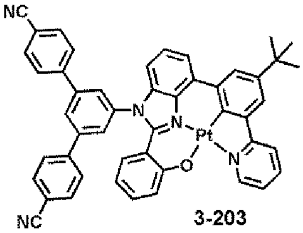
3-203

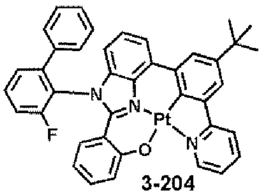
3-204

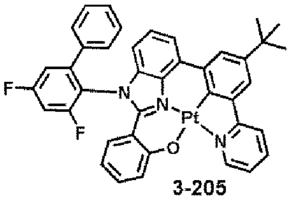
3-205

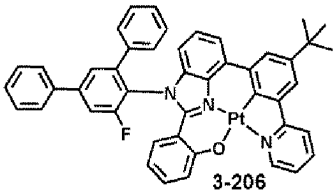
3-206

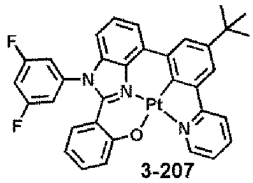
3-207

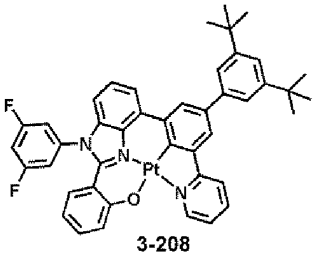
3-208

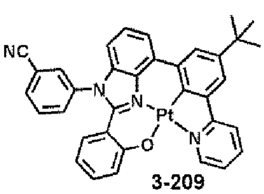
3-209

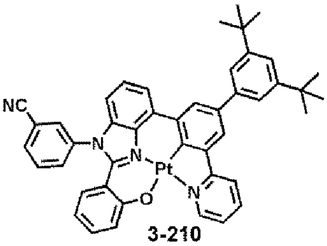
3-210

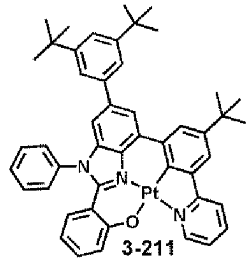
3-211

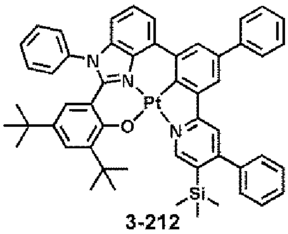
3-212

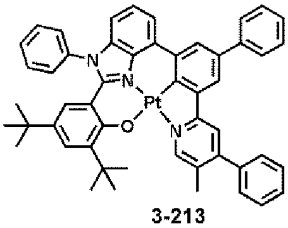
3-213

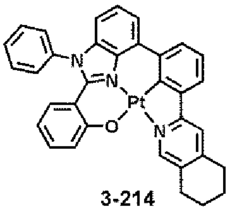
3-214

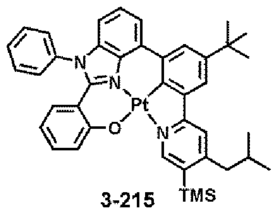
3-215

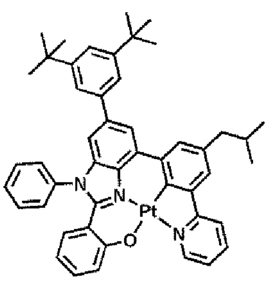
3-216

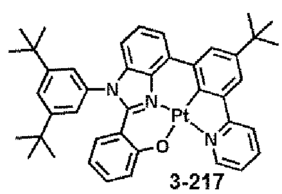
3-217

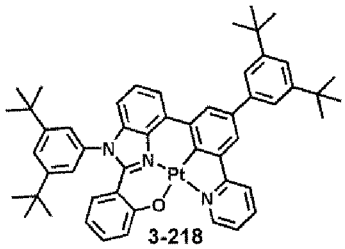
3-218

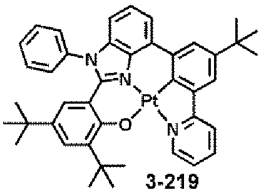
3-219

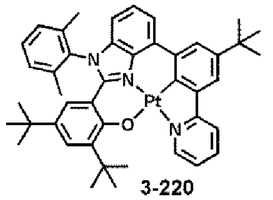
3-220

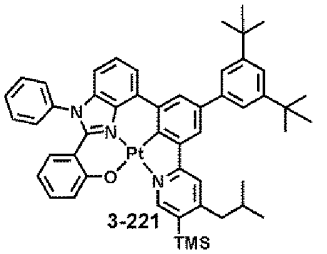
3-221

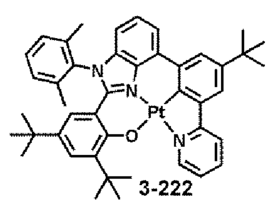
3-222

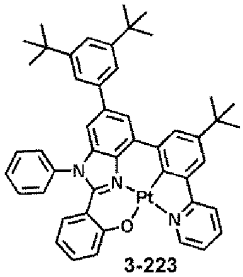
3-223

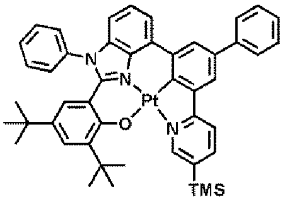
3-224

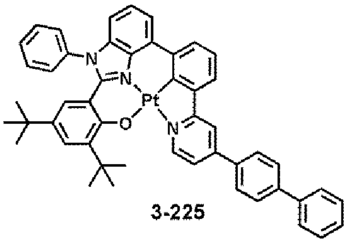
3-225

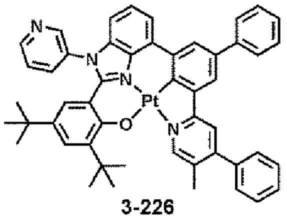
3-226

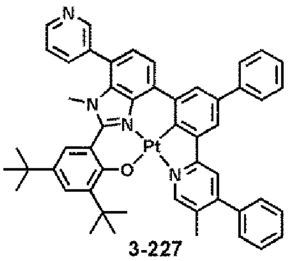
3-227

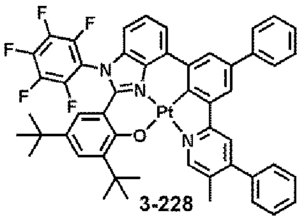
3-228

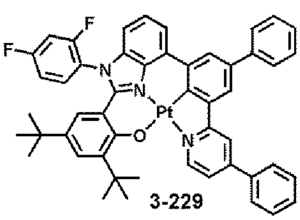
3-229

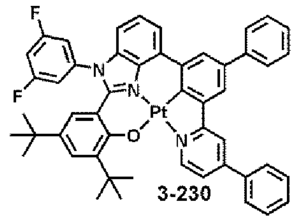
3-230

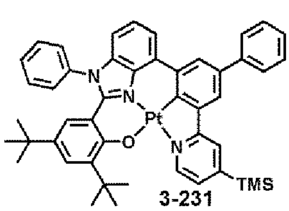
3-231

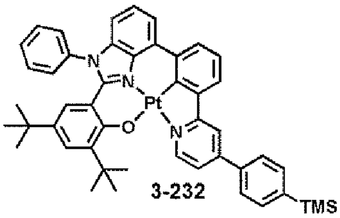
3-232

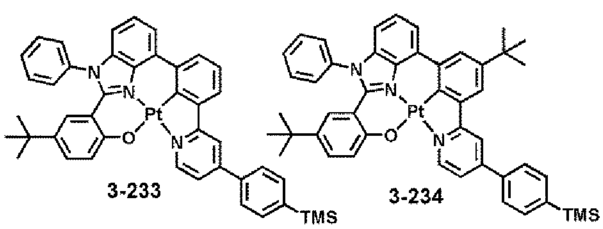
3-233

3-234

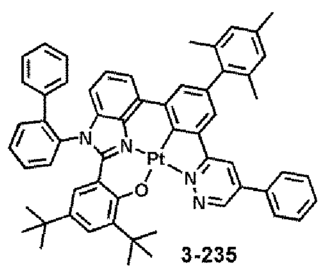
3-235

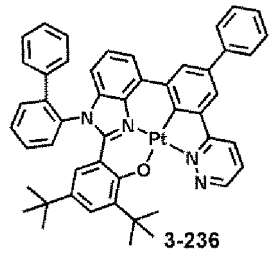
3-236

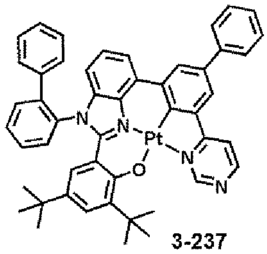
3-237

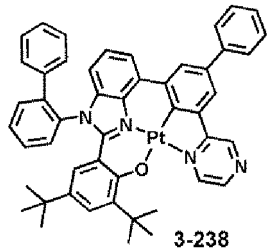
3-238

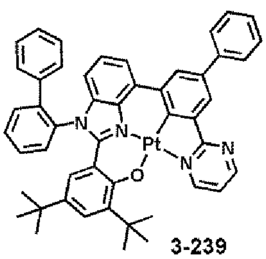
3-239

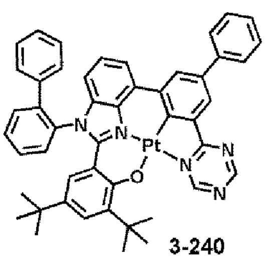
3-240

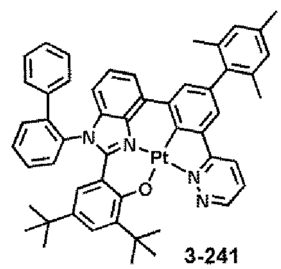
3-241

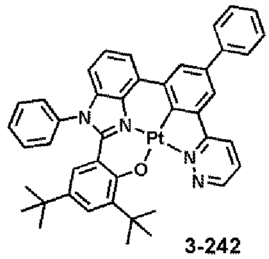
3-242

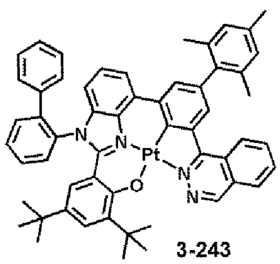
3-243
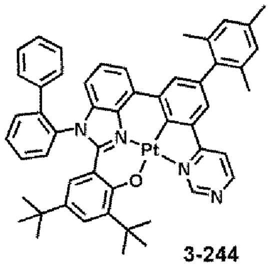
3-244
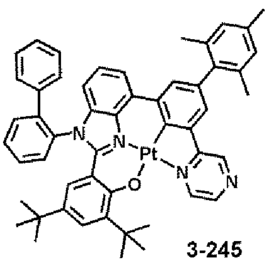
3-245
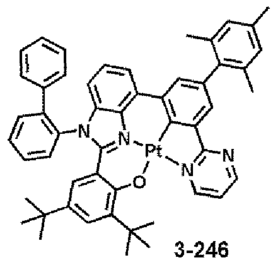
3-246
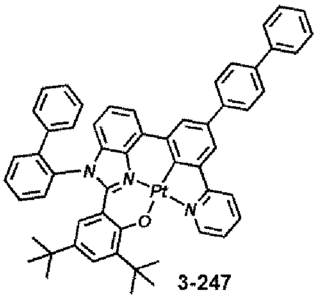
3-247
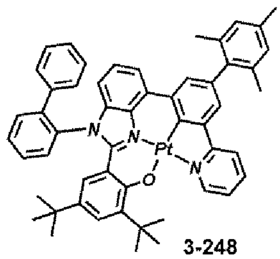
3-248
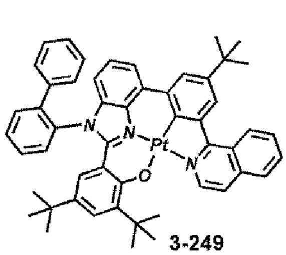
3-249
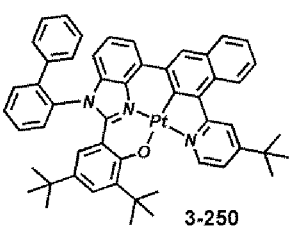
3-250
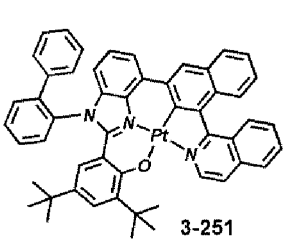
3-251
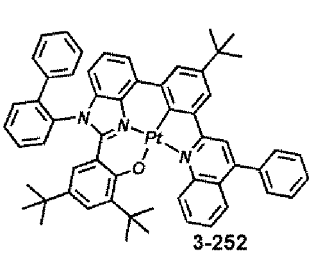
3-252
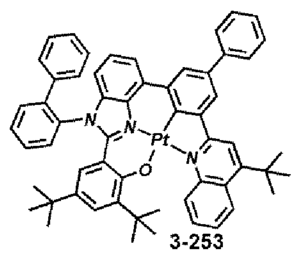
3-253
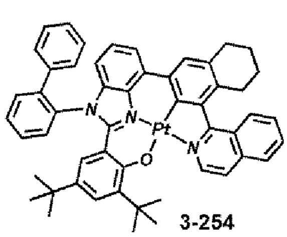
3-254
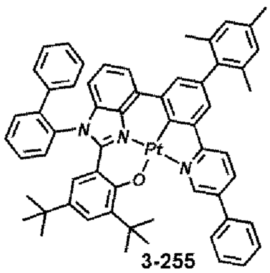
3-255
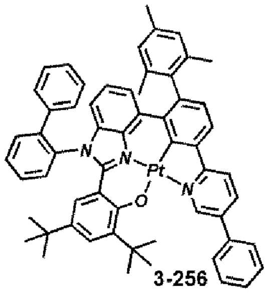
3-256
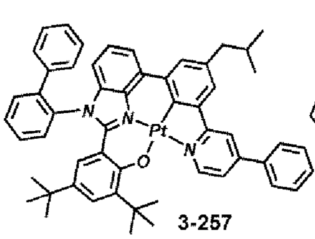
3-257
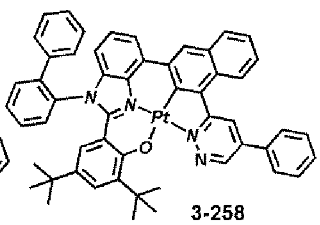
3-258
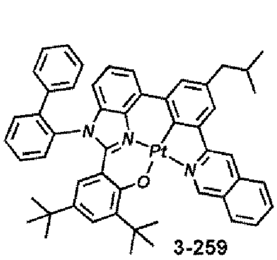
3-259
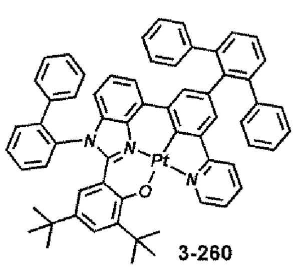
3-260
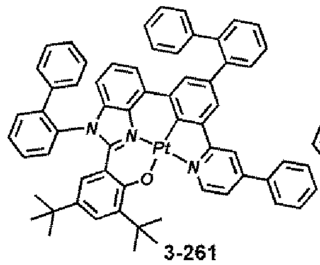
3-261
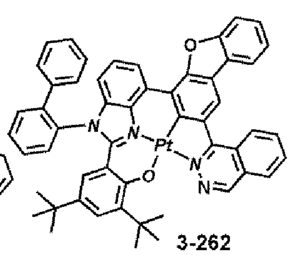
3-262

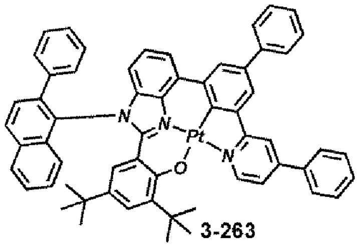
3-263

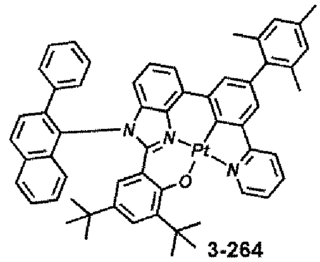
3-264

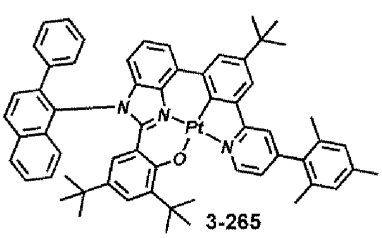
3-265

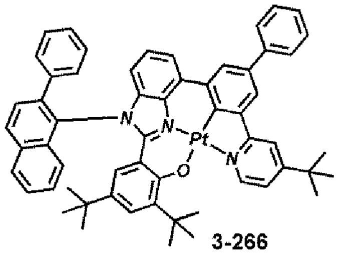
3-266

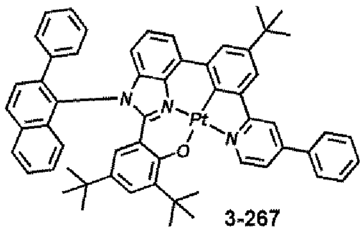
3-267

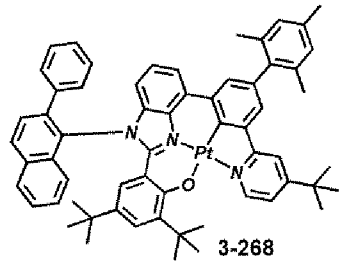
3-268

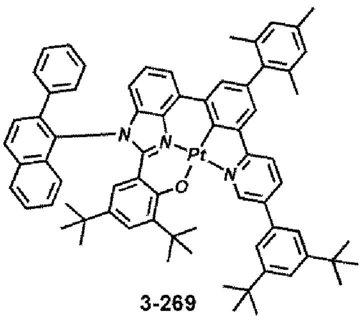
3-269

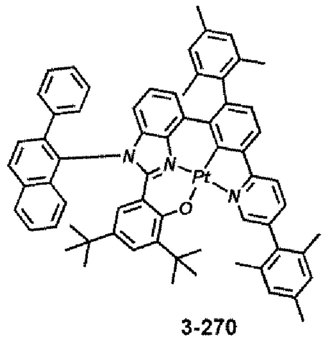
3-270

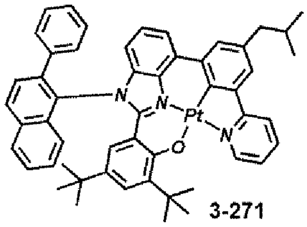
3-271

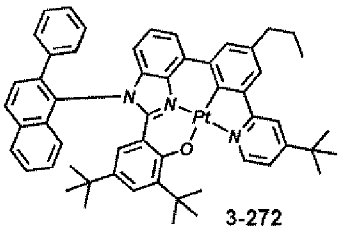
3-272

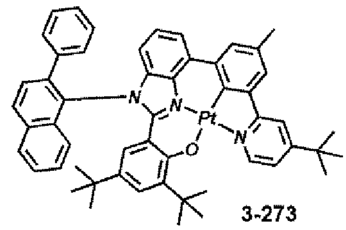
3-273

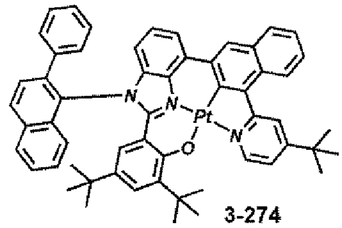
3-274

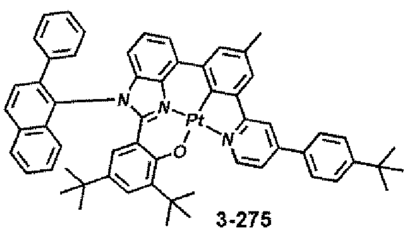
3-275

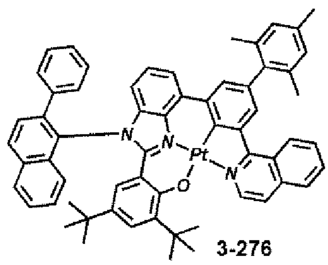
3-276

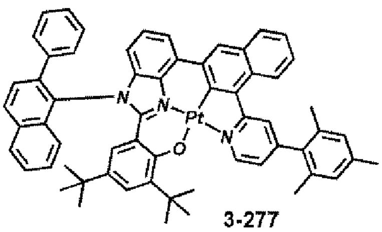
3-277

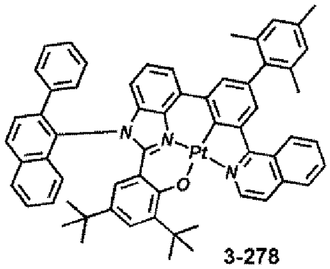
3-278
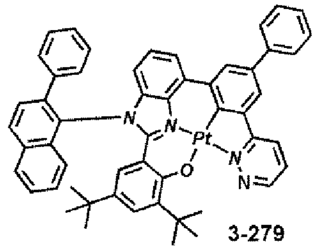
3-279
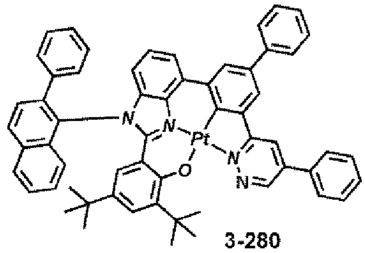
3-280

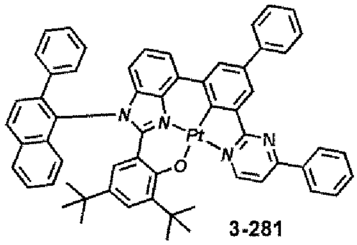
3-281
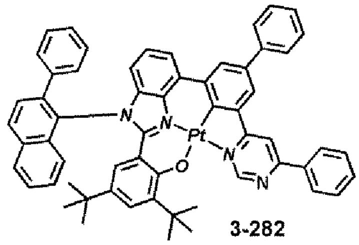
3-282
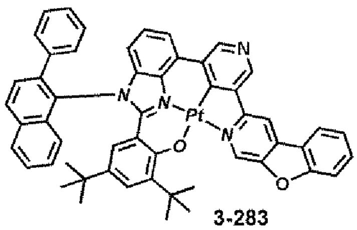
3-283

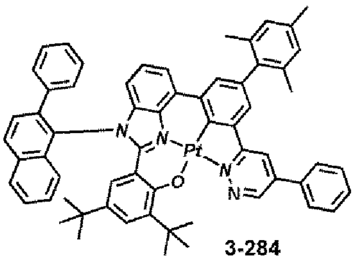
3-284
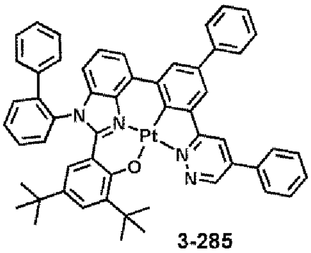
3-285
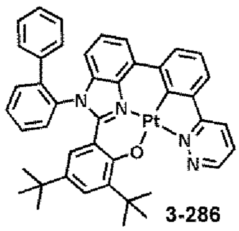
3-286
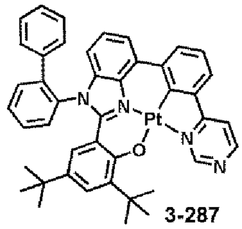
3-287

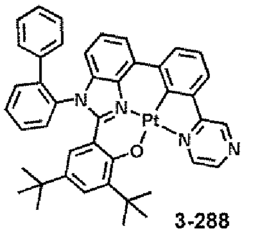
3-288
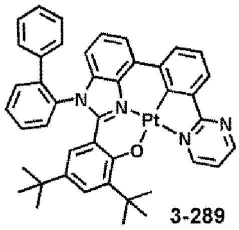
3-289
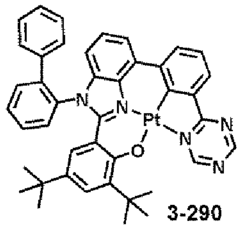
3-290
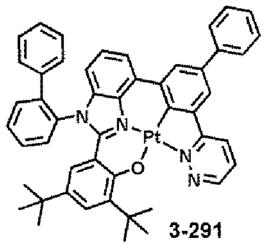
3-291

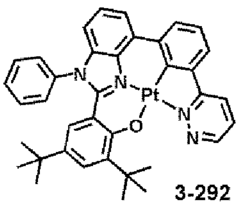
3-292
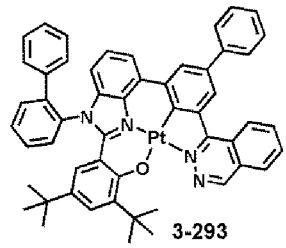
3-293
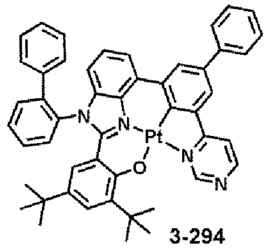
3-294
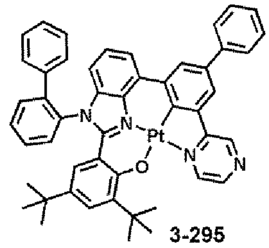
3-295

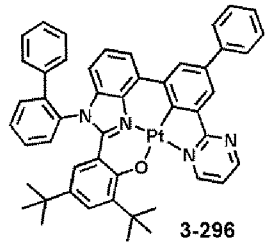
3-296
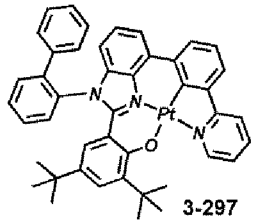
3-297
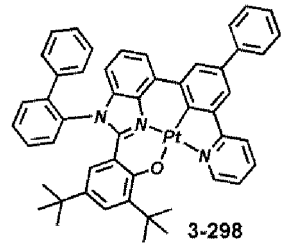
3-298
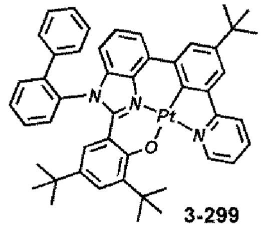
3-299

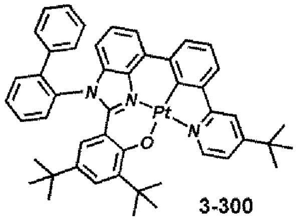
3-300

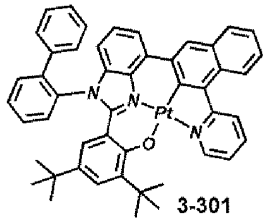
3-301

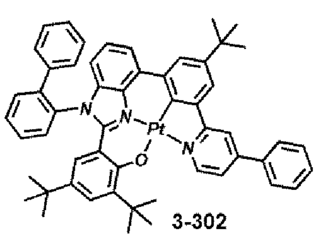
3-302

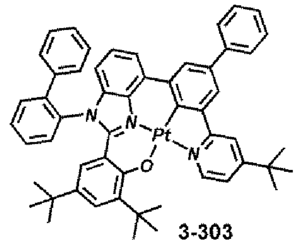
3-303

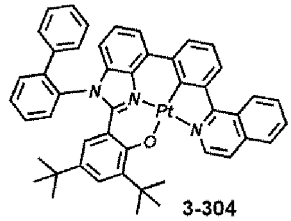
3-304

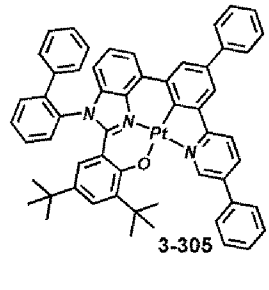
3-305

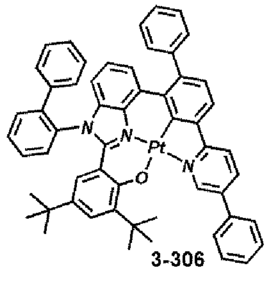
3-306

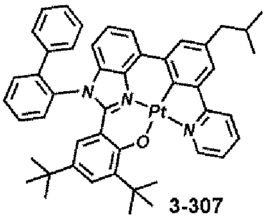
3-307

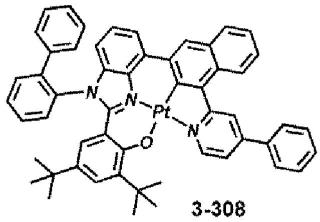
3-308

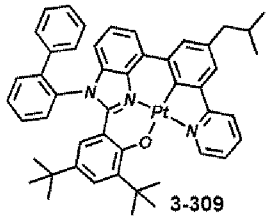
3-309

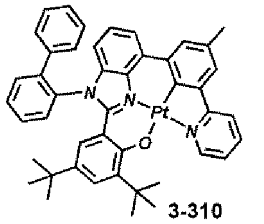
3-310

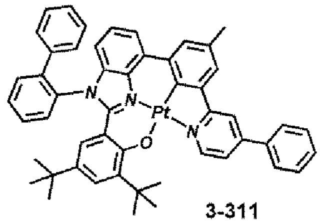
3-311

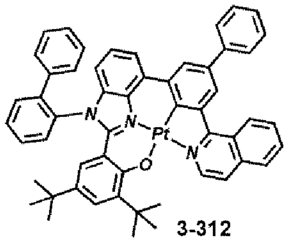
3-312

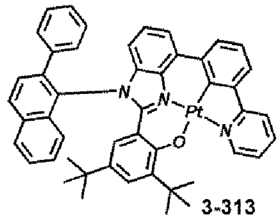
3-313

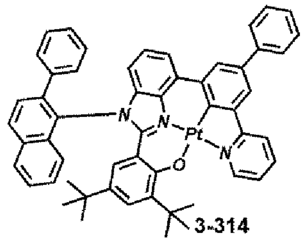
3-314

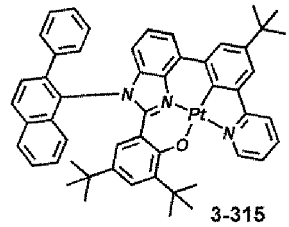
3-315

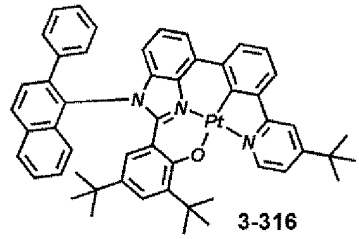
3-316

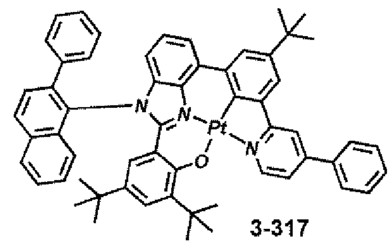
3-317

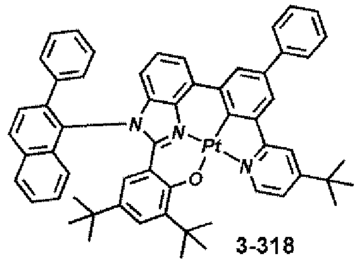
3-318

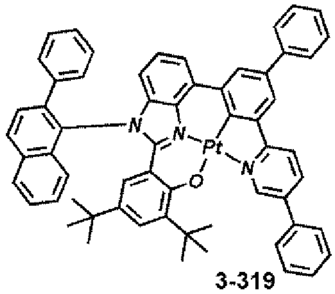
3-319

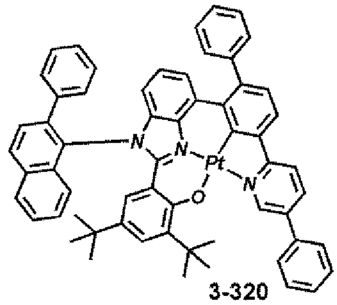
3-320

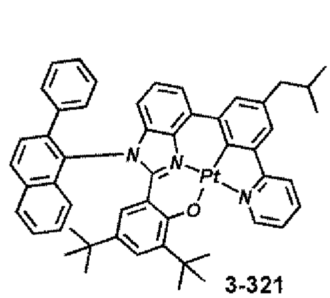
3-321

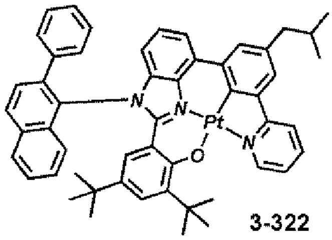
3-322

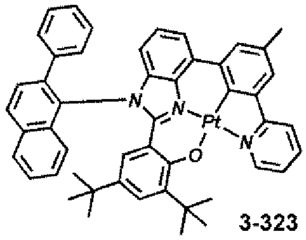
3-323

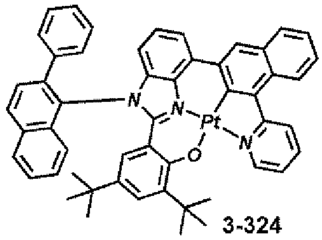
3-324

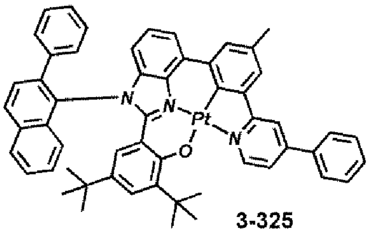
3-325

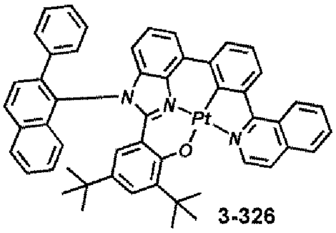
3-326

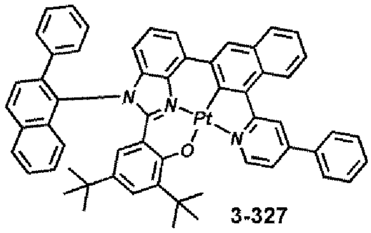
3-327

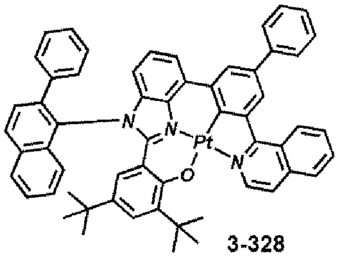
3-328

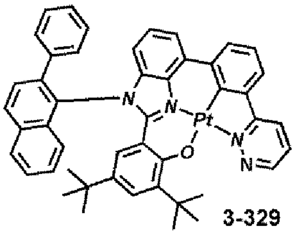
3-329

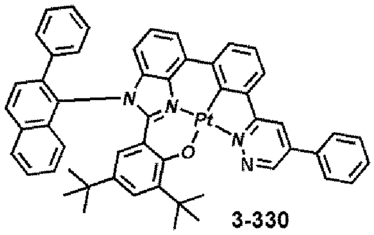
3-330

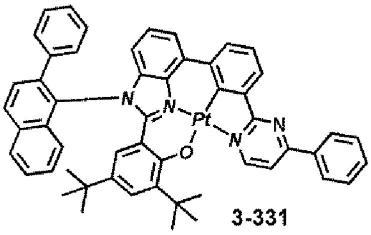
3-331

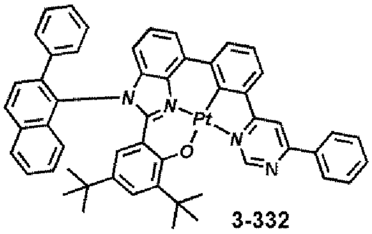
3-332

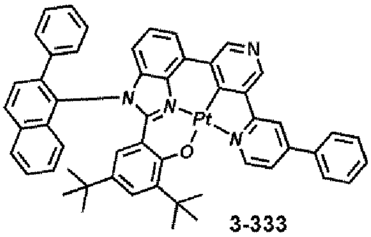
3-333

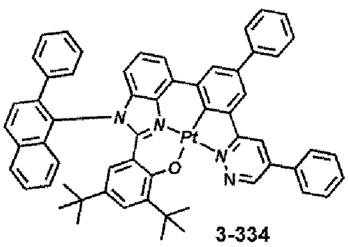
3-334

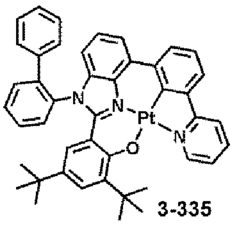
3-335

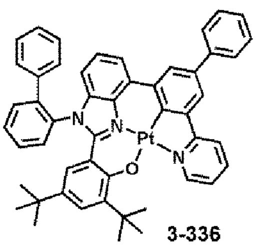
3-336

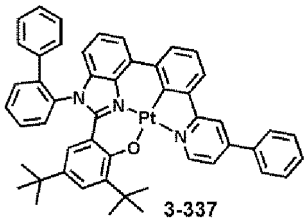
3-337

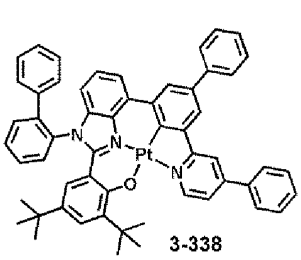
3-338

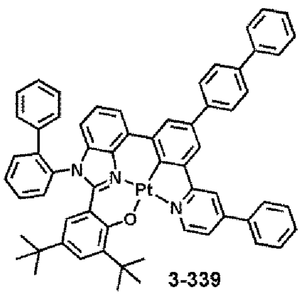
3-339

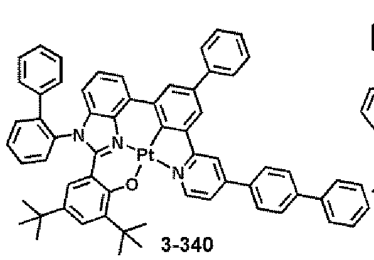
3-340

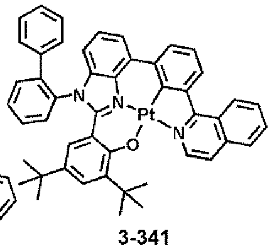
3-341

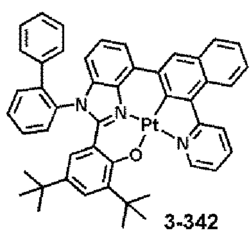
3-342

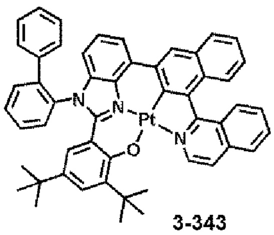
3-343

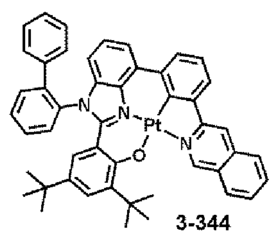
3-344

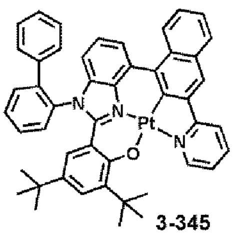
3-345

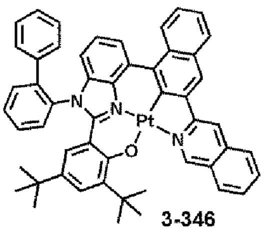
3-346

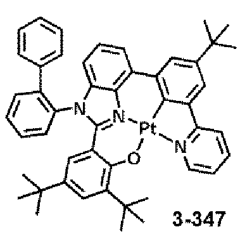
3-347

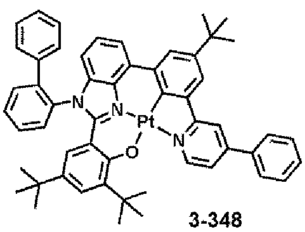
3-348

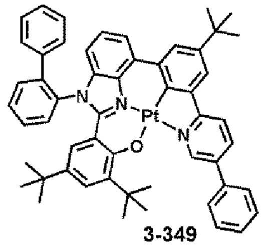
3-349

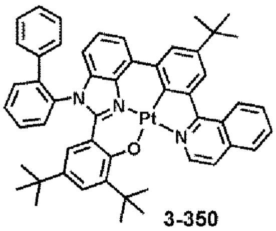
3-350

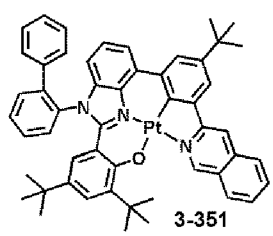
3-351

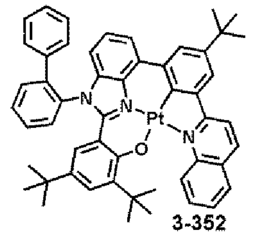
3-352

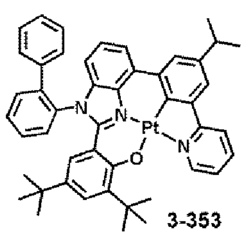
3-353

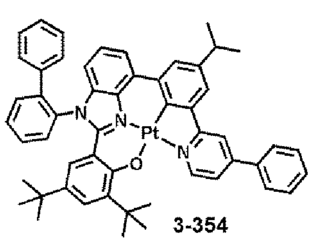
3-354

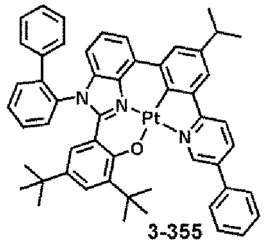
3-355

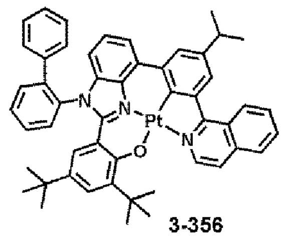
3-356

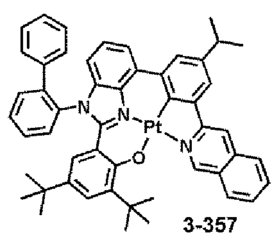
3-357

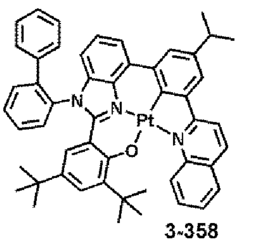
3-358

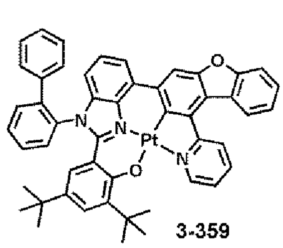
3-359

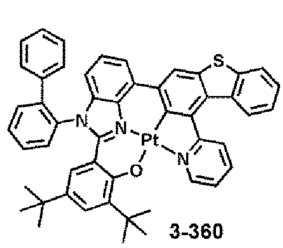
3-360

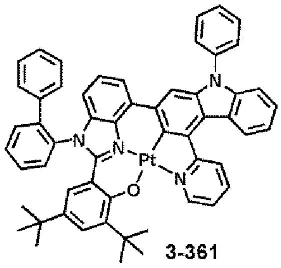
3-361

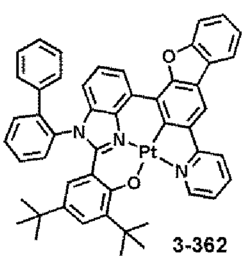
3-362

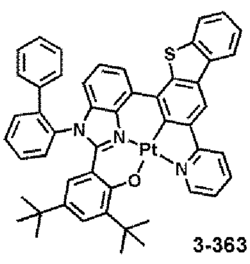
3-363

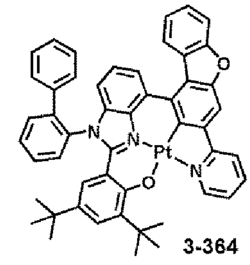
3-364

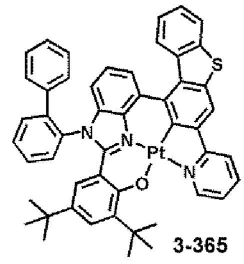
3-365

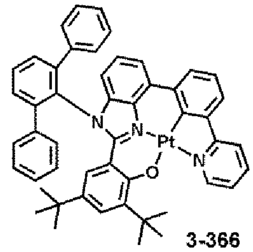
3-366

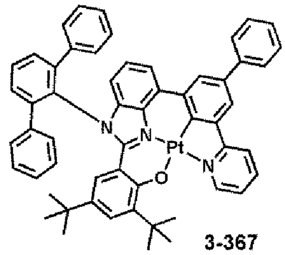
3-367

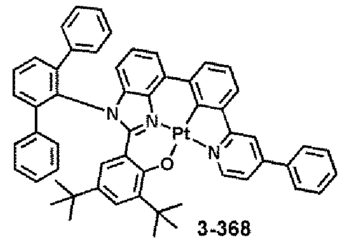
3-368

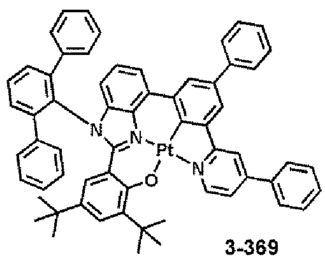
3-369

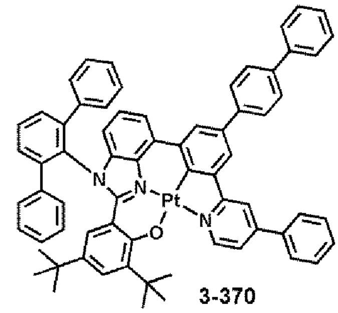
3-370

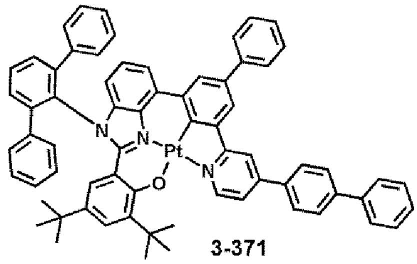
3-371

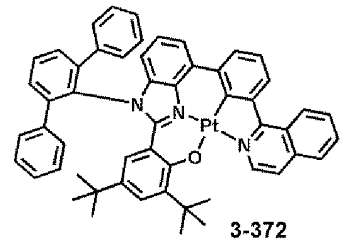
3-372

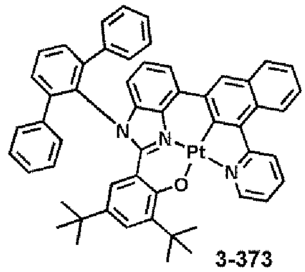
3-373

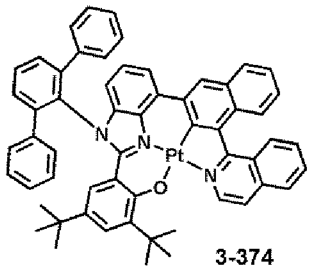
3-374

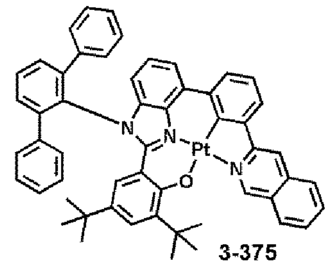
3-375

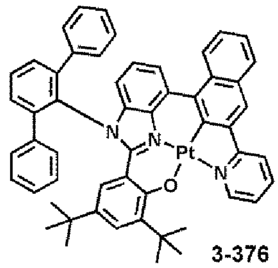
3-376

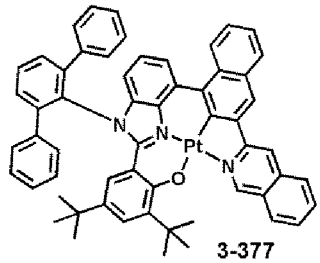
3-377

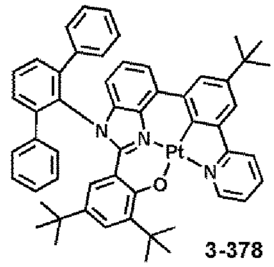
3-378

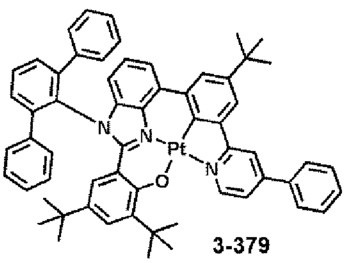
3-379

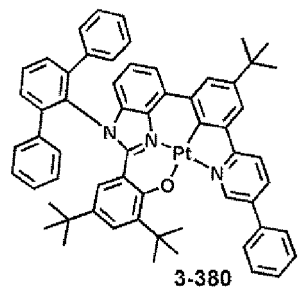
3-380

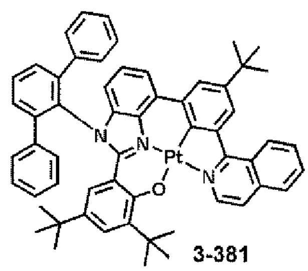
3-381

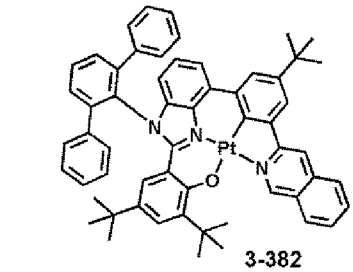
3-382

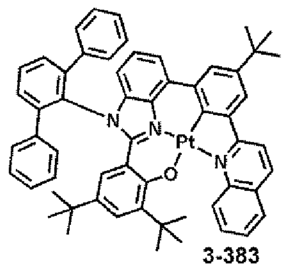
3-383

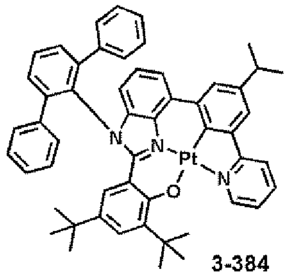
3-384

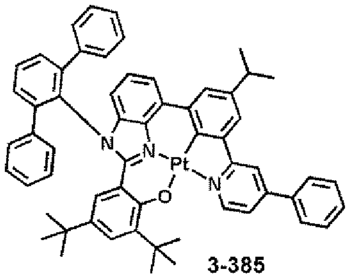
3-385

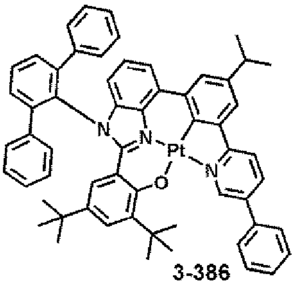
3-386

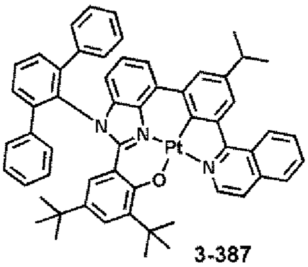
3-387

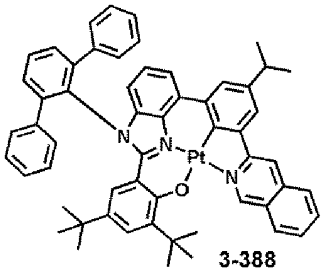
3-388

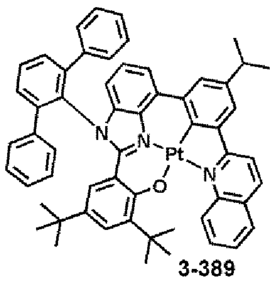
3-389

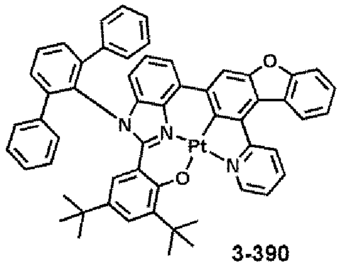
3-390

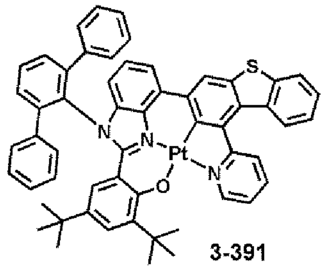
3-391

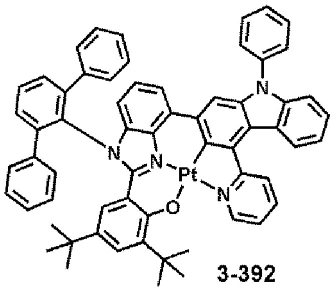
3-392

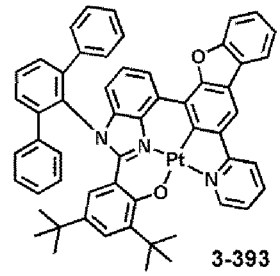
3-393

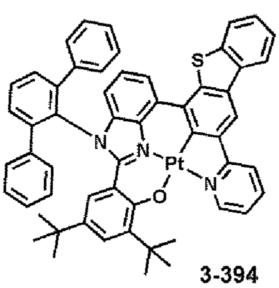
3-394

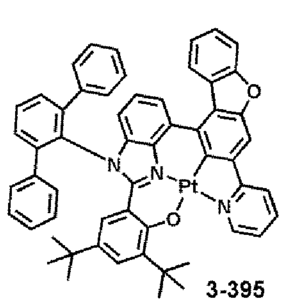
3-395

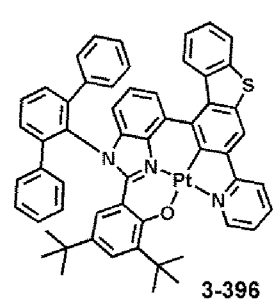
3-396

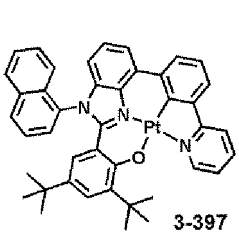
3-397

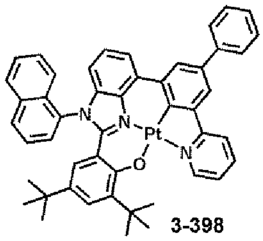
3-398

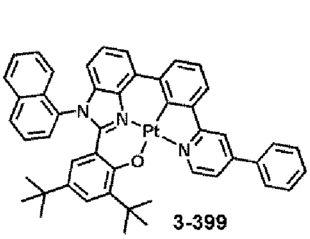
3-399

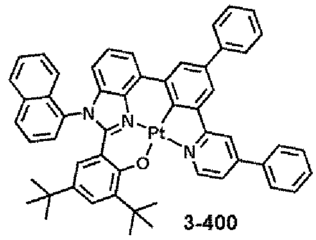
3-400

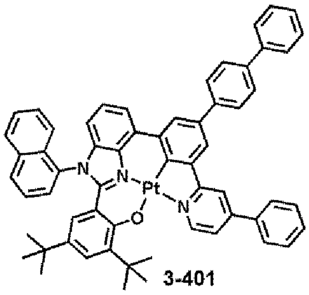
3-401

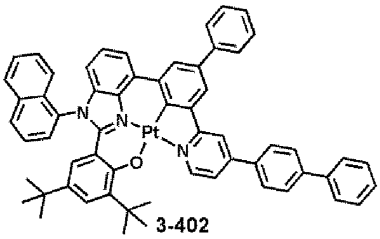
3-402

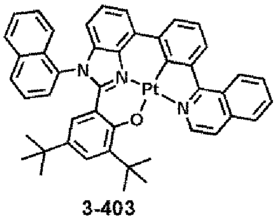
3-403

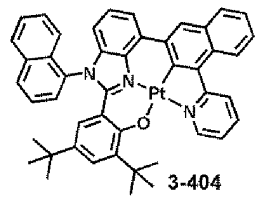
3-404

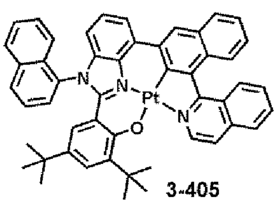
3-405

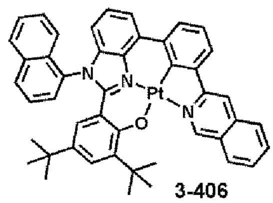
3-406

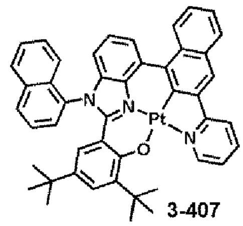
3-407

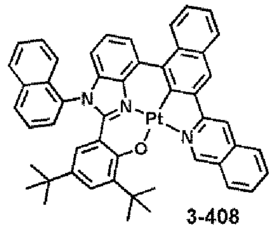
3-408

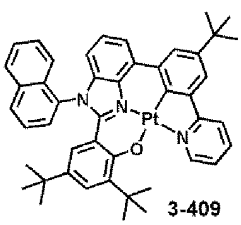
3-409

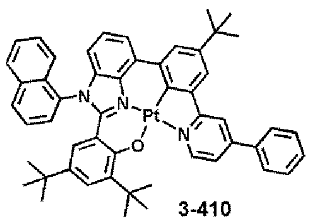
3-410

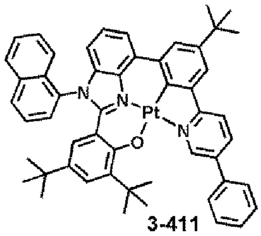
3-411

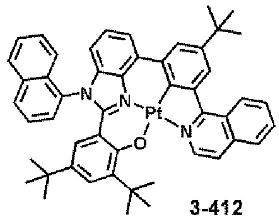
3-412

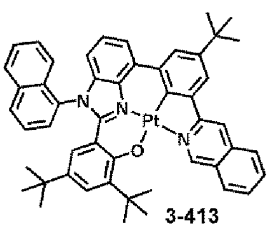
3-413

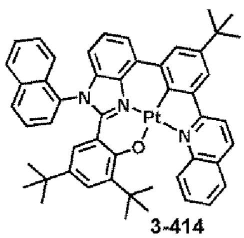
3-414

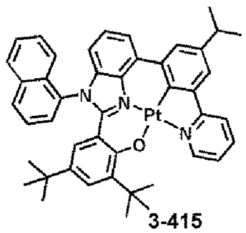
3-415

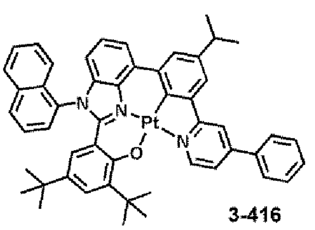
3-416

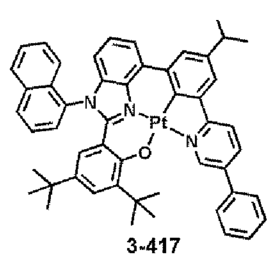
3-417

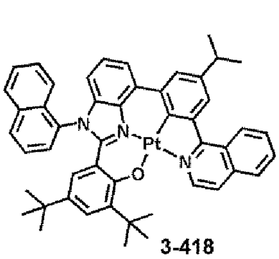
3-418

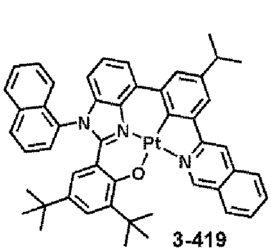
3-419

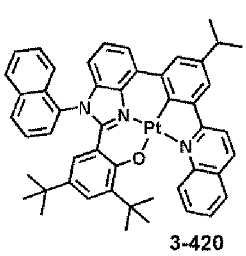
3-420

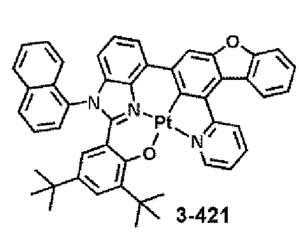
3-421

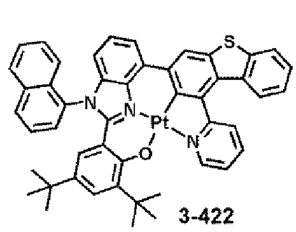
3-422

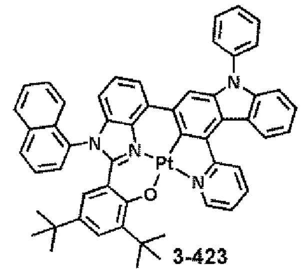
3-423

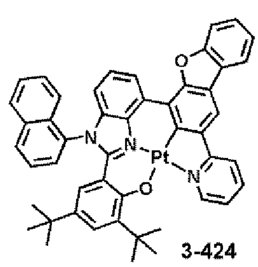
3-424

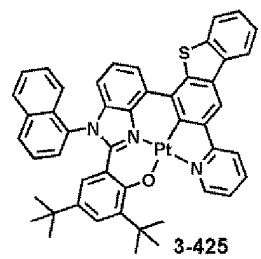
3-425

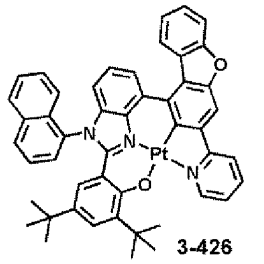
3-426

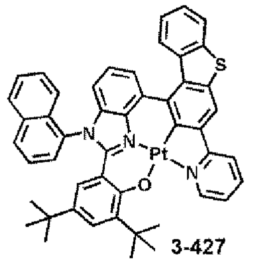
3-427

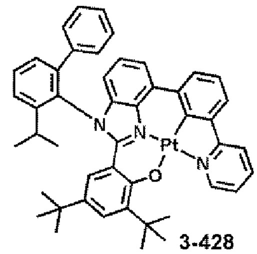
3-428

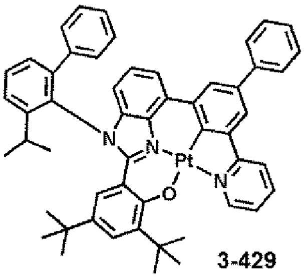
3-429

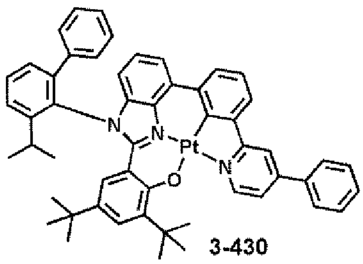
3-430

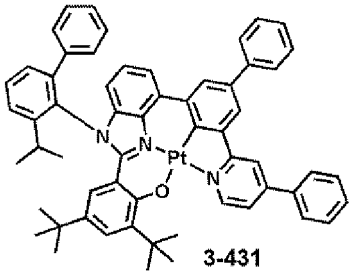
3-431

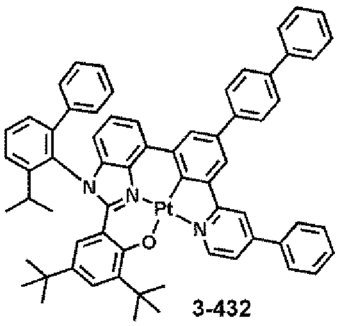
3-432

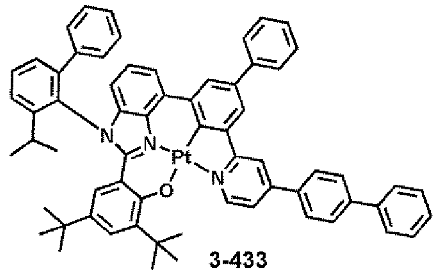
3-433

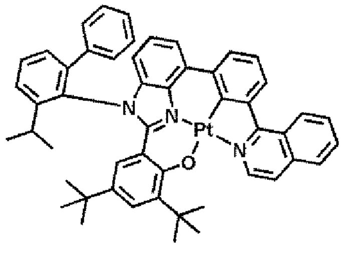
3-434

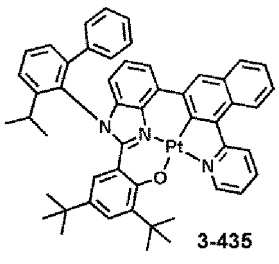
3-435

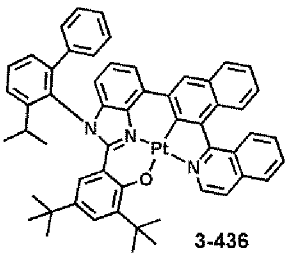
3-436

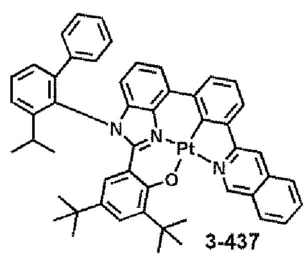
3-437

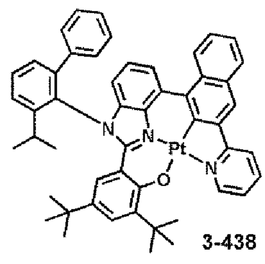
3-438

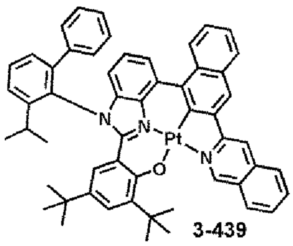
3-439
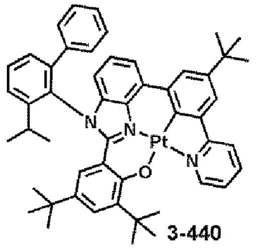
3-440
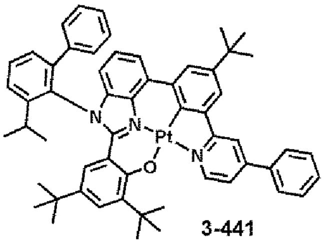
3-441
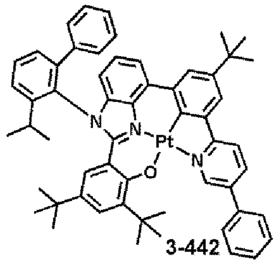
3-442
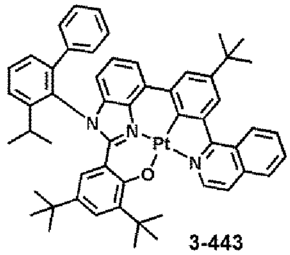
3-443
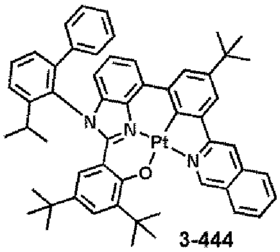
3-444
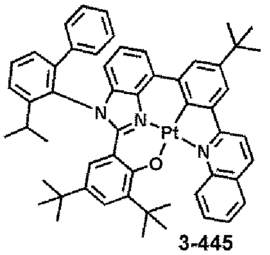
3-445
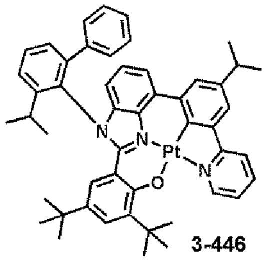
3-446
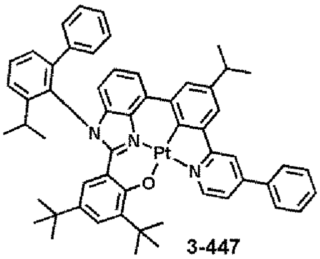
3-447
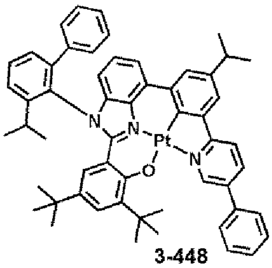
3-448
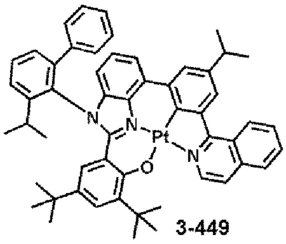
3-449
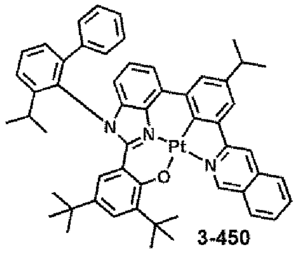
3-450
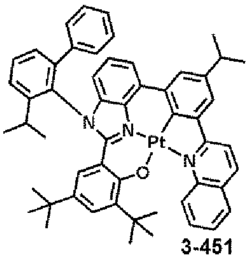
3-451
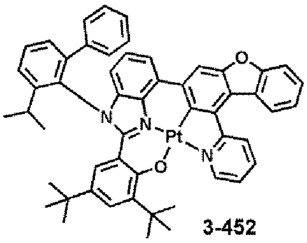
3-452
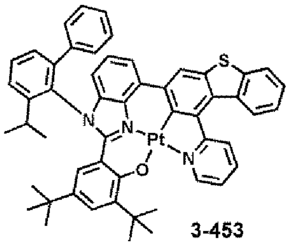
3-453
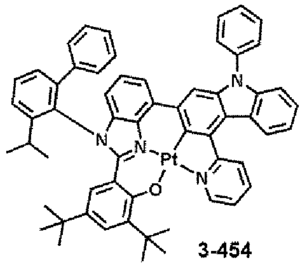
3-454
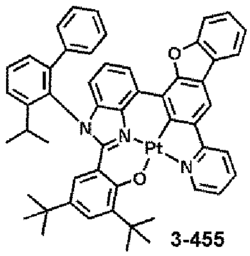
3-455
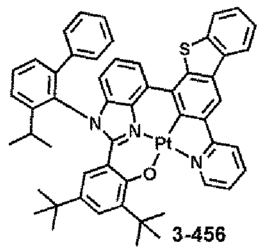
3-456
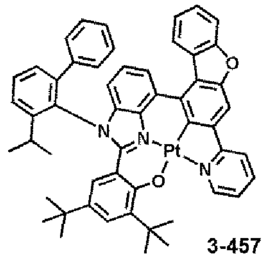
3-457
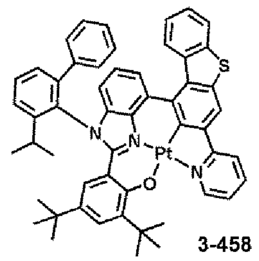
3-458
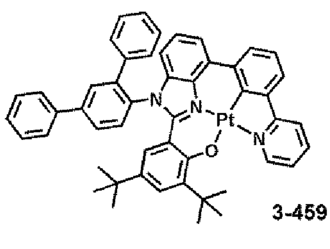
3-459
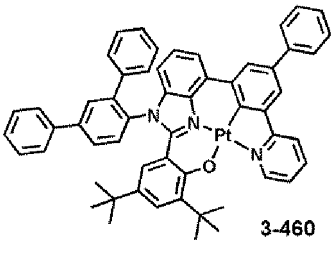
3-460
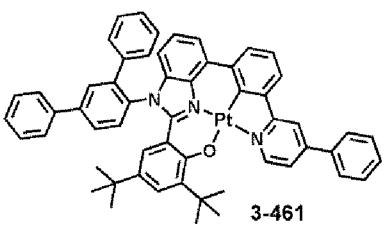
3-461

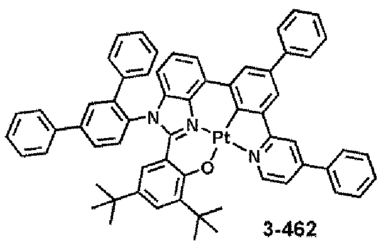
3-462

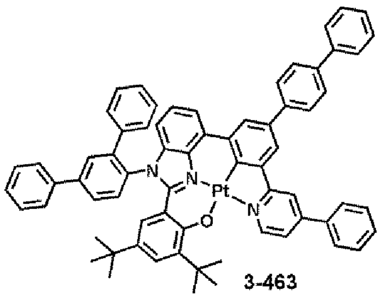
3-463

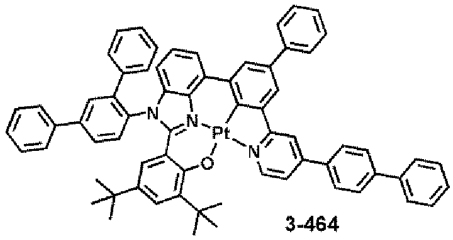
3-464

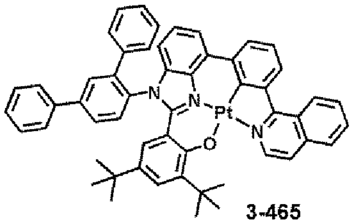
3-465

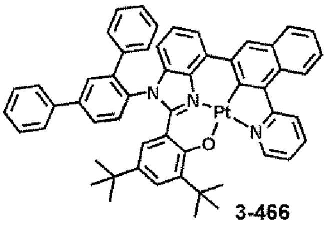
3-466

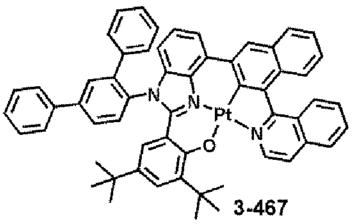
3-467

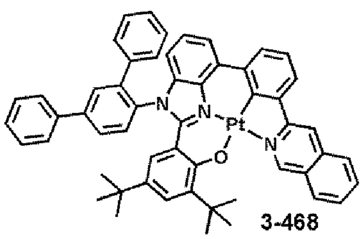
3-468

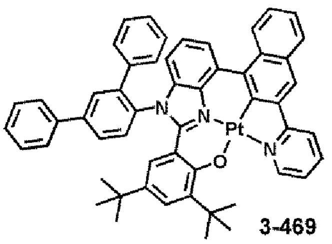
3-469

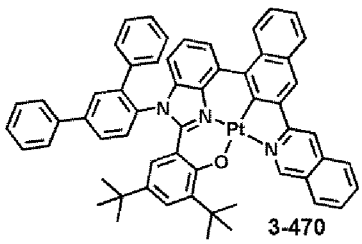
3-470

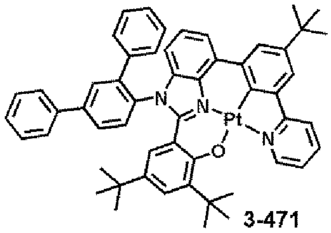
3-471

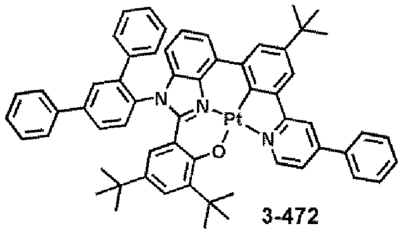
3-472

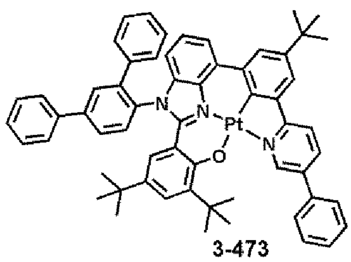
3-473

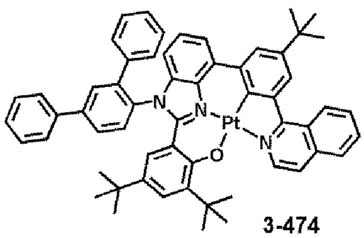
3-474

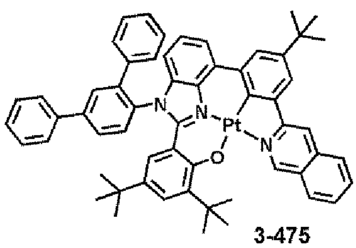
3-475

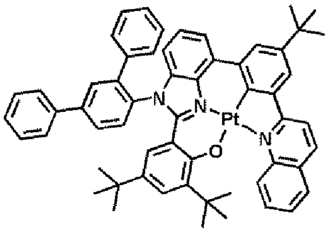
3-476

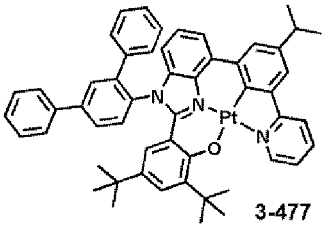
3-477

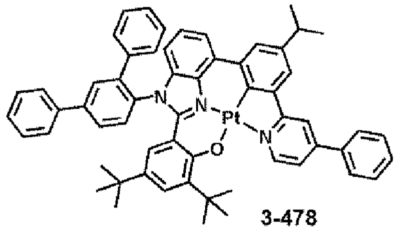
3-478

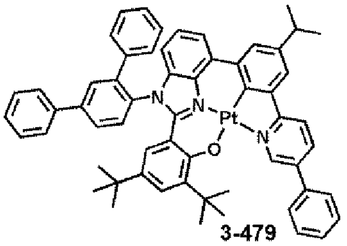
3-479

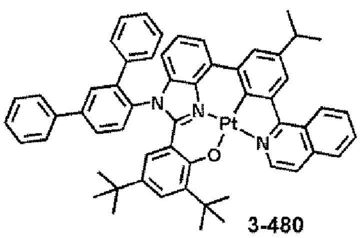
3-480

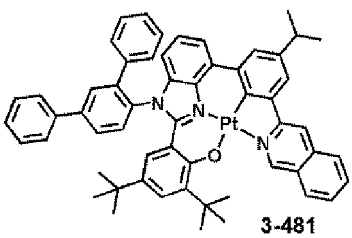
3-481

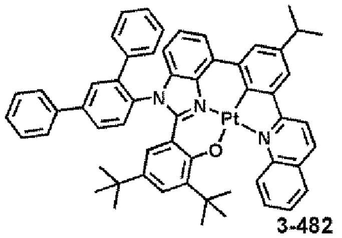
3-482

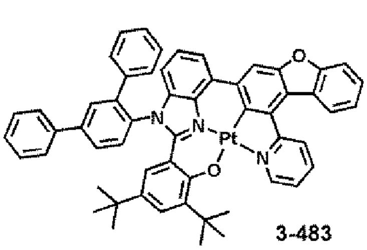
3-483

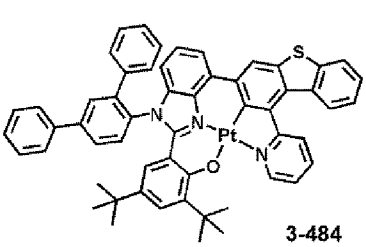
3-484

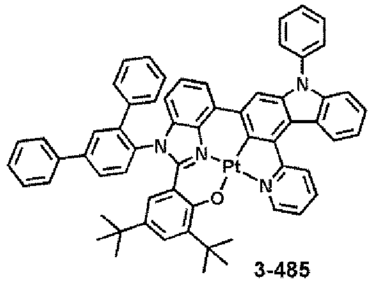
3-485

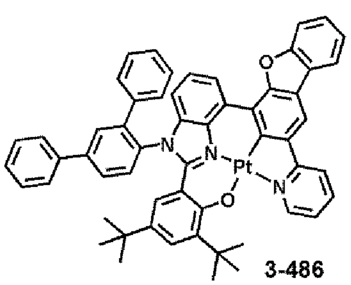
3-486

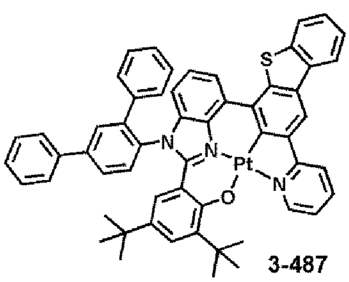
3-487

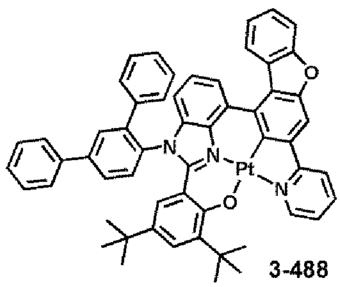
3-488

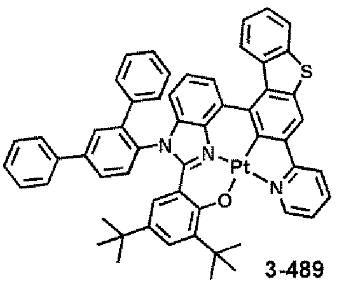
3-489

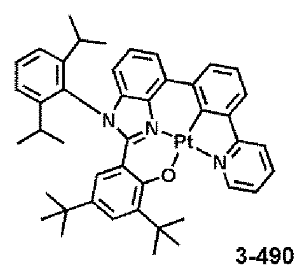
3-490

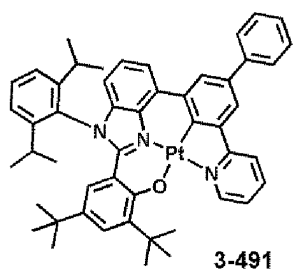
3-491

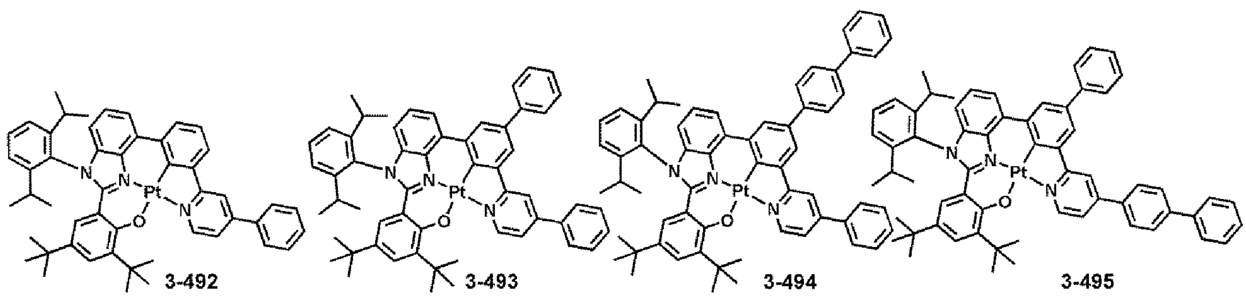
3-492 3-493 3-494 3-495

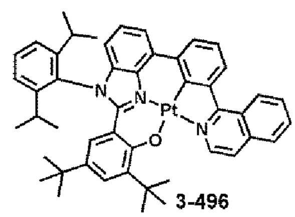
3-496

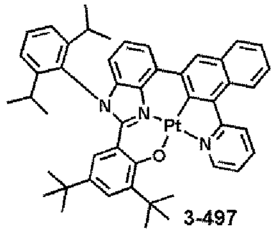
3-497

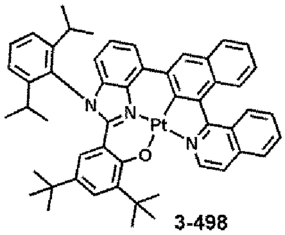
3-498

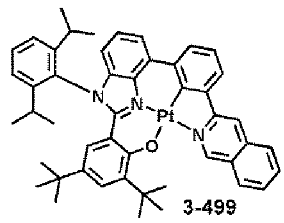
3-499

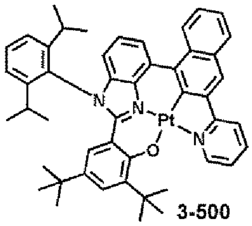
3-500

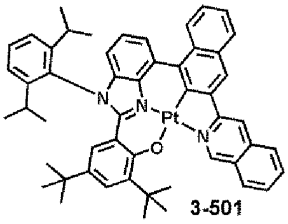
3-501

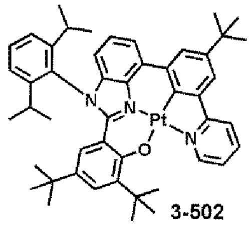
3-502

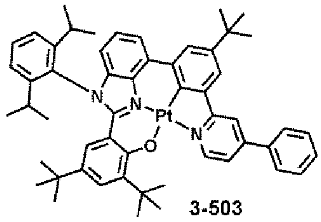
3-503

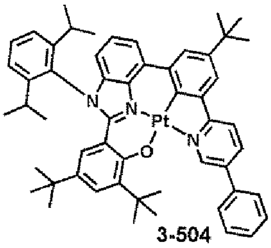
3-504

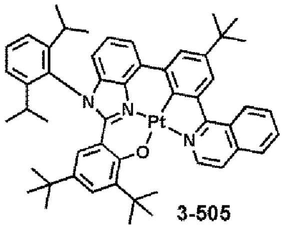
3-505

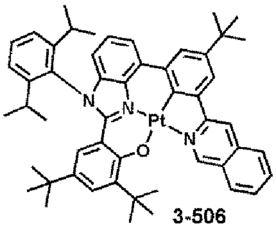
3-506

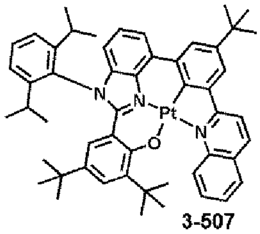
3-507

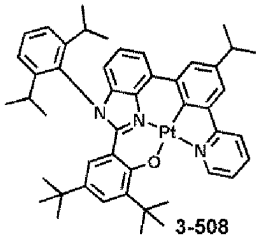
3-508

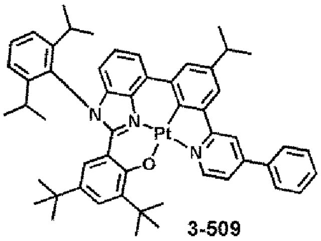
3-509

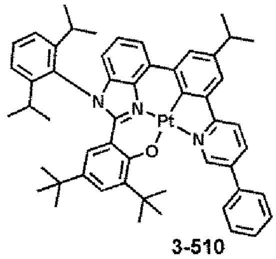
3-510

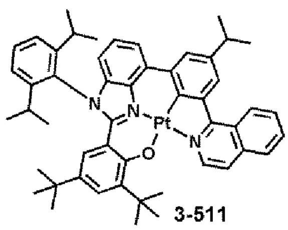
3-511

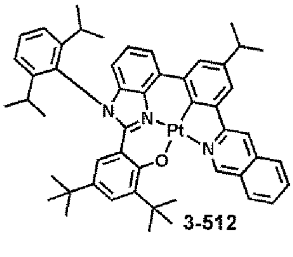
3-512

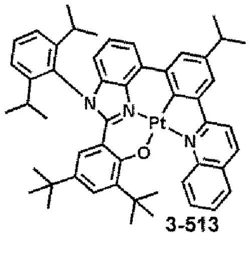
3-513

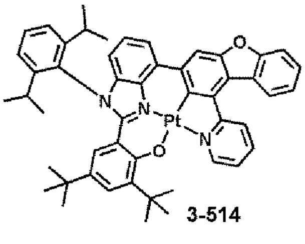
3-514

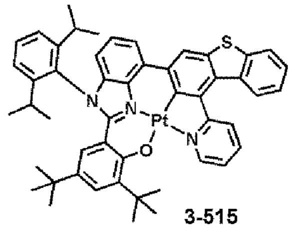
3-515

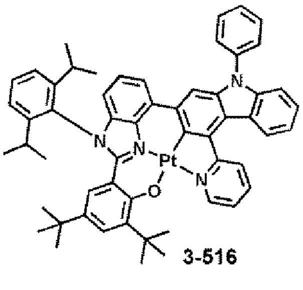
3-516

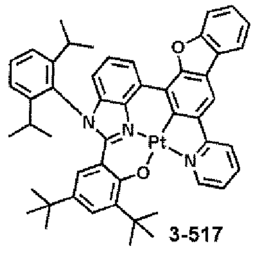
3-517

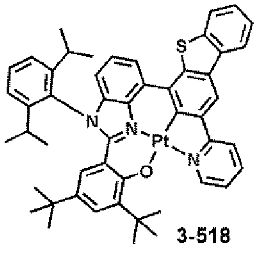
3-518

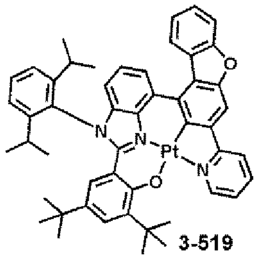
3-519

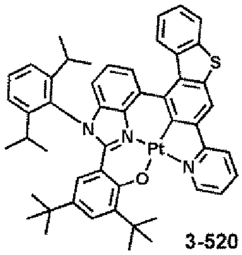
3-520

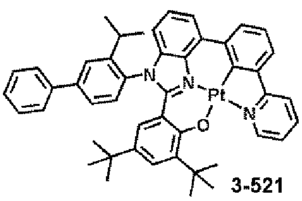
3-521

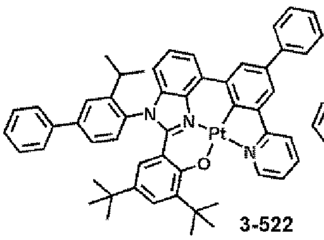
3-522

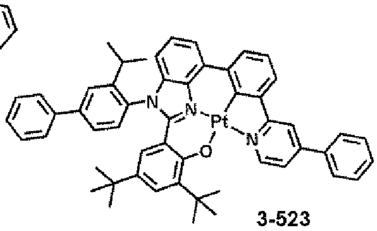
3-523

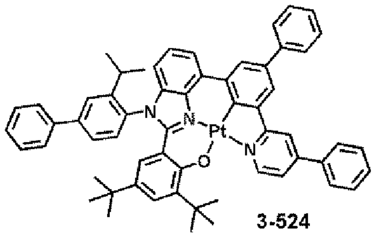
3-524

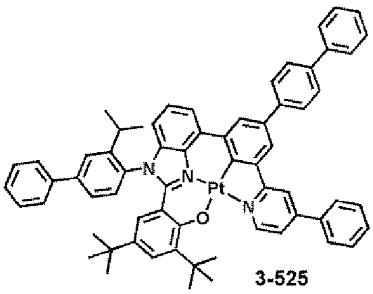
3-525

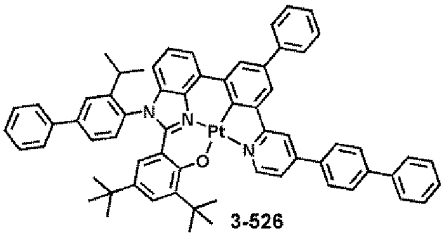
3-526

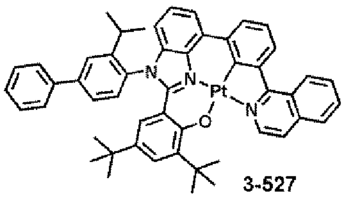
3-527

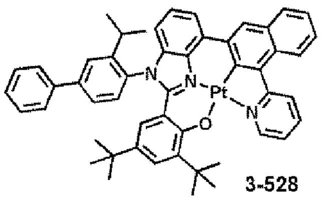
3-528

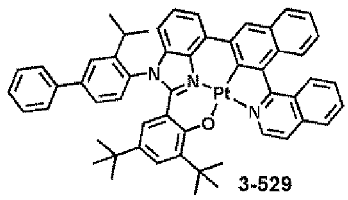
3-529

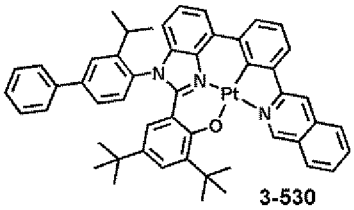
3-530

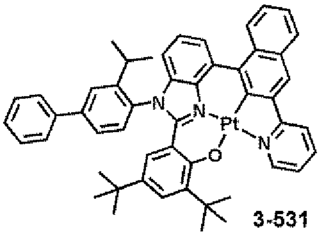
3-531

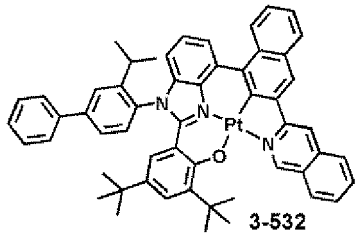
3-532

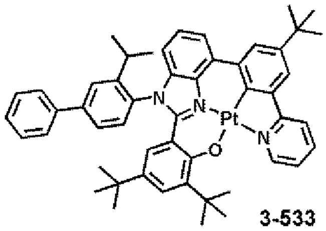
3-533

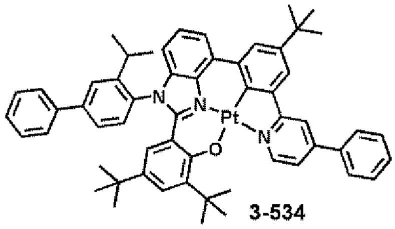
3-534

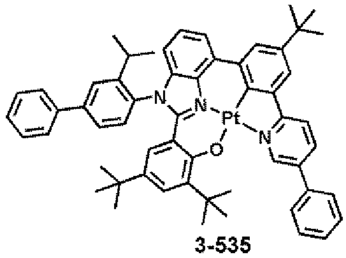
3-535

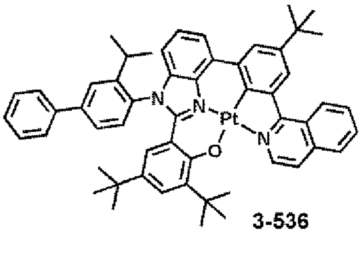
3-536

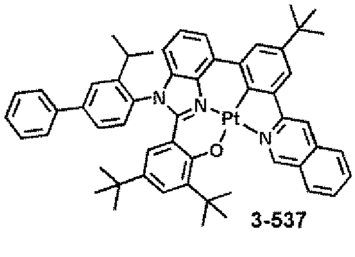
3-537

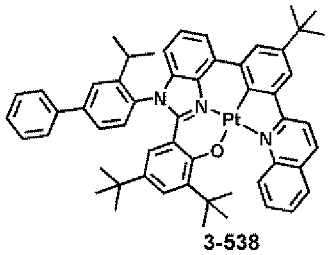
3-538

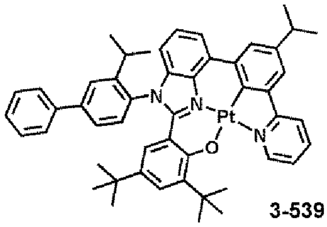
3-539

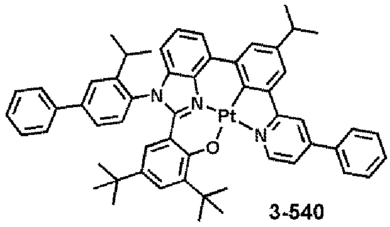
3-540

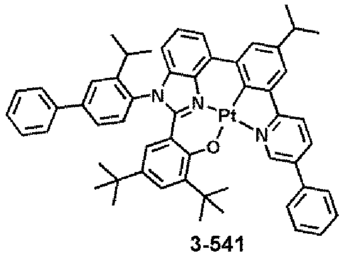
3-541

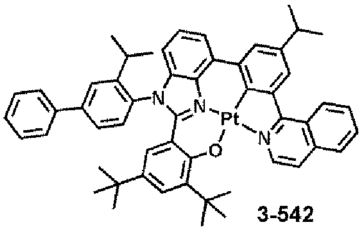
3-542

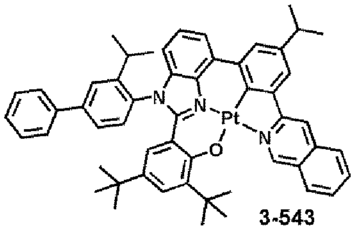
3-543

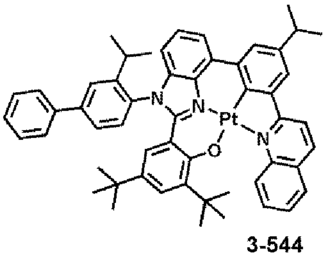
3-544

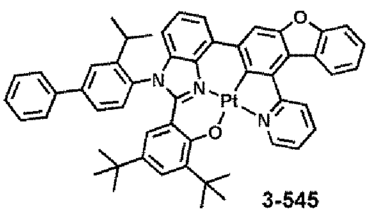
3-545

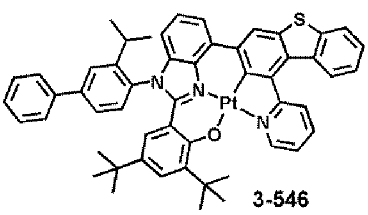
3-546

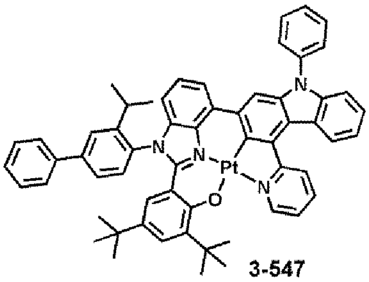
3-547

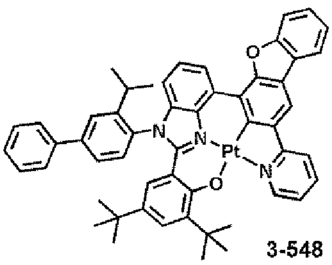
3-548

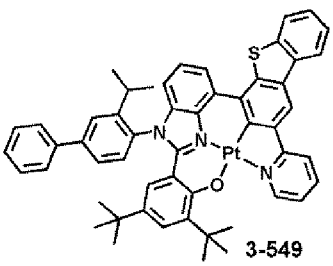
3-549

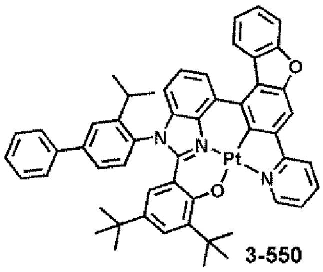
3-550

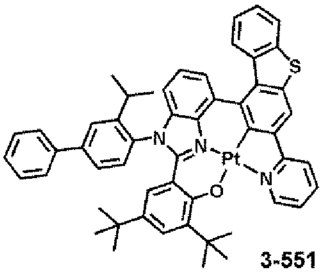
3-551

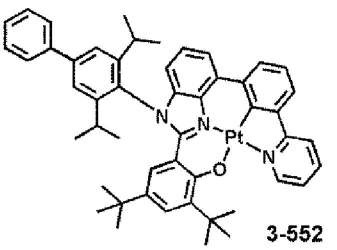
3-552

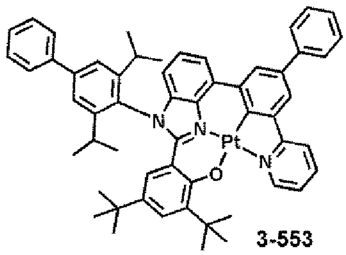
3-553

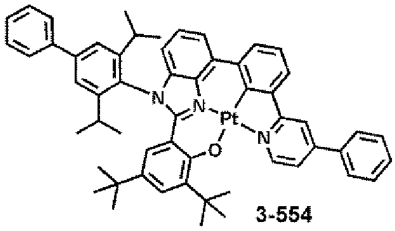
3-554

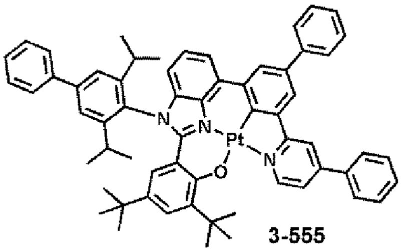
3-555

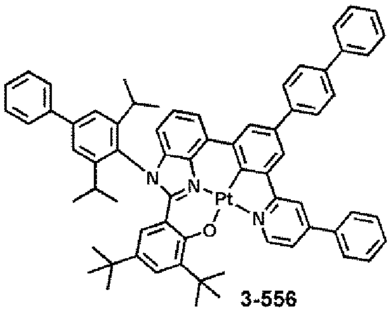
3-556

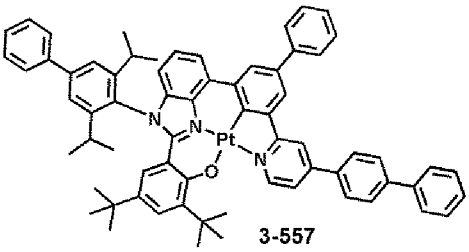
3-557

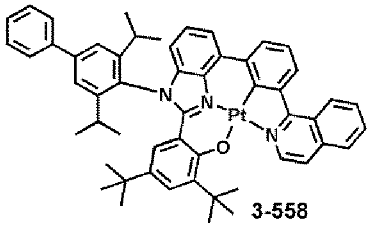
3-558

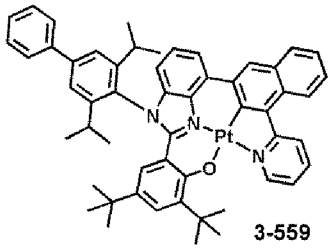
3-559

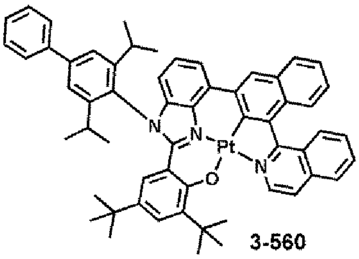
3-560

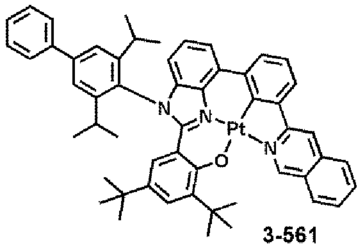
3-561

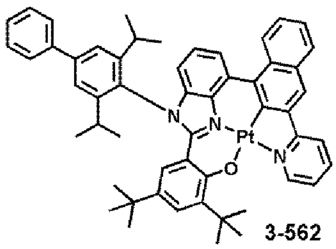
3-562

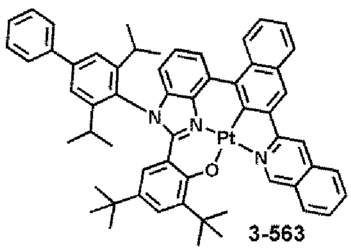
3-563

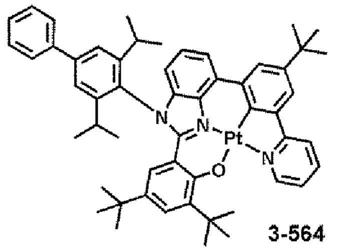
3-564

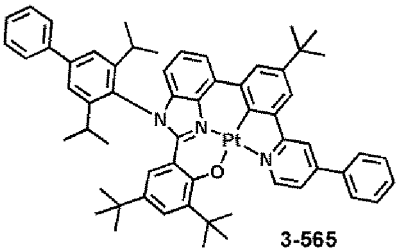
3-565

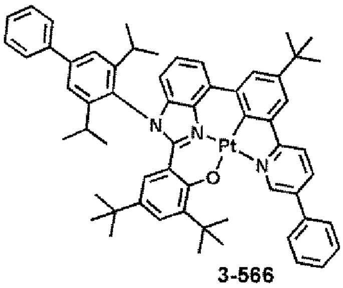
3-566

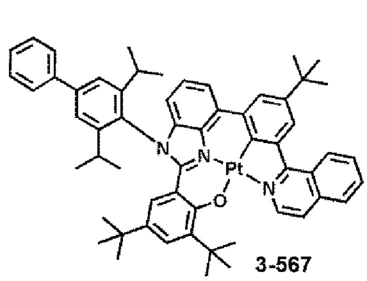
3-567

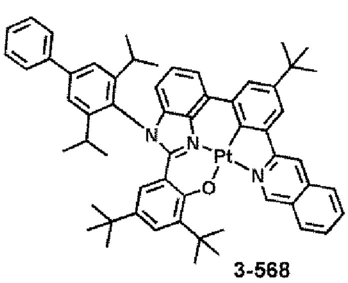
3-568

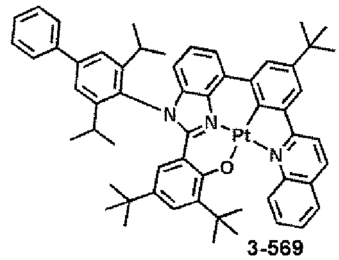
3-569

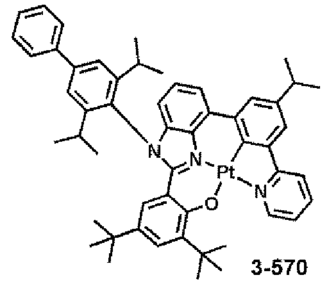
3-570

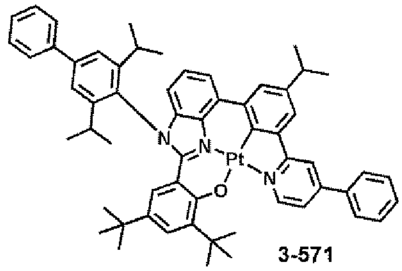
3-571

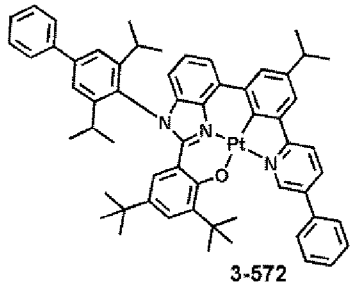
3-572

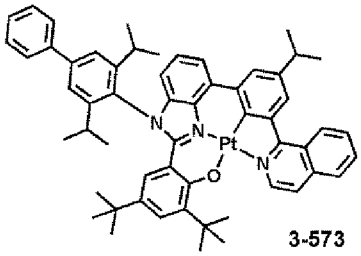
3-573

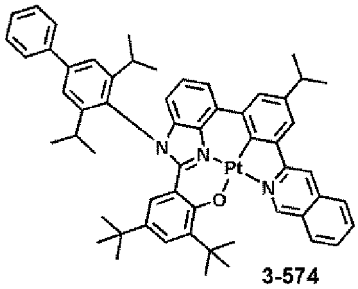
3-574

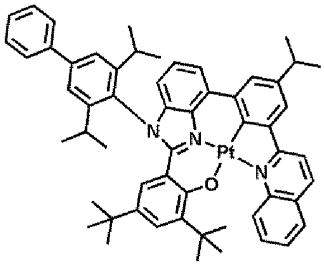
3-575

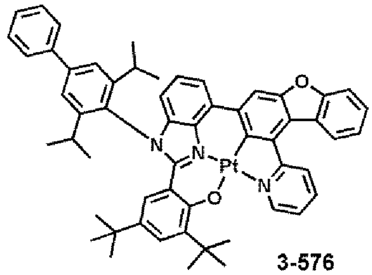
3-576

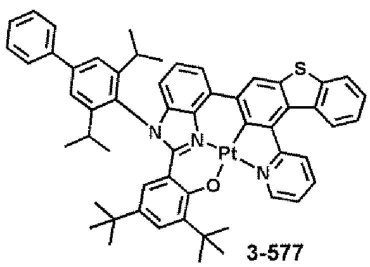
3-577

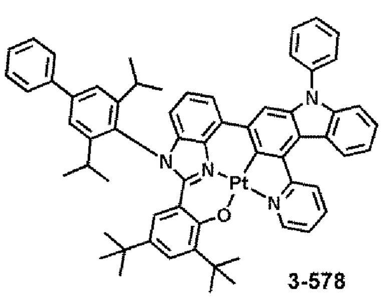
3-578

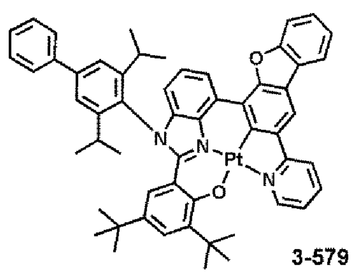
3-579

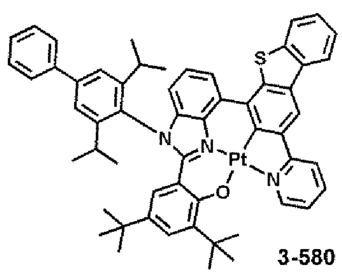
3-580

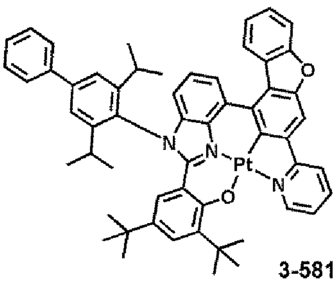
3-581

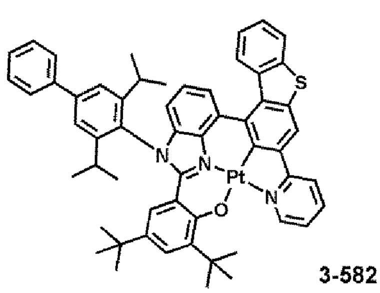
3-582

**6.** An organic light-emitting device comprising:

a first electrode;

a second electrode; and
an organic layer disposed between the first electrode and the second electrode,
wherein the organic layer comprising an emission layer, and
wherein the organic layer comprises at least one organometallic compound of any of claims 1-5;
preferably wherein
the first electrode is an anode,
the second electrode is a cathode,
the organic layer further comprises a hole transport region disposed between the first electrode and the emission layer and an electron transport region disposed between the emission layer and the second electrode,
the hole transport region comprises a hole injection layer, a hole transport layer, an electron blocking layer, or any combination thereof, and
the electron transport region comprises a hole blocking layer, an electron transport layer, an electron injection layer, or any combination thereof.

**7.** The organic light-emitting device of claim 6, wherein the emission layer comprises the organometallic compound; preferably wherein
the emission layer further comprises a host, and
an amount of the host in the emission layer is greater than an amount of the organometallic compound in the emission layer.

**Patentansprüche**

**1.** Organometallische Verbindung, repräsentiert durch Formel **1-1**:

Formel **1-1**

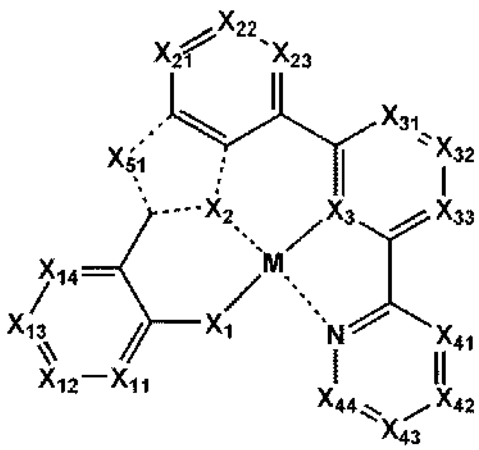

Formel **1-1**

,

wobei in Formel **1-1**,

M Beryllium (Be), Magnesium (Mg), Aluminium (Al), Calcium (Ca), Titan (Ti), Mangan (Mn), Cobalt (Co), Kupfer (Cu), Zink (Zn), Gallium (Ga), Germanium (Ge), Zirconium (Zr), Ruthenium (Ru), Rhodium (Rh), Palladium (Pd), Silber (Ag), Rhenium (Re), Platin (Pt) oder Gold (Au) ist, $X_1$ O oder S ist, und eine Bindung zwischen $X_1$ und M eine kovalente Bindung ist, i) $X_2$ N ist, $X_3$ C ist, eine Bindung zwischen $X_2$ und M eine Koordinatenbindung ist und eine Bindung zwischen $X_3$ und M eine kovalente Bindung ist;
oder ii) $X_3$ N ist, $X_2$ C ist, eine Bindung zwischen $X_3$ und M eine Koordinatenbindung ist und eine Bindung zwischen $X_2$ und M eine kovalente Bindung ist, $X_{51}$ ausgewählt ist aus O, S, N-[$(L_7)_{b7}$-$(R_7)_{c7}$], $C(R_7)(R_8)$, $Si(R_7)(R_8)$ und C(=O), $R_7$ und $R_8$ optional über eine erste Verknüpfungsgruppe verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden, und die erste Verknüpfungsgruppe aus einer Einzelbindung, *-O-*', *- S-*', *-$C(R_5)(R_6)$-*', *-$C(R_5)$=*', *=$C(R_6)$-*', *-$C(R_5)=C(R_6)$-*', *-C(=O)-*', *-C(=S)-*', *-C ≡ C-*', *-$N(R_5)$-*' und *-

$Si(R_5)(R_6)$-*', ausgewählt sein kann, $R_5$ und $R_6$ unabhängig das gleiche sind wie in Verbindung mit $R_7$ unten beschrieben, und *und *' jeweils eine Bindungsstelle an einem benachbarten Atom angeben, $L_7$ aus einer substituierten oder unsubstituierten carbocyclischen $C_5$-$C_{30}$-Gruppe und einer substituierten oder unsubstituierten heterocyclischen $C_1$-$C_{30}$-Gruppe ausgewählt ist, b7 eine ganze Zahl von 0 bis 5 ist,

$R_7$ und $R_8$ unabhängig ausgewählt sind aus Wasserstoff, Deuterium, -F, -Cl, -Br, -I, $-SF_5$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkynylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_2$-$C_{60}$-Heteroaryloxygruppe, einer substituierten oder unsubstituierten $C_2$-$C_{60}$-Heteroarylthiogruppe, einer substituierten oder unsubstituierten $C_3$-$C_{60}$-Heteroarylalkylgruppe, einer substituierten oder unsubstituierten, monovalenten, nicht aromatischen, kondensierten, polycyclischen Gruppe, einer substituierten oder unsubstituierten, monovalenten, nicht aromatischen, kondensierten, heteropolycyclischen Gruppe, - $N(Q_1)(Q_2)$, $-Si(Q_3)(Q_4)(Q_5)$, $-B(Q_6)(Q_7)$ und $-P(=O)(Q_8)(Q_9)$,

c7 eine ganze Zahl von 1 bis 5 ist,

$X_{11}$ N oder $C$-$[(L_{11})_{b11}$-$(R_{11})_{c11}]$ ist, $X_{12}$ N oder $C$-$[(L_{12})_{b12}$-$(R_{12})_{c12}]$ ist, $X_{13}$ N oder $C$-$[(L_{13})_{b13}$-$(R_{13})_{c13}]$ ist, $X_{14}$ N oder $C$-$[(L_{14})_{b14}$-$(R_{14})_{c14}]$ ist,

$L_{11}$ bis $L_{14}$, b11 bis b14, $R_{11}$ bis $R_{14}$ und c11 bis c14 unabhängig das gleiche sind wie in Verbindung mit $L_7$, b7, $R_7$ bzw. c7 oben beschrieben,

$X_{21}$ N oder $C$-$[(L_{21})_{b21}$-$(R_{21})_{c21}]$ ist, $X_{22}$ N oder $C$-$[(L_{22})_{b22}$-$(R_{22})_{c22}]$ ist, $X_{23}$ N oder $C$-$[(L_{23})_{b23}$-$(R_{23})_{c23}]$ ist,

$L_{21}$ bis $L_{23}$, b21 bis b23, $R_{21}$ bis $R_{23}$ und c21 bis c23 unabhängig das gleiche sind wie in Verbindung mit $L_7$, b7, $R_7$ bzw. c7 oben beschrieben,

$X_{31}$ N oder $C$-$[(L_{31})_{b31}$-$(R_{31})_{c31}]$ ist, $X_{32}$ N oder $C$-$[(L_{32})_{b32}$-$(R_{32})_{c32}]$ ist, $X_{33}$ N oder $C$-$[(L_{33})_{b33}$-$(R_{33})_{c33}]$ ist,

$L_{31}$ bis $L_{33}$, b31 bis b33, $R_{31}$ bis $R_{33}$ und c31 bis c33 unabhängig das gleiche sind wie in Verbindung mit $L_7$, b7, $R_7$ bzw. c7 oben beschrieben,

$X_{41}$ N oder $C$-$[(L_{41})_{b41}$-$(R_{41})_{c41}]$ ist, $X_{42}$ N oder $C$-$[(L_{42})_{b42}$-$(R_{42})_{c42}]$ ist, $X_{43}$ N oder $C$-$[(L_{43})_{b43}$-$(R_{43})_{c43}]$ ist, $X_{44}$ N oder $C$-$[(L_{44})_{b44}$-$(R_{44})_{c44}]$ ist,

$L_{41}$ bis $L_{44}$, b41 bis b44, $R_{41}$ bis $R_{44}$ und c41 bis c44 unabhängig das gleiche sind wie in Verbindung mit $L_7$, b7, $R_7$ bzw. c7 oben beschrieben, zwei ausgewählt aus $R_{11}$ bis $R_{14}$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden, zwei ausgewählt aus $R_{21}$ bis $R_{23}$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden, zwei ausgewählt aus $R_{31}$ bis $R_{33}$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden, und zwei ausgewählt aus $R_{41}$ bis $R_{44}$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden, in Fällen, bei denen i)-vii) unten gelten, mindestens eines ausgewählt aus $R_{11}$ bis $R_{14}$, $R_{21}$ bis $R_{23}$, $R_{31}$ bis $R_{33}$ und $R_{41}$ bis $R_{44}$ ausgewählt ist aus einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_1$-$C_{60}$-Heteroarylgruppe, einer substituierten oder unsubstituierten, monovalenten, nicht aromatischen, kondensierten, polycyclischen Gruppe und substituierten oder unsubstituierten, monovalenten, nicht aromatischen, kondensierten, heteropolycyclischen Gruppe,

i) M Pt ist, ii) $X_1$ O ist, iii) $X_2$ N ist, $X_3$ C ist, eine Bindung zwischen $X_2$ und M eine Koordinatenbindung ist und eine Bindung zwischen $X_3$ und M eine kovalente Bindung ist, iv) die zwei Bindungen von $X_{51}$, angegeben durch eine gestrichelte Linie, jeweils eine Einzelbindung sind, v) $X_{11}$, $X_{12}$, $X_{13}$, $X_{14}$, $X_{21}$, $X_{22}$ $X_{23}$, $X_{31}$, $X_{32}$, $X_{33}$, $X_{41}$, $X_{42}$, $X_{43}$ und $X_{44}$ $C$-$[(L_{11})_{b11}$-$(R_{11})_{c11}]$, $C$-$[(L_{12})_{b12}$-$(R_{12})_{c12}]$, $C$-$[(L_{13})_{b13}$-$(R_{13})_{c13}]$, $C$-$[(L_{14})_{b14}$-$(R_{14})_{c14}]$, $C$-$[(L_{21})_{b21}$-$(R_{21})_{c21}]$, $C$-$[(L_{22})_{b22}$-$(R_{22})_{c22}]$, $C$-$[(L_{23})_{b23}$-$(R_{23})_{23}]$, $C$-$[(L_{31})_{b31}$- $(R_{31})_{c31}]$, $C$-$[(L_{32})_{b32}$-$(R_{32})_{c32}]$, $C$-$[(L_{33})_{b33}$-$(P_{33})_{33}]$, $C$-$[(L_{41})_{b41}$-$(R_{41})_{c41}]$, $C$-$[(L_{42})_{b42}$-$(R_{42})_{c42}]$, $C$-$[(L_{43})_{b43}$-$(R_{43})_{c43}]$ bzw. $C$-$[(L_{44})_{b44}$-$(R_{44})_{c44}]$ sind, vi) $X_{51}$ O, S oder $N$-$[(L_7)_{b7}$-$(R_7)_{c7}]$ ist, und vii) b7 0 ist, c7 1 ist und $R_7$ eine substituierte oder unsubstituierte

$C_1$-$C_{60}$-Alkylgruppe ist;

mindestens ein Substituent der substituierten carbocyclischen $C_5$-$C_{30}$-Gruppe, der substituierten heterocyclischen $C_1$-$C_{30}$-Gruppe, der substituierten $C_1$-$C_{60}$-Alkylgruppe, der substituierten $C_2$-$C_{60}$-Alkenylgruppe, der substituierten $C_2$-$C_{60}$-Alkynylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_7$-$C_{60}$-Arylalkylgruppe, der substituierten $C_1$-$C_{60}$-Heteroarylgruppe, der substituierten $C_2$-$C_{60}$-Heteroaryloxygruppe, der substituierten $C_2$-$C_{60}$-Heteroarylthiogruppe, der substituierten $C_3$-$C_{60}$-Heteroarylalkylgruppe, der substituierten, monovalenten, nicht aromatischen, kondensierten, polycyclischen Gruppe und der substituierten, monovalenten, nicht aromatischen, kondensierten, heteropolycyclischen Gruppe ausgewählt ist aus:

Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe;

einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe, jeweils substituiert mit mindestens einem, ausgewählt aus Deuterium, -F, -Cl, -Br, -I, - $CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_2$-$C_{60}$-Heteroaryloxygruppe, einer $C_2$-$C_{60}$-Heteroarylthiogruppe, einer $C_3$-$C_{60}$-Heteroarylalkylgruppe, einer monovalenten, nicht aromatischen, kondensierten, polycyclischen Gruppe, einer monovalenten, nicht aromatischen, kondensierten, heteropolycyclischen Gruppe, $-N(Q_{11})(Q_{12})$, $-Si(Q_{13})(Q_{14})(Q_{15})$, $-B(Q_{16})(Q_{17})$ und $-P(=O)(Q_{18})(Q_{19})$;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_2$-$C_{60}$-Heteroaryloxygruppe, einer $C_2$-$C_{60}$-Heteroarylthiogruppe, einer $C_3$-$C_{60}$-Heteroarylalkylgruppe, einer monovalenten, nicht aromatischen, kondensierten, polycyclischen Gruppe, einer monovalenten, nicht aromatischen, kondensierten, heteropolycyclischen Gruppe;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_2$-$C_{60}$-Heteroaryloxygruppe, einer $C_2$-$C_{60}$-Heteroarylthiogruppe, einer $C_3$-$C_{60}$-Heteroarylalkylgruppe, einer monovalenten, nicht aromatischen, kondensierten, polycyclischen Gruppe und einer monovalenten, nicht aromatischen, kondensierten, heteropolycyclischen Gruppe, jeweils substituiert mit einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, $C_1$-$C_{60}$-Alkylgruppe, einer $C_2$-$C_{60}$-alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$ arylgruppe, einer $C_6$-$C_{60}$-Aryloxygruppe, einer $C_6$-$C_{60}$-Arylthiogruppe, einer $C_7$-$C_{60}$ arylalkylgruppe, einer $C_1$-$C_{60}$-Heteroarylgruppe, einer $C_2$-$C_{60}$-Heteroaryloxygruppe, einer $C_2$-$C_{60}$-Heteroarylthiogruppe, einer $C_3$-$C_{60}$-Heteroarylalkylgruppe, einer monovalenten, nicht aromatischen, kondensierten, polycyclischen Gruppe, einer monovalenten, nicht aromatischen, kondensierten, heteropolycyclischen Gruppe, $-N(Q_{21})(Q_{22})$, $-Si(Q_{23})(Q_{24})(Q_{25})$, $-B(Q_{26})(Q_{27})$ und $-P(=O)(Q_{28})(Q_{29})$; und

$-N(Q_{31})(Q_{32})$, $-Si(Q_{33})(Q_{34})(Q_{35})$, $-B(Q_{36})(Q_{37})$ und $-P(=O)(Q_{38})(Q_{39})$, and $Q_1$ bis $Q_9$, $Q_{11}$ bis $Q_{19}$, $Q_{21}$ bis $Q_{29}$, und $Q_{31}$ bis $Q_{39}$ sind jeweils unabhängig ausgewählt aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{60}$-Alkylgruppe, einer $C_1$-$C_{60}$-Alkylgruppe, substituiert mit mindestens einem ausgewählt aus Deuterium, einer $C_1$-$C_{60}$-Alkylgrup-

pe und einer $C_6$-$C_{60}$-Arylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Arylgruppe, substituiert mit mindestens einem ausgewählt aus Deuterium, einer $C_1$-$C_{60}$-Alkylgruppe und einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-heteroaryl group, einer $C_2$-$C_{60}$-heteroaryloxy group, einer $C_2$-$C_{60}$-Heteroarylthiogruppe, einer $C_3$-$C_{60}$-Heteroarylalkylgruppe, einer monovalenten, nicht aromatischen, kondensierten, polycyclischen Gruppe und einer monovalenten, nicht aromatischen, kondensierten, heteropolycyclischen Gruppe.

**2.** Organometallische Verbindung gemäß Anspruch 1, wobei $R_7$ und $R_8$ jeweils unabhängig ausgewählt sind aus:

einem Wasserstoff, einem Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, $-SF_5$, einer $C_1$-$C_{20}$-Alkylgruppe und einer $C_1$-$C_{20}$-Alkoxygruppe;
einer $C_1$-$C_{20}$-Alkylgruppe und einer $C_1$-$C_{20}$-alkoxygruppe, jeweils substituiert mit mindestens einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{10}$-Alkylgruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer cycloheptyl group, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgroup, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe, jeweils substituiert mit mindestens einem ausgewählt aus Deuterium, -F, -Cl, -Br, -I, $-CD_3$, $-CD_2H$, $-CDH_2$, $-CF_3$, $-CF_2H$, $-CFH_2$, einer hydroxyl group, einer cyano group, einer nitro group, einer amino group, einer amidino group, einer hydrazine group, einer hydrazone group, einer Carbonsäuregruppe oder einem Salz davon, einer Schwefelsäuregruppe oder einem Salz davon, einer Phosphorsäuregruppe oder einem Salz davon, einer $C_1$-$C_{20}$-alkyl group, einer $C_1$-$C_{20}$-Alkoxygruppe, einer Cyclo-

pentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenyl gruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe und $-Si(Q_{33})(Q_{34})(Q_{35})$; und
$-N(Q_1)(Q_2)$, $-Si(Q_3)(Q_4)(Q_5)$, $-B(Q_6)(Q_7)$ und $-P(=O)(Q_8)(Q_9)$ und $Q_1$ bis $Q_9$ und $Q_{33}$ bis $Q_{35}$ jeweils unabhängig ausgewählt sind aus:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, and $-CD_2CDH_2$;
einer n-Propylgruppe, einer Iso-Propylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer Iso-Propylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit mindestens einem ausgewählt aus Deuterium, einer $C_1$-$C_{10}$-Alkylgruppe und einer Phenylgruppe;

wobei bevorzugt $R_7$ und $R_8$ jeweils unabhängig ausgewählt sind aus Wasserstoff, Deuterium, -F, einer Cyanogruppe, einer Nitrogruppe, $-SF_5$, $-CH_3$, $-CD_3$, $-CD_2H$, $-CDH_2$, $-CF_3$, $-CF_2H$, $-CFH_2$, $-C_2F_5$, $-C_2F_4H$, $-C_2F_3H_2$, $-C_2F_2H_3$, $-C_2FH_4$, Gruppen, repräsentiert durch Formen 9-1 bis 9-19, Gruppen repräsentiert durch Formen 10-1 bis 10-167, $-N(Q_1)(Q_2)$, $-Si(Q_3)(Q_4)(Q_5)$, - $B(Q_6)(Q_7)$ und $-P(=O)(Q_8)(Q_9)$:

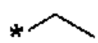
Formel 9-1

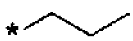
Formel 9-2

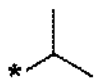
Formel 9-3

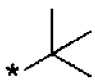
Formel 9-4

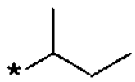
Formel 9-5

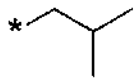
Formel 9-6

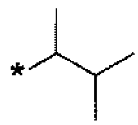
Formel 9-7

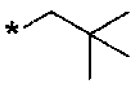
Formel 9-8

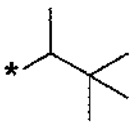
Formel 9-9

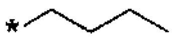
Formel 9-10

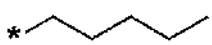
Formel 9-11

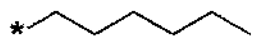
Formel 9-12

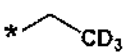
Formel 9-13

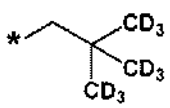
Formel 9-14

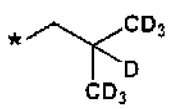
Formel 9-15

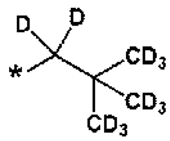
Formel 9-16

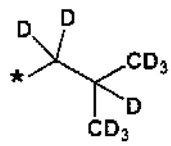
Formel 9-17

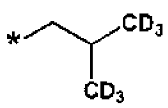
Formel 9-18

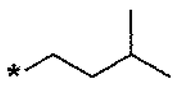
Formel 9-19

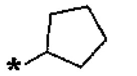
Formel 10-1

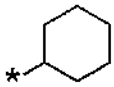
Formel 10-2

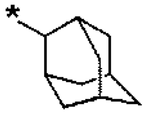
Formel 10-3

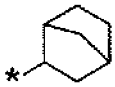
Formel 10-4

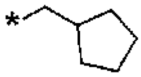
Formel 10-5

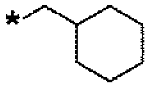
Formel 10-6

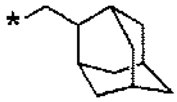
Formel 10-7

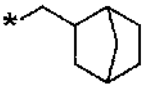
Formel 10-8

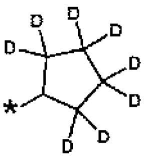
Formel 10-9

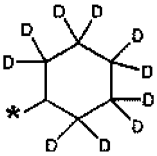
Formel 10-10

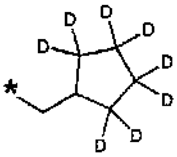
Formel 10-11

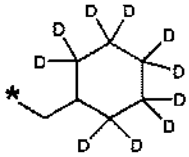
Formel 10-12

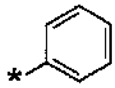
Formel 10-13

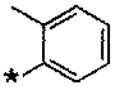
Formel 10-14

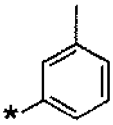
Formel 10-15

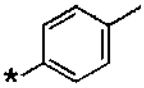
Formel 10-16

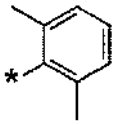
Formel 10-17

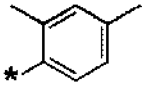
Formel 10-18

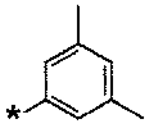
Formel 10-19

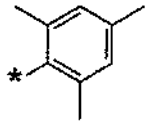
Formel 10-20

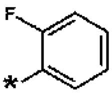
Formel 10-21

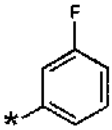
Formel 10-22

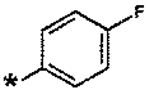
Formel 10-23

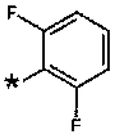
Formel 10-24

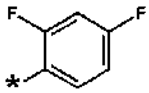
Formel 10-25

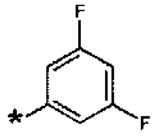
Formel 10-26

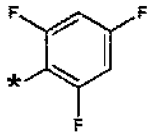
Formel 10-27

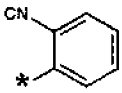
Formel 10-28

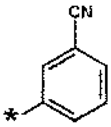
Formel 10-29

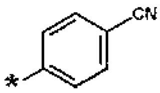
Formel 10-30

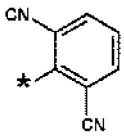
Formel 10-31

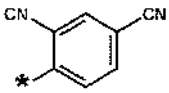
Formel 10-32

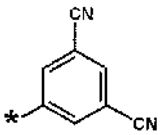
Formel 10-33

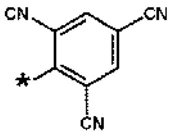
Formel 10-34

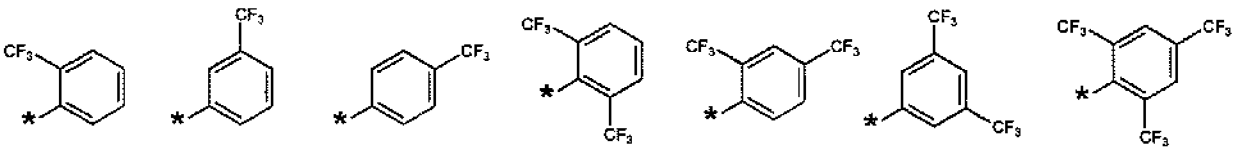
Formel 10-35 Formel 10-36 Formel 10-37 Formel 10-38 Formel 10-39 Formel 10-40 Formel 10-41

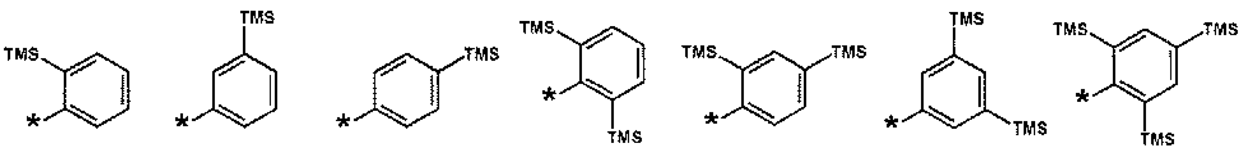
Formel 10-42 Formel 10-43 Formel 10-44 Formel 10-45 Formel 10-46 Formel 10-47 Formel 10-48

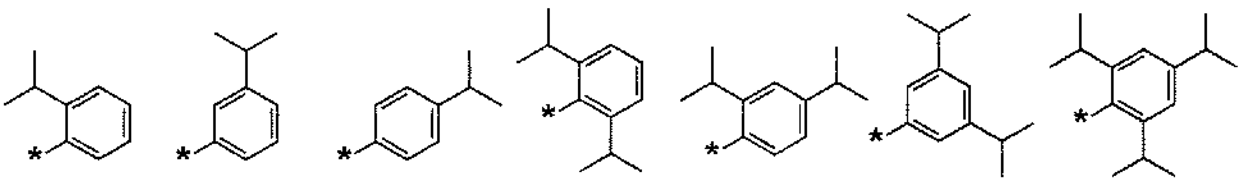
Formel 10-49 Formel 10-50 Formel 10-51 Formel 10-52 Formel 10-53 Formel 10-54 Formel 10-55

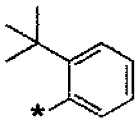
Formel 10-56
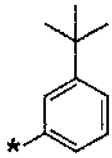
Formel 10-57
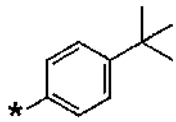
Formel 10-58
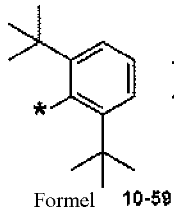
Formel 10-59
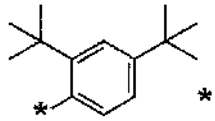
Formel 10-60
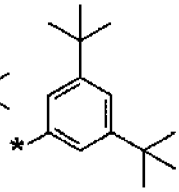
Formel 10-61
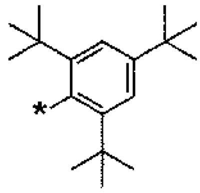
Formel 10-62

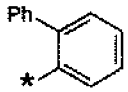
Formel 10-63
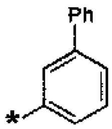
Formel 10-64
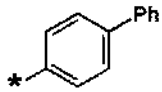
Formel 10-65
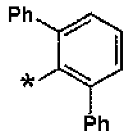
Formel 10-66
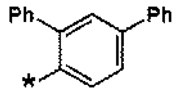
Formel 10-67
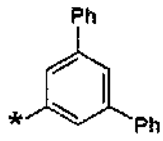
Formel 10-68
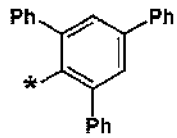
Formel 10-69

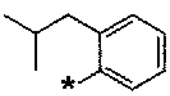
Formel 10-70
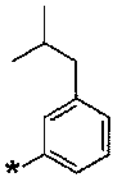
Formel 10-71
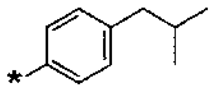
Formel 10-72
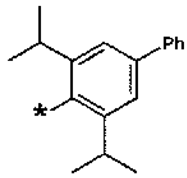
Formel 10-73
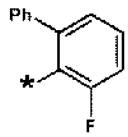
Formel 10-74
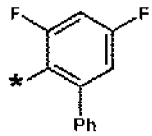
Formel 10-75

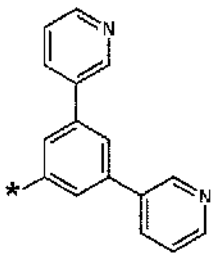
Formel 10-76
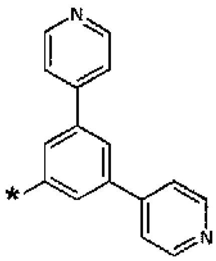
Formel 10-77
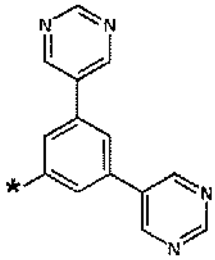
Formel 10-78
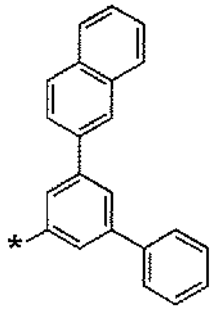
Formel 10-79
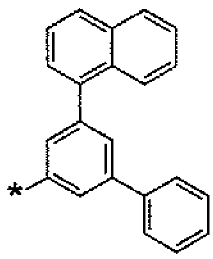
Formel 10-80

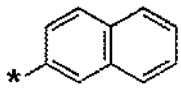
Formel 10-81
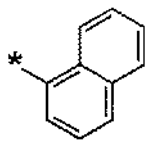
Formel 10-82
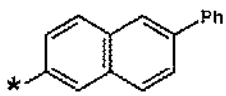
Formel 10-83
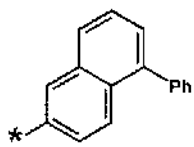
Formel 10-84
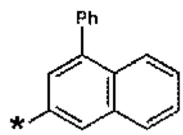
Formel 10-85

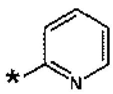
Formel 10-86
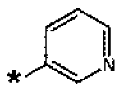
Formel 10-87
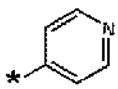
Formel 10-88
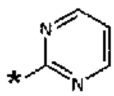
Formel 10-89
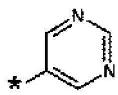
Formel 10-90
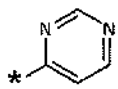
Formel 10-91
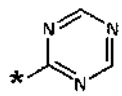
Formel 10-92

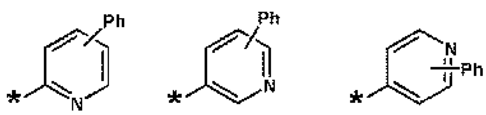
Formel 10-93 Formel 10-94 Formel 10-95
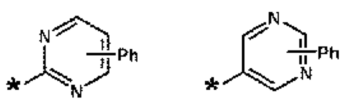
Formel 10-96 Formel 10-97
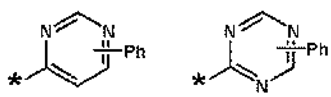
Formel 10-98 Formel 10-99

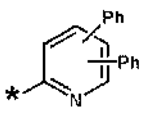 Formel 10-100 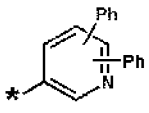 Formel 10-101 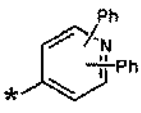 Formel 10-102 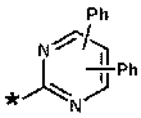 Formel 10-103 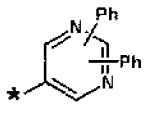 Formel 10-104 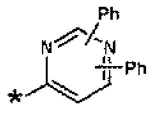 Formel 10-105 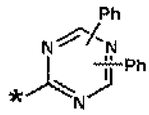 Formel 10-106

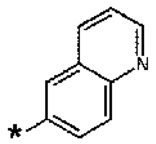 Formel 10-107 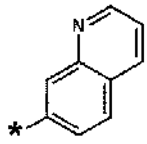 Formel 10-108 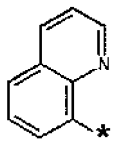 Formel 10-109 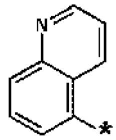 Formel 10-110 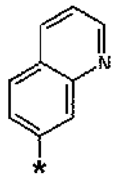 Formel 10-111 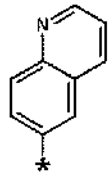 Formel 10-112

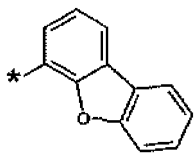 Formel 10-113 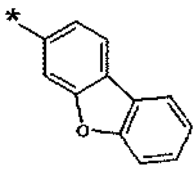 Formel 10-114 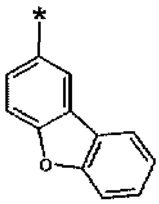 Formel 10-115 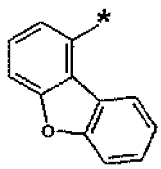 Formel 10-116 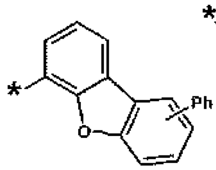 Formel 10-117 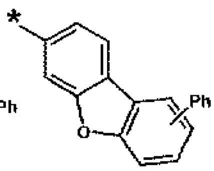 Formel 10-118

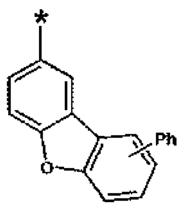 Formel 10-119 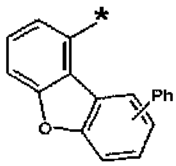 Formel 10-120 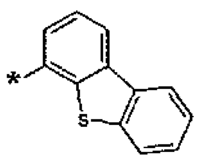 Formel 10-121 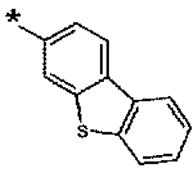 Formel 10-122 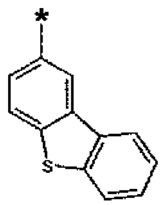 Formel 10-123 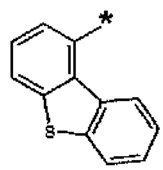 Formel 10-124

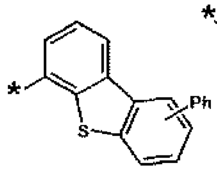 Formel 10-125 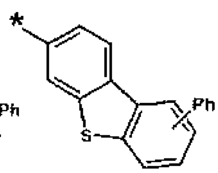 Formel 10-126 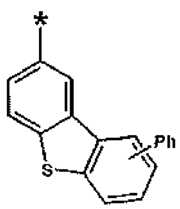 Formel 10-127 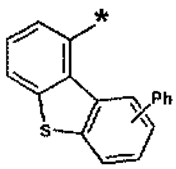 Formel 10-128 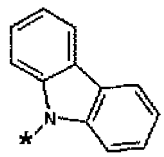 Formel 10-129 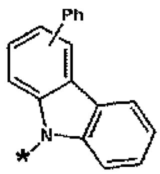 Formel 10-130

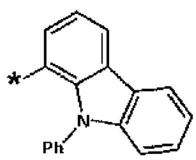 Formel 10-131 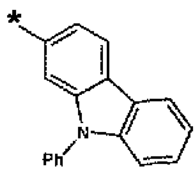 Formel 10-132 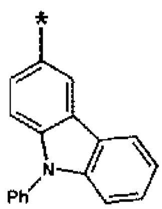 Formel 10-133 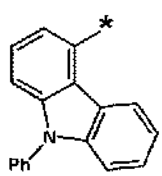 Formel 10-134 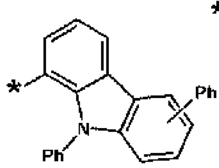 Formel 10-135 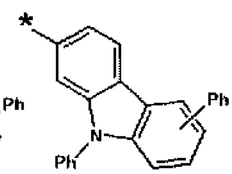 Formel 10-136

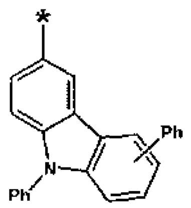 Formel 10-137 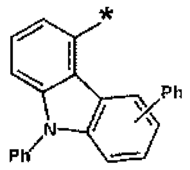 Formel 10-138 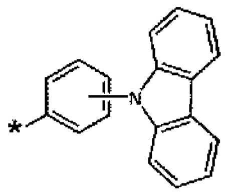 Formel 10-139 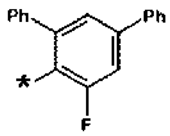 Formel 10-140 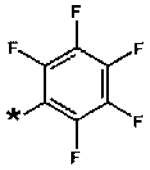 Formel 10-141 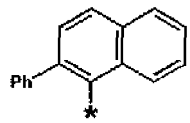 Formel 10-142

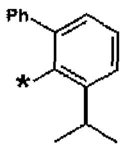 Formel 10-143 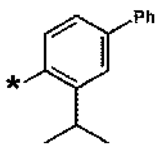 Formel 10-144 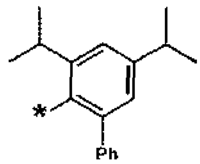 Formel 10-145 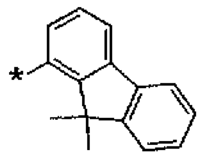 Formel 10-146 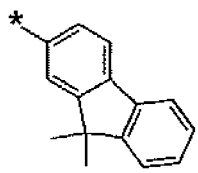 Formel 10-147 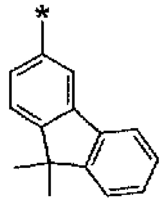 Formel 10-148

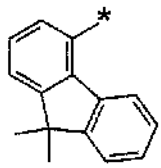 Formel 10-149 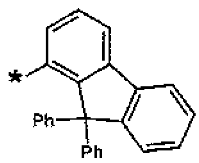 Formel 10-150 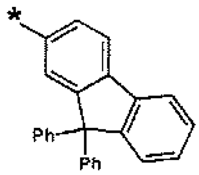 Formel 10-151 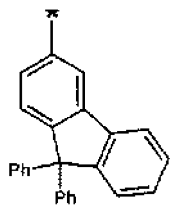 Formel 10-152 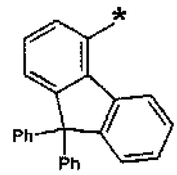 Formel 10-153

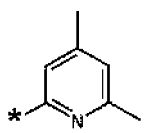 Formel 10-154 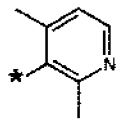 Formel 10-155 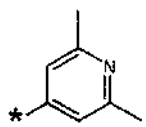 Formel 10-156 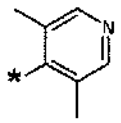 Formel 10-157 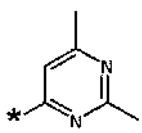 Formel 10-158 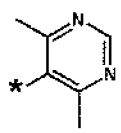 Formel 10-159 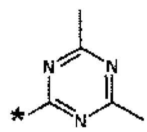 Formel 10-160

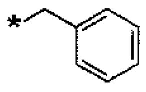 Formel 10-161 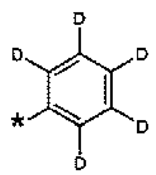 Formel 10-162 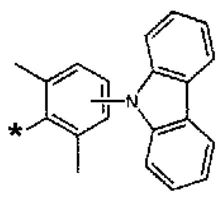 Formel 10-163 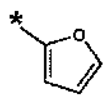 Formel 10-164 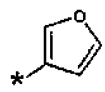 Formel 10-165 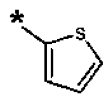 Formel 10-166 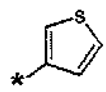 Formel 10-167,

$Q_1$ bis $Q_9$ jeweils unabhängig ausgewählt sind aus:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$ und $-CD_2CDH_2$;

einer n-Propylgruppe, einer Iso-Propylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und

einer n-Propylgruppe, einer Iso-Propylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit mindestens einem ausgewählt aus Deuterium, einer $C_1$-$C_{10}$-Alkylgruppe und einer Phenylgruppe, und in Formeln 9-1 bis 9-19 und 10-1 bis 10-167,

gibt * eine Bindungsstelle an einem benachbarten Atom an;
gibt Ph eine Phenylgruppe an; und
Gibt TMS eine Trimethylsilylgruppe an.

**3.** Organometallische Verbindung gemäß den Ansprüchen 1 oder 2, wobei

i) die zwei Bindungen von $X_{51}$, angegeben durch eine gestrichelte Linie, jeweils eine Einzelbindung sind und $X_{51}$ $C(R_7)(R_8)$, $Si(R_7)(R_8)$ oder $C(=O)$ ist,
ii) die zwei Bindungen von $X_{51}$, angegeben durch eine gestrichelte Linie, jeweils eine Einzelbindung sind, $X_{51}$ $N-[(L_7)_{b7}-(R_7)_{c7}]$ ist und $R_7$ ausgewählt ist aus einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_2$-$C_{60}$-Heteroaryloxygruppe, einer substituierten oder unsubstituierten $C_2$-$C_{60}$-Heteroarylthiogruppe, einer substituierten oder unsubstituierten $C_3$-$C_{60}$-Heteroarylalkylgruppe, einer substituierten oder unsubstituierten, monovalenten, nicht aromatischen, kondensierten, polycyclischen Gruppe und einer substituierten oder unsubstituierten, monovalenten, nicht aromatischen, kondensierten, heteropolycyclischen Gruppe, oder
iii) von den zwei Bindungen von $X_{51}$, angegeben durch eine gestrichelte Linie, eine eine Einzelbindung ist, während die andere Bindung davon eine Doppelbindung ist, und $X_{51}$ N, $C(R_7)$ oder $Si(R_7)$ ist.

**4.** Organometallische Verbindung gemäß einem der Ansprüche 1-3, wobei $X_{51}$ O, S oder $N-[(L_7)_{b7}-(R_7)_{c7}]$ ist, b7 0 ist, c7 1 ist, $R_7$ ausgewählt ist aus:

einer $C_1$-$C_{30}$-Alkylgruppe; und
einer $C_1$-$C_{30}$-Alkylgruppe, substituiert mit mindestens einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe.

**5.** Organometallische Verbindung gemäß einem der Ansprüche 1-4, wobei die organometallische Verbindung eine ist, die ausgewählt ist aus den Verbindungen 1-1 bis 1-88, Verbindungen 2-1 bis 2-47 und Verbindungen 3-1 bis 3-582:

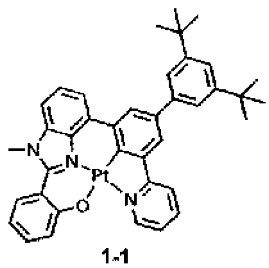
1-1

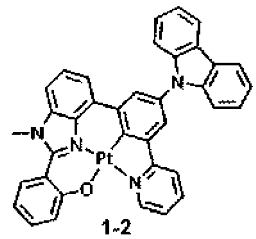
1-2

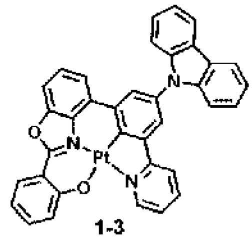
1-3

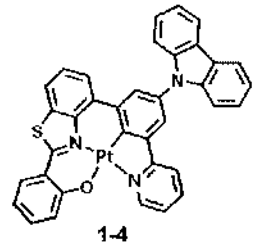
1-4

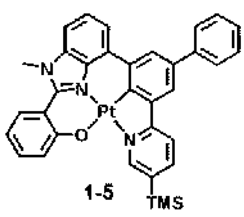
1-5

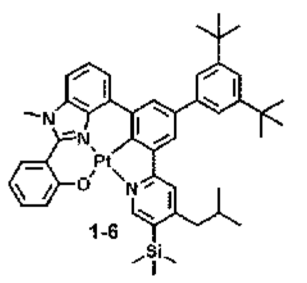
1-6

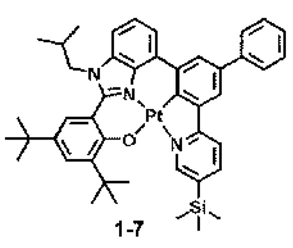
1-7

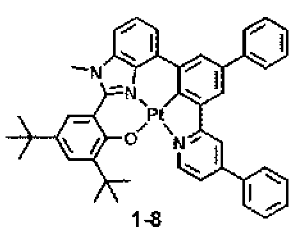
1-8

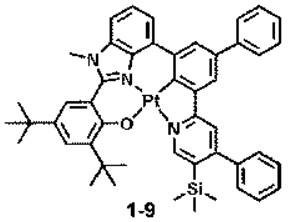
1-9

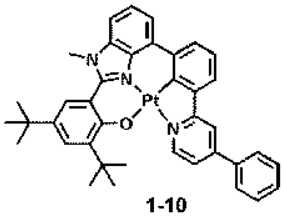
1-10

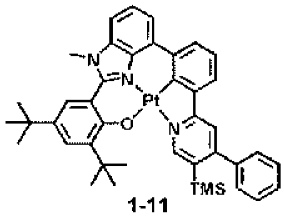
1-11

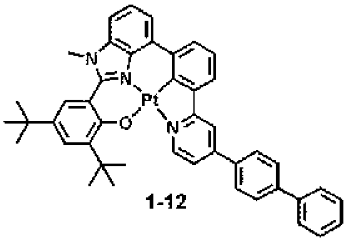
1-12

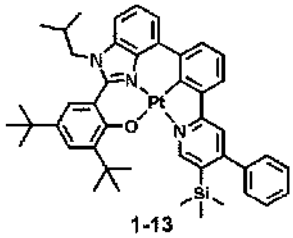
1-13

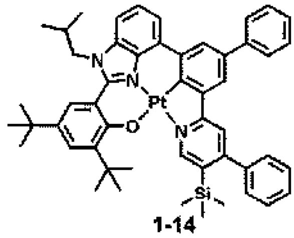
1-14

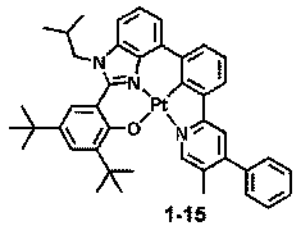
1-15

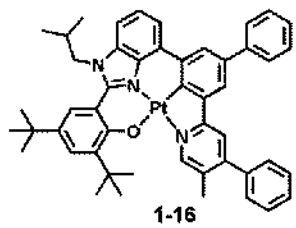
1-16

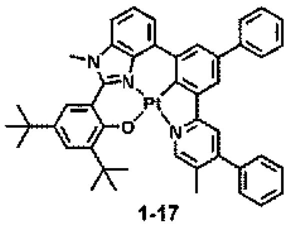
1-17

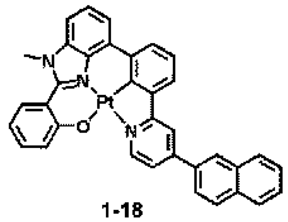
1-18

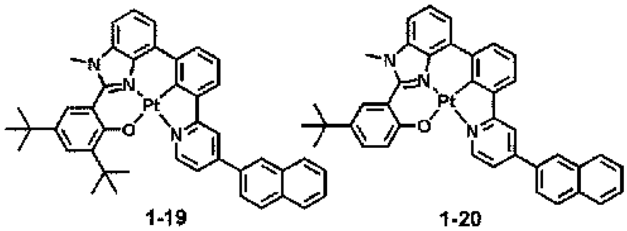
1-19

1-20

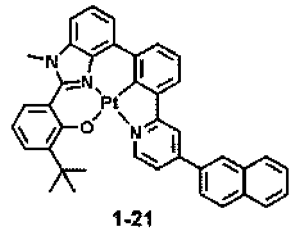
1-21

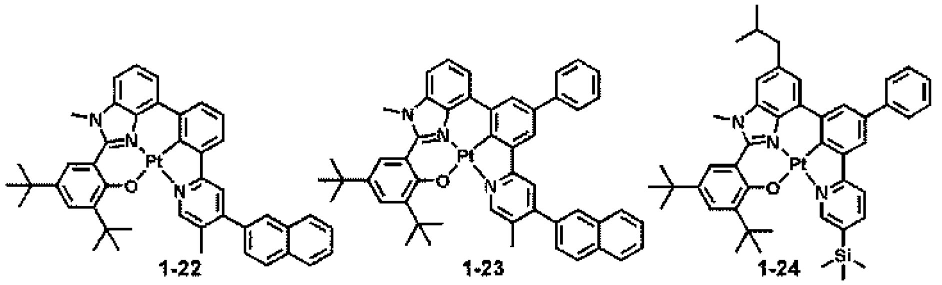
1-22

1-23

1-24

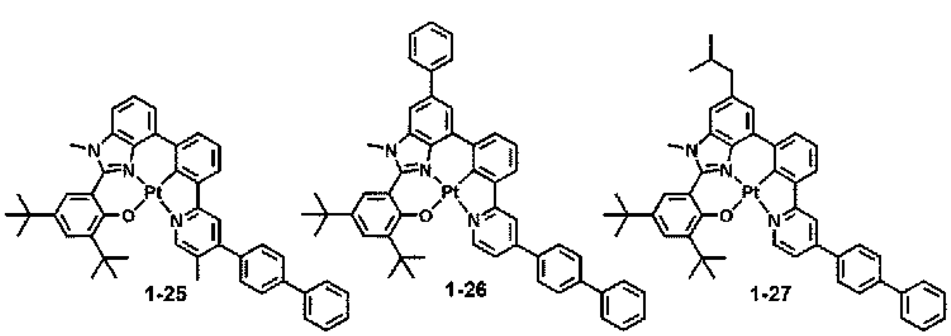
1-25

1-26

1-27

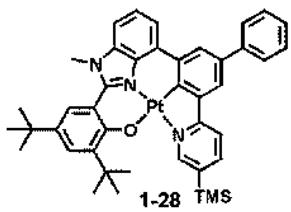
1-28

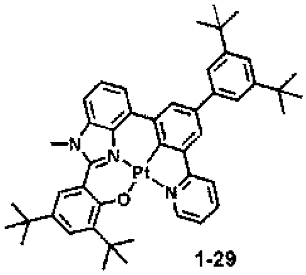
1-29

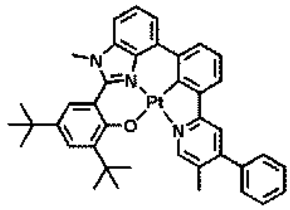
1-30

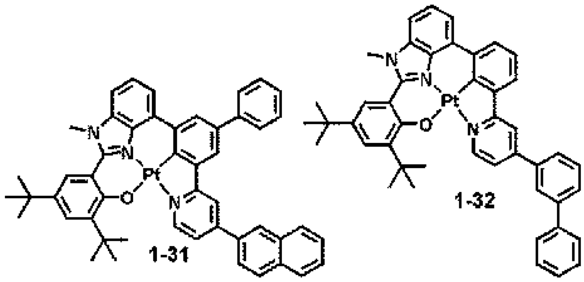
1-31

1-32

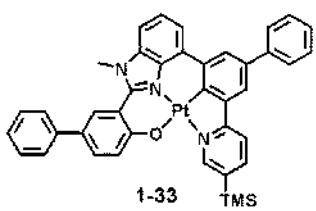
1-33

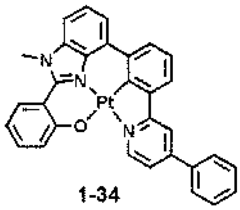
1-34

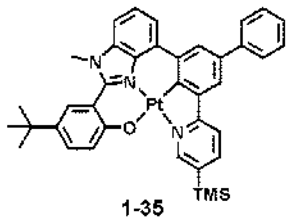
1-35

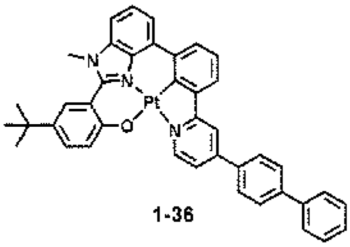
1-36

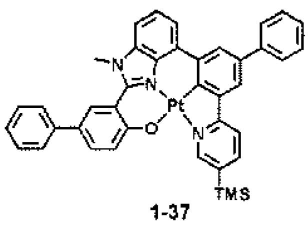
1-37

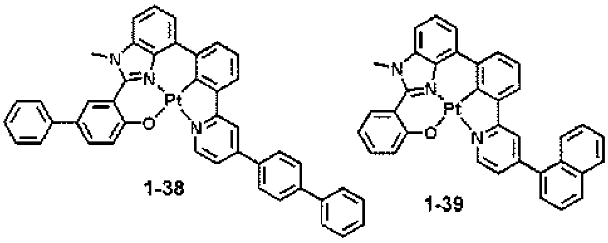
1-38

1-39

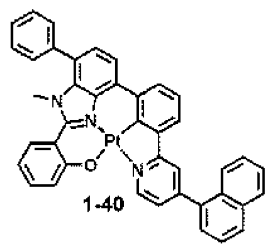
1-40

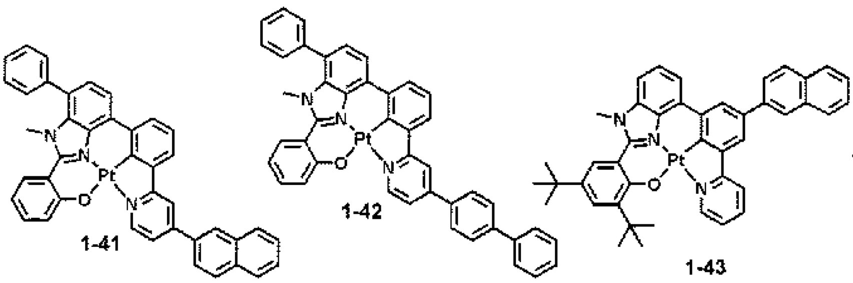
1-41

1-42

1-43

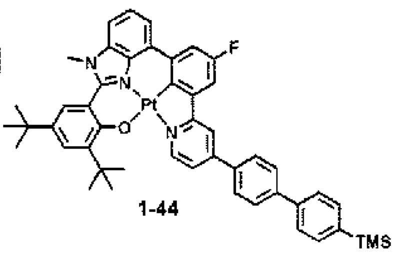
1-44

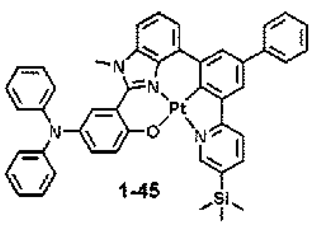
1-45

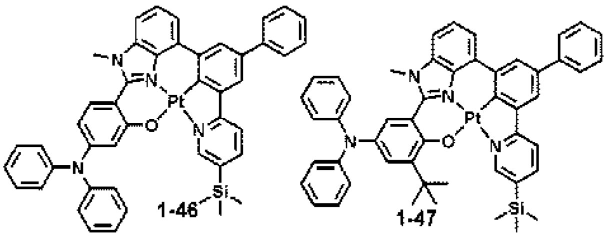
1-46

1-47

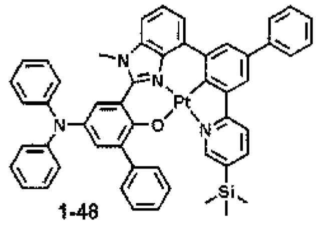
1-48

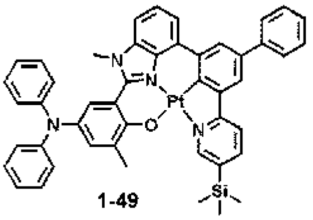
1-49

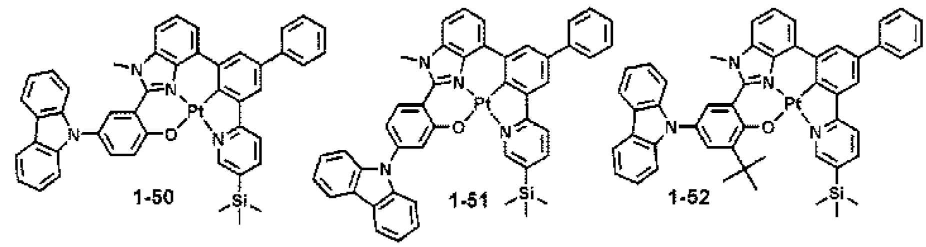
1-50

1-51

1-52

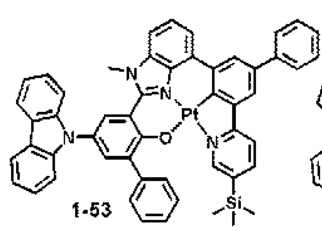
1-53

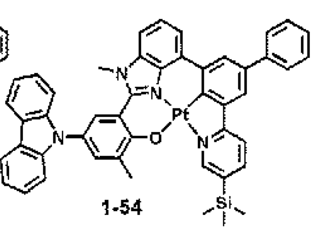
1-54

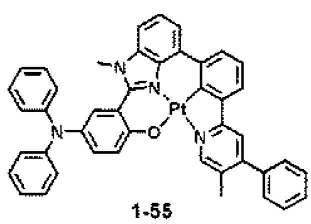
1-55

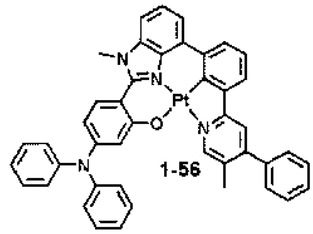
1-56

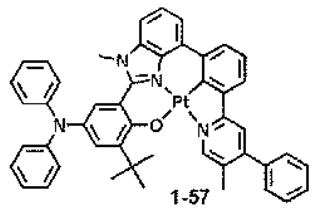
1-57

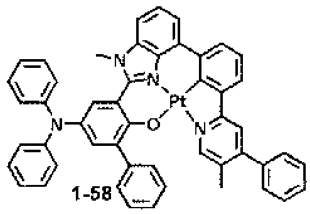
1-58

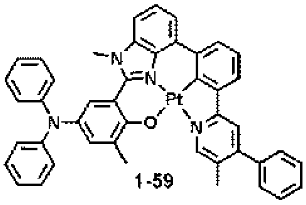
1-59

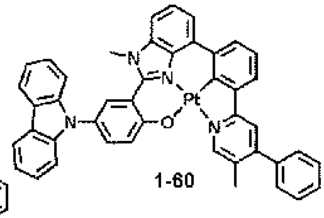
1-60

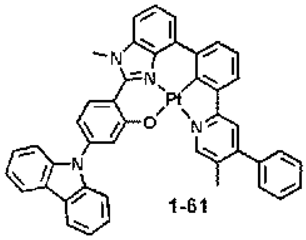
1-61

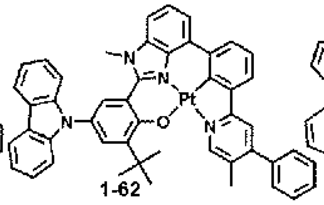
1-62

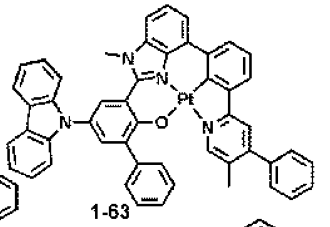
1-63

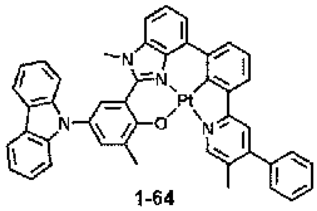
1-64

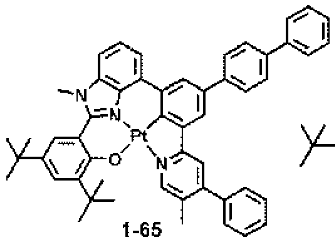
1-65

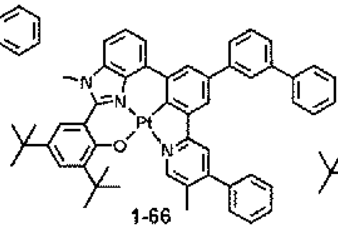
1-66

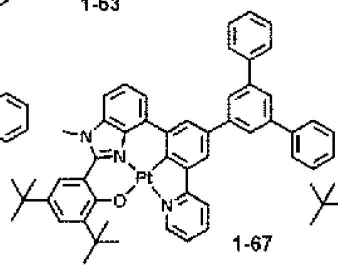
1-67

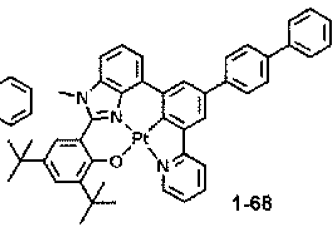
1-68

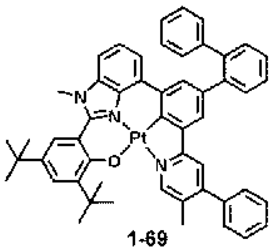
1-69

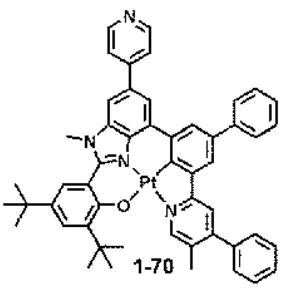
1-70

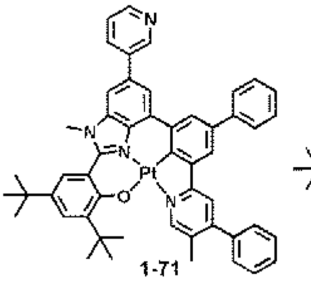
1-71

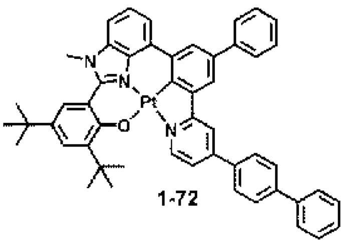
1-72

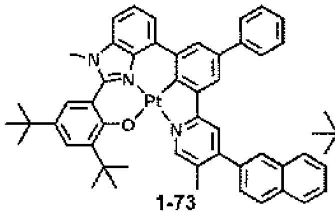
1-73

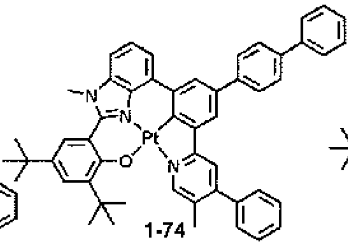
1-74

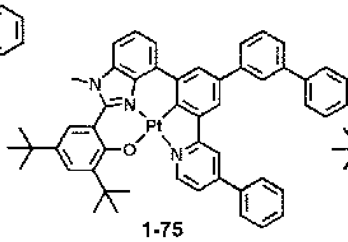
1-75

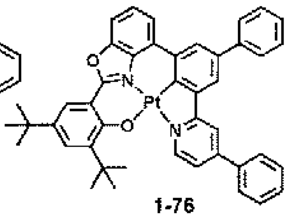
1-76

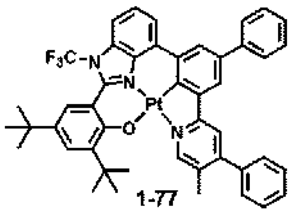
1-77

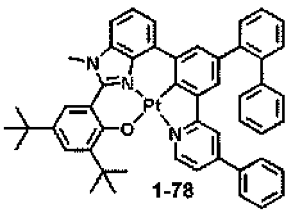
1-78

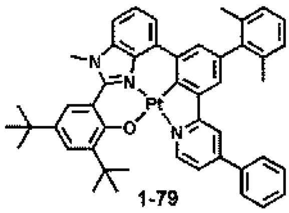
1-79

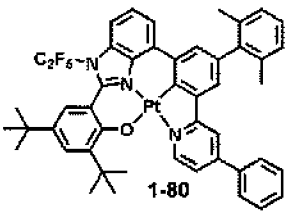
1-80

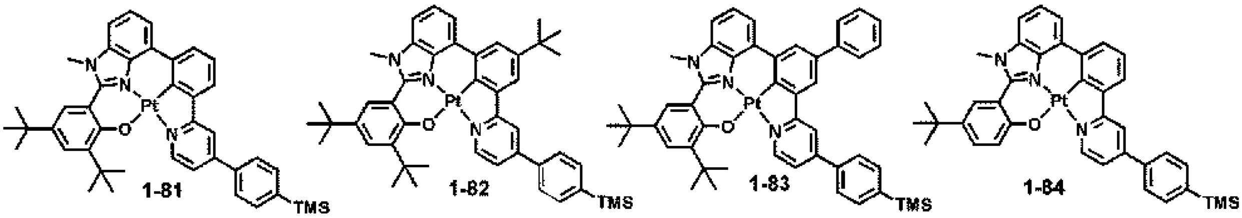
1-81 1-82 1-83 1-84

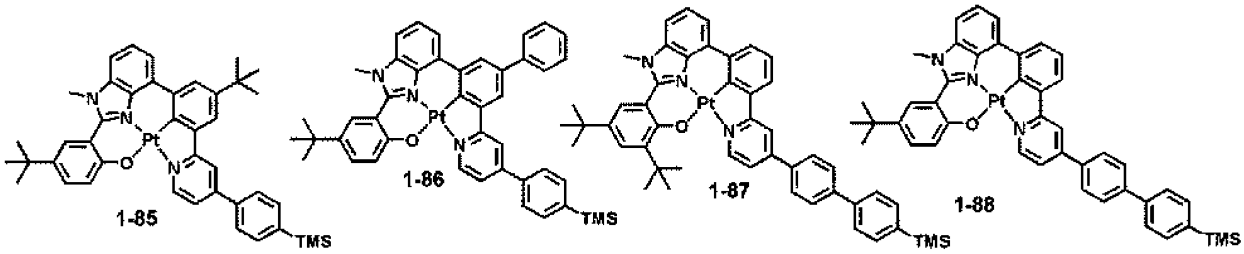
1-85 1-86 1-87 1-88

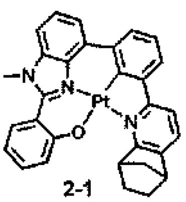
2-1

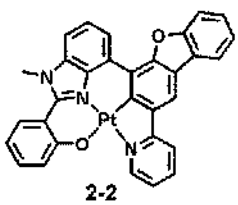
2-2

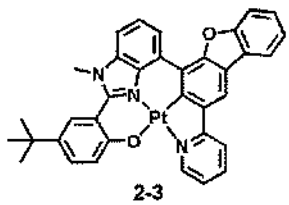
2-3

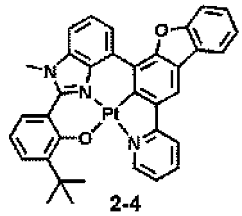
2-4

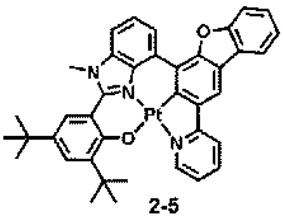
2-5

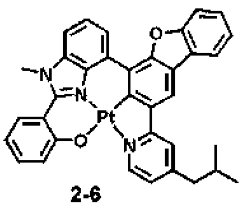
2-6

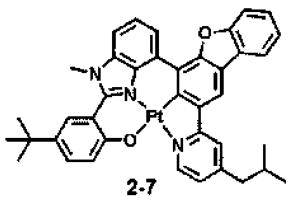
2-7

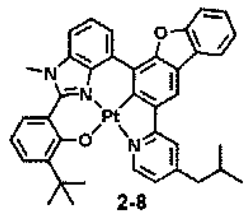
2-8

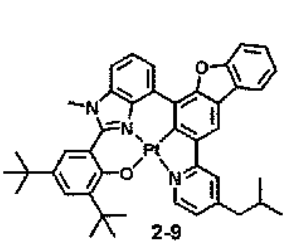
2-9

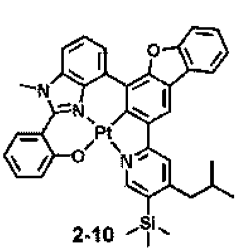
2-10

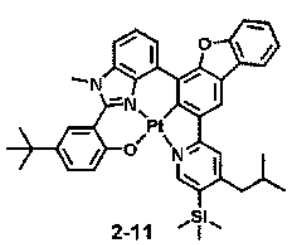
2-11

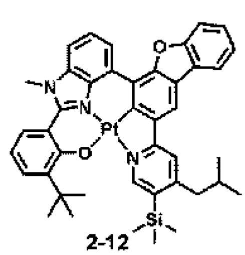
2-12

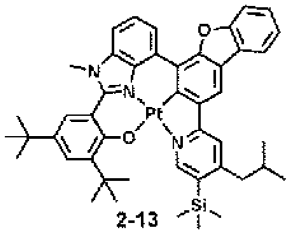
2-13

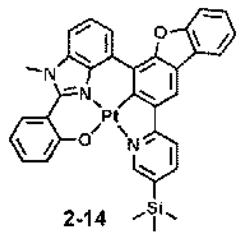
2-14

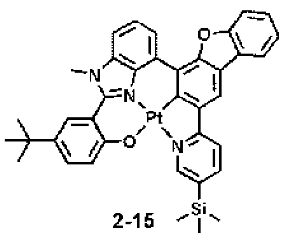
2-15

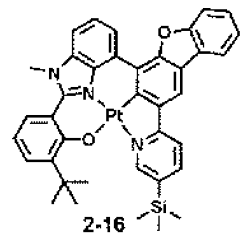
2-16

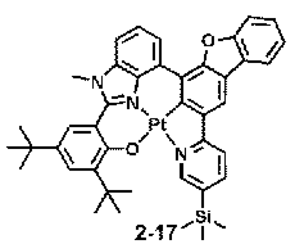
2-17

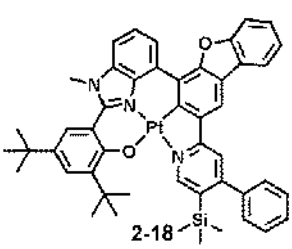
2-18

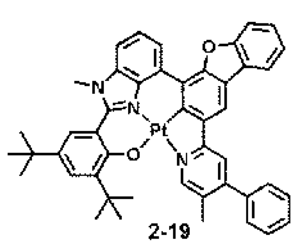
2-19

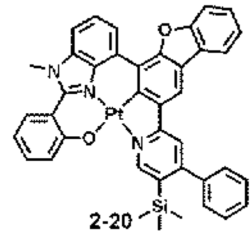
2-20

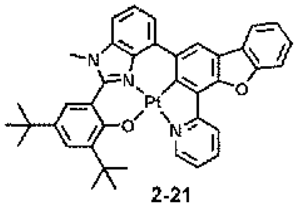
2-21

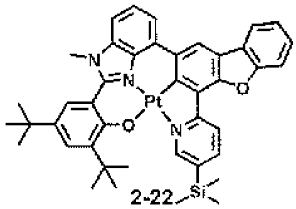
2-22

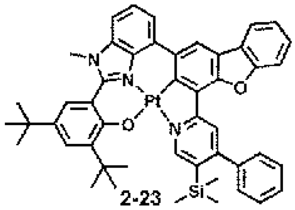
2-23

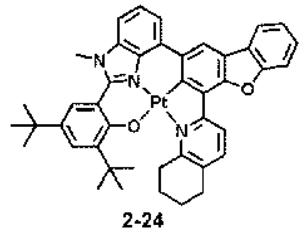
2-24

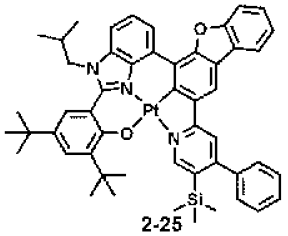
2-25

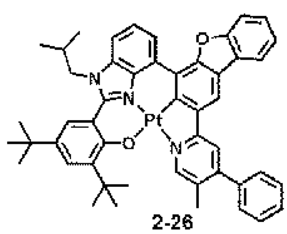
2-26

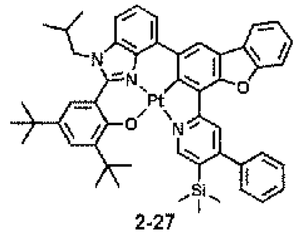
2-27

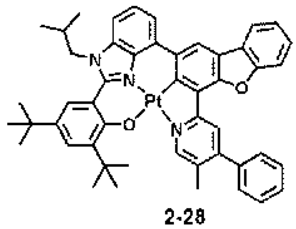
2-28

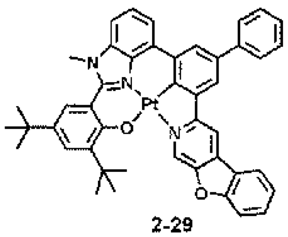
2-29

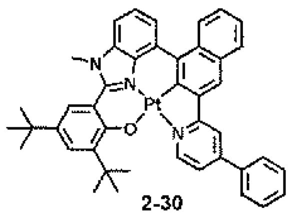
2-30

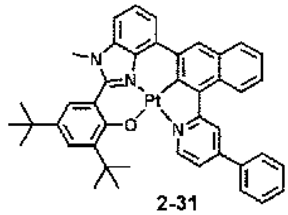
2-31

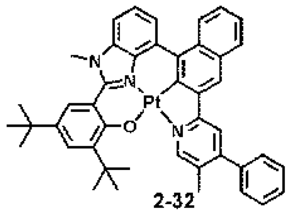
2-32

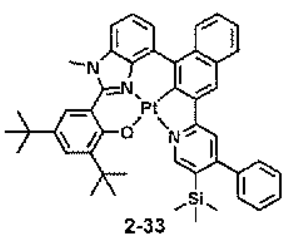
2-33

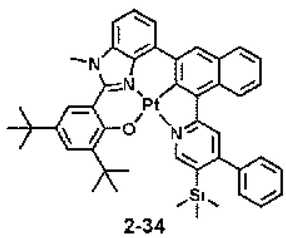
2-34

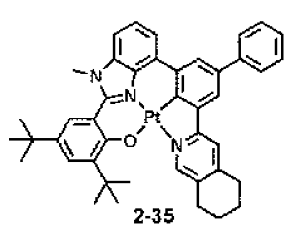
2-35

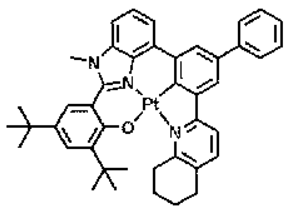
2-36

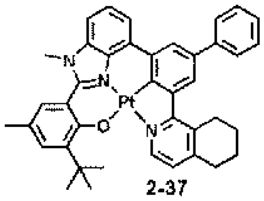
2-37

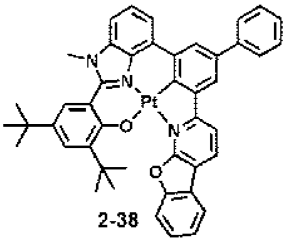
2-38

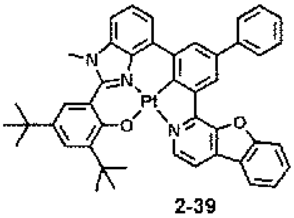
2-39

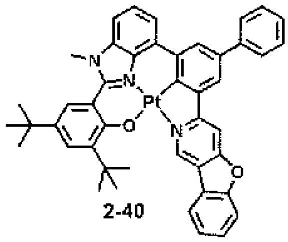
2-40

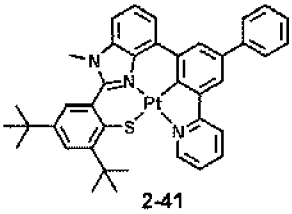
2-41

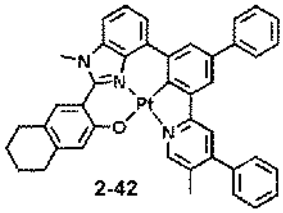
2-42

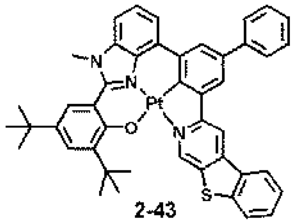
2-43

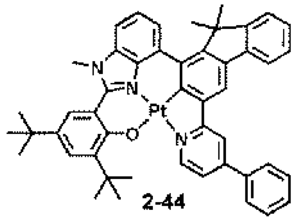
2-44

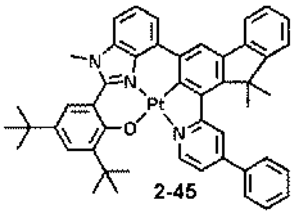
2-45

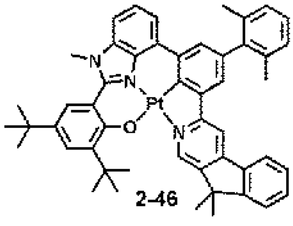
2-46

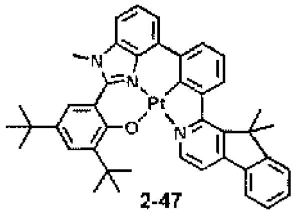
2-47

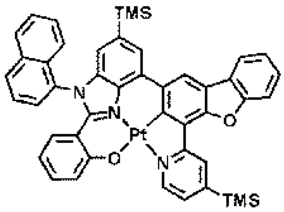
3-1

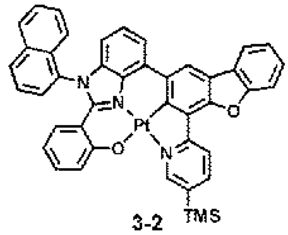
3-2

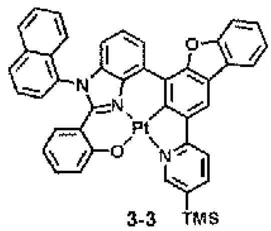
3-3

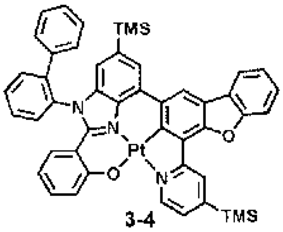
3-4

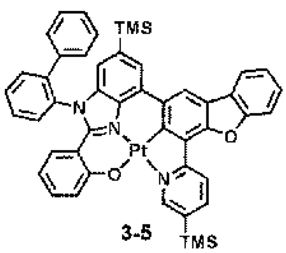
3-5

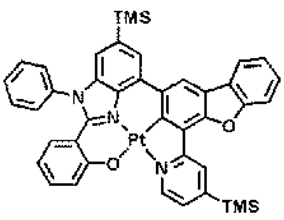
3-6

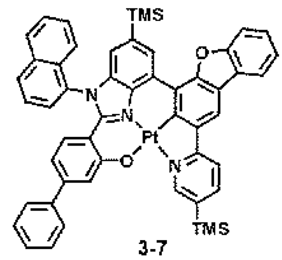
3-7

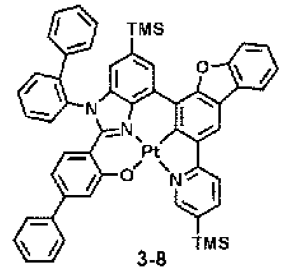
3-8

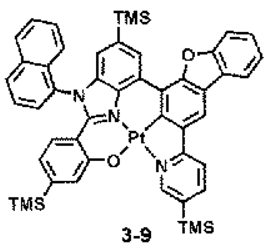
3-9

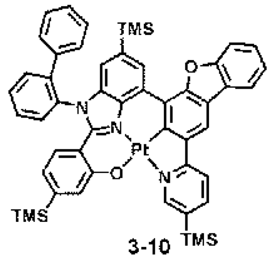
3-10

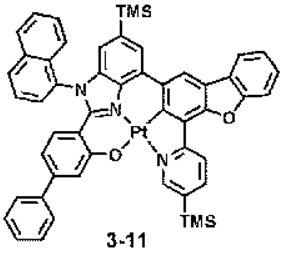
3-11

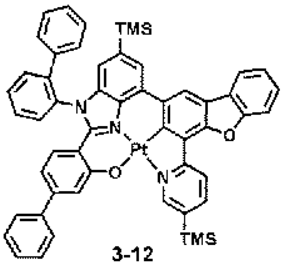
3-12

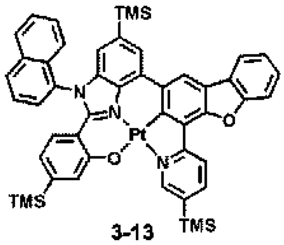
3-13

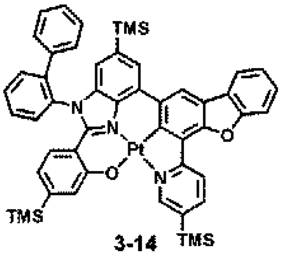
3-14

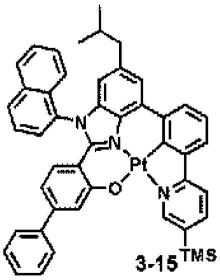
3-15

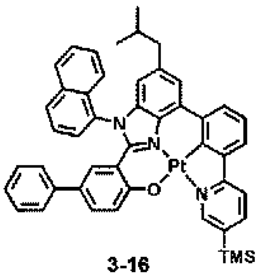
3-16

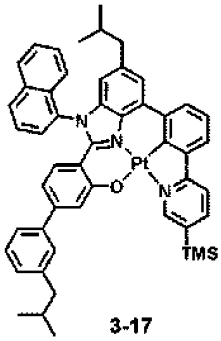
3-17

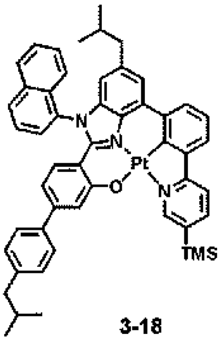
3-18

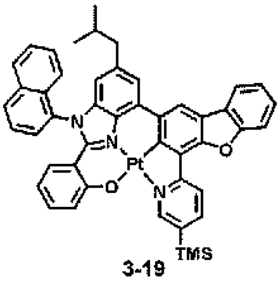
3-19

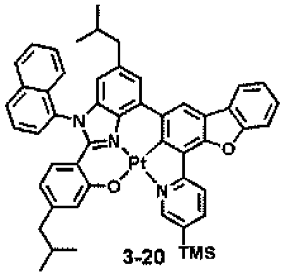
3-20

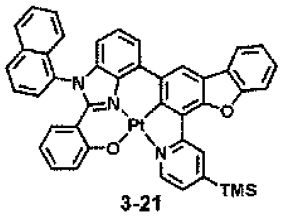
3-21

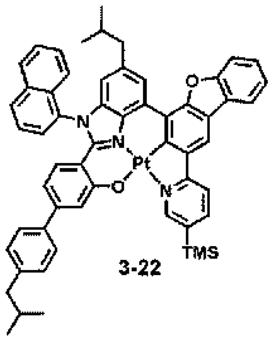
3-22

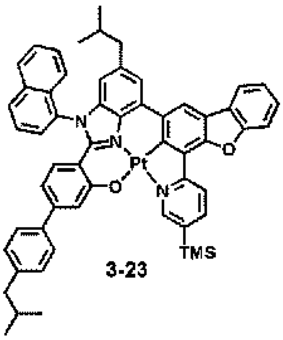
3-23

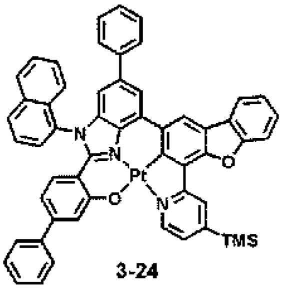
3-24

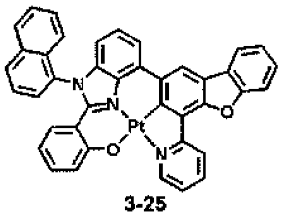
3-25

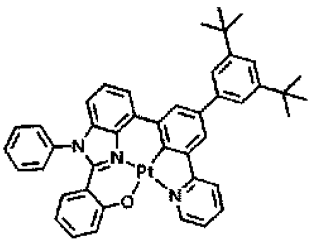
3-26

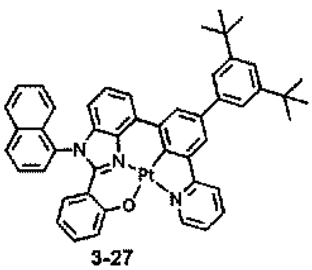
3-27

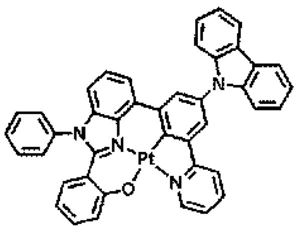
3-28

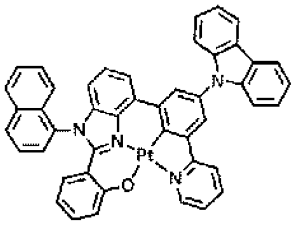
3-29

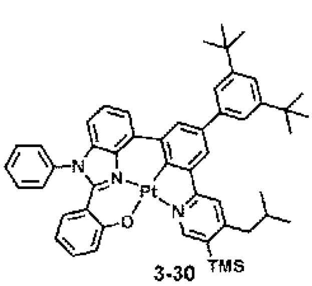
3-30

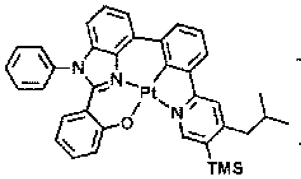
3-31

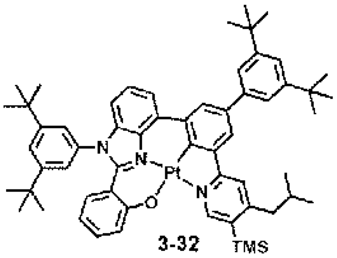
3-32

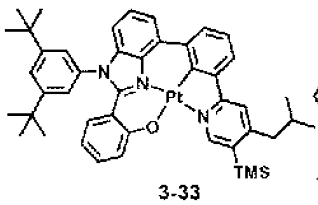
3-33

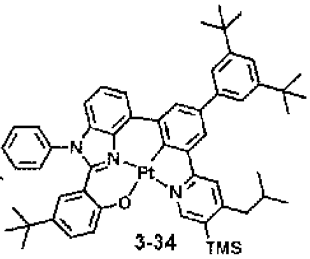
3-34

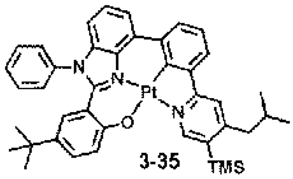
3-35

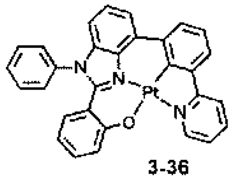
3-36

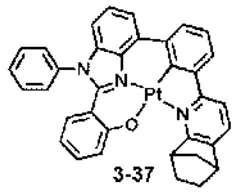
3-37

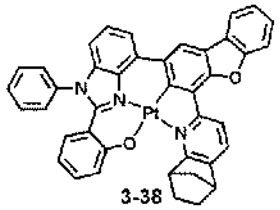
3-38

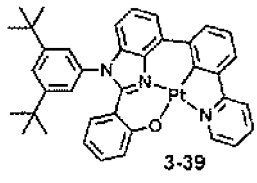
3-39

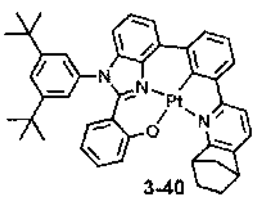
3-40

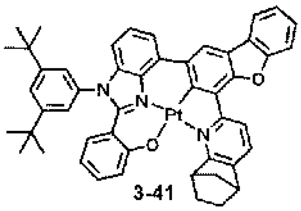
3-41

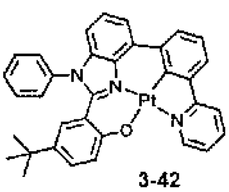
3-42

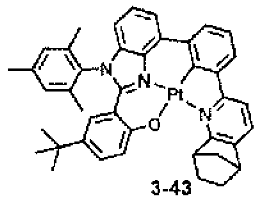
3-43

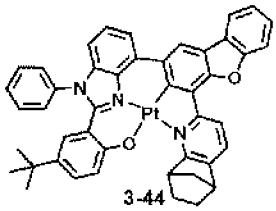
3-44

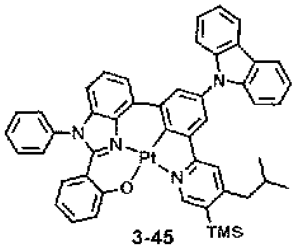
3-45

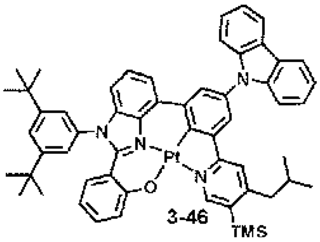
3-46

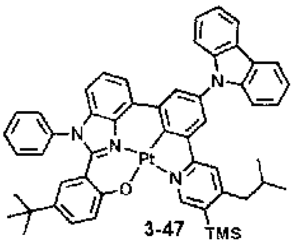
3-47

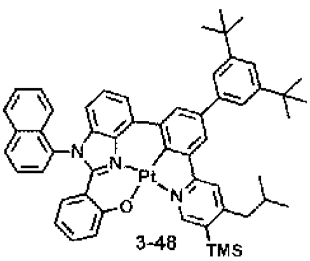
3-48

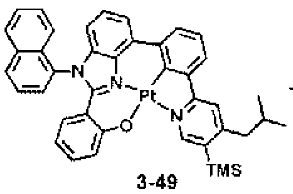
3-49

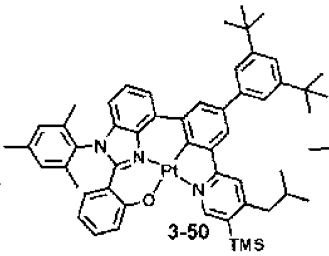
3-50

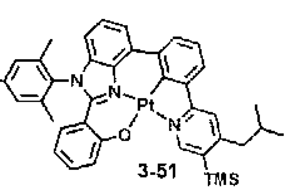
3-51

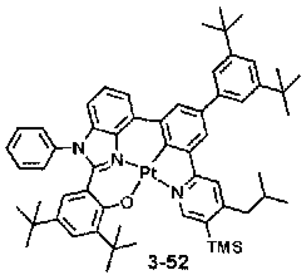
3-52

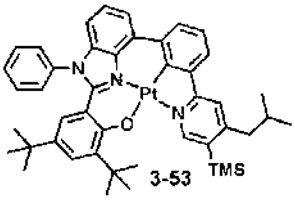
3-53

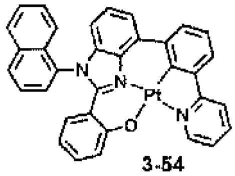
3-54

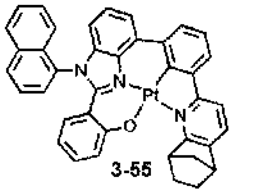
3-55

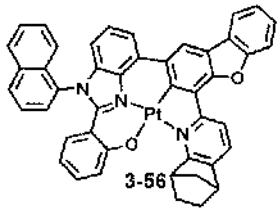
3-56

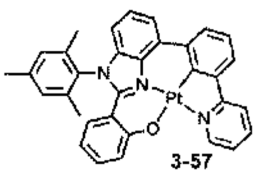
3-57

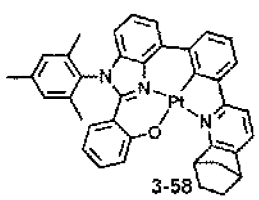
3-58

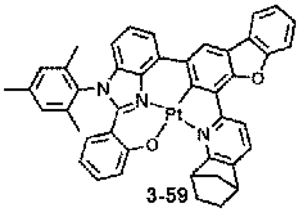
3-59

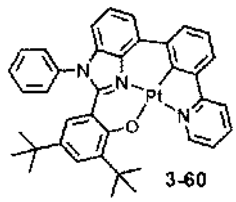
3-60

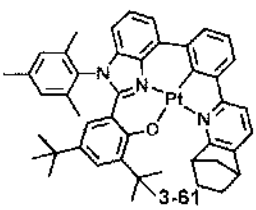
3-61

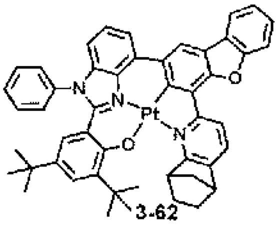
3-62

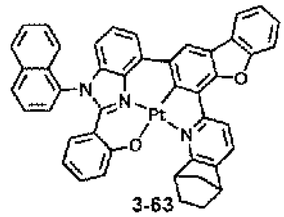
3-63

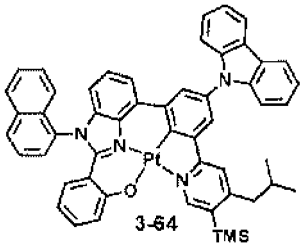
3-64

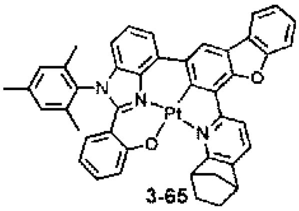
3-65

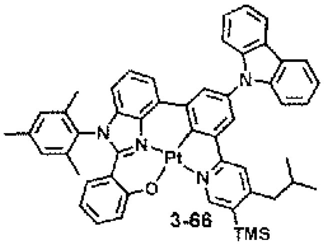
3-66

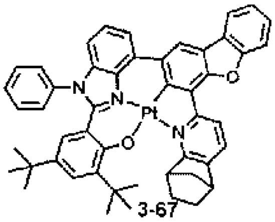
3-67

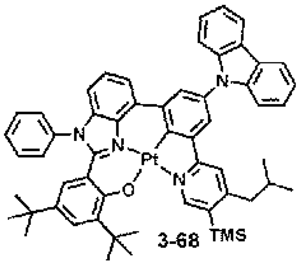
3-68

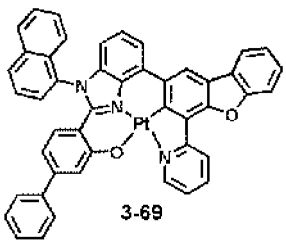
3-69

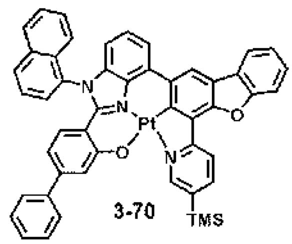
3-70

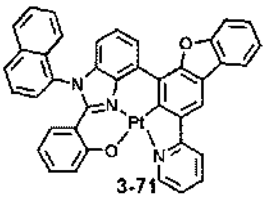
3-71

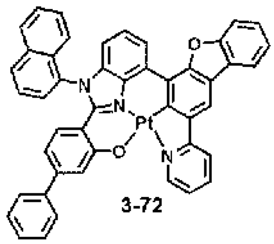
3-72

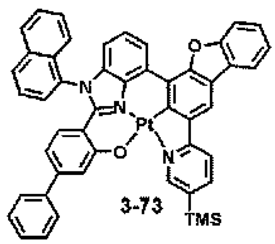
3-73

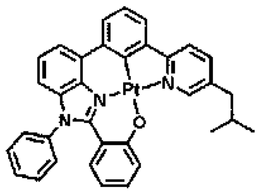
3-74

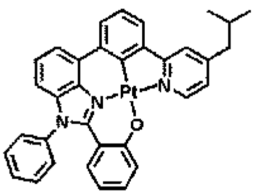
3-75

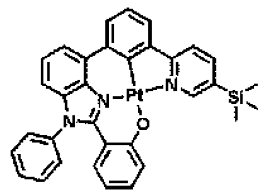
3-76

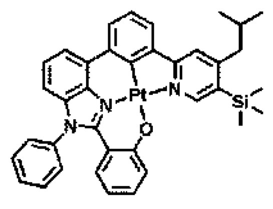
3-77

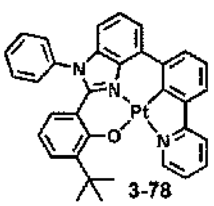
3-78

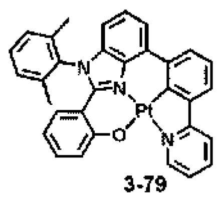
3-79

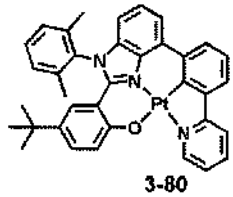
3-80

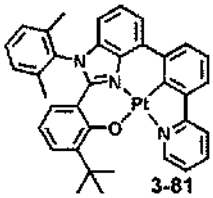
3-81

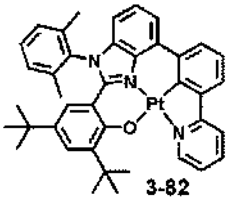
3-82

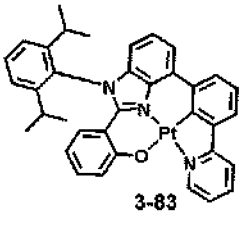
3-83

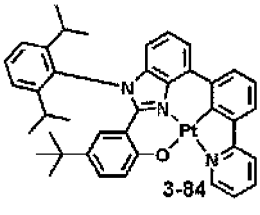
3-84

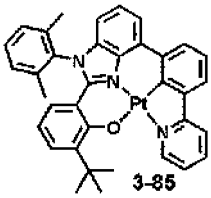
3-85

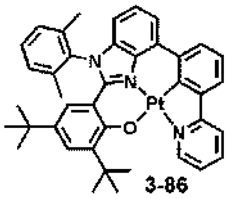
3-86

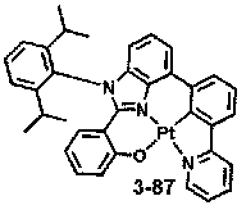
3-87

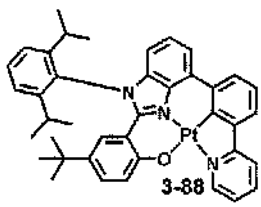
3-88

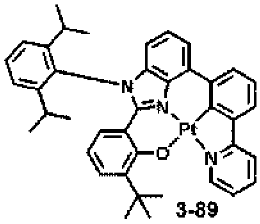
3-89

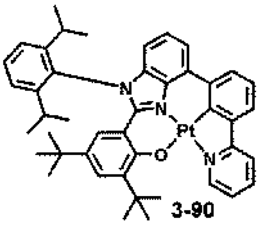
3-90

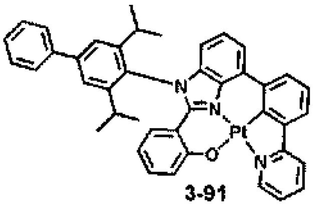
3-91

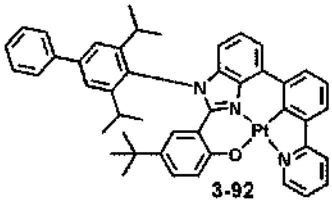
3-92

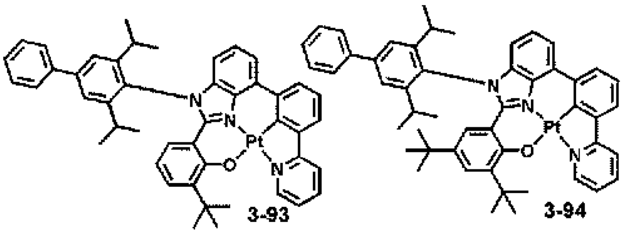
3-93

3-94

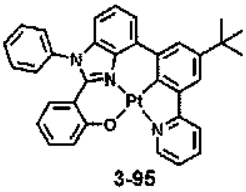
3-95

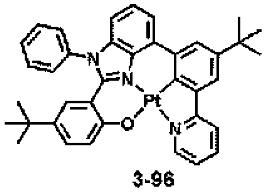
3-96

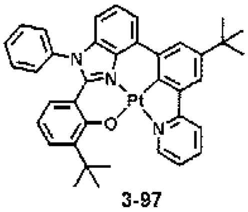
3-97

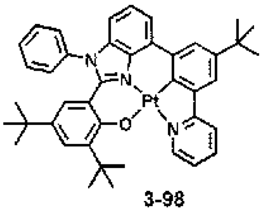
3-98

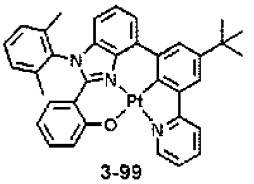
3-99

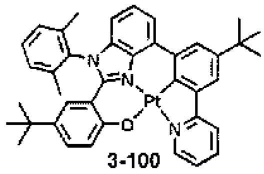
3-100

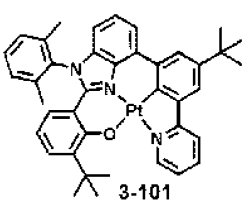
3-101

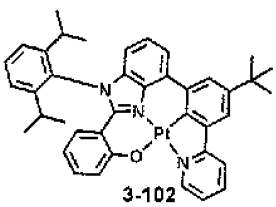
3-102

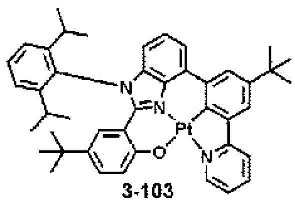
3-103

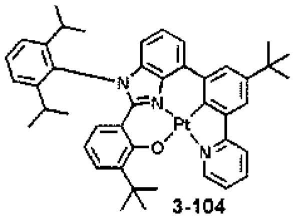
3-104

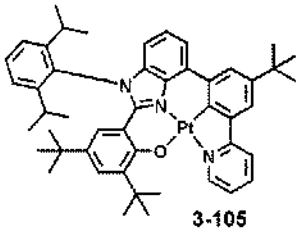

3-105

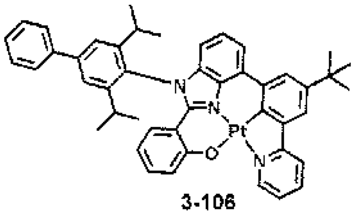

3-106

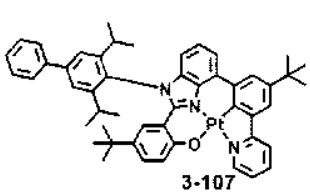

3-107

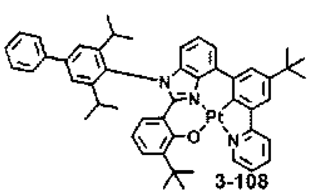

3-108

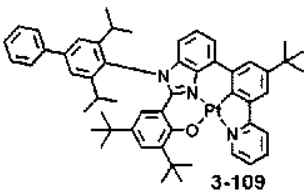

3-109

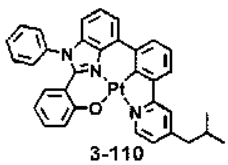

3-110

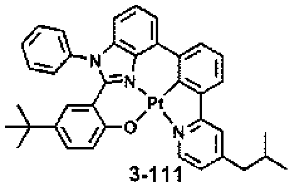

3-111

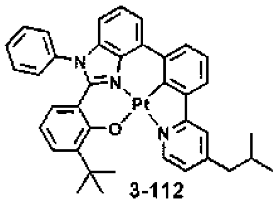

3-112

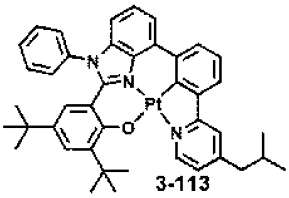

3-113

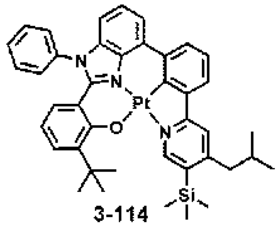

3-114

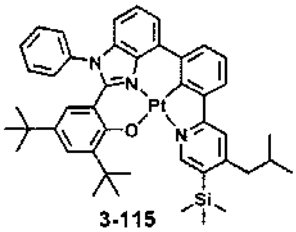

3-115

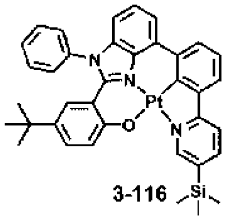

3-116

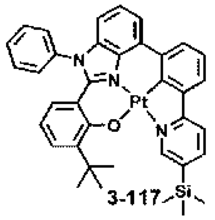

3-117

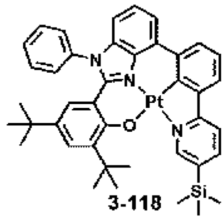

3-118

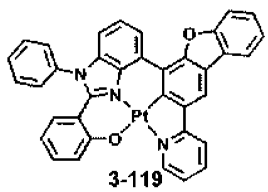

3-119

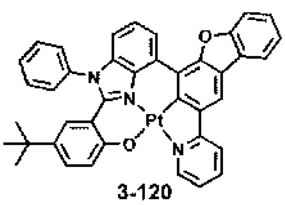

3-120

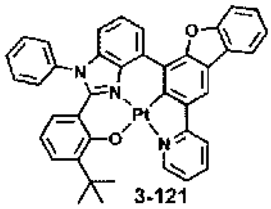

3-121

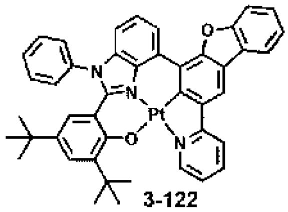

3-122

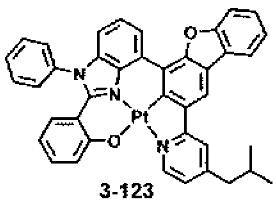

3-123

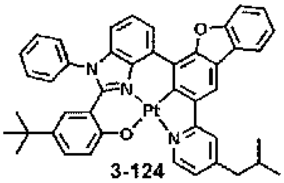
3-124

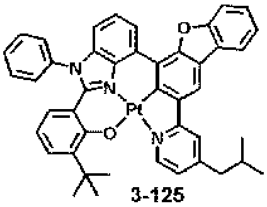
3-125

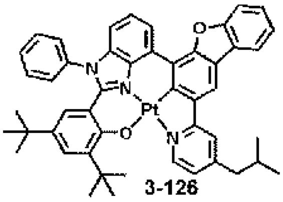
3-126

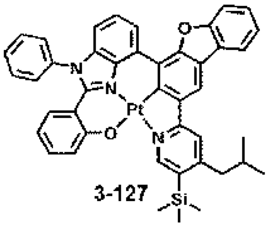
3-127

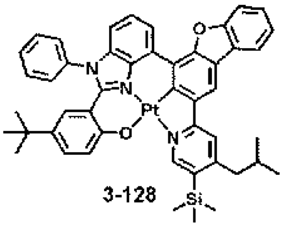
3-128

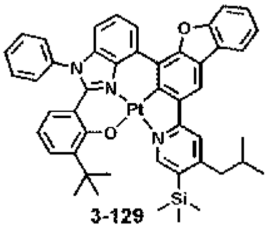
3-129

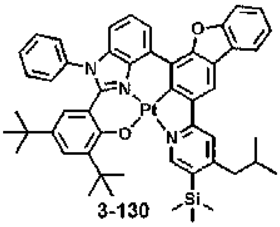
3-130

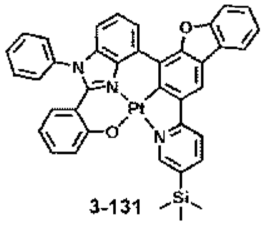
3-131

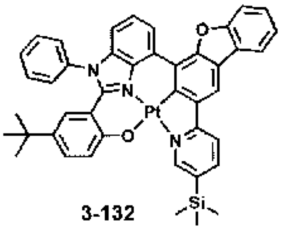
3-132

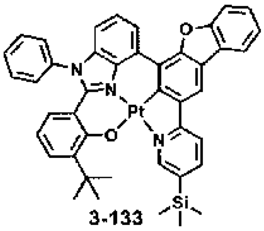
3-133

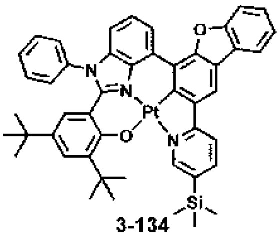
3-134

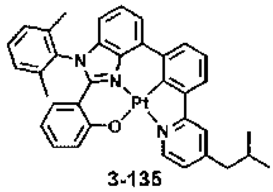
3-135

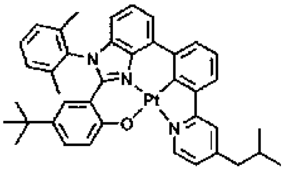
3-136

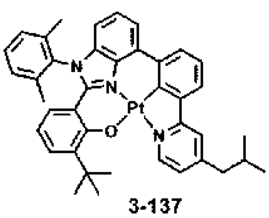
3-137

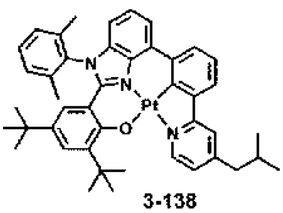
3-138

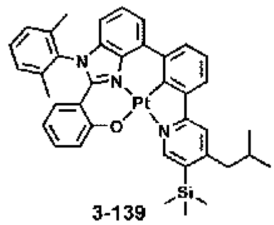
3-139

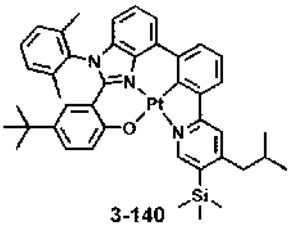
3-140

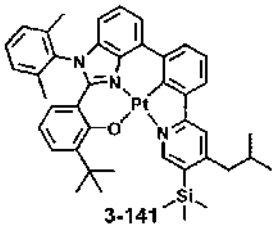
3-141

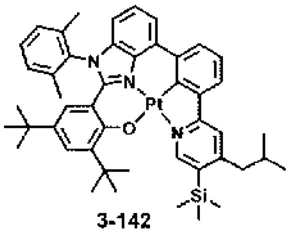
3-142

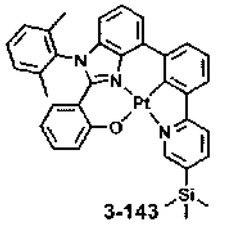
3-143

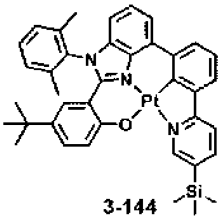
3-144

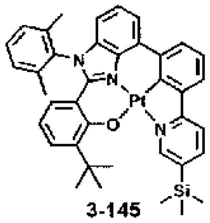
3-145

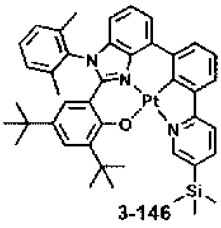
3-146

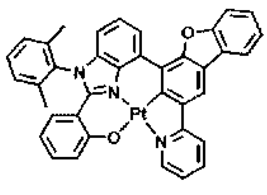
3-147

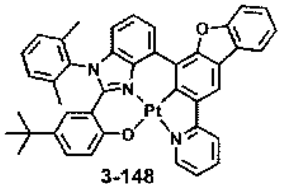
3-148

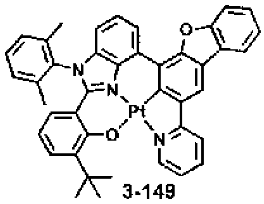
3-149

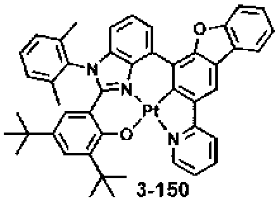
3-150

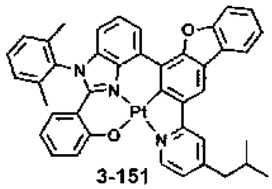
3-151

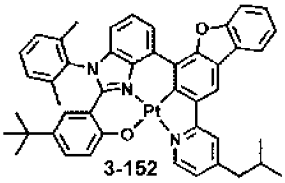
3-152

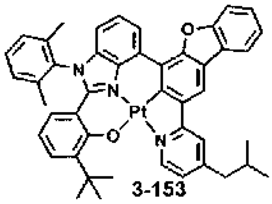
3-153

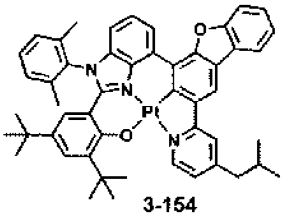
3-154

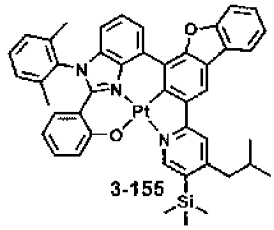
3-155

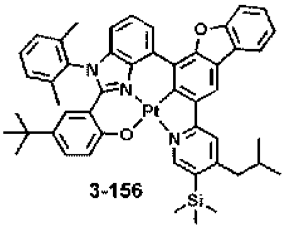
3-156

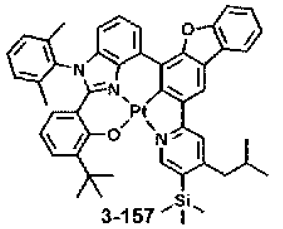
3-157

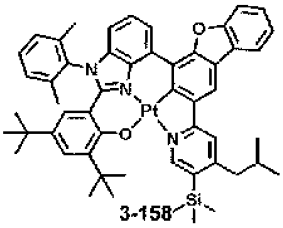
3-158

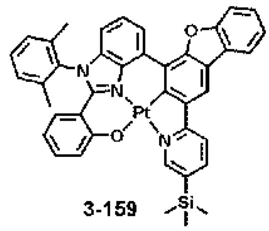
3-159

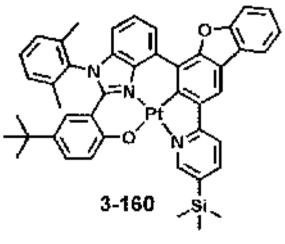
3-160

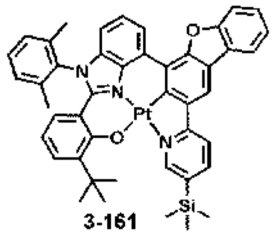
3-161

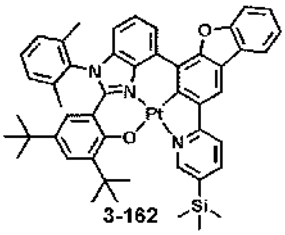
3-162

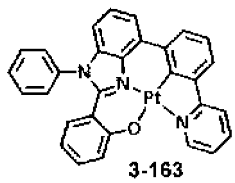
3-163

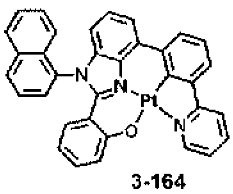
3-164

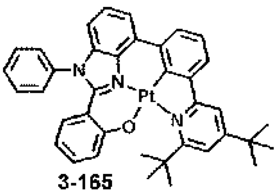
3-165

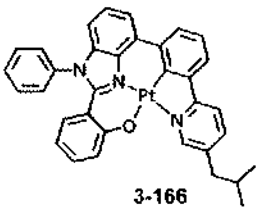
3-166

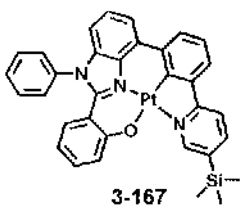
3-167

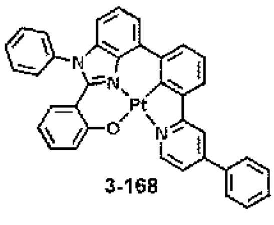
3-168

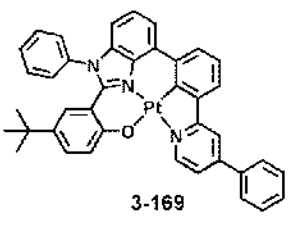
3-169

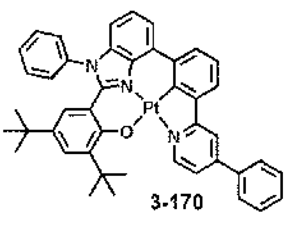
3-170

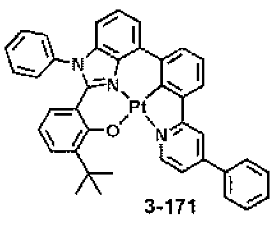
3-171

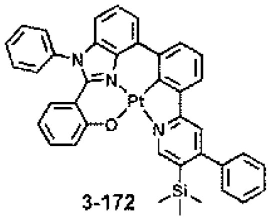
3-172

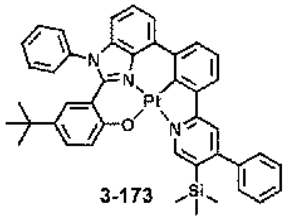
3-173

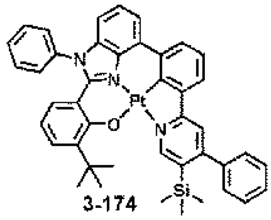
3-174

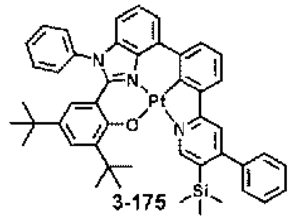
3-175

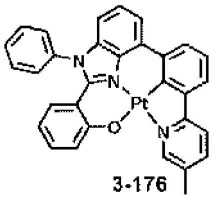
3-176

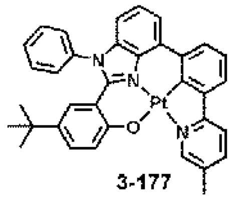
3-177

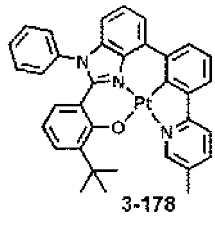
3-178

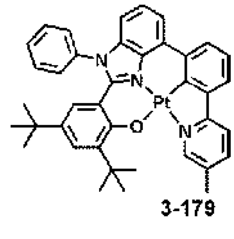
3-179

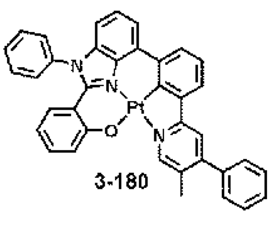
3-180

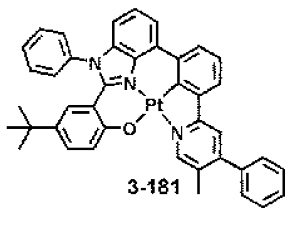
3-181

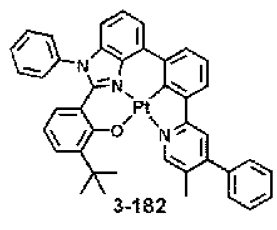
3-182

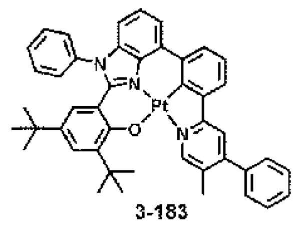
3-183

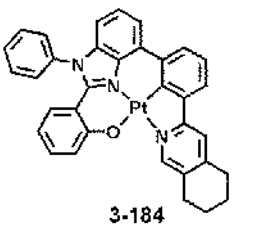
3-184

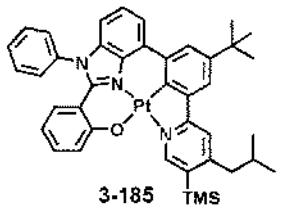
3-185

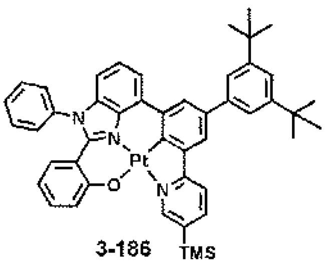
3-186

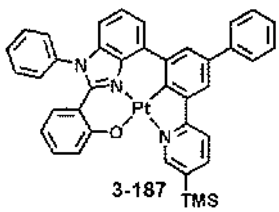
3-187

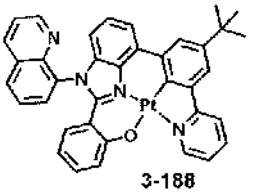
3-188

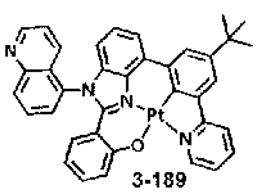
3-189

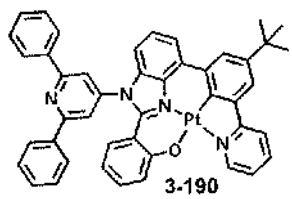
3-190

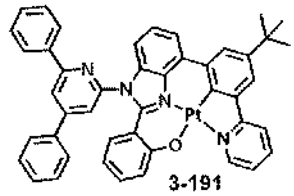
3-191

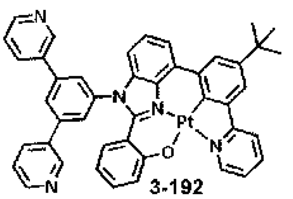
3-192

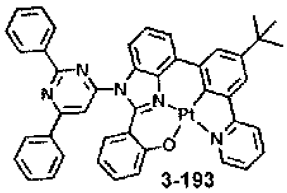
3-193

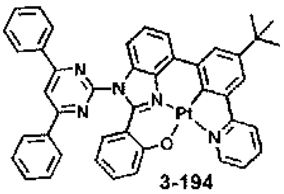
3-194

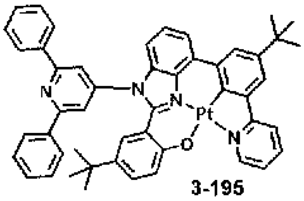
3-195

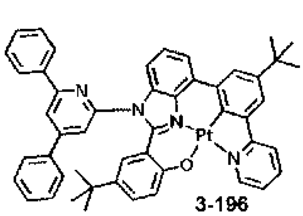
3-196

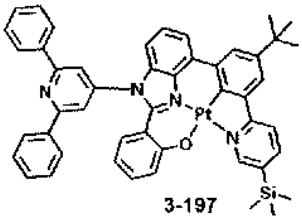
3-197

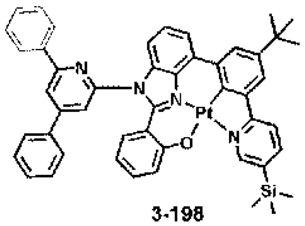
3-198

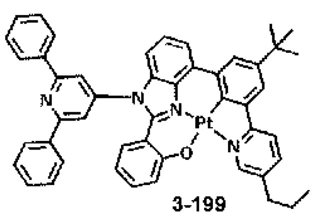
3-199

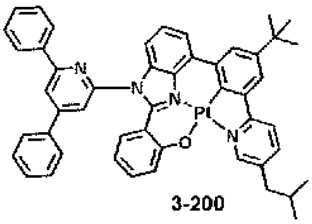
3-200

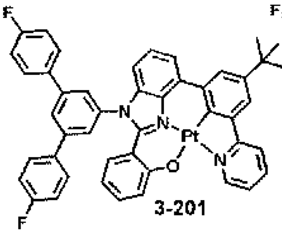
3-201

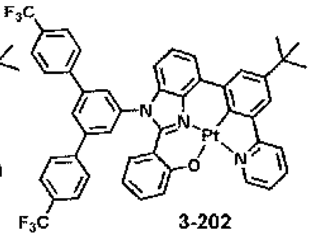
3-202

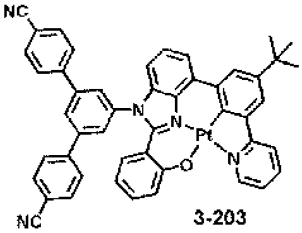
3-203

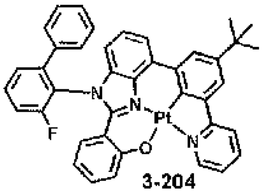
3-204

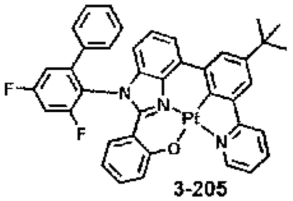
3-205

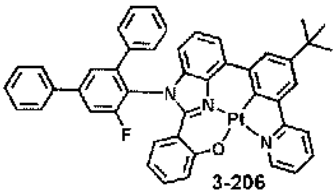
3-206

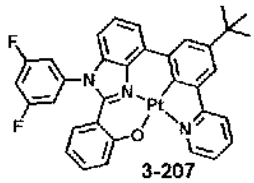
3-207

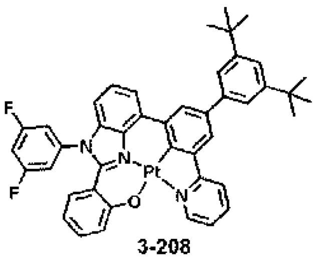
3-208

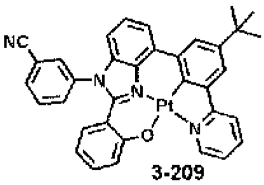
3-209

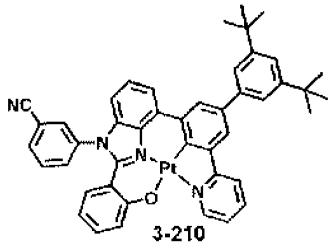
3-210

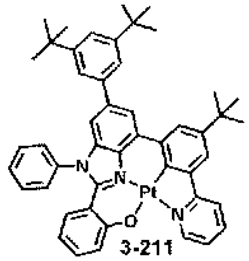
3-211

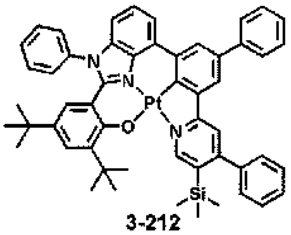
3-212

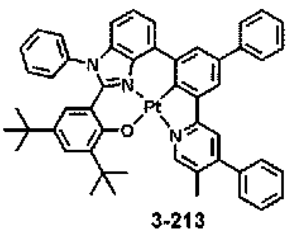
3-213

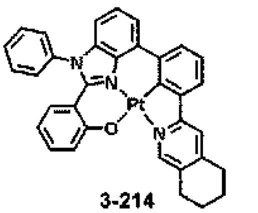
3-214

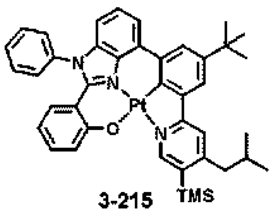
3-215

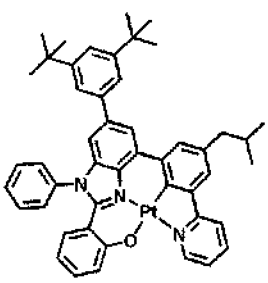
3-216

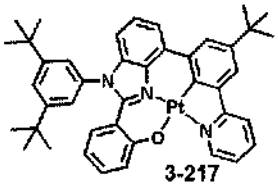
3-217

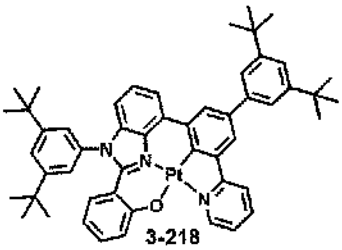
3-218

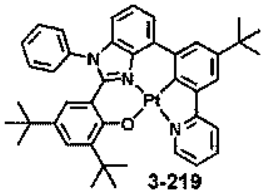
3-219

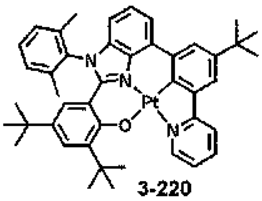
3-220

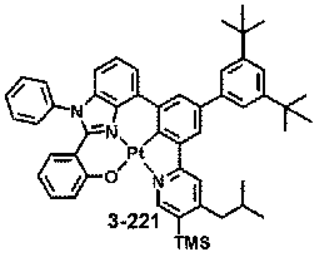
3-221

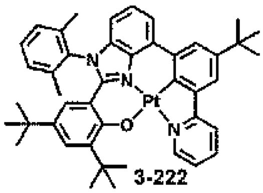
3-222

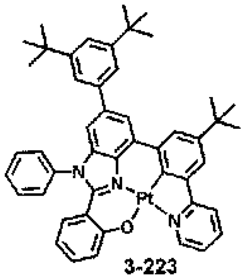
3-223

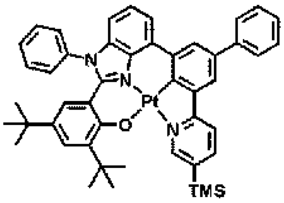
3-224

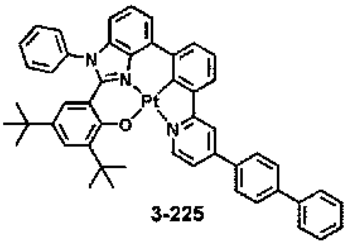
3-225

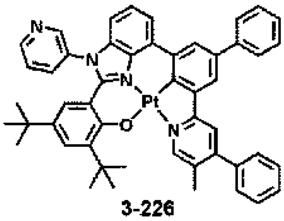
3-226

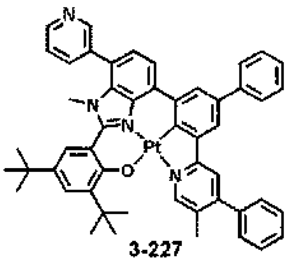
3-227

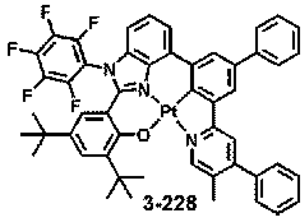
3-228

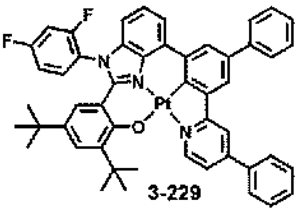
3-229

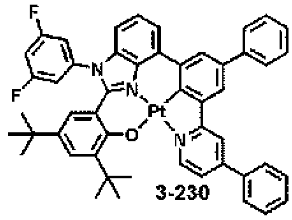
3-230

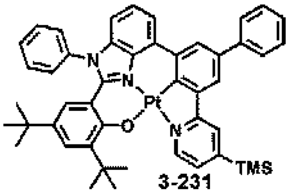
3-231

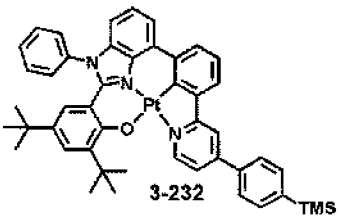
3-232

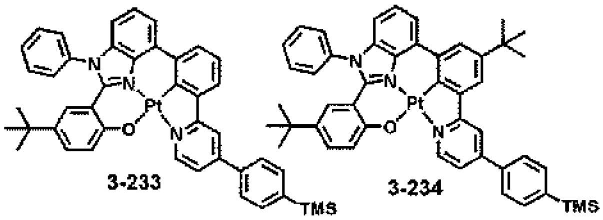
3-233

3-234

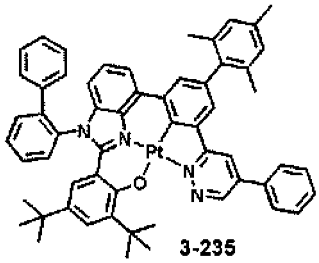
3-235

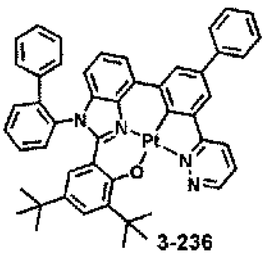
3-236

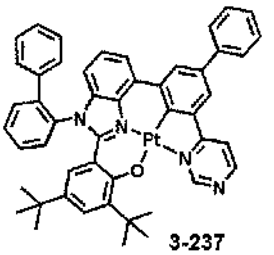
3-237

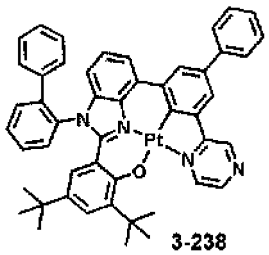
3-238

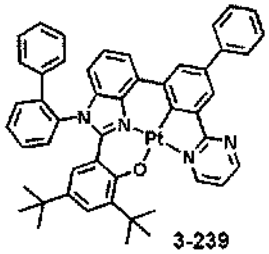 3-239
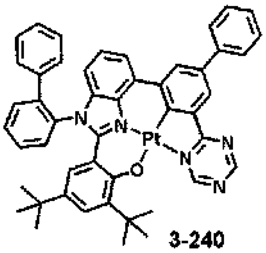 3-240
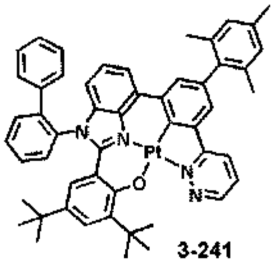 3-241
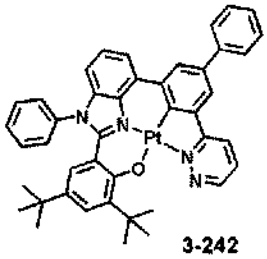 3-242

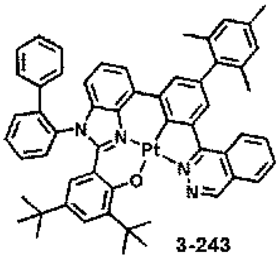 3-243
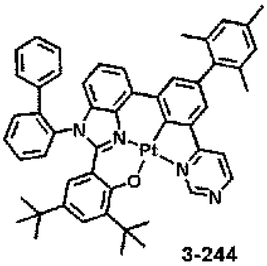 3-244
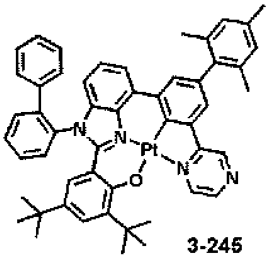 3-245
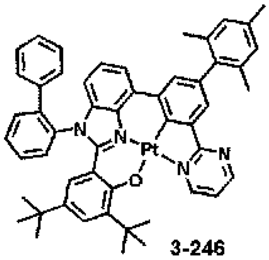 3-246

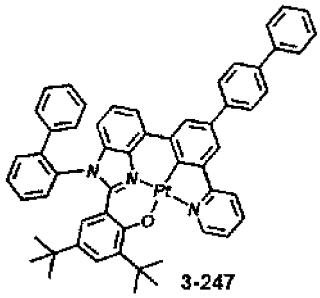 3-247
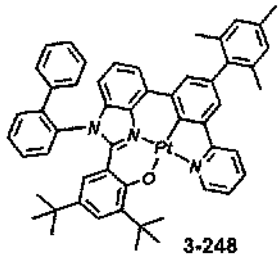 3-248
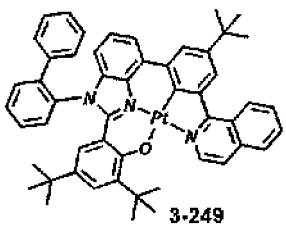 3-249
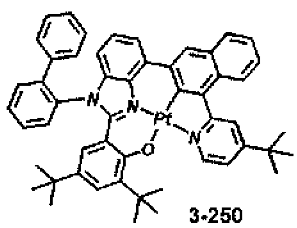 3-250

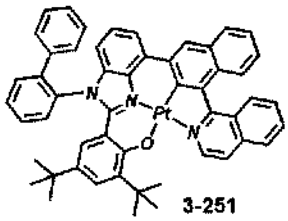 3-251
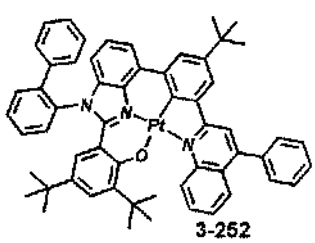 3-252
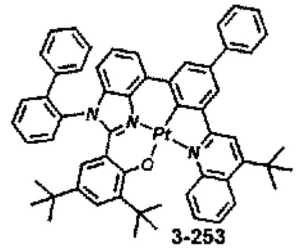 3-253
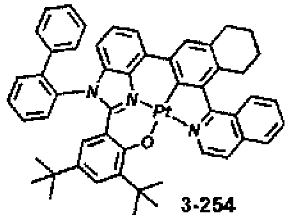 3-254

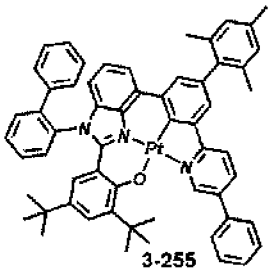 3-255
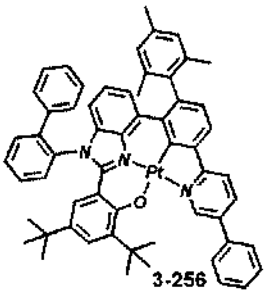 3-256
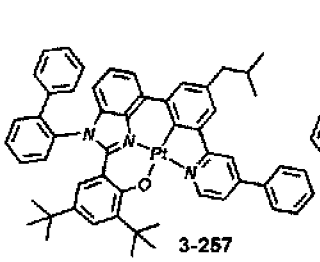 3-257
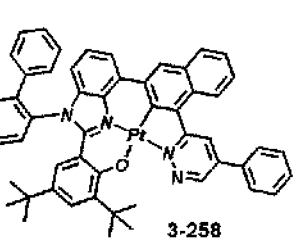 3-258

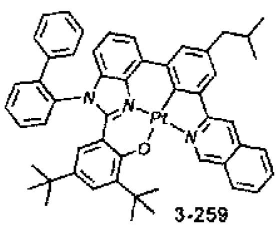
3-259

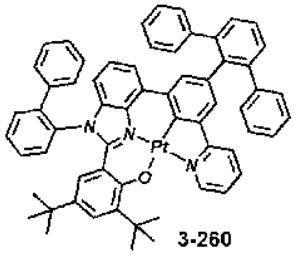
3-260

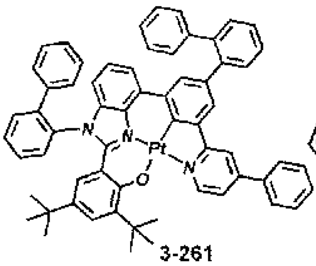
3-261

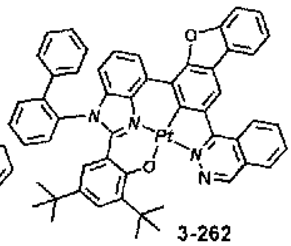
3-262

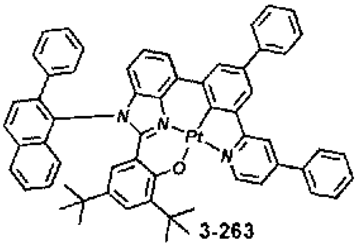
3-263

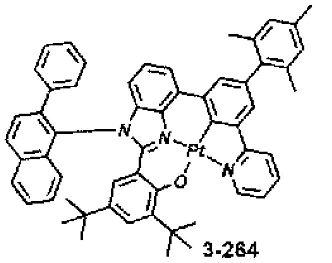
3-264

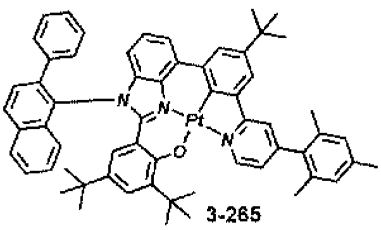
3-265

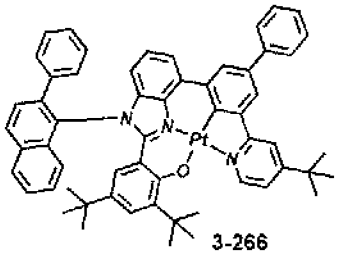
3-266

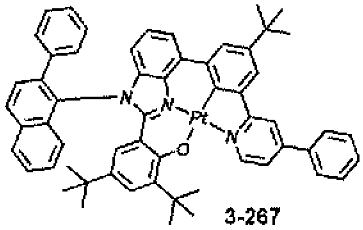
3-267

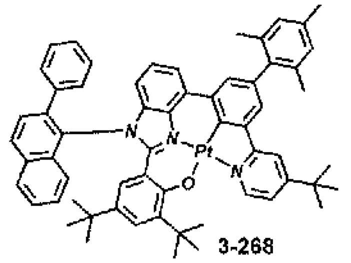
3-268

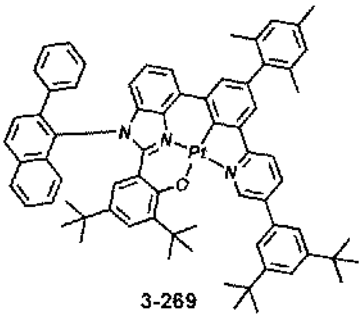
3-269

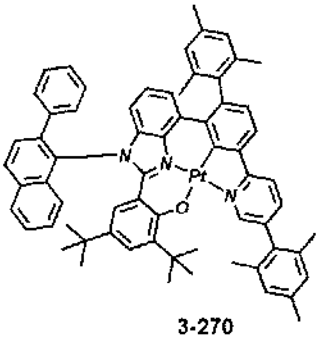
3-270

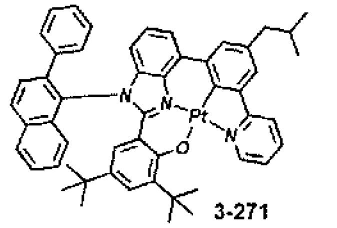
3-271

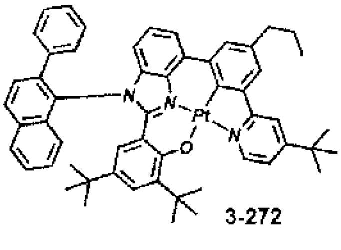
3-272

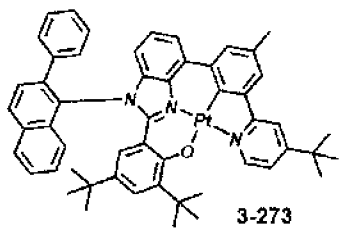
3-273

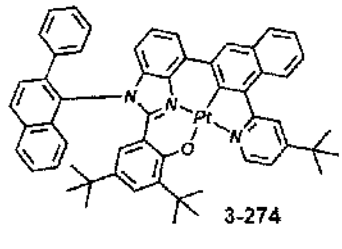
3-274

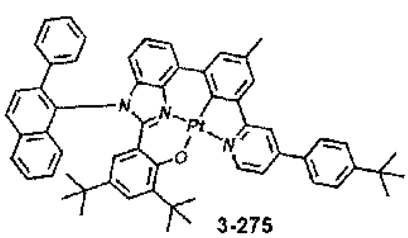

3-275

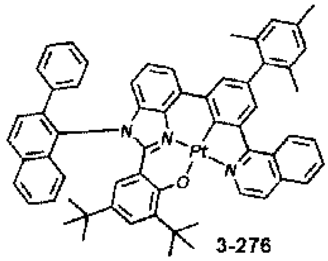

3-276

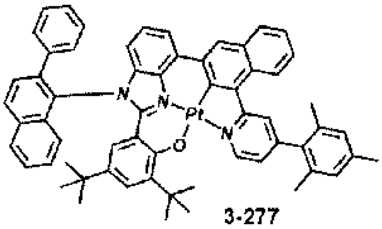

3-277

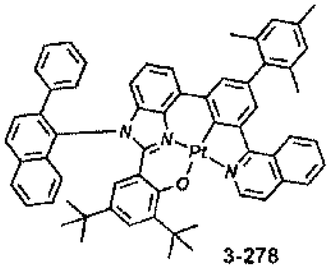

3-278

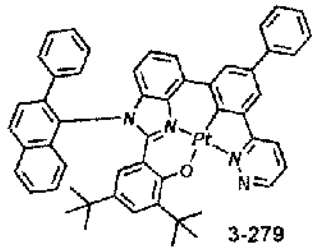

3-279

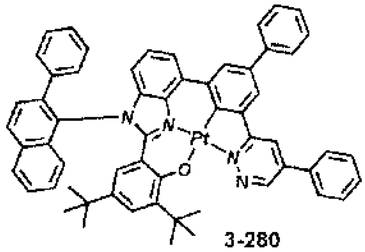

3-280

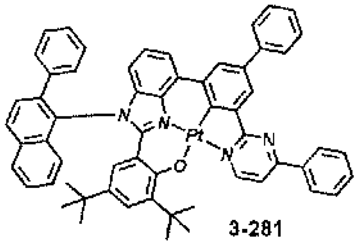

3-281

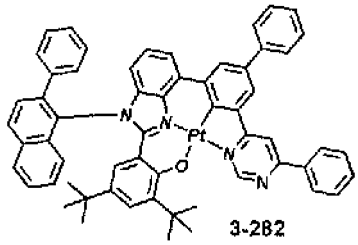

3-282

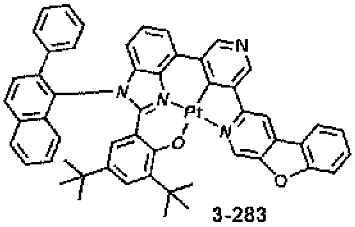

3-283

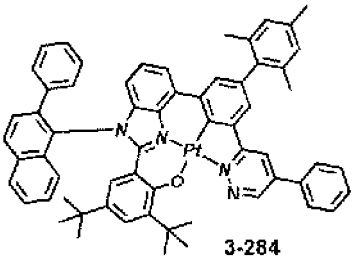

3-284

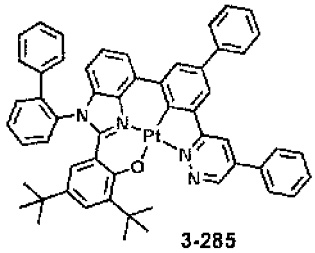

3-285

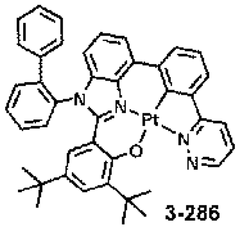

3-286

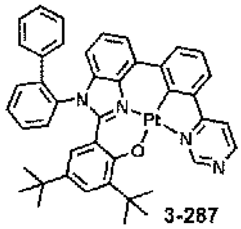

3-287

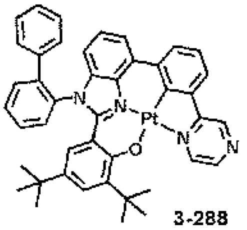

3-288

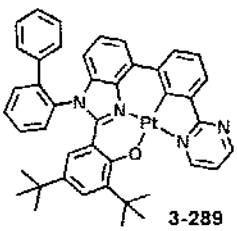

3-289

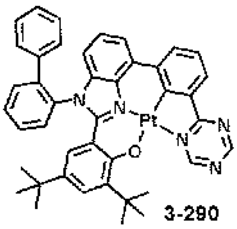

3-290

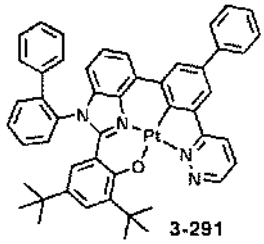

3-291

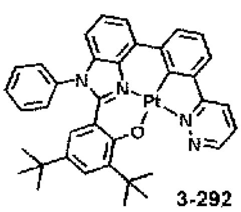

3-292

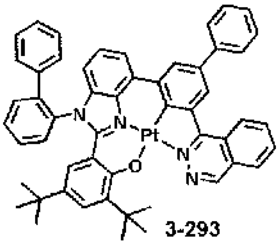

3-293

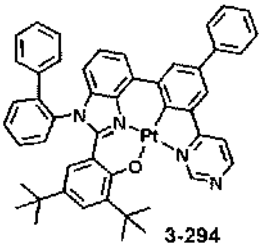

3-294

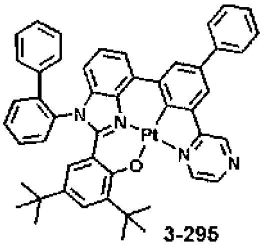

3-295

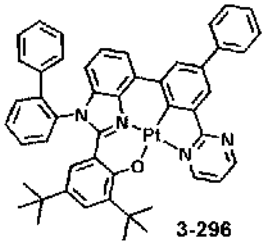
3-296

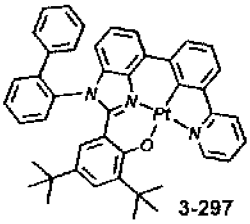
3-297

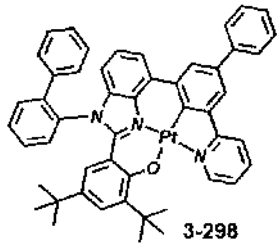
3-298

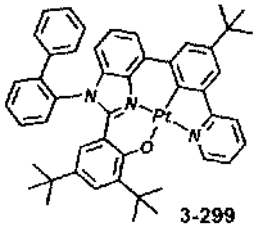
3-299

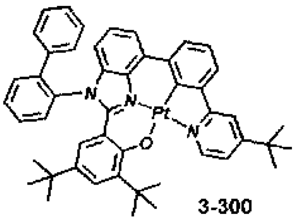
3-300

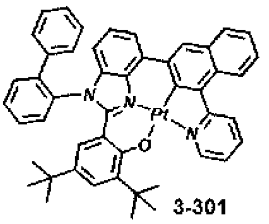
3-301

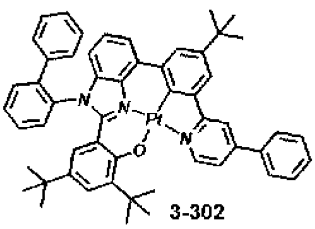
3-302

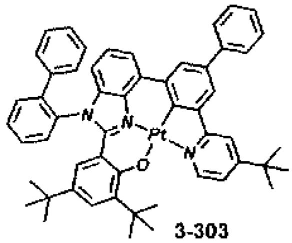
3-303

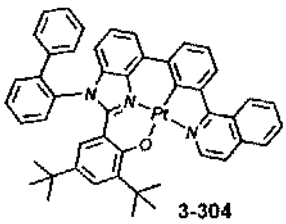
3-304

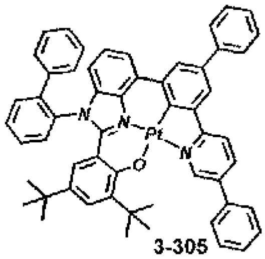
3-305

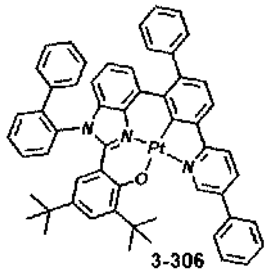
3-306

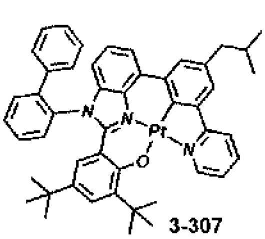
3-307

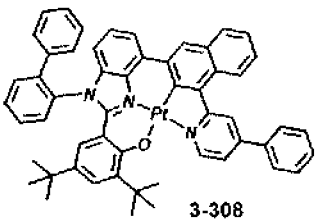
3-308

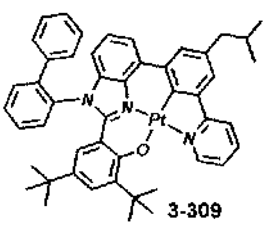
3-309

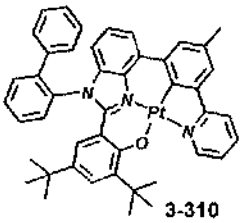
3-310

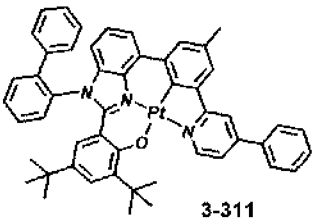
3-311

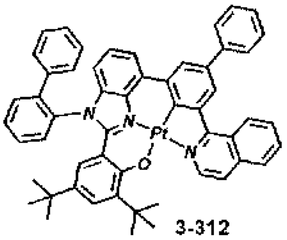
3-312

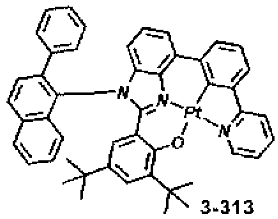
3-313

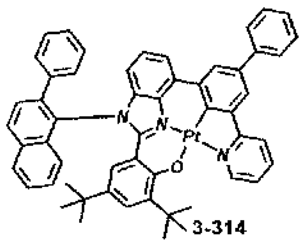
3-314

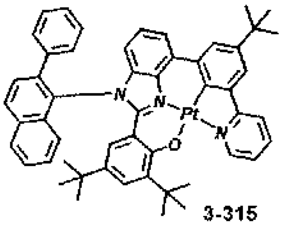
3-315

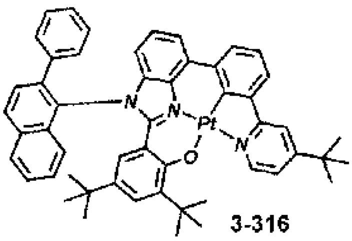
3-316

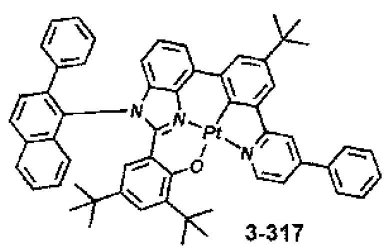
3-317

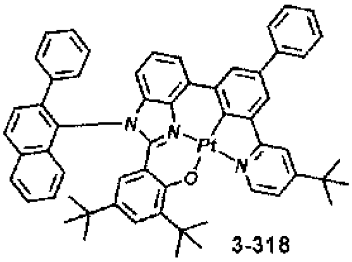
3-318

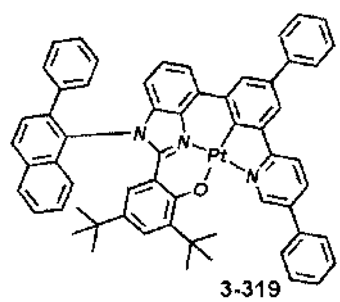
3-319

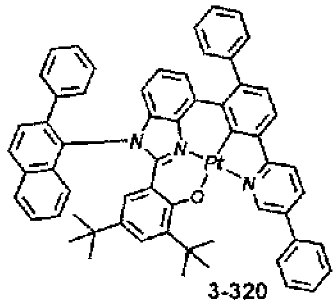
3-320

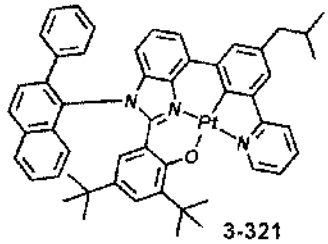
3-321

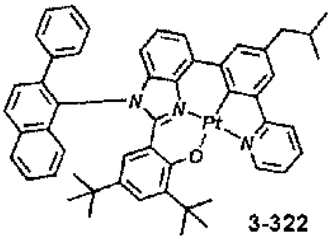
3-322

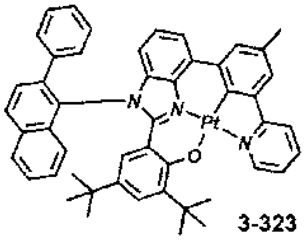
3-323

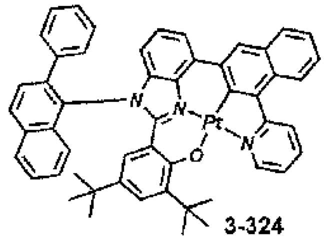
3-324

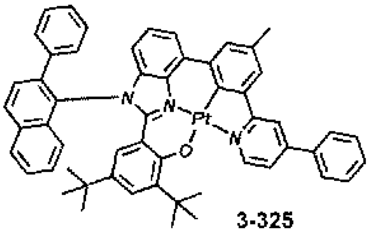
3-325

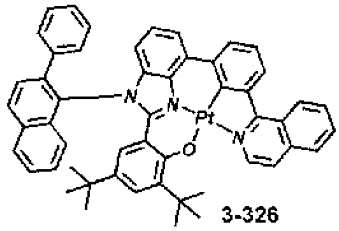
3-326

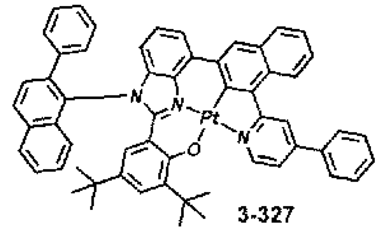
3-327

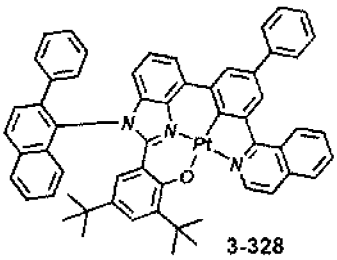
3-328

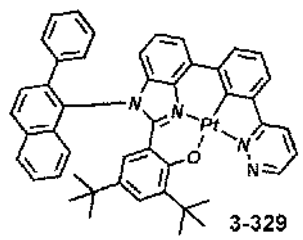
3-329

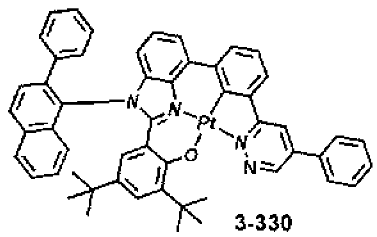
3-330

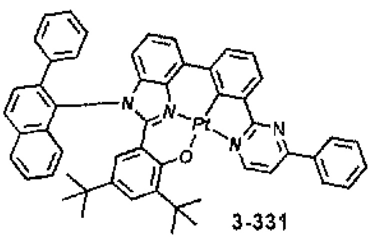
3-331

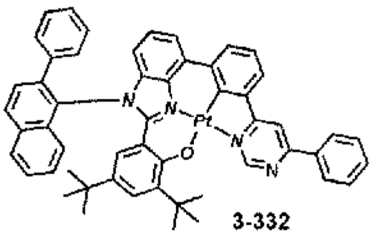
3-332

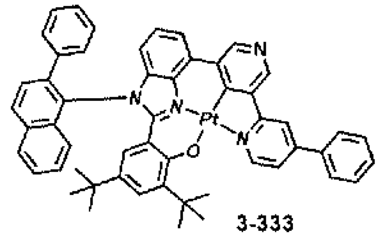
3-333

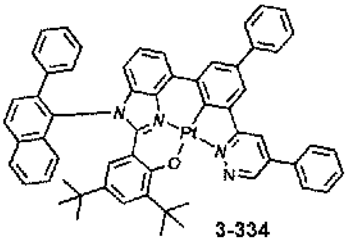
3-334

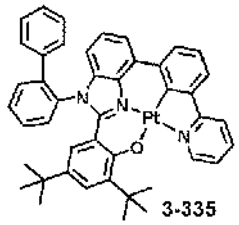
3-335

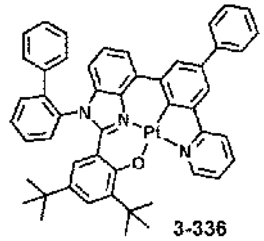
3-336

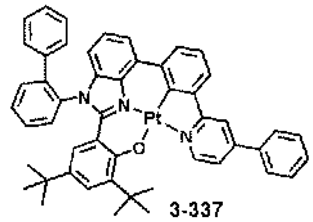
3-337

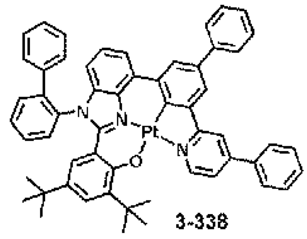
3-338

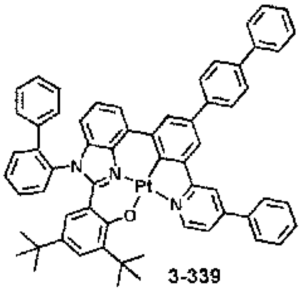
3-339

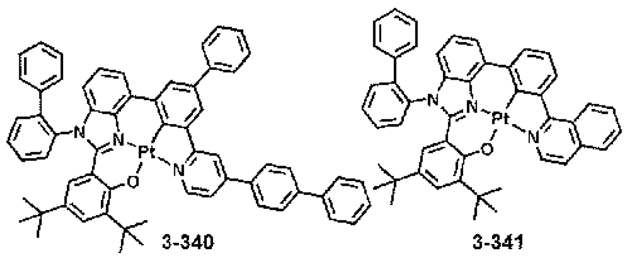
3-340

3-341

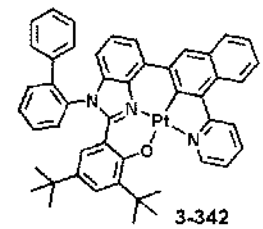
3-342

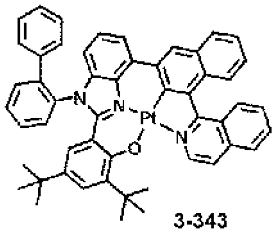
3-343

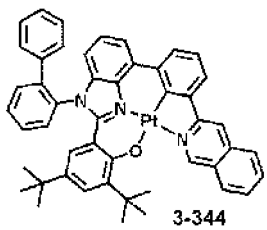
3-344

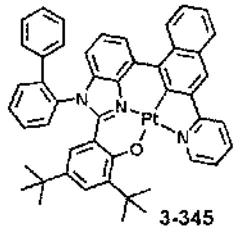
3-345

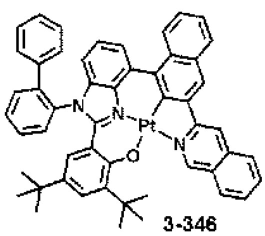
3-346

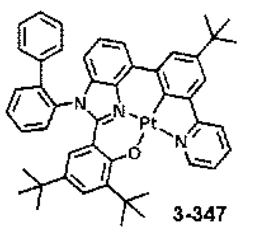
3-347

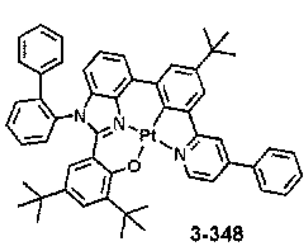
3-348

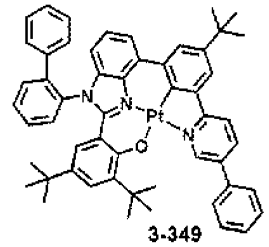
3-349

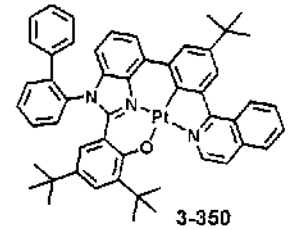
3-350

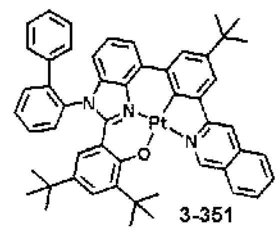
3-351

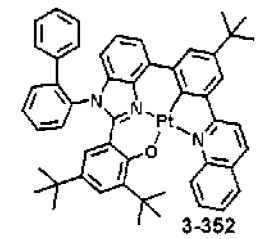
3-352

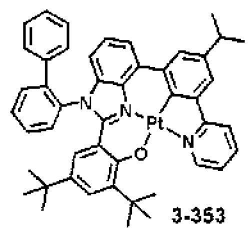
3-353

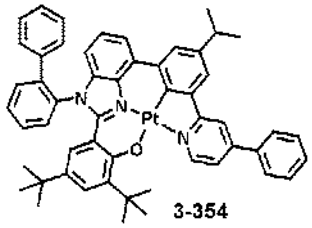
3-354

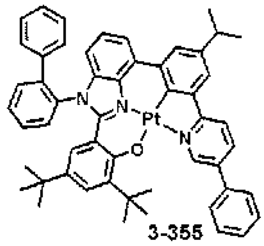
3-355

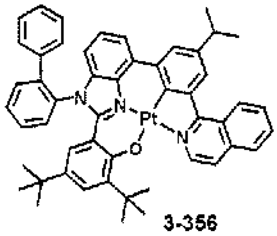
3-356

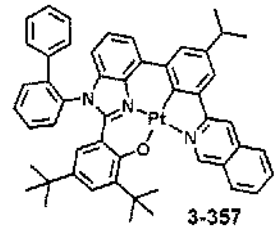
3-357

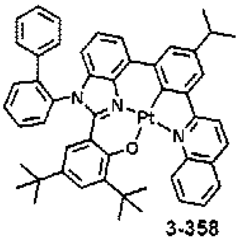
3-358

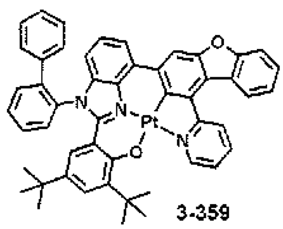
3-359

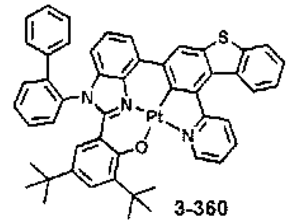
3-360

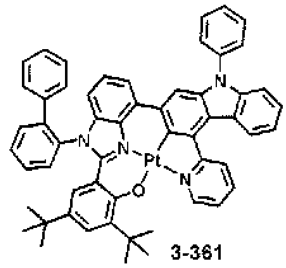
3-361

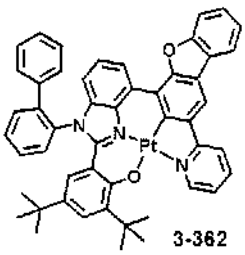
3-362

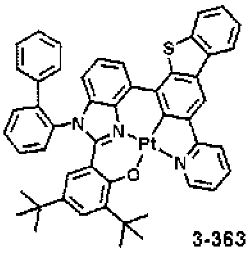
3-363

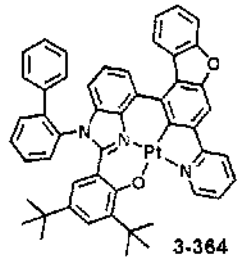
3-364

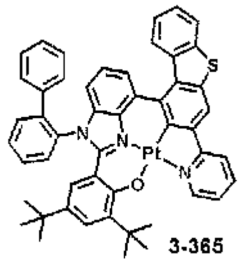
3-365

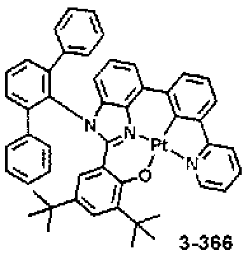
3-366

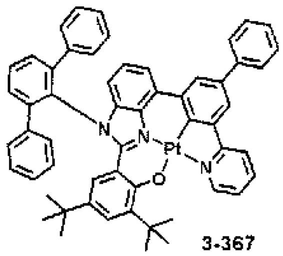
3-367

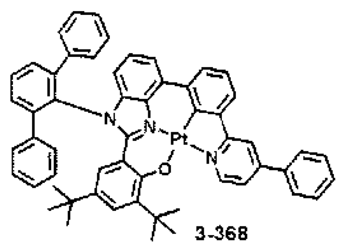
3-368

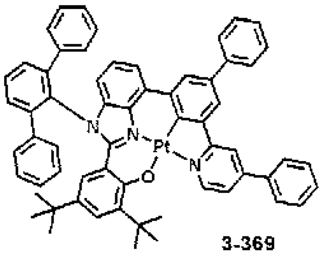
3-369

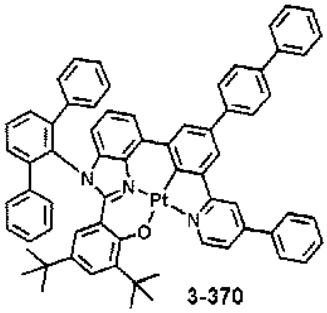
3-370

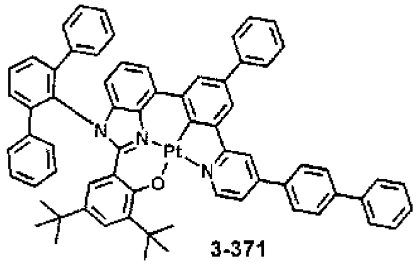
3-371

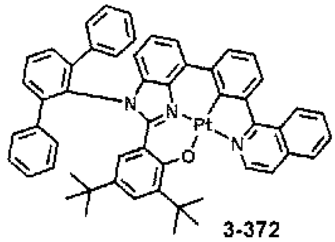
3-372

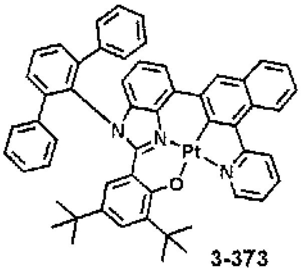
3-373

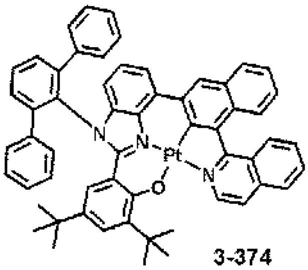
3-374

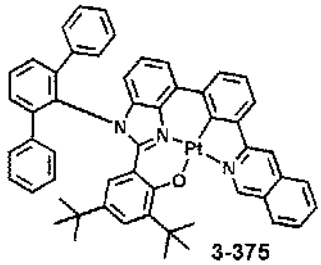
3-375

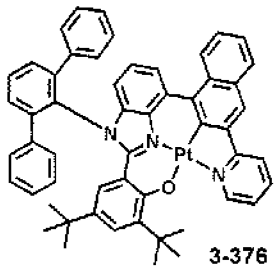
3-376

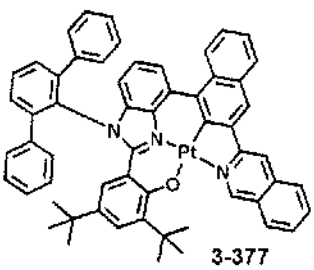
3-377

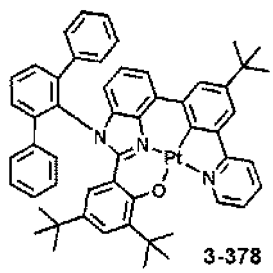
3-378

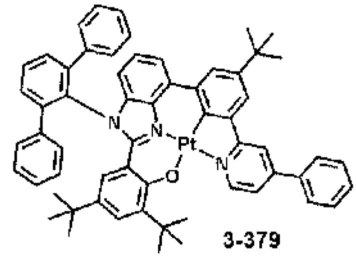
3-379

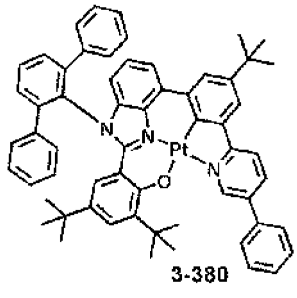
3-380

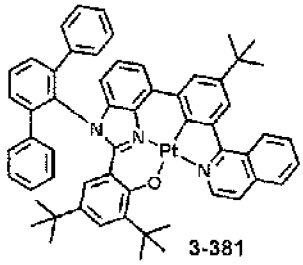
3-381

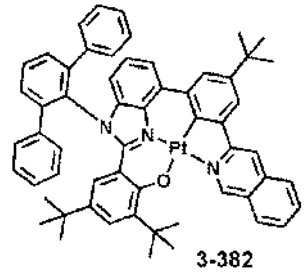
3-382

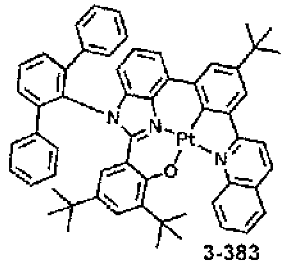
3-383

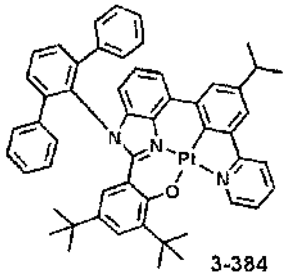
3-384

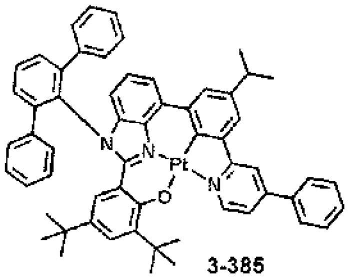
3-385

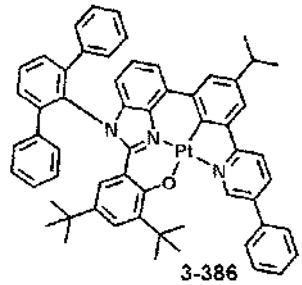
3-386

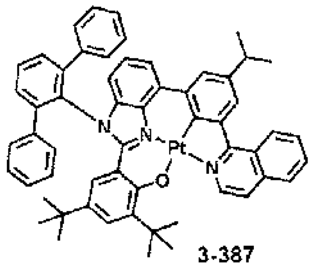
3-387

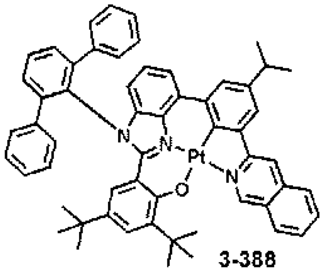
3-388

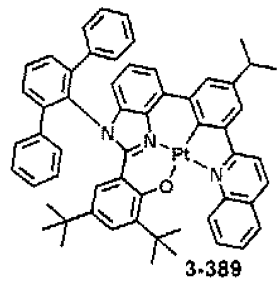
3-389

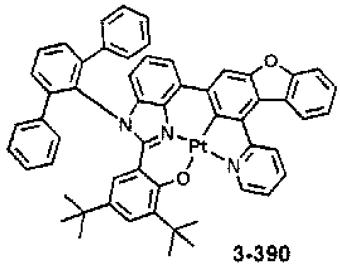
3-390

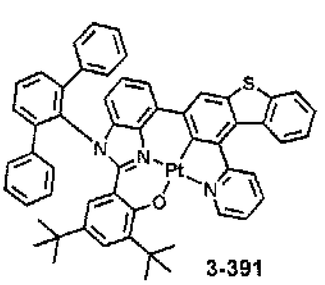
3-391

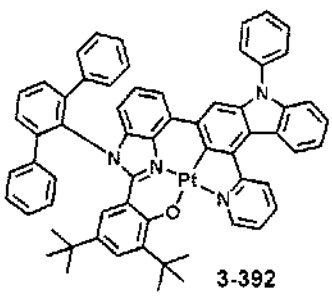
3-392

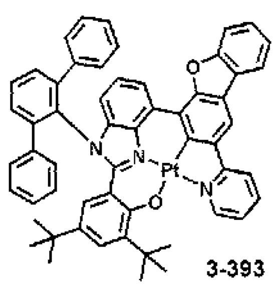
3-393

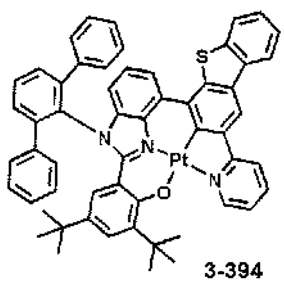
3-394

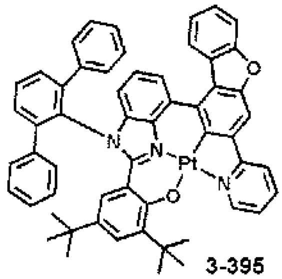
3-395

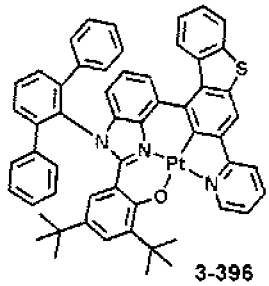
3-396

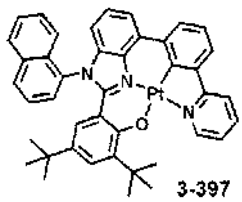
3-397

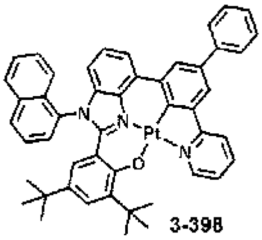
3-398

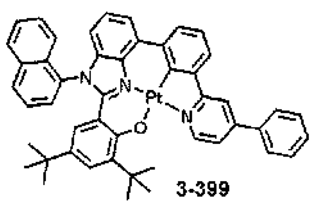
3-399

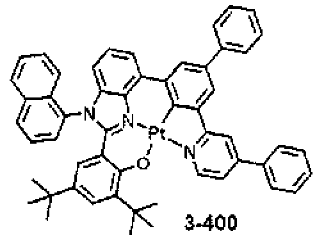
3-400

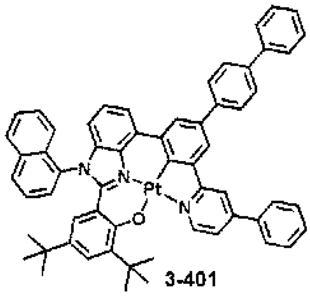
3-401

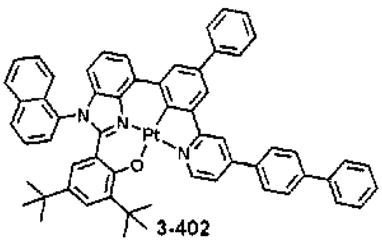
3-402

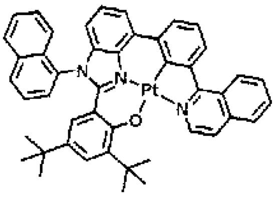
3-403

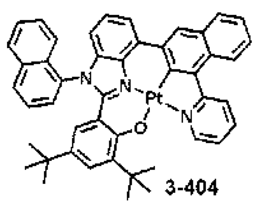
3-404

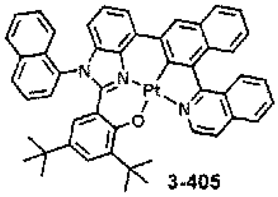
3-405

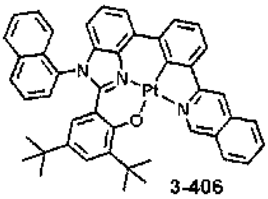
3-406

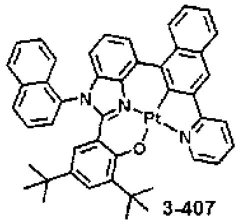
3-407

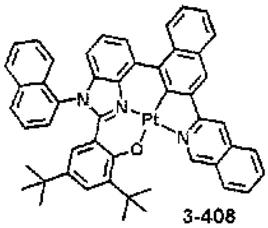
3-408

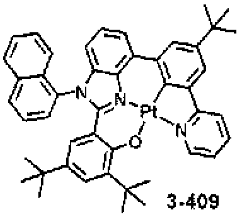
3-409

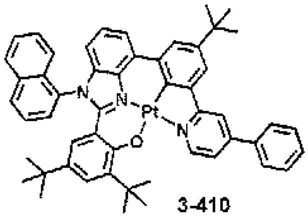
3-410

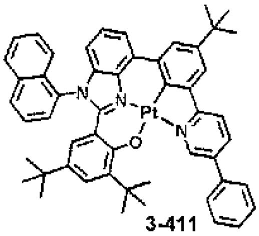
3-411

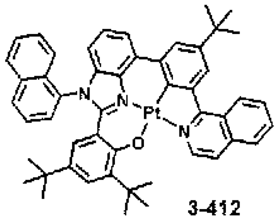
3-412

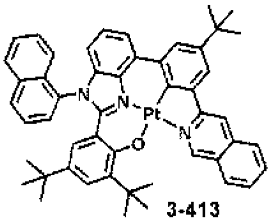
3-413

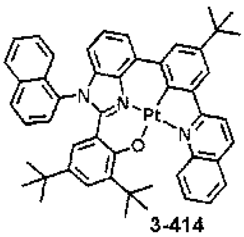
3-414

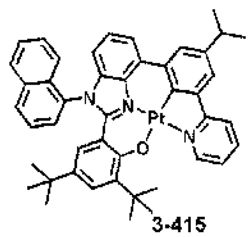
3-415

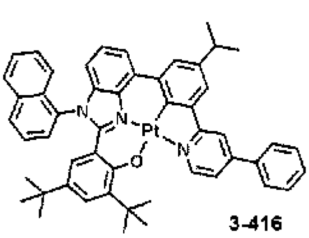
3-416

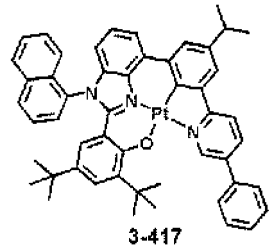
3-417

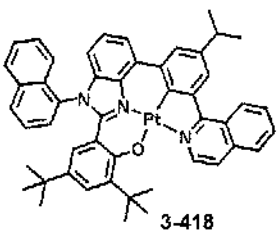
3-418

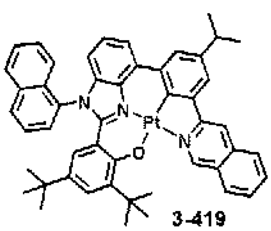
3-419

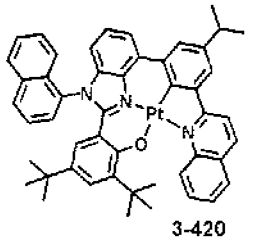
3-420

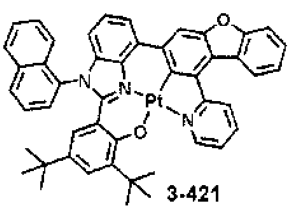
3-421

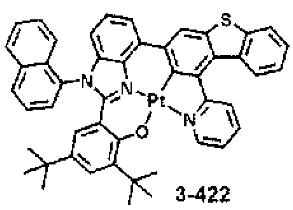
3-422

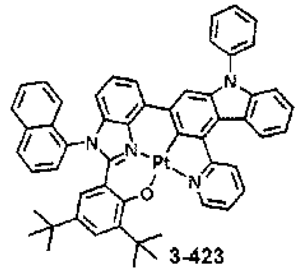
3-423

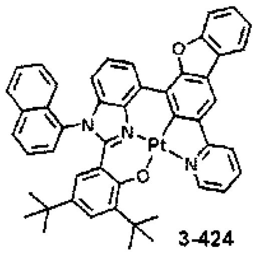
3-424

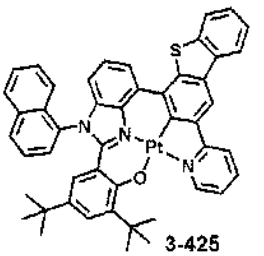
3-425

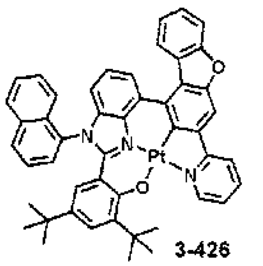
3-426

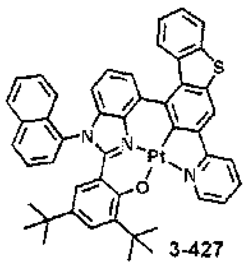
3-427

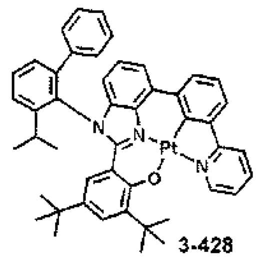
3-428

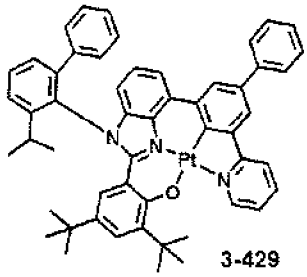
3-429

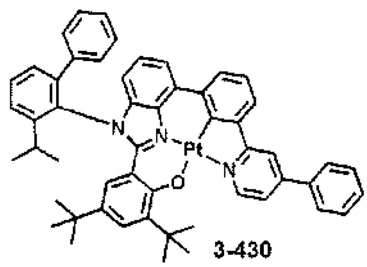
3-430

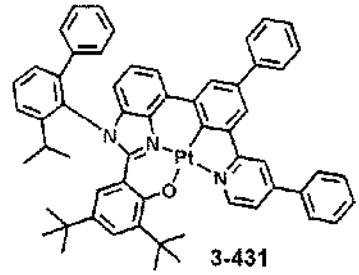
3-431

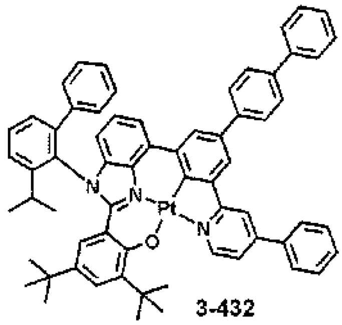
3-432

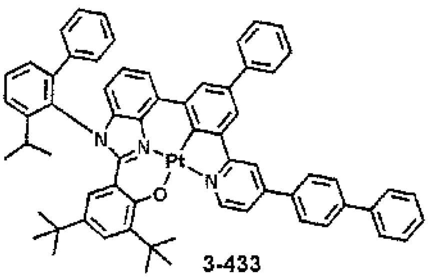
3-433

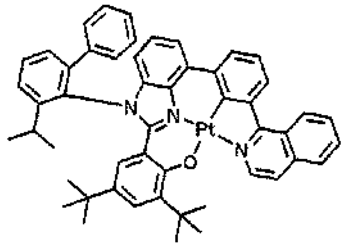
3-434

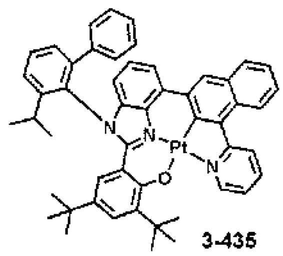
3-435

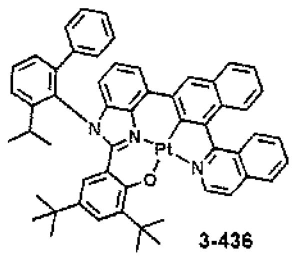
3-436

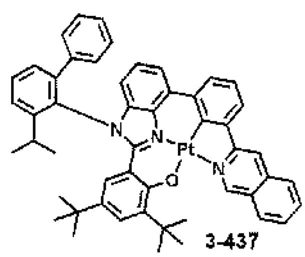
3-437

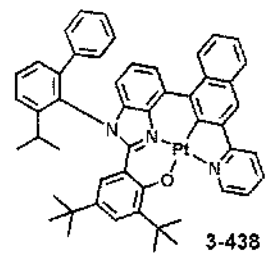
3-438

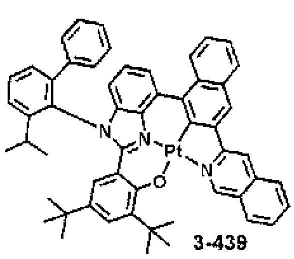
3-439

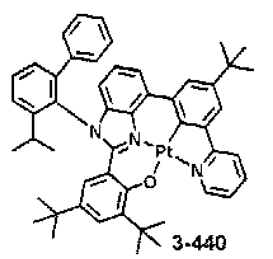
3-440

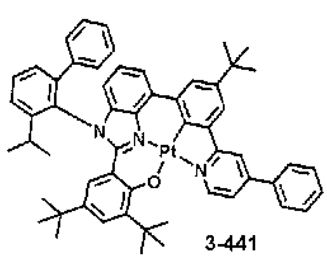
3-441

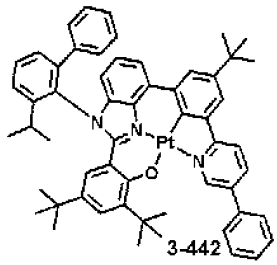
3-442

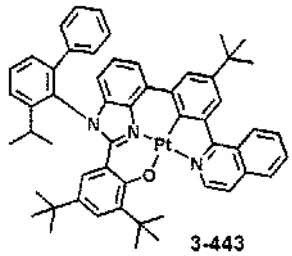
3-443

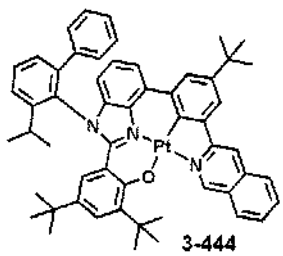
3-444

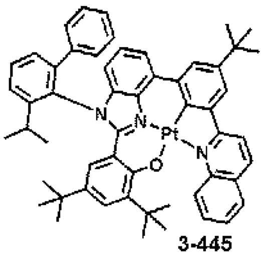
3-445

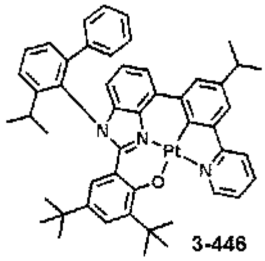
3-446

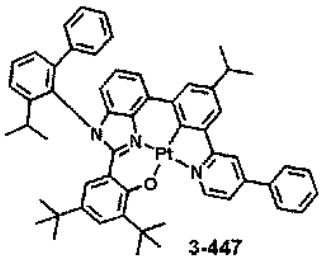
3-447

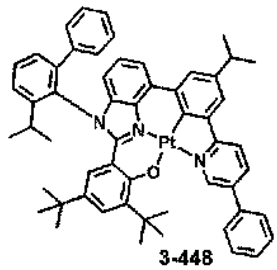
3-448

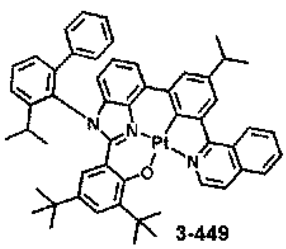
3-449

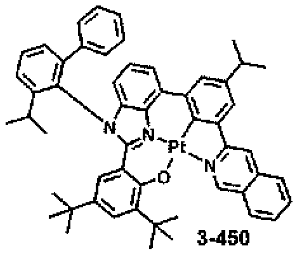
3-450

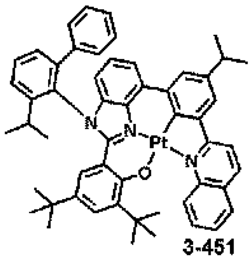
3-451

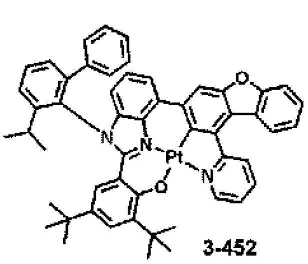
3-452

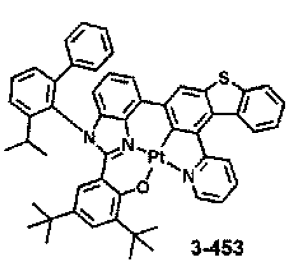
3-453

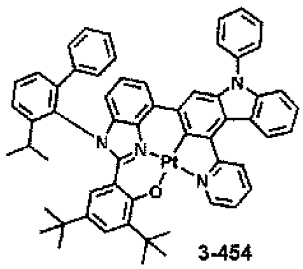
3-454

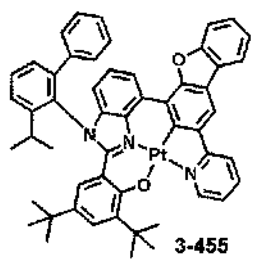
3-455

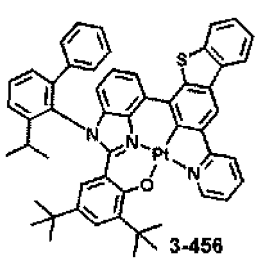
3-456

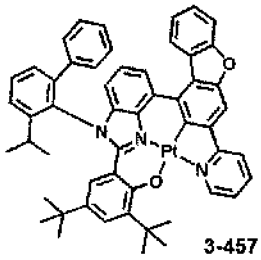
3-457

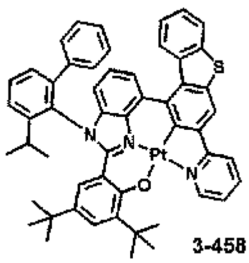
3-458

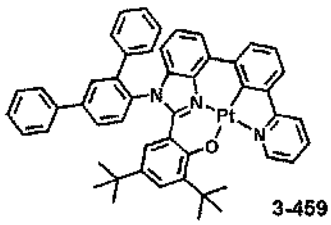
3-459

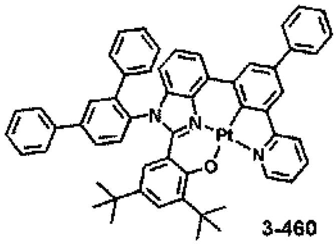
3-460

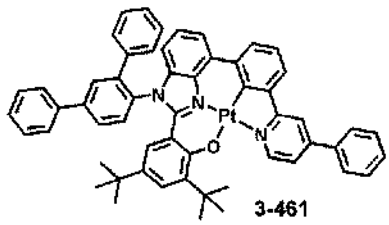
3-461

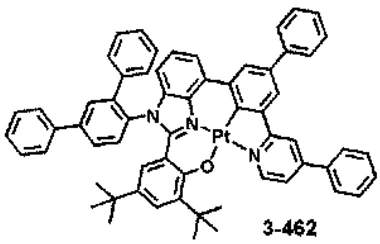
3-462

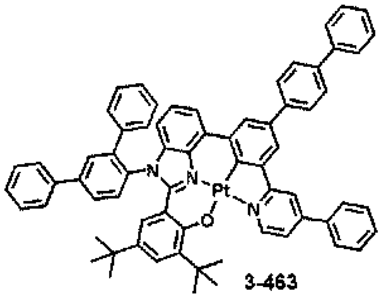
3-463

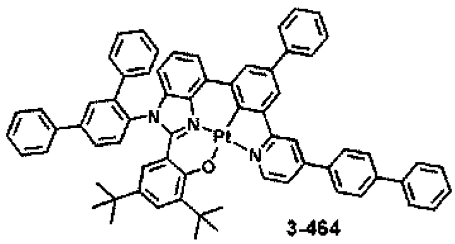
3-464

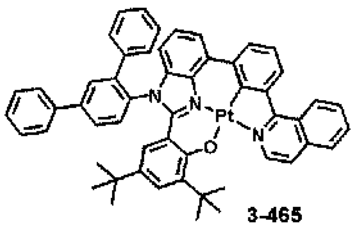
3-465

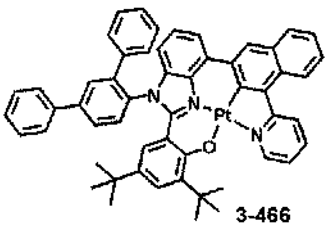
3-466

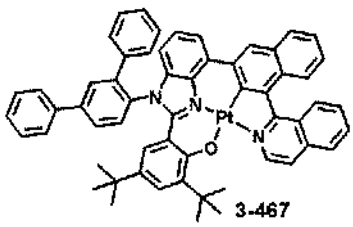
3-467

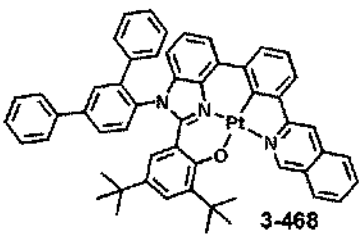
3-468

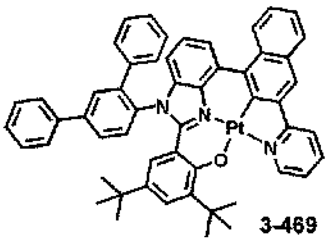
3-469

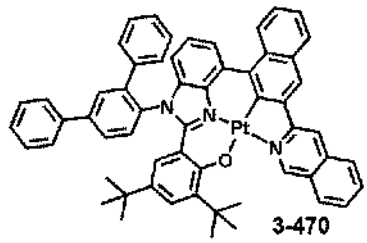
3-470

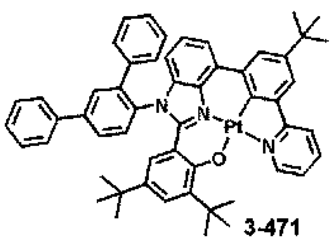
3-471

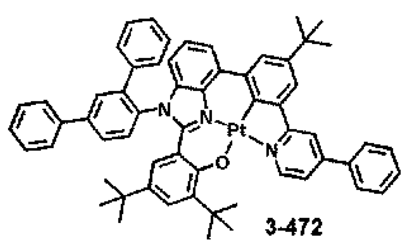
3-472

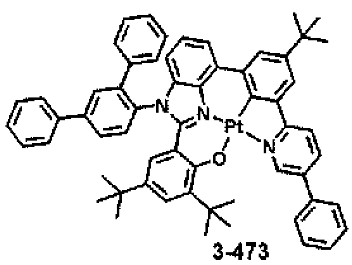
3-473

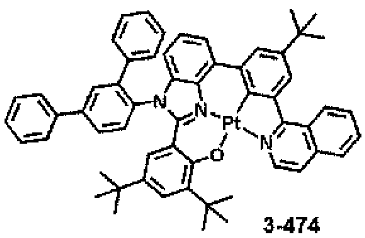
3-474

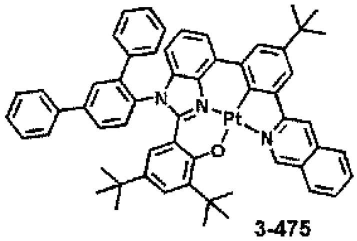
3-475

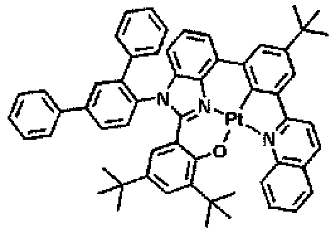
3-476

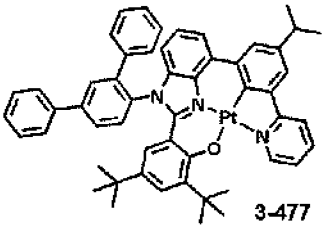
3-477

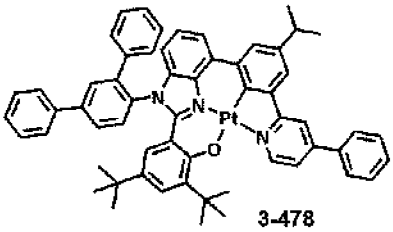
3-478

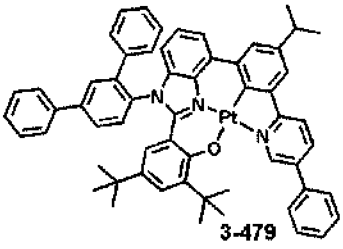
3-479

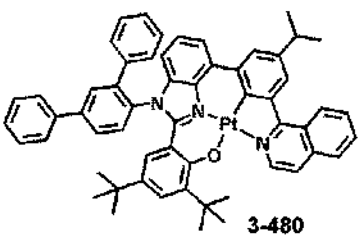
3-480

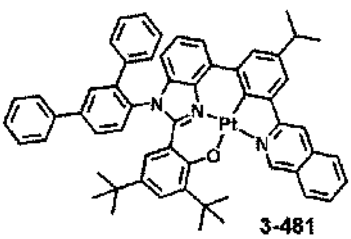
3-481

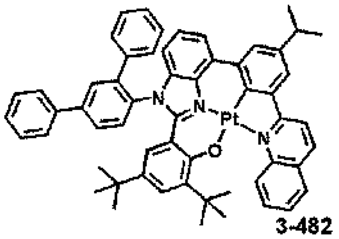
3-482

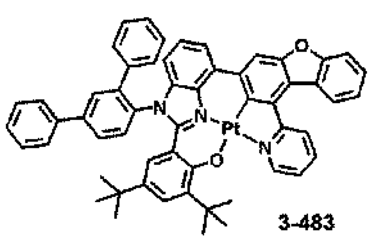
3-483

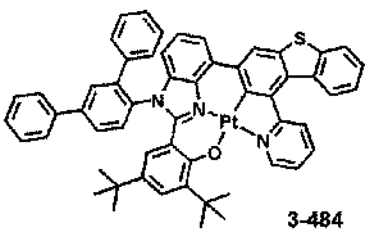
3-484

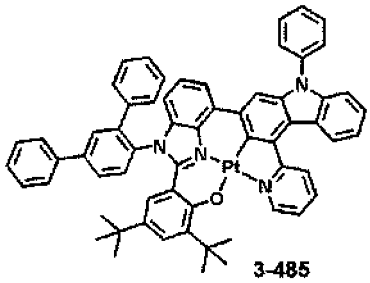
3-485

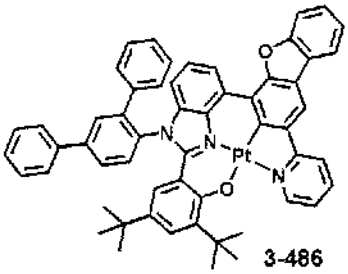
3-486

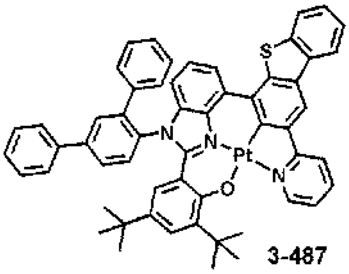
3-487

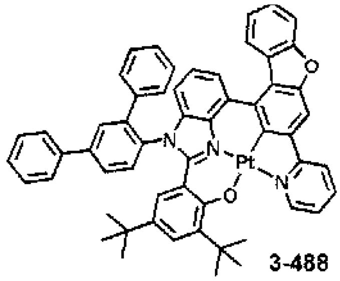
3-488

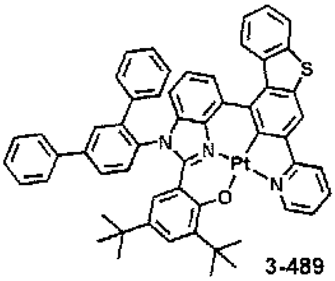
3-489

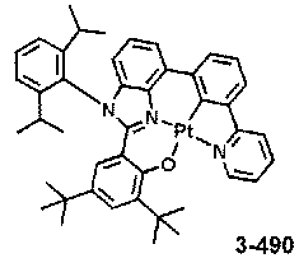
3-490

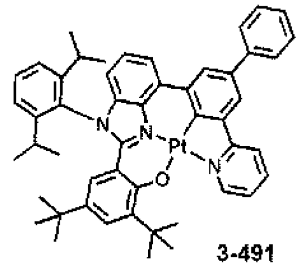
3-491

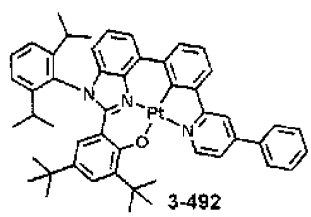
3-492

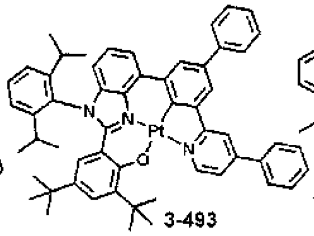
3-493

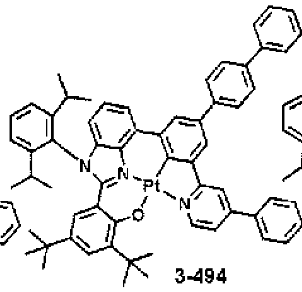
3-494

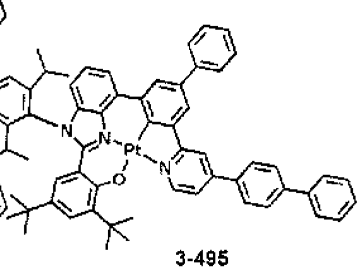
3-495

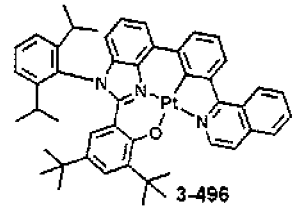
3-496

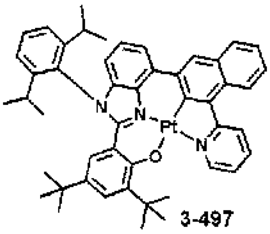
3-497

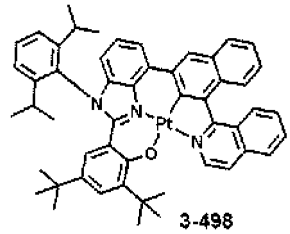
3-498

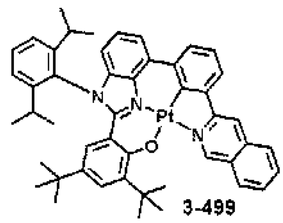
3-499

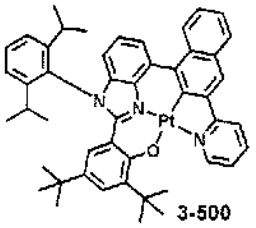
3-500

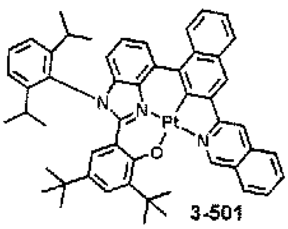
3-501

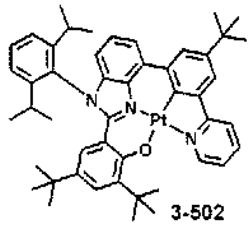
3-502

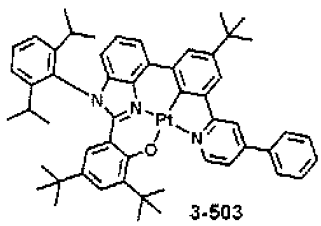
3-503

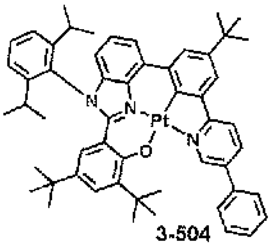
3-504

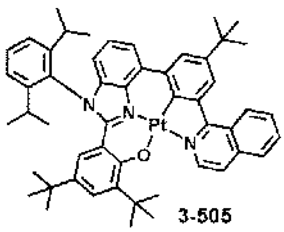
3-505

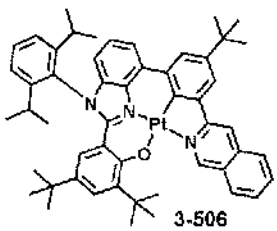
3-506

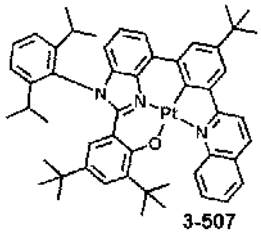
3-507

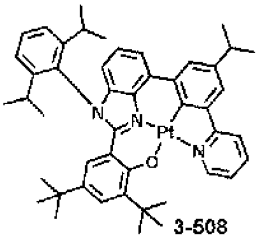
3-508

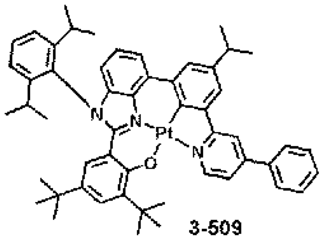
3-509

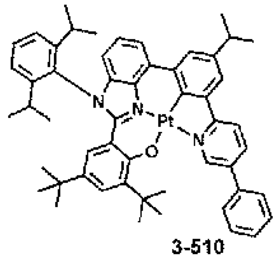
3-510

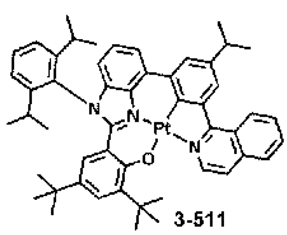
3-511

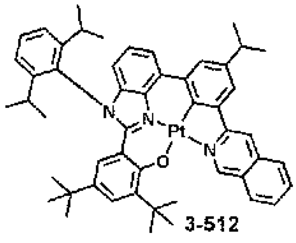
3-512

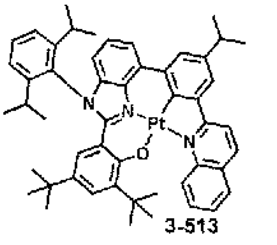
3-513

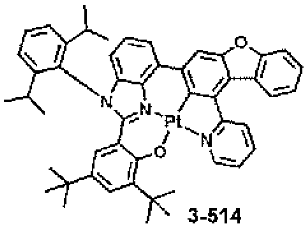
3-514

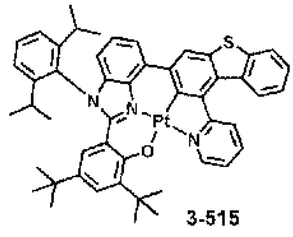
3-515

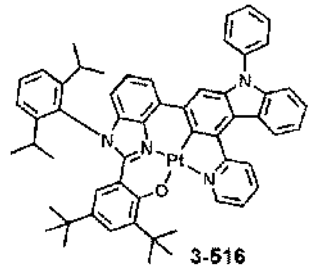
3-516

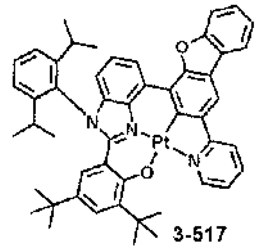
3-517

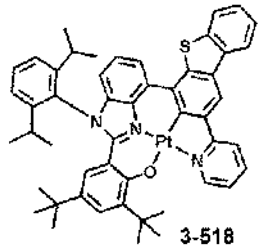
3-518

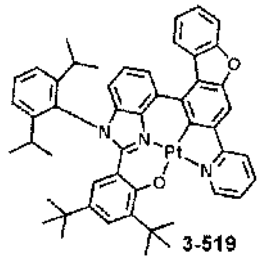
3-519

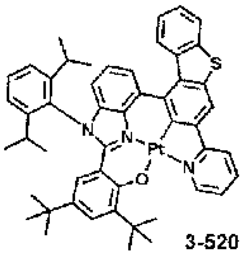
3-520

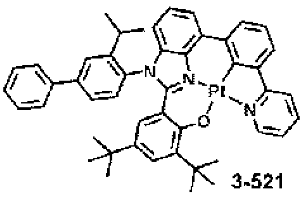
3-521

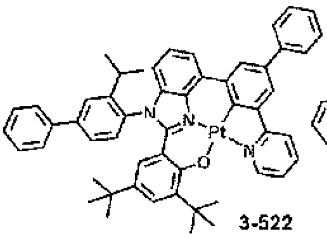
3-522

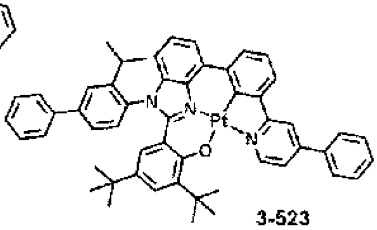
3-523

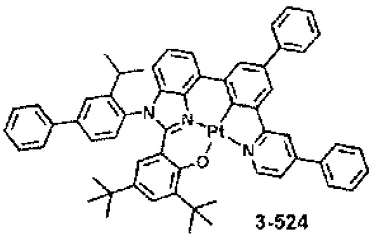
3-524

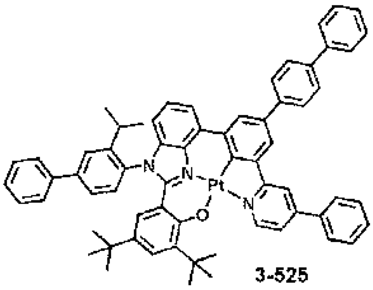
3-525

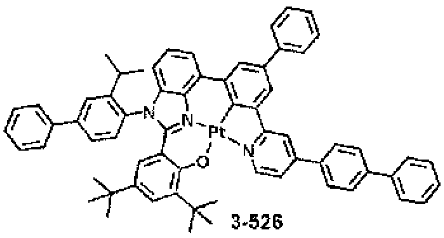
3-526

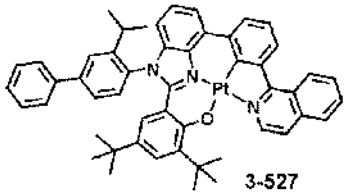
3-527

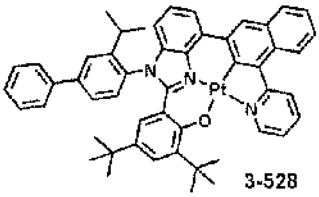
3-528

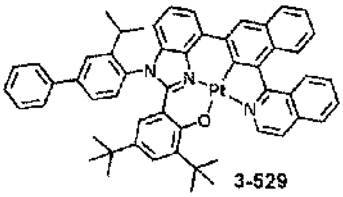
3-529

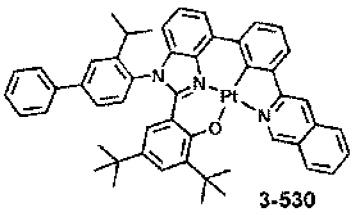
3-530

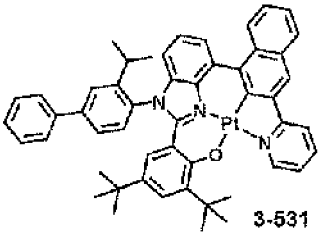
3-531

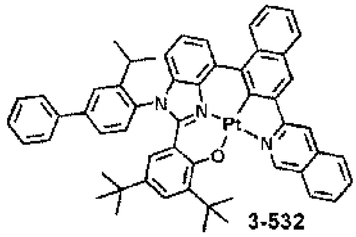
3-532

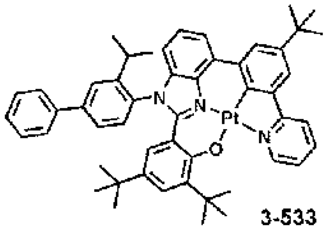
3-533

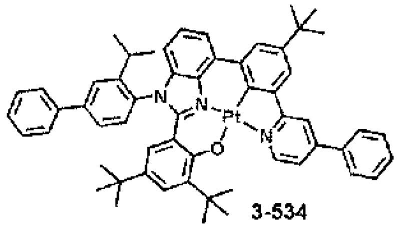
3-534

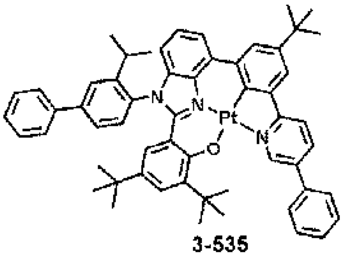
3-535

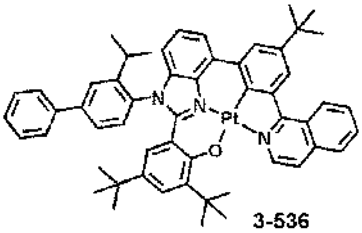
3-536

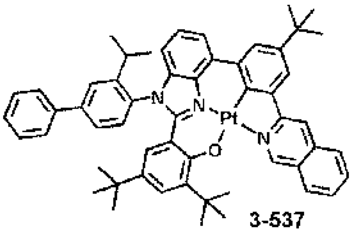
3-537

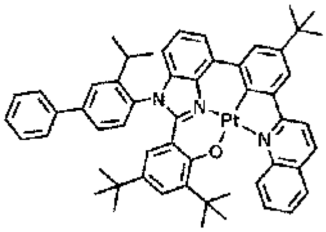
3-538

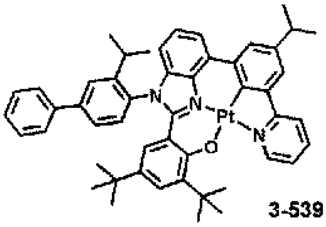
3-539

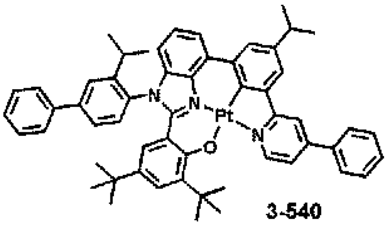
3-540

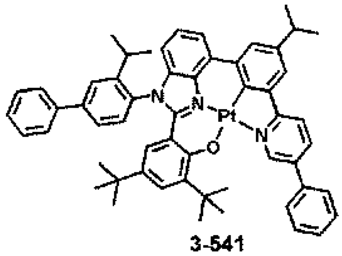
3-541

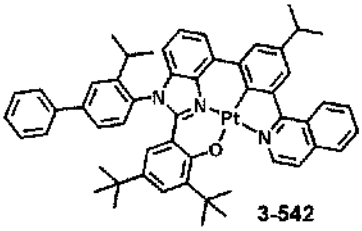
3-542

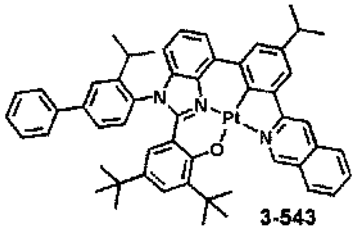
3-543

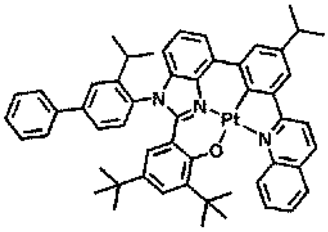
3-544

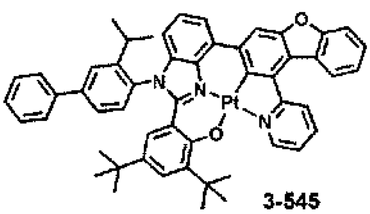
3-545

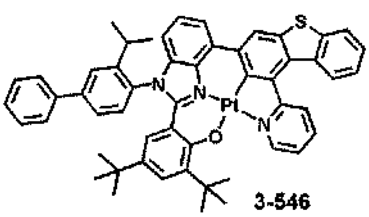
3-546

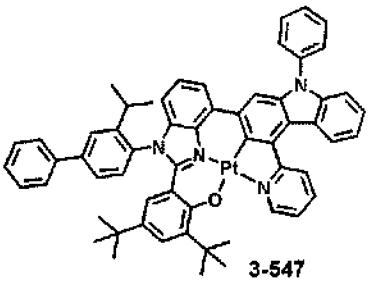
3-547

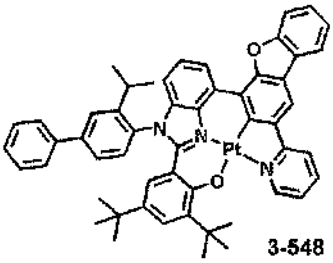
3-548

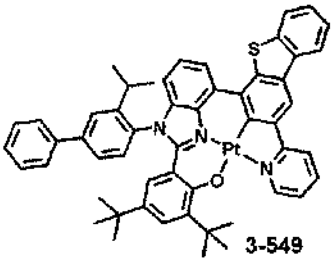
3-549

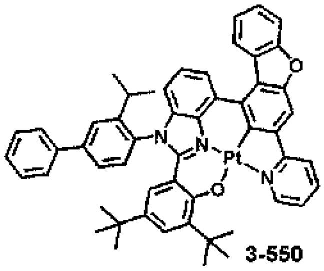
3-550

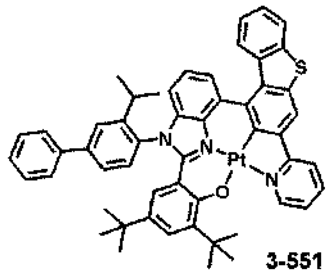

3-551

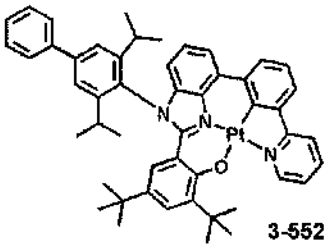

3-552

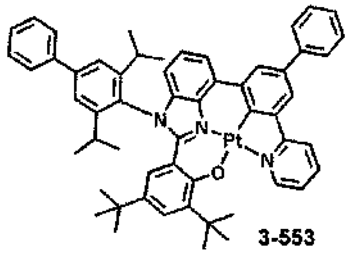

3-553

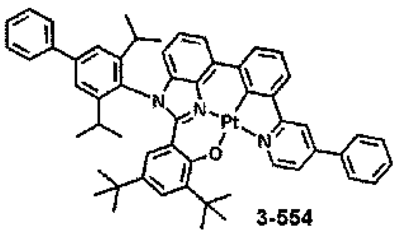

3-554

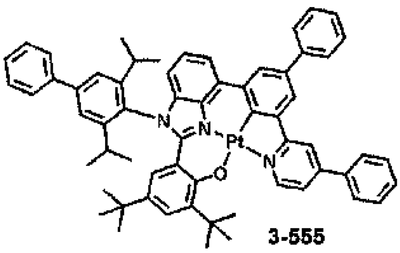

3-555

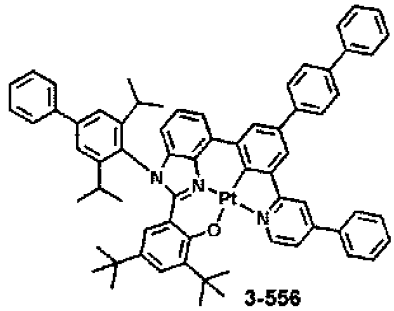

3-556

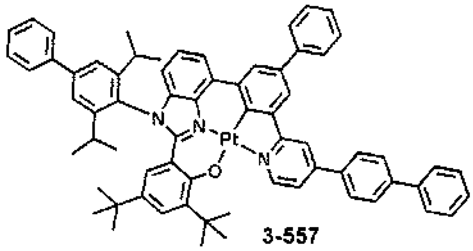

3-557

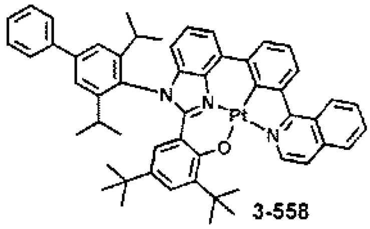

3-558

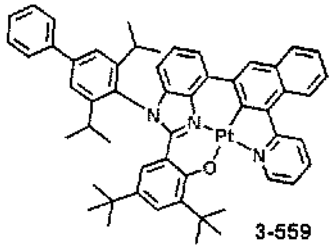

3-559

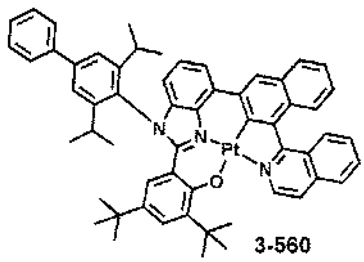

3-560

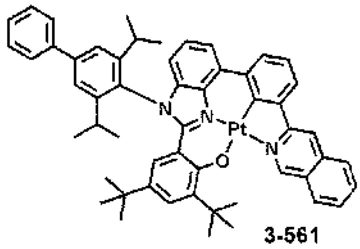

3-561

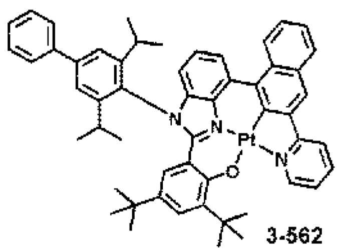

3-562

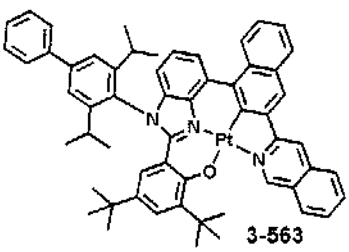

3-563

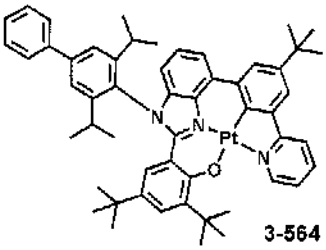

3-564

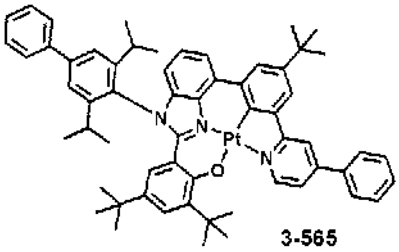

3-565

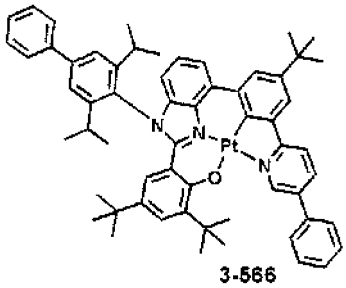
**3-566**

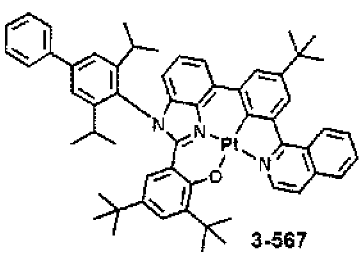
**3-567**

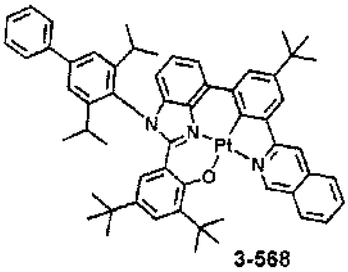
**3-568**

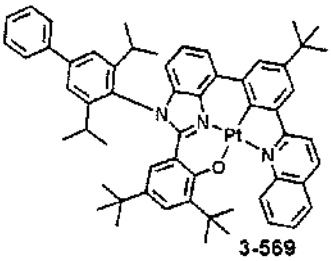
**3-569**

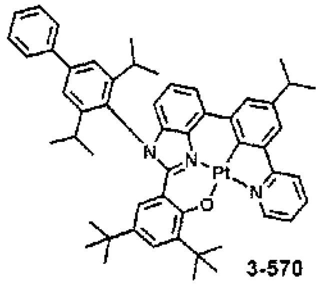
**3-570**

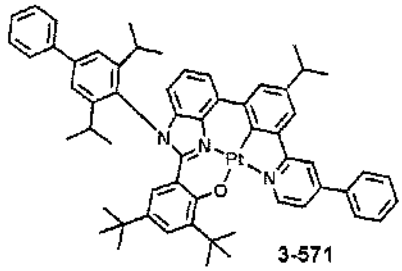
**3-571**

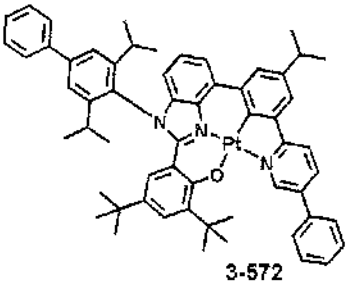
**3-572**

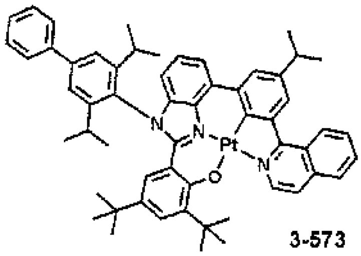
**3-573**

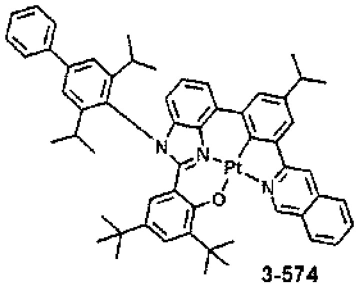
**3-574**

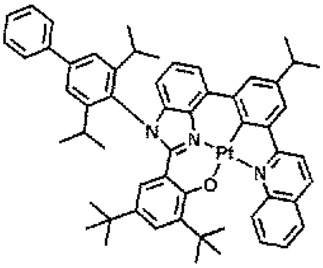
**3-575**

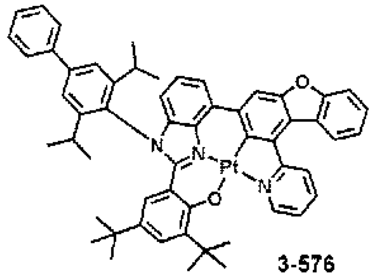
**3-576**

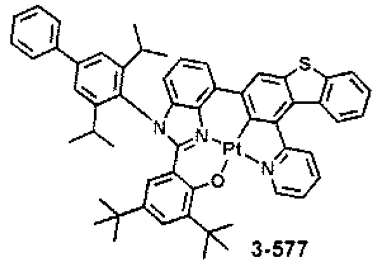
**3-577**

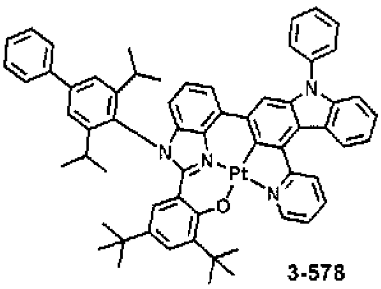
**3-578**

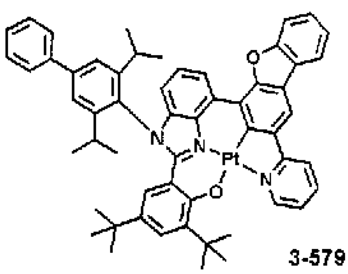
**3-579**

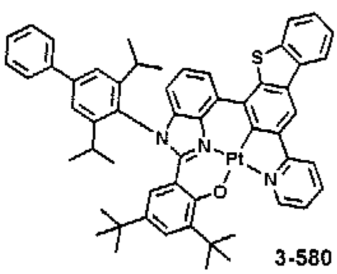
**3-580**

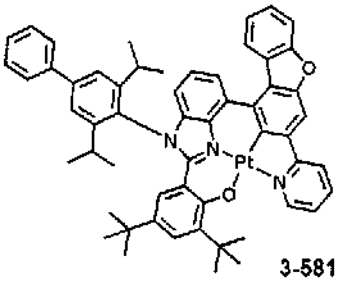

3-581

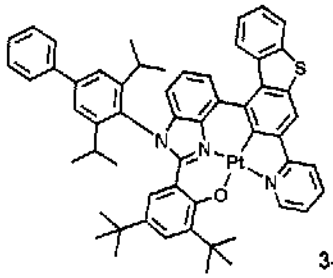

3-582

**6.** Organische lichtemittierende Vorrichtung, die Folgendes beinhaltet:

eine erste Elektrode;
eine zweite Elektrode; und
eine organische Schicht, die zwischen der ersten Elektrode und der zweiten Elektrode angeordnet ist, wobei die organische Schicht eine Emissionsschicht beinhaltet und wobei die organische Schicht mindestens organometallische Verbindung gemäß einem der Ansprüche 1-5 beinhaltet;
wobei bevorzugt die erste Elektrode eine Anode ist, die zweite Elektrode eine Kathode ist, die organische Schicht ferner eine Lochtransportregion, die zwischen der ersten Elektrode und der Emissionsschicht angeordnet ist, und eine Elektronentransportregion, die zwischen der Emissionsschicht und der zweiten Elektrode angeordnet ist, die Lochtransportregion eine Lochinjektionsschicht, eine Lochtransportschicht, eine Elektronenblockierschicht oder eine Kombination davon beinhaltet; und die Elektronentransportregion eine Lochblockierschicht, eine Elektronentransportschicht, eine Elektroneninjektionsschicht oder eine Kombination davon beinhaltet.

**7.** Organische lichtemittierende Vorrichtung gemäß Anspruch 6, wobei die Emissionsschicht die organometallische Verbindung beinhaltet;
wobei bevorzugt die Emissionsschicht ferner einen Wirt beinhaltet und eine Menge des Wirts in der Emissionsschicht größer als eine Menge der organometallischen Verbindung in der Emissionsschicht ist.

## Revendications

**1.** Composé organométallique représenté par la Formule 1-1 :

Formule 1-1

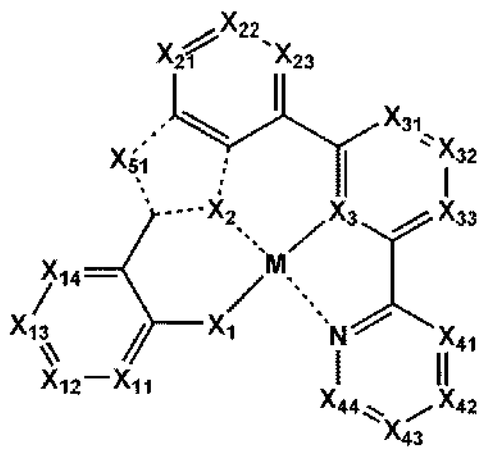

Formule **1-1** ,

dans lequel, dans la Formule 1-1,

M représente le béryllium (Be), le magnésium (Mg), l'aluminium (Al), le calcium (Ca), le titane (Ti), le manganèse

(Mn), le cobalt (Co), le cuivre (Cu), le zinc (Zn), le gallium (Ga), le germanium (Ge), le zirconium (Zr), le ruthénium (Ru), le rhodium (Rh), le palladium (Pd), l'argent (Ag), le rhénium (Re), le platine (Pt), ou l'or (Au),
$X_1$ représente O ou S, et une liaison entre $X_1$ et M est une liaison covalente,

i) $X_2$ représente N, $X_3$ représente C, une liaison entre $X_2$ et M est une liaison dative, et une liaison entre $X_3$ et M est une liaison covalente ;
ou ii) $X_3$ représente N, $X_2$ représente C, une liaison entre $X_3$ et M est une liaison dative, et une liaison entre $X_2$ et M est une liaison covalente, $X_{51}$ est choisi parmi O, S, N-[$(L_7)_{b7}$-$(R_7)_{c7}$], C($R_7$)($R_8$), Si($R_7$)($R_8$), et C(=O), $R_7$ et $R_8$ sont éventuellement liés par l'intermédiaire d'un premier groupe de liaison afin de former un groupe carbocyclique en $C_5$-$C_{30}$ substitué ou non substitué ou un groupe hétérocyclique en $C_1$-$C_{30}$ substitué ou non substitué, et le premier groupe de liaison peut être choisi parmi une liaison simple, *-O-*', *-S-*', *-C($R_5$)($R_6$)-*', *-C($R_5$)=*', *=C($R_6$)-*', *-C($R_5$)=C($R_6$)-*', *-C(=O)-*', *-C(=S)-*', *-C$\equiv$C-*', *-N($R_5$)-*' et *-Si($R_5$)($R_6$)-*', $R_5$ et $R_6$ sont chacun indépendamment les mêmes que décrits en connexion avec $R_7$ décrit ci-dessous, et * et *' indiquent chacun un site de liaison à un atome voisin, $L_7$ est choisi parmi un groupe carbocyclique en $C_5$-$C_{30}$ substitué ou non substitué et un groupe hétérocyclique en $C_1$-$C_{30}$ substitué ou non substitué, b7 est un nombre entier compris entre 0 et 5,

$R_7$, et $R_8$ sont chacun indépendamment choisis parmi l'hydrogène, le deutérium, -F, -Cl, -Br, -I, -$SF_5$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$ substitué ou non substitué, un groupe alcényle en $C_2$-$C_{60}$ substitué ou non substitué, un groupe alcynyle en $C_2$-$C_{60}$ substitué ou non substitué, un groupe alcoxy en $C_1$-$C_{60}$ substitué ou non substitué, un groupe cycloalkyle en $C_3$-$C_{10}$ substitué ou non substitué, un groupe hétérocycloalkyle en $C_1$-$C_{10}$ substitué ou non substitué, un groupe cycloalcényle en $C_3$-$C_{10}$ substitué ou non substitué, un groupe hétérocycloalcényle en $C_1$-$C_{10}$ substitué ou non substitué, un groupe aryle en $C_6$-$C_{60}$ substitué ou non substitué, un groupe aryloxy en $C_6$-$C_{60}$ substitué ou non substitué, un groupe arylthio en $C_6$-$C_{60}$ substitué ou non substitué, un groupe arylalkyle en $C_7$-$C_{60}$ substitué ou non substitué, un groupe hétéroaryle en $C_1$-$C_{60}$ substitué ou non substitué, un groupe hétéroaryloxy en $C_2$-$C_{60}$ substitué ou non substitué, un groupe hétéroarylthio en $C_2$-$C_{60}$ substitué ou non substitué, un groupe hétéroarylalkyle en $C_3$-$C_{60}$ substitué ou non substitué, un groupe polycyclique condensé non aromatique monovalent substitué ou non substitué, un groupe hétéropolycyclique condensé non aromatique monovalent substitué ou non substitué, -N($Q_1$)($Q_2$), -Si($Q_3$)($Q_4$)($Q_5$), -B($Q_6$)($Q_7$), et -P(=O)($Q_8$)($Q_9$), c7 est un nombre entier compris entre 1 et 5,
$X_{11}$ représente N ou C-[$(L_{11})_{b11}$-$(R_{11})_{c11}$], $X_{12}$ représente N ou C-[$(L_{12})_{b12}$-$(R_{12})_{c12}$], $X_{13}$ représente N ou C-[$(L_{13})_{b13}$-$(R_{13})_{c13}$], $X_{14}$ représente N ou C-[$(L_{14})_{b14}$-$(R_{14})_{c14}$],
$L_{11}$ à $L_{14}$, b11 à b14, $R_{11}$ à $R_{14}$ et c11 à c14 sont chacun indépendamment les mêmes que décrits en connexion avec $L_7$, b7, $R_7$, et c7 ci-dessus, respectivement,
$X_{21}$ représente N ou C-[$(L_{21})_{b21}$-$(R_{21})_{c21}$], $X_{22}$ représente N ou C-[$(L_{22})_{b22}$-$(R_{22})_{c22}$], $X_{23}$ représente N ou C-[$(L_{23})_{b23}$-$(R_{23})_{c23}$],
$L_{21}$ à $L_{23}$, b21 à b23, $R_{21}$ à $R_{23}$ et c21 à c23 sont chacun indépendamment les mêmes que décrits en connexion avec $L_7$, b7, $R_7$, et c7 ci-dessus, respectivement,
$X_{31}$ représente N ou C-[$(L_{31})_{b31}$-$(R_{31})_{c31}$], $X_{32}$ représente N ou C-[$(L_{32})_{b32}$-$(R_{32})_{c32}$], $X_{33}$ représente N ou C-[$(L_{33})_{b33}$-$(R_{33})_{c33}$],
$L_{31}$ à $L_{33}$, b31 à b33, $R_{31}$ à $R_{33}$ et c31 à c33 sont chacun indépendamment les mêmes que décrits en connexion avec $L_7$, b7, $R_7$, et c7 ci-dessus,
$X_{41}$ représente N ou C-[$(L_{41})_{b41}$-$(R_{41})_{c41}$], $X_{42}$ représente N ou C-[$(L_{42})_{b42}$-$(R_{42})_{c42}$], $X_{43}$ représente N ou C-[$(L_{43})_{b43}$-$(R_{43})_{c43}$], $X_{44}$ représente N ou C-[$(L_{44})_{b44}$-$(R_{44})_{c44}$],
$L_{41}$ à $L_{44}$, b41 à b44, $R_{41}$ à $R_{44}$ et c41 à c44 sont chacun indépendamment les mêmes que décrits en connexion avec $L_7$, b7, $R_7$, et c7 ci-dessus, deux groupes choisis parmi $R_{11}$ à $R_{14}$ sont éventuellement liés afin de former un groupe carbocyclique en $C_5$-$C_{30}$ substitué ou non substitué ou un groupe hétérocyclique en $C_1$-$C_{30}$ substitué ou non substitué, deux groupes choisis parmi $R_{21}$ à $R_{23}$ sont éventuellement liés afin de former un groupe carbocyclique en $C_5$-$C_{30}$ substitué ou non substitué ou un groupe hétérocyclique en $C_1$-$C_{30}$ substitué ou non substitué, deux groupes choisis parmi $R_{31}$ à $R_{33}$ sont éventuellement liés afin de former un groupe carbocyclique en $C_5$-$C_{30}$ substitué ou non substitué ou un groupe hétérocyclique en $C_1$-$C_{30}$ substitué ou non substitué, et deux groupes choisis parmi $R_{41}$ à $R_{44}$ sont éventuellement liés afin de former un groupe carbocyclique en $C_5$-$C_{30}$ substitué ou non substitué ou un groupe hétérocyclique en $C_1$-$C_{30}$ substitué ou non substitué,
dans les cas où i)-vii) ci-dessous s'appliquent, au moins un groupe choisi parmi $R_{11}$ à $R_{14}$, $R_{21}$ à $R_{23}$, $R_{31}$ à $R_{33}$ et $R_{41}$ à $R_{44}$ est choisi parmi un groupe cycloalkyle en $C_3$-$C_{10}$ substitué ou non substitué, un groupe hétérocycloalkyle en $C_1$-$C_{10}$ substitué ou non substitué, un groupe cycloalcényle en $C_3$-$C_{10}$ substitué ou non

substitué, un groupe hétérocycloalcényle en $C_1$-$C_{10}$ substitué ou non substitué, un groupe aryle en $C_6$-$C_{60}$ substitué ou non substitué, un groupe hétéroaryle en $C_1$-$C_{60}$ substitué ou non substitué, un groupe polycyclique condensé non aromatique monovalent substitué ou non substitué, et un groupe hétéropolycyclique condensé non aromatique monovalent substitué ou non substitué,

i) M représente Pt, ii) $X_1$ représente O, iii) $X_2$ représente N, $X_3$ représente C, une liaison entre $X_2$ et M est une liaison dative, et une liaison entre $X_3$ et M est une liaison covalente, iv) les deux liaisons provenant de $X_{51}$ indiquées par une ligne pointillée représentent chacune une liaison simple, v) $X_{11}$, $X_{12}$, $X_{13}$, $X_{14}$, $X_{21}$, $X_{22}$ $X_{23}$, $X_{31}$, $X_{32}$, $X_{33}$, $X_{41}$, $X_{42}$, $X_{43}$ et $X_{44}$ are C-[$(L_{11})_{b11}$-$(R_{11})_{c11}$], C-[$(L_{12})_{b12}$-$(R_{12})_{c12}$], C-[$(L_{13})_{b13}$-$(R_{13})_{c13}$], C-[$(L_{14})_{b14}$-$(R_{14})_{c14}$], C-[$(L_{21})$b$_{21}$-$(R_{21})_{c21}$], C-[$(L_{22})_{b22}$-$(R_{22})_{c22}$], C-[$(L_{23})_{b23}$-$(R_{23})_{23}$], C-[$(L_{31})_{b31}$-$(R_{31})_{c31}$], C-[$(L_{32})_{b32}$-$(R_{32})_{c32}$], C-[$(L_{33})_{b33}$-$(R_{33})_{33}$], C-[$(L_{41})_{b41}$-$(R_{41})_{c41}$], C-[$(L_{42})_{b42}$-$(R_{42})_{c42}$], C-[$(L_{43})_{b43}$-$(R_{43})_{c43}$] et C-[$(L_{44})_{b44}$-$(R_{44})_{c44}$], respectivement, vi) $X_{51}$ représente O, S, ou N-[$(L_7)_{b7}$-$(R_7)_{c7}$], et vii) b7 vaut 0, c7 vaut 1, et $R_7$ représente un groupe alkyle en $C_1$-$C_{60}$ substitué ou non substitué ;

au moins un substituant du groupe carbocyclique en $C_5$-$C_{30}$ substitué, du groupe hétérocyclique en $C_1$-$C_{30}$ substitué, du groupe alkyle en $C_1$-$C_{60}$ substitué, du groupe alcényle en $C_2$-$C_{60}$ substitué, du groupe alcynyle en $C_2$-$C_{60}$ substitué, du groupe alcoxy en $C_1$-$C_{60}$ substitué, du groupe cycloalkyle en $C_3$-$C_{10}$ substitué, du groupe hétérocycloalkyle en $C_1$-$C_{10}$ substitué, du groupe cycloalcényle en $C_3$-$C_{10}$ substitué, du groupe hétérocycloalcényle en $C_1$-$C_{10}$ substitué, du groupe aryle en $C_6$-$C_{60}$ substitué, du groupe aryloxy en $C_6$-$C_{60}$ substitué, du groupe arylthio en $C_6$-$C_{60}$ substitué, du groupe arylalkyle en $C_7$-$C_{60}$ substitué, du groupe hétéroaryle en $C_1$-$C_{60}$ substitué, du groupe hétéroaryloxy en $C_2$-$C_{60}$ substitué, du groupe hétéroarylthio en $C_2$-$C_{60}$ substitué, du groupe hétéroarylalkyle en $C_3$-$C_{60}$ substitué, du groupe polycyclique condensé non aromatique monovalent substitué, et du groupe hétéropolycyclique condensé non aromatique monovalent substitué est choisi parmi :

le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alcényle en $C_2$-$C_{60}$, un groupe alcényle en $C_2$- $C_{60}$, et un groupe alcoxy en $C_1$-$C_{60}$ ;

un groupe alkyle en $C_1$-$C_{60}$, un groupe alcényle en $C_2$-$C_{60}$, un groupe alcynyle en $C_2$-$C_{60}$, et un groupe alcoxy en $C_1$-$C_{60}$, chacun étant chacun étant substitué par au moins un groupe choisi parmi le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe arylalkyle en $C_7$-$C_{60}$, un groupe hétéroaryle en $C_1$-$C_{60}$, un groupe hétéroaryloxy en $C_2$-$C_{60}$, un groupe hétéroarylthio en $C_2$-$C_{60}$, un groupe hétéroarylalkyle en $C_3$-$C_{60}$, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-B(Q_{16})(Q_{17})$, et $-P(=O)(Q_{18})(Q_{19})$ ;

un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe arylalkyle en $C_7$-$C_{60}$, un groupe hétéroaryle en $C_1$-$C_{60}$, un groupe hétéroaryloxy en $C_2$-$C_{60}$, un groupe hétéroarylthio en $C_2$-$C_{60}$, un groupe hétéroarylalkyle en $C_3$-$C_{60}$, un groupe polycyclique condensé non aromatique monovalent, et un groupe hétéropolycyclique condensé non aromatique monovalent ;

un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe arylalkyle en $C_7$-$C_{60}$, un groupe hétéroaryle en $C_1$-$C_{60}$, un groupe hétéroaryloxy en $C_2$-$C_{60}$, un groupe hétéroarylthio en $C_2$-$C_{60}$, un groupe hétéroarylalkyle en $C_3$-$C_{60}$, un groupe polycyclique condensé non aromatique monovalent, et un groupe hétéropolycyclique condensé non aromatique monovalent, chacun étant substitué par au moins un groupe choisi parmi le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe arylalkyle en $C_7$-$C_{60}$, un groupe hétéroaryle en $C_1$-$C_{60}$, un groupe hétéroaryloxy en $C_2$-$C_{60}$, un groupe hétéroarylthio en $C_2$-$C_{60}$, un groupe

hétéroarylalkyle en $C_3$-$C_{60}$, un groupe polycyclique condensé non aromatique monovalent, un groupe hétéropolycyclique condensé non aromatique monovalent, -N($Q_{21}$)($Q_{22}$), Si($Q_{23}$)($Q_{24}$)($Q_{25}$), -B($Q_{26}$)($Q_{27}$), et -P(=O)($Q_{28}$)($Q_{29}$) ; et

-N($Q_{31}$)($Q_{32}$), -Si($Q_{33}$)($Q_{34}$)($Q_{35}$), -B($Q_{36}$)($Q_{37}$), et -P(=O)($Q_{38}$)($Q_{39}$), et $Q_1$ à $Q_9$, $Q_{11}$ à $Q_{19}$, $Q_{21}$ à $Q_{29}$, et $Q_{31}$ à $Q_{39}$ sont chacun indépendamment choisis parmi l'hydrogène, le deutérium, -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$, un groupe alkyle en $C_1$-$C_{60}$ substitué par au moins un groupe choisi parmi le deutérium, un groupe alkyle en $C_1$-$C_{60}$, et un groupe aryle en $C_6$-$C_{60}$, un groupe alcényle en $C_2$-$C_{60}$, un groupe alcynyle en $C_2$-$C_{60}$, un groupe alcoxy en $C_1$-$C_{60}$, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryle en $C_6$-$C_{60}$ substitué par au moins un groupe choisi parmi le deutérium, un groupe alkyle en $C_1$-$C_{60}$, et un groupe aryle en $C_6$-$C_{60}$, un groupe aryloxy en $C_6$-$C_{60}$, un groupe arylthio en $C_6$-$C_{60}$, un groupe arylalkyle en $C_7$-$C_{60}$, un groupe hétéroaryle en $C_1$-$C_{60}$, un groupe hétéroaryloxy en $C_2$-$C_{60}$, un groupe hétéroarylthio en $C_2$-$C_{60}$, un groupe hétéroarylalkyle en $C_3$-$C_{60}$, un groupe polycyclique condensé non aromatique monovalent, et un groupe hétéropolycyclique condensé non aromatique monovalent.

**2.** Composé organométallique selon la revendication 1, dans lequel $R_7$ et $R_8$ sont chacun indépendamment choisis parmi :

l'hydrogène, le deutérium, -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, $-SF_5$, un groupe alkyle en $C_1$-$C_{20}$, et un groupe alcoxy en $C_1$-$C_{20}$ ;

un groupe alkyle en $C_1$-$C_{20}$ et un groupe alcoxy en $C_1$-$C_{20}$, chacun étant substitué par au moins un groupe choisi parmi le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{10}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, et un groupe pyrimidinyle ;

un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, et un groupe imidazopyrimidinyle ;

un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe

isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, et un groupe imidazopyrimidinyle, chacun étant substitué par au moins un groupe choisi parmi le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{20}$, un groupe alcoxy en $C_1$-$C_{20}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle, et $-Si(Q_{33})(Q_{34})(Q_{35})$ ; et

$-N(Q_1)(Q_2)$, $-Si(Q_3)(Q_4)(Q_5)$, $-B(Q_6)(Q_7)$, et $-P(=O)(Q_8)(Q_9)$, et $Q_1$ à $Q_9$ et $Q_{33}$ à $Q_{35}$ sont chacun indépendamment choisis parmi :

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, et $-CD_2CDH_2$ ;

un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle ;

et un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle, chacun étant substitué par au moins un groupe choisi parmi le deutérium, un groupe alkyle en $C_1$-$C_{10}$, et un groupe phényle ;

de préférence dans lequel $R_7$ et $R_8$ sont chacun indépendamment choisis parmi l'hydrogène, le deutérium, -F, un groupe cyano, un groupe nitro, $-SF_5$, $-CH_3$, $-CD_3$, $-CD_2H$, $-CDH_2$, $-CF_3$, $-CF_2H$, $-CFH_2$, $-C_2F_5$, $-C_2F_4H$, $-C_2F_3H_2$, $-C_2F_2H_3$, $-C_2FH_4$, les groupes représentés par les Formules 9-1 à 9-19, les groupes représentés par les Formules 10-1 à 10-167, $-N(Q_1)(Q_2)$, $-Si(Q_3)(Q_4)(Q_5)$, $-B(Q_6)(Q_7)$, et $-P(=O)(Q_8)(Q_9)$ :

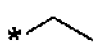
Formule 9-1

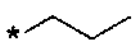
Formule 9-2

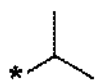
Formule 9-3

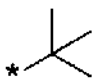
Formule 9-4

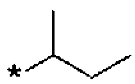
Formule 9-5

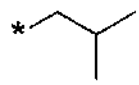
Formule 9-6

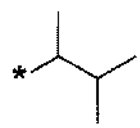
Formule 9-7

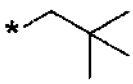
Formule 9-8

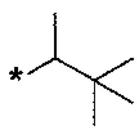
Formule 9-9

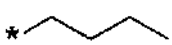
Formule 9-10

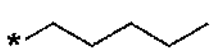
Formule 9-11

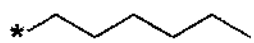
Formule 9-12

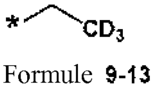
Formule 9-13

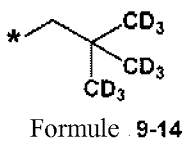
Formule 9-14

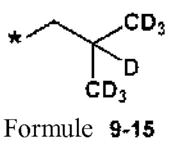
Formule 9-15

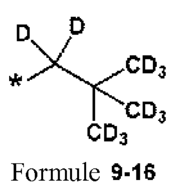
Formule 9-16

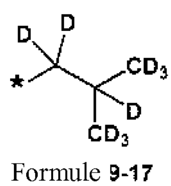
Formule 9-17

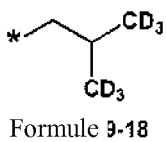
Formule 9-18

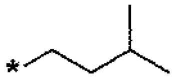

Formule 9-19

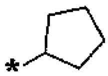
Formule 10-1
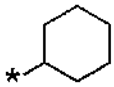
Formule 10-2
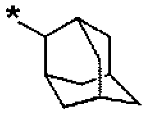
Formule 10-3
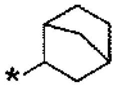
Formule 10-4
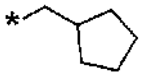
Formule 10-5
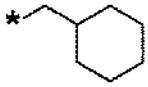
Formule 10-6
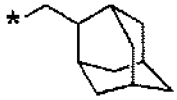
Formule 10-7

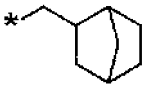
Formule 10-8
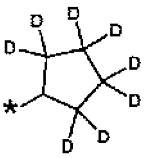
Formule 10-9
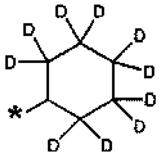
Formule 10-10
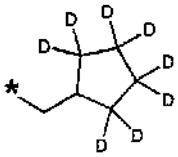
Formule 10-11
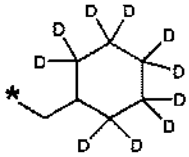
Formule 10-12
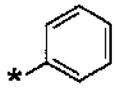
Formule 10-13

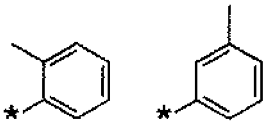
Formule 10-14 Formule 10-15
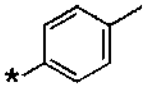
Formule 10-16
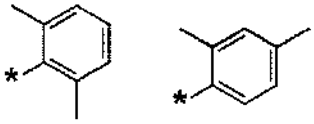
Formule 10-17 Formule 10-18
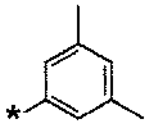
Formule 10-19
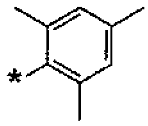
Formule 10-20

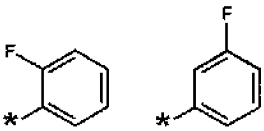
Formule 10-21 Formule 10-22
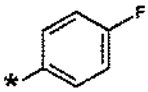
Formule 10-23
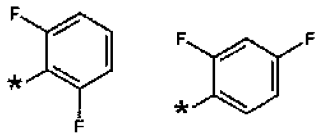
Formule 10-24 Formule 10-25
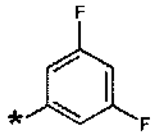
Formule 10-26
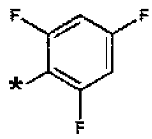
Formule 10-27

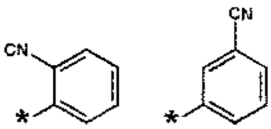
Formule 10-28 Formule 10-29
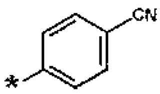
Formule 10-30
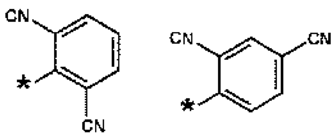
Formule 10-31 Formule 10-32
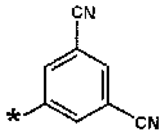
Formule 10-33
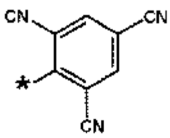
Formule 10-34

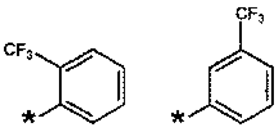
Formule 10-35 Formule 10-36
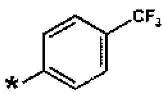
Formule 10-37
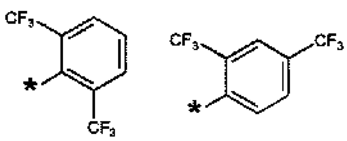
Formule 10-38 Formule 10-39
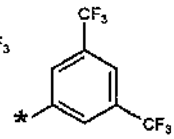
Formule 10-40
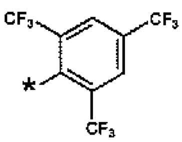
Formule 10-41

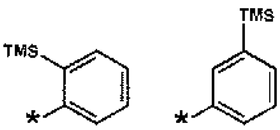
Formule 10-42 Formule 10-43
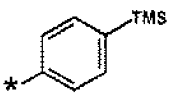
Formule 10-44
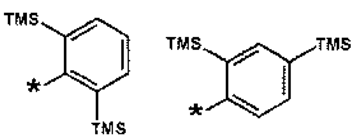
Formule 10-45 Formule 10-46
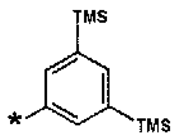
Formule 10-47
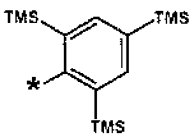
Formule 10-48

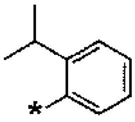
Formule 10-49
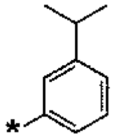
Formule 10-50
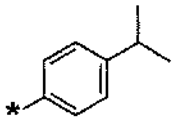
Formule 10-51
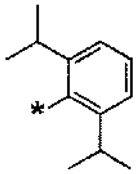
Formule 10-52
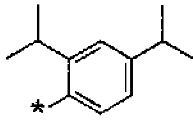
Formule 10-53
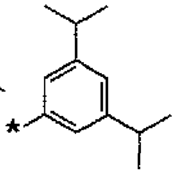
Formule 10-54
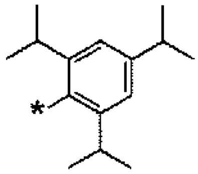
Formule 10-55

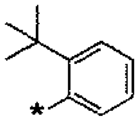
Formule 10-56
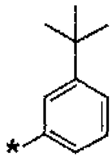
Formule 10-57
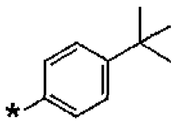
Formule 10-58
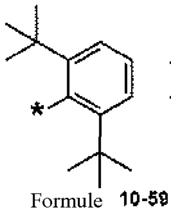
Formule 10-59
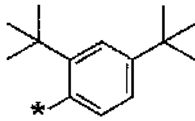
Formule 10-60
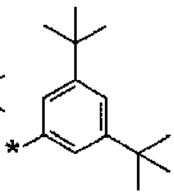
Formule 10-61
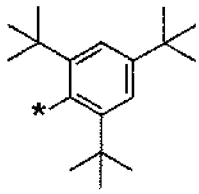
Formule 10-62

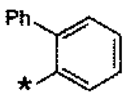
Formule 10-63
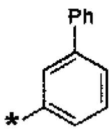
Formule 10-64
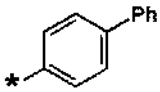
Formule 10-65
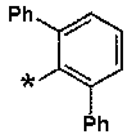
Formule 10-66
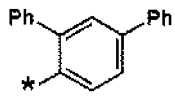
Formule 10-67
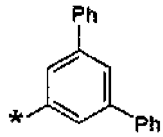
Formule 10-68
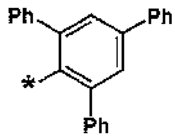
Formule 10-69

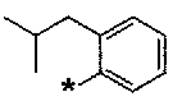
Formule 10-70
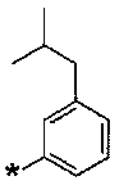
Formule 10-71
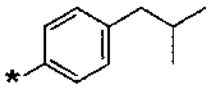
Formule 10-72
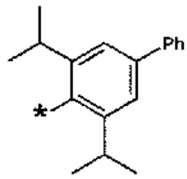
Formule 10-73
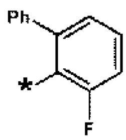
Formule 10-74
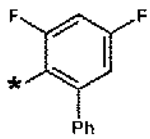
Formule 10-75

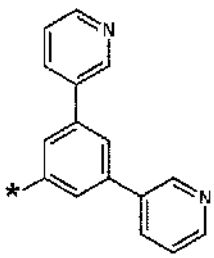
Formule 10-76
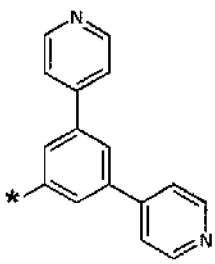
Formule 10-77
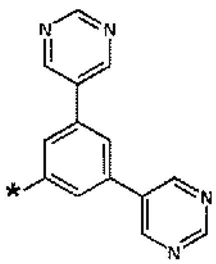
Formule 10-78
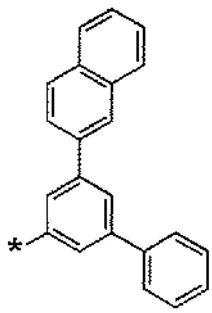
Formule 10-79
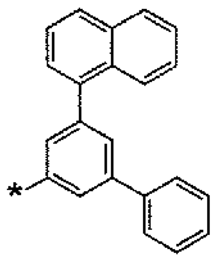
Formule 10-80

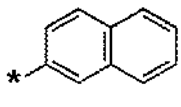
Formule 10-81
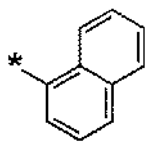
Formule 10-82
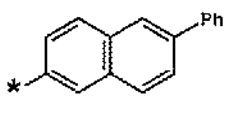
Formule 10-83
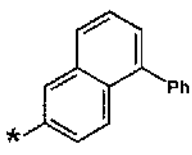
Formule 10-84
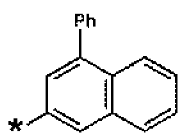
Formule 10-85

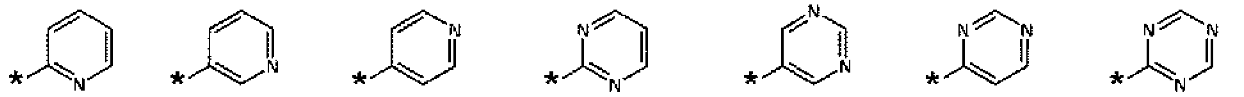

Formule 10-86 Formule 10-87 Formule 10-88 Formule 10-89 Formule 10-90 Formule 10-91 Formule 10-92

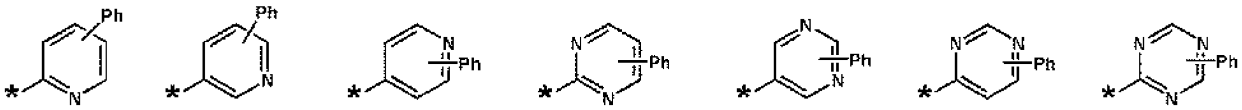

Formule 10-93 Formule 10-94 Formule 10-95 Formule 10-96 Formule 10-97 Formule 10-98 Formule 10-99

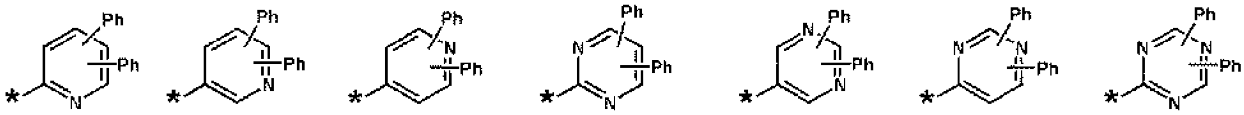

Formule 10-100 Formule 10-101 Formule 10-102 Formule 10-103 Formule 10-104 Formule 10-105 Formule 10-106

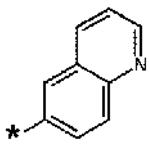
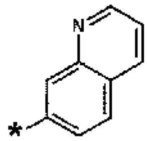
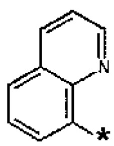
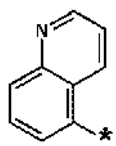
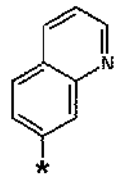
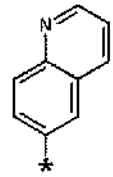

Formule 10-107 Formule 10-108 Formule 10-109 Formule 10-110 Formule 10-111 Formule 10-112

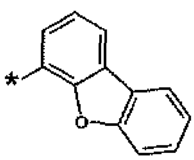
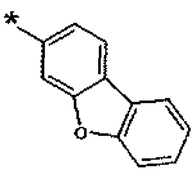
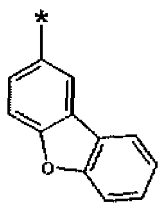
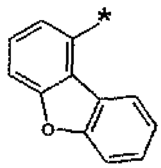
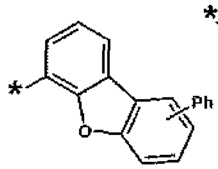
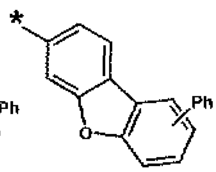

Formule 10-113 Formule 10-114 Formule 10-115 Formule 10-116 Formule 10-117 Formule 10-118

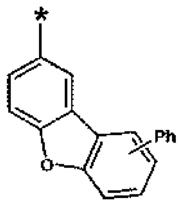
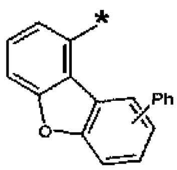
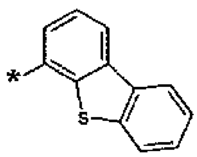
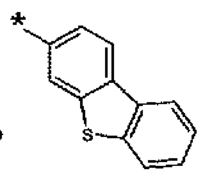
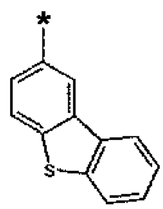
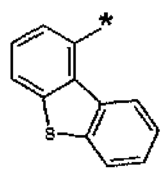

Formule 10-119 Formule 10-120 Formule 10-121 Formule 10-122 Formule 10-123 Formule 10-124

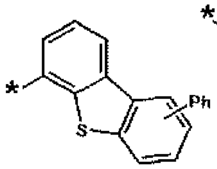
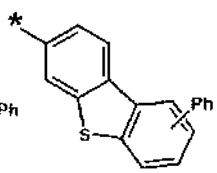
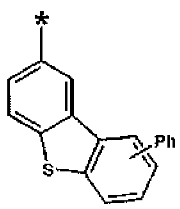
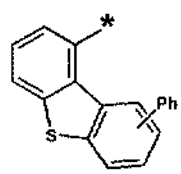
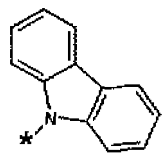
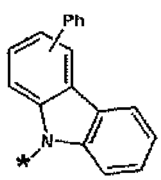

Formule 10-125 Formule 10-126 Formule 10-127 Formule 10-128 Formule 10-129 Formule 10-130

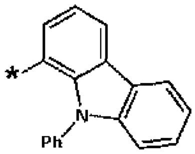 Formule 10-131 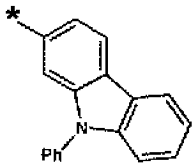 Formule 10-132 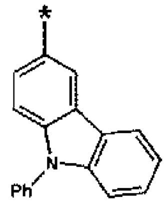 Formule 10-133 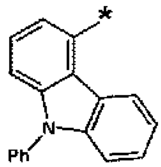 Formule 10-134 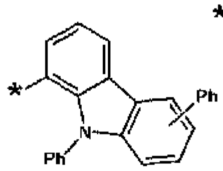 Formule 10-135 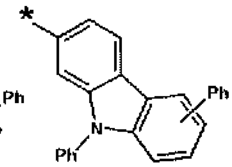 Formule 10-136

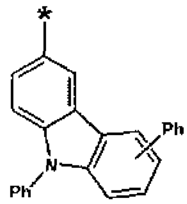 Formule 10-137 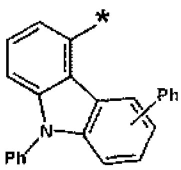 Formule 10-138 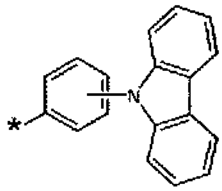 Formule 10-139 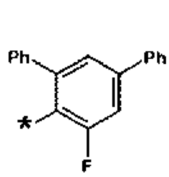 Formule 10-140 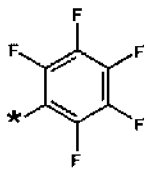 Formule 10-141 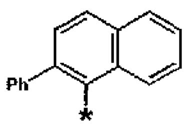 Formule 10-142

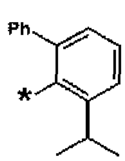 Formule 10-143 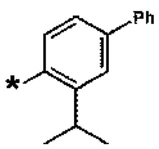 Formule 10-144 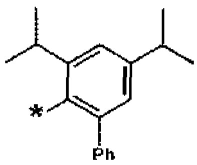 Formule 10-145 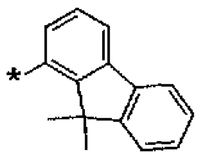 Formule 10-146 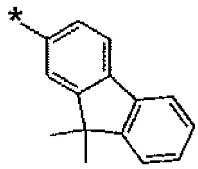 Formule 10-147 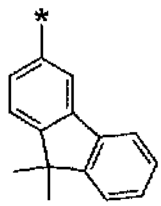 Formule 10-148

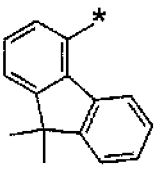 Formule 10-149 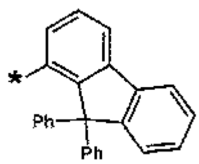 Formule 10-150 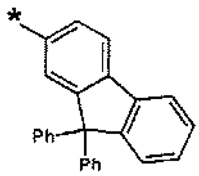 Formule 10-151 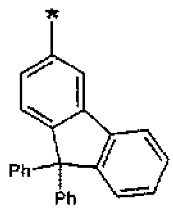 Formule 10-152 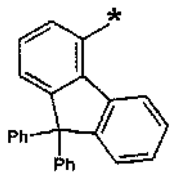 Formule 10-153

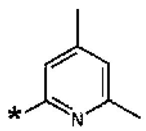 Formule 10-154 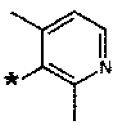 Formule 10-155 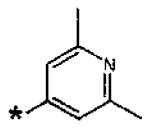 Formule 10-156 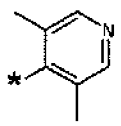 Formule 10-157 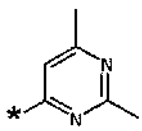 Formule 10-158 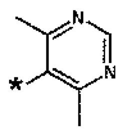 Formule 10-159 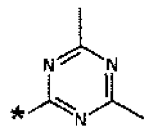 Formule 10-160

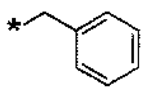 Formule 10-161 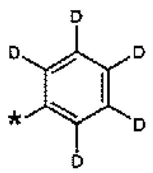 Formule 10-162 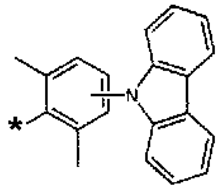 Formule 10-163 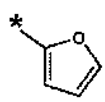 Formule 10-164 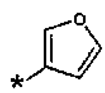 Formule 10-165 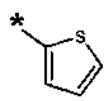 Formule 10-166 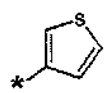 Formule 10-167,

$Q_1$ à $Q_9$ sont chacun indépendamment choisis parmi :

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, et $-CD_2CDH_2$ ;

un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle ;
et un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle, chacun étant substitué par au moins un groupe choisi parmi le deutérium, un groupe alkyle en $C_1$-$C_{10}$, et un groupe phényle, et dans les Formules 9-1 à 9-19 et 10-1 à 10-167,
* indique un site de liaison à un atome voisin ;
Ph indique un groupe phényle ;
et TMS indique un groupe triméthylsilyle.

**3.** Composé organométallique selon la revendication 1 ou la revendication 2, dans lequel

i) les deux liaisons provenant de $X_{51}$ indiquées par une ligne pointillée représentent chacune une liaison simple, et $X_{51}$ représente $C(R_7)(R_8)$, $Si(R_7)(R_8)$, ou C(=O),
ii) les deux liaisons provenant de $X_{51}$ indiquées par une ligne pointillée représentent chacune une liaison simple, $X_{51}$ représente $N$-$[(L_7)_{b7}$-$(R_7)_{c7}]$, et $R_7$ est choisi parmi un groupe cycloalkyle en $C_3$-$C_{10}$ substitué ou non substitué, un groupe hétérocycloalkyle en $C_1$-$C_{10}$ substitué ou non substitué, un groupe cycloalcényle en $C_3$-$C_{10}$ substitué ou non substitué, un groupe hétérocycloalcényle en $C_1$-$C_{10}$ substitué ou non substitué, un groupe aryle en $C_6$-$C_{60}$ substitué ou non substitué, un groupe aryloxy en $C_6$-$C_{60}$ substitué ou non substitué, un groupe arylthio en $C_6$-$C_{60}$ substitué ou non substitué, un groupe arylalkyle en $C_7$-$C_{60}$ substitué ou non substitué, un groupe hétéroaryle en $C_1$-$C_{60}$ substitué ou non substitué, un groupe hétéroaryloxy en $C_2$-$C_{60}$ substitué ou non substitué, un groupe hétéroarylthio en $C_2$-$C_{60}$ substitué ou non substitué, un groupe hétéroarylalkyle en $C_3$-$C_{60}$ substitué ou non substitué, un groupe polycyclique condensé non aromatique monovalent substitué ou non substitué, et un groupe hétéropolycyclique condensé non aromatique monovalent substitué ou non substitué, ou
iii) parmi les deux liaisons provenant de $X_{51}$ indiquées par une ligne pointillée, une liaison représente une liaison unique tandis que son autre liaison représente une double liaison, et $X_{51}$ représente N, $C(R_7)$, ou $Si(R_7)$.

**4.** Composé organométallique selon l'une quelconque des revendications 1 à 3, dans lequel $X_{51}$ représente O, S, ou $N$-$[(L_7)_{b7}$-$(R_7)_{c7}]$, b7 vaut 0, c7 vaut 1, $R_7$ est choisi parmi :

un groupe alkyle en $C_1$-$C_{30}$ ;
et un groupe alkyle en $C_1$-$C_{30}$ substitué par au moins un groupe choisi parmi le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{10}$, un groupe alcoxy en $C_1$-$C_{10}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, et un groupe pyrimidinyle.

**5.** Composé organométallique selon l'une quelconque des revendications 1 à 4, dans lequel le composé organométallique est un composé choisi parmi les Composés 1-1 à 1-88, les Composés 2-1 à 2-47, et les Composés 3-1 à 3-582 :

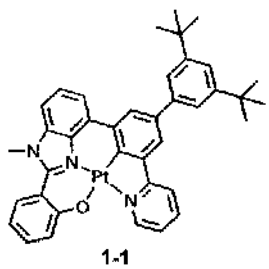
1-1

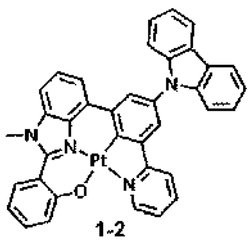
1-2

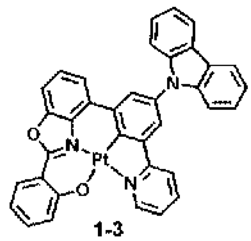
1-3

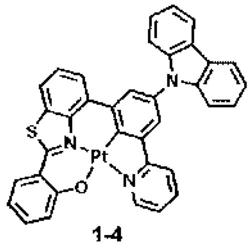
1-4

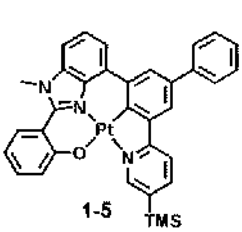
1-5

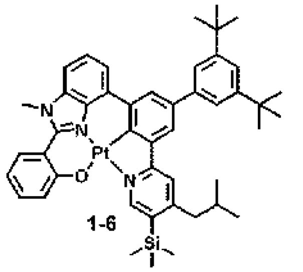
1-6

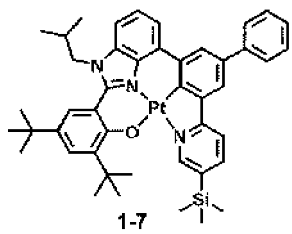
1-7

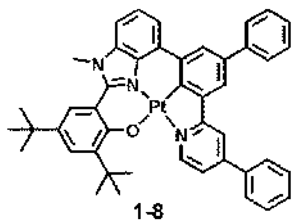
1-8

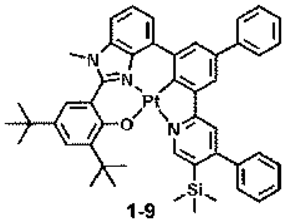
1-9

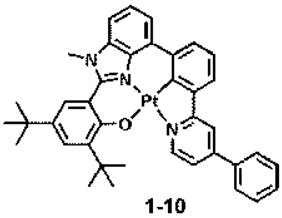
1-10

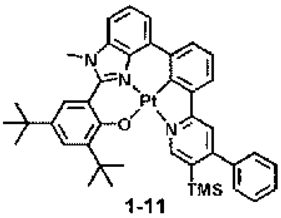
1-11

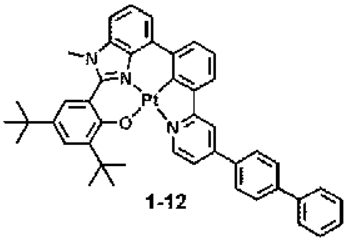
1-12

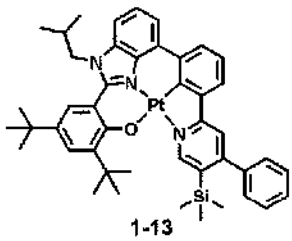
1-13

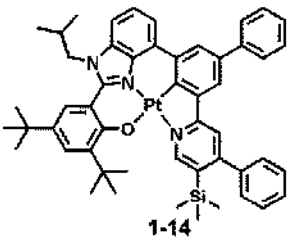
1-14

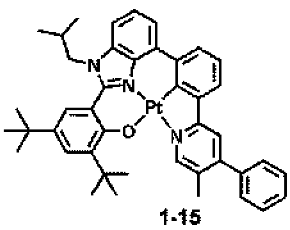
1-15

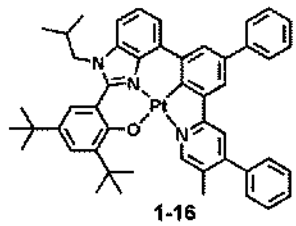
1-16

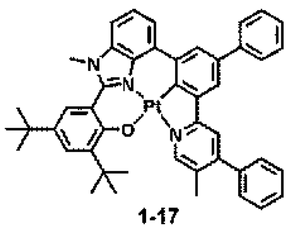
1-17

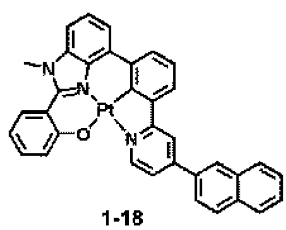
1-18

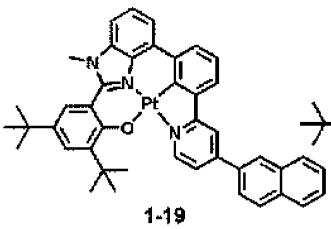
1-19

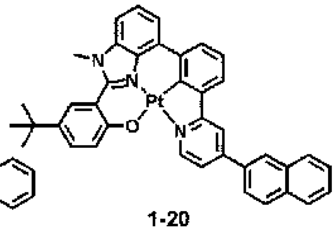
1-20

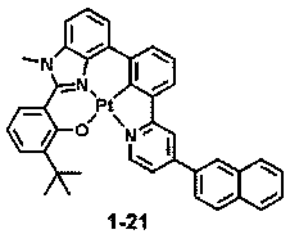
1-21

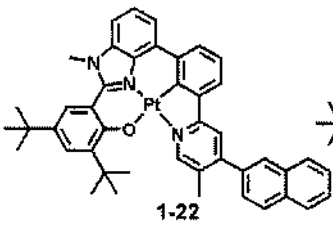
1-22

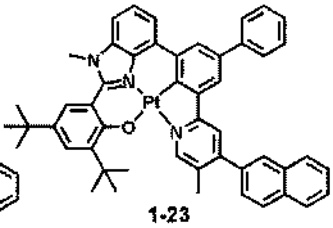
1-23

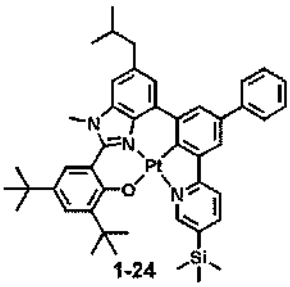
1-24

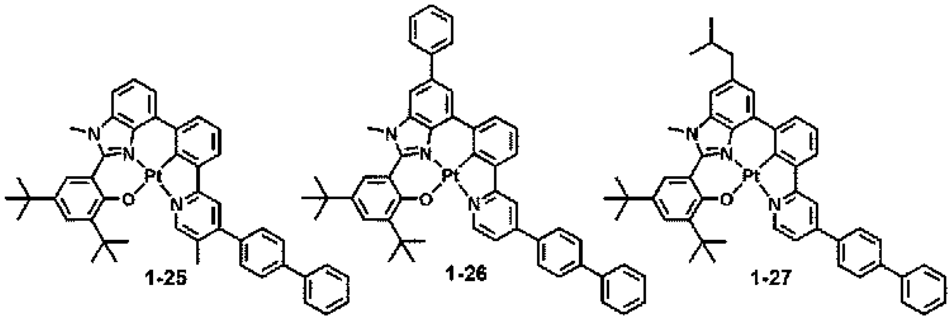

1-25 1-26 1-27

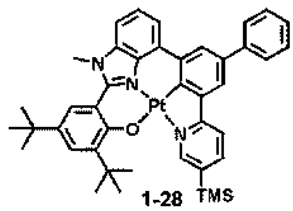

1-28

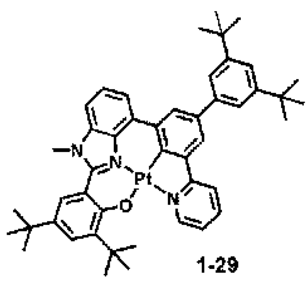

1-29

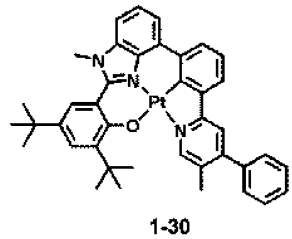

1-30

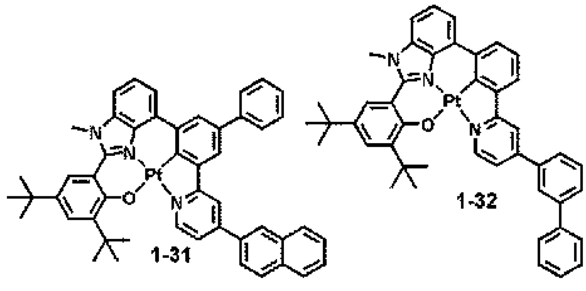

1-31 1-32

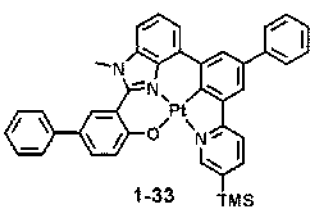

1-33

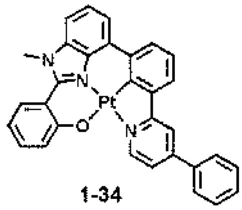

1-34

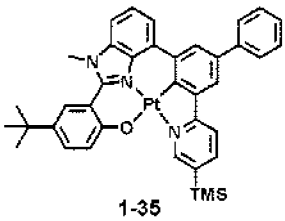

1-35

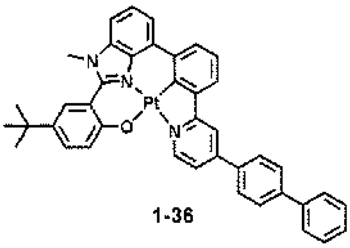

1-36

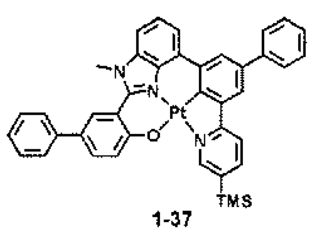

1-37

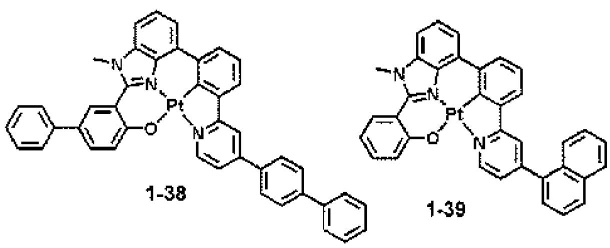

1-38 1-39

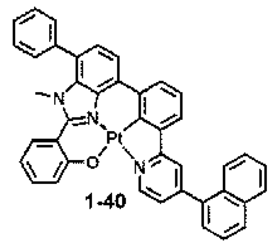

1-40

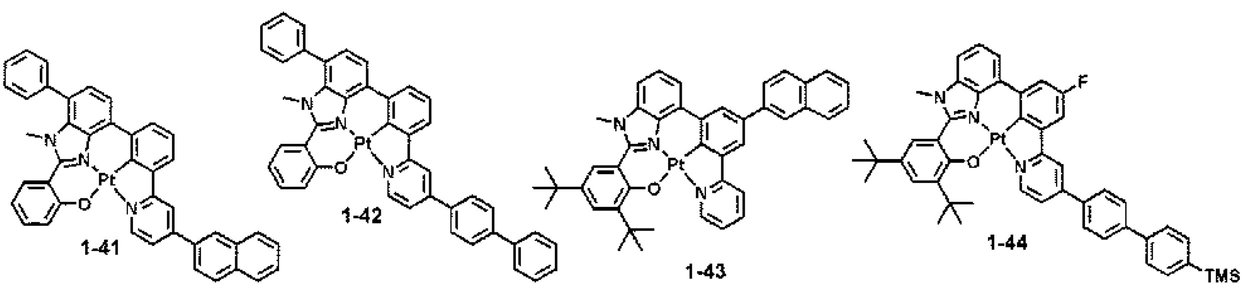

1-41 1-42 1-43 1-44

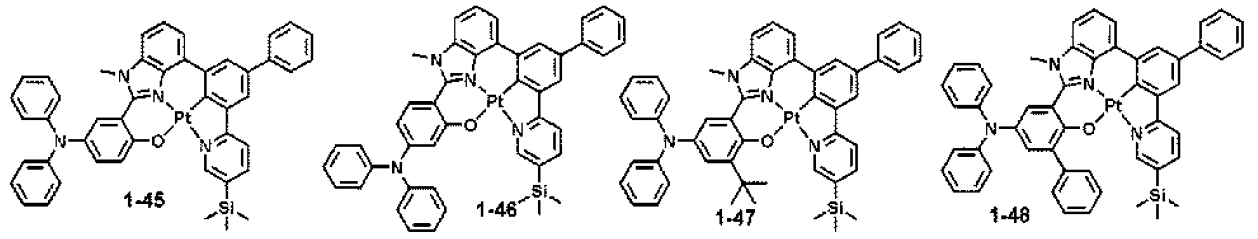

1-45 1-46 1-47 1-48

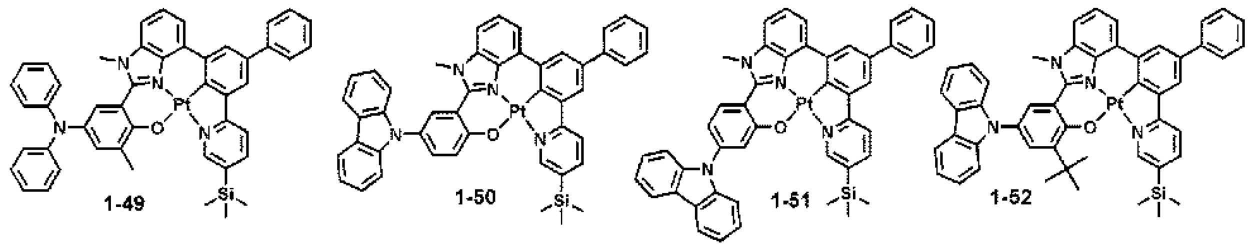

1-49 1-50 1-51 1-52

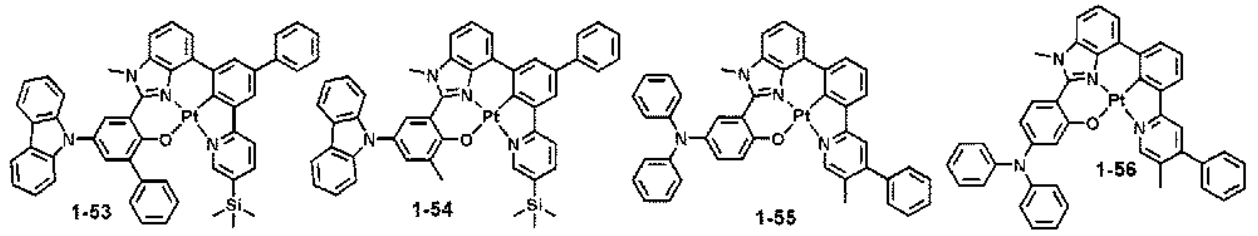

1-53 1-54 1-55 1-56

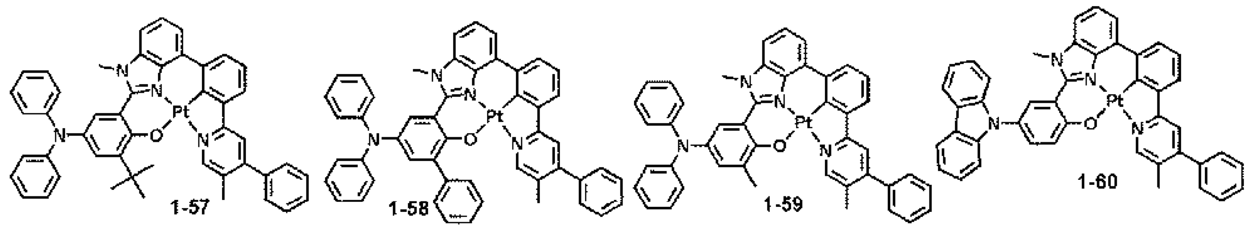

1-57 1-58 1-59 1-60

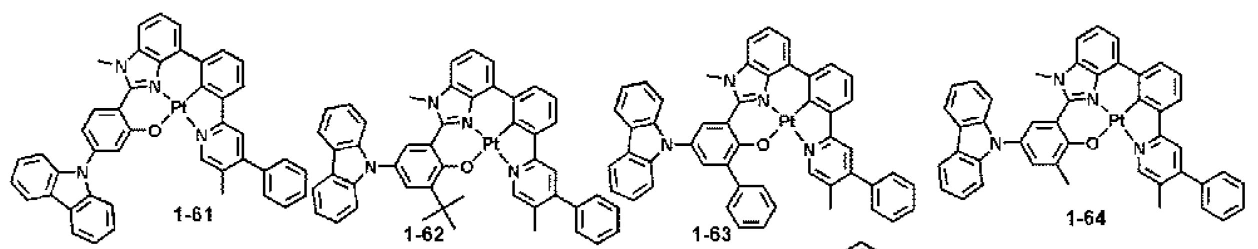

1-61 1-62 1-63 1-64

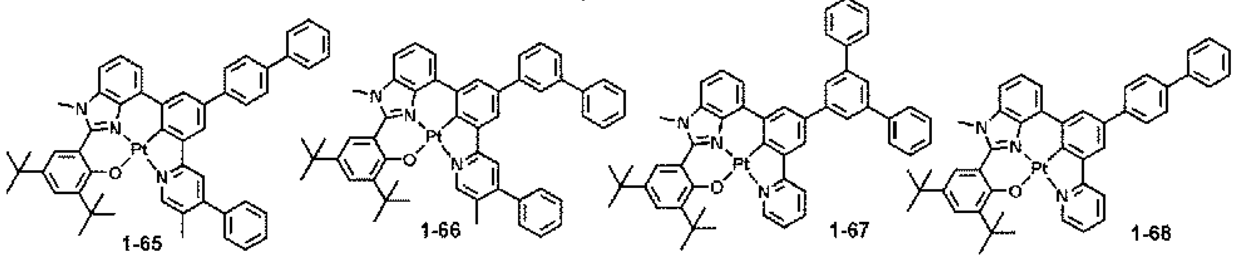

1-65 1-66 1-67 1-68

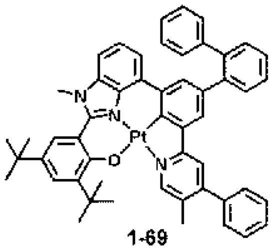
1-69

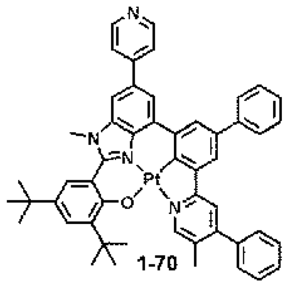
1-70

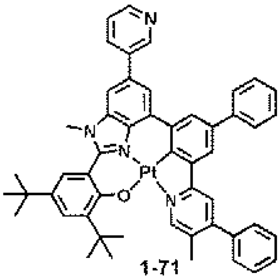
1-71

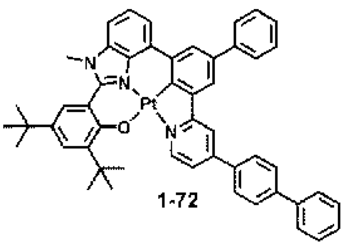
1-72

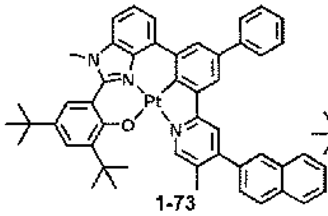
1-73

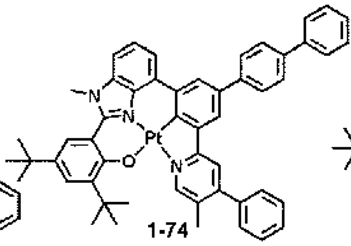
1-74

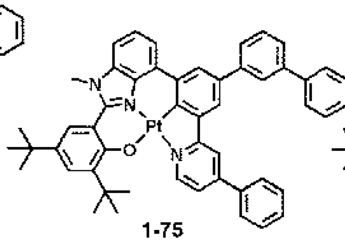
1-75

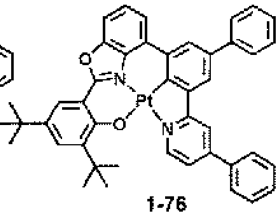
1-76

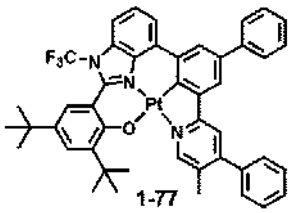
1-77

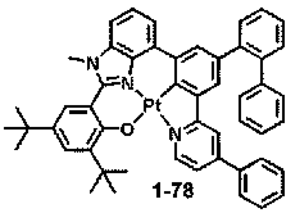
1-78

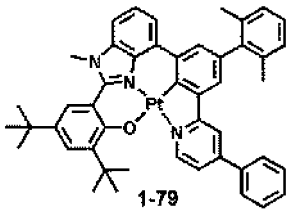
1-79

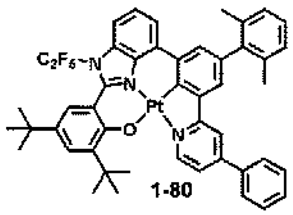
1-80

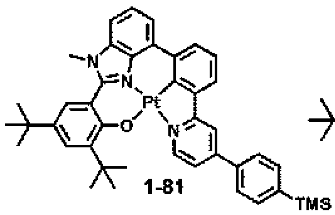
1-81

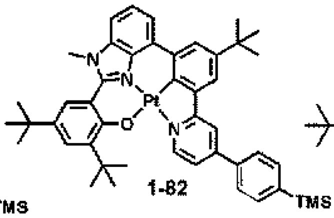
1-82

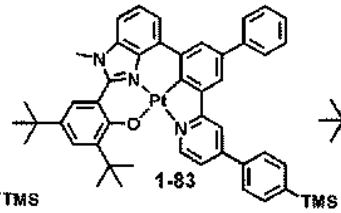
1-83

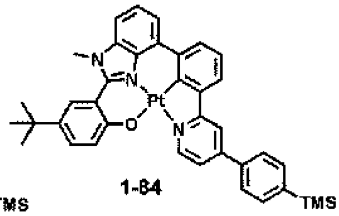
1-84

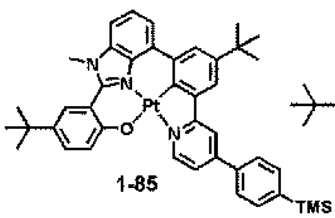
1-85

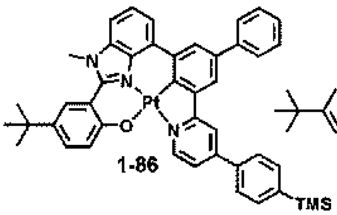
1-86

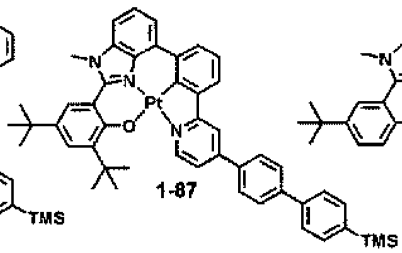
1-87

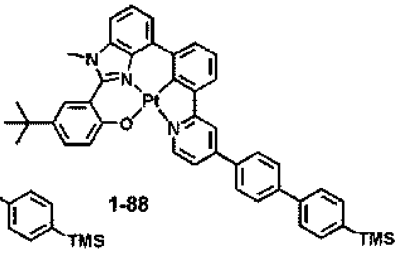
1-88

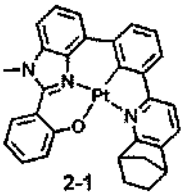
2-1

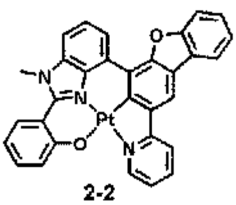
2-2

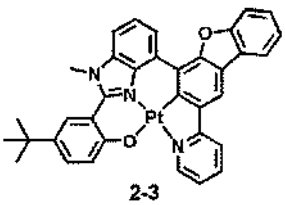
2-3

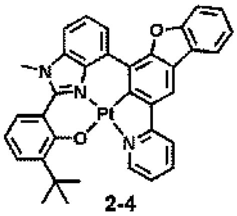
2-4

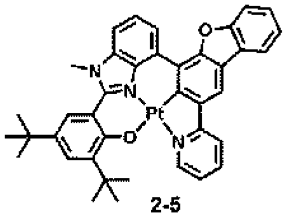
2-5
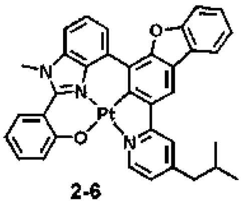
2-6
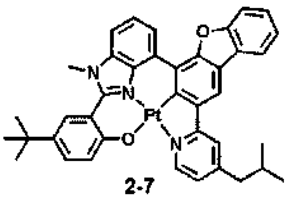
2-7
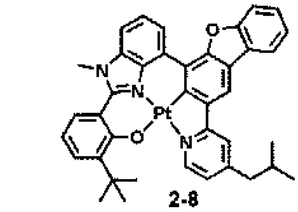
2-8

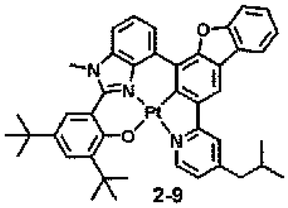
2-9
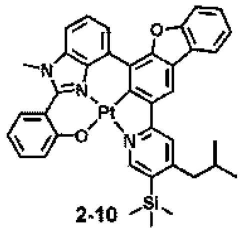
2-10
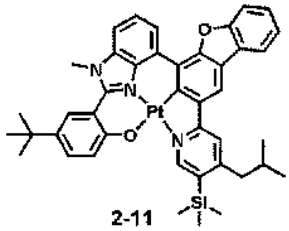
2-11
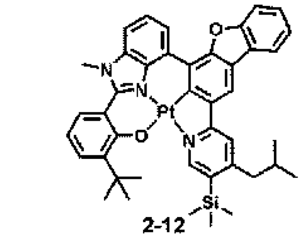
2-12

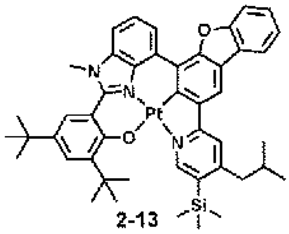
2-13
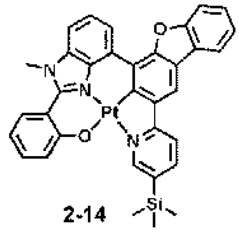
2-14
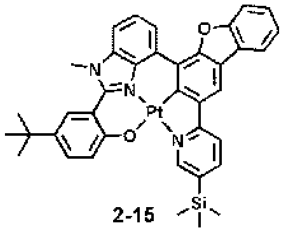
2-15
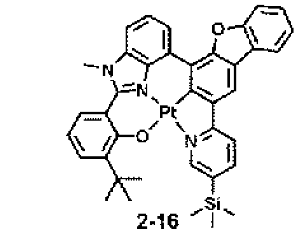
2-16

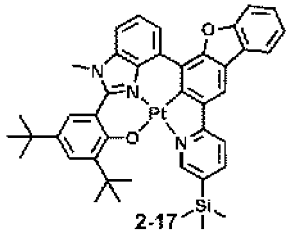
2-17
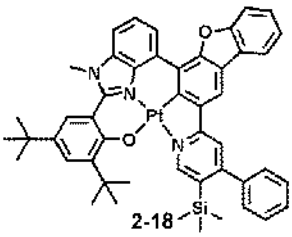
2-18
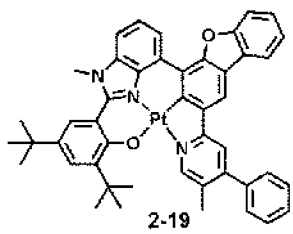
2-19
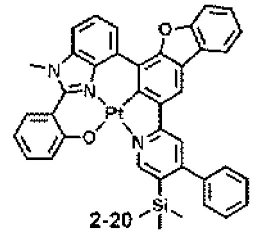
2-20

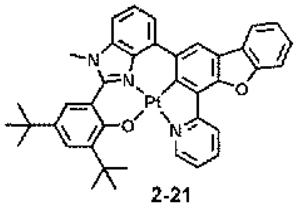
2-21
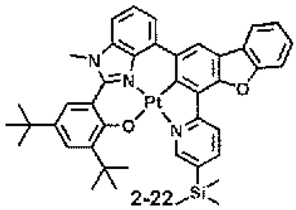
2-22
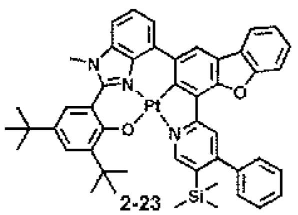
2-23
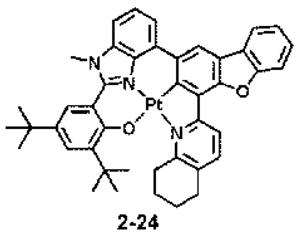
2-24

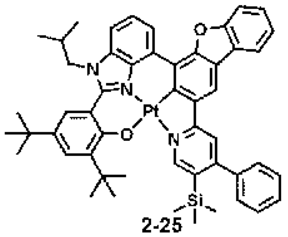
2-25
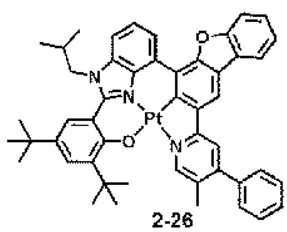
2-26
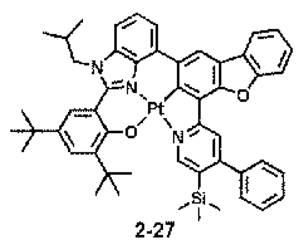
2-27
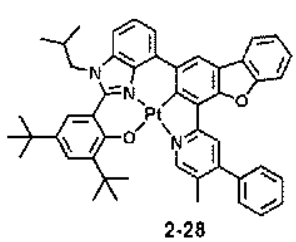
2-28

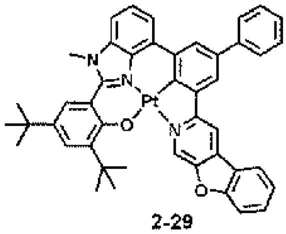

2-29

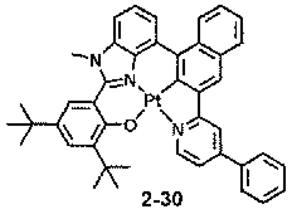

2-30

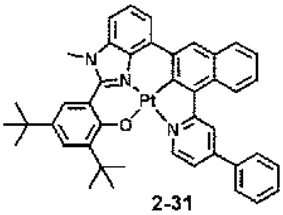

2-31

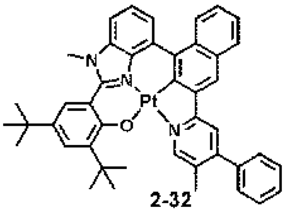

2-32

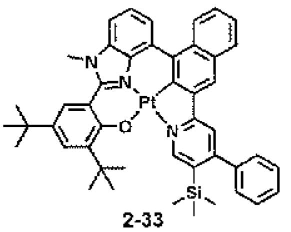

2-33

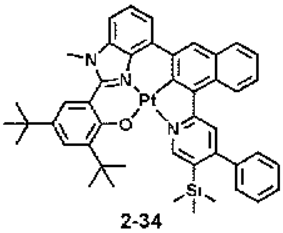

2-34

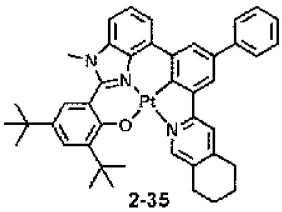

2-35

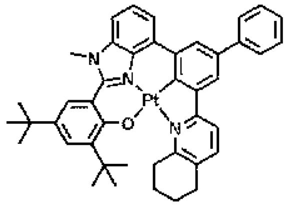

2-36

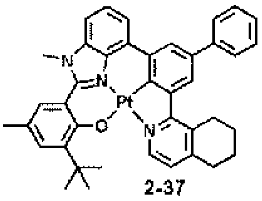

2-37

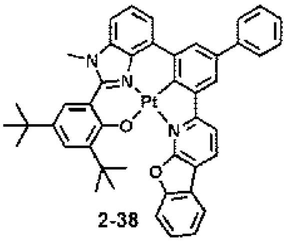

2-38

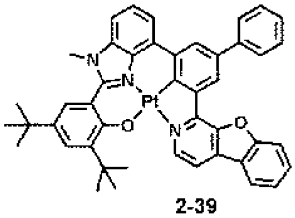

2-39

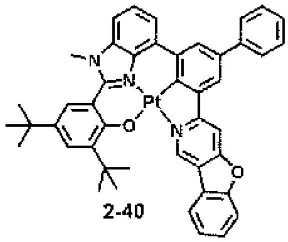

2-40

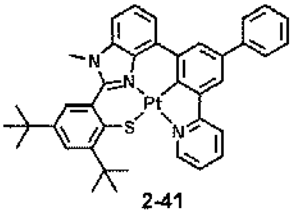

2-41

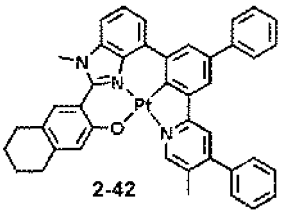

2-42

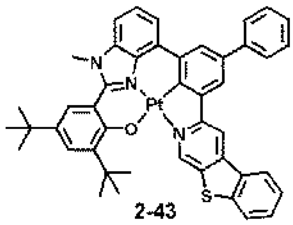

2-43

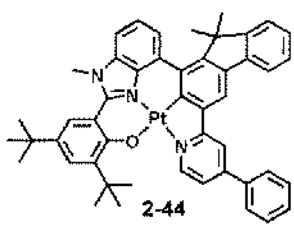

2-44

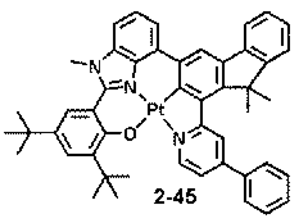

2-45

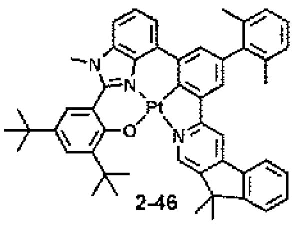

2-46

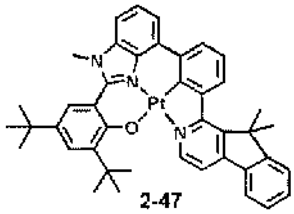

2-47

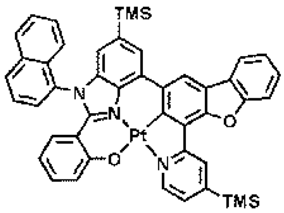

3-1

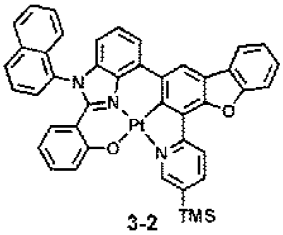

3-2

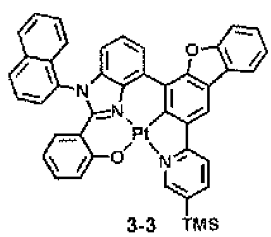

3-3

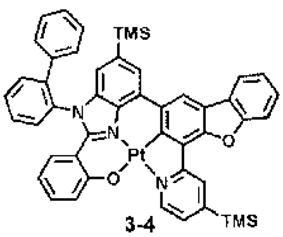

3-4

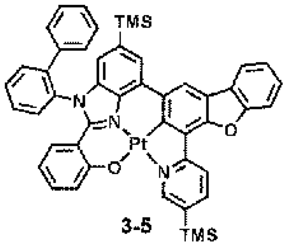
3-5

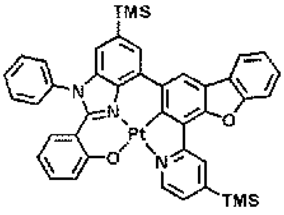
3-6

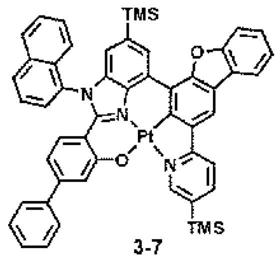
3-7

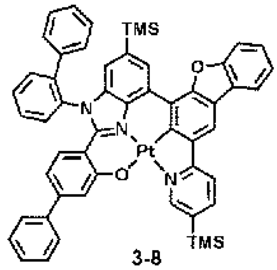
3-8

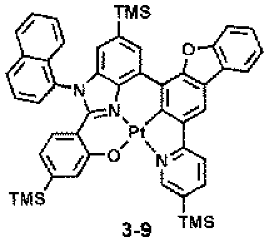
3-9

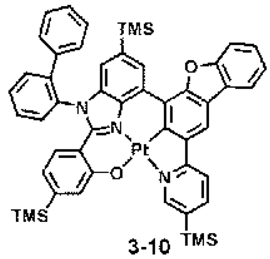
3-10

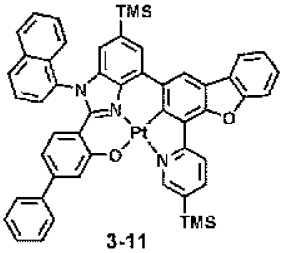
3-11

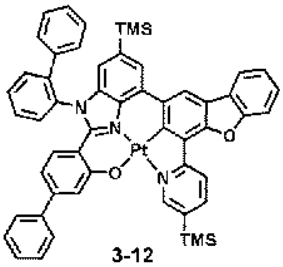
3-12

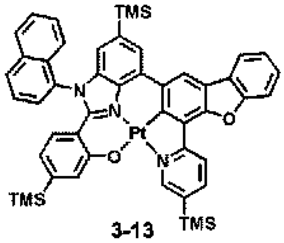
3-13

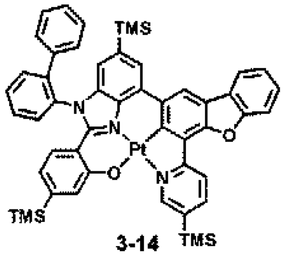
3-14

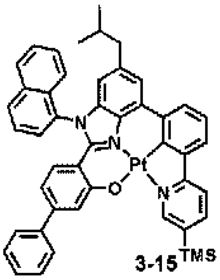
3-15

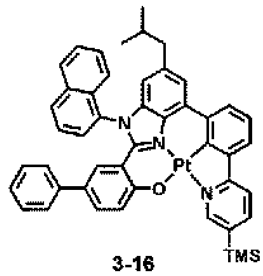
3-16

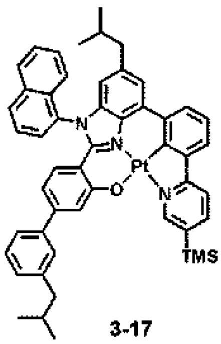
3-17

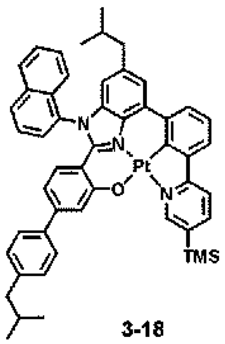
3-18

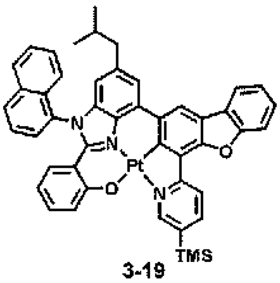
3-19

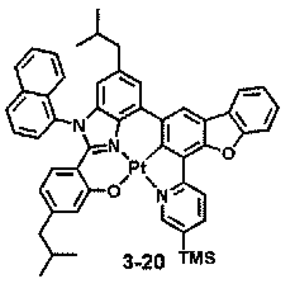
3-20

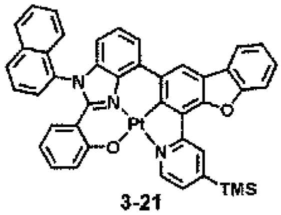
3-21

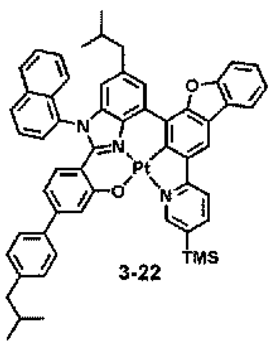
3-22

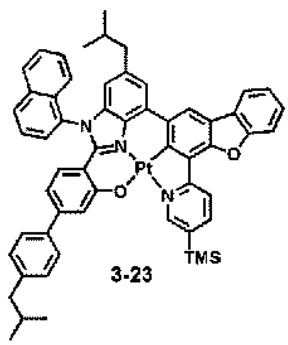
3-23

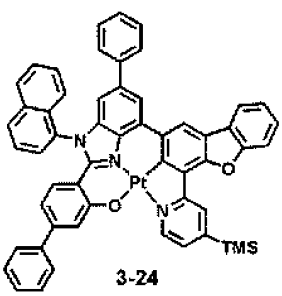
3-24

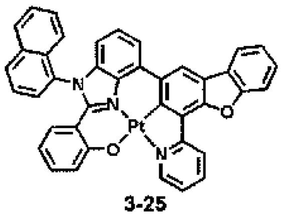
3-25
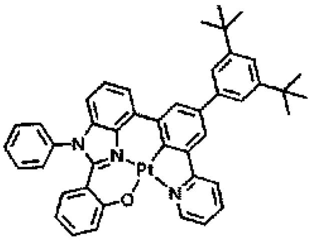
3-26
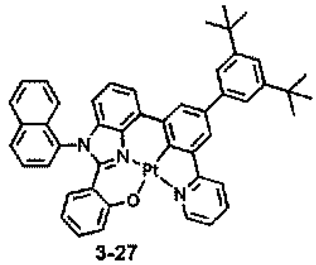
3-27
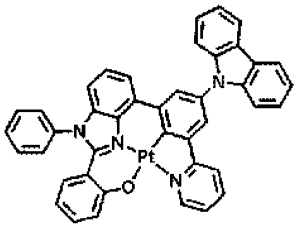
3-28

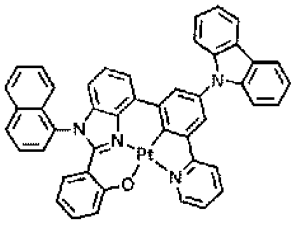
3-29
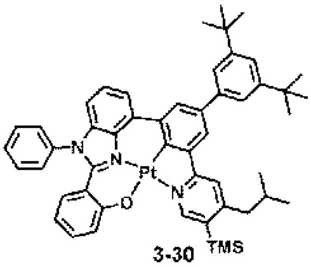
3-30
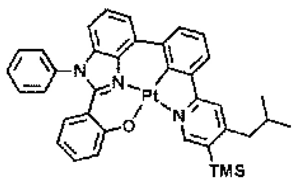
3-31
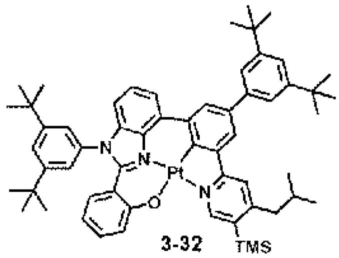
3-32

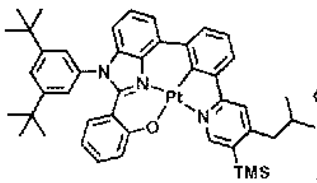
3-33
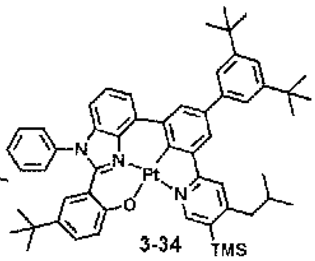
3-34
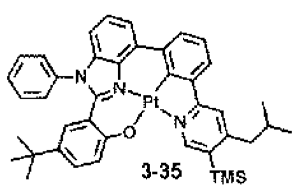
3-35
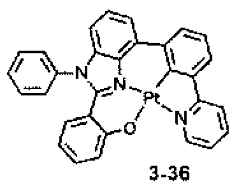
3-36

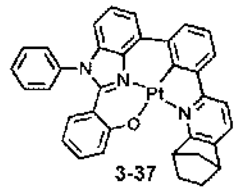
3-37
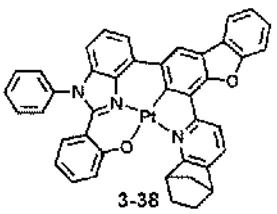
3-38
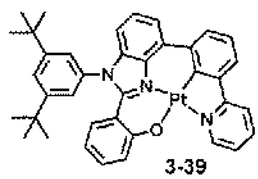
3-39
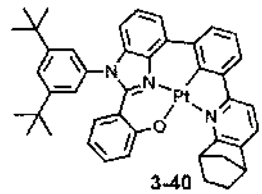
3-40

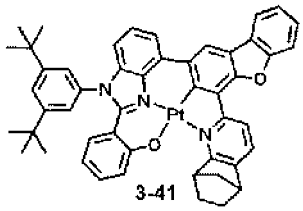
3-41
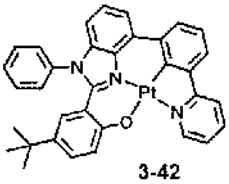
3-42
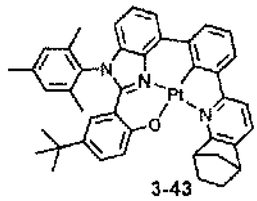
3-43
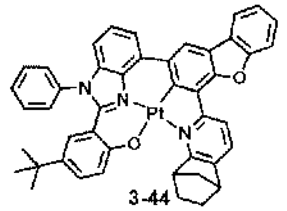
3-44

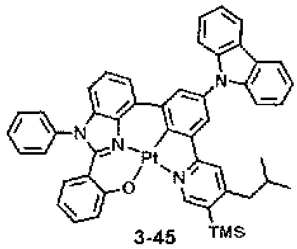
3-45
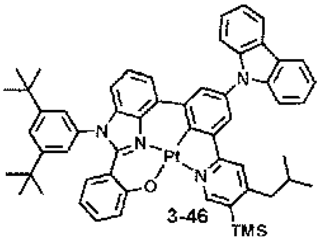
3-46
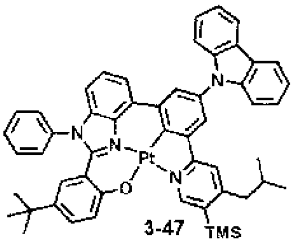
3-47
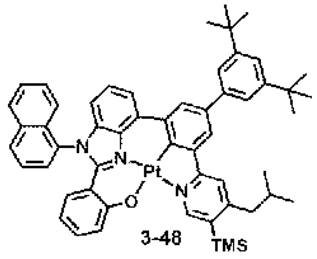
3-48

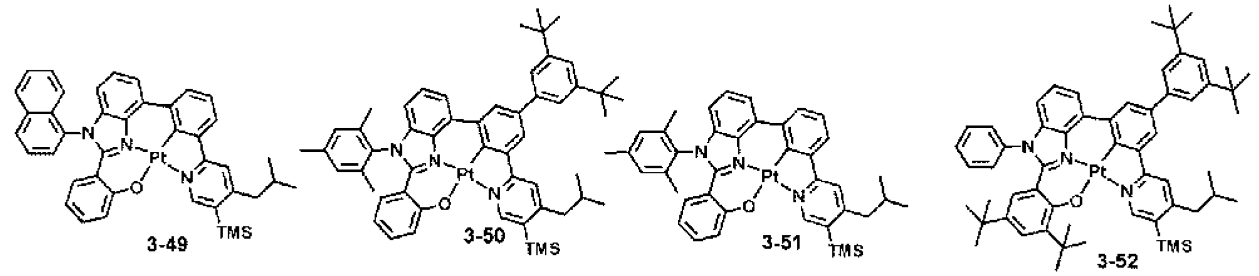

3-49 3-50 3-51 3-52

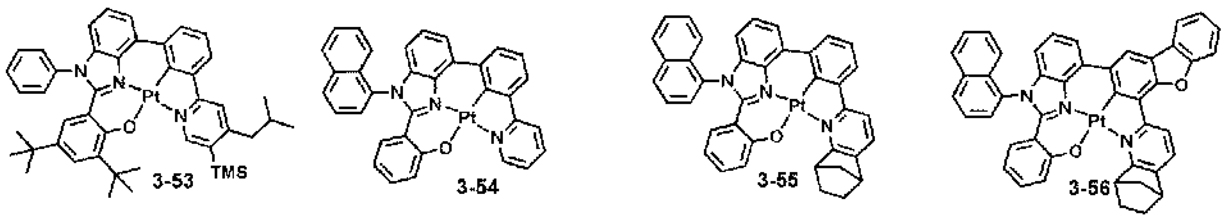

3-53 3-54 3-55 3-56

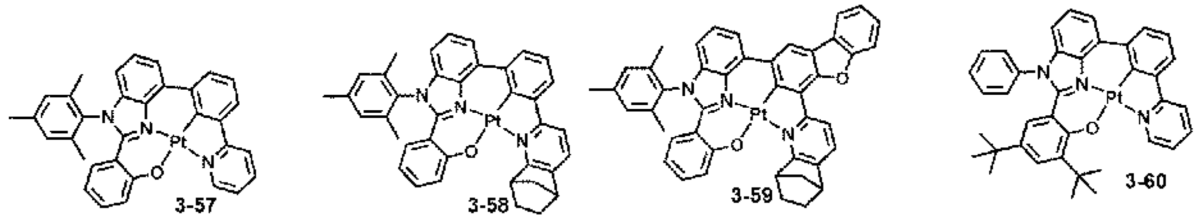

3-57 3-58 3-59 3-60

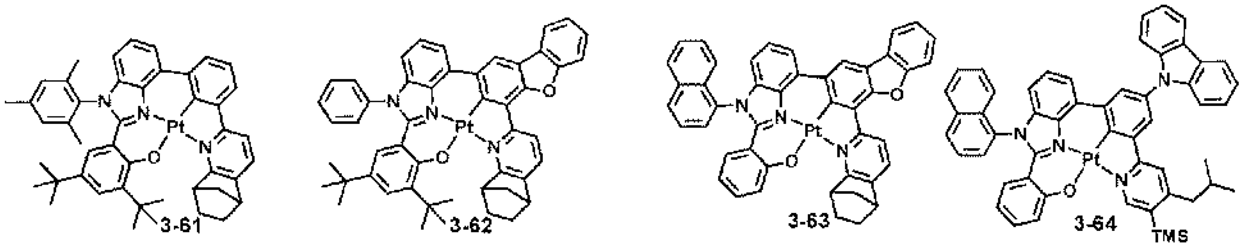

3-61 3-62 3-63 3-64

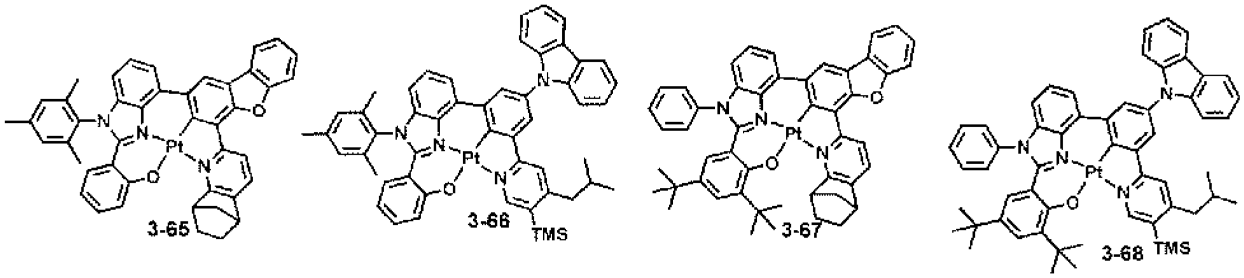

3-65 3-66 3-67 3-68

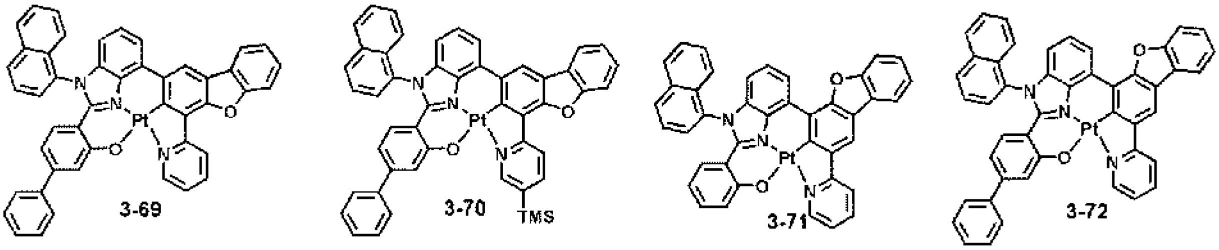

3-69 3-70 3-71 3-72

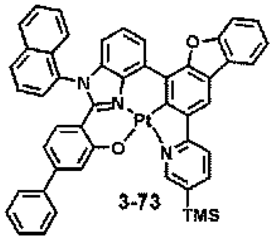
3-73

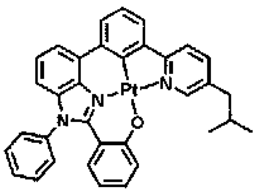
3-74

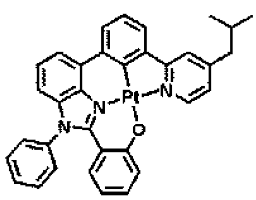
3-75

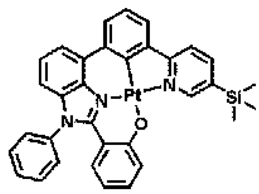
3-76

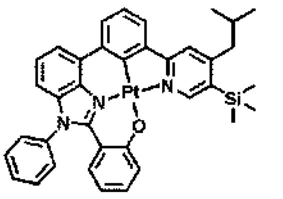
3-77

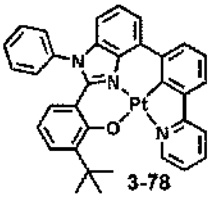
3-78

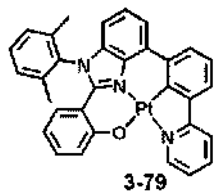
3-79

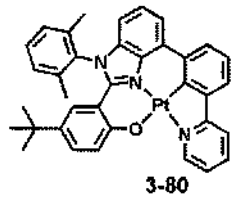
3-80

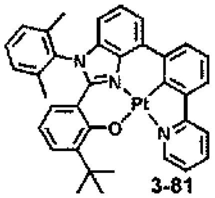
3-81

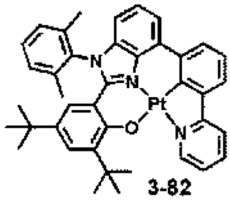
3-82

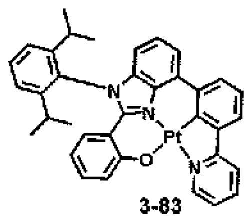
3-83

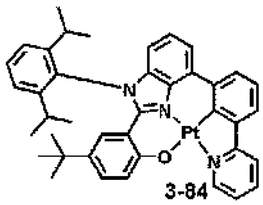
3-84

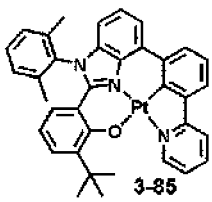
3-85

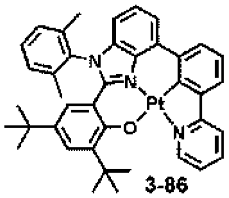
3-86

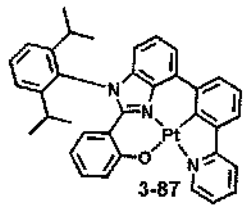
3-87

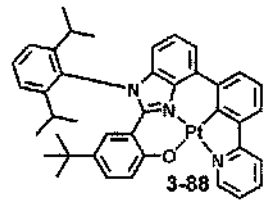
3-88

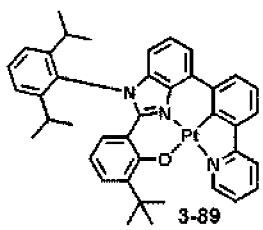
3-89

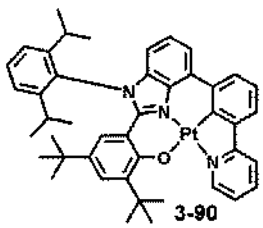
3-90

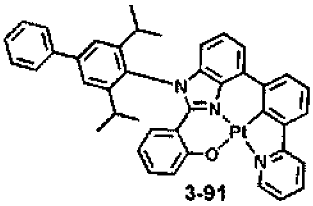
3-91

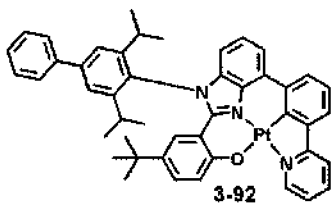
3-92

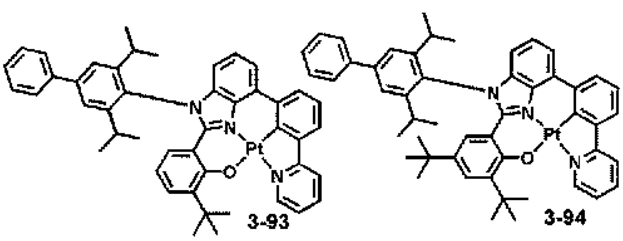
3-93

3-94

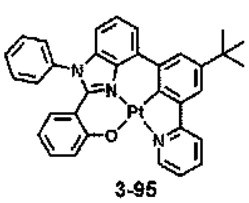
3-95

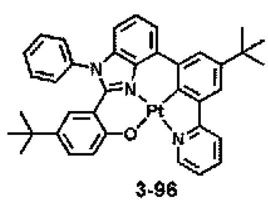
3-96

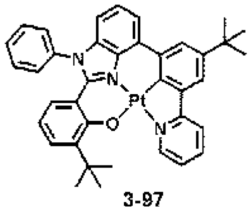
3-97

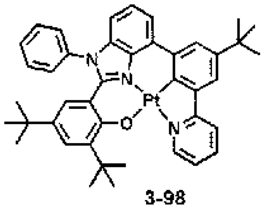
3-98

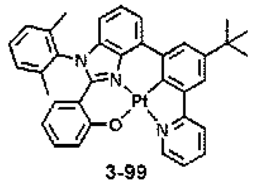
3-99

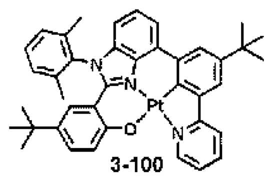
3-100

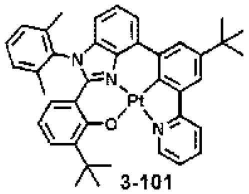
3-101

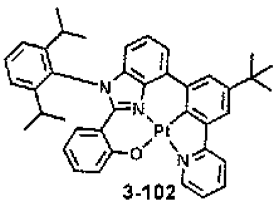
3-102

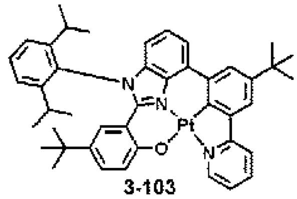
3-103

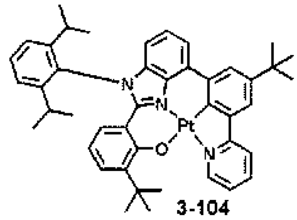
3-104

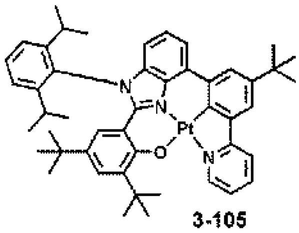
3-105

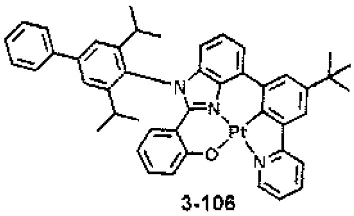
3-106

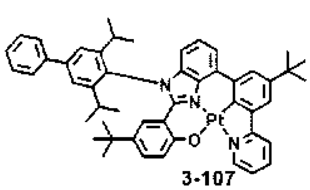
3-107

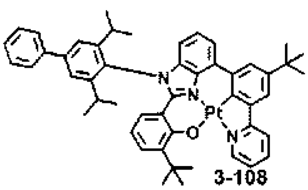
3-108

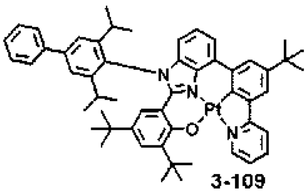
3-109

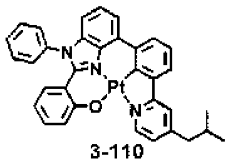
3-110

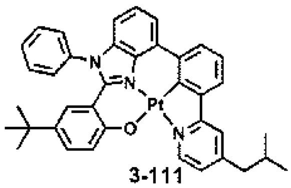
3-111

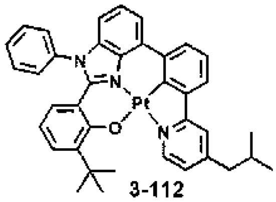
3-112

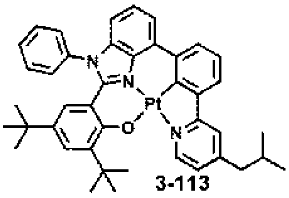
3-113

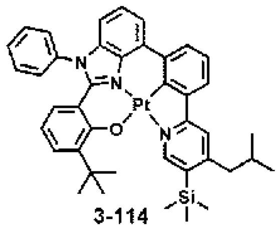
3-114

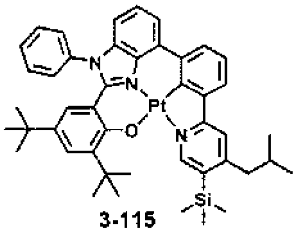
3-115

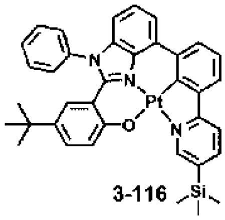
3-116

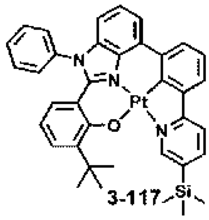
3-117

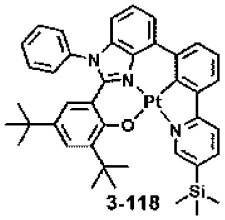
3-118

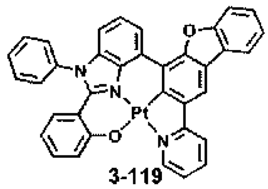
3-119

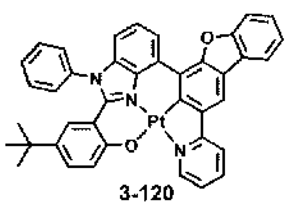
3-120

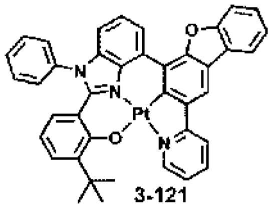
3-121

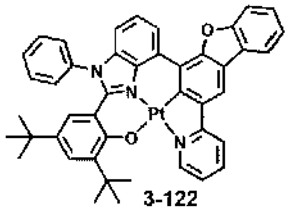
3-122

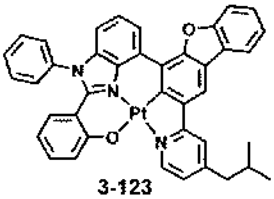
3-123

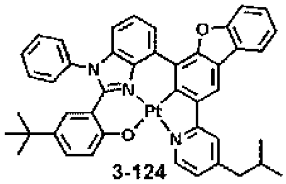
3-124

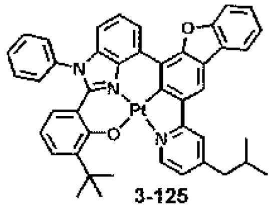
3-125

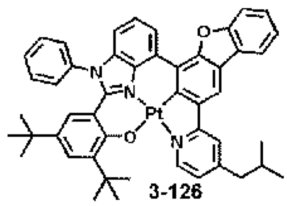
3-126

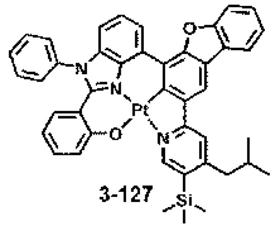
3-127

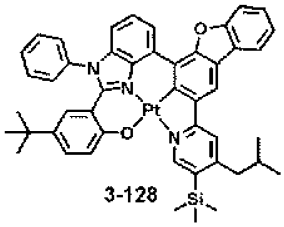
3-128

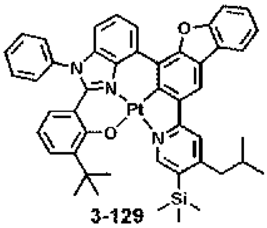
3-129

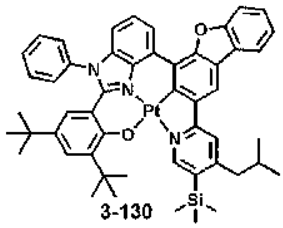
3-130

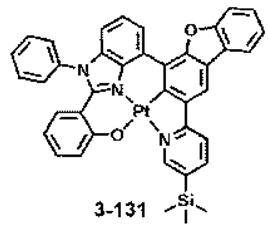
3-131

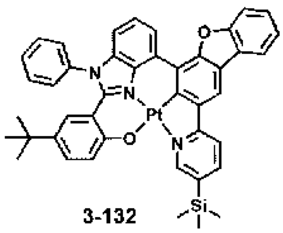
3-132

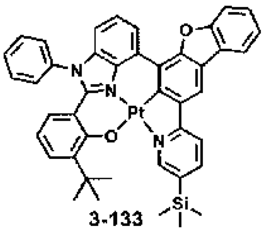
3-133

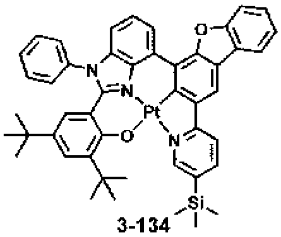
3-134

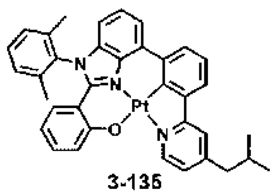
3-135

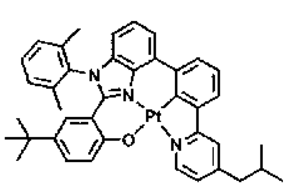
3-136

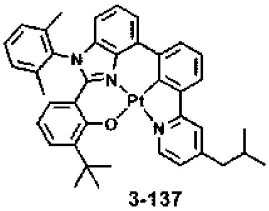
3-137

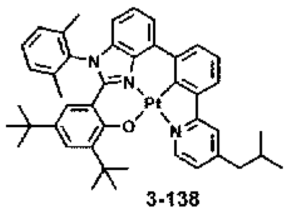
3-138

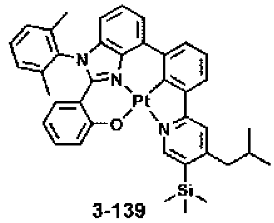
3-139

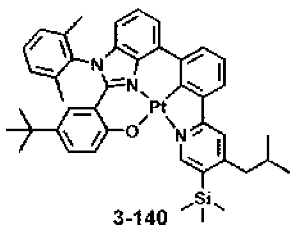
3-140

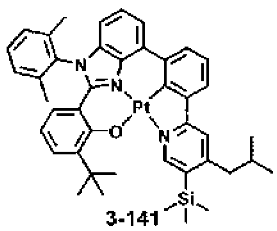
3-141

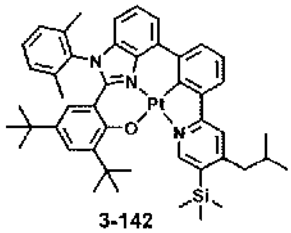
3-142

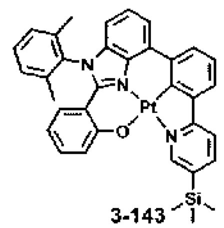
3-143

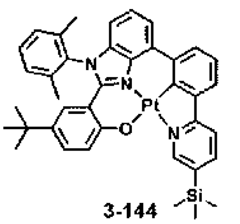
3-144

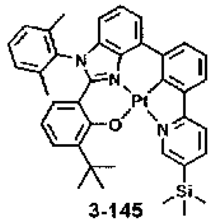
3-145

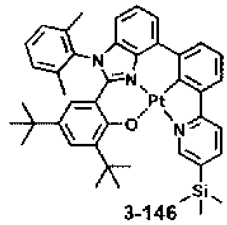
3-146

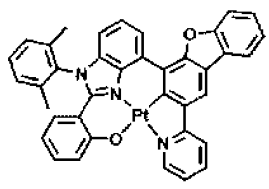
3-147

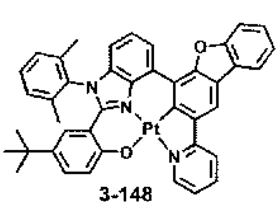
3-148

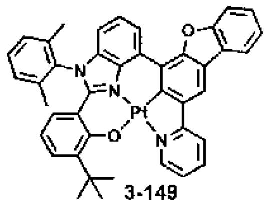
3-149

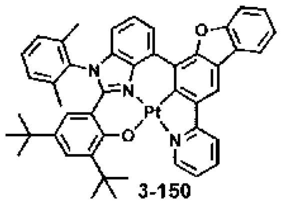
3-150

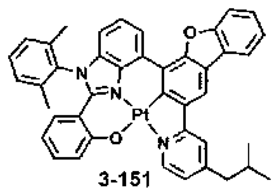
3-151

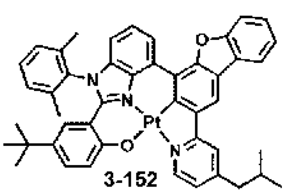
3-152

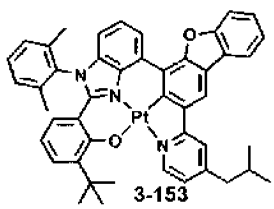
3-153

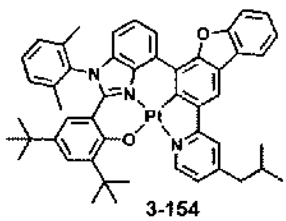
3-154

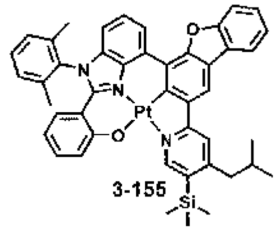
3-155

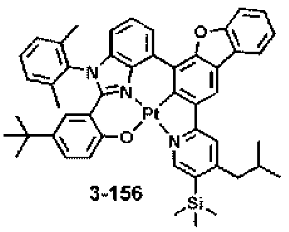
3-156

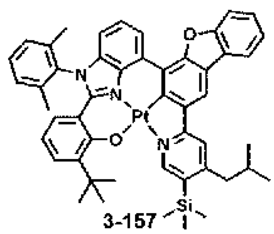
3-157

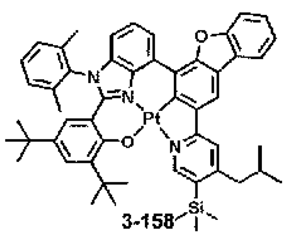
3-158

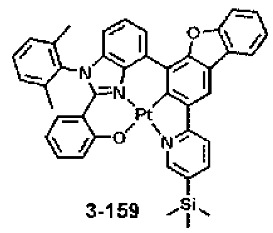
3-159

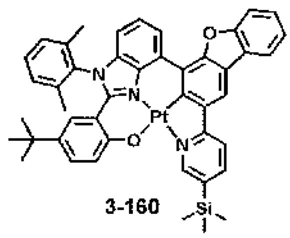
3-160

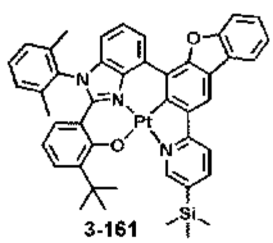
3-161

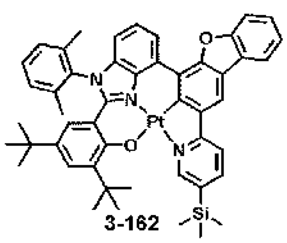
3-162

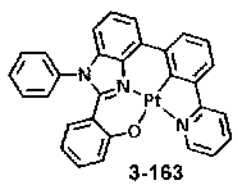
3-163

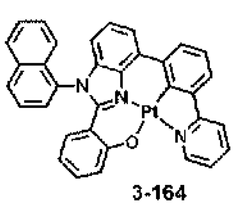
3-164

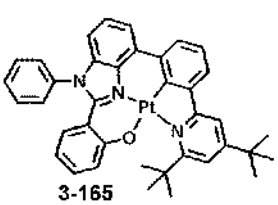
3-165

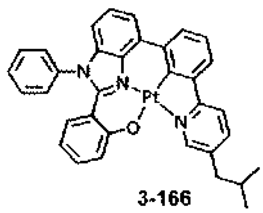
3-166

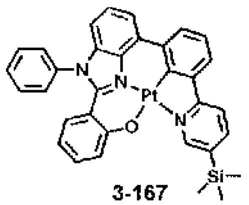
3-167

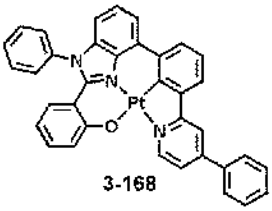
3-168

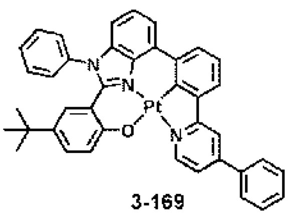
3-169

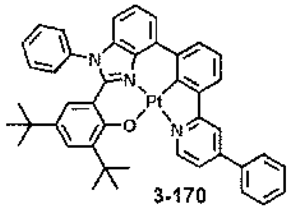
3-170

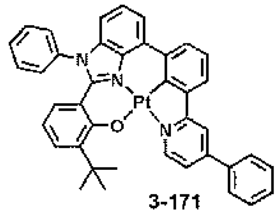
3-171

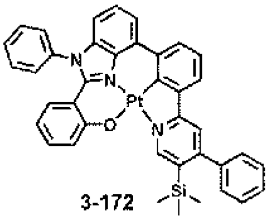
3-172

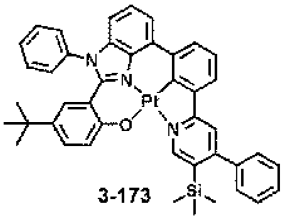
3-173

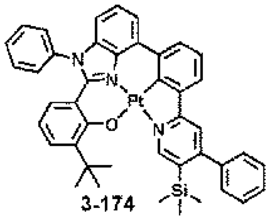
3-174

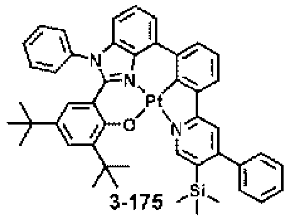
3-175

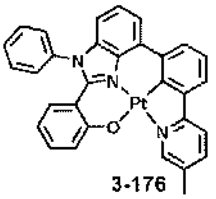
3-176

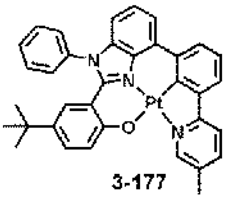
3-177

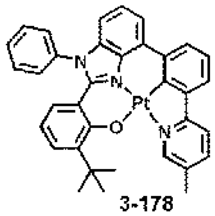
3-178

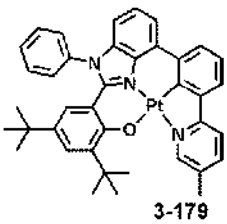
3-179

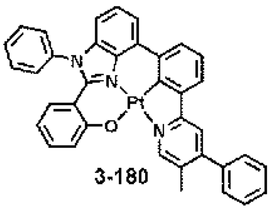
3-180

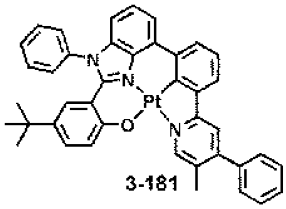
3-181

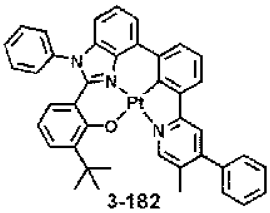
3-182

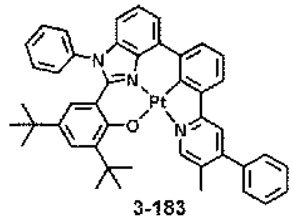
3-183

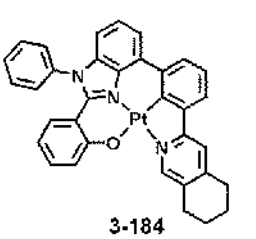
3-184

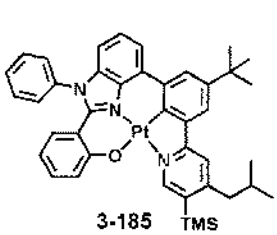
3-185

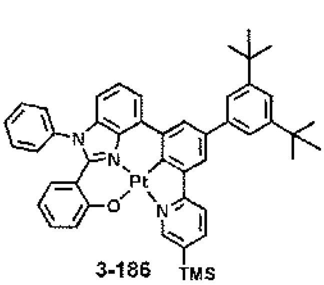
3-186

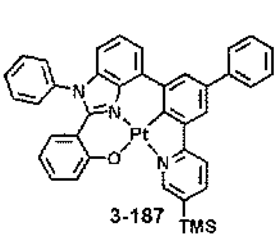
3-187

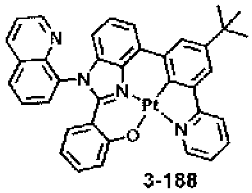
3-188

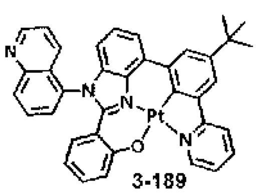
3-189

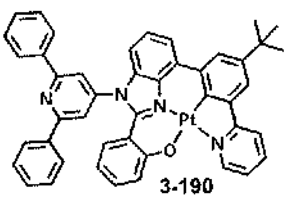
3-190

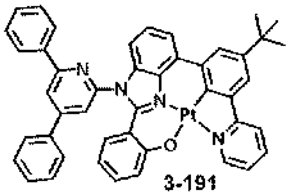
3-191

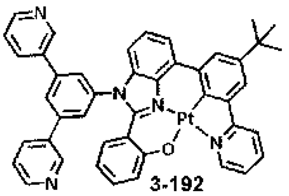
3-192

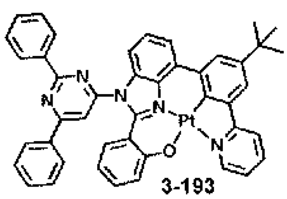
3-193

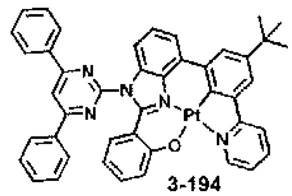
3-194

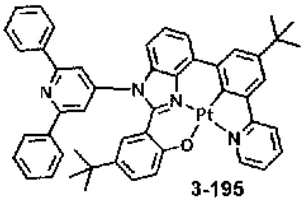
3-195

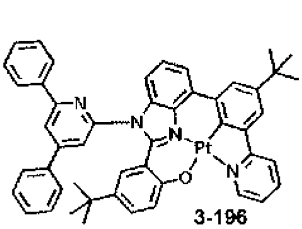
3-196

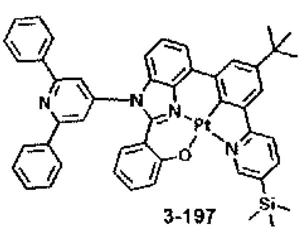
3-197

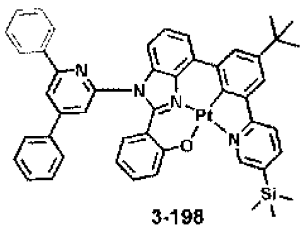
3-198

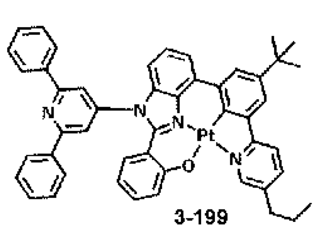
3-199

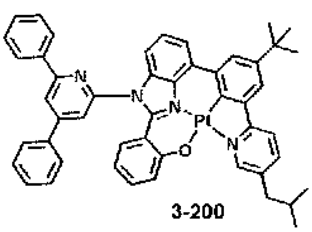
3-200

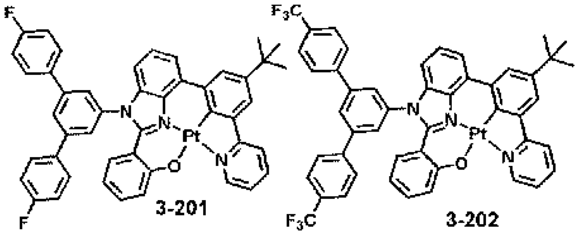
3-201

3-202

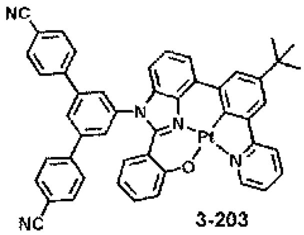
3-203

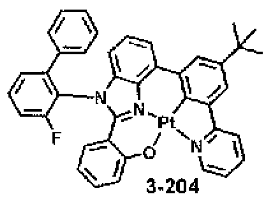
3-204

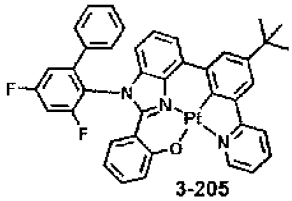
3-205

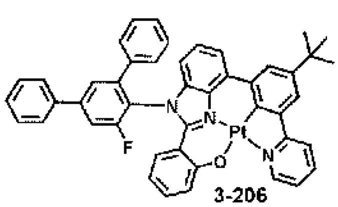
3-206

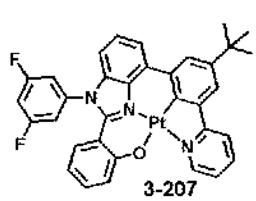
3-207

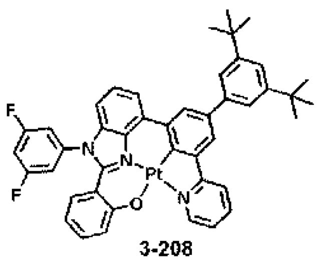
3-208

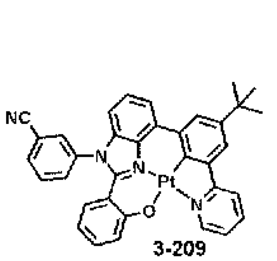
3-209

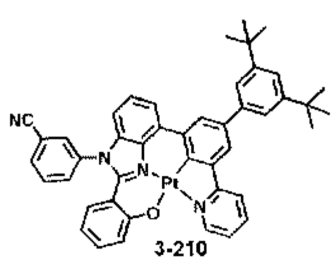
3-210

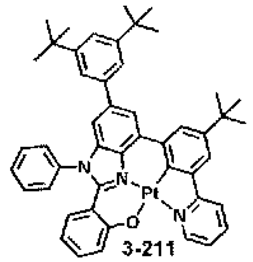
3-211

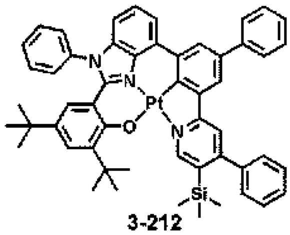
3-212

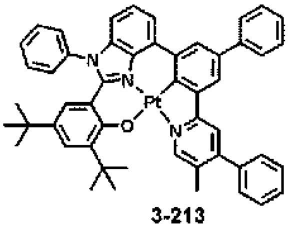
3-213

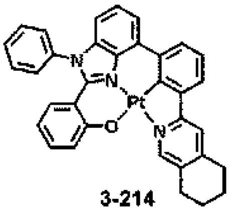
3-214

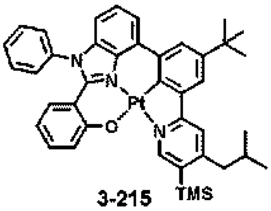
3-215

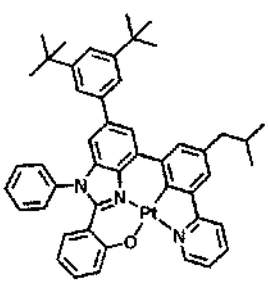
3-216

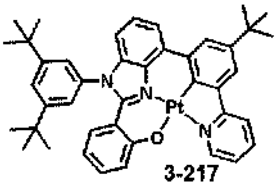
3-217

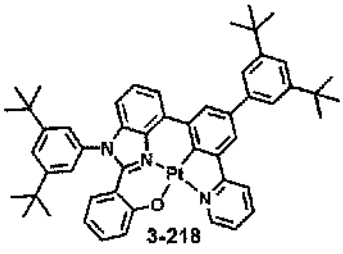
3-218

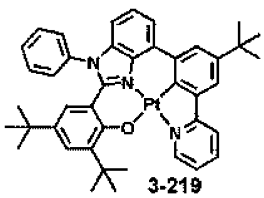
3-219

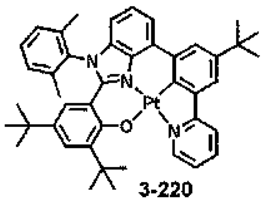
3-220

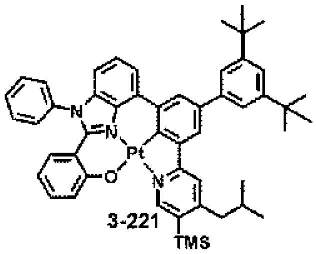
3-221

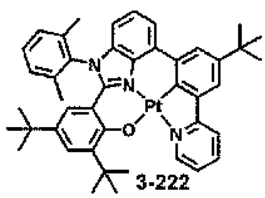
3-222

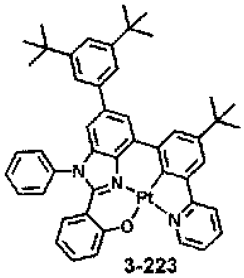
3-223

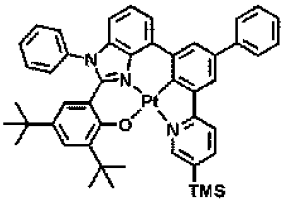
3-224

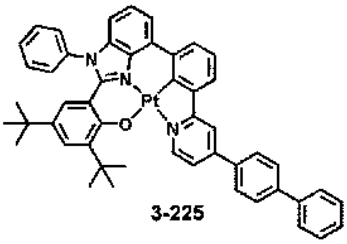
3-225

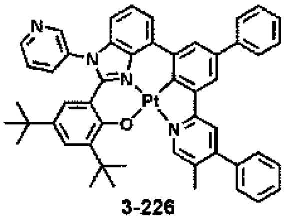
3-226

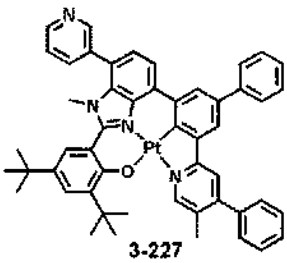
3-227

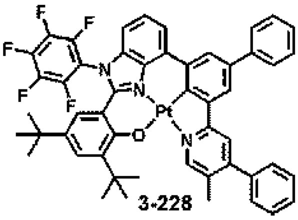
3-228

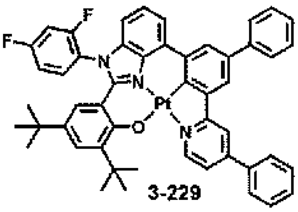
3-229

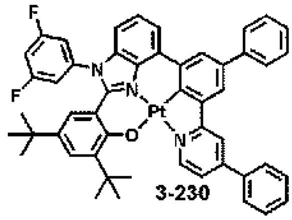
3-230

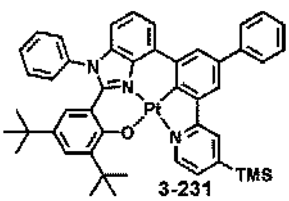
3-231

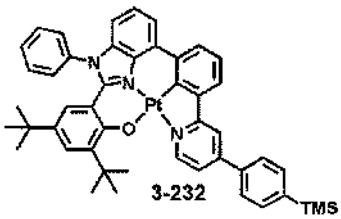
3-232

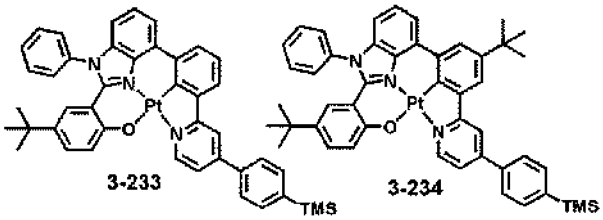
3-233

3-234

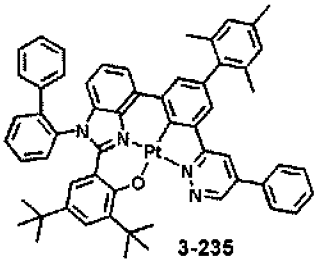
3-235

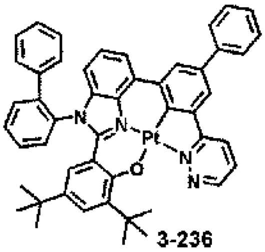
3-236

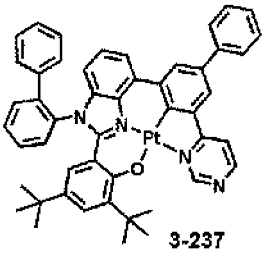
3-237

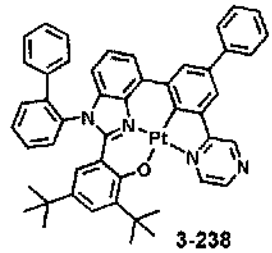
3-238

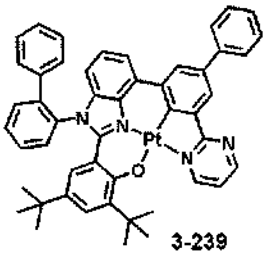
3-239

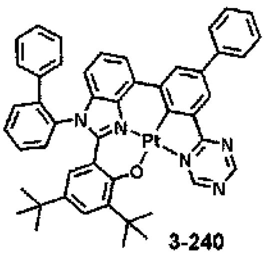
3-240

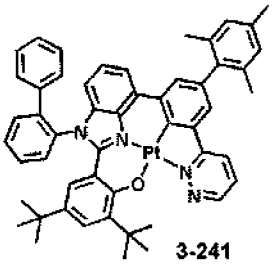
3-241

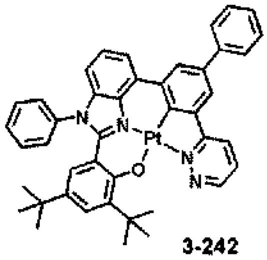
3-242

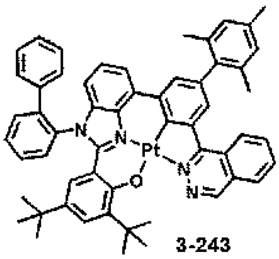
3-243

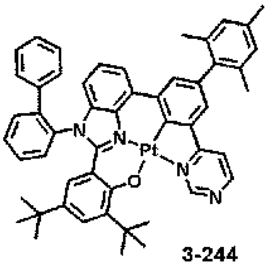
3-244

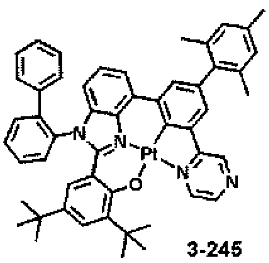
3-245

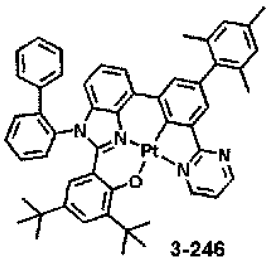
3-246

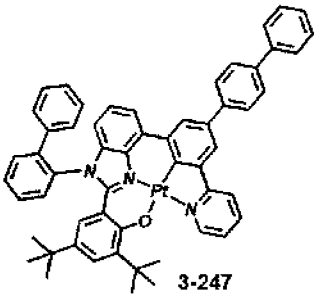
3-247

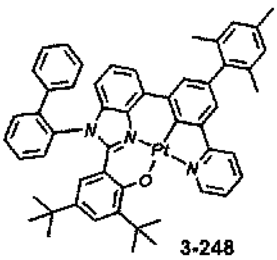
3-248

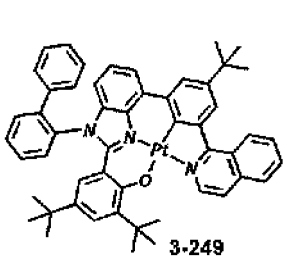
3-249

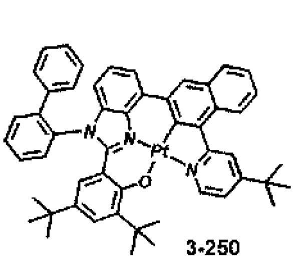
3-250

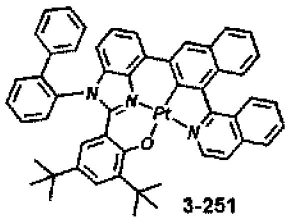
3-251

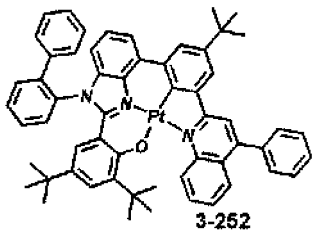
3-252

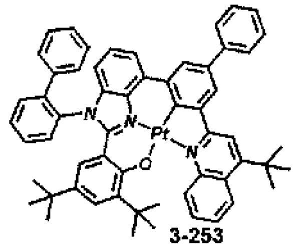
3-253

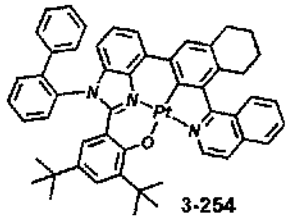
3-254

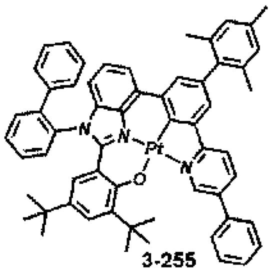
3-255

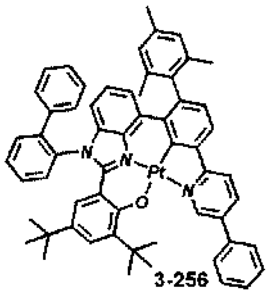
3-256

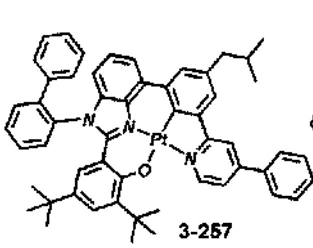
3-257

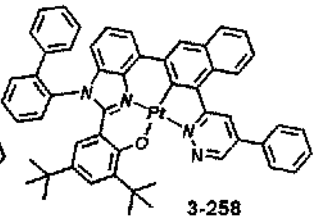
3-258

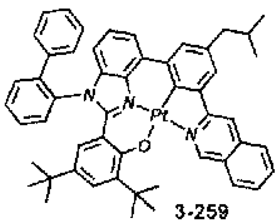
3-259

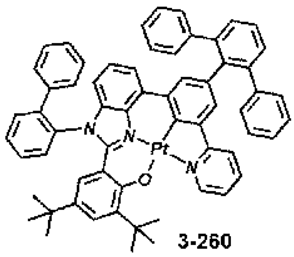
3-260

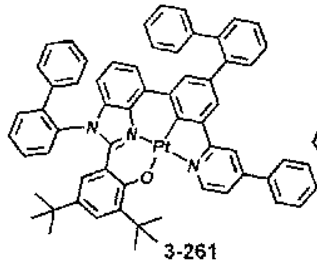
3-261

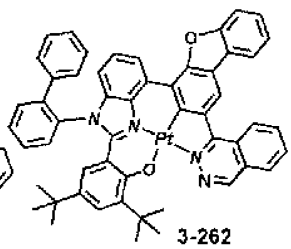
3-262

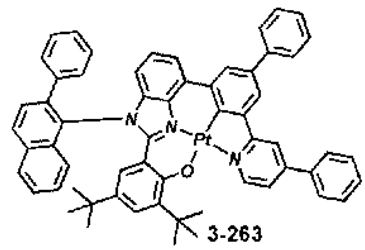
3-263

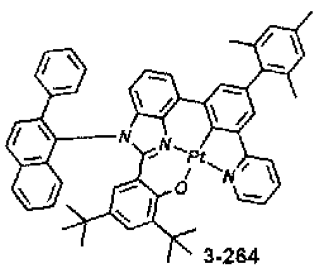
3-264

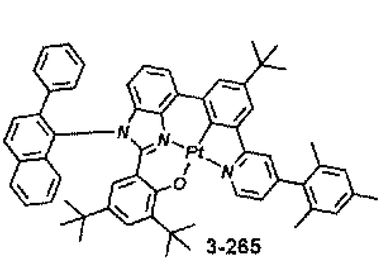
3-265

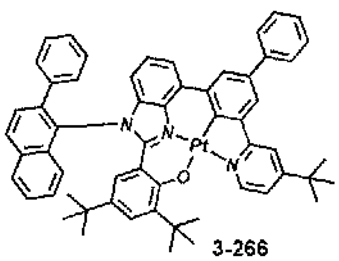
3-266

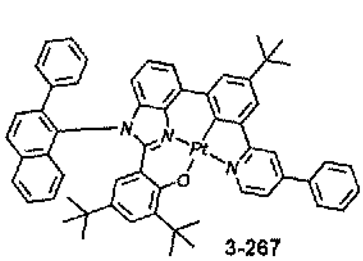
3-267

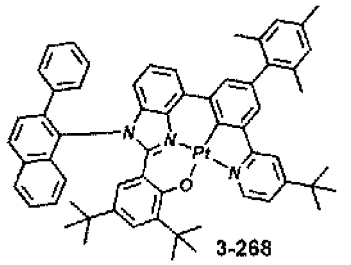
3-268

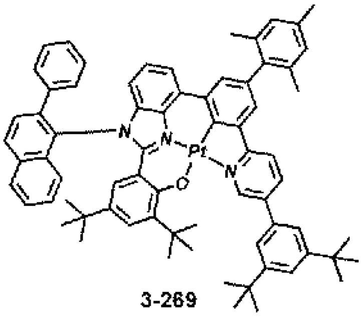
3-269

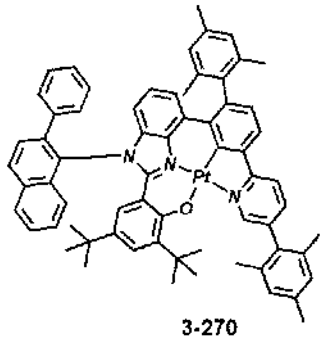
3-270

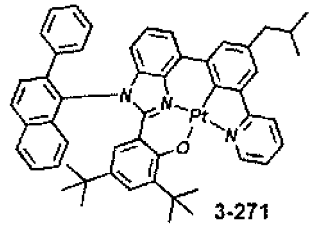
3-271

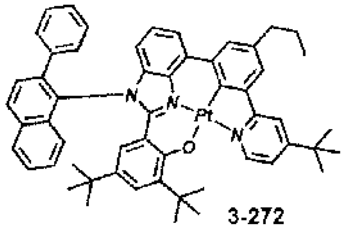
3-272

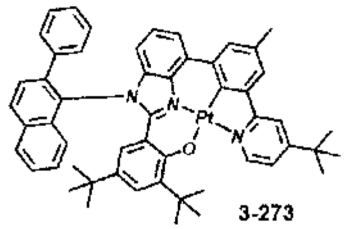
3-273

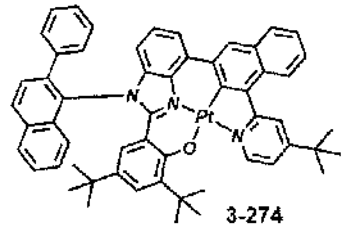
3-274

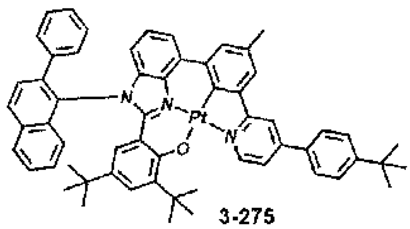
3-275

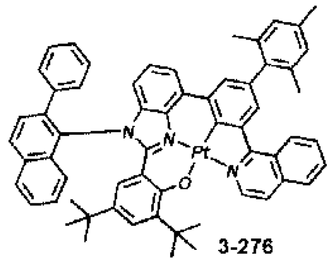
3-276

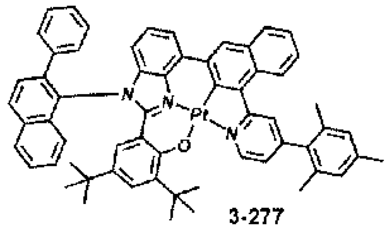
3-277

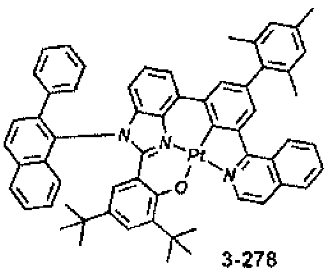
3-278

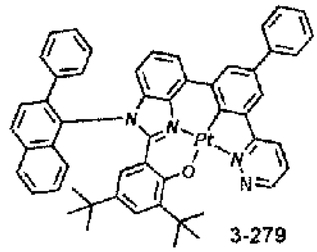
3-279

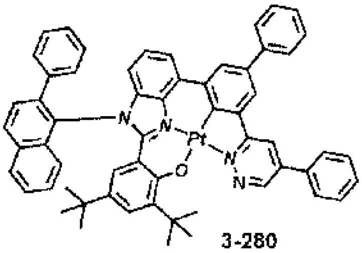
3-280

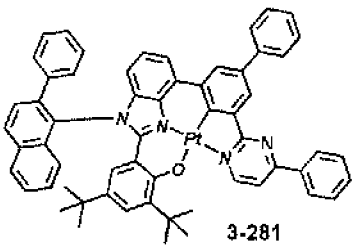
3-281

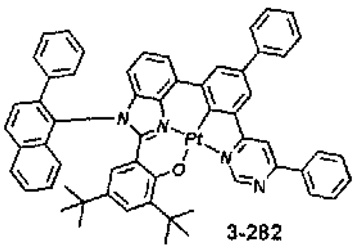
3-282

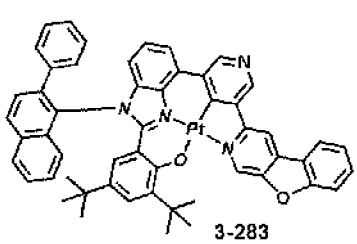
3-283

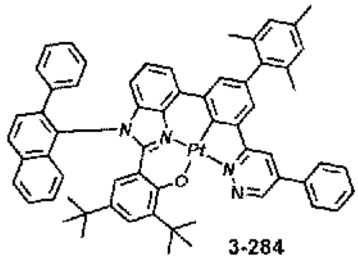
3-284

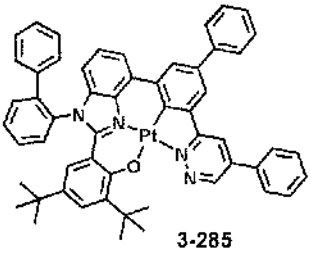
3-285

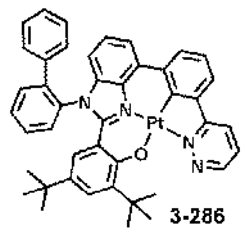
3-286

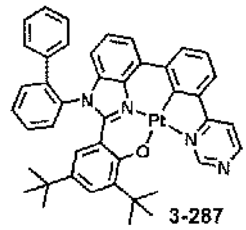
3-287

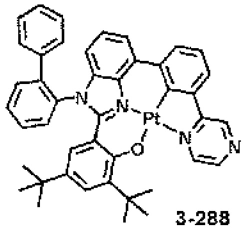
3-288

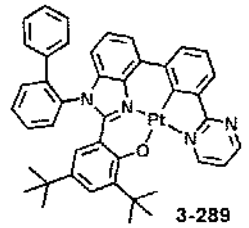
3-289

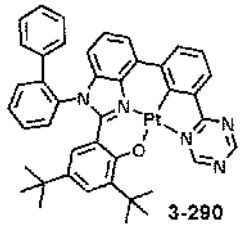
3-290

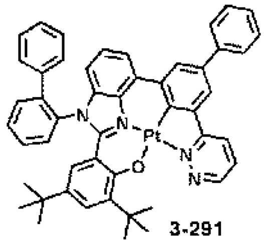
3-291

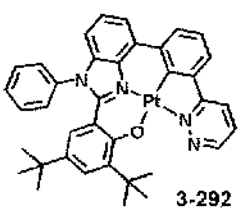
3-292

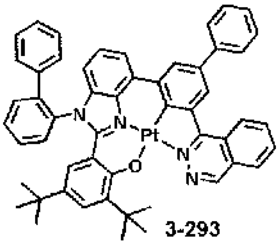
3-293

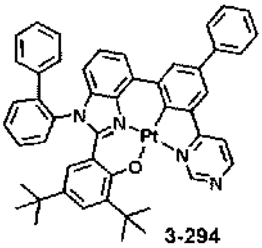
3-294

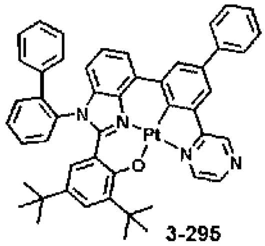
3-295

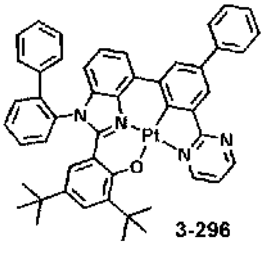
3-296

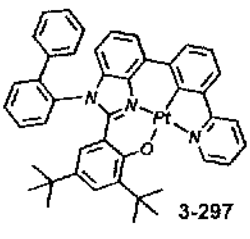
3-297

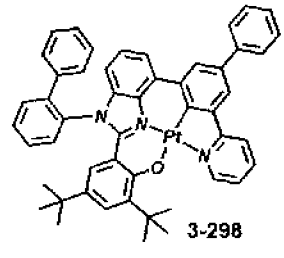
3-298

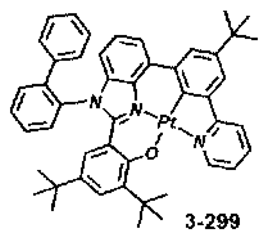
3-299

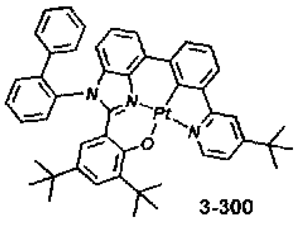
3-300

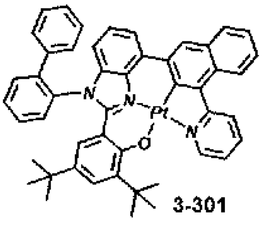
3-301

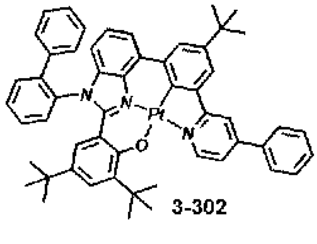
3-302

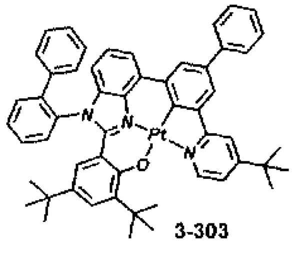
3-303

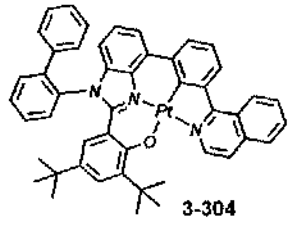
3-304

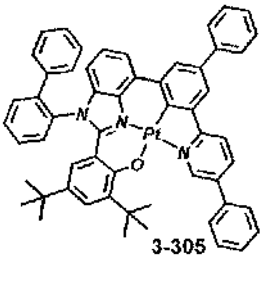
3-305

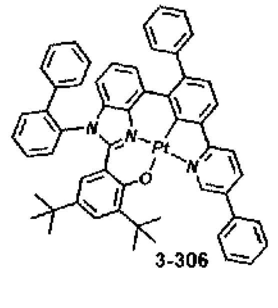
3-306

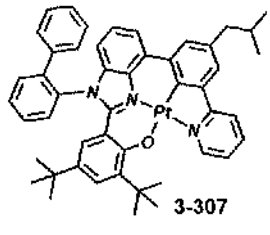
3-307

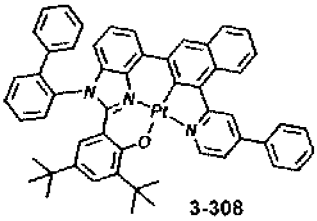
3-308

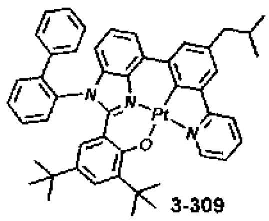
3-309

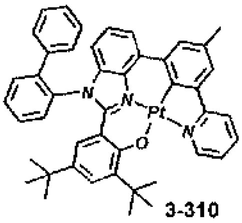
3-310

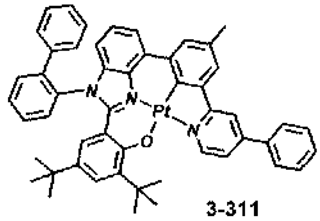
3-311

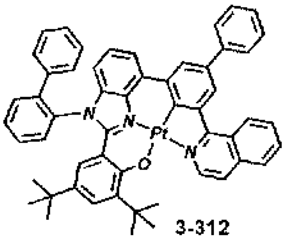
3-312

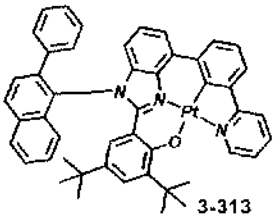
3-313

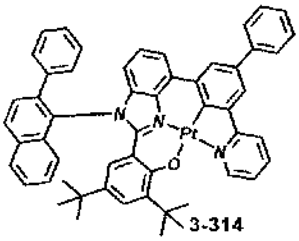
3-314

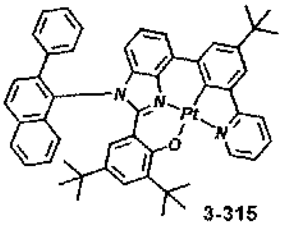
3-315

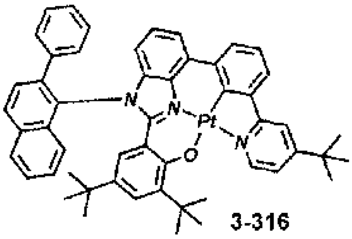
3-316

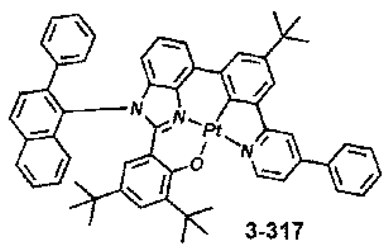
3-317

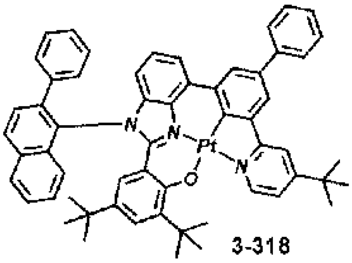
3-318

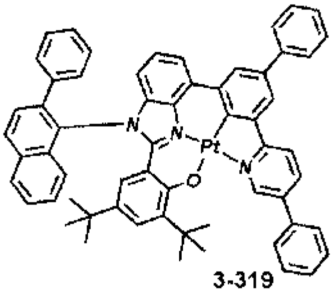
3-319

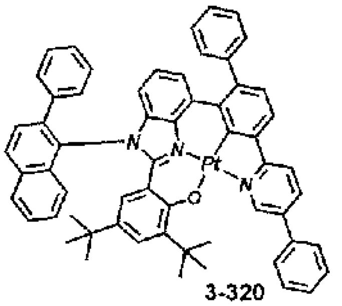
3-320

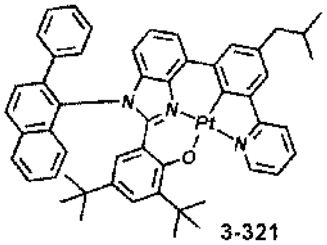
3-321

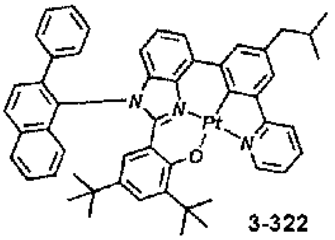
3-322

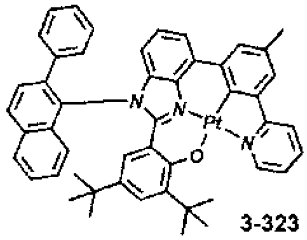
3-323

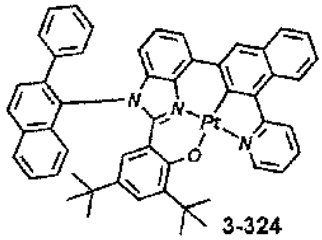
3-324

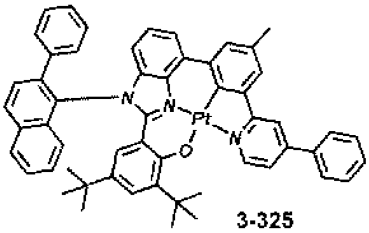
3-325

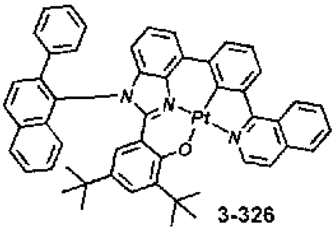
3-326

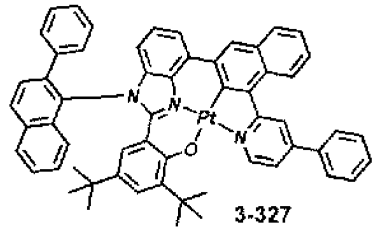
3-327

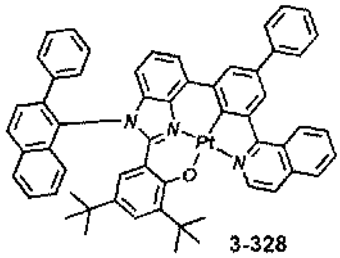
3-328

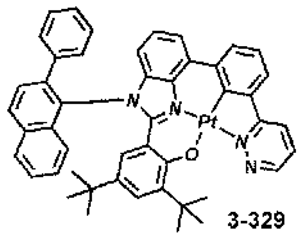
3-329

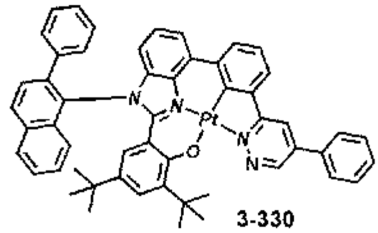
3-330

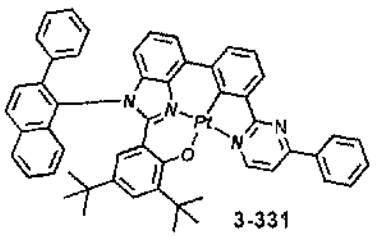
3-331

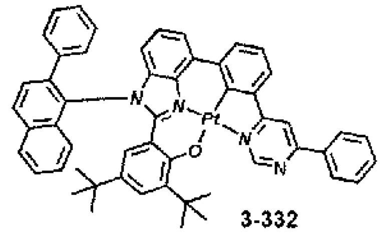
3-332

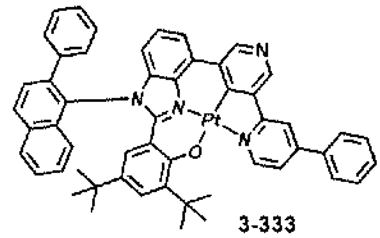
3-333

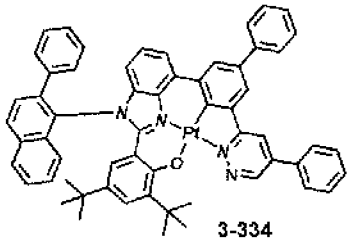
3-334

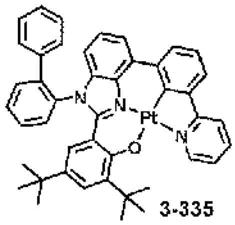
3-335

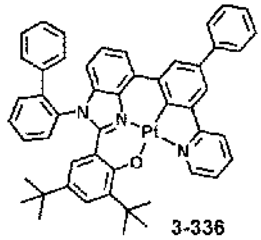
3-336

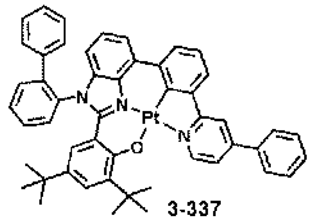
3-337

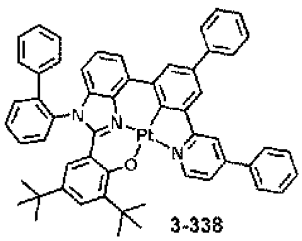
3-338

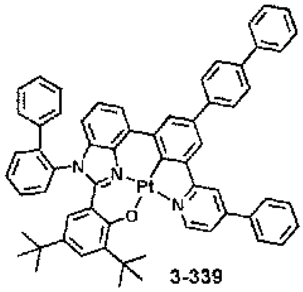
3-339

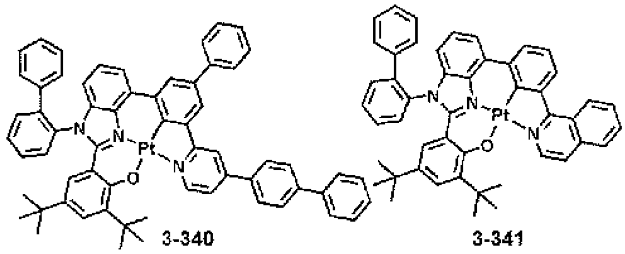
3-340

3-341

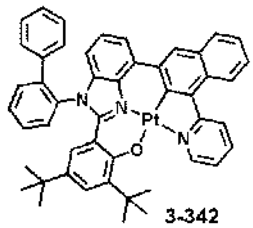
3-342

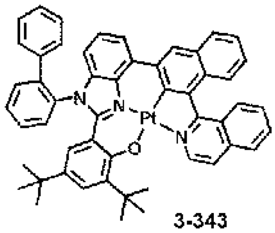
3-343

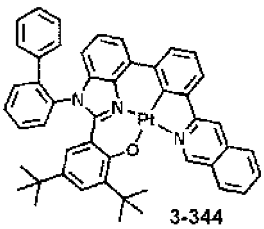
3-344

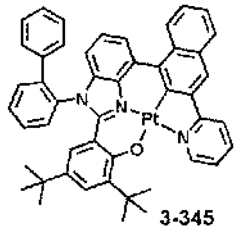
3-345

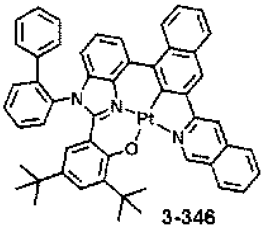
3-346

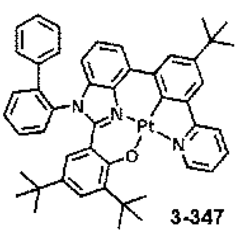
3-347

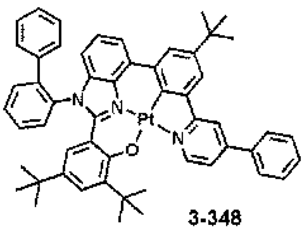
3-348

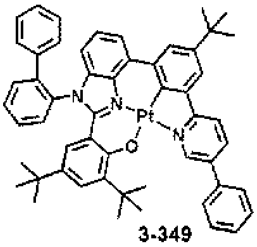
3-349

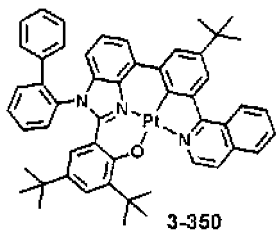
3-350

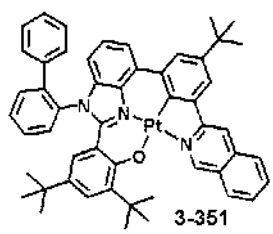
3-351

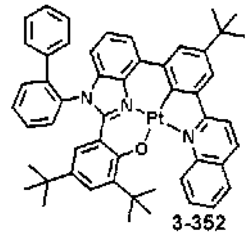
3-352

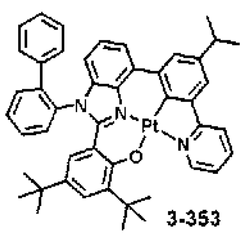
3-353

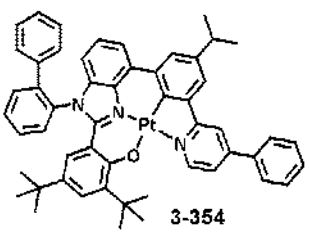
3-354

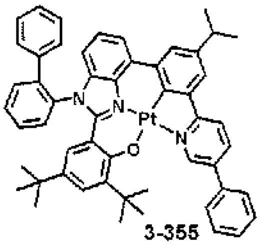
3-355

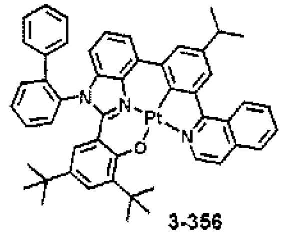
3-356

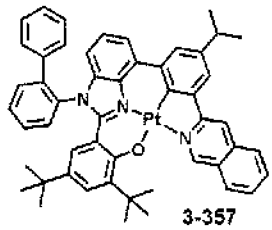
3-357

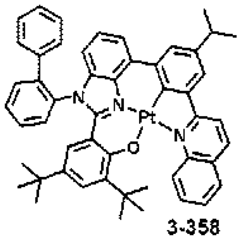
3-358

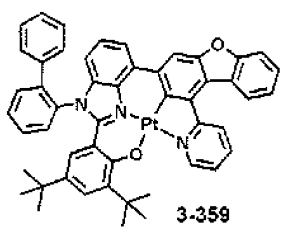
3-359

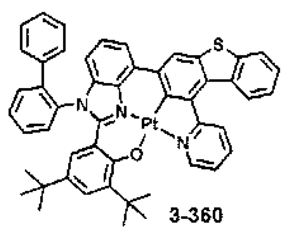
3-360

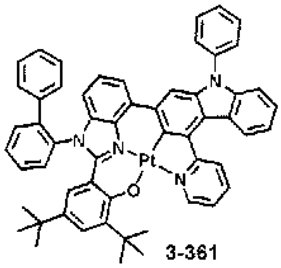
3-361

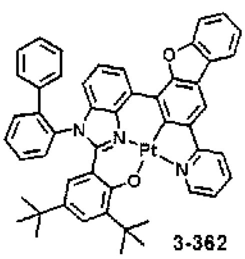
3-362

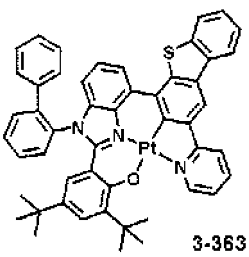
3-363

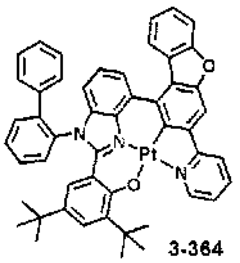
3-364

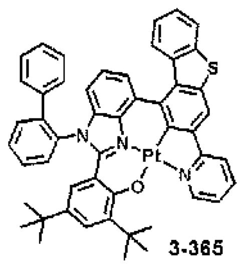
3-365

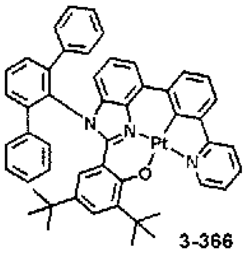
3-366

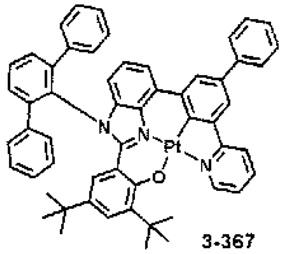
3-367

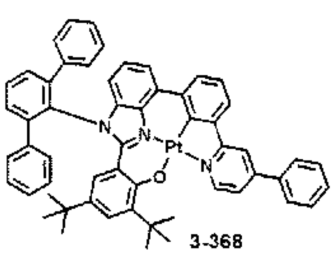
3-368

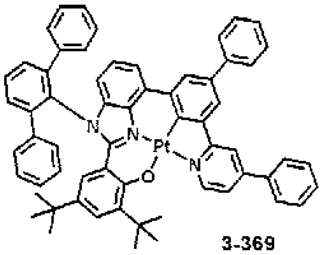
3-369

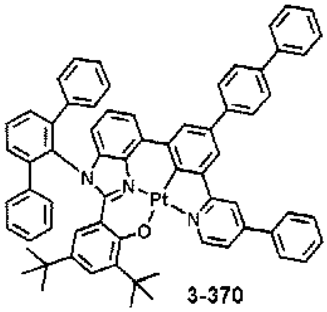
3-370

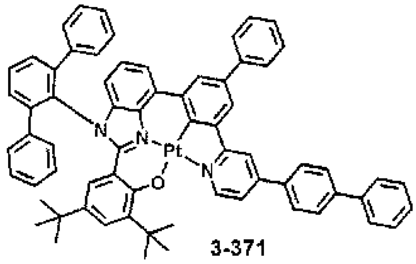
3-371

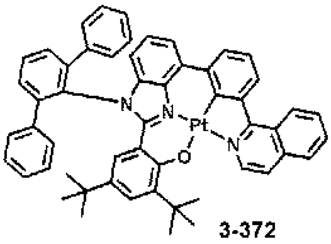
3-372

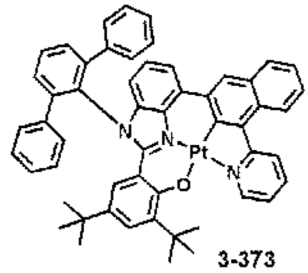
3-373

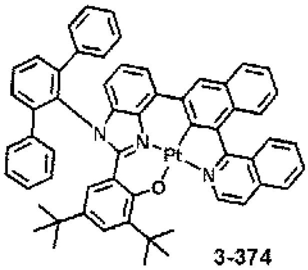
3-374

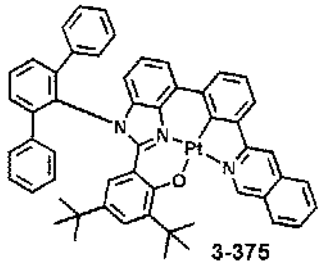
3-375

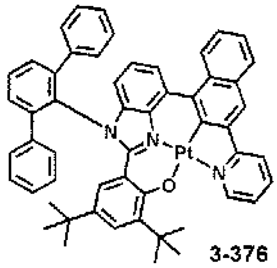
3-376

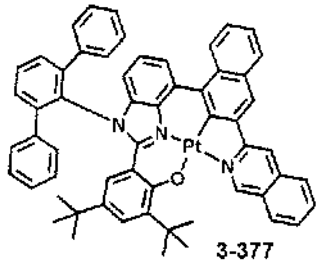
3-377

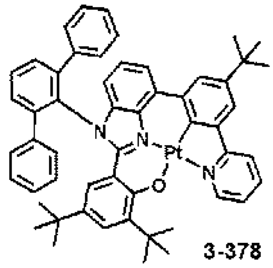
3-378

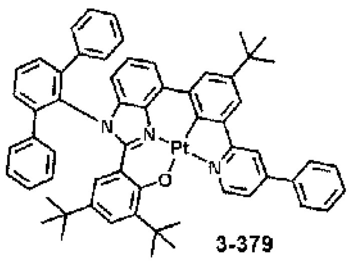
3-379

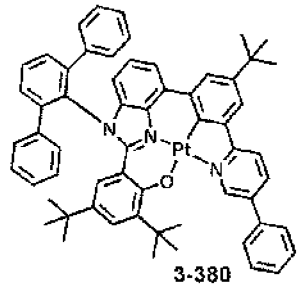
3-380

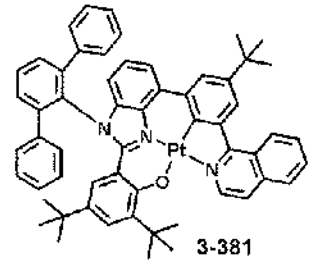
3-381

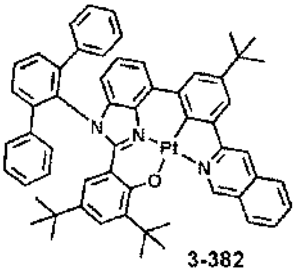
3-382

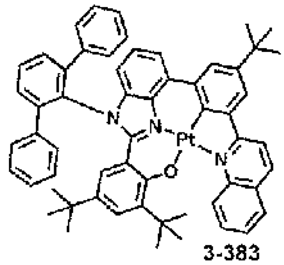
3-383

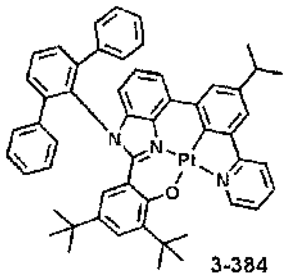
3-384

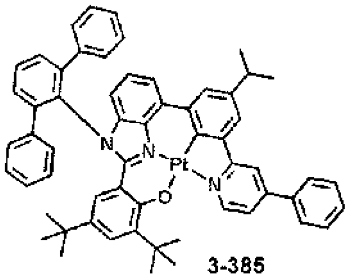
3-385

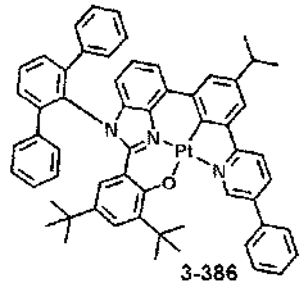
3-386

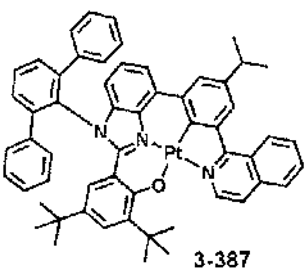
3-387

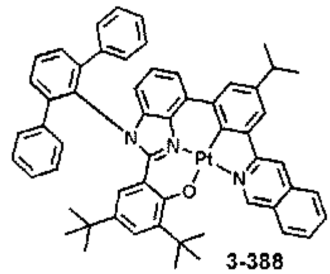
3-388

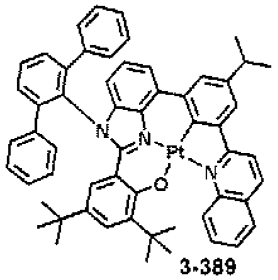
3-389

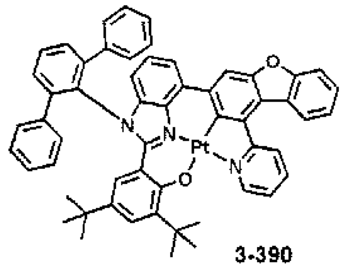
3-390

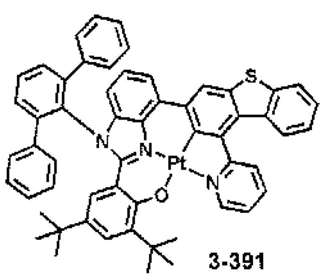
3-391

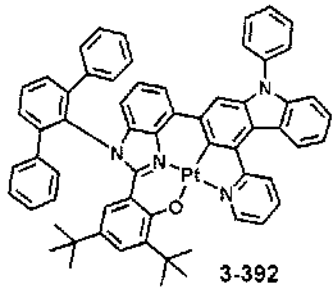
3-392

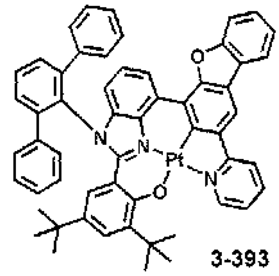
3-393

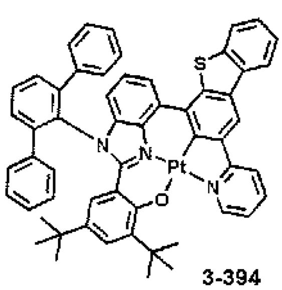
3-394

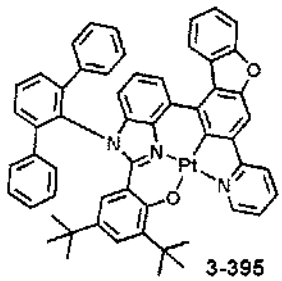
3-395

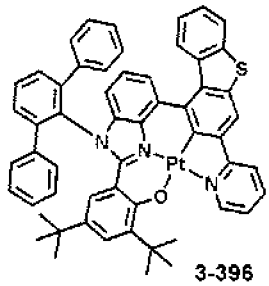
3-396

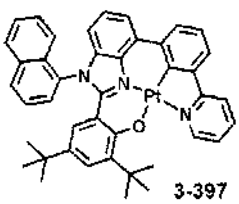
3-397

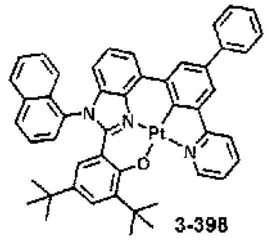
3-398

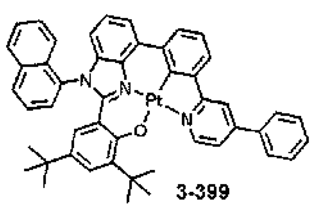
3-399

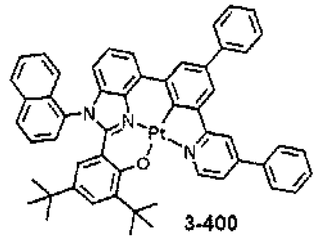
3-400

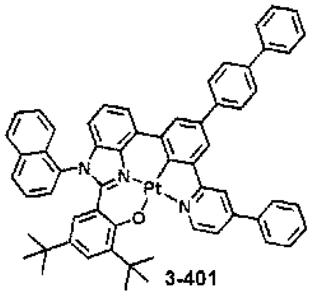
3-401

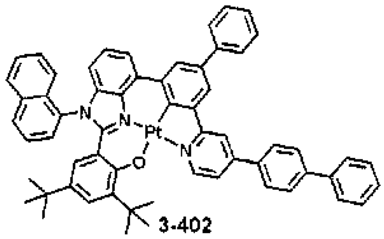
3-402

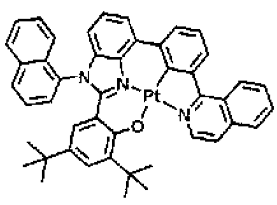
3-403

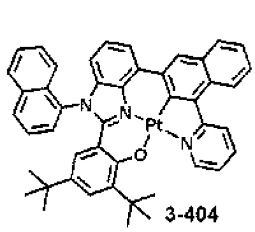
3-404

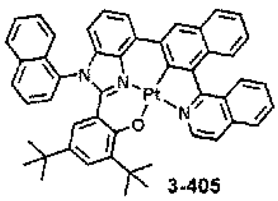
3-405

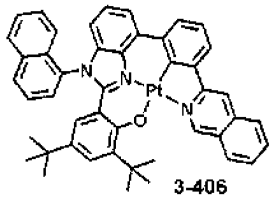
3-406

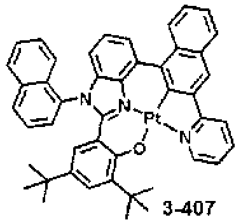
3-407

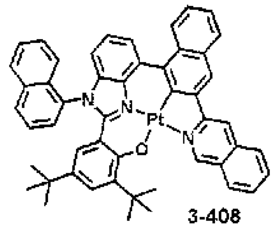
3-408

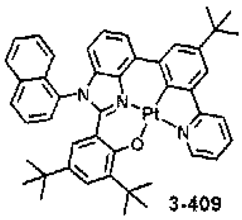
3-409

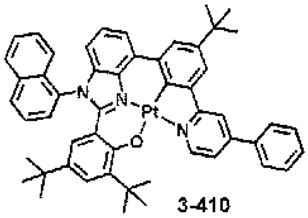
3-410

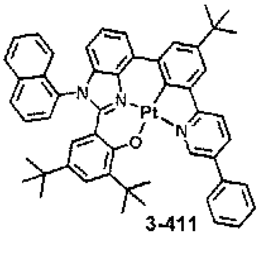
3-411

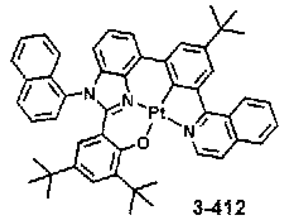
3-412

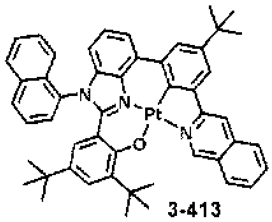
3-413

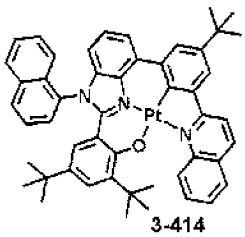
3-414

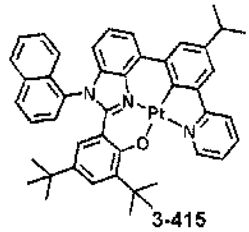
3-415

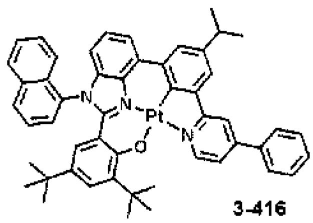
3-416

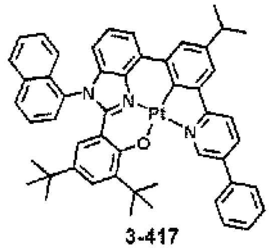
3-417

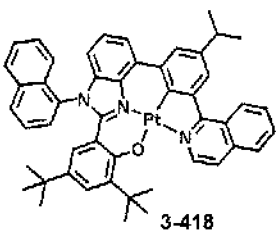
3-418

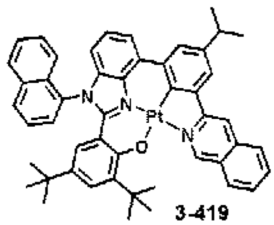
3-419

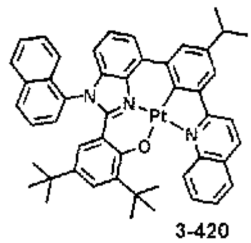
3-420

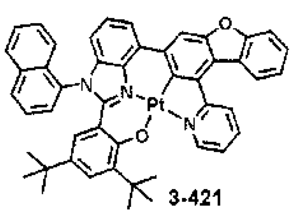
3-421

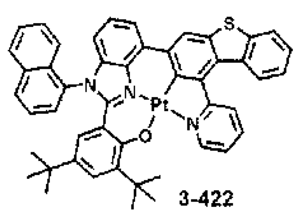
3-422

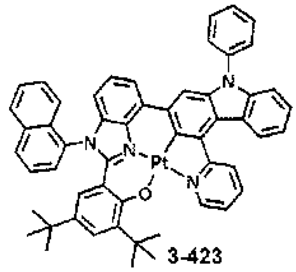
3-423

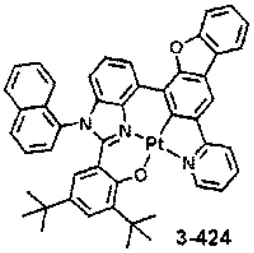
3-424

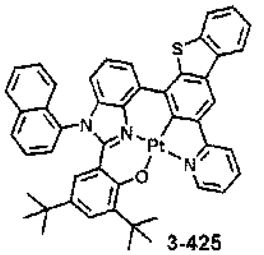
3-425

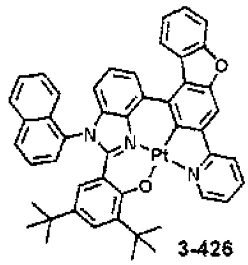
3-426

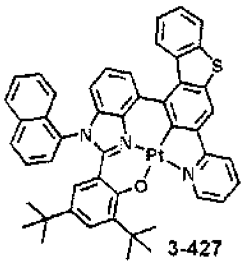
3-427

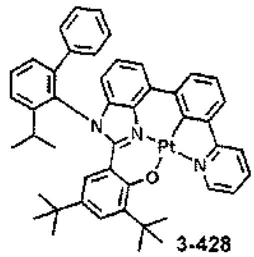
3-428

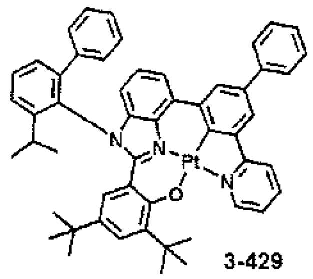
3-429

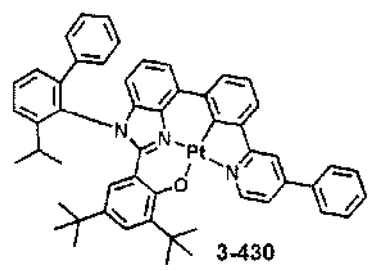
3-430

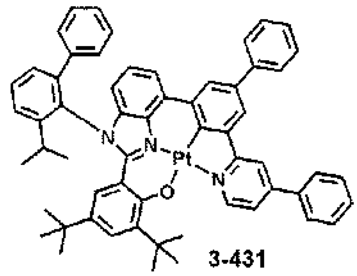
3-431

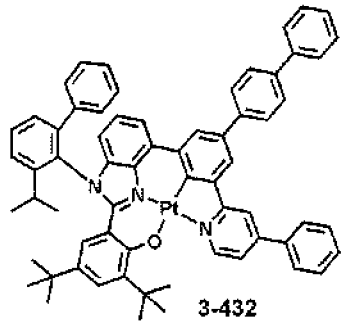
3-432

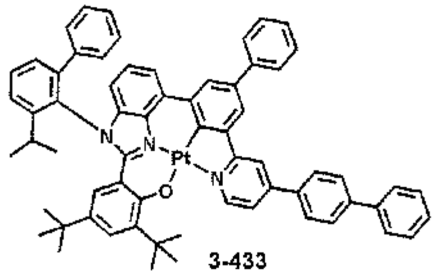
3-433

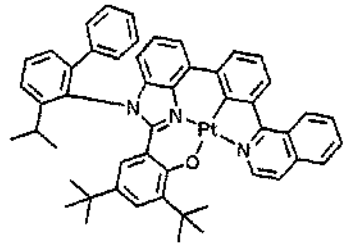
3-434

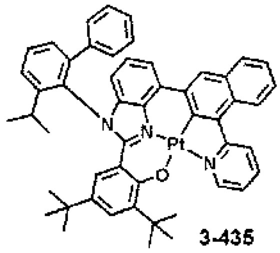
3-435

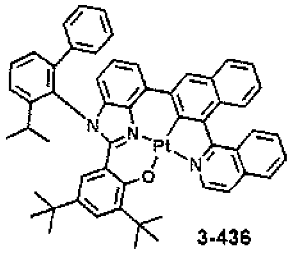
3-436

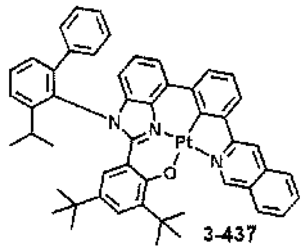
3-437

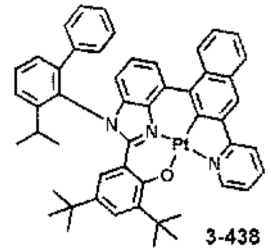
3-438

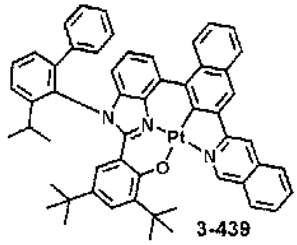
3-439

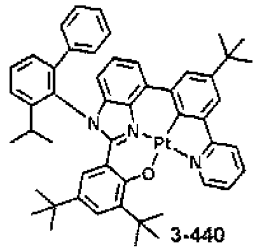
3-440

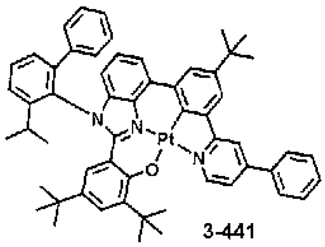
3-441

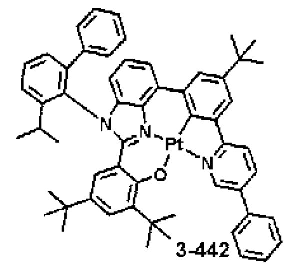
3-442

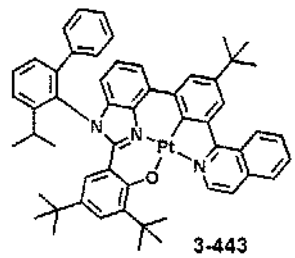
3-443

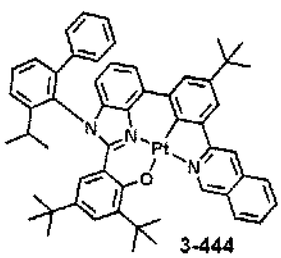
3-444

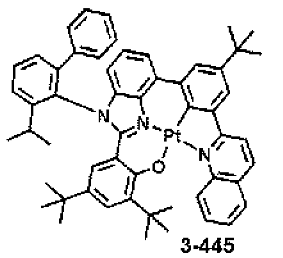
3-445

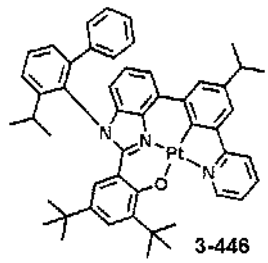
3-446

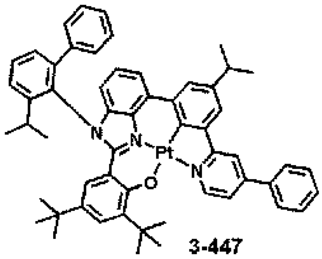
3-447

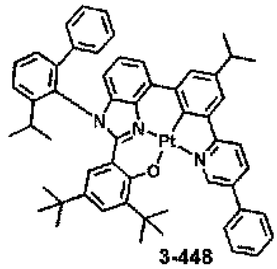
3-448

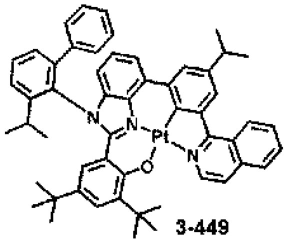
3-449

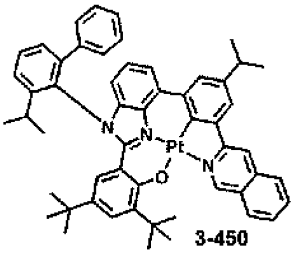
3-450

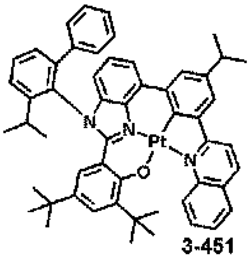
3-451

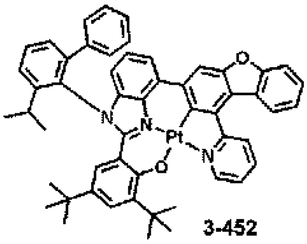
3-452

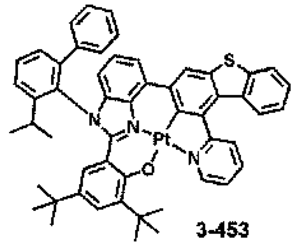
3-453

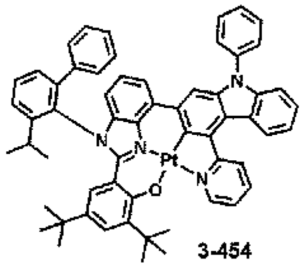
3-454

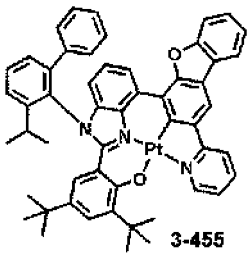
3-455

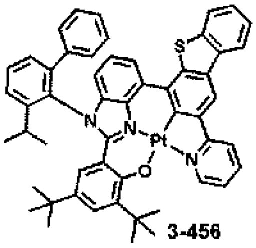
3-456

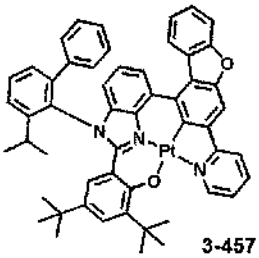
3-457

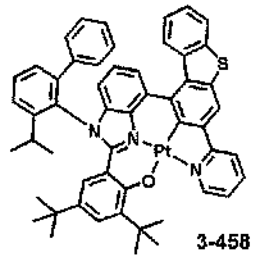
3-458

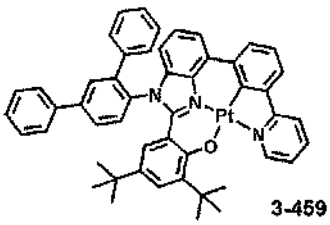
3-459

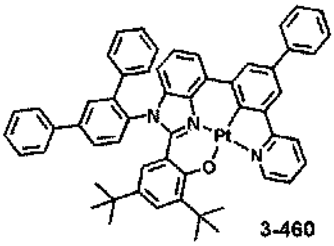
3-460

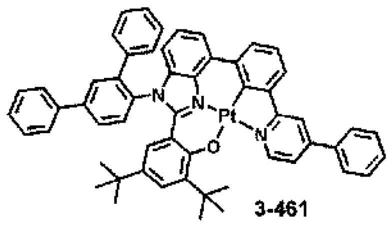
3-461

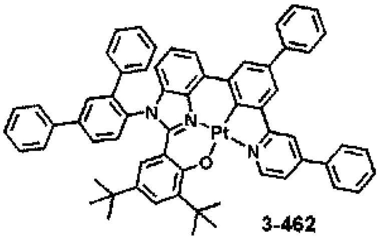
3-462

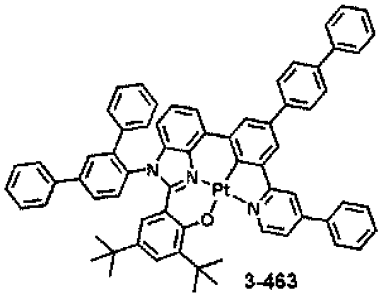
3-463

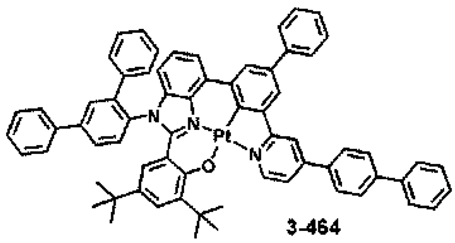
3-464

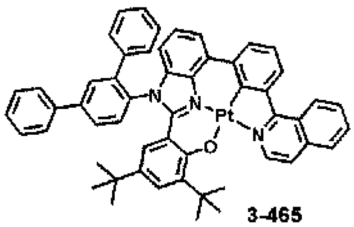
3-465

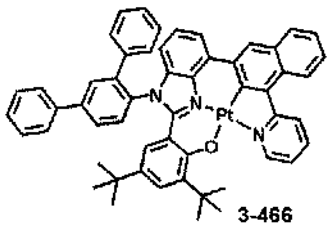
3-466

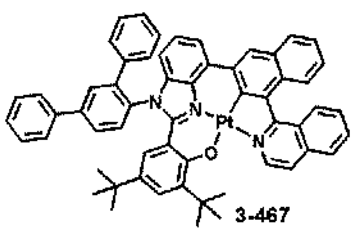
3-467

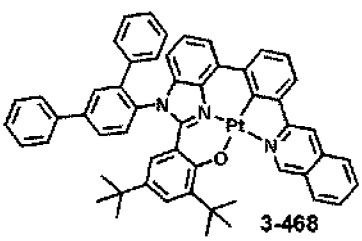
3-468

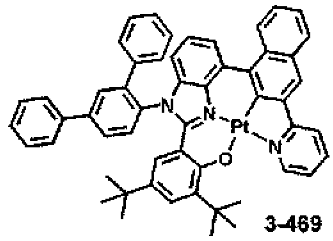
3-469

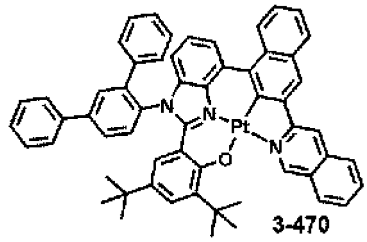
3-470

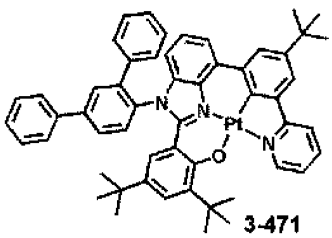
3-471

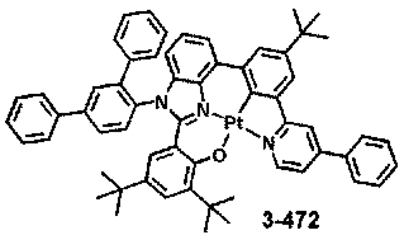
3-472

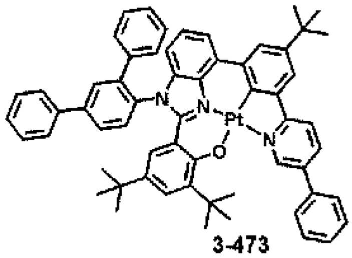
3-473

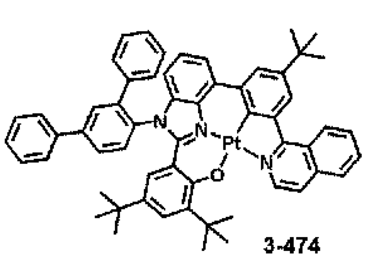
3-474

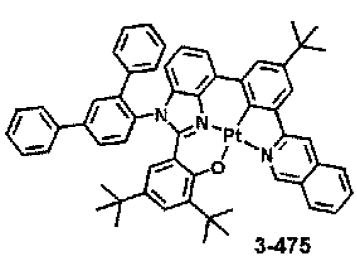
3-475

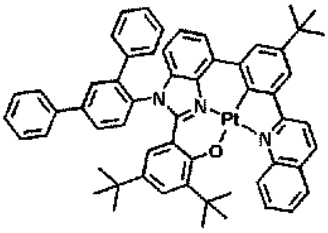
3-476

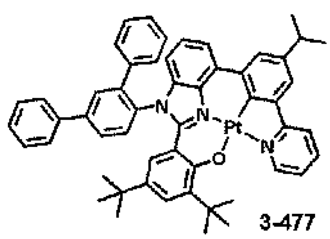
3-477

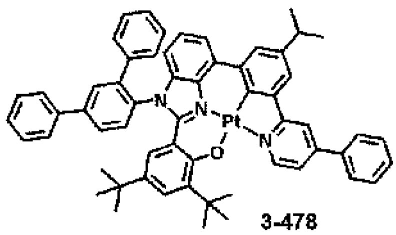
3-478

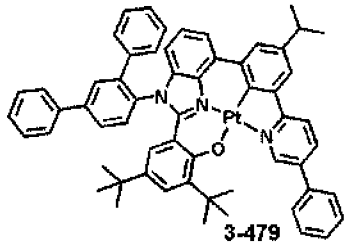
3-479

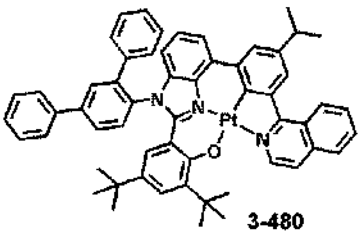
3-480

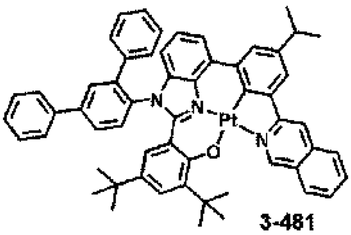
3-481

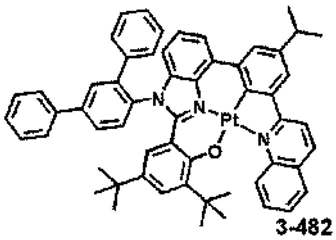
3-482

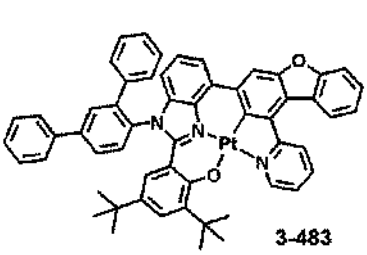
3-483

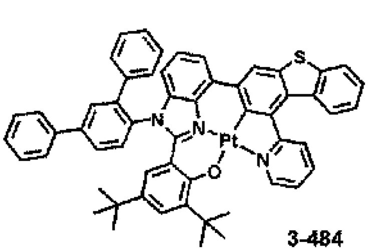
3-484

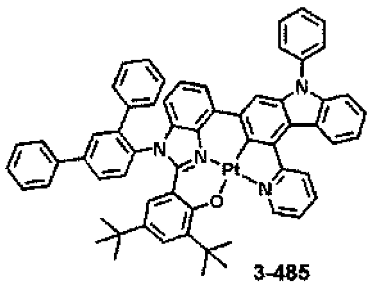
3-485

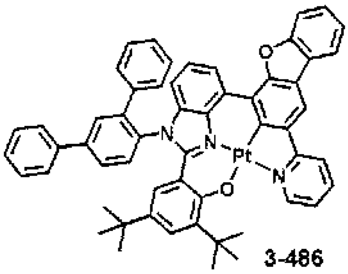
3-486

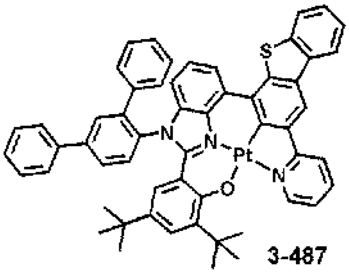
3-487

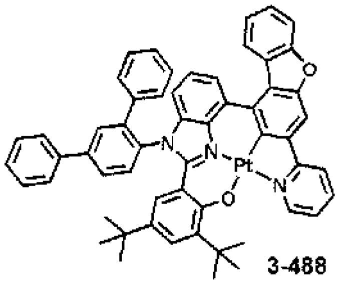
3-488

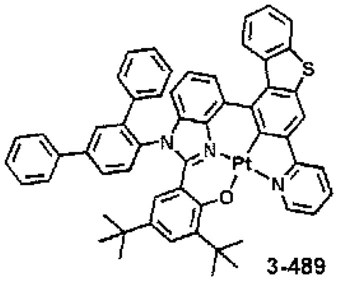
3-489

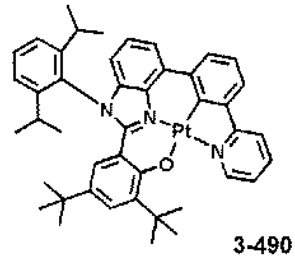
3-490

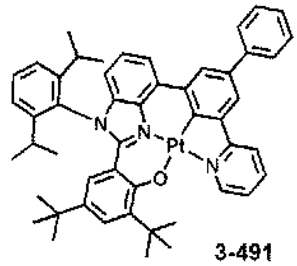
3-491

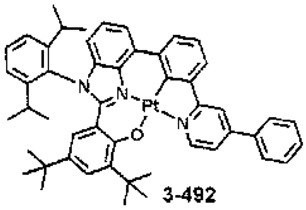
3-492

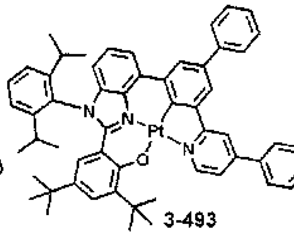
3-493

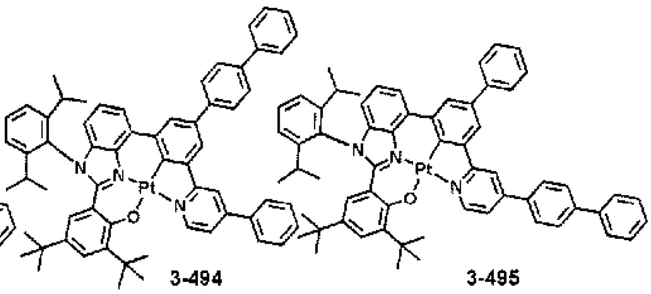
3-494

3-495

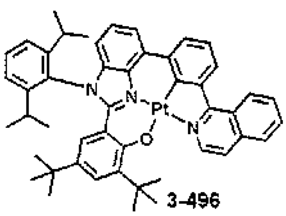
3-496

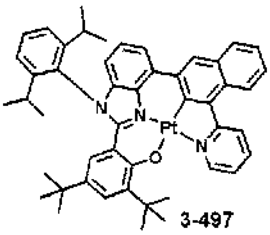
3-497

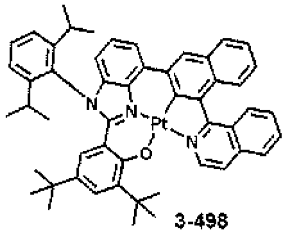
3-498

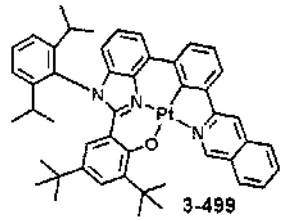
3-499

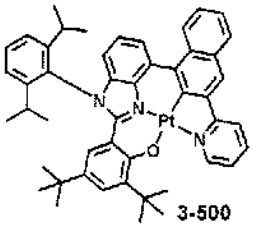
3-500

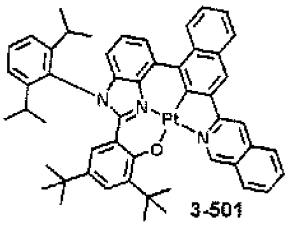
3-501

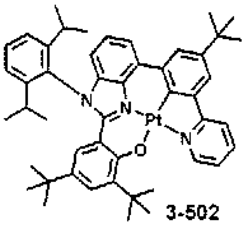
3-502

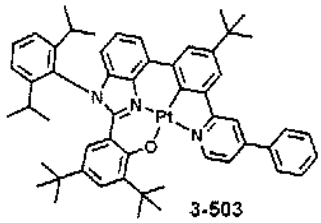
3-503

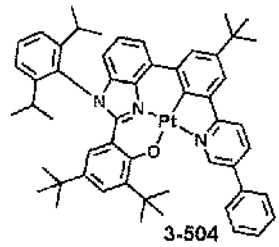
3-504

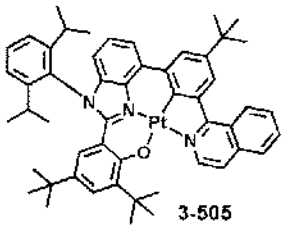
3-505

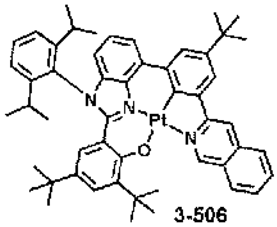
3-506

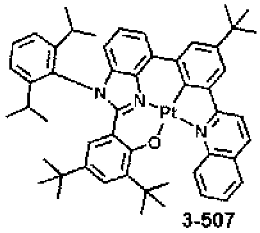
3-507

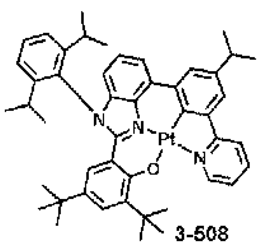
3-508

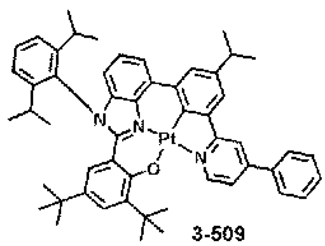
3-509

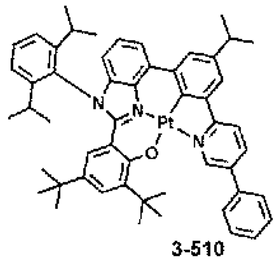
3-510

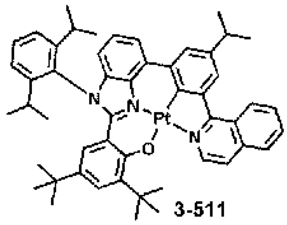
3-511

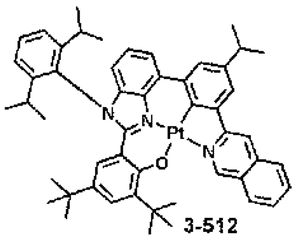
3-512

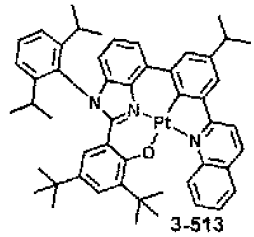
3-513

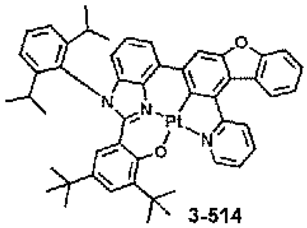
3-514

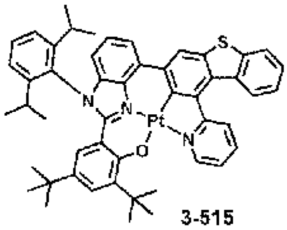
3-515

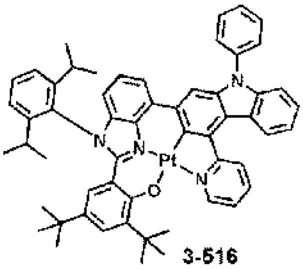
3-516

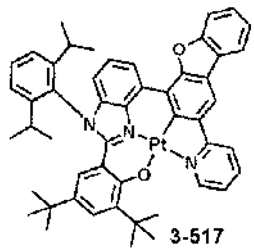
3-517

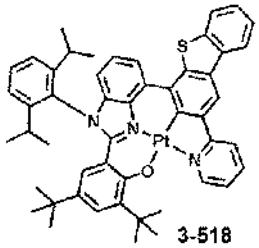
3-518

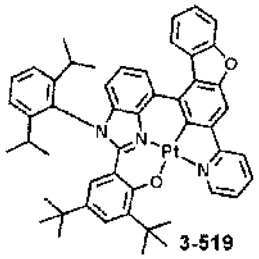
3-519

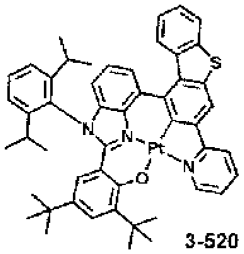
3-520

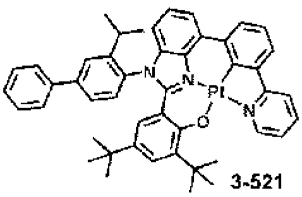
3-521

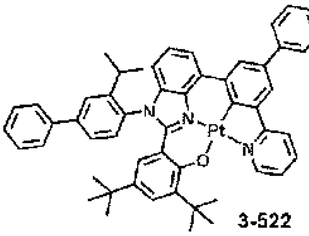
3-522

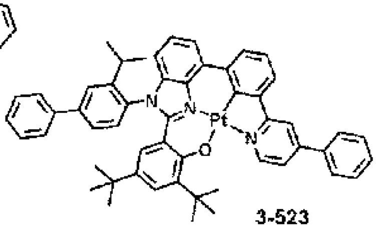
3-523

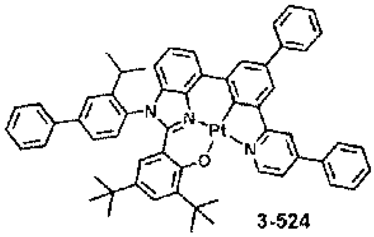
3-524

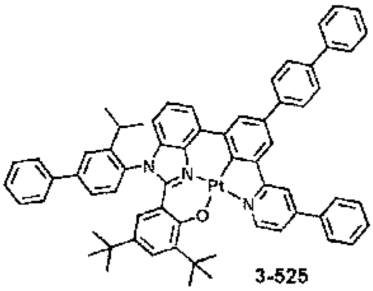
3-525

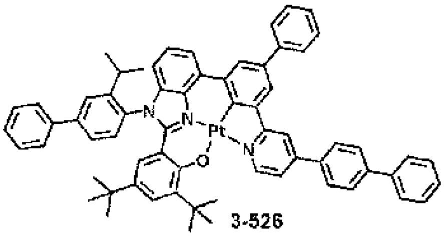
3-526

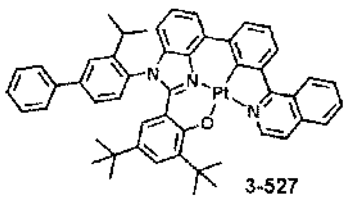
3-527

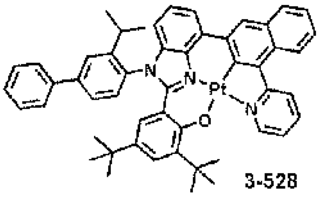
3-528

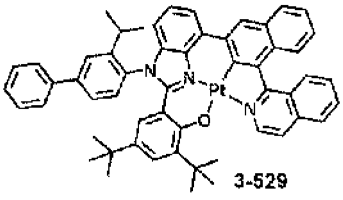
3-529

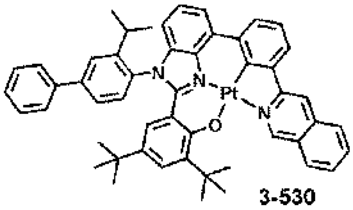
3-530

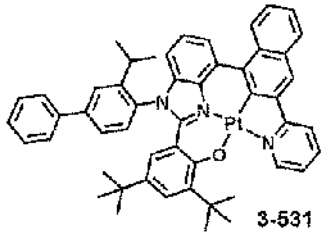
3-531

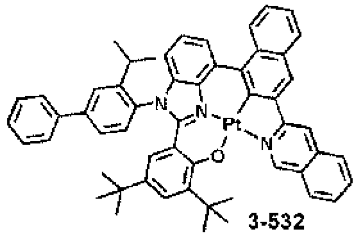
3-532

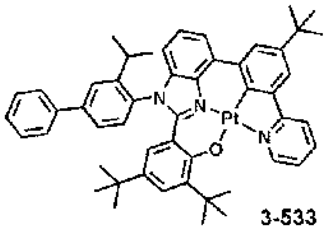
3-533

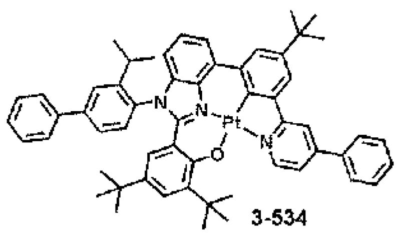
3-534

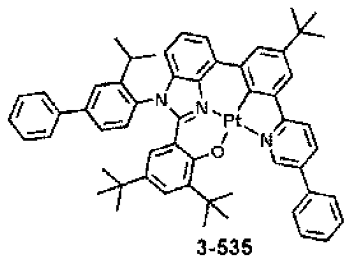
3-535

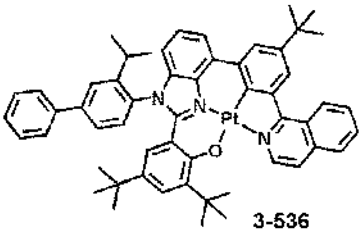
3-536

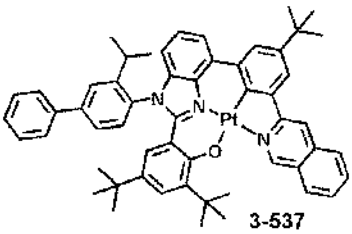
3-537

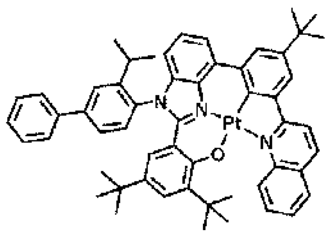
3-538

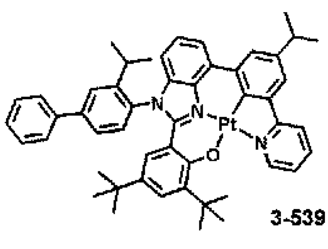
3-539

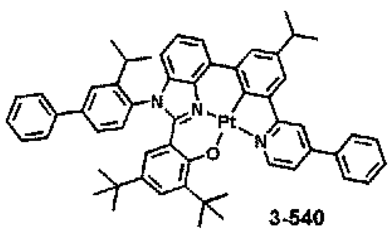
3-540

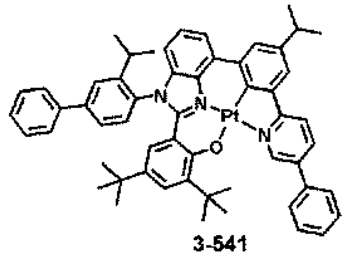
3-541

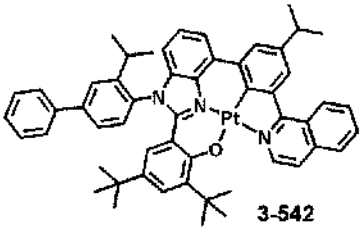
3-542

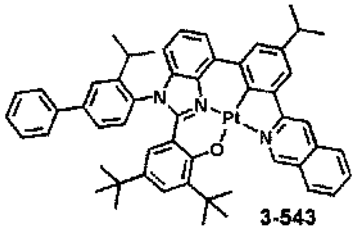
3-543

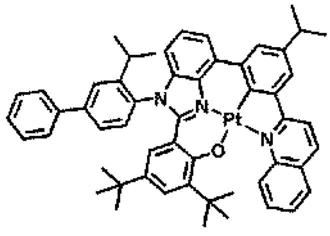
3-544

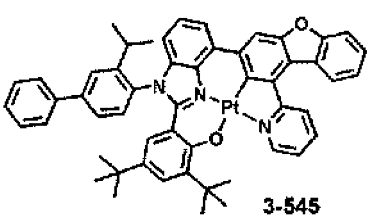
3-545

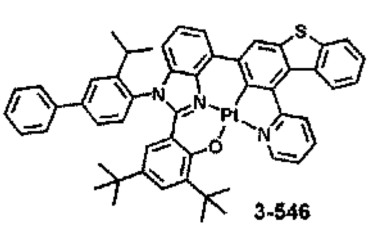
3-546

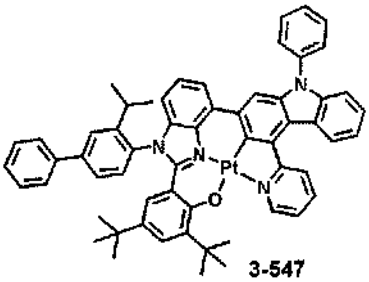
3-547

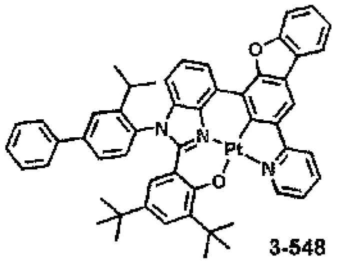
3-548

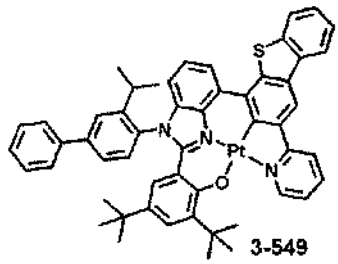
3-549

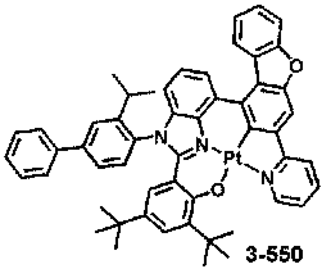
3-550

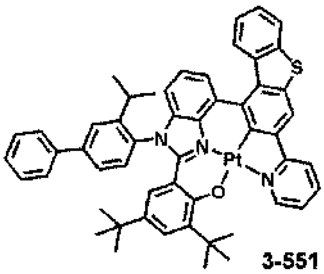
3-551

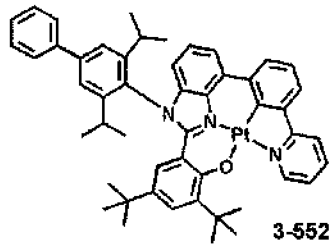
3-552

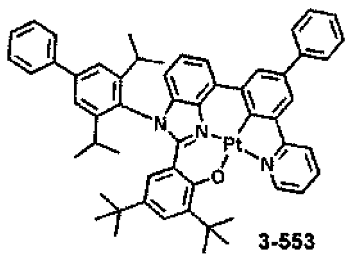
3-553

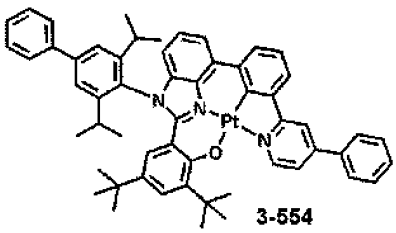
3-554

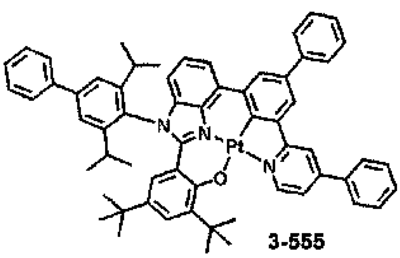
3-555

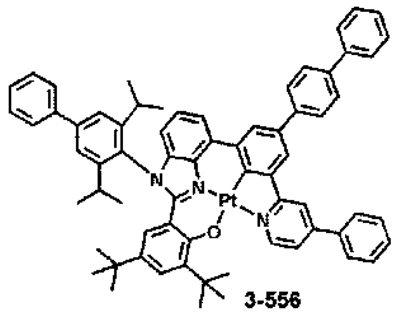
3-556

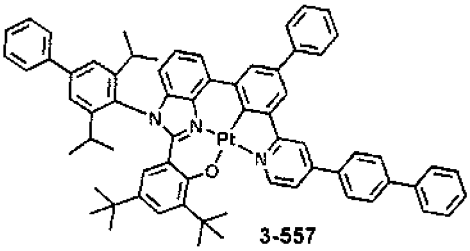
3-557

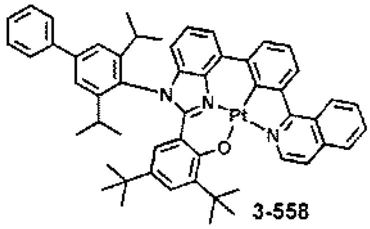
3-558

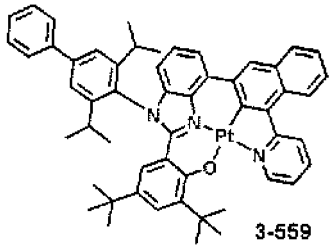
3-559

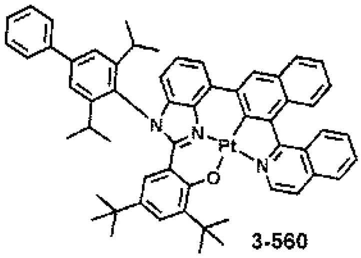
3-560

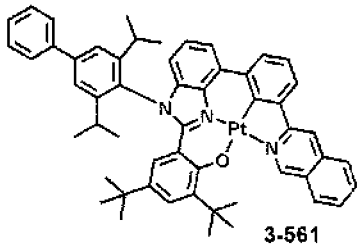
3-561

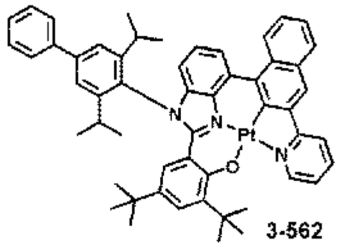
3-562

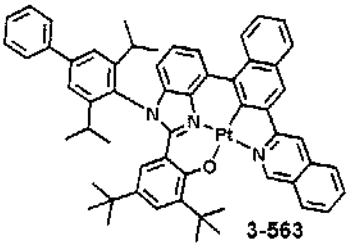
3-563

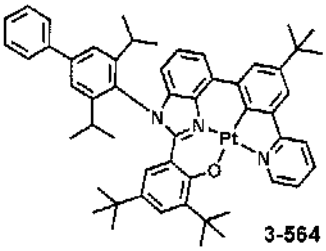
3-564

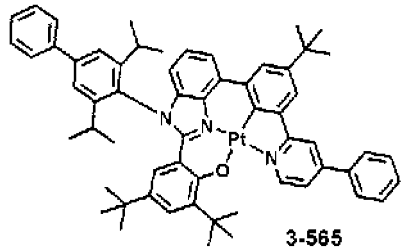
3-565

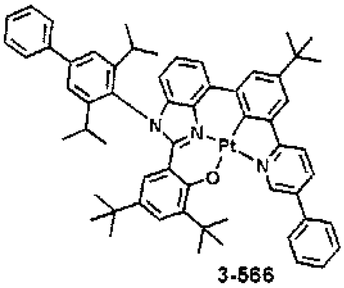
3-566

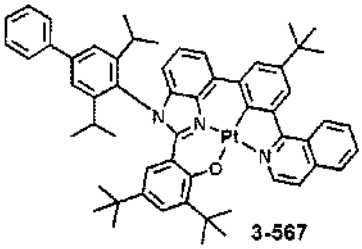
3-567

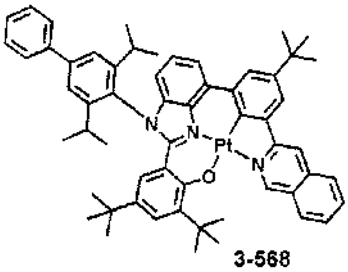
3-568

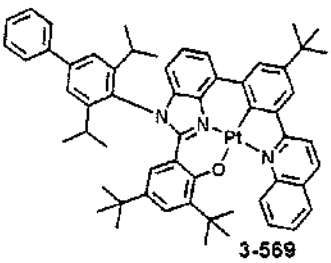
3-569

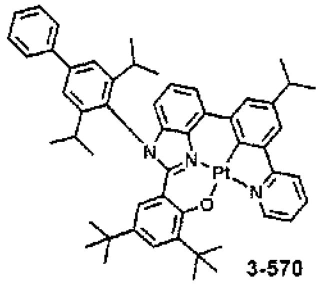
3-570

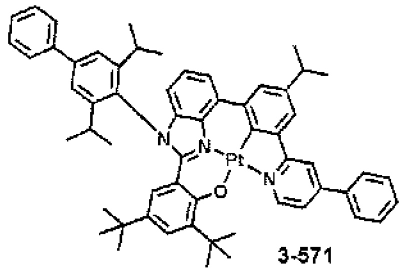
3-571

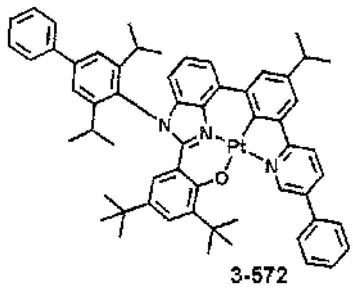
3-572

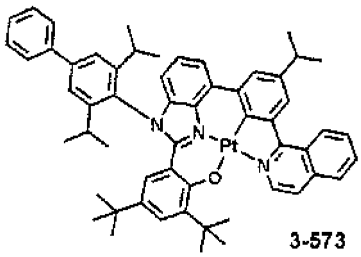
3-573

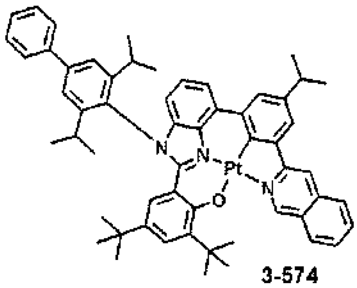
3-574

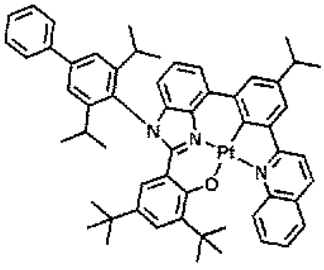
3-575

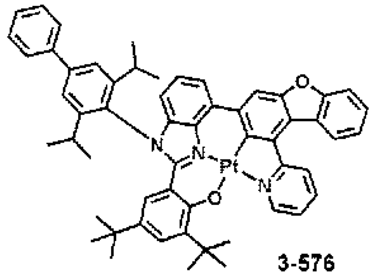
3-576

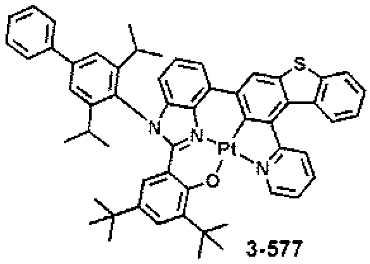
3-577

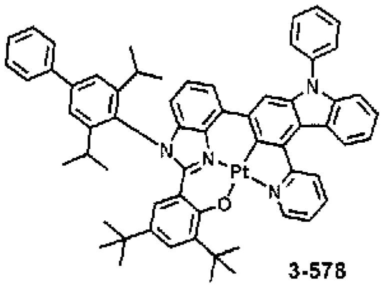
3-578

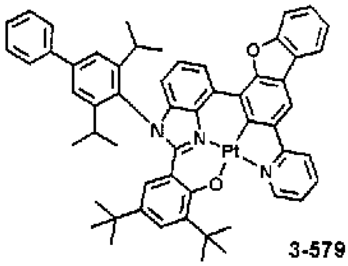
3-579

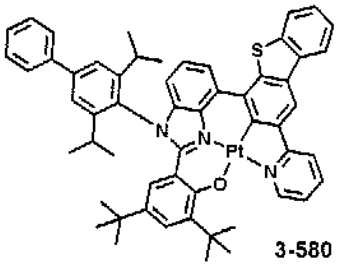
3-580

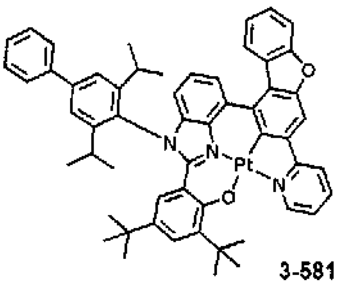
3-581

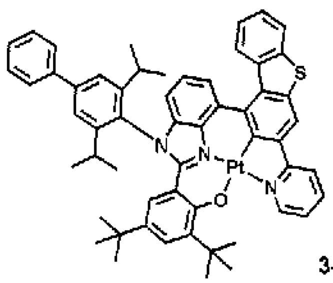
3-582

**6.** Dispositif organique électroluminescent comprenant :

une première électrode ;
une seconde électrode ;
et une couche organique disposée entre la première électrode et la seconde électrode, dans lequel la couche organique comprenant une couche d'émission, et dans lequel la couche organique comprend au moins un composé organométallique selon l'une quelconque des revendications 1 à 5 ;
de préférence dans lequel la première électrode est une anode, la seconde électrode est une et une cathode, la couche organique comprend en outre une région de transport de trous disposée entre la première électrode et la couche d'émission et une région de transport d'électrons disposée entre la couche d'émission et la seconde électrode, la région de transport de trous comprend une couche d'injection de trous, une couche de transport de trous, une couche de blocage d'électrons, ou toute combinaison de celles-ci, et la région de transport d'électrons comprend une couche de blocage de trous, une couche de transport d'électrons, une couche d'injection d'électrons, ou toute combinaison de celles-ci.

**7.** Dispositif organique électroluminescent selon la revendication 6, dans lequel la couche d'émission comprend le composé organométallique ;
de préférence dans lequel la couche d'émission comprend en outre un hôte, et une quantité de l'hôte dans la couche d'émission est supérieure à une quantité du composé organométallique dans la couche d'émission.

FIG. 1

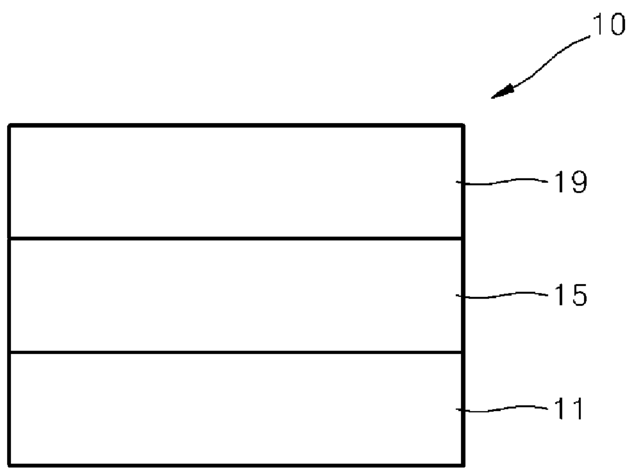

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **B. WANG et al.** Strongly phosphorescent platinum(II) complexes supported by tetradentate benzazole-containing ligands. *Journal of Materials Chemistry C,* 2015, vol. 31, 8212-8218